# EUROPEAN PATENT APPLICATION

(11) **EP 4 293 001 A1**
(43) Date of publication of application: **20.12.2023**
(21) Application number: 23178109.7
(22) Date of filing: 07.06.2023
(51) Int. Cl.: C07B 59/00, C07F 15/00, C09K 11/06, H10K 85/30

(54) **ORGANIC ELECTROLUMINESCENT MATERIALS AND DEVICES**

(30) Priority: 08.06.2022 US 202263350150 P; 10.06.2022 US 202263351049 P; 23.06.2022 US 202263354721 P; 21.07.2022 US 202263391173 P; 27.07.2022 US 202263392731 P; 13.09.2022 US 202263406019 P; 19.09.2022 US 202263407981 P; 04.10.2022 US 202217959324; 20.10.2022 US 202263417746 P; 23.11.2022 US 202218058461; 01.12.2022 US 202263385730 P; 23.01.2023 US 202363481143 P; 10.04.2023 US 202318297699; 10.04.2023 US 202318297759; 10.04.2023 US 202318297781; 10.04.2023 US 202318297693; 10.04.2023 US 202318297752; 09.05.2023 US 202363501049 P; 06.06.2023 US 202318329912
(71) Applicant: Universal Display Corporation, Ewing, NJ 08618 (US)
(72) Inventor: SHIH, Wei-Chun, Ewing, NJ 08618 (US); DYATKIN, Alexey Borisovich, Ewing, NJ 08618 (US); BOUDREAULT, Pierre-Luc T, Ewing, NJ 08618 (US); LIN, Chun, Ewing, NJ 08618 (US); JI, Zhiqiang, Ewing, NJ 08618 (US); CHEN, Hsiao-Fan, Ewing, NJ 08618 (US); HAMZE, Rasha, Ewing, NJ 08618 (US); FLEETHAM, Tyler, Ewing, NJ 08618 (US)
(74) Representative: Maiwald GmbH

(57) **Abstract**

A compound of a first ligand L_{A} of Formula I, 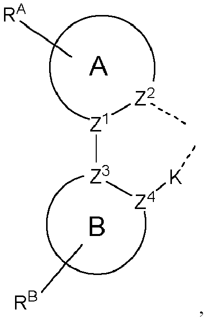 is provided. In Formula I, moieties A and B are each a monocyclic ring or a polycyclic fused-ring system; Z¹ to Z⁴ are each C or N; K is a direct bond, O, or S; each R^{A} and R^{B} is independently a hydrogen or a General Substituent; at least one R^{A} or R^{B} is R^{∗}, wherein R* has a structure of Formula II, ---L-GeR¹R²R³; L is a direct bond or an organic linker; and L_{A} is coordinated to a metal M by the dashed lines; and metal M is selected from Ir, Rh, Re, Ru, Os, Pt, Pd, Ag, Au, or Cu.

## Description

### CROSS-REFERENCE TO RELATED APPLICATIONS

This application is a continuation-in-part of copending United States patent Application Nos. 17/959,324, filed on October 4, 2022, 18/058,461, filed on November 23, 2022, 18/297,699, filed on April 10, 2023, 18/297,759, filed on April 10, 2023, 18/297,781, filed on April 10, 2023, 18/297,693, filed on April 10, 2023, 18/297,752, filed on April 10, 2023, and 17/743,561, filed on May 13, 2022, the entire contents of all the above identified applications are incorporated herein by reference. This application claims priority under 35 U.S.C. § 119(e) to United States Provisional Applications No. 63/501,049, filed on May 9, 2023, No. 63/391,173, filed on July 21, 2022, No. 63/350,150, filed on June 8, 2022, No. 63/351,049, filed on June 10, 2022, No. 63/354,721, filed on June 23, 2022, No. 63/406,019, filed on September 13, 2022, No. 63/407,981, filed on September 19, 2022, No. 63/417,746, filed on October 20, 2022, No. 63/481,143, filed on January 23, 2023, No. 63/392,731, filed on July 27, 2022, and No. 63/385,730, filed on December 1, 2022, the entire contents of all the above applications are incorporated herein by reference.

### FIELD

The present disclosure generally relates to organometallic compounds and formulations and their various uses including as emitters in devices such as organic light emitting diodes and related electronic devices.

### BACKGROUND

Opto-electronic devices that make use of organic materials are becoming increasingly desirable for various reasons. Many of the materials used to make such devices are relatively inexpensive, so organic opto-electronic devices have the potential for cost advantages over inorganic devices. In addition, the inherent properties of organic materials, such as their flexibility, may make them well suited for particular applications such as fabrication on a flexible substrate. Examples of organic opto-electronic devices include organic light emitting diodes/devices (OLEDs), organic phototransistors, organic photovoltaic cells, and organic photodetectors. For OLEDs, the organic materials may have performance advantages over conventional materials.

OLEDs make use of thin organic films that emit light when voltage is applied across the device. OLEDs are becoming an increasingly interesting technology for use in applications such as flat panel displays, illumination, and backlighting.

One application for phosphorescent emissive molecules is a full color display. Industry standards for such a display call for pixels adapted to emit particular colors, referred to as "saturated" colors. In particular, these standards call for saturated red, green, and blue pixels. Alternatively, the OLED can be designed to emit white light. In conventional liquid crystal displays emission from a white backlight is filtered using absorption filters to produce red, green and blue emission. The same technique can also be used with OLEDs. The white OLED can be either a single emissive layer (EML) device or a stack structure. Color may be measured using CIE coordinates, which are well known to the art.

### SUMMARY

Provided are novel Pt- and Ir- organometallic complexes with ligands comprising Ge atom that are useful as phosphorescent emitters in OLEDs.

In one aspect, the present disclosure provides a compound of a first ligand L_{A} of Formula I, 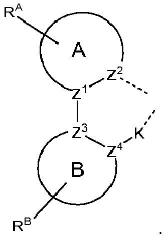 In Formula I:
moieties A and B are each independently a monocyclic 5-membered or 6-membered carbocyclic or heterocyclic ring or a polycyclic fused-ring system comprising at least two rings, wherein each of the at least two rings is independently a 5-membered or 6-membered carbocyclic or heterocyclic ring;
Z¹ to Z⁴ are each independently C or N;
K is a direct bond, O, or S;
R^{A} and R^{B} each independently represents mono to the maximum allowable substitution, or no substitution;
each R^{A} and R^{B} is independently a hydrogen or a substituent selected from the group consisting of deuterium, halogen, alkyl, cycloalkyl, heteroalkyl, heterocycloalkyl, arylalkyl, alkoxy, aryloxy, amino, silyl, germyl, boryl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, selenyl, and combinations thereof;
at least one R^{A} or R^{B} is R*, wherein R* has a structure of Formula II, ---L-GeR¹R²R³;
L is a direct bond or an organic linker;
each R¹, R², and R³ is independently selected from the group consisting of alkyl, heteroalkyl, cycloalkyl, heterocycloalkyl, aryl, heteroaryl, and combinations thereof;
L_{A} is coordinated to a metal M by the dashed lines;
the metal M is selected from the group consisting of Ir, Rh, Re, Ru, Os, Pt, Pd, Ag, Au, and Cu;
L_{A} can be joined with other ligands to comprise a tridentate, tetradentate, pentadentate, or hexadentate ligand;
any two substituents can be joined or fused to form a ring.

In another aspect, the present disclosure provides a formulation comprising a compound having a first ligand L_{A} of Formula I as described herein.

In yet another aspect, the present disclosure provides an OLED having an organic layer comprising a compound having a first ligand L_{A} of Formula I as described herein.

In yet another aspect, the present disclosure provides a consumer product comprising an OLED with an organic layer comprising a compound having a first ligand L_{A} of Formula I as described herein.

### BRIEF DESCRIPTION OF THE DRAWINGS

FIG. 1 shows an organic light emitting device.
FIG. 2 shows an inverted organic light emitting device that does not have a separate electron transport layer.

### DETAILED DESCRIPTION

### A. Terminology

Unless otherwise specified, the below terms used herein are defined as follows:
As used herein, the term "organic" includes polymeric materials as well as small molecule organic materials that may be used to fabricate organic opto-electronic devices. "Small molecule" refers to any organic material that is not a polymer, and "small molecules" may actually be quite large. Small molecules may include repeat units in some circumstances. For example, using a long chain alkyl group as a substituent does not remove a molecule from the "small molecule" class. Small molecules may also be incorporated into polymers, for example as a pendent group on a polymer backbone or as a part of the backbone. Small molecules may also serve as the core moiety of a dendrimer, which consists of a series of chemical shells built on the core moiety. The core moiety of a dendrimer may be a fluorescent or phosphorescent small molecule emitter. A dendrimer may be a "small molecule," and it is believed that all dendrimers currently used in the field of OLEDs are small molecules.

As used herein, "top" means furthest away from the substrate, while "bottom" means closest to the substrate. Where a first layer is described as "disposed over" a second layer, the first layer is disposed further away from substrate. There may be other layers between the first and second layer, unless it is specified that the first layer is "in contact with" the second layer. For example, a cathode may be described as "disposed over" an anode, even though there are various organic layers in between.

As used herein, "solution processable" means capable of being dissolved, dispersed, or transported in and/or deposited from a liquid medium, either in solution or suspension form.

A ligand may be referred to as "photoactive" when it is believed that the ligand directly contributes to the photoactive properties of an emissive material. A ligand may be referred to as "ancillary" when it is believed that the ligand does not contribute to the photoactive properties of an emissive material, although an ancillary ligand may alter the properties of a photoactive ligand.

As used herein, and as would be generally understood by one skilled in the art, a first "Highest Occupied Molecular Orbital" (HOMO) or "Lowest Unoccupied Molecular Orbital" (LUMO) energy level is "greater than" or "higher than" a second HOMO or LUMO energy level if the first energy level is closer to the vacuum energy level. Since ionization potentials (IP) are measured as a negative energy relative to a vacuum level, a higher HOMO energy level corresponds to an IP having a smaller absolute value (an IP that is less negative). Similarly, a higher LUMO energy level corresponds to an electron affinity (EA) having a smaller absolute value (an EA that is less negative). On a conventional energy level diagram, with the vacuum level at the top, the LUMO energy level of a material is higher than the HOMO energy level of the same material. A "higher" HOMO or LUMO energy level appears closer to the top of such a diagram than a "lower" HOMO or LUMO energy level.

As used herein, and as would be generally understood by one skilled in the art, a first work function is "greater than" or "higher than" a second work function if the first work function has a higher absolute value. Because work functions are generally measured as negative numbers relative to vacuum level, this means that a "higher" work function is more negative. On a conventional energy level diagram, with the vacuum level at the top, a "higher" work function is illustrated as further away from the vacuum level in the downward direction. Thus, the definitions of HOMO and LUMO energy levels follow a different convention than work functions.

The terms "halo," "halogen," and "halide" are used interchangeably and refer to fluorine, chlorine, bromine, and iodine.

The term "acyl" refers to a substituted carbonyl radical (C(O)-Rₛ).

The term "ester" refers to a substituted oxycarbonyl (-O-C(O)-Rₛ or -C(O)-O-Rₛ) radical.

The term "ether" refers to an -ORₛ radical.

The terms "sulfanyl" or "thio-ether" are used interchangeably and refer to a -SRₛ radical.

The term "selenyl" refers to a -SeRₛ radical.

The term "sulfinyl" refers to a -S(O)-Rₛ radical.

The term "sulfonyl" refers to a -SO₂-Rₛ radical.

The term "phosphino" refers to a -P(Rₛ)₃ radical, wherein each Rₛ can be same or different.

The term "silyl" refers to a -Si(Rₛ)₃ radical, wherein each Rₛ can be same or different.

The term "germyl" refers to a -Ge(Rₛ)₃ radical, wherein each Rₛ can be same or different.

The term "boryl" refers to a -B(Rₛ)₂ radical or its Lewis adduct -B(Rₛ)₃ radical, wherein Rₛ can be same or different.

In each of the above, Rₛ can be hydrogen or a substituent selected from the group consisting of deuterium, halogen, alkyl, cycloalkyl, heteroalkyl, heterocycloalkyl, arylalkyl, alkoxy, aryloxy, amino, silyl, alkenyl, cycloalkenyl, heteroalkenyl, alkynyl, aryl, heteroaryl, and combination thereof. Preferred Rₛ is selected from the group consisting of alkyl, cycloalkyl, aryl, heteroaryl, and combination thereof.

The term "alkyl" refers to and includes both straight and branched chain alkyl radicals. Preferred alkyl groups are those containing from one to fifteen carbon atoms and includes methyl, ethyl, propyl, 1-methylethyl, butyl, 1-methylpropyl, 2-methylpropyl, pentyl, 1-methylbutyl, 2-methylbutyl, 3-methylbutyl, 1,1-dimethylpropyl, 1,2-dimethylpropyl, 2,2-dimethylpropyl, and the like. Additionally, the alkyl group may be optionally substituted.

The term "cycloalkyl" refers to and includes monocyclic, polycyclic, and spiro alkyl radicals. Preferred cycloalkyl groups are those containing 3 to 12 ring carbon atoms and includes cyclopropyl, cyclopentyl, cyclohexyl, bicyclo[3.1.1]heptyl, spiro[4.5]decyl, spiro[5.5]undecyl, adamantyl, and the like. Additionally, the cycloalkyl group may be optionally substituted.

The terms "heteroalkyl" or "heterocycloalkyl" refer to an alkyl or a cycloalkyl radical, respectively, having at least one carbon atom replaced by a heteroatom. Optionally the at least one heteroatom is selected from O, S, N, P, B, Si and Se, preferably, O, S or N. Additionally, the heteroalkyl or heterocycloalkyl group may be optionally substituted.

The term "alkenyl" refers to and includes both straight and branched chain alkene radicals. Alkenyl groups are essentially alkyl groups that include at least one carbon-carbon double bond in the alkyl chain. Cycloalkenyl groups are essentially cycloalkyl groups that include at least one carbon-carbon double bond in the cycloalkyl ring. The term "heteroalkenyl" as used herein refers to an alkenyl radical having at least one carbon atom replaced by a heteroatom. Optionally the at least one heteroatom is selected from O, S, N, P, B, Si, and Se, preferably, O, S, or N. Preferred alkenyl, cycloalkenyl, or heteroalkenyl groups are those containing two to fifteen carbon atoms. Additionally, the alkenyl, cycloalkenyl, or heteroalkenyl group may be optionally substituted.

The term "alkynyl" refers to and includes both straight and branched chain alkyne radicals. Alkynyl groups are essentially alkyl groups that include at least one carbon-carbon triple bond in the alkyl chain. Preferred alkynyl groups are those containing two to fifteen carbon atoms. Additionally, the alkynyl group may be optionally substituted.

The terms "aralkyl" or "arylalkyl" are used interchangeably and refer to an alkyl group that is substituted with an aryl group. Additionally, the aralkyl group may be optionally substituted.

The term "heterocyclic group" refers to and includes aromatic and non-aromatic cyclic radicals containing at least one heteroatom. Optionally the at least one heteroatom is selected from O, S, N, P, B, Si, and Se, preferably, O, S, or N. Hetero-aromatic cyclic radicals may be used interchangeably with heteroaryl. Preferred hetero-non-aromatic cyclic groups are those containing 3 to 7 ring atoms which includes at least one hetero atom, and includes cyclic amines such as morpholino, piperidino, pyrrolidino, and the like, and cyclic ethers/thio-ethers, such as tetrahydrofuran, tetrahydropyran, tetrahydrothiophene, and the like. Additionally, the heterocyclic group may be optionally substituted.

The term "aryl" refers to and includes both single-ring aromatic hydrocarbyl groups and polycyclic aromatic ring systems. The polycyclic rings may have two or more rings in which two carbons are common to two adjoining rings (the rings are "fused") wherein at least one of the rings is an aromatic hydrocarbyl group, e.g., the other rings can be cycloalkyls, cycloalkenyls, aryl, heterocycles, and/or heteroaryls. Preferred aryl groups are those containing six to thirty carbon atoms, preferably six to twenty carbon atoms, more preferably six to twelve carbon atoms. Especially preferred is an aryl group having six carbons, ten carbons or twelve carbons. Suitable aryl groups include phenyl, biphenyl, triphenyl, triphenylene, tetraphenylene, naphthalene, anthracene, phenalene, phenanthrene, fluorene, pyrene, chrysene, perylene, and azulene, preferably phenyl, biphenyl, triphenyl, triphenylene, fluorene, and naphthalene. Additionally, the aryl group may be optionally substituted.

The term "heteroaryl" refers to and includes both single-ring aromatic groups and polycyclic aromatic ring systems that include at least one heteroatom. The heteroatoms include, but are not limited to O, S, N, P, B, Si, and Se. In many instances, O, S, or N are the preferred heteroatoms. Hetero-single ring aromatic systems are preferably single rings with 5 or 6 ring atoms, and the ring can have from one to six heteroatoms. The hetero-polycyclic ring systems can have two or more rings in which two atoms are common to two adjoining rings (the rings are "fused") wherein at least one of the rings is a heteroaryl, e.g., the other rings can be cycloalkyls, cycloalkenyls, aryl, heterocycles, and/or heteroaryls. The hetero-polycyclic aromatic ring systems can have from one to six heteroatoms per ring of the polycyclic aromatic ring system. Preferred heteroaryl groups are those containing three to thirty carbon atoms, preferably three to twenty carbon atoms, more preferably three to twelve carbon atoms. Suitable heteroaryl groups include dibenzothiophene, dibenzofuran, dibenzoselenophene, furan, thiophene, benzofuran, benzothiophene, benzoselenophene, carbazole, indolocarbazole, pyridylindole, pyrrolodipyridine, pyrazole, imidazole, triazole, oxazole, thiazole, oxadiazole, oxatriazole, dioxazole, thiadiazole, pyridine, pyridazine, pyrimidine, pyrazine, triazine, oxazine, oxathiazine, oxadiazine, indole, benzimidazole, indazole, indoxazine, benzoxazole, benzisoxazole, benzothiazole, quinoline, isoquinoline, cinnoline, quinazoline, quinoxaline, naphthyridine, phthalazine, pteridine, xanthene, acridine, phenazine, phenothiazine, phenoxazine, benzofuropyridine, furodipyridine, benzothienopyridine, thienodipyridine, benzoselenophenopyridine, and selenophenodipyridine, preferably dibenzothiophene, dibenzofuran, dibenzoselenophene, carbazole, indolocarbazole, imidazole, pyridine, triazine, benzimidazole, 1,2-azaborine, 1,3-azaborine, 1,4-azaborine, borazine, and aza-analogs thereof. Additionally, the heteroaryl group may be optionally substituted.

Of the aryl and heteroaryl groups listed above, the groups of triphenylene, naphthalene, anthracene, dibenzothiophene, dibenzofuran, dibenzoselenophene, carbazole, indolocarbazole, imidazole, pyridine, pyrazine, pyrimidine, triazine, and benzimidazole, and the respective aza-analogs of each thereof are of particular interest.

The terms alkyl, cycloalkyl, heteroalkyl, heterocycloalkyl, alkenyl, cycloalkenyl, heteroalkenyl, alkynyl, aralkyl, heterocyclic group, aryl, and heteroaryl, as used herein, are independently unsubstituted, or independently substituted, with one or more general substituents.

In many instances, the General Substituents are selected from the group consisting of deuterium, halogen, alkyl, cycloalkyl, heteroalkyl, heterocycloalkyl, arylalkyl, alkoxy, aryloxy, amino, silyl, germyl, boryl, alkenyl, cycloalkenyl, heteroalkenyl, alkynyl, aryl, heteroaryl, acyl, carboxylic acid, ether, ester, nitrile, isonitrile, sulfanyl, selenyl, sulfinyl, sulfonyl, phosphino, and combinations thereof.

In some instances, the Preferred General Substituents are selected from the group consisting of deuterium, fluorine, alkyl, cycloalkyl, heteroalkyl, alkoxy, aryloxy, amino, silyl, germyl, boryl, alkenyl, cycloalkenyl, heteroalkenyl, aryl, heteroaryl, nitrile, isonitrile, sulfanyl, and combinations thereof.

In some instances, the More Preferred General Substituents are selected from the group consisting of deuterium, fluorine, alkyl, cycloalkyl, alkoxy, aryloxy, amino, silyl, aryl, heteroaryl, sulfanyl, and combinations thereof.

In yet other instances, the Most Preferred General Substituents are selected from the group consisting of deuterium, fluorine, alkyl, cycloalkyl, aryl, heteroaryl, and combinations thereof.

The terms "substituted" and "substitution" refer to a substituent other than H that is bonded to the relevant position, e.g., a carbon or nitrogen. For example, when R¹ represents mono-substitution, then one R¹ must be other than H (i.e., a substitution). Similarly, when R¹ represents di-substitution, then two of R¹ must be other than H. Similarly, when R¹ represents zero or no substitution, R¹, for example, can be a hydrogen for available valencies of ring atoms, as in carbon atoms for benzene and the nitrogen atom in pyrrole, or simply represents nothing for ring atoms with fully filled valencies, e.g., the nitrogen atom in pyridine. The maximum number of substitutions possible in a ring structure will depend on the total number of available valencies in the ring atoms.

As used herein, "combinations thereof" indicates that one or more members of the applicable list are combined to form a known or chemically stable arrangement that one of ordinary skill in the art can envision from the applicable list. For example, an alkyl and deuterium can be combined to form a partial or fully deuterated alkyl group; a halogen and alkyl can be combined to form a halogenated alkyl substituent; and a halogen, alkyl, and aryl can be combined to form a halogenated arylalkyl. In one instance, the term substitution includes a combination of two to four of the listed groups. In another instance, the term substitution includes a combination of two to three groups. In yet another instance, the term substitution includes a combination of two groups. Preferred combinations of substituent groups are those that contain up to fifty atoms that are not hydrogen or deuterium, or those which include up to forty atoms that are not hydrogen or deuterium, or those that include up to thirty atoms that are not hydrogen or deuterium. In many instances, a preferred combination of substituent groups will include up to twenty atoms that are not hydrogen or deuterium.

The "aza" designation in the fragments described herein, i.e. aza-dibenzofuran, aza-dibenzothiophene, etc. means that one or more of the C-H groups in the respective aromatic ring can be replaced by a nitrogen atom, for example, and without any limitation, azatriphenylene encompasses both dibenzo[*f,h*]quinoxaline and dibenzo[*f,h*]quinoline. One of ordinary skill in the art can readily envision other nitrogen analogs of the aza-derivatives described above, and all such analogs are intended to be encompassed by the terms as set forth herein.

As used herein, "deuterium" refers to an isotope of hydrogen. Deuterated compounds can be readily prepared using methods known in the art. For example, U.S. Pat. No. 8,557,400, Patent Pub. No. WO 2006/095951, and U.S. Pat. Application Pub. No. US 2011/0037057, which are hereby incorporated by reference in their entireties, describe the making of deuterium-substituted organometallic complexes. Further reference is made to Ming Yan, et al., Tetrahedron 2015, 71, 1425-30 and Atzrodt et al., Angew. Chem. Int. Ed. (Reviews) 2007, 46, 7744-65, which are incorporated by reference in their entireties, describe the deuteration of the methylene hydrogens in benzyl amines and efficient pathways to replace aromatic ring hydrogens with deuterium, respectively.

It is to be understood that when a molecular fragment is described as being a substituent or otherwise attached to another moiety, its name may be written as if it were a fragment (e.g. phenyl, phenylene, naphthyl, dibenzofuryl) or as if it were the whole molecule (e.g. benzene, naphthalene, dibenzofuran). As used herein, these different ways of designating a substituent or attached fragment are considered to be equivalent.

In some instance, a pair of adjacent substituents can be optionally joined or fused into a ring. The preferred ring is a five, six, or seven-membered carbocyclic or heterocyclic ring, includes both instances where the portion of the ring formed by the pair of substituents is saturated and where the portion of the ring formed by the pair of substituents is unsaturated. As used herein, "adjacent" means that the two substituents involved can be on the same ring next to each other, or on two neighboring rings having the two closest available substitutable positions, such as 2, 2' positions in a biphenyl, or 1, 8 position in a naphthalene, as long as they can form a stable fused ring system.

### B. The Compounds of the Present Disclosure

In one aspect, the present disclosure provides a compound of a first ligand L_{A} of Formula I, 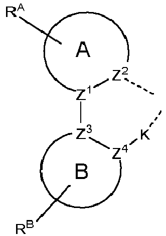 or Formula Ia 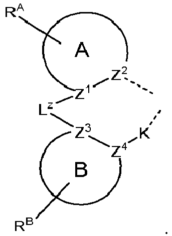 In Formula I and Formula Ia:
moieties A and B are each independently a monocyclic 5-membered or 6-membered carbocyclic or heterocyclic ring or a polycyclic fused-ring system comprising at least two rings, wherein each of the at least two rings is independently a 5-membered or 6-membered carbocyclic or heterocyclic ring;
L^{Z} is a direct bond or an organic linker;
Z¹ to Z⁴ are each independently C or N;
K is a direct bond, O, or S;
R^{A} and R^{B} each independently represent mono to the maximum allowable substitution, or no substitution;
each R^{A} and R^{B} is independently a hydrogen or a substituent selected from the group consisting of the General Substituents defined herein;
at least one R^{A} or R^{B} is R*, wherein R* has a structure of Formula II, ---L-GeR¹R²R³;
L is a direct bond or an organic linker;
each R¹, R², and R³ is independently selected from the group consisting of alkyl, heteroalkyl, cycloalkyl, heterocycloalkyl, aryl, heteroaryl, and combinations thereof;
L_{A} is coordinated to a metal M by the dashed lines;
metal M is selected from the group consisting of Ir, Rh, Re, Ru, Os, Pt, Pd, Ag, Au, and Cu;
L_{A} may be joined with other ligands to comprise a tridentate, tetradentate, pentadentate, or hexadentate ligand; and
any two substituents can be joined or fused to form a ring.

In some embodiments, each of the following provisos is true:
(i) when M is Ir, L is a direct bond, moiety A is unfused pyridine, Z² is N, moiety B is unfused phenyl, K is a direct bond, and at least one R^{B} is R*, then the compound is heteroleptic and does not comprise an acetylacetonate ligand or a derivative thereof;
(ii) when M is Ir, A is unfused pyridine, Z² is N, moiety B is unfused phenyl, K is a direct bond, and at least one R^{A} is R*, then L comprises at least one cyclic group;
(iii) when M is Ir, K is a direct bond, L is a direct bond, moiety B is unfused naphthalene, and at least one R^{B} is R*, then the compound does not comprise an acetylacetonate ligand or a derivative thereof;
(iv) when M is Ir, L is a direct bond, Z² is N, and at least one R^{A} is R*, then Z² is not part of a unfused pyridine ring or a fused pyridine ring with all additional fused rings being phenyl ring;
(v) when M is Ir, L is a direct bond, Z² is N and is part of a pyridine ring that is part of a polycyclic fused-ring system of moiety A, and at least one R^{A} is R* attached to the pyridine ring, then the polycyclic fused-ring system of moiety A comprises at least one five-membered ring;
(vi) when M is Pt, then L_{A} is a tetradentate ligand and Ge in R* does not belong to any ring atom; and
(vii) when M is Pt, L is a direct bond, moiety A is unfused pyridine, Z² is N, and at least one R^{A} is R*, then moiety A links to another fused or unfused aromatic ring in addition to moiety B, and the another fused or unfused aromatic ring coordinates to Pt; and
(viii) one or more combinations of (i) to (vii).

As used herein, an example of a derivative of an acetylacetonate ligand is where the methyl groups are replaced with another substituents, such as the General Substituents or the Preferred General Substituents defined herein. In some embodiments, each of the methyl groups is independently replaced with a group selected from the group consisting of alkyl, cycloalkyl, partially or fully deuterated variants thereof, or combinations thereof.

In some embodiments, no more than 10% of the spin densities of any of the anion, cation, or lowest excited triplet state are localized on any one of R¹, R², R³, and L. In some embodiments, no more than 5% of the spin densities of any of the anion, cation, or lowest excited triplet state are localized on any one of R¹, R², R³, and L. In some embodiments, no more than 1% of the spin densities of any of the anion, cation, or lowest excited triplet state are localized on any one of R¹, R², R³, and L.

In some embodiments, no more than 10% of the spin densities of any of the anion, cation, or lowest excited triplet state are localized on all of R¹, R², R³, and L. In some embodiments, no more than 5% of the spin densities of any of the anion, cation, or lowest excited triplet state are localized on all of R¹, R², R³, and L. In some embodiments, no more than 1% of the spin densities of any of the anion, cation, or lowest excited triplet state are localized on all of R¹, R², R³, and L.

In some embodiments, one of the rings in moiety A or Moiety B is the ring Q, R* is joined to the ring Q, and no more than 10% of the spin densities of any of the anion, cation, or lowest excited triplet state are localized on ring Q. In some embodiments, one of the rings in moiety A or Moiety B is the ring Q, R* is joined to the ring Q, and no more than 5% of the spin densities of any of the anion, cation, or lowest excited triplet state are localized on ring Q. In some embodiments, one of the rings in moiety A or Moiety B is the ring Q, R* is joined to the ring Q, and no more than 1% of the spin densities of any of the anion, cation, or lowest excited triplet state are localized on ring Q.

In some embodiments, the shortest number of atoms between the Ge atom in R* and an atom with greater than 1% of the spin densities of any of the anion, cation, or lowest excited triplet state is at least 2 atoms. In some embodiments, the shortest number of atoms between the Ge atom in R* and an atom with greater than 1% of the spin densities of any of the anion, cation, or lowest excited triplet state is at least 3 atoms. In some embodiments, the shortest number of atoms between the Ge atom in R*and an atom with greater than 1% of the spin densities of any of the anion, cation, or lowest excited triplet state is at least 4 atoms. In some embodiments, the shortest number of atoms between the Ge atom in R* and an atom with greater than 1% of the spin densities of any of the anion, cation, or lowest excited triplet state is at least 5 atoms.

Density functional theory (DFT) was used to calculate the anion, cation, and triplet spin densities of the compounds. Calculations were performed using the unrestricted B3LYP functional with a CEP-31G basis set. The geometry optimizations for the first triplet excited state were performed in vacuum by setting a spin multiplicity of three. The geometry optimizations for the first cation and anion doublet states were performed in vacuum by setting a charge of +1 or -1 respectively, and a spin multiplicity of 2. Spin density was then calculated using the CubeGen utility in the program Gaussian as the difference between the alpha and beta spin densities. All calculations were carried out using the program Gaussian. To determine the spin density population on each atom and each grouping of atoms, the spin density was subjected to a Löwdin population analysis as described by Löwdin, P.-O. J. Chem. Phys. 1950, 18, 365 and Löwdin, P.-O. Adv Quantum Chem 1970, 5, 185. This is accomplished by partitioning the spin density into disjoint atom-centered contributions that collectively compose a molecule. These contributions are then collected either individually or as groups as needed.

In some embodiments, M is Ir, L is a direct bond, moiety A is unfused pyridine, Z² is N, moiety B is unfused phenyl, K is direct bond, at least one R^{B} is R*, and the compound comprises at least one L^{B}, which is a phenylpyridine ligand with a silane substituent on the pyridine ring. In some such embodiments, the silane is Si(CH₃)₃ or Si(C₆H₅)₃.

In some embodiments, M is Ir, A is unfused pyridine, Z² is N, B is unfused phenyl, K is a direct bond, at least one R^{A} is R*, and L comprises at least one linker selected from the group consisting of aryl, heteroaryl, and cycloalkyl. In some embodiments, L comprises cycloalkyl. In some embodiments, L comprises aryl. In some embodiments, L comprises phenyl, pyridyl, pyrimidinyl, pyridazinyl, pyrazinyl, triazinyl, imidazolyl, pyrazolyl, pyrrolyl, oxazolyl, furanyl, thiophenyl, or thiazolyl. In some embodiments, L comprises cyclohexyl, cyclopentyl, or fluorenyl.

With respect to proviso (vi), the term "ring atom" includes atoms that are part of the backbone of any ring, including a ring that includes the metal M (e.g., a metallated ring).

In some embodiments, M is Ir, L is a direct bond, Z² is N, at least one R^{A} is R*, and Z² is not part of a unfused pyridine ring or a fused pyridine ring with all additional fused rings being phenyl ring. In some such embodiments, the pyridine ring including Z² is fused to a 5-membered ring or a 6-membered heterocyclic ring. In some such embodiments, the pyridine ring including Z² is fused to a ring selected from the group consisting of pyridine, pyrimidine, pyridazine, pyrazine, triazine, imidazole, pyrazole, pyrrole, oxazole, furan, thiophene, and thiazole.

In some embodiments, L^{Z} is a direct bond. In some embodiments, L^{Z} is an organic linker selected from the group consisting of BR, BRR', NR, PR, P(O)R, O, S, Se, C=O, C=S, C=Se, C=NR, C=CRR', S=O, SO₂, CR, CRR', SiRR', and GeRR', wherein each R and R' is independently selected from the group consisting of the Preferred General Substituents defined herein. It should be understood that when L^{Z} is a direct bond, Formula Ia is identical to Formula I, and all the embodiments applicable to Formula I should be applicable to Foruma Ia.

In some embodiments, each R^{A} and R^{B} is independently selected from the group consisting of the Preferred General Substituents defined herein. In some embodiments, each R^{A} and R^{B} is independently selected from the group consisting of the More Preferred General Substituents defined herein. In some embodiments, each R^{A} and R^{B} is independently selected from the group consisting of the Most Preferred General Substituents defined herein.

In some embodiments, each of Z¹, Z³, and Z⁴ is C, and Z² is N.

In some embodiments, K is a direct bond. In some embodiments, K is O. In some embodiments, K is S.

In some embodiments, moiety A is an unfused monocyclic ring. In some embodiments, moiety A is selected from the group consisting of phenyl, pyridine, pyrimidine, pyridazine, pyrazine, triazine, imidazole, pyrazole, pyrrole, oxazole, furan, thiophene, and thiazole.

In some embodiments, moiety A is unfused pyridine.

In some embodiments, moiety A is not unfused pyridine. In some embodiments, moiety A is a polycyclic fused-ring system. In some embodiments, moiety A is selected from the group consisting of naphthalene, quinoline, isoquinoline, quinazoline, benzofuran, benzoxazole, benzothiophene, benzothiazole, benzoselenophene, indene, indole, benzimidazole, carbazole, dibenzofuran, dibenzothiophene, quinoxaline, phthalazine, phenanthrene, phenanthridine, and fluorene.

In some embodiments where moiety A is not an unfused pyridine ring, Z² is N and is part of a pyridine ring.

In some embodiments where moiety A is not an unfused pyridine ring, Z² is N, but is not part of a pyridine ring.

In some embodiments, moiety B is a monocyclic ring. In some embodiments, moiety B is a non-aromatic ring. In some embodiments, moiety B is a cycloalkyl ring. In some embodiments, moiety B is selected from the group consisting of cyclopentane, cyclohexane, and cycloheptane.

In some embodiments, moiety B is selected from the group consisting of phenyl, pyridine, pyrimidine, pyridazine, pyrazine, triazine, imidazole, pyrazole, pyrrole, oxazole, furan, thiophene, and thiazole.

In some embodiments, moiety B is unfused phenyl.

In some embodiments, moiety B is selected from the group consisting of cyclopentane, cyclohexane, cycloheptane, and fluorene.

In some embodiments, moiety B is a polycyclic fused-ring system. In some embodiments, moiety B is selected from the group consisting of naphthalene, quinoline, isoquinoline, quinazoline, benzofuran, benzoxazole, benzothiophene, benzothiazole, benzoselenophene, indene, indole, benzimidazole, carbazole, dibenzofuran, dibenzothiophene, quinoxaline, phthalazine, phenanthrene, and phenanthridine.

In some embodiments, moiety B is not naphthalene.

In some embodiments, two R^{A} are joined to form a ring. In some embodiments, the ring formed by two R^{A} is a 5-membered or 6-membered carbocyclic or heterocyclic ring. In some embodiments, the ring formed by two R^{A} is selected from the group consisting of benzene, pyridine, pyrimidine, pyridazine, pyrazine, triazine, imidazole, pyrazole, pyrrole, oxazole, furan, thiophene, and thiazole.

In some embodiments, two R^{B} are joined to form a ring. In some embodiments, the ring formed by two R^{B} is a 5-membered or 6-membered carbocyclic or heterocyclic ring. In some embodiments, the ring formed by two R^{B} is selected from the group consisting of benzene, pyridine, pyrimidine, pyridazine, pyrazine, triazine, imidazole, pyrazole, pyrrole, oxazole, furan, thiophene, and thiazole.

In some embodiments, each of moiety A and moiety B can independently be a polycyclic fused ring structure. In some embodiments, each of moiety A and moiety B can independently be a polycyclic fused ring structure comprising at least three fused rings. In some embodiments, the polycyclic fused ring structure has two 6-membered rings and one 5-membered ring. In some such embodiments, the 5-membered ring is fused to the ring coordinated to metal M and the second 6-membered ring is fused to the 5-membered ring. In some embodiments, each of moiety A and moiety B can independently selected from the group consisting of dibenzofuran, dibenzothiophene, dibenzoselenophene, and aza-variants thereof. In some such embodiments, each of moiety A and moiety B can independently be further substituted at the ortho- or meta-position of the O, S, or Se atom by a substituent selected from the group consisting of deuterium, fluorine, nitrile, alkyl, cycloalkyl, aryl, heteroaryl, and combinations thereof. In some such embodiments, the aza-variants contain exactly one N atom at the 6-position (ortho to the O, S, or Se) with a substituent at the 7-position (meta to the O, S, or Se).

In some embodiments, each of moiety A and moiety B can independently be a polycyclic fused ring structure comprising at least four fused rings. In some embodiments, the polycyclic fused ring structure comprises three 6-membered rings and one 5-membered ring. In some such embodiments, the 5-membered ring is fused to the ring coordinated to metal M, the second 6-membered ring is fused to the 5-membered ring, and the third 6-membered ring is fused to the second 6-membered ring. In some such embodiments, the third 6-membered ring is further substituted by a substituent selected from the group consisting of deuterium, fluorine, nitrile, alkyl, cycloalkyl, aryl, heteroaryl, and combinations thereof.

In some embodiments, each of moiety A and moiety B can independently be a polycyclic fused ring structure comprising at least five fused rings. In some embodiments, the polycyclic fused ring structure comprises four 6-membered rings and one 5-membered ring or three 6-membered rings and two 5-membered rings. In some embodiments comprising two 5-membered rings, the 5-membered rings are fused together. In some embodiments comprising two 5-membered rings, the 5-membered rings are separated by at least one 6-membered ring. In some embodiments with one 5-membered ring, the 5-membered ring is fused to the ring coordinated to metal M, the second 6-membered ring is fused to the 5-membered ring, the third 6-membered ring is fused to the second 6-membered ring, and the fourth 6-membered ring is fused to the third 6-membered ring.

In some embodiments, each moiety A and moiety B can independently be an aza version of the polycyclic fused rings described above. In some such embodiments, each moiety A and moiety B can independently contain exactly one aza N atom. In some such embodiments, each moiety A and moiety B can contain exactly two aza N atoms, which can be in one ring, or in two different rings. In some such embodiments, the ring having aza N atom is separated by at least two other rings from the metal M atom. In some such embodiments, the ring having aza N atom is separated by at least three other rings from the metal M atom. In some such embodiments, each of the ortho position of the aza N atom is substituted.

In some embodiments, the Ge in R* does not belong to any ring atom.

In some embodiments, at least one R^{A} is R*. In some embodiments, moiety A is a polycyclic fused-ring system and at least one R^{A} is bonded to the ring that includes Z² is R*. In some such embodiments, the polycyclic fused-ring system of moiety A includes at least one ring selected from the group consisting of imidazole, pyrazole, pyrrole, oxazole, furan, thiophene, and thiazole.

In some embodiments, moiety A is a polycyclic fused-ring system and at least one R^{A} bonded to a ring that does not include Z² is R*.

In some embodiments, at least one R^{B} is R*. In some embodiments, moiety B is a polycyclic fused-ring system and at least one R^{B} bonded to the ring that includes Z⁴ is R*. In some embodiments, moiety B is a polycyclic fused-ring system and at least one R^{B} bonded to a ring that does not include Z⁴ is R*.

In some embodiments, each of R¹, R², and R³ is independently alkyl, which can be partially or fully deuterated, partially or fully fluorinated. In some such embodiments, each of R¹, R², and R³ is independently selected from the group consisting of methyl, ethyl, propyl, isopropyl, n-butyl, and t-butyl.

In some embodiments, each of R¹, R², and R³ is independently aryl, which can be partially or fully deuterated, partially or fully fluorinated. In some embodiments, each of R¹, R², and R³ is independently phenyl, which can be partially or fully deuterated, partially or fully fluorinated.

In some embodiments, none of R¹, R², and R³ is joined or fused with another substituent. In some embodiments, R¹, R², and R³ are joined to form a ring. In some embodiments, L is a direct bond.

In some embodiments, L is selected from the group consisting of BR, BRR', NR, PR, P(O)R, O, S, Se, C=O, C=S, C=Se, C=NR', C=CR'R", S=O, SO₂, CR, CRR', SiRR', GeRR', alkylene, cycloalkyl, aryl, cycloalkylene, arylene, heteroarylene, and combinations thereof; and each R and R' is independently a hydrogen or a substituent selected from the group consisting of the General Substituents defined herein.

In some embodiments, L comprises aryl or heteroaryl. In some embodiments, L is aryl. In some embodiments, L is selected from the group consisting of phenyl, biphenyl, terphenyl, pyridine, pyrimidine, pyridazine, pyrazine, triazine, imidazole, pyrazole, pyrrole, oxazole, furan, thiophene, and thiazole, naphthalene, quinoline, isoquinoline, quinazoline, benzofuran, benzoxazole, benzothiophene, benzothiazole, benzoselenophene, indene, indole, benzimidazole, carbazole, dibenzofuran, dibenzothiophene, quinoxaline, phthalazine, phenanthrene, phenanthridine, and fluorene, which may be further substituted.

In some embodiments, L is phenyl or biphenyl, which may be further substituted by a substituent selected from the group consisting of the General Substituents defined herein.

In some of the above embodiemnts, any substituents of L can be joined or fused to form a ring with its neighboring substituents. In some embodiments, substituents of L may be joined or fused with R¹, R², and R³ to form a ring.

In some embodiments, Ge in R* directly attaches to moiety A, or B.

In some embodiments, Ge in R* does not directly attach to moiety A, or B.

In some embodiments, Ge in R* belongs to a ring atom of a first ring.

In some embodiments, Ge in R* belongs to a ring atom of a first ring which is fused to moiety A, or B.

In some embodiments, Ge in R* belongs to a ring atom of a first ring which is fused to one or more rings before fused to moiety A, or B.

In some embodiments, Ge in R* belongs to a ring atom of a first ring which is fused to one or more rings but not fused to moiety A, or B.

In some embodiments, metal M is Ir. In some embodiments, metal M is Pt or Pd.

In some embodiments, moiety B is not monocyclic (e.g., unfused) phenyl. In some embodiments, L_{A} is a tetradentate ligand. In some embodiments, none of R¹, R², or R³ join with R^{A} or R^{B} to form a ring.

In some embodiments, the ligand L_{A} is selected from the group consisting of the structures of the following LIST 1: 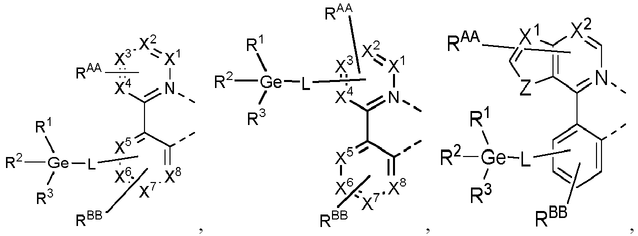 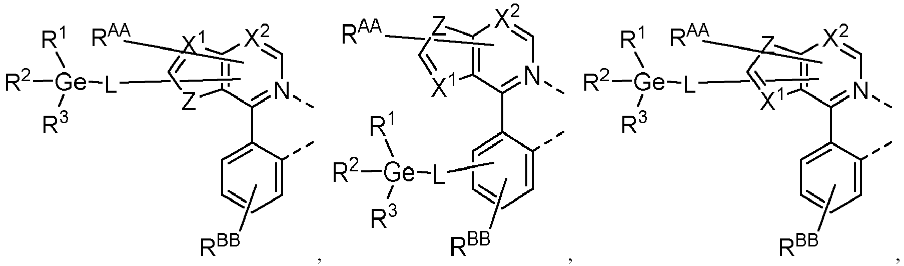 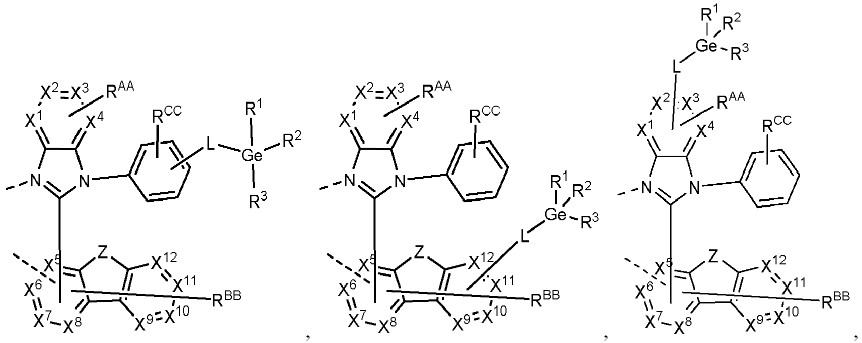 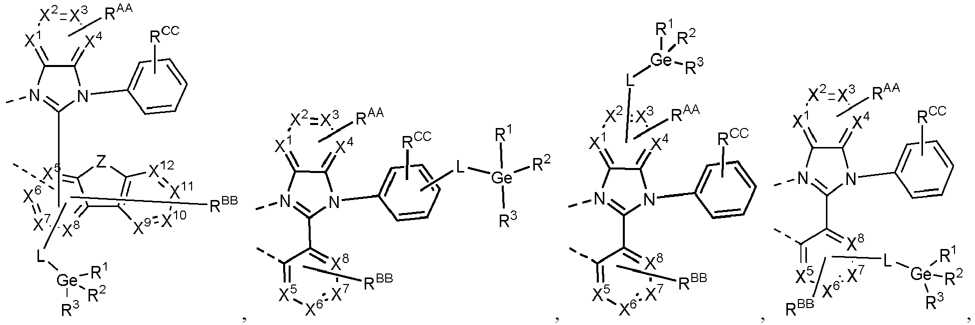 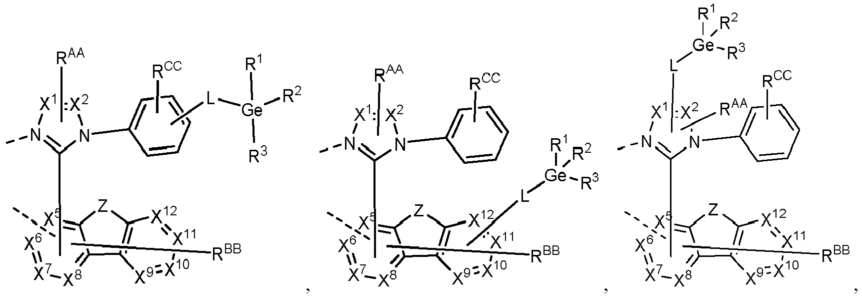 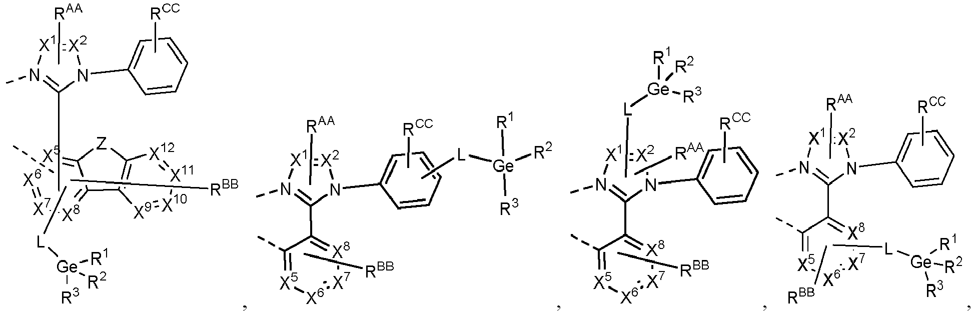 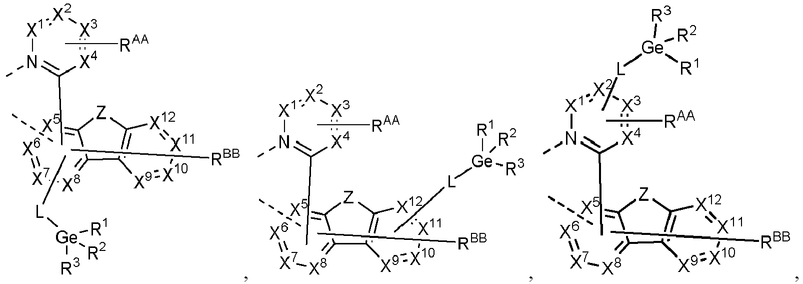 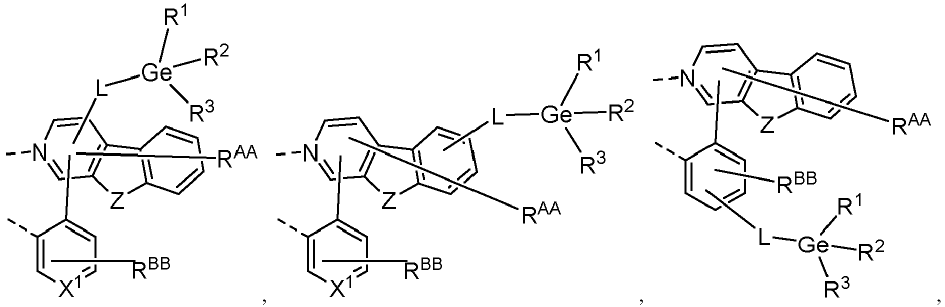 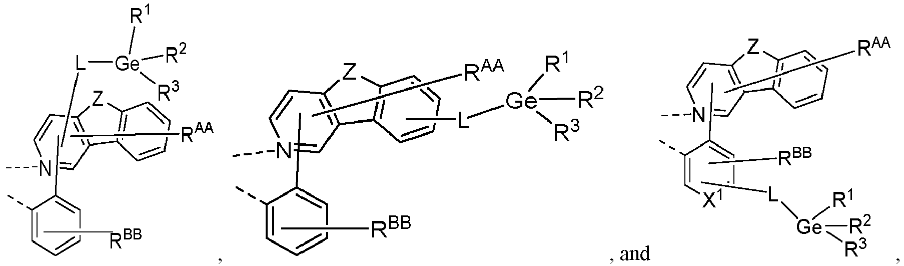 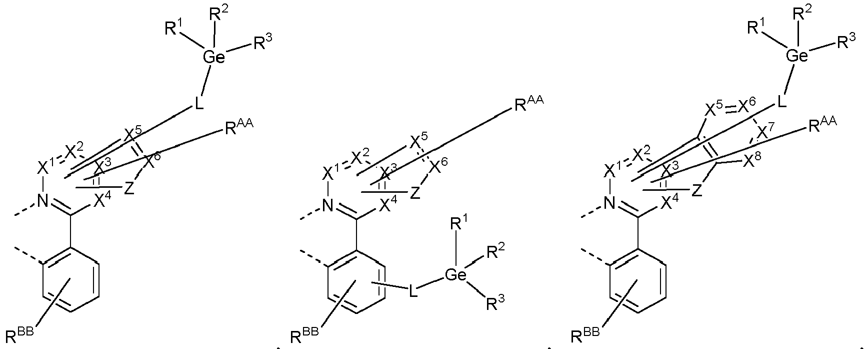 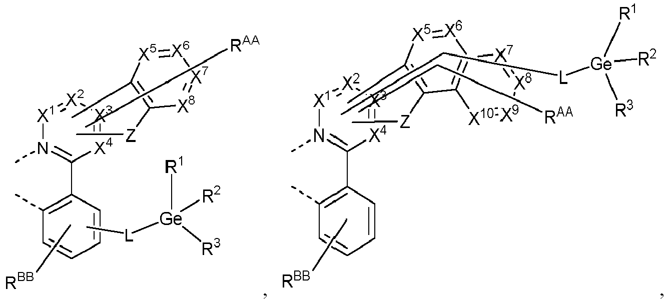 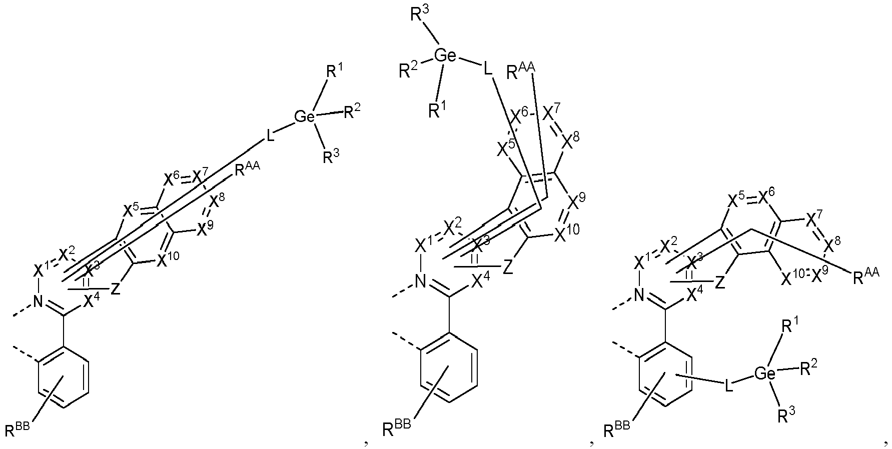 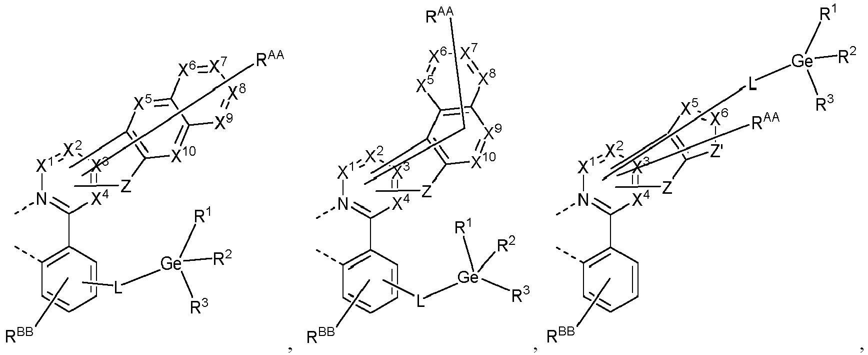 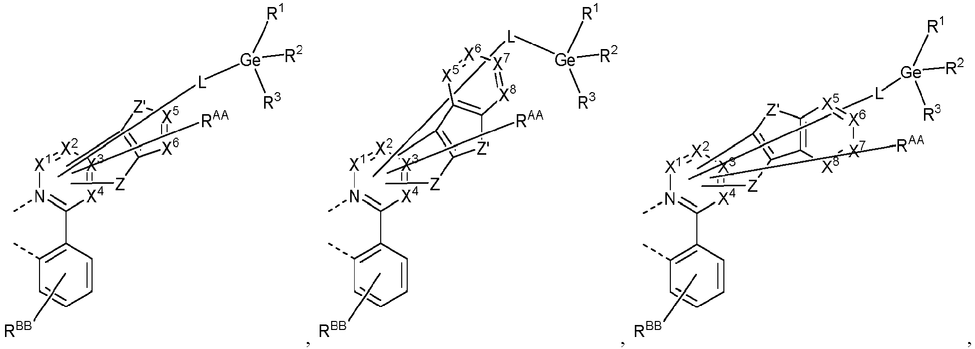 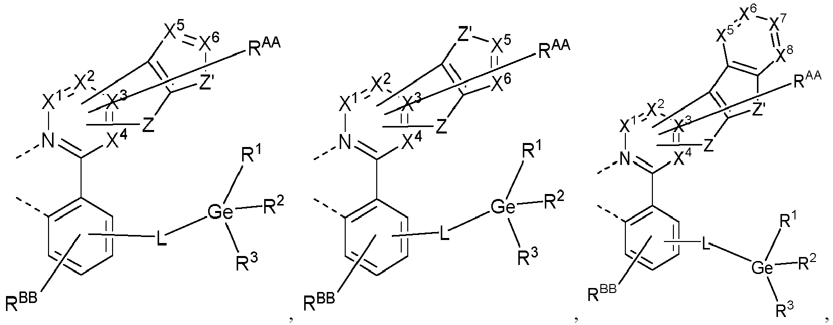 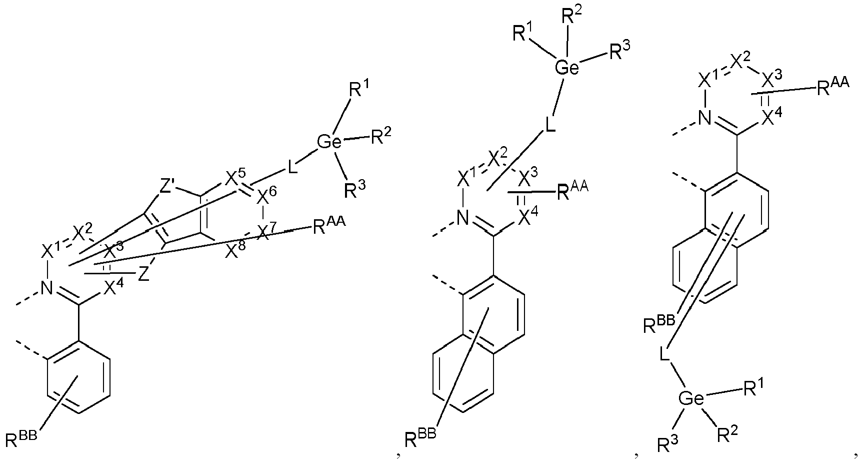 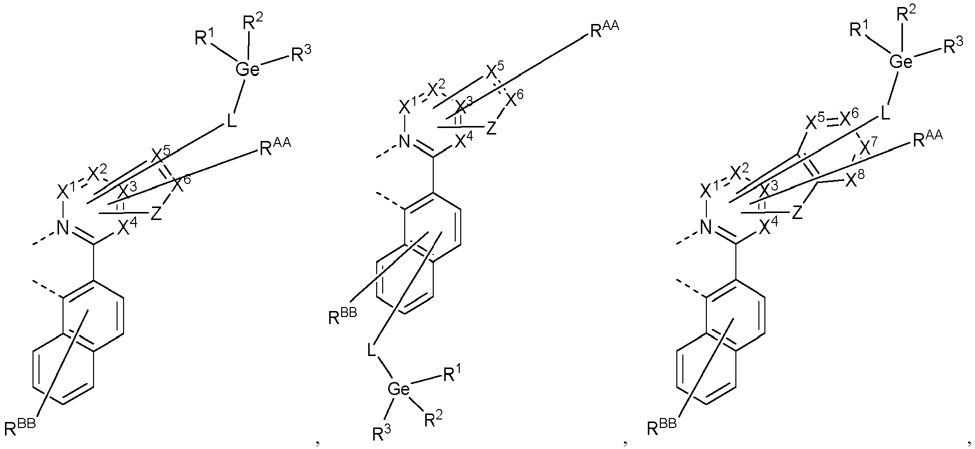 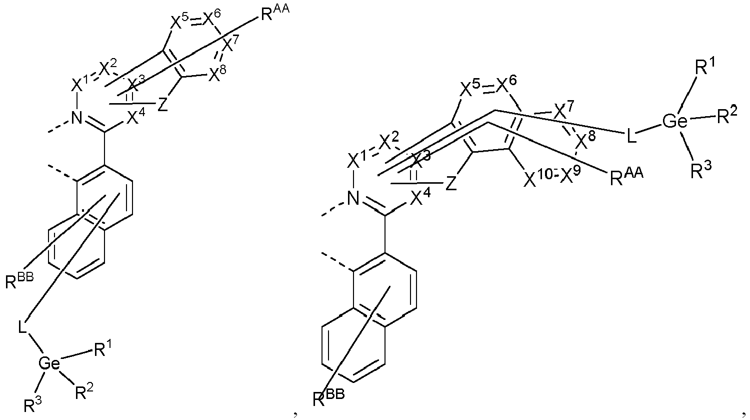 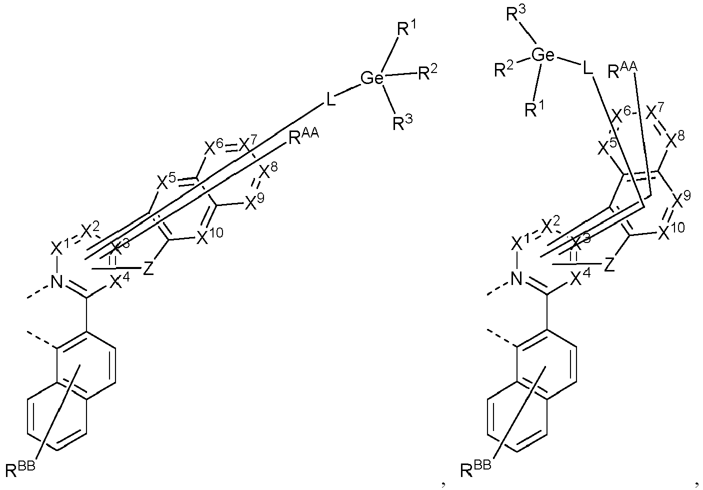 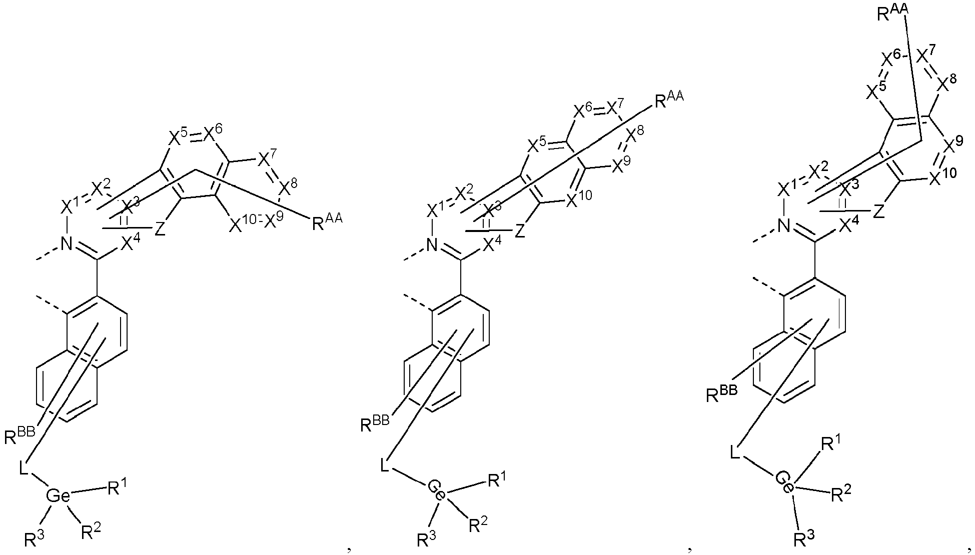 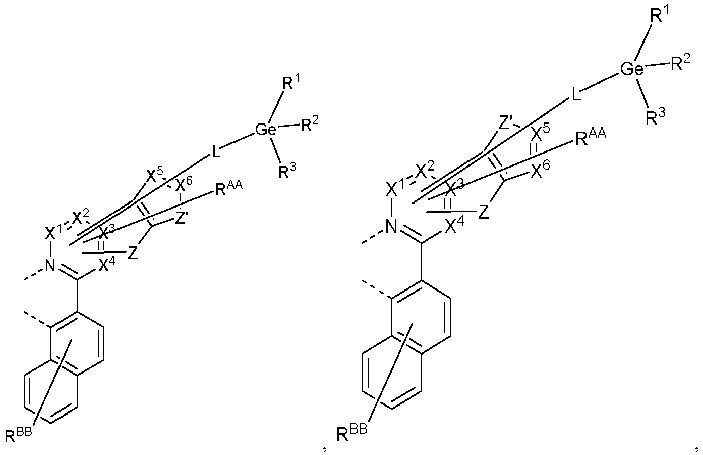 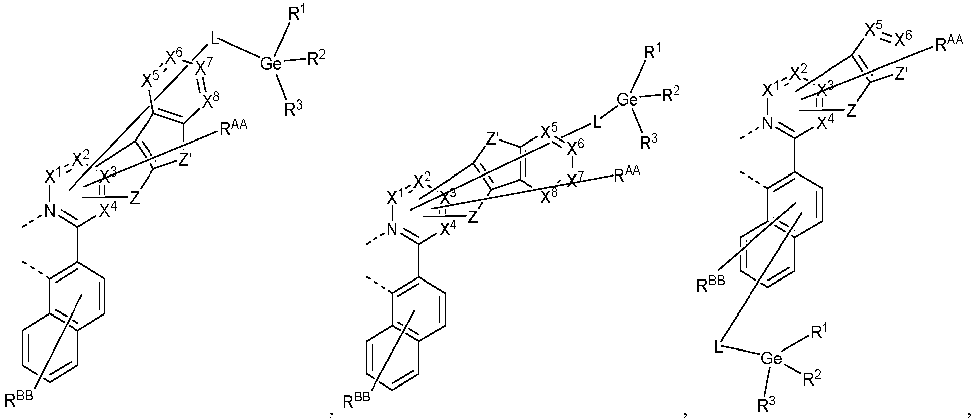 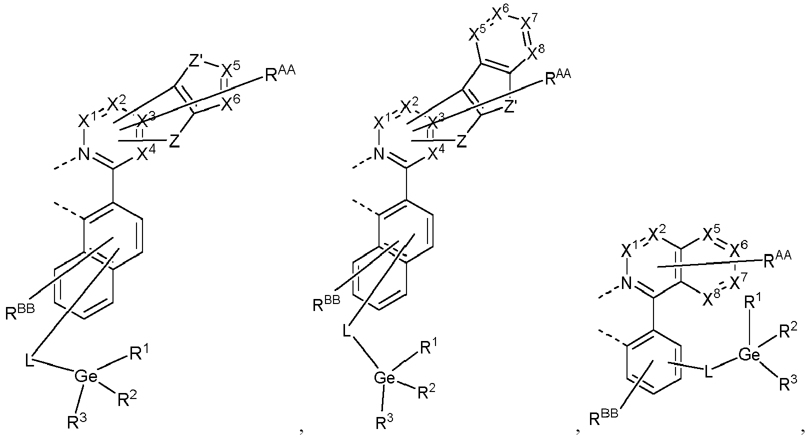 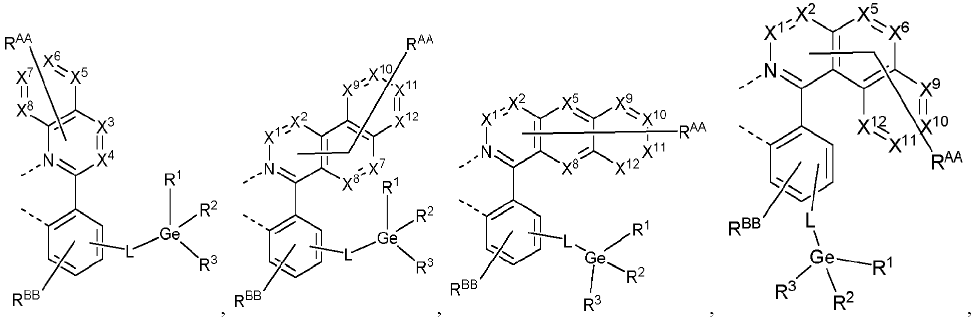 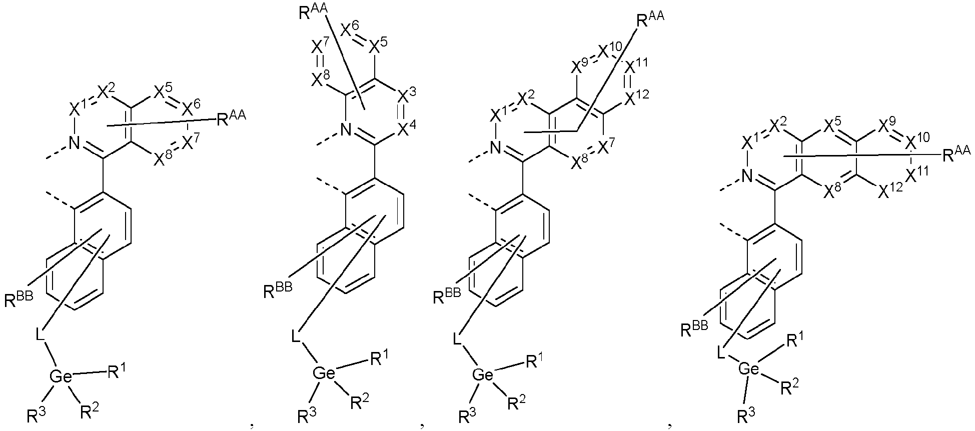 , and 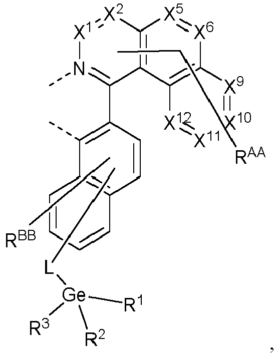 wherein:
X¹-X¹² are each independently C or N;
each of Z and Z' is independently selected from the group consisting of BR, BRR', NR, PR, P(O)R, O, S, Se, C=O, C=S, C=Se, C=NR, C=CRR', S=O, SO₂, CR, CRR', SiRR', and GeRR';
each of R^{AA}, R^{BB}, and R^{CC} independently represents mono- up to the maximum possible number of substitutions, or no substitutions;
each R, R', R^{AA}, R^{BB}, and R^{CC} is independently a hydrogen or a substituent selected from the group consisting of the General Substituents; and
any two substituents can be joined or fused to form a ring.

In some embodiments, the ligand L_{A} is selected from the group consisting of the structures of the following LIST 2: 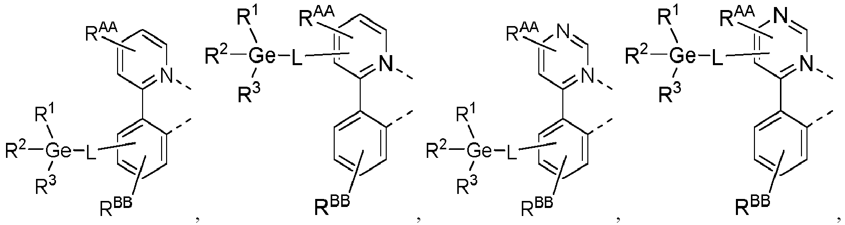 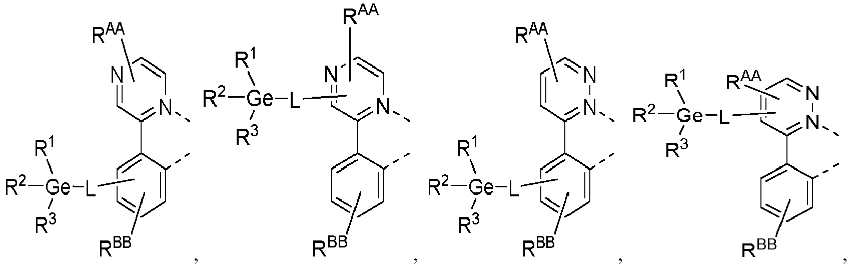 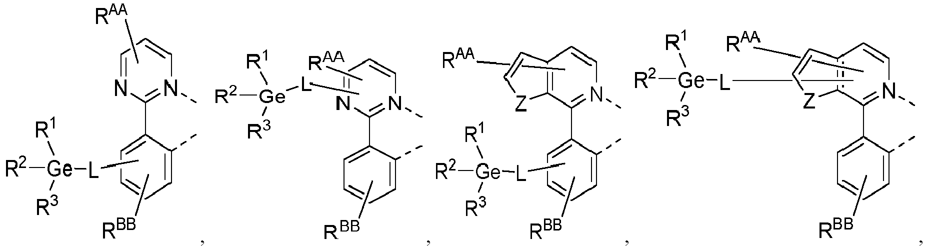 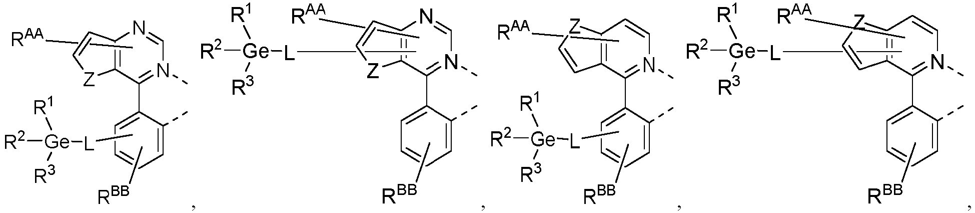 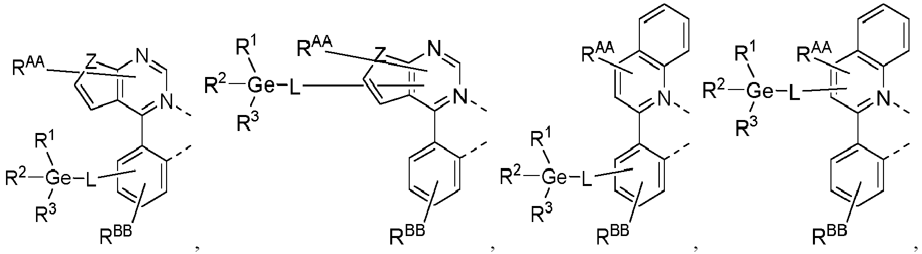 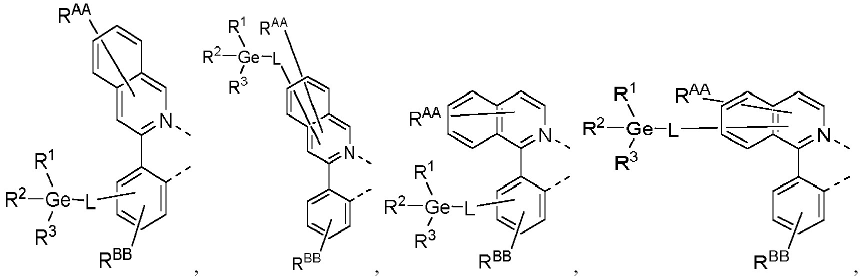 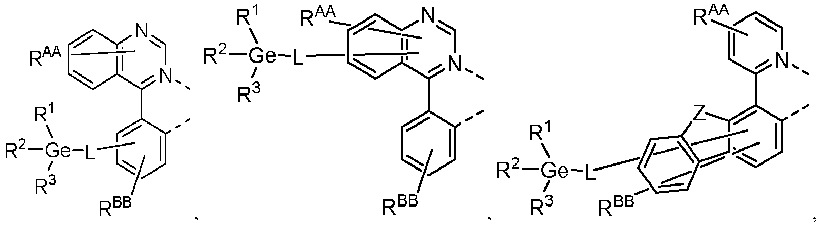 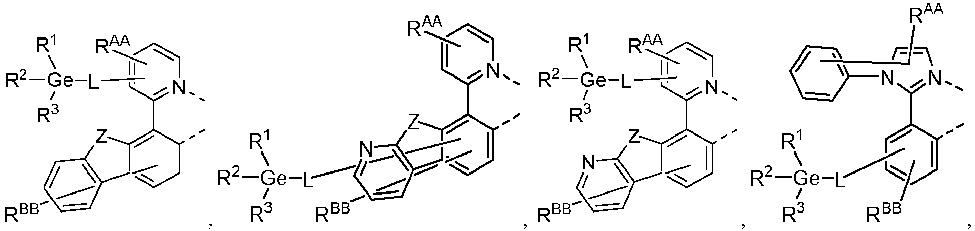 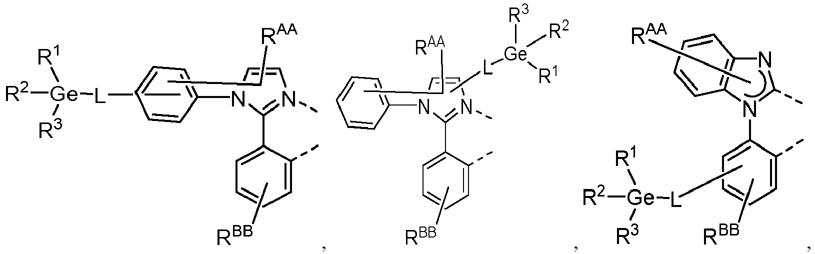 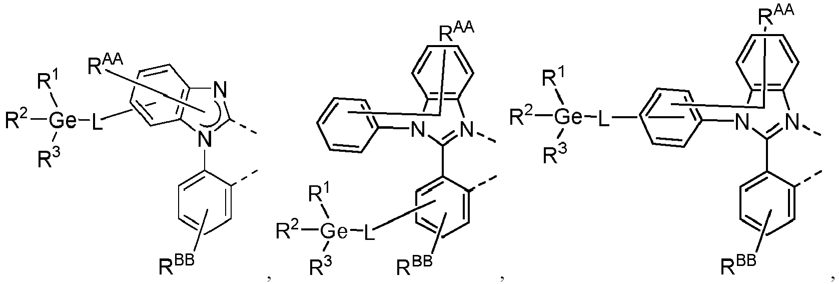 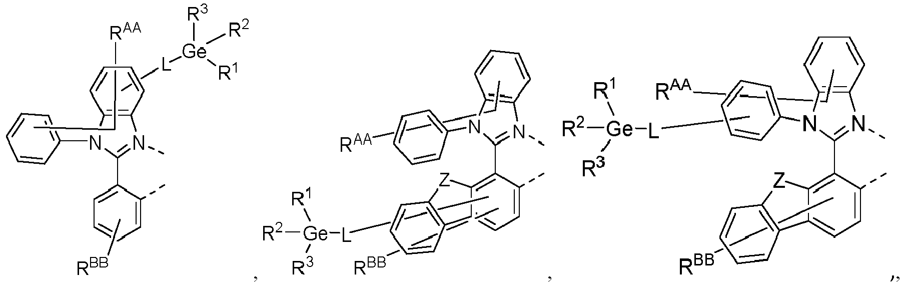 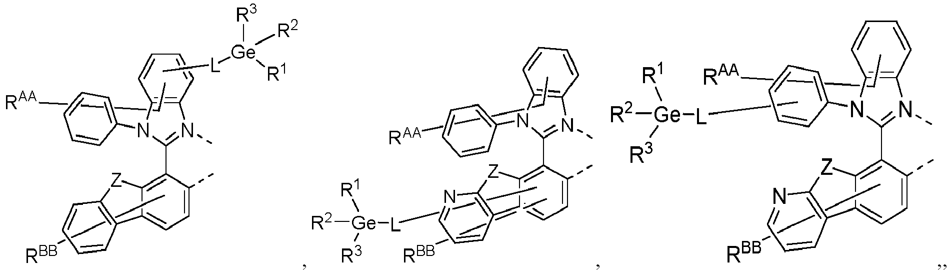 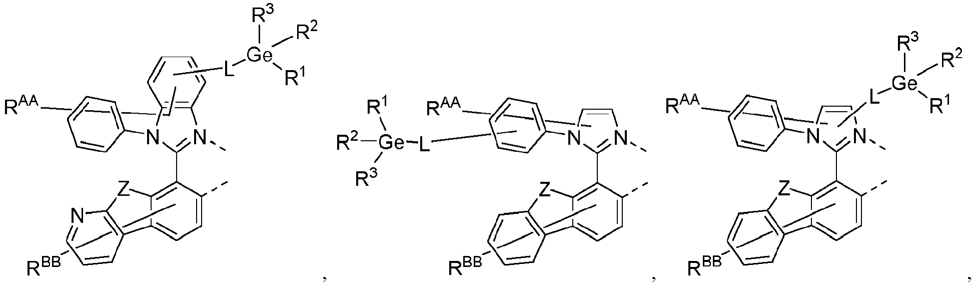 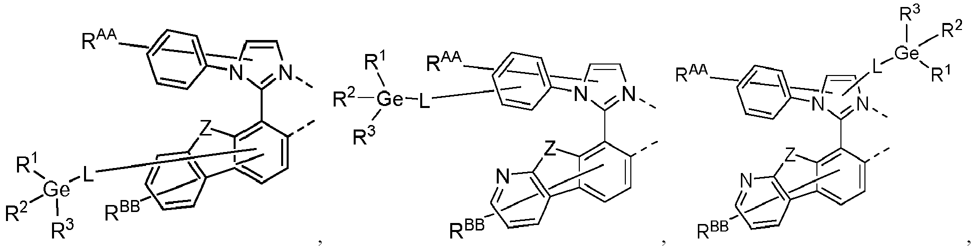 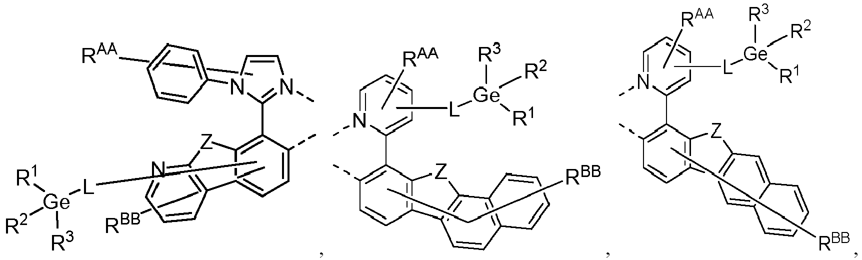 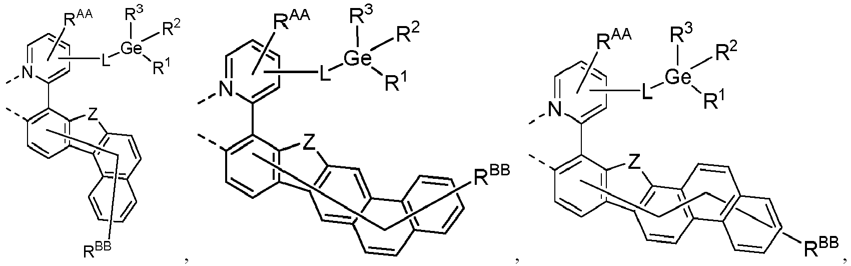 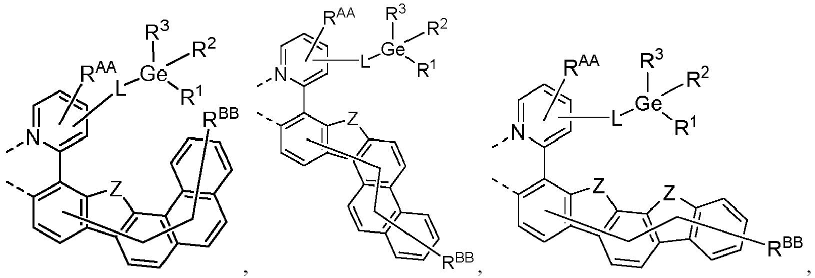 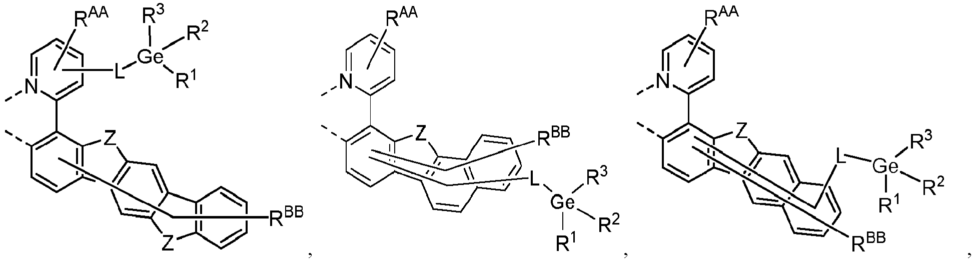 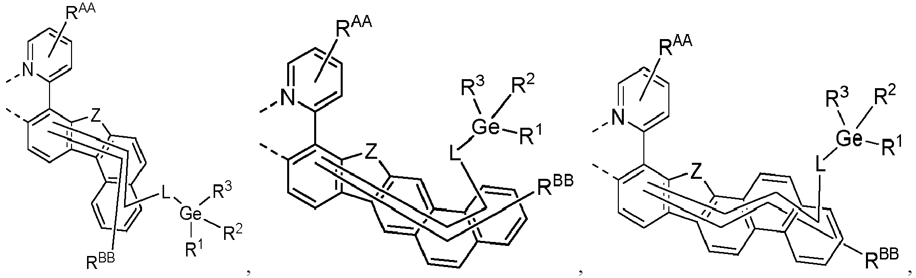 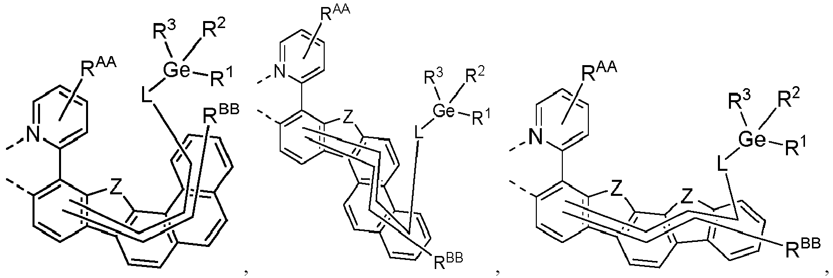 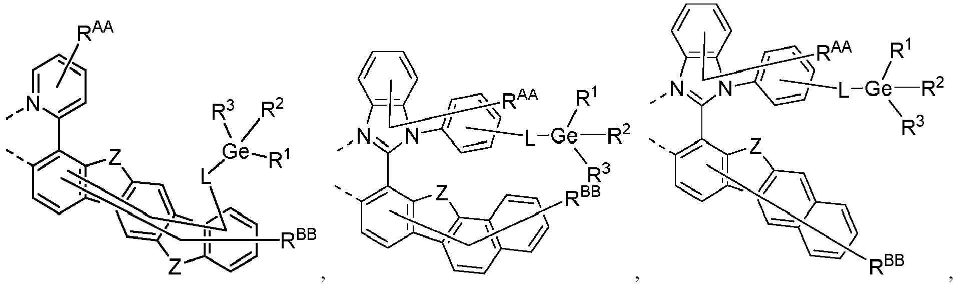 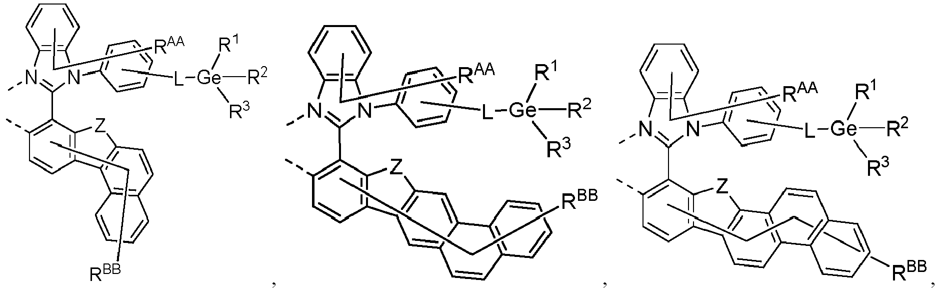 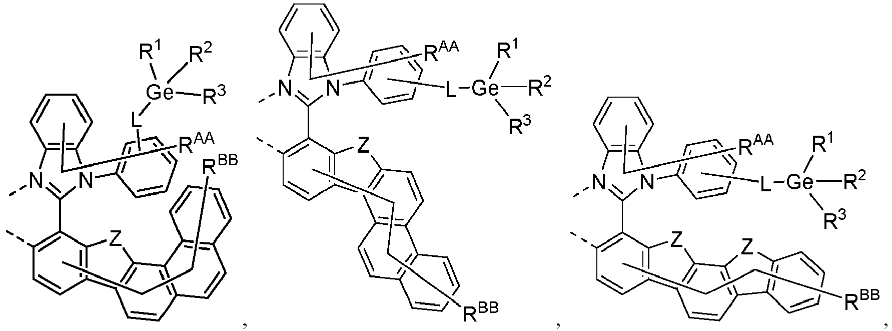 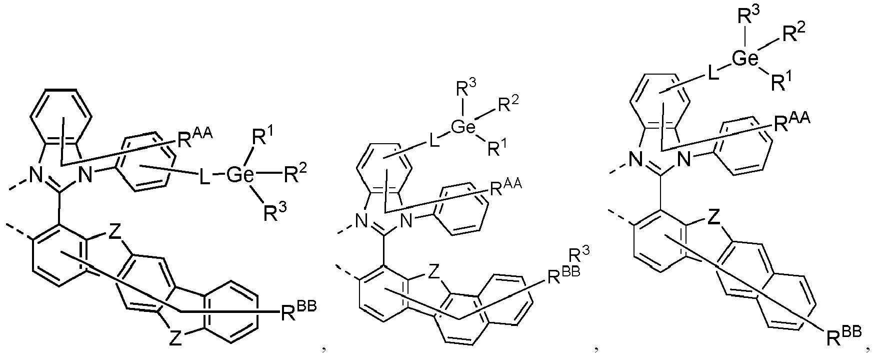 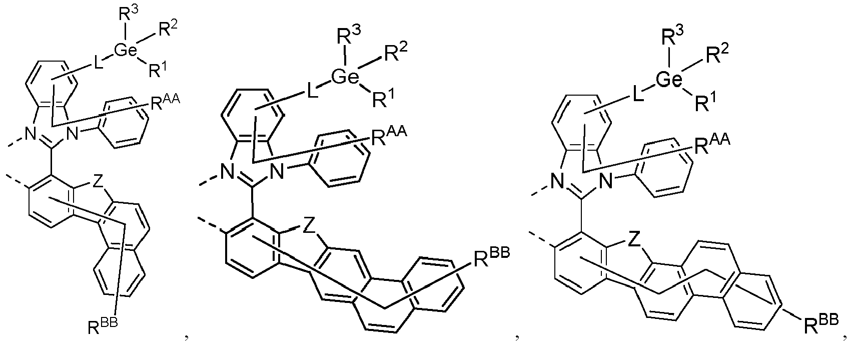 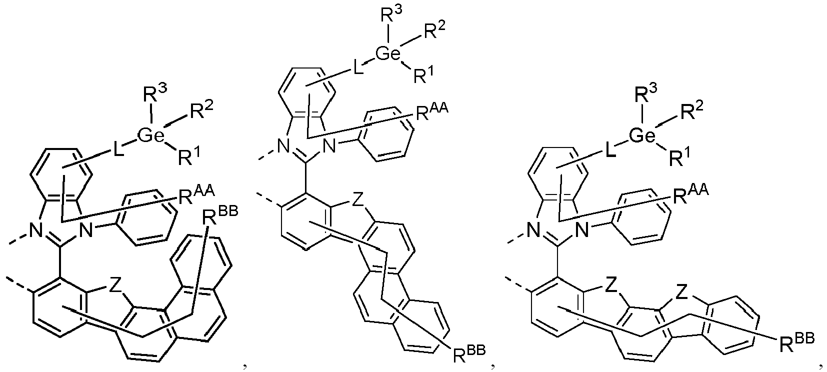 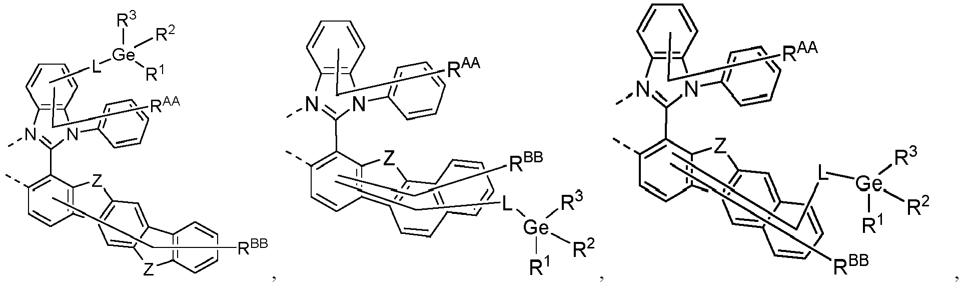 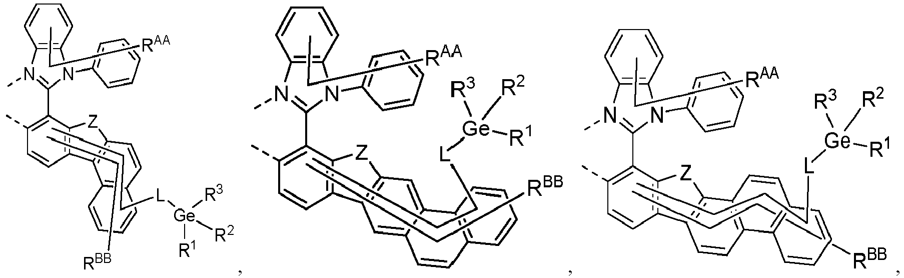 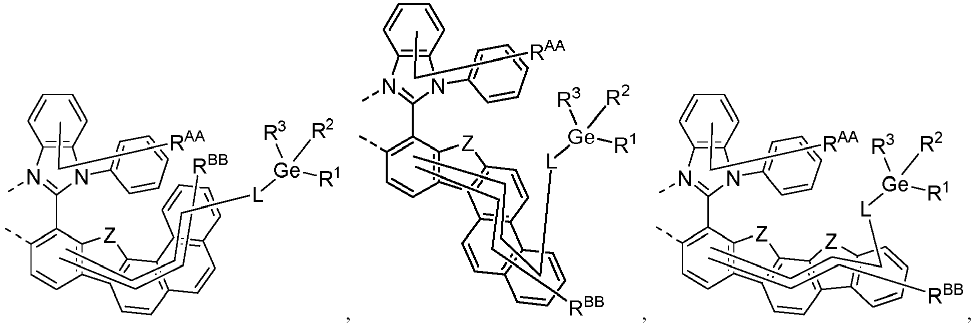 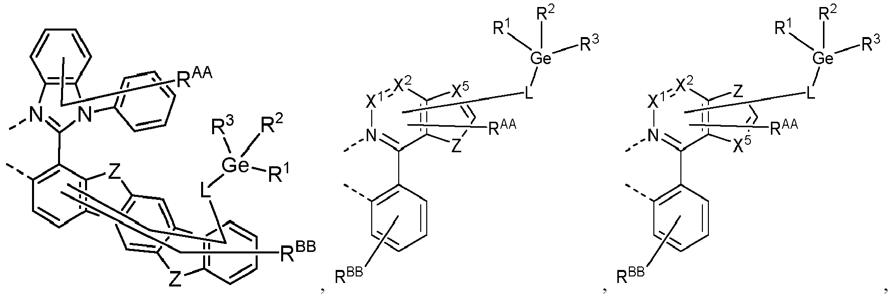 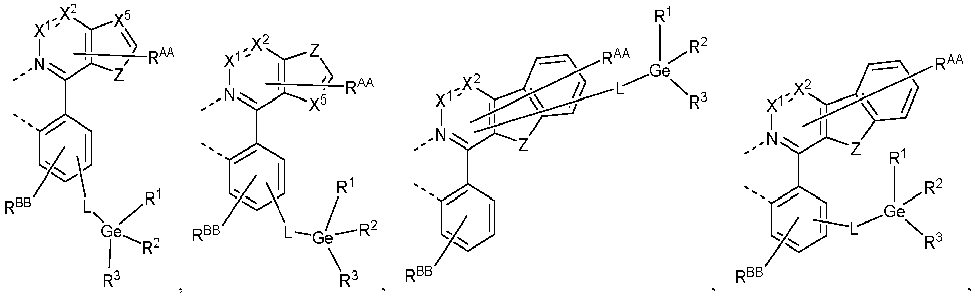 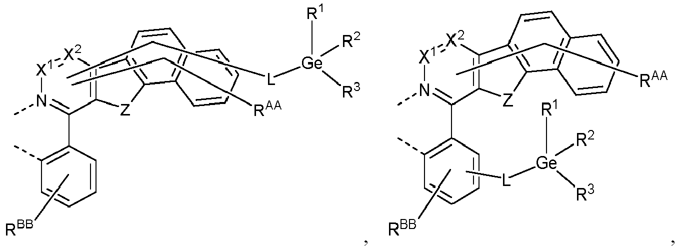 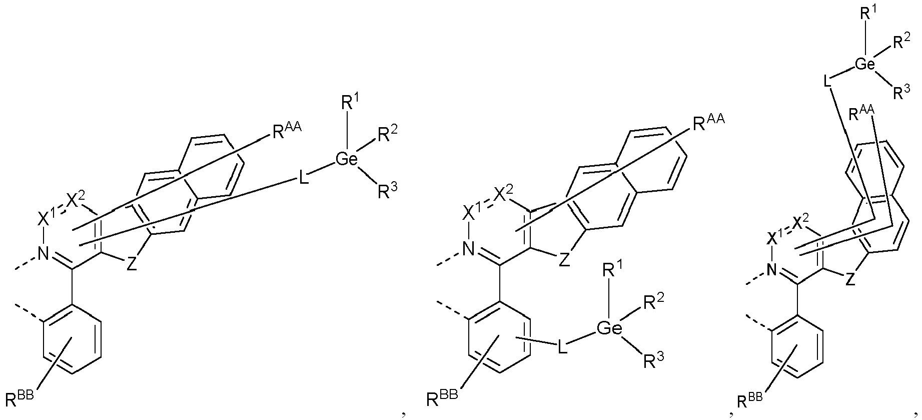 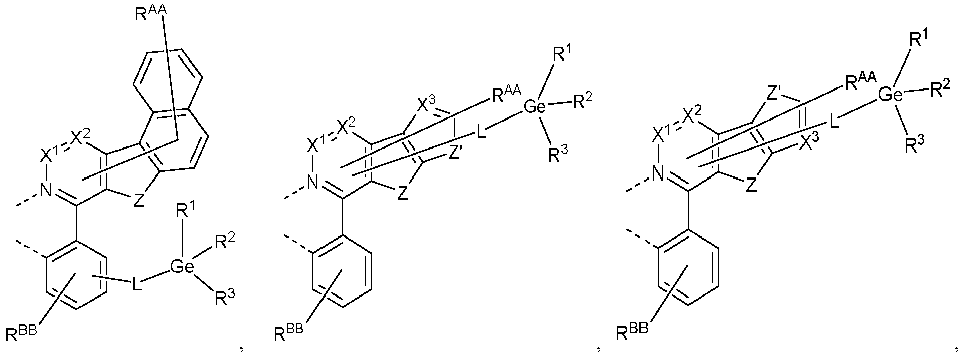 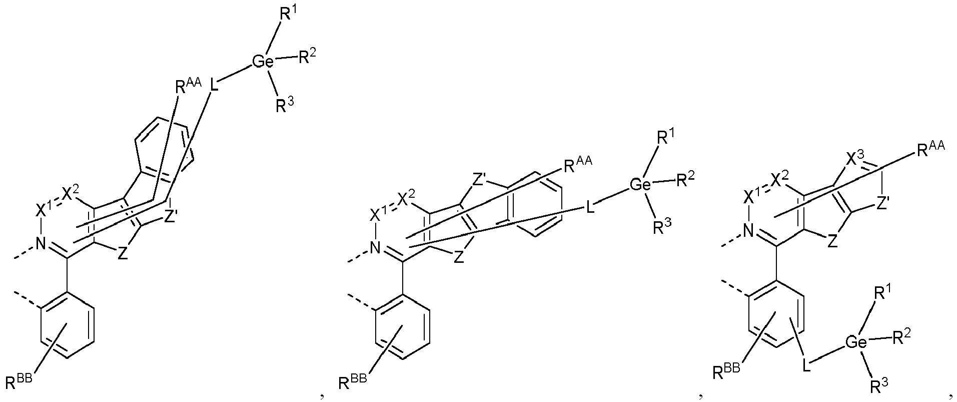 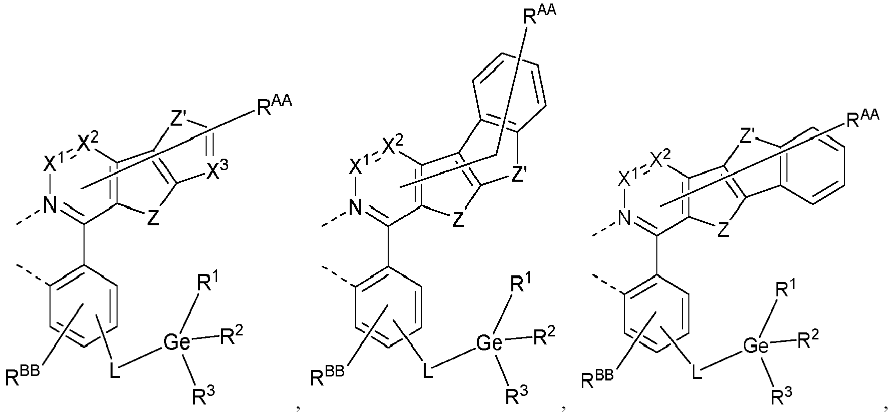 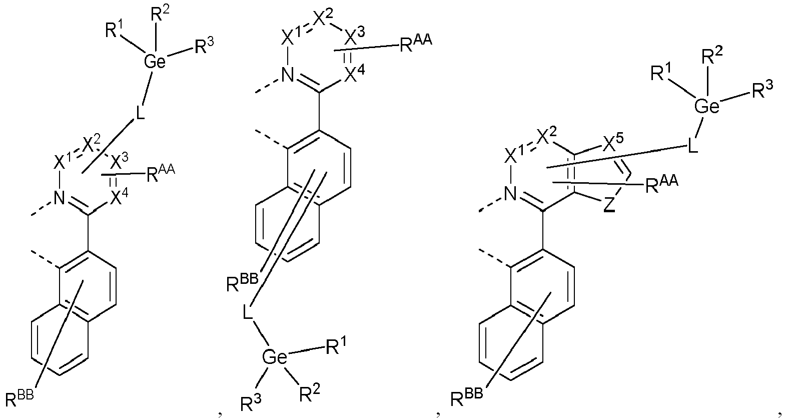 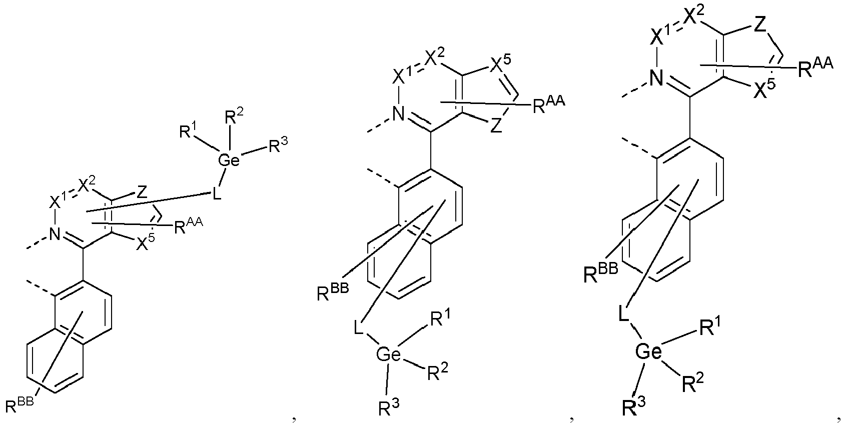 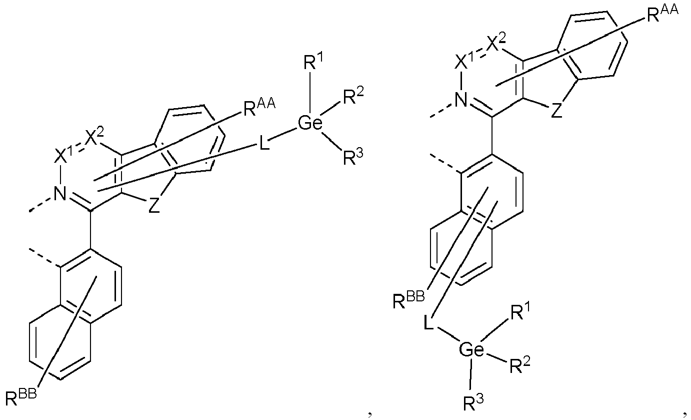 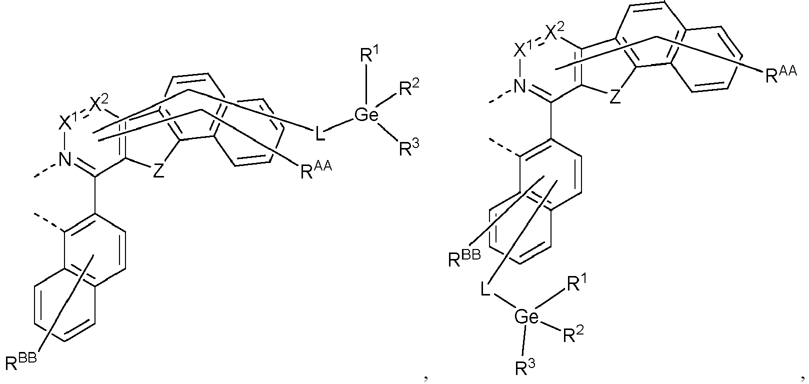 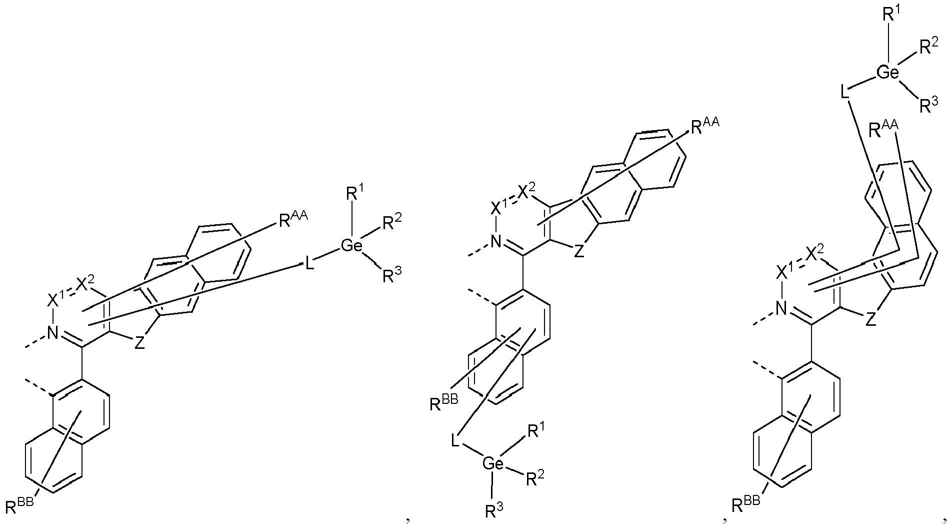 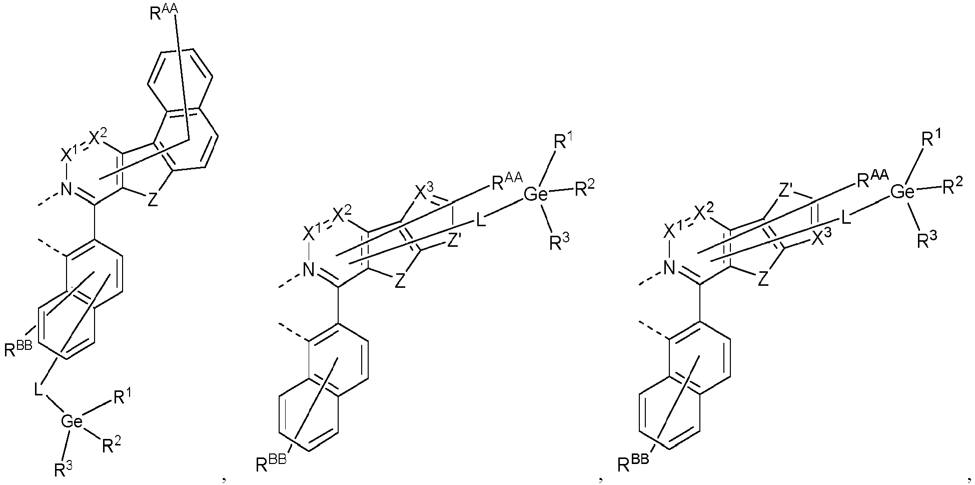 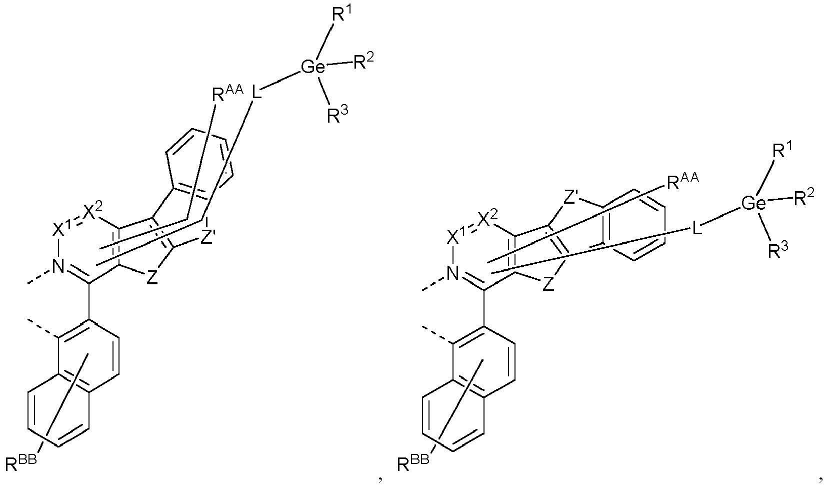 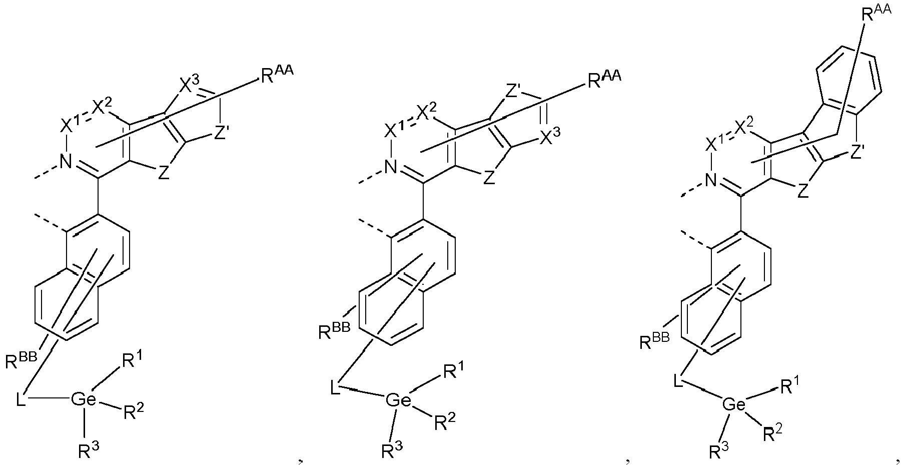 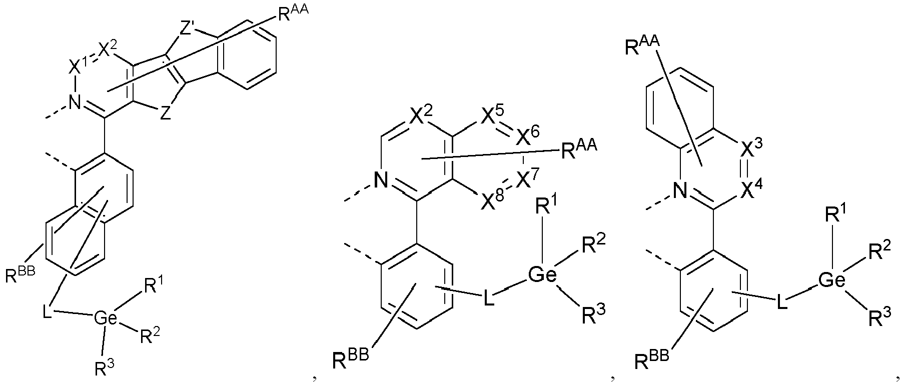 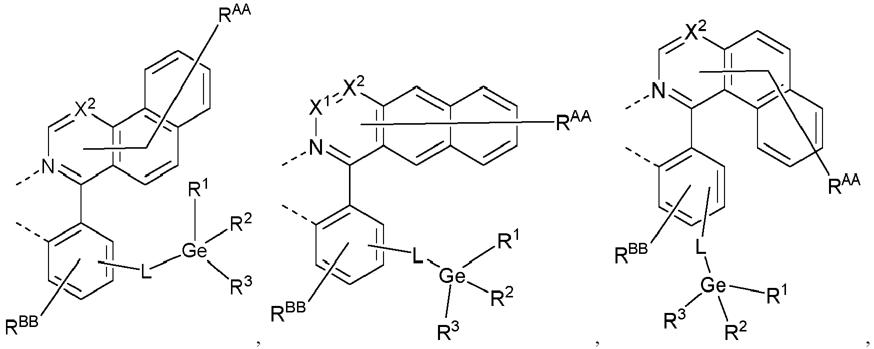 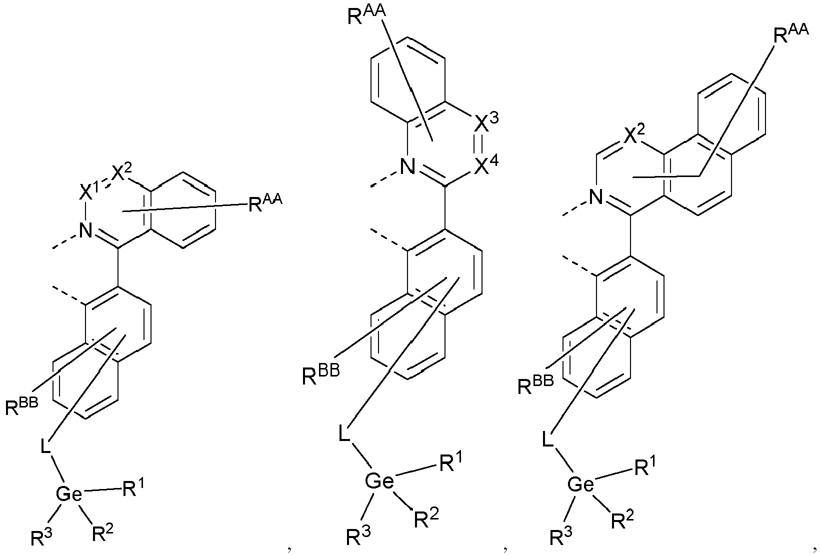 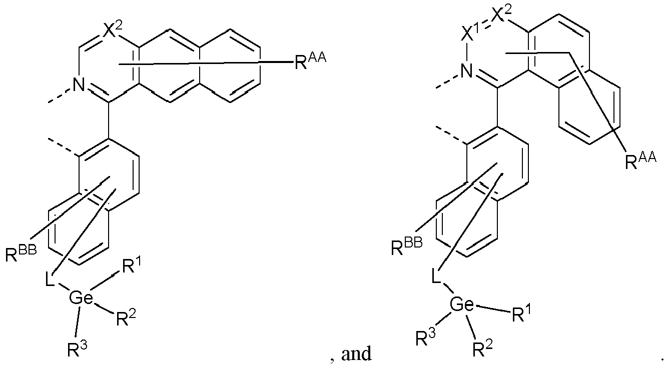 wherein:
Z is selected from the group consisting of BR, BRR', NR, PR, P(O)R, O, S, Se, C=O, C=S, C=Se, C=NR, C=CRR', S=O, SO₂, CR, CRR', SiRR', and GeRR';
each of R^{AA} and R^{BB} independently represents mono- up to the maximum possible number of substitutions, or no substitutions;
each R, R', R^{AA}, and R^{BB} is independently a hydrogen or a substituent selected from the group consisting of the General Substituents defined herein; and
any two substituents can be joined or fused to form a ring.

In some embodiments, the GeR¹R²R³group can be GeMe₃, GeEt₃, Ge(*ⁱ*Pr)₃, Ge(*^{t}*Bu)₃, GePh₃, Ge(CD₃)₃, CH₂GeMe₃, CD₂GeMe₃, GeMeEt₂, GeMe(*ⁱ*Pr)₂, GeMe(*^{t}*Bu)₂, 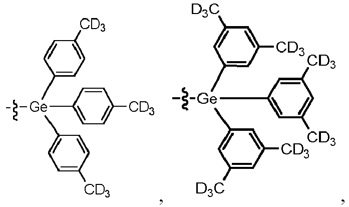 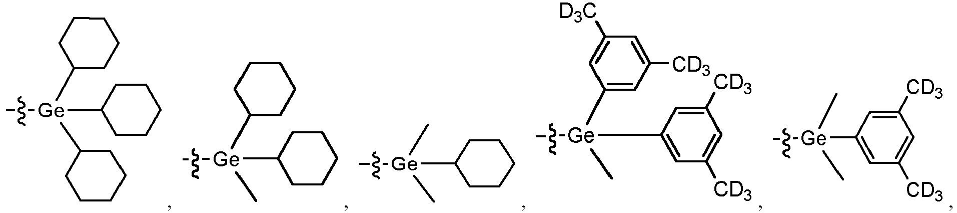 or

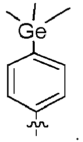

In some embodiments, the GeR¹R²R³group can be

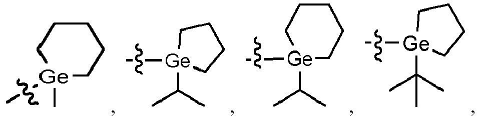

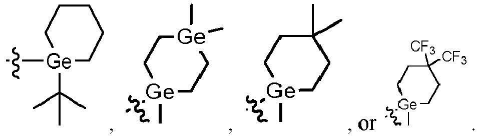

In some embodiments, the ligand L_{A} is selected from the group consisting of L_{A}1-(R^{A1})(R^{A2})(R^{A3})(R^{B1})(L)(R¹)(R²)(R³) to L_{A}2-(R^{A1})(R^{A2})(R^{A3})(R^{B1})(L)(R¹)(R²)(R³), L_{A}3-(R^{A1})(R^{A2})(R^{B1})(R^{B2})(L')(R¹)(R²)(R³) to L_{A}4-(R^{A1})(R^{B2})(L')(R¹)(R²)(R³), L_{A}-(R^{A1})(R^{A2})(R^{B1})(L)(R¹)(R²)(R³) to L_{A}10-(R^{A1})(R^{A2})(R^{B1})(L)(R¹)(R²)(R³),
L_{A}11-(R^{A1})(R^{A2})(R^{A3})(R^{B1})(L)(R¹)(R²)(R³) to L_{A}12-(R^{A1})(R^{A2})(R^{A3})(R^{B1})(L)(R¹)(R²)(R³), L_{A}13-(R^{A1})(R^{A2})(R^{A3})(R^{B1})(L)(R¹)(R²)(R³) to L_{A}20-(R^{A1})(R^{B2})(L)(R¹)(R²)(R³), L_{A}21-(R^{A1})(R^{A2})(R^{A3})(R^{B1})(L)(R¹)(R²)(R³) to L_{A}28-(R^{A1})(R^{A2})(R^{A3})(R^{B1})(L)(R¹)(R²)(R³), L_{A}29-(R^{A1})(R^{A2})(R^{B1})(R^{B2})(L)(R¹)(R²)(R³) to L_{A30}-(R^{A1})(R^{A2})(R^{B1})(R^{B2})(L)(R¹)(R²)(R³), L_{A}31-(R^{A1})(R^{A2})(R^{A3})(R^{B1})(L)(R¹)(R²)(R³) to L_{A}38-(R^{A1})(R^{A2})(R^{A3})(R^{B1})(L)(R¹)(R²)(R³), L_{A}39-(R^{A1})(R^{A2})(R^{A3})(R^{B1})(L)(R¹)(R²)(R³) to L_{A}42-(R^{A1})(R^{A2})(R^{A3})(R^{B1})(R^{B2})(L)(R¹)(R²)(R³) L_{A}43-(R^{A1})(R^{A2})(R^{A3})(R^{B1})(R^{B2})(L)(R¹)(R²)(R³) to L_{A}44-(R^{A1})(R^{B2})(L)(R¹)(R²)(R³), L_{A}45-(R^{A1})(R^{A2})(R^{B1})(L)(R¹)(R²)(R³) to L_{A}100-(R^{A1})(R^{A2})(R^{B1})(L)(R¹)(R²)(R³), L_{A}101-(R^{A1})(R^{A2})(R^{A3})(R^{B1})(L)(R¹)(R²)(R³) to L_{A}118-(R^{A1})(R^{A2})(R^{A3})(R^{B1})(L)(R¹)(R²)(R³), wherein each of R^{A1}, R^{A2}, R^{A3}, R^{B1}, R^{B2}, R¹, R², and R³ is independently selected from structures R¹ to R80, L is selected from structures L1 to L10, and L' is selected from structures L1 to L8, and wherein each of L_{A}1-(R1)(R1)(R1)(R1)(L1)(R1)(R1)(R1) to L_{A}118-(R80)(R80)(R80)(R80)(L10)(R80)(R80)(R80)has the structure defined in the following LIST 3:

| | |
|---|---|
| L_{A}1(R^{A1})(R^{A2})(R^{A3})(R^{B1})(L)(R¹)(R²)(R³), wherein L_{A}1-(R1)(R1)(R1)(R1)(L1)(R1)(R1)(R1) to L_{A}1-(R80)(R80)(R80)(R80)(L10)(R80)(R80)(R80) have the structure | L_{A}2-(R^{A1})(R^{A2})(R^{A3})(R^{B1})(L)(R¹)(R²)(R³), wherein L_{A}2-(R1)(R1)(R1)(R1)(L1)(R1)(R1)(R1) to L_{A}2-(R80)(R80)(R80)(R80)(L10)(R80)(R80)(R80) have the structure |
| 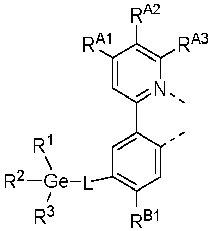 | 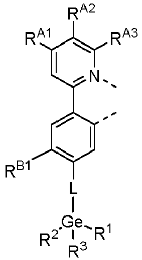 |
| L_{A}3-(R^{A1})(R^{A2})(R^{B1})(R^{B2})(L')(R¹)(R²)(R³), wherein L_{A}3-(R1)(R1)(R1)(R1)(L1)(R1)(R1)(R1) to L_{A}3-(R80)(R80)(R80)(R80)(L8)(R80)(R80)(R80) have the structure | L_{A}4-(R^{A1})(R^{A2})(R^{B1})(R^{B2})(L')(R¹)(R²)(^{R3}),wherein L_{A}4-(R1)(R1)(R1)(R1)(L1)(R1)(R1)(R1) to L_{A}4-(R80)(R80)(R80)(R80)(L10)(R80)(R80)(R80) have the structure |
| 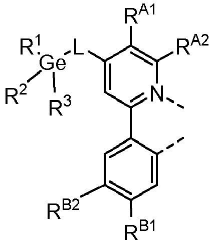 | 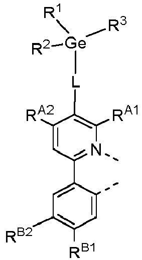 |
| L_{A}5-(R^{A1})(R^{A2})(R^{B1})(L)(R¹)(R²)(R³), wherein L_{A}5-(R1)(R1)(R1)(L1)(R1)(R1)(R1) to L_{A}5-(R80)(R80)(R80)(L10)(R80)(R80)(R80) have the structure | L_{A}6-(R^{A1})(R^{A2})(R^{B1})(L)(R¹)(R²)(R³), wherein L_{A}6-(R1)(R1)(R1)(L1)(R1)(R1)(R1) to L_{A}6-(R80)(R80)(R80)(L10)(R80)(R80)(R80) have the structure |
| 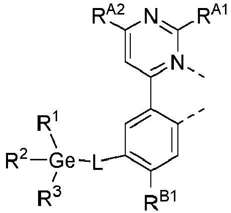 | 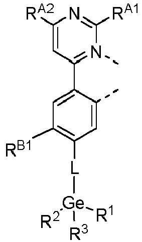 |
| L_{A}7-(R^{A1})(R^{A2})(R^{B1})(L)(R¹)(R²)(R³), wherein L_{A}7-(R1)(R1)(R1)(L1)(R1)(R1)(R1) to L_{A}7-(R80)(R80)(R80)(L10)(R80)(R80)(R80) have the structure | L_{A}8-(R^{A1})(R^{A2})(R^{B1})(L)(R¹)(R²)(R³), wherein L_{A}8-(R1)(R1)(R1)(L1)(R1)(R1)(R1) to L_{A}8-(R80)(R80)(R80)(L10)(R80)(R80)(R80) have the structure |
| 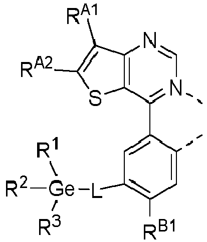 | 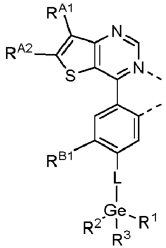 |
| L_{A}9(R^{A1})(R^{A2})(R^{A3})(R^{B1})(L)(R¹)(R²)(R³), wherein L_{A}9-(R1)(R1)(R1)(L1)(R1)(R1)(R1) to L_{A}9-(R80)(R80)(R80)(L10)(R80)(R80)(R80) have the structure | L_{A}10-(R^{A1})(R^{A2})(R^{B1})(L)(R¹)(R²)(R³), wherein L_{A}10-(R1)(R1)(R1)(L1)(R1)(R1)(R1) to L_{A}10-(R80)(R80)(R80)(L10)(R80)(R80)(R80) have the structure |
| 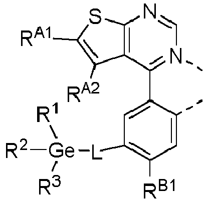 | 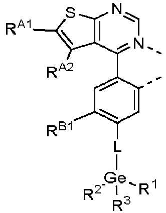 |
| L_{A}11-(R^{A1})(R^{A2})(R^{A3})(R^{B1})(L)(R¹)(R²)(R³), wherein L_{A}11-(R1)(R1)(R1)(R1)(L1)(R1)(R1)(R1) to L_{A}11-(R80)(R80)(R80)(R80)(L10)(R80)(R80)(R80) have the structure | L_{A}12-(R^{A1})(R^{A2})(R^{A3})(R^{B1})(L)(R¹)(R²)(R³), wherein L_{A}12-(R1)(R1)(R1)(R1)(L1)(R1)(R1)(R1) to L_{A}12-(R80)(R80)(R80)(R80)(L10)(R80)(R80)(R80) have the structure |
| 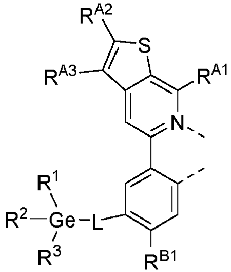 | 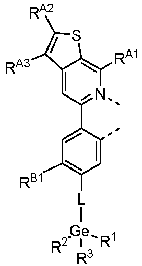 |
| L_{A}13-(R^{A1})(R^{A2})(R^{A3})(R^{B1})(R^{B2})(L)(R¹)(R²)(R³) wherein L_{A}13-(R1)(R1)(R1)(R1)(R1)(L1)(R1)(R1)(R1) to L_{A}13-(R80)(R80)(R80)(R80)(R80)(L10)(R80)(R80)(R80) have the structure | L_{A}14-(R^{A1})(R^{A2})(R^{A3})(R^{B1})(R^{B2})(L)(R¹)(R²)(R³), wherein L_{A}14-(R1)(R1)(R1)(R1)(R1)(L1)(R1)(R1)(R1) to L_{A}14-(R80)(R80)(R80)(R80)(R80)(L10)(R80)(R80)(R80) have the structure |
| 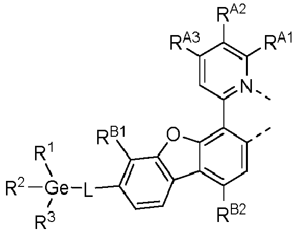 | 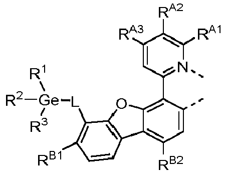 |
| L_{A}15-(R^{A1})(R^{A2})(R^{A3})(R^{B1})(R^{B2})(L)(R¹)(R²)(R³) wherein L_{A}15-(R1)(R1)(R1)(R1)(R1)(L1)(R1)(R1)(R1) to L_{A}15-(R80)(R80)(R80)(R80)(R80)(L10)(R80)(R80)(R80) have the structure | L_{A}16-(R^{A1})(R^{A2})(R^{A3})(R^{B1})(A^{B2})(L)(R¹)(R²)(R³) wherein L_{A}16-(R1)(R1)(R1)(R1)(R1)(L1)(R1)(R1)(R1) to L_{A}16-(R80)(R80)(R80)(R80)(R80)(L10)(R80)(R80)(R80) have the structure |
| 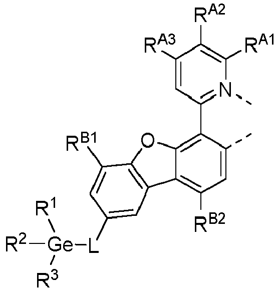 | 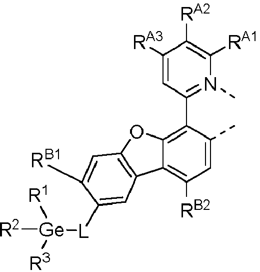 I |
| L_{A}17-(R^{A1})(R^{A2})(R^{A3})(R^{B1})(R^{B2})(L)(R¹)(R²)(R³) wherein L_{A}17-(R1)(R1)(R1)(R1)(R1)(L1)(R1)(R1)(R1) to L_{A}17-(R80)(R80)(R80)(R80)(R80)(L10)(R80)(R80)(R80) have the structure | L_{A}18-(R^{A1})(R^{A2})(R^{A3})(R^{B1})(R^{B2})(L)(R¹)(R²)(R³) wherein L_{A}18-(R1)(R1)(R1)(R1)(R1)(L1)(R1)(R1)(R1) to L_{A}18-(R80)(R80)(R80)(R80)(R80)(L10)(R80)(R80)(R80) have the structure |
| 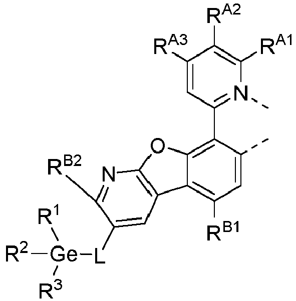 | 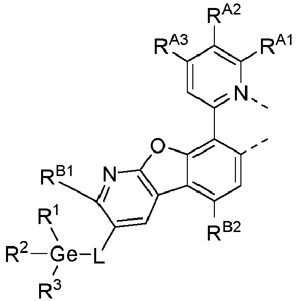 |
| L_{A}19-(R^{A1})(R^{A2})(R^{A3})(R^{B1})(R^{B2})(L)(R¹)(R²)(R³) wherein L_{A}19-(R1)(R1)(R1)(R1)(R1)(L1)(R1)(R1)(R1) to L_{A}19-(R80)(R80)(R80)(R80)(R80)(L10)(R80)(R80)(R80) have the structure | L_{A}20-(R^{A1})(R^{A2})(R^{A3})(R^{B1})(R^{B2})(L)(R¹)(R²)(R³) wherein L_{A}20-(R1)(R1)(R1)(R1)(R1)(L1)(R1)(R1)(R1) to L_{A}20-(R80)(R80)(R80)(R80)(R80)(L10)(R80)(R80)(R80) have the structure |
| 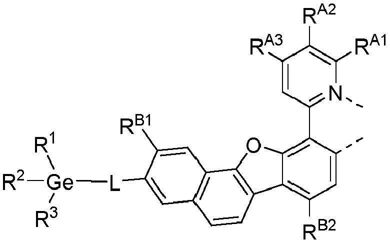 | 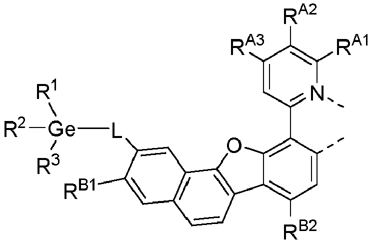 |
| L_{A}21-(R^{A1})(R^{A2})(R^{A3})(R^{B1})(L)(R¹)(R²)(R³), wherein L_{A}21-(R1)(R1)(R1)(R1)(L1)(R1)(R1)(R1) to L_{A}21-(R80)(R80)(R80)(R80)(L10)(R80)(R80)(R80) have the structure | L_{A}22-(R^{A1})(R^{A2})(R^{A3})(R^{B1})(L)(R¹)(R²)(R³), wherein L_{A}22-(R1)(R1)(R1)(R1)(L1)(R1)(R1)(R1) to L_{A}22-(R80)(R80)(R80)(R80)(L10)(R80)(R80)(R80) have the structure |
| 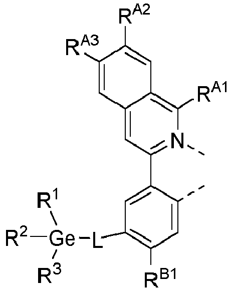 | 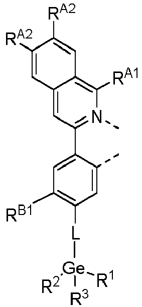 |
| L_{A}23-(R^{A1})(R^{A2})(R^{A3})(R^{B1})(L)(R¹)(R²)(R³), wherein L_{A}23-(R1)(R1)(R1)(R1)(L1)(R1)(R1)(R1) to L_{A}23-(R80)(R80)(R80)(R80)(L10)(R80)(R80)(R80) have the structure | L_{A}24-(R^{A1})(R^{A2})(R^{A3})(R^{B1})(L)(R¹)(R²)(R³), wherein L_{A}24-(R1)(R1)(R1)(R1)(L1)(R1)(R1)(R1) to L_{A}24-(R80)(R80)(R80)(R80)(L10)(R80)(R80)(R80) have the structure |
| 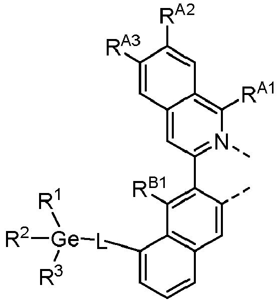 | 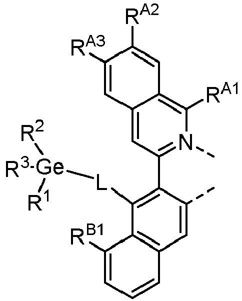 |
| L_{A}25-(R^{A1})(R^{A2})(R^{A3})(R^{B1})(L)(R¹)(R²)(R³), wherein L_{A}25-(R1)(R1)(R1)(R1)(L1)(R1)(R1)(R1) to L_{A}25-(R80)(R80)(R80)(R80)(L10)(R80)(R80)(R80) have the structure | L_{A}26-(R^{A1})(R^{A2})(R^{A3})(R^{B1})(L)(R¹)(R²)(R³), wherein L_{A}26-(R1)(R1)(R1)(R1)(L1)(R1)(R1)(R1) to L_{A}26-(R80)(R80)(R80)(R80)(L10)(R80)(R80)(R80) have the structure |
| 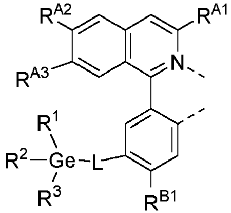 | 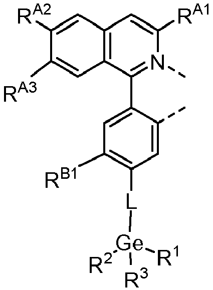 |
| L_{A}27-(R^{A1})(R^{A2})(R^{A3})(R^{B1})(L)(R¹)(R²)(R³), wherein L_{A}27-(R1)(R1)(R1)(R1)(L1)(R1)(R1)(R1) to L_{A}27-(R80)(R80)(R80)(R80)(L10)(R80)(R80)(R80) have the structure | L_{A}28-(R^{A1})(R^{A2})(R^{A3})(R^{B1})(L)(R¹)(R²)(R³), wherein L_{A}28-(R1)(R1)(R1)(R1)(L1)(R1)(R1)(R1) to L_{A}28-(R80)(R80)(R80)(R80)(L10)(R80)(R80)(R80) have the structure |
| 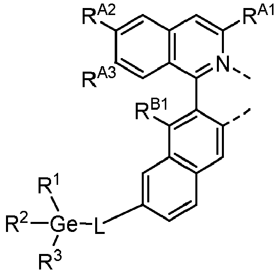 | 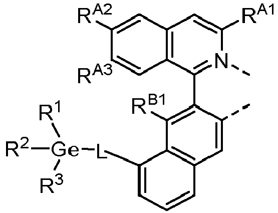 |
| L_{A}29-(R^{A1})(R^{A2})(R^{A3})(R^{B1})(R^{B2})(L)(R¹)(R²)(R³), wherein L_{A}29-(R1XR1)(R1)(R1)(L1XR1)(R1)(R1) to L_{A}29-(R80)(R80)(R80)(R80)(L10)(R80)(R80)(R80) have the structure | L_{A}30-(R^{A1})(R^{A2})(R^{A3})(R^{B1})(R^{B2})(L)(R¹)(R²)(R³), wherein L_{A}30-(R1)(R1)(R1)(R1)(L1)(R1)(R1)(R1) to L_{A}30-(R80)(R80)(R80)(R80)(L10)(R80)(R80)(R80) have the structure |
| 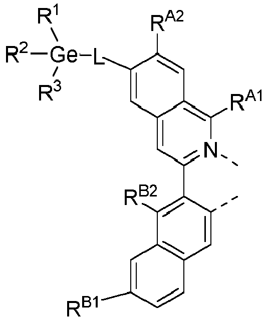 | 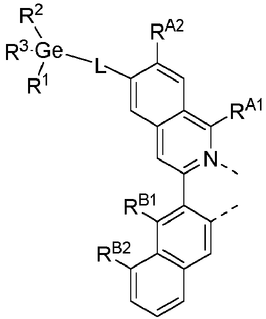 |
| L_{A}31-(R^{A1})(R^{A2})(R^{A3})(R^{B1})(R^{B2})(L)(R¹)(R²)(R³) wherein L_{A}31-(R1)(R1)(R1)(R1)(R1)(L1)(R1)(R1)(R1) to L_{A}31-(R80)(R80)(R80)(R80)(R80)(L10)(R80)(R80)(R80) have the structure | L_{A}32-(R^{A1})(R^{A2})(R^{A3})(R^{B1})(R^{B2})(L)(R¹)(R²)(R³), wherein L_{A}32-(R1)(R1)(R1)(R1)(R1)(L1)(R1)(R1)(R1) to L_{A}32-(R80)(R80)(R80)(R80)(R80)(L10)(R80)(R80)(R80) have the structure |
| 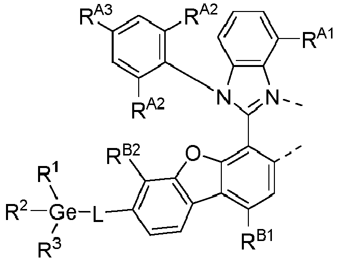 | 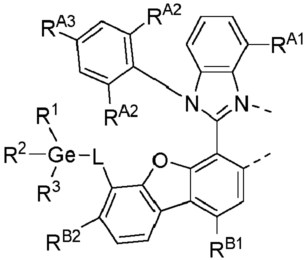 |
| L_{A}33-(R^{A1})(R^{A2})(R^{A3})(R^{B1})(R^{B2})(L)(R¹)(R²)(R³) wherein L_{A}33-(R1)(R1)(R1)(R1)(R1)(L1)(R1)(R1)(R1) to L_{A}33-(R80)(R80)(R80)(R80)(R80)(L10)(R80)(R80)(R80) have the structure | L_{A}34-(R^{A1})(R^{A2})(R^{A3})(R^{B1})(R^{B2})(L)(R¹)(R²)(R³) wherein L_{A}34-(R1)(R1)(R1)(R1)(R1)(L1)(R1)(R1)(R1) to L_{A}34-(R80)(R80)(R80)(R80)(R80)(L10)(R80)(R80)(R80) have the structure |
| 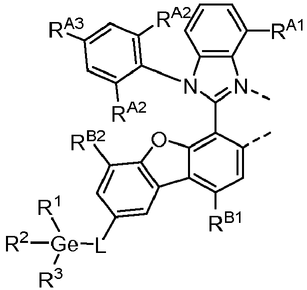 | 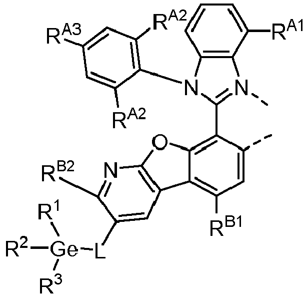 |
| L_{A}35-(R^{A1})(R^{A2})(R^{A3})(R^{B1})(R^{B2})(L)(R¹)(R²)(R³) wherein L_{A}35-(R1)(R1)(R1)(R1)(R1)(L1)(R1)(R1)(R1) to L_{A}35-(R80)(R80)(R80)(R80)(R80)(L10)(R80)(R80)(R80) have the structure | L_{A}36-(R^{A1})(R^{A2})(R^{A3})(R^{B1})(R^{B2})(L)(R¹)(R²)(R³) wherein L_{A}36-(R1)(R1)(R1)(R1)(R1)(L1)(R1)(R1)(R1) to L_{A}36-(R80)(R80)(R80)(R80)(R80)(L10)(R80)(R80)(R80) have the structure |
| 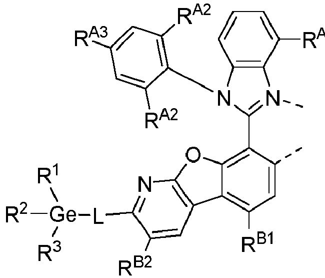 | 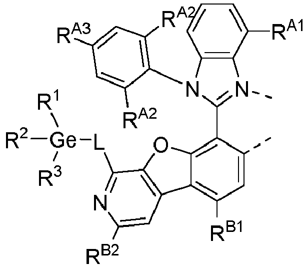 |
| L_{A}37-(R^{A1})(R^{A2})(R^{A3})(R^{B1})(R^{B2})(L)(R¹)(R²)(R³) wherein L_{A}37-(R1)(R1)(R1)(R1)(R1)(L1)(R1)(R1)(R1) to L_{A}37-(R80)(R80)(R80)(R80)(R80)(L10)(R80)(R80)(R80) have the structure | L_{A}38-(R^{A1})(R^{A2})(R^{A3})(R^{B1})(R^{B2})(L)(R¹)(R²)(R³) wherein L_{A}38-(R1)(R1)(R1)(R1)(R1)(L1)(R1)(R1)(R1) to L_{A}38-(R80)(R80)(R80)(R80)(R80)(L10)(R80)(R80)(R80) have the structure |
| 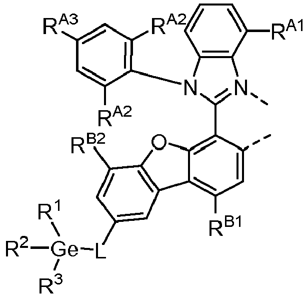 | 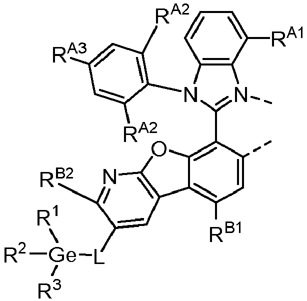 |
| L_{A}39-(R^{A1})(R^{A2})(R^{A3})(R^{B1})(R^{B2})(L)(R¹)(R²)(R³), wherein L_{A}39-(R1)(R1)(R1)(R1)(L1)(R1)(R1)(R1) to L_{A}39-(R80)(R80)(R80)(R80)(L10)(R80)(R80)(R80) have the structure | L_{A}40-(R^{A1})(R^{A2})(R^{A3})(R^{B1})(L)(R¹)(R²)(R³), wherein L_{A}40-(R1)(R1)(R1)(R1)(L1)(R1)(R1)(R1) to L_{A}40-(R80)(R80)(R80)(R80)(L10)(R80)(R80)(R80) have the structure |
| 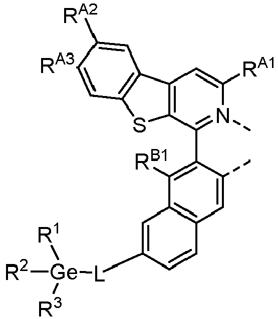 | 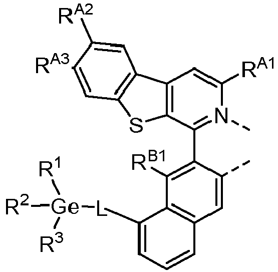 |
| L_{A}41-(R^{A1})(R^{A2})(R^{A3})(R^{B1})(R^{B2})(L)(R¹)(R²)(R³), wherein L_{A}41-(R1)(R1)(R1)(R1)(L1)(R1)(R1)(R1) to L_{A}41-(R80)(R80)(R80)(R80)(L10)(R80)(R80)(R80) have the structure | L_{A}42-(R^{A1})(R^{A2})(R^{A3})(R^{B1})(R^{B2})(L)(R¹)(R²)(R³), wherein L_{A}42-(R1)(R1)(R1)(R1)(L1)(R1)(R1)(R1) to L_{A}42-(R80)(R80)(R80)(R80)(L10)(R80)(R80)(R80) have the structure |
| 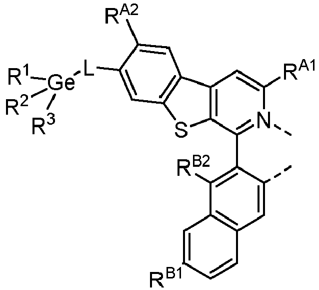 | 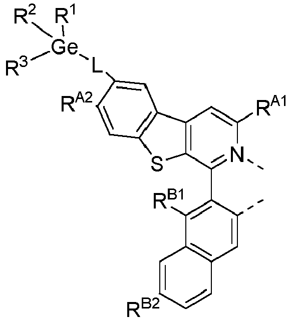 |
| L_{A}43-(R^{A1})(R^{A2})(R^{A3})(R^{B1})(R^{B2})(L)(R¹)(R²)(R³) wherein L_{A}43-(R1)(R1)(R1)(R1)(R1)(L1)(R1)(R1)(R1) to L_{A}43-(R80)(R80)(R80)(R80)(R80)(L10)(R80)(R80)(R80) have the structure | L_{A}44-(R^{A1})(R^{A2})(R^{A3})(R^{B1})(R^{B2})(L)(R¹)(R²)(R³), wherein L_{A}44-(R1)(R1)(R1)(R1)(R1)(L1)(R1)(R1)(R1) to L_{A}44-(R80)(R80)(R80)(R80)(R80)(L10)(R80)(R80)(R80) have the structure |
| 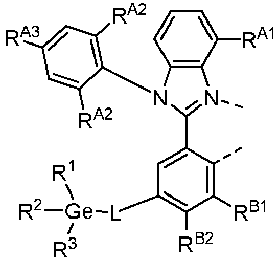 | 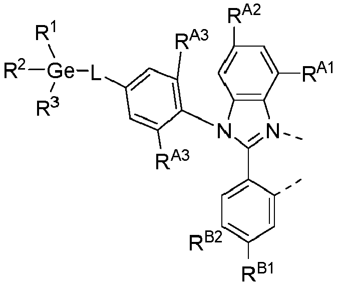 |
| L_{A}45-(R^{A1})(R^{A2})(R^{B1})(L)(R¹)(R²)(R³), wherein L_{A}45-(R1)(R1)(R1)(L1)(R1)(R1)(R1) to L_{A}45-(R80)(R80)(R80)(L10)(R80)(R80)(R80) have the structure | L_{A}46-(R^{A1})(R^{A2})(R^{B1})(L)(R¹)(R²)(R³) wherein L_{A}46-(R1)(R1)(R1)(L1)(R1)(R1)(R1) to L_{A}46-(R80)(R80)(R80)(L10)(R80)(R80)(R80) have the structure |
| 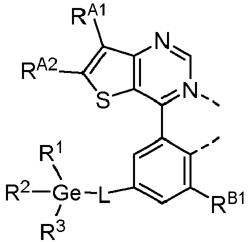 | 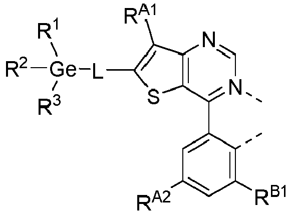 |
| L_{A}47-(R^{A1})(R^{A2})(R^{B1})(L)(R¹)(R²)(R³), wherein L_{A}47-(R1)(R1)(R1)(L1)(R1)(R1)(R1) to L_{A}47-(R80)(R80)(R80)(L10)(R80)(R80)(R80) have the structure | L_{A}48-(R^{A1})(R^{A2})(R^{B1})(L)(R¹)(R²)(R³), wherein L_{A}48-(R1)(R1)(R1)(L1)(R1)(R1)(R1) to L_{A}48-(R80)(R80)(R80)(L10)(R80)(R80)(R80) have the structure |
| 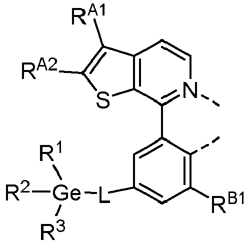 | 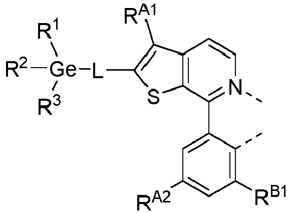 |
| L_{A}49-(R^{A1})(R^{A2})(R^{B1})(L)(L)(R¹)(R²)(R³),wherein L_{A}49-(R1)(R1)(R1)(L1)(R1)(R1)(R1) to L_{A}49-(R80)(R80)(R80)(L10)(R80)(R80)(R80) have the structure | L_{A}50-(R^{A1})(R^{A2})(R^{B1})(L)(R¹)(R²)(R³), wherein L_{A}50-(R1)(R1)(R1)(L1)(R1)(R1)(R1) to L_{A}50-(R80)(R80)(R80)(L10)(R80)(R80)(R80) have the structure |
| 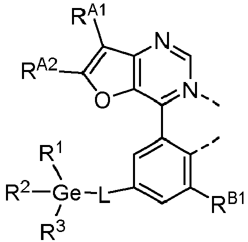 | 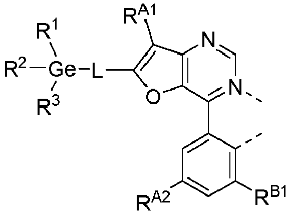 |
| L_{A}51-(R^{A1})(R^{A2})(R^{B1})(L)(R¹)(R²)(R³), wherein L_{A}51-(R1)(R1)(R1)(L1)(R1)(R1)(R1) to L_{A}51-(R80)(R80)(R80)(L10)(R80)(R80)(R80) have the structure | L_{A}52-(R^{A1})(R^{A2})(R^{B1})(L)(R¹)(R²)(R³), wherein L_{A}52-(R1)(R1)(R1)(L1)(R1)(R1)(R1) to L_{A}52-(R80)(R80)(R80)(L10)(R80)(R80)(R80) have the structure |
| 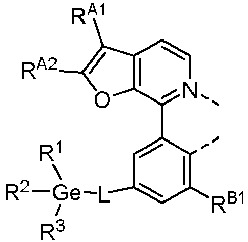 | 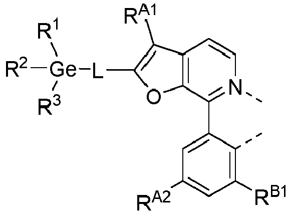 |
| L_{A}53-(R^{A1})(R^{A2})(R^{B1})(L)(R¹)(R²)(R³), wherein L_{A}53-(R1)(R1)(R1)(L1)(R1)(R1)(R1) to L_{A}53-(R80)(R80)(R80)(L10)(R80)(R80)(R80) have the structure | L_{A}54-(R^{A1})(R^{A2})(R^{B1})(L)(R¹)(R²)(R³), wherein L_{A}54-(R1)(R1)(R1)(L1)(R1)(R1)(R1) to L_{A}54-(R80)(R80)(R80)(L10)(R80)(R80)(R80) have the structure |
| 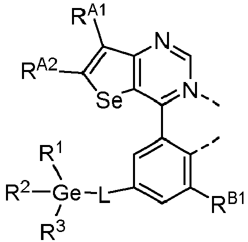 | 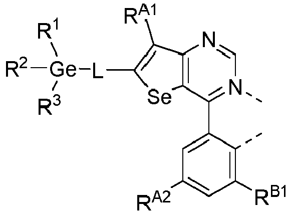 |
| L_{A}55-(R^{A1})(R^{A2})(R^{B1})(L)(R¹)(R²)(R³), wherein L_{A}55-(R1)(R1)(R1)(L1)(R1)(R1)(R1) to L_{A}55-(R80)(R80)(R80)(L10)(R80)(R80)(R80) have the structure | L_{A}56-(R^{A1})(R^{A2})(R^{B1})(L)(R¹)(R²)(R³), wherein L_{A}56-(R1)(R1)(R1)(L1)(R1)(R1)(R1) to L_{A}56-(R80)(R80)(R80)(L10)(R80)(R80)(R80) have the structure |
| 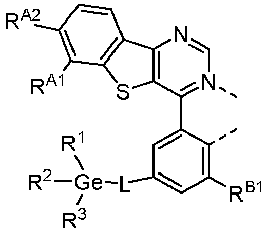 | 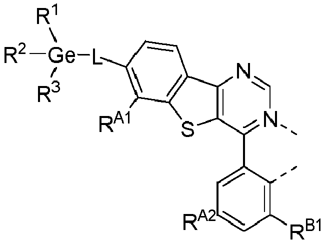 |
| L_{A}57-(R^{A1})(R^{A2})(R^{B1})(L)(R¹)(R²)(R³), wherein L_{A}57-(R1)(R1)(R1)(L1)(R1)(R1)(R1) to L_{A}57-(R80)(R80)(R80)(L10)(R80)(R80)(R80) have the structure | L_{A}58-(R^{A1})(R^{A2})(R^{B1})(L)(R¹)(R²)(R³), wherein L_{A}58-(R1)(R1)(R1)(L1)(R1)(R1)(R1) to L_{A}58-(R80)(R80)(R80)(L10)(R80)(R80)(R80) have the structure |
| 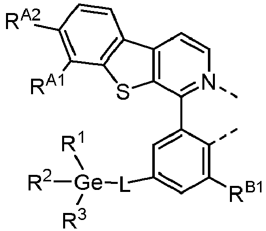 | 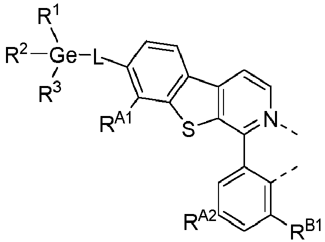 |
| L_{A}59-(R^{A1})(R^{A2})(R^{B1})(L)(R¹)(R²)(R³), wherein L_{A}59-(R1)(R1)(R1)(L1)(R1)(R1)(R1) to L_{A}59-(R80)(R80)(R80)(L10)(R80)(R80)(R80) have the structure | L_{A}60-(R^{A1})(R^{A2})(R^{B1})(L)(R¹)(R²)(R³), wherein L_{A}60-(R1)(R1)(R1)(L1)(R1)(R1)(R1) to L_{A}60-(R80)(R80)(R80)(L10)(R80)(R80)(R80) have the structure |
| 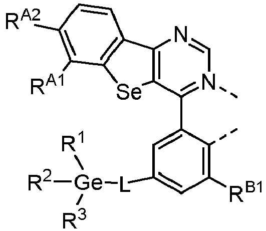 | 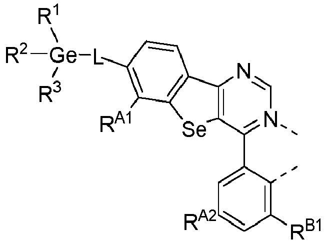 |
| L_{A}61-(R^{A1})(R^{A2})(R^{B1})(L)(R¹)(R²)(R³), wherein L_{A}61-(R1)(R1)(R1)(L1)(R1)(R1)(R1) to L_{A}61-(R80)(R80)(R80)(L10)(R80)(R80)(R80) have the structure | L_{A}62-(R^{A1})(R^{A2})(R^{B1})(L)(R¹)(R²)(R³), wherein L_{A}62-(R1)(R1)(R1)(L1)(R1)(R1)(R1) to L_{A}62-(R80)(R80)(R80)(L10)(R80)(R80)(R80) have the structure |
| 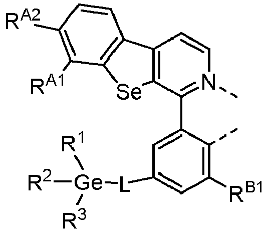 | 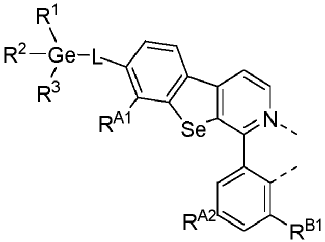 |
| L_{A}63-(R^{A1})(R^{A2})(R^{B1})(L)(R¹)(R²)(R³), wherein L_{A}63-(R1)(R1)(R1)(L1)(R1)(R1)(R1) to L_{A}63-(R80)(R80)(R80)(L10)(R80)(R80)(R80) have the structure | L_{A}64-(R^{A1})(R^{A2})(R^{B1})(L)(R¹)(R²)(R³), wherein L_{A}64-(R1)(R1)(R1)(L1)(R1)(R1)(R1) to L_{A}64-(R80)(R80)(R80)(L10)(R80)(R80)(R80) have the structure |
| 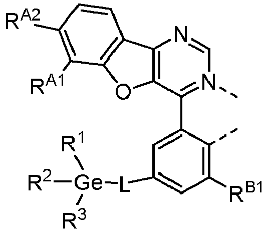 | 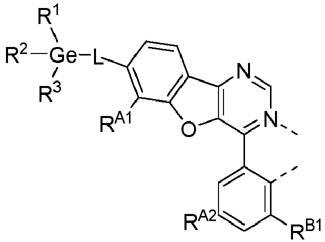 |
| L_{A}65-(R^{A1})(R^{A2})(R^{B1})(L)(R¹)(R²)(R³), wherein L_{A}65-(R1)(R1)(R1)(L1)(R1)(R1)(R1) to L_{A}65-(R80)(R80)(R80)(L10)(R80)(R80)(R80) have the structure | L_{A}66-(R^{A1})(R^{A2})(R^{B1})(L)(R¹)(R²)(R³), wherein L_{A}66-(R1)(R1)(R1)(L1)(R1)(R1)(R1) to L_{A}66-(R80)(R80)(R80)(L10)(R80)(R80)(R80) have the structure |
| 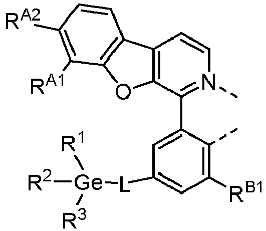 | 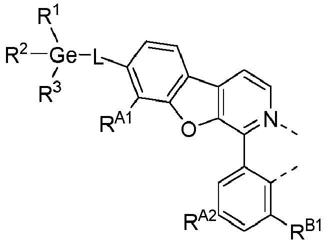 |
| L_{A}67-(R^{A1})(R^{A2})(R^{B1})(L)(R¹)(R²)(R³), wherein L_{A}67-(R1)(R1)(R1)(L1)(R1)(R1)(R1) to L_{A}67-(R80)(R80)(R80)(L10)(R80)(R80)(R80) have the structure | L_{A}68-(R^{A1})(R^{A2})(R^{B1})(L)(R¹)(R²)(R³), wherein L_{A}68-(R1)(R1)(R1)(L1)(R1)(R1)(R1) to L_{A}68-(R80)(R80)(R80)(L10)(R80)(R80)(R80) have the structure |
| 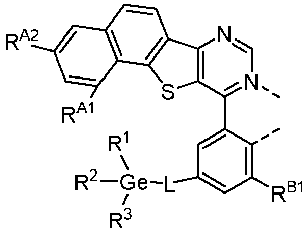 | 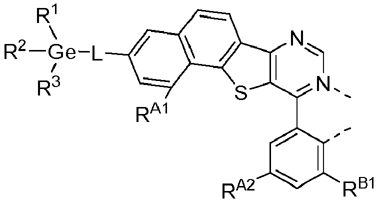 |
| L_{A}69-(R^{A1})(R^{A2})(R^{B1})(L)(R¹)(R²)(R³), wherein L_{A}69-(R1)(R1)(R1)(L1)(R1)(R1)(R1) to L_{A}69-(R80)(R80)(R80)(L10)(R80)(R80)(R80) have the structure | L_{A}70-(R^{A1})(R^{A2})(R^{B1})(L)(R¹)(R²)(R³), wherein L_{A}70-(R1)(R1)(R1)(L1)(R1)(R1)(R1) to L_{A}70-(R80)(R80)(R80)(L10)(R80)(R80)(R80) have the structure |
| 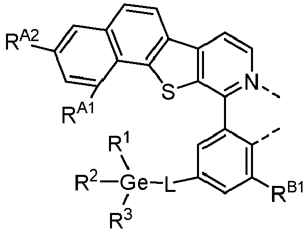 | 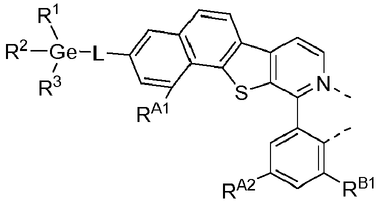 |
| L_{A}71-(R^{A1})(R^{A2})(R^{B1})(L)(R¹)(R²)(R³), wherein L_{A}71-(R1)(R1)(R1)(L1)(R1)(R1)(R1) to L_{A}71-(R80)(R80)(R80)(L10)(R80)(R80)(R80) have the structure | L_{A}72-(R^{A1})(R^{A2})(R^{B1})(L)(R¹)(R²)(R³), wherein L_{A}72-(R1)(R1)(R1)(L1)(R1)(R1)(R1) to L_{A}72-(R80)(R80)(R80)(L10)(R80)(R80)(R80) have the structure |
| 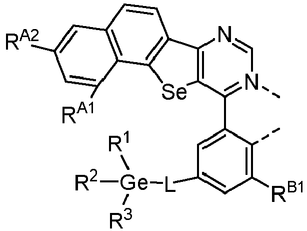 | 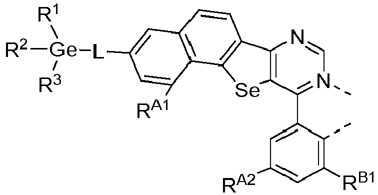 |
| L_{A}73-(R^{A1})(R^{A2})(R^{B1})(L)(R¹)(R²)(R³), wherein L_{A}73-(R1)(R1)(R1)(L1)(R1)(R1)(R1) to L_{A}73-(R80)(R80)(R80)(L10)(R80)(R80)(R80) have the structure | L_{A}74-(R^{A1})(R^{A2})(R^{B1})(L)(R¹)(R²)(R³), wherein L_{A}74-(R1)(R1)(R1)(L1)(R1)(R1)(R1) to L_{A}74-(R80)(R80)(R80)(L10)(R80)(R80)(R80) have the structure |
| 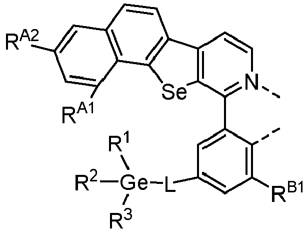 | 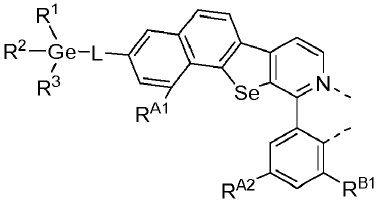 |
| L_{A}75-(R^{A1})(R^{A2})(R^{B1})(L)(R¹)(R²)(R³), wherein L_{A}75-(R1)(R1)(R1)(L1)(R1)(R1)(R1) to L_{A}75-(R80)(R80)(R80)(L10)(R80)(R80)(R80) have the structure | L_{A}76-(R^{A1})(R^{A2})(R^{B1})(L)(R¹)(R²)(R³), wherein L_{A}76-(R1)(R1)(R1)(L1)(R1)(R1)(R1) to L_{A}76-(R80)(R80)(R80)(L10)(R80)(R80)(R80) have the structure |
| 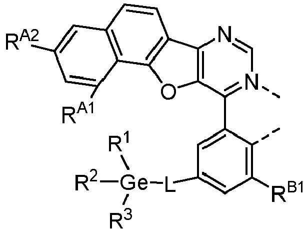 | 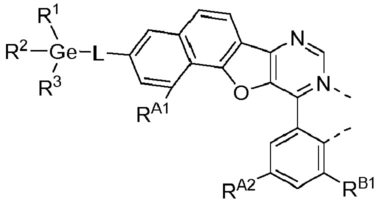 |
| L_{A}77-(R^{A1})(R^{A2})(R^{B1})(L)(R¹)(R²)(R³), wherein L_{A}77-(R1)(R1)(R1)(L1)(R1)(R1)(R1) to L_{A}77-(R80)(R80)(R80)(L10)(R80)(R80)(R80) have the structure | L_{A}78-(R^{A1})(R^{A2})(R^{B1})(L)(R¹)(R²)(R³), wherein L_{A}78-(R1)(R1)(R1)(L1)(R1)(R1)(R1) to L_{A}78-(R80)(R80)(R80)(L10)(R80)(R80)(R80) have the structure |
| 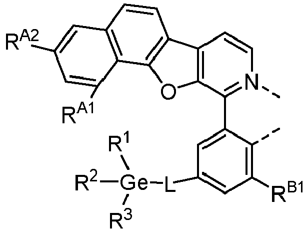 | 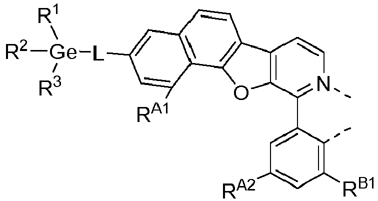 |
| L_{A}79-(R^{A1})(R^{A2})(R^{B1})(L)(R¹)(R²)(R³), wherein L_{A}79-(R1)(R1)(R1)(L1)(R1)(R1)(R1) to L_{A}79-(R80)(R80)(R80)(L10)(R80)(R80)(R80) have the structure | L_{A}80-(R^{A1})(R^{A2})(R^{B1})(L)(R¹)(R²)(R³), wherein L_{A}80-(R1)(R1)(R1)(L1)(R1)(R1)(R1) to L_{A}80-(R80)(R80)(R80)(L10)(R80)(R80)(R80) have the structure |
| 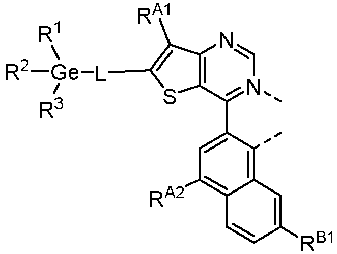 | 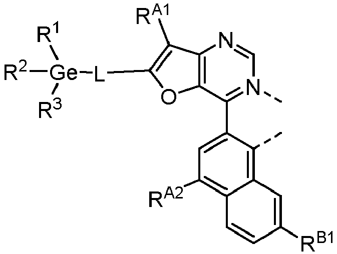 |
| L_{A}81-(R^{A1})(R^{A2})(R^{B1})(L)(R¹)(R²)(R³), wherein L_{A}81-(R1)(R1)(R1)(L1)(R1)(R1)(R1) to L_{A}81-(R80)(R80)(R80)(L10)(R80)(R80)(R80) have the structure | L_{A}82-(R^{A1})(R^{A2})(R^{B1})(L)(R¹)(R²)(R³), wherein L_{A}82-(R1)(R1)(R1)(L1)(R1)(R1)(R1) to L_{A}82-(R80)(R80)(R80)(L10)(R80)(R80)(R80) have the structure |
| 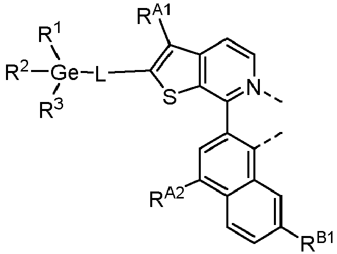 | 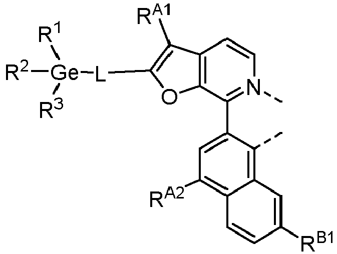 |
| L_{A}83-(R^{A1})(R^{A2})(R^{B1})(L)(R¹)(R²)(R³), wherein L_{A}83-(R1)(R1)(R1)(L1)(R1)(R1)(R1) to L_{A}83-(R80)(R80)(R80)(L10)(R80)(R80)(R80) have the structure | L_{A}84-(R^{A1})(R^{A2})(R^{B1})(L)(R¹)(R²)(R³), wherein L_{A}84-(R1)(R1)(R1)(L1)(R1)(R1)(R1) to L_{A}84-(R80)(R80)(R80)(L10)(R80)(R80)(R80) have the structure |
| 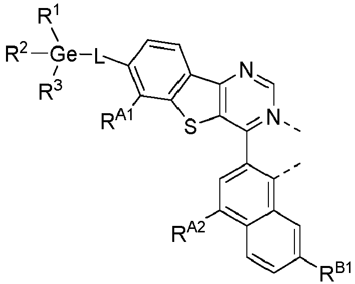 | 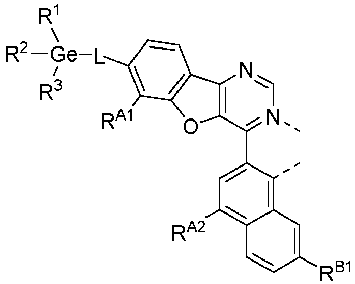 |
| L_{A}85-(R^{A1})(R^{A2})(R^{B1})(L)(R¹)(R²)(R³), wherein L_{A}85-(R1)(R1)(R1)(L1)(R1)(R1)(R1) to L_{A}85-(R80)(R80)(R80)(L10)(R80)(R80)(R80) have the structure | L_{A}86-(R^{A1})(R^{A2})(R^{B1})(L)(R¹)(R²)(R³), wherein L_{A}86-(R1)(R1)(R1)(L1)(R1)(R1)(R1) to L_{A}86-(R80)(R80)(R80)(L10)(R80)(R80)(R80) have the structure |
| 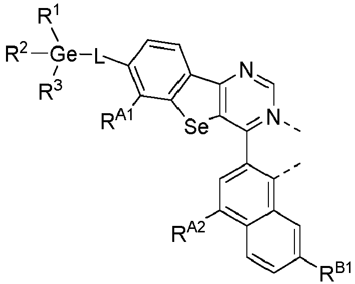 | 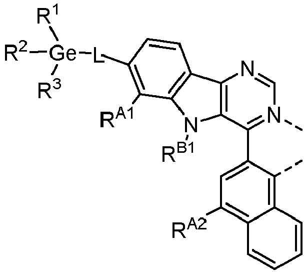 |
| L_{A}87-(R^{A1})(R^{A2})(R^{B1})(L)(R¹)(R²)(R³), wherein L_{A}87-(R1)(R1)(R1)(L1)(R1)(R1)(R1) to L_{A}87-(R80)(R80)(R80)(L10)(R80)(R80)(R80) have the structure | L_{A}88-(R^{A1})(R^{A2})(R^{B1})(L)(R¹)(R²)(R³), wherein L_{A}88-(R1)(R1)(R1)(L1)(R1)(R1)(R1) to L_{A}88-(R80)(R80)(R80)(L10)(R80)(R80)(R80) have the structure |
| 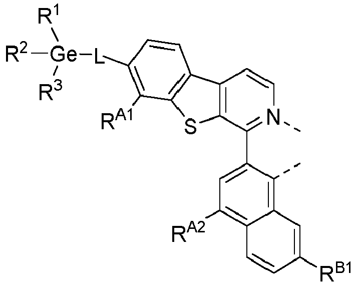 | 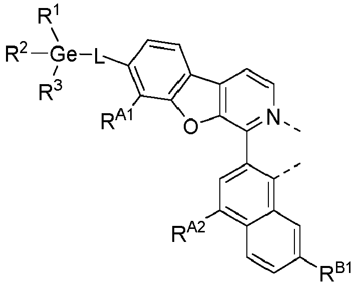 |
| L_{A}89-(R^{A1})(R^{A2})(R^{B1})(L)(R¹)(R²)(R³), wherein L_{A}89-(R1)(R1)(R1)(L1)(R1)(R1)(R1) to L_{A}89-(R80)(R80)(R80)(L10)(R80)(R80)(R80) have the structure | L_{A}90-(R^{A1})(R^{A2})(R^{B1})(L)(R¹)(R²)(R³), wherein L_{A}90-(R1)(R1)(R1)(L1)(R1)(R1)(R1) to L_{A}90-(R80)(R80)(R80)(L10)(R80)(R80)(R80) have the structure |
| 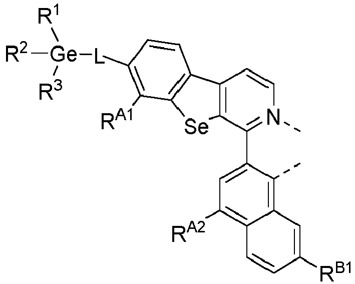 | 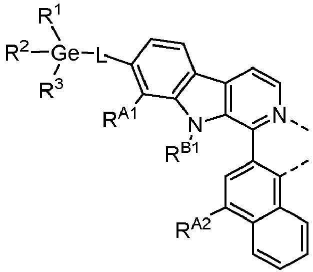 |
| L_{A}91-(R^{A1})(R^{A2})(R^{B1})(L)(R¹)(R²)(R³), wherein L_{A}91-(R1)(R1)(R1)(L1)(R1)(R1)(R1) to L_{A}91-(R80)(R80)(R80)(L10)(R80)(R80)(R80) have the structure | L_{A}92-(R^{A1})(R^{A2})(R^{B1})(L)(R¹)(R²)(R³), wherein L_{A}92-(R1)(R1)(R1)(L1)(R1)(R1)(R1) to L_{A}92-(R80)(R80)(R80)(L10)(R80)(R80)(R80) have the structure |
| 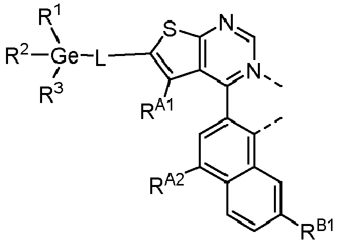 | 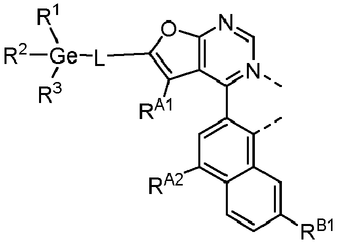 |
| L_{A}93-(R^{A1})(R^{A2})(R^{B1})(L)(R¹)(R²)(R³), wherein L_{A}93-(R1)(R1)(R1)(L1)(R1)(R1)(R1) to L_{A}93-(R80)(R80)(R80)(L10)(R80)(R80)(R80) have the structure | L_{A}94-(R^{A1})(R^{A2})(R^{B1})(L)(R¹)(R²)(R³), wherein L_{A}94-(R1)(R1)(R1)(L1)(R1)(R1)(R1) to L_{A}94-(R80)(R80)(R80)(L10)(R80)(R80)(R80) have the structure |
| 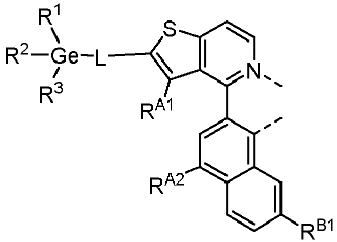 | 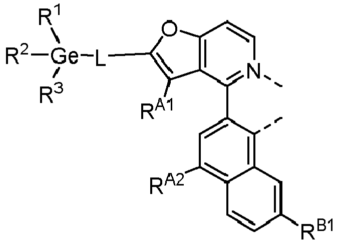 |
| L_{A}95-(R^{A1})(R^{A2})(R^{B1})(L)(R¹)(R²)(R³), wherein L_{A}95-(R1)(R1)(R1)(L1)(R1)(R1)(R1) to L_{A}95-(R80)(R80)(R80)(L10)(R80)(R80)(R80) have the structure | L_{A}96-(R^{A1})(R^{A2})(R^{B1})(L)(R¹)(R²)(R³), wherein L_{A}96-(R1)(R1)(R1)(L1)(R1)(R1)(R1) to L_{A}96-(R80)(R80)(R80)(L10)(R80)(R80)(R80) have the structure |
| 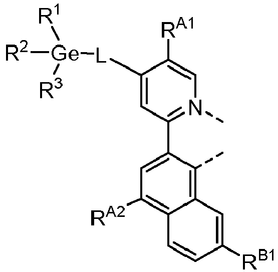 | 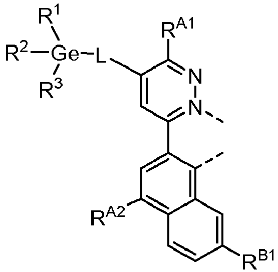 |
| L_{A}97-(R^{A1})(R^{A2})(R^{B1})(L)(R¹)(R²)(R³), wherein L_{A}97-(R1)(R1)(R1)(L1)(R1)(R1)(R1) to L_{A}97-(R80)(R80)(R80)(L10)(R80)(R80)(R80) have the structure | L_{A}98-(R^{A1})(R^{A2})(R^{B1})(L)(R^{A2})(R^{B1})(L)(R¹))(R²)(R³), wherein L_{A}98-(R1)(R1)(R1)(L1)(R1)(R1)(R1) to L_{A}98-(R80)(R80)(R80)(L10)(R80)(R80)(R80) have the structure |
| 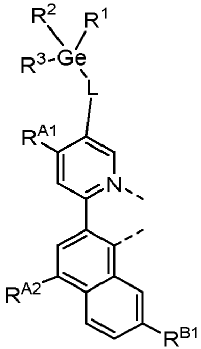 | 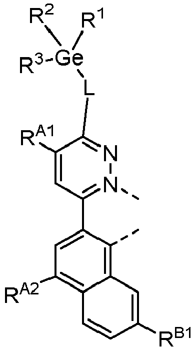 |
| L_{A}99-(R^{A1})(R^{A2})(R^{B1})(L)(R¹)(R²)(R³), wherein L_{A}99-(R1)(R1)(R1)(L1)(R1)(R1)(R1) to L_{A}99-(R80)(R80)(R80)(L10)(R80)(R80)(R80) have the structure | L_{A}100-(R^{A1})(R^{A2})(R^{B1})(L)(R¹)(R²)(R³), wherein L_{A}100-(R1)(R1)(R1)(L1)(R1)(R1)(R1) to L_{A}100-(R80)(R80)(R80)(L10)(R80)(R80)(R80) have the structure |
| 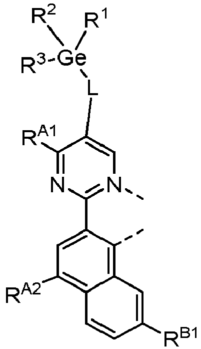 | 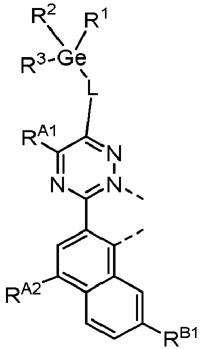 |
| L_{A}101-(R^{A1})(R^{A2})(R^{A3})(R^{B1})(L)(R¹)(R²)(R³), wherein L_{A}101-(R1)(R1)(R1)(R1)(L1)(R1)(R1)(R1) to L_{A}101-(R80)(R80)(R80)(R80)(L10)(R80)(R80)(R80) have the structure | L_{A}102-(R^{A1})(R^{A2})(R^{A3})(R^{B1})(L)(R¹)(R²)(R³), wherein L_{A}102-(R1)(R1)(R1)(R1)(L1)(R1)(R1)(R1) to L_{A}102-(R80)(R80)(R80)(R80)(L10)(R80)(R80)(R80) have the structure |
| 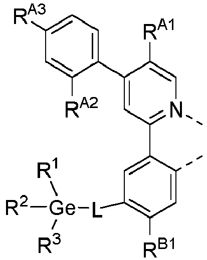 | 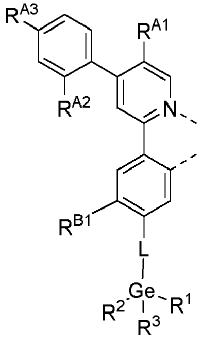 |
| L_{A}103-(R^{A1})(R^{A2})(R^{A3})(R^{B1})(L)(R¹)(R²)(R³), wherein L_{A}103-(R1)(R1)(R1)(R1)(L1)(R1)(R1)(R1) to L_{A}103-(R80)(R80)(R80)(R80)(L10)(R80)(R80)(R80) have the structure | L_{A}104-(R^{A1})(R^{A2})(R^{A3})(R^{B1})(L)(R¹)(R²)(R³), wherein L_{A}104-(R1)(R1)(R1)(R1)(L1)(R1)(R1)(R1) to L_{A}104-(R80)(R80)(R80)(R80)(L10)(R80)(R80)(R80) have the structure |
| 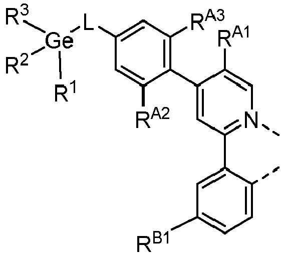 | 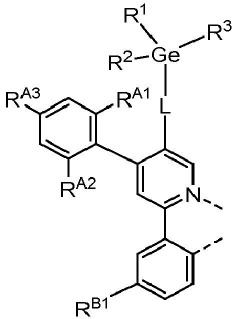 |
| L_{A}105-(R^{A1})(R^{A2})(R^{A3})(R^{B1})(L)(R¹)(R²)(R³), wherein L_{A}105-(R1)(R1)(R1)(R1)(L1)(R1)(R1)(R1) to L_{A}105-(R80)(R80)(R80)(R80)(L10)(R80)(R80)(R80) have the structure | L_{A}106-(R^{A1})(R^{A2})(R^{A3})(R^{B1})(L)(R¹)(R²)(R³), wherein L_{A}106-(R1)(R1)(R1)(R1)(L1)(R1)(R1)(R1) to L_{A}106-(R80)(R80)(R80)(R80)(L10)(R80)(R80)(R80) have the structure |
| 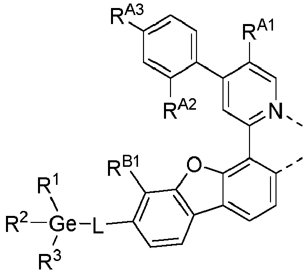 | 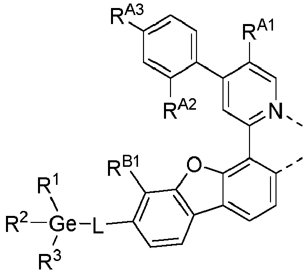 |
| L_{A}107-(R^{A1})(R^{A2})(R^{A3})(R^{B1})(L)(R¹)(R²)(R³), wherein L_{A}107-(R1)(R1)(R1)(R1)(L1)(R1)(R1)(R1) to L_{A}107-(R80)(R80)(R80)(R80)(L10)(R80)(R80)(R80) have the structure | L_{A}108-(R^{A1})(R^{A2})(R^{A3})(R^{B1})(L)(R¹)(R²)(R³), wherein L_{A}108-(R1)(R1)(R1)(R1)(L1)(R1)(R1)(R1) to L_{A}108-(R80)(R80)(R80)(R80)(L10)(R80)(R80)(R80) have the structure |
| 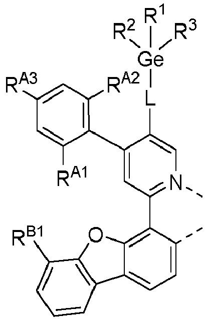 | 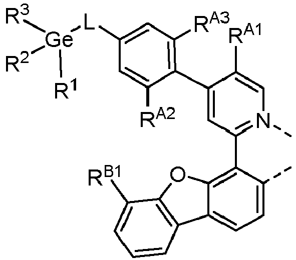 |
| L_{A}109-(R^{A1})(R^{A2})(R^{A3})(R^{B1})(L)(R¹)(R²)(R³), wherein L_{A}109-(R1)(R1)(R1)(R1)(L1)(R1)(R1)(R1) to L_{A}109-(R80)(R80)(R80)(R80)(L10)(R80)(R80)(R80) have the structure | L_{A}110-(R^{A1})(R^{A2})(R^{A3})(R^{B1})(L)(R¹)(R²)(R³), wherein L_{A}110-(R1)(R1)(R1)(R1)(L1)(R1)(R1)(R1) to L_{A}110-(R80)(R80)(R80)(R80)(L10)(R80)(R80)(R80) have the structure |
| 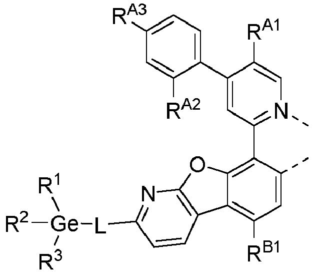 | 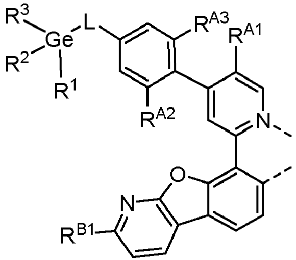 |
| L_{A}111-(R^{A1})(R^{A2})(R^{A3})(R^{B1})(L)(R¹)(R²)(R³), wherein L_{A}111-(R1)(R1)(R1)(R1)(L1)(R1)(R1)(R1) to L_{A}111-(R80)(R80)(R80)(R80)(L10)(R80)(R80)(R80) have the | L_{A}112-(R^{A1})(R^{A2})(R^{A3})(R^{B1})(L)(R¹)(R²)(R³), wherein L_{A}112-(R1)(R1)(R1)(R1)(L1)(R1)(R1)(R1) to L_{B}112-(R80)(R80)(R80)(R80)(L10)(R80)(R80)(R80) have the |
| structure | structure |
| 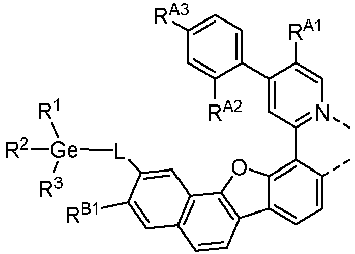 | 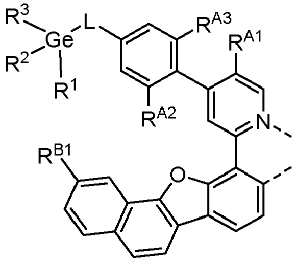 |
| L_{A}113-(R^{A1})(R^{A2})(R^{A3})(R^{B1})(L)(R¹)(R²)(R³), wherein L_{A}113-(R1)(R1)(R1)(R1)(L1)(R1)(R1)(R1) to L_{A}113-(R80)(R80)(R80)(R80)(L10)(R80)(R80)(R80) have the structure | L_{A}113-(R^{A1})(R^{A2})(R^{A3})(R^{B1})(L)(R¹)(R²)(R³), wherein L_{A}114-(R1)(R1)(R1)(R1)(L1)(R1)(R1)(R1) to L_{A}114-(R80)(R80)(R80)(R80)(L10)(R80)(R80)(R80) have the structure |
| 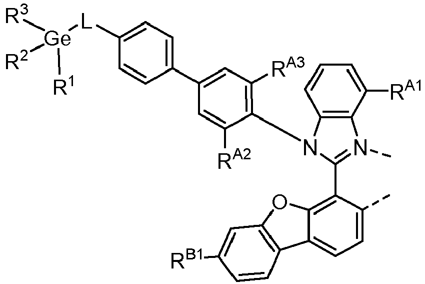 | 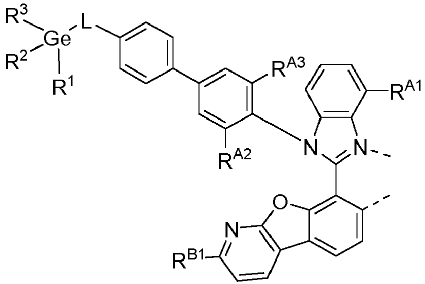 |
| L_{A}110-(R^{A1})(R^{A2})(R^{A3})(R^{B1})(L)(R¹)(R²)(R³), wherein L_{A}115-(R1)(R1)(R1)(R1)(L1)(R1)(R1)(R1) to L_{A}115-(R80)(R80)(R80)(R80)(L10)(R80)(R80)(R80) have the structure | L_{A}110-(R^{A1})(R^{A2})(R^{A3})(R^{B1})(L)(R¹)(R²)(R³), wherein L_{A}116-(R1)(R1)(R1)(R1)(L1)(R1)(R1)(R1) to L_{A}116-(R80)(R80)(R80)(R80)(L10)(R80)(R80)(R80) have the structure |
| 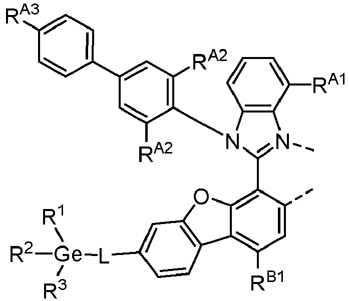 | 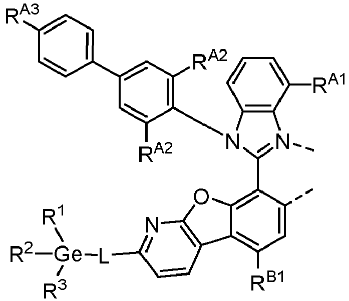 |
| L_{A}113-(R^{A1})(R^{A2})(R^{A3})(R^{B1})(L)(R¹)(R²)(R³), wherein L_{A}117-(R1)(R1)(R1)(R1)(L1)(R1)(R1)(R1) to L_{A}117 - (R80)(R80)(R80)(R80)(L10)(R80)(R80)(R80) have the structure | L_{A}110-(R^{A1})(R^{A2})(R^{A3})(R^{B1})(L)(R¹)(R²)(R³), wherein L_{A}118-(R1)(R1)(R1)(R1)(L1)(R1)(R1)(R1) to L_{A}118-(R80)(R80)(R80)(R80)(L10)(R80)(R80)(R80) have the structure |
| 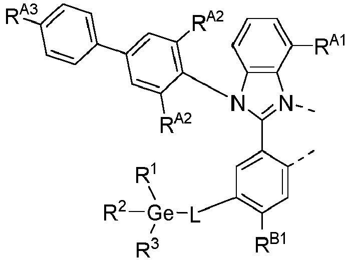 | 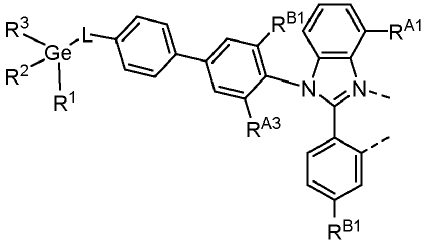 |

wherein R1 to R80 have the structures defined in the following LIST 4: 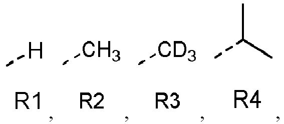 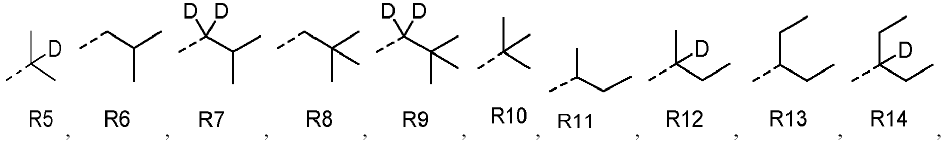 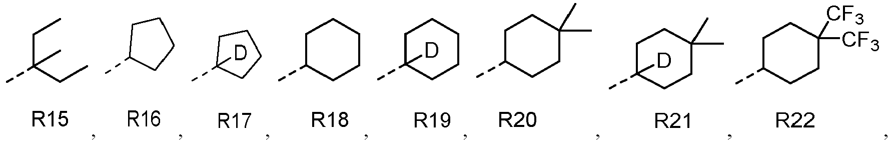 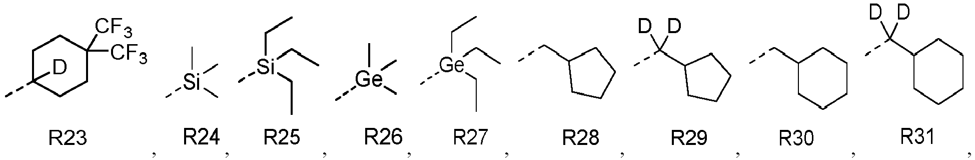 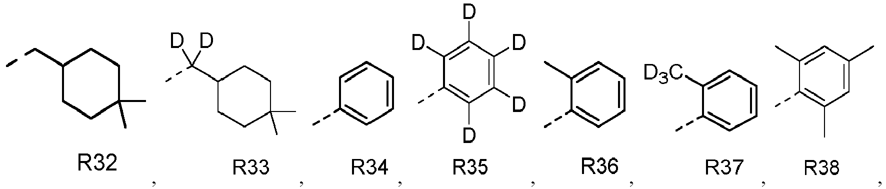 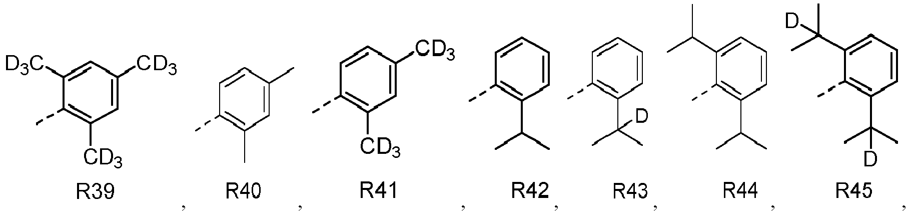 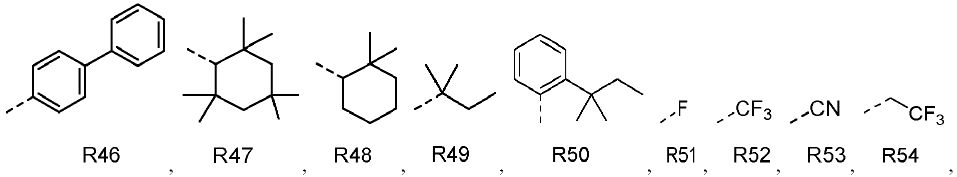 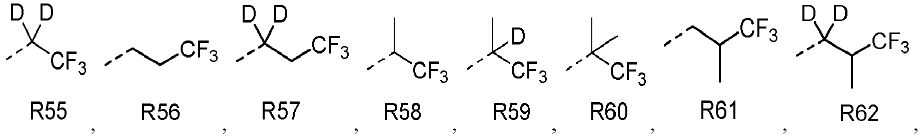 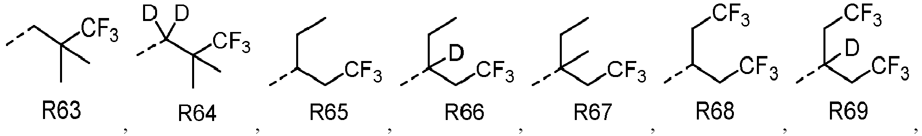 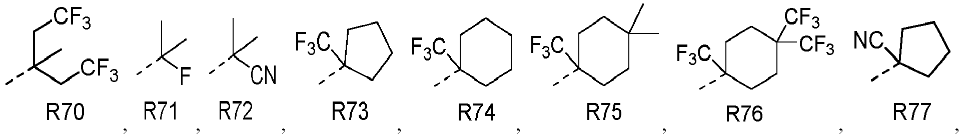 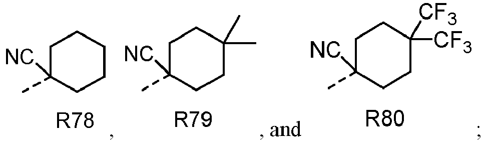 wherein L1 to L10 have the structures defined in the following LIST 5: 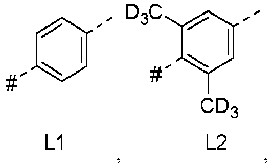 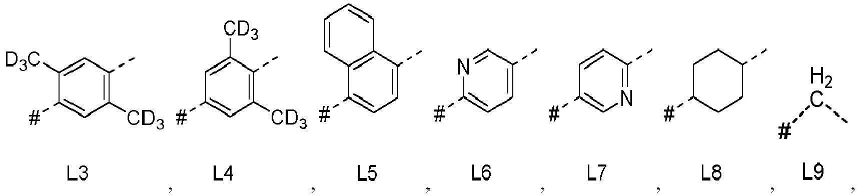 and direct bond L10 ;
wherein the dashed line marked with # is bonded to moiety A or moiety B.

In some embodiments, the compound has a formula of M(L_{A})ₚ(L_{B})_{q}(L_{C})ᵣ wherein L_{B} and L_{C} are each a bidentate ligand; and wherein p is 1, 2, or 3; q is 0, 1, or 2; r is 0, 1, or 2; and p+q+r is the oxidation state of the metal M.

In some embodiments, the compound has a formula selected from the group consisting of Ir(L_{A})₃, Ir(L_{A})(L_{B})₂, Ir(L_{A})₂(L_{B}), Ir(L_{A})₂(L_{C}), and Ir(L_{A})(L_{B})(L_{C}); and wherein L_{A}, L_{B}, and L_{C} are different from each other.

In some embodiments, L_{B} is a substituted or unsubstituted phenylpyridine, and L_{C} is a substituted or unsubstituted acetylacetonate.

In some embodiments, the compound has a formula of Pt(L_{A})(L_{B}); and wherein L_{A} and L_{B} can be same or different. In such embodiments, L_{A} and L_{B} are connected to form a tetradentate ligand

In some embodiments, L_{B} and Lc are each independently selected from the group consisting of the structures of the following LIST 6: 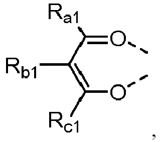 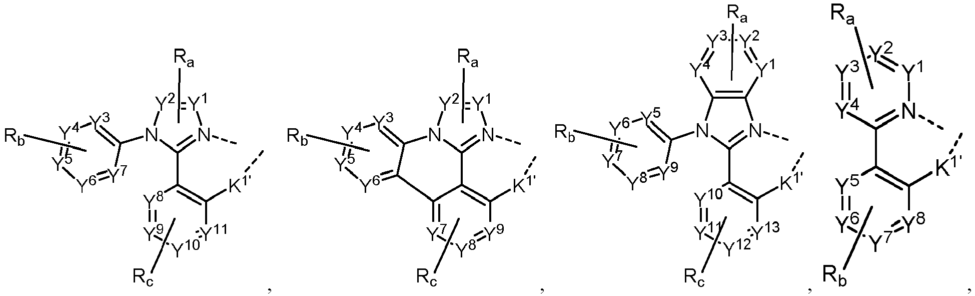 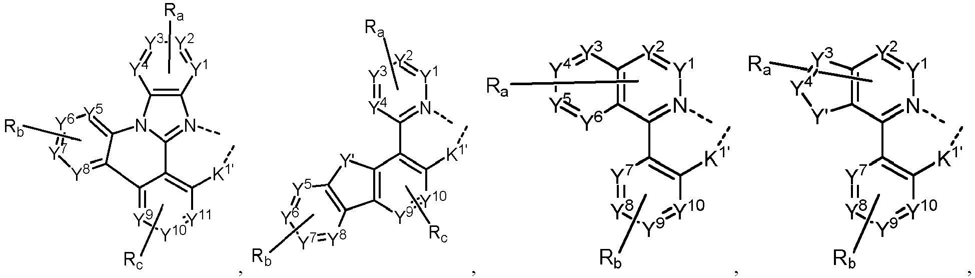 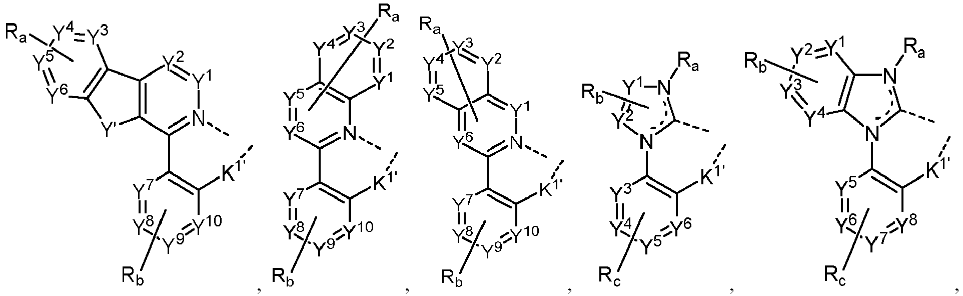 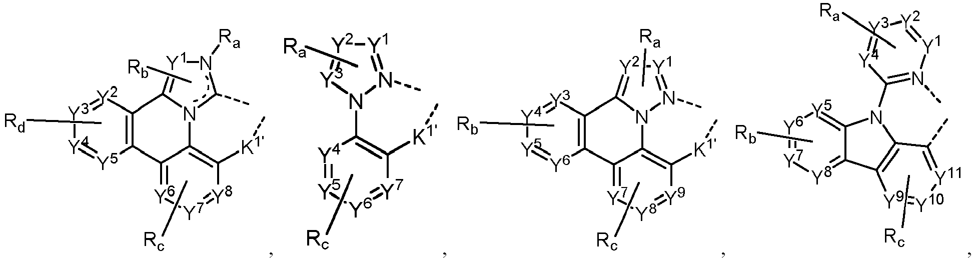 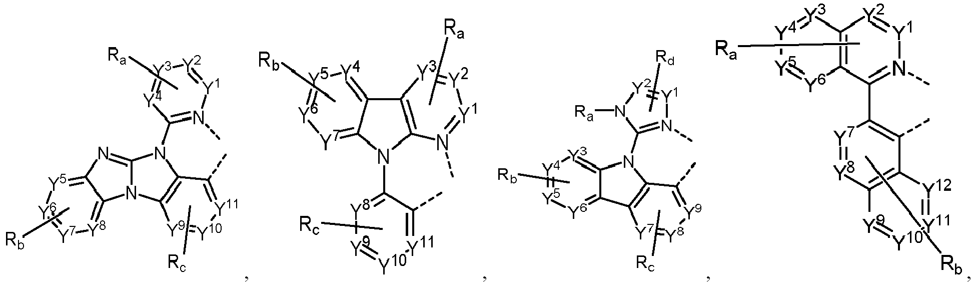 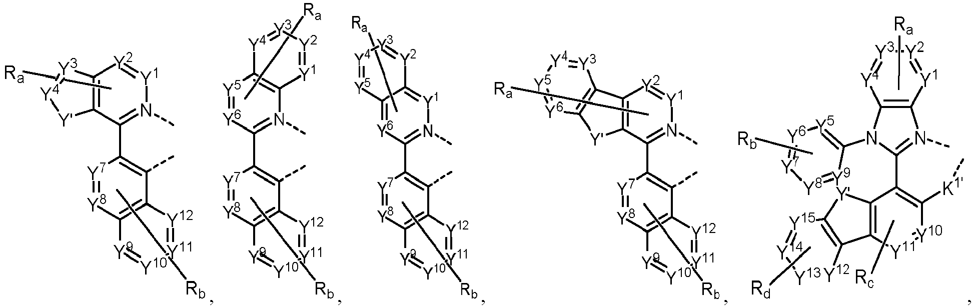 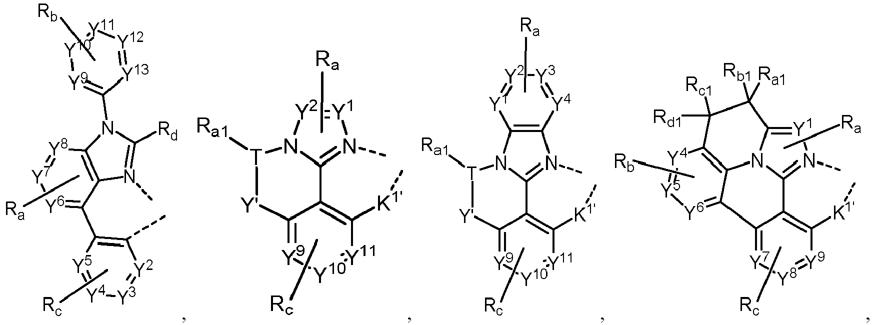 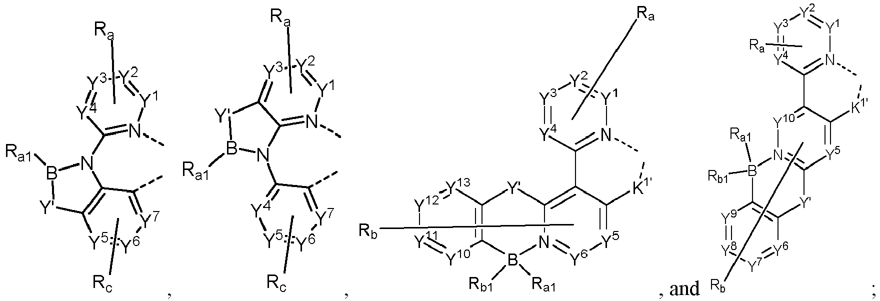
wherein T is selected from the group consisting of B, Al, Ga, and In;
wherein K^{1'} is a direct bond or is selected from the group consisting of NRₑ, PRₑ, O, S, and Se;
wherein each Y' to Y¹³ are independently selected from the group consisting of carbon and nitrogen;
wherein Y' is selected from the group consisting of BRₑ, NRₑ, PRₑ, O, S, Se, C=O, S=O, SO₂, CRₑR_{f}, SiRₑR_{f}, and GeRₑR_{f};
wherein Rₑ and R_{f} can be fused or joined to form a ring;
wherein each Rₐ, R_{b}, Rₑ, and R_{d} can independently represent from mono to the maximum possible number of substitutions, or no substitution;
wherein each Rₐ₁, R_{b1}, R_{c1}, R_{d1}, Rₐ, R_{b}, Rₑ, R_{d}, Rₑ, and R_{f} is independently a hydrogen or a substituent selected from the group consisting of the General Substituents as defined herein; and
wherein any two of Rₐ₁, R_{b1}, R_{c1}, R_{d1}, Rₐ, R_{b}, Rₑ, and R_{d} can be fused or joined to form a ring or form a multidentate ligand.

In some such embodiments, neither L_{B} nor L_{C} is

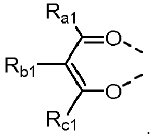

In some embodiments, L_{B} and Lc are each independently selected from the group consisting of the structures of the following LIST 7: 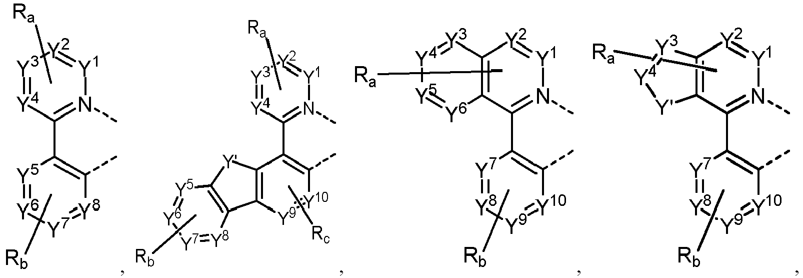 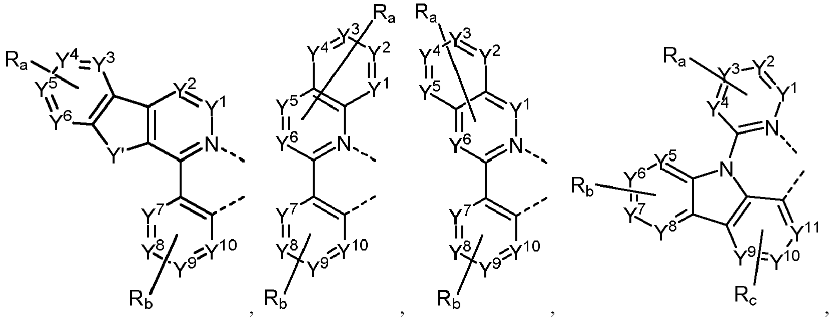 and

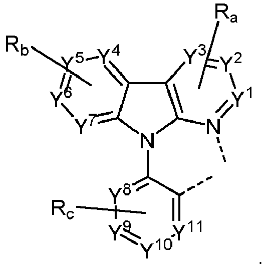

In some embodiments, L_{B} and Lc are each independently selected from the group consisting of the structures of the following LIST 8: 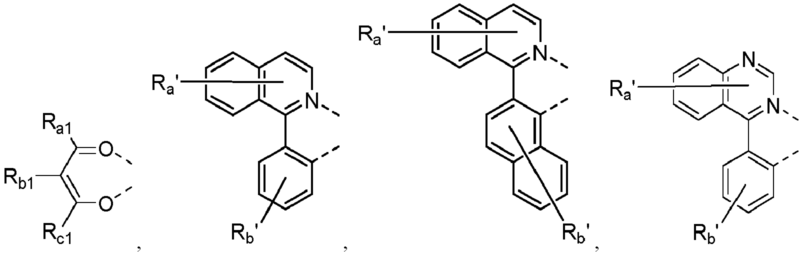 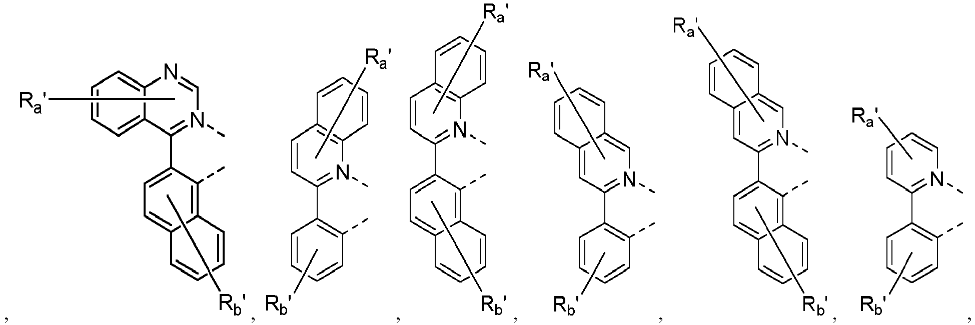 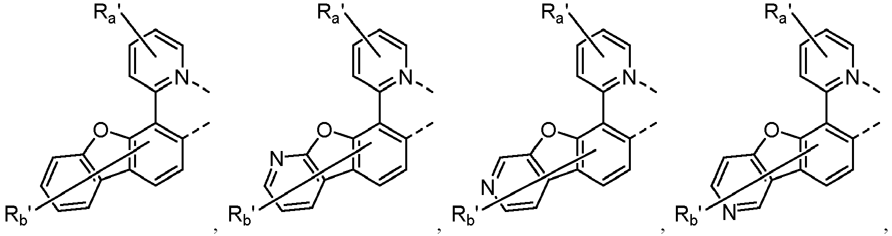 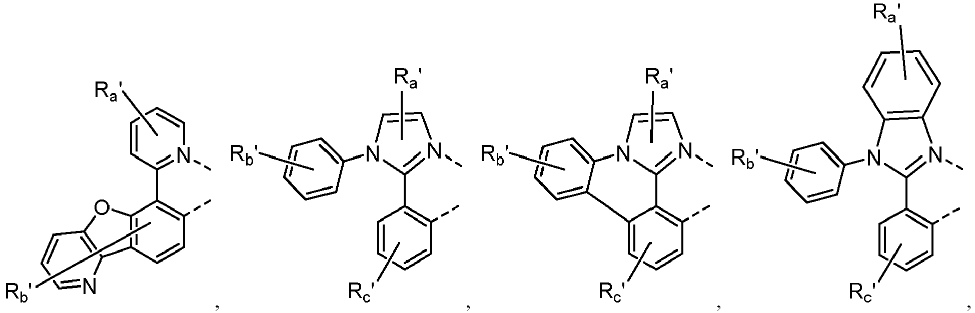 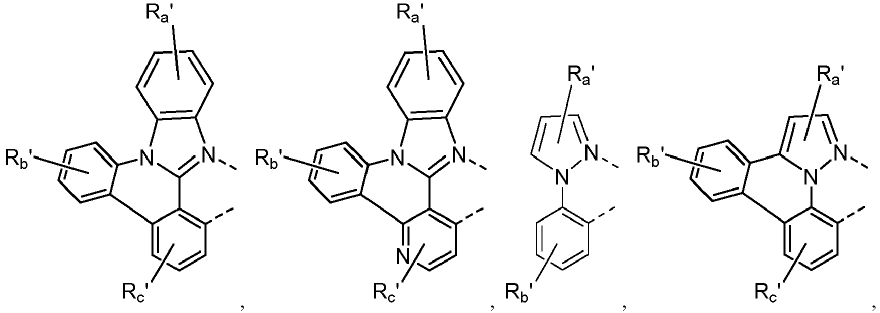 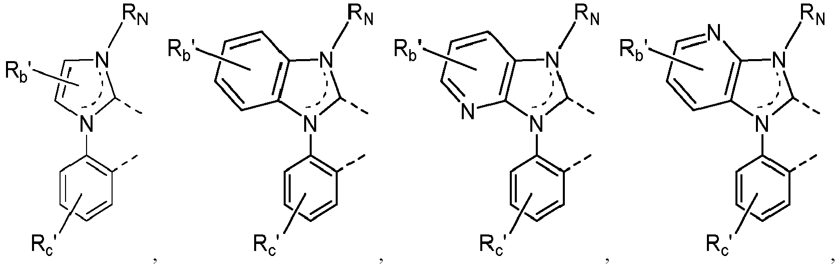 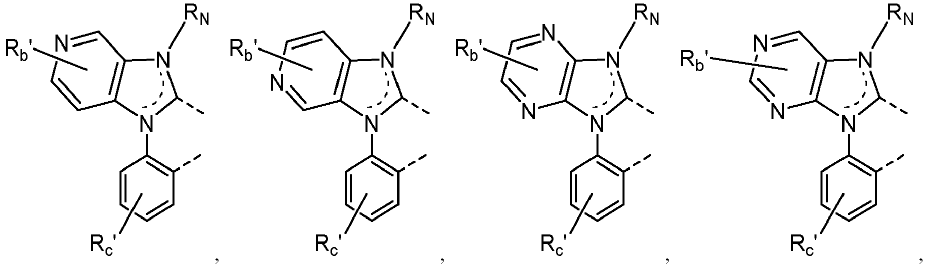 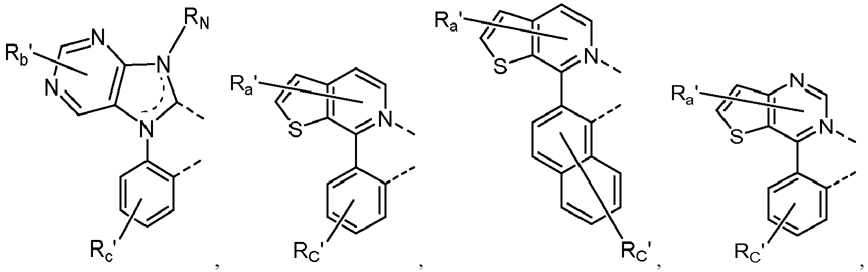 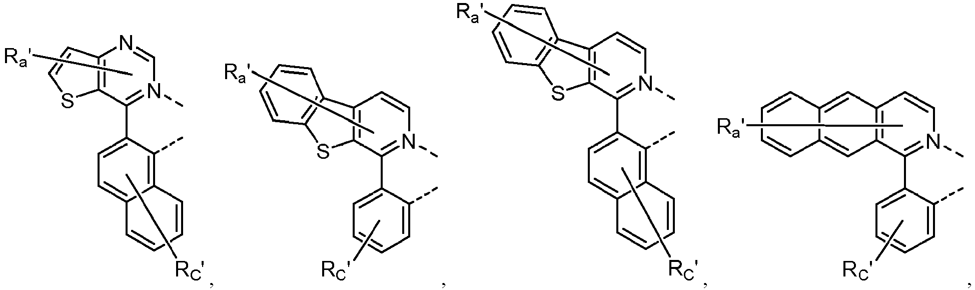 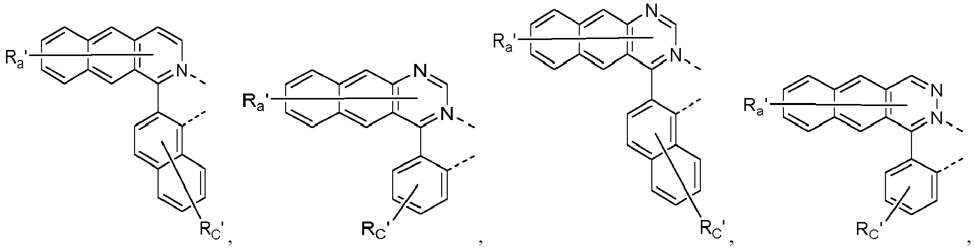 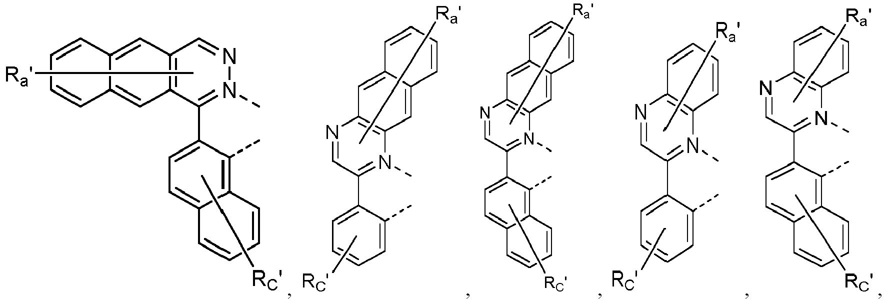 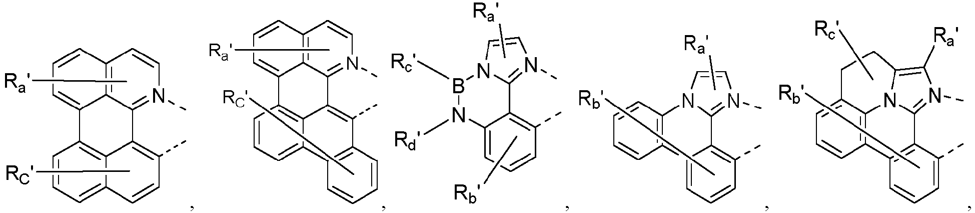 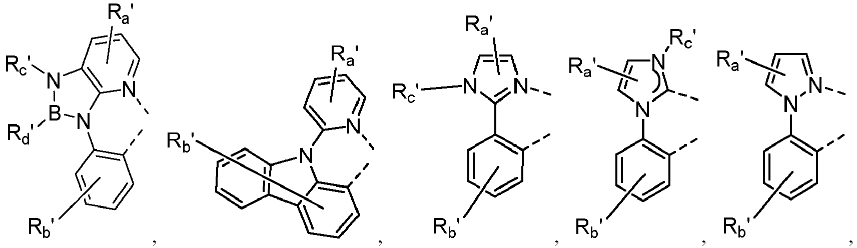 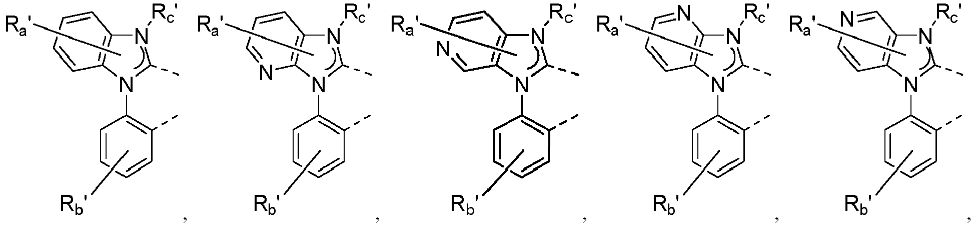 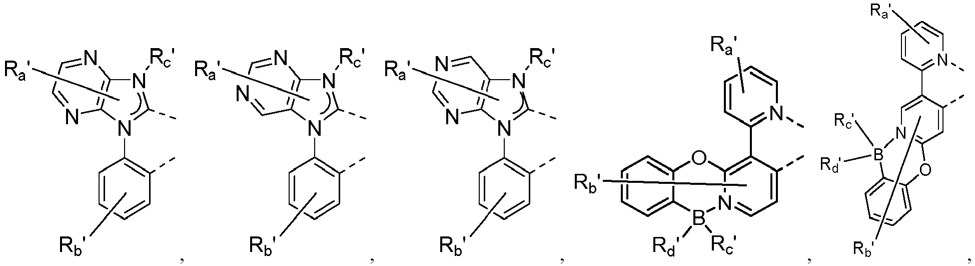 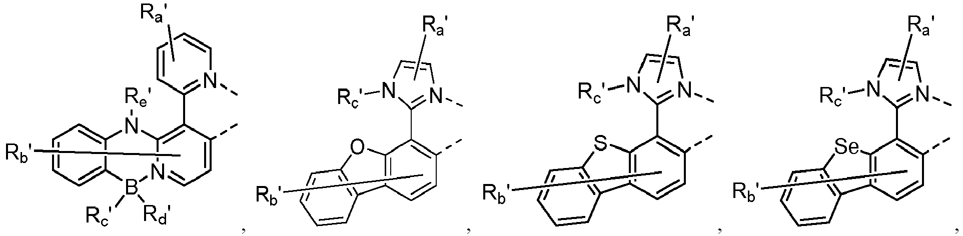 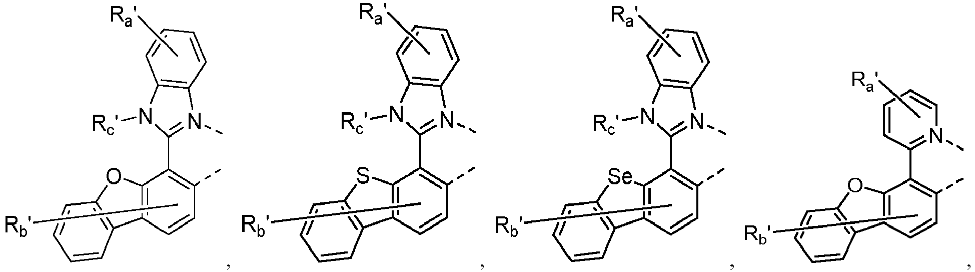 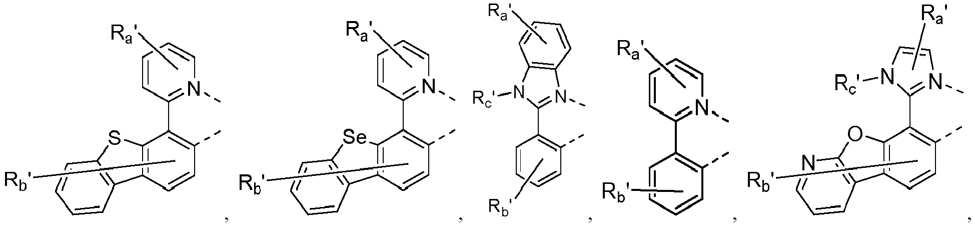 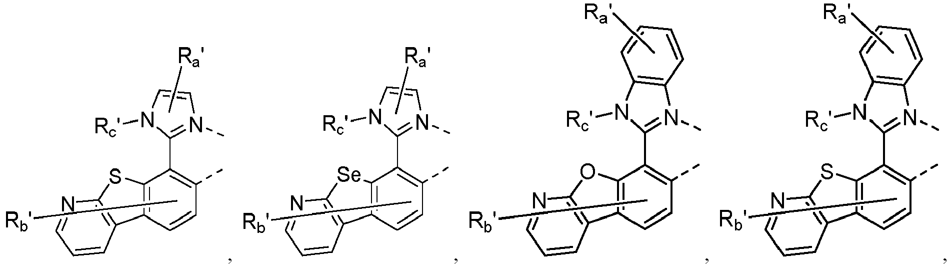 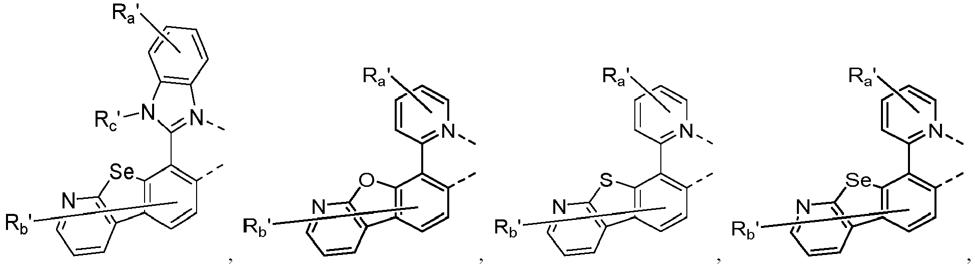 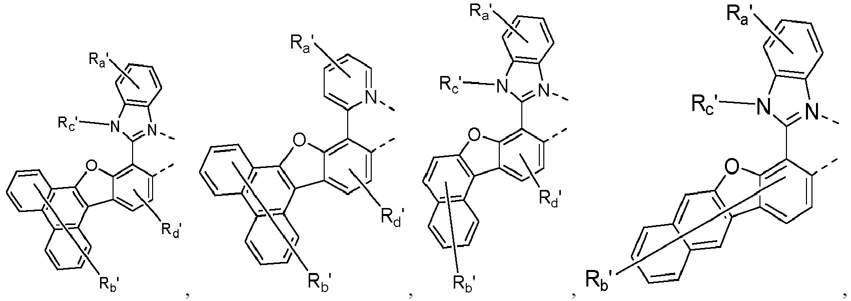 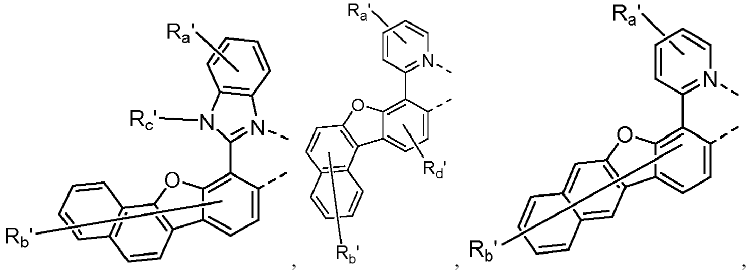 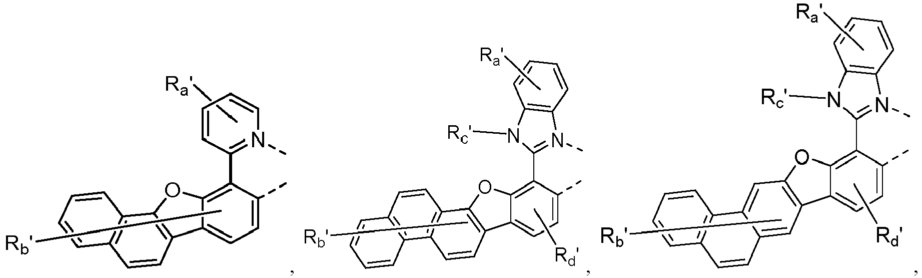 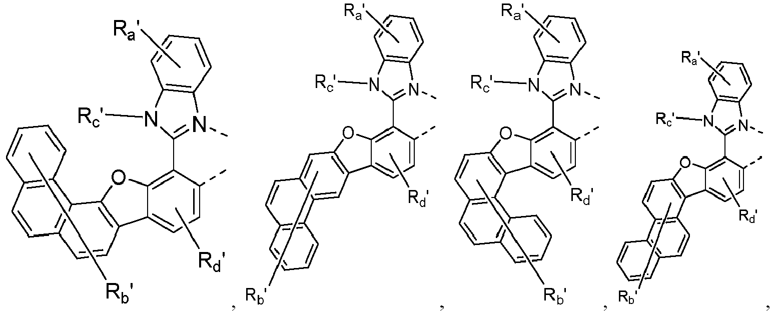 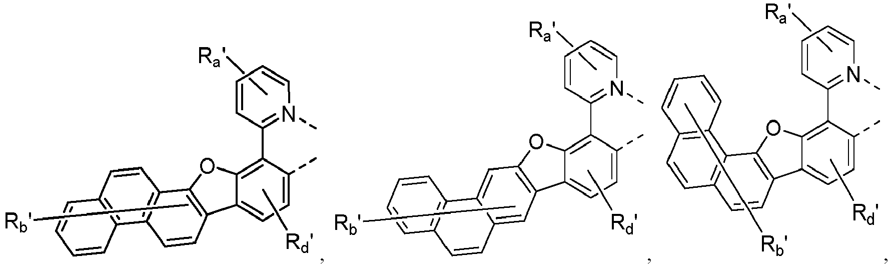 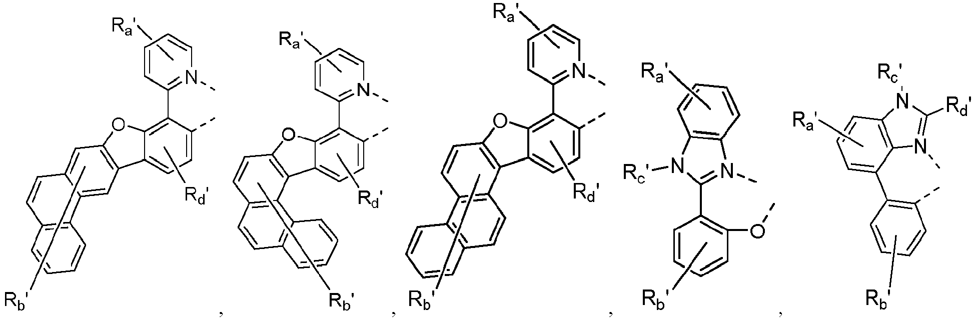 , and 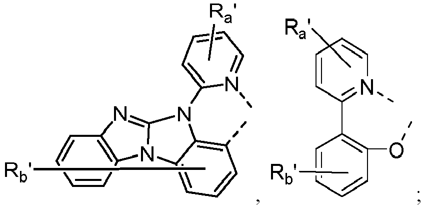 wherein:
Rₐ', R_{b}', R_{c}', R_{d}', and Rₑ' each independently represents zero, mono, or up to a maximum allowed number of substitutions to its associated ring;
each of Rₐ₁, R_{b1}, R_{c1}, Rₐ, R_{b}, Rₑ, R_{N}, Rₐ', R_{b}', R_{c}', R_{d}', and Rₑ' is independently hydrogen or a substituent selected from the group consisting of the General Substituents defined herein; and
any two Rₐ₁, R_{b1}, R_{c1}, Rₐ, R_{b}, Rₑ, R_{N}, Rₐ', R_{b}', Rₑ', R_{d}', and Rₑ'can be fused or joined to form a ring or form a multidentate ligand.

In some such embodiments, neither L_{B} nor L_{C} is

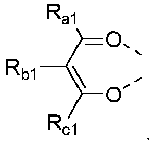

In some embodiments, L_{B} and Lc are each independently selected from the group consisting of the structures of the following LIST 8a:

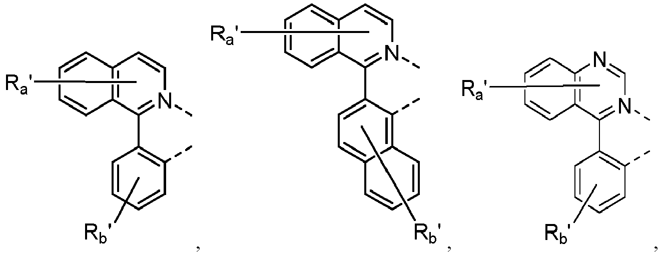

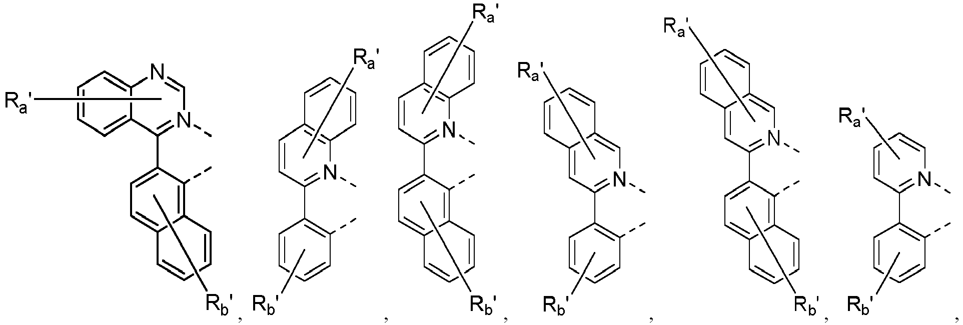

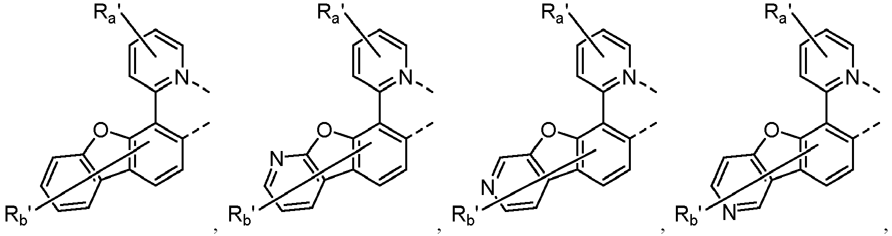

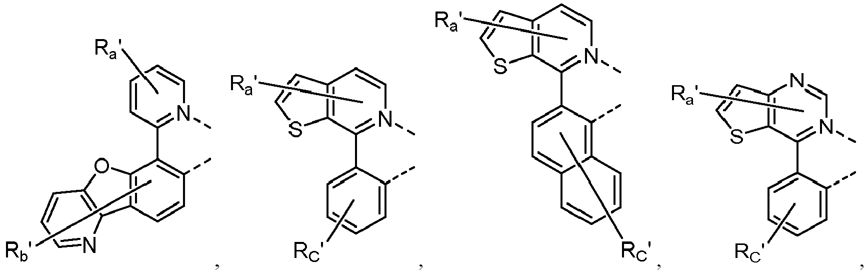

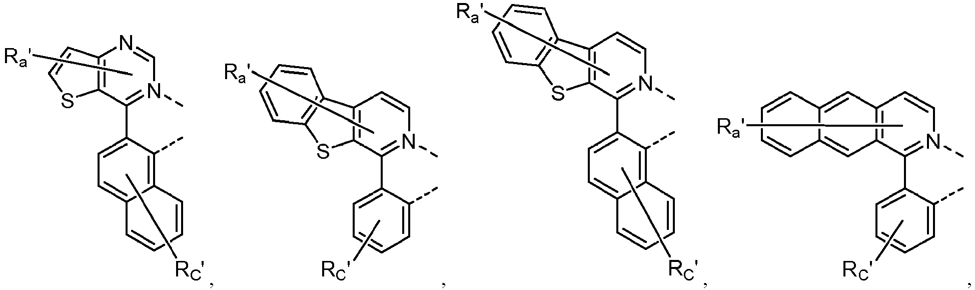

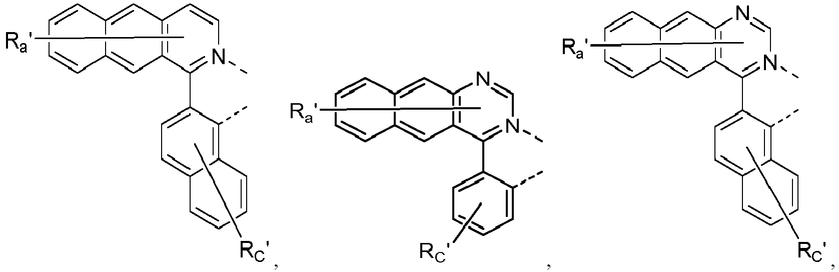

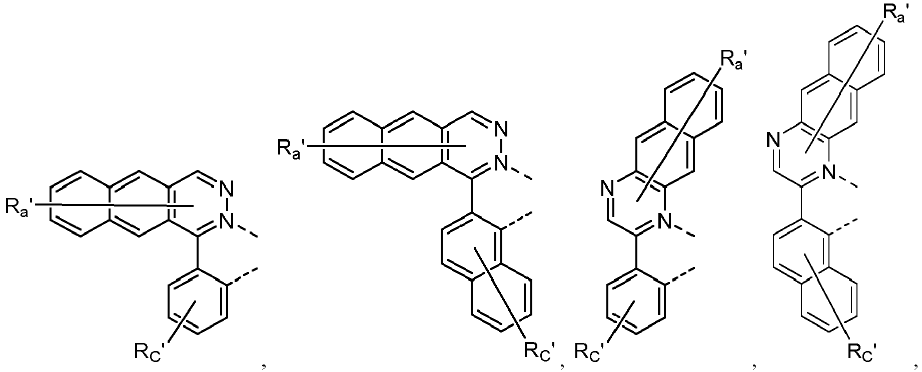

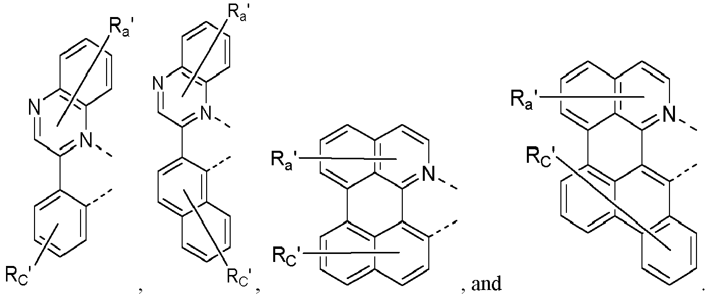

In some embodiments, the compound can have the formula Ir(L_{A})₃, the formula Ir(L_{A})(L_{B*k*})₂, the formula Ir(L_{A})₂(L_{Bk}), the formula Ir(L_{A})₂(L_{*Cj*-*I*}), the formula Ir(L_{A})₂(L_{*Cj*-*II*}), the formula Ir(L_{A})(L_{B*k*})(L*_{Cj-I}*), or the formula Ir(L_{A})(L_{B*k*})(L_{*Cj*-*II*}), wherein L_{A} is a ligand with respect to Formula I as defined here; L_{B*k*} is defined herein; and L_{*Cj*-*I*} and L_{*Cj*-*II*} are each defined herein.

In some embodiments, the compound has formula Ir(L_{A})₃, formula Ir(L_{A})(L_{B*k*})₂, formula Ir(L_{A})₂(L_{B*k*}), formula Ir(L_{A})₂(L_{*Cj-*I}), or formula Ir(L_{A})₂(L_{*Cj*-I}),
wherein L_{A} can be any L_{A} described herein;
wherein k is an integer from 1 to 520;
wherein each L_{B*k*} has the structure defined in the following LIST 9: 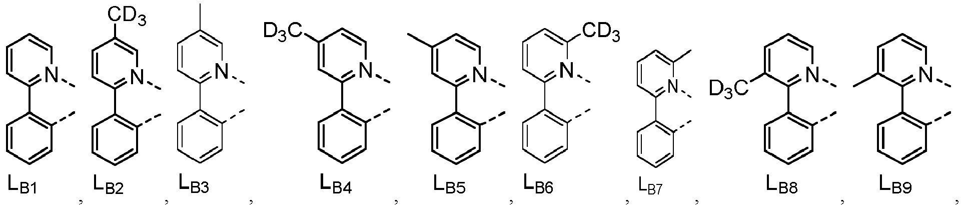 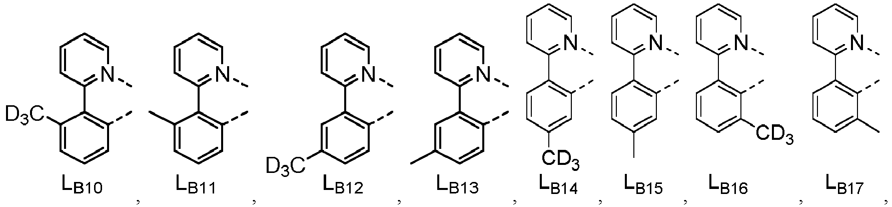 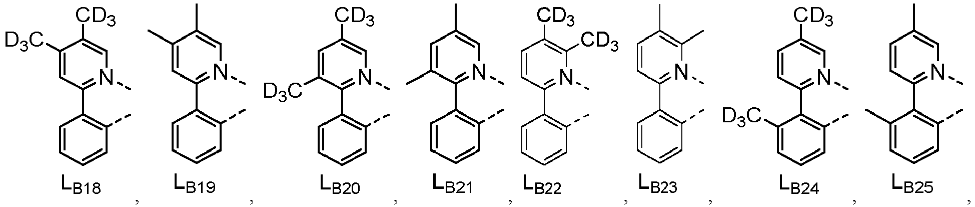 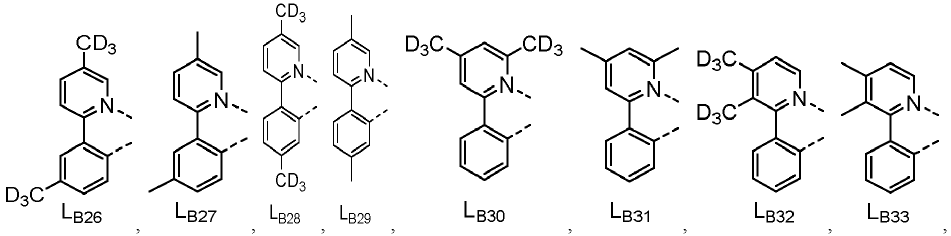 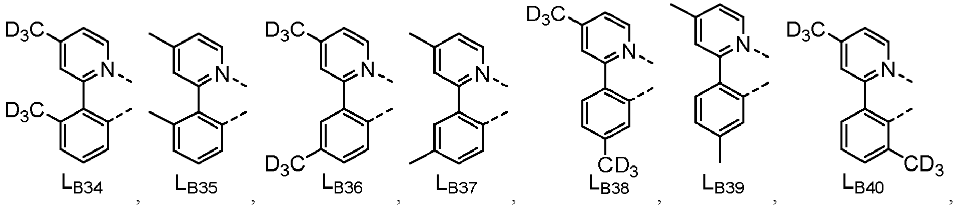 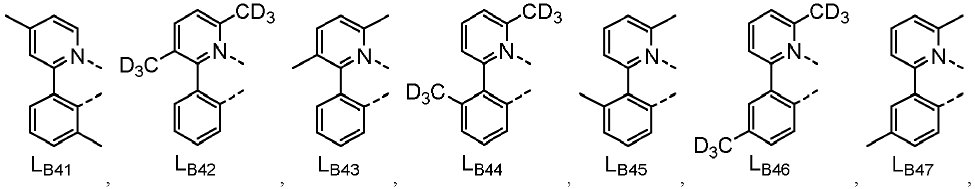 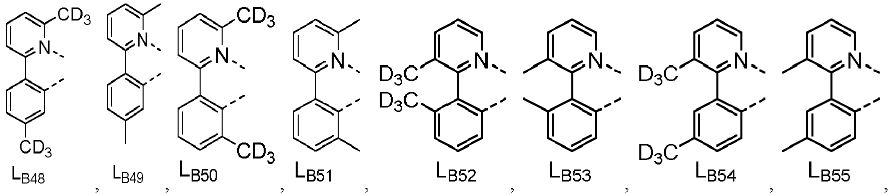 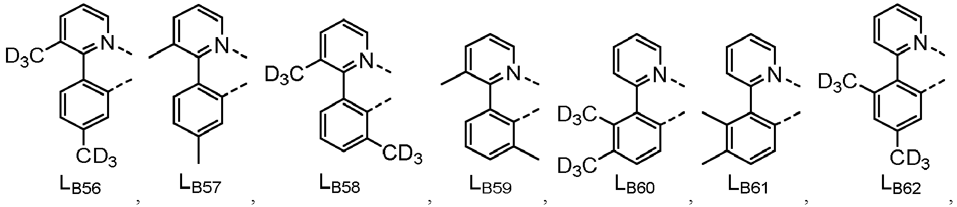 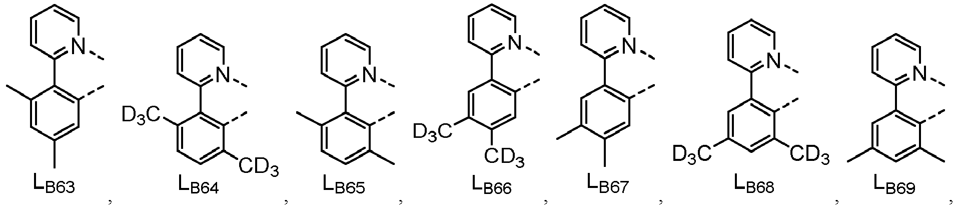 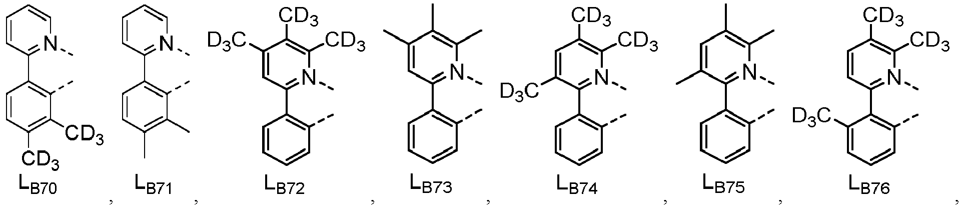 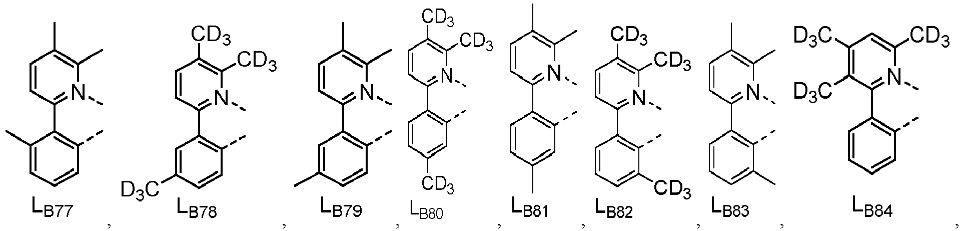 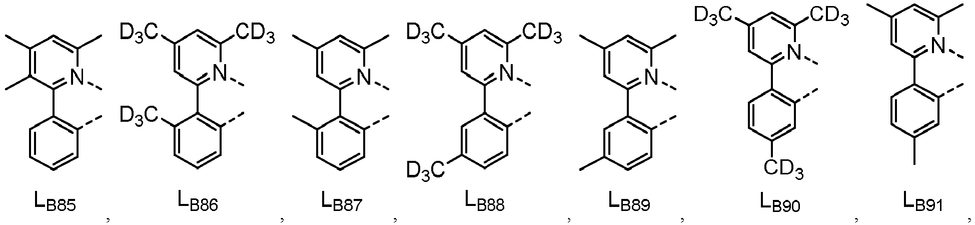 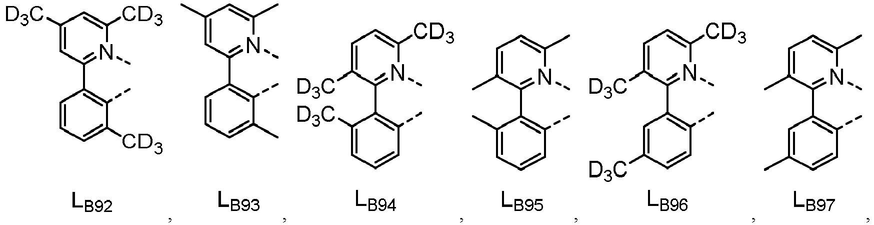 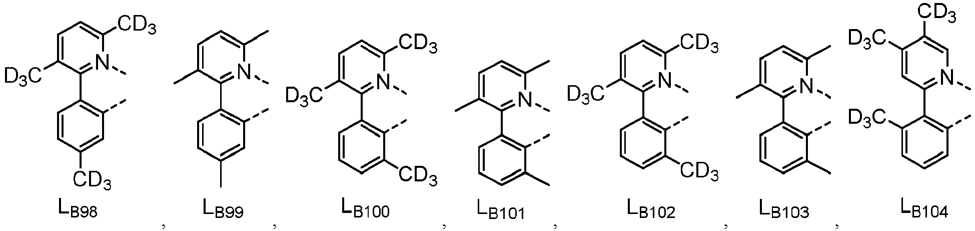 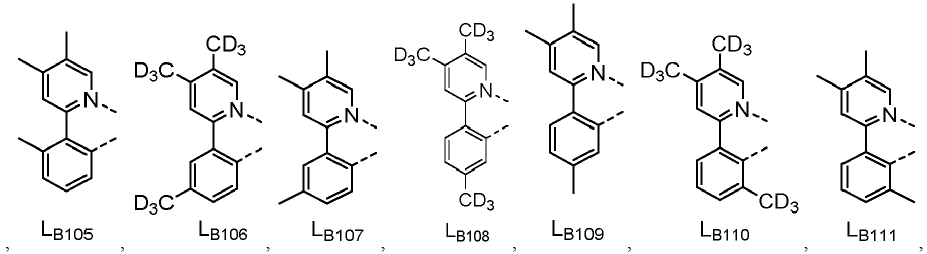 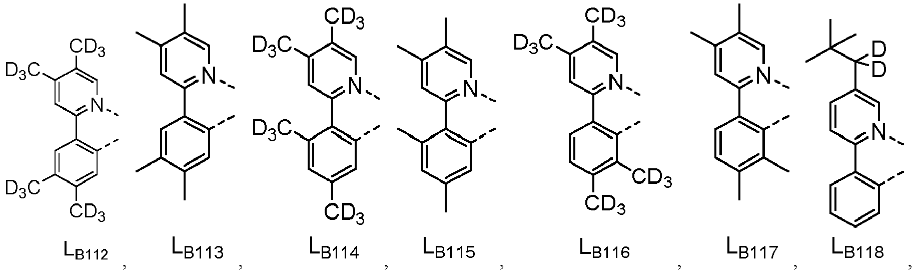 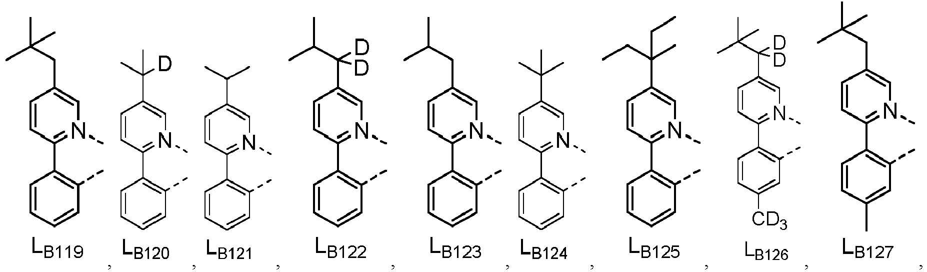 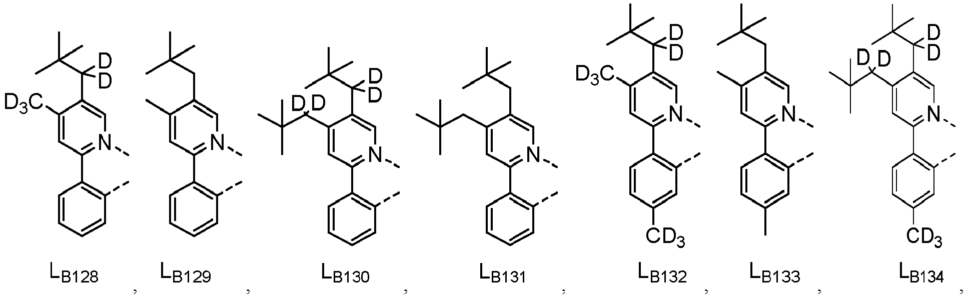 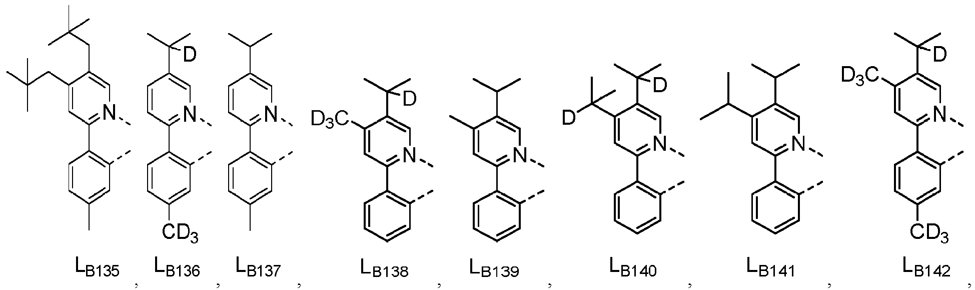 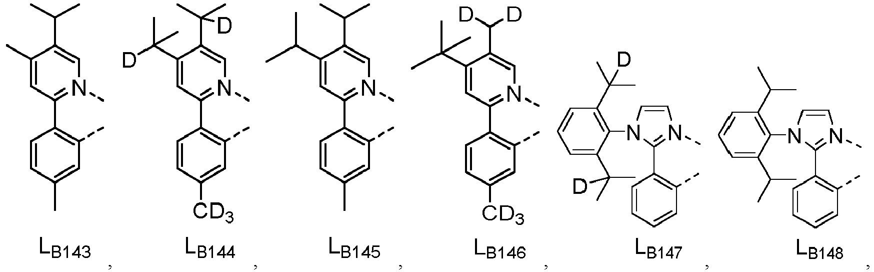 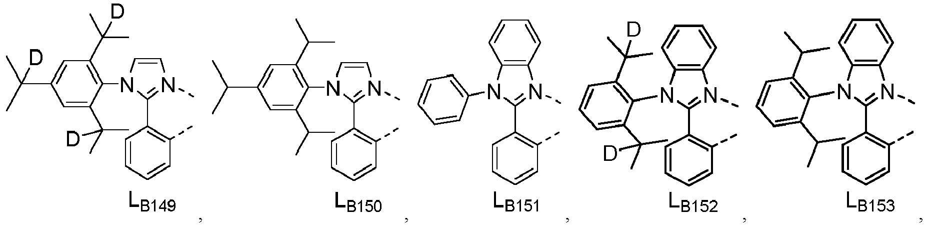 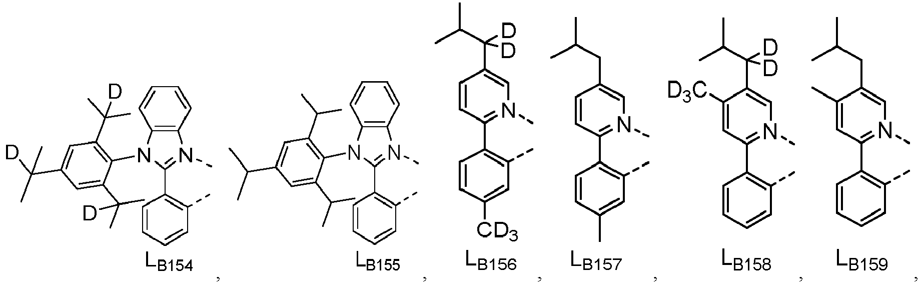 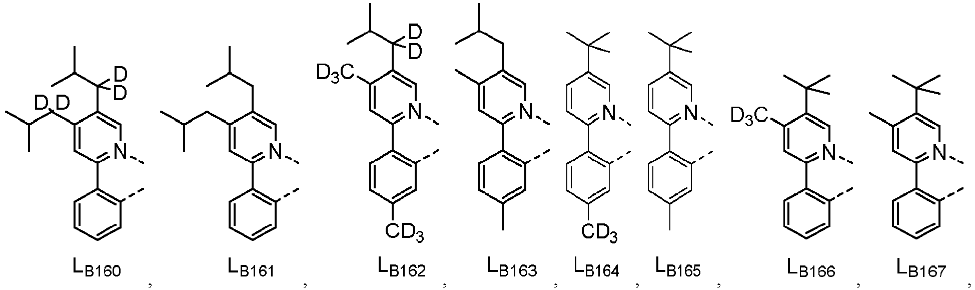 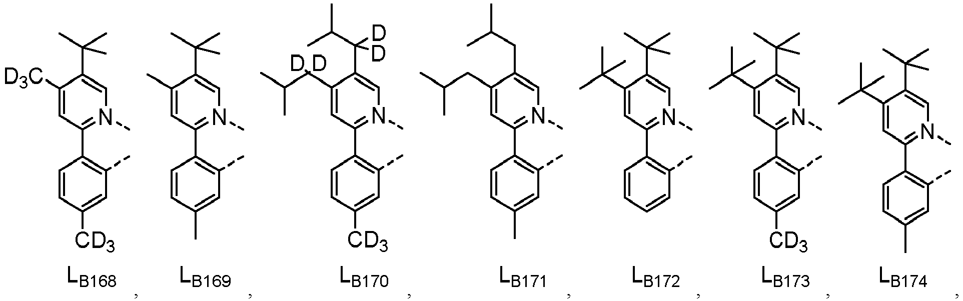 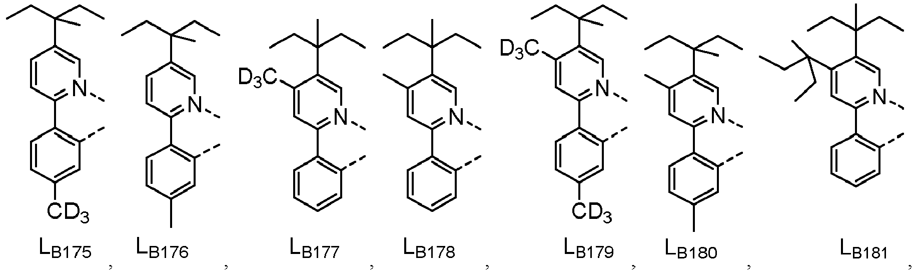 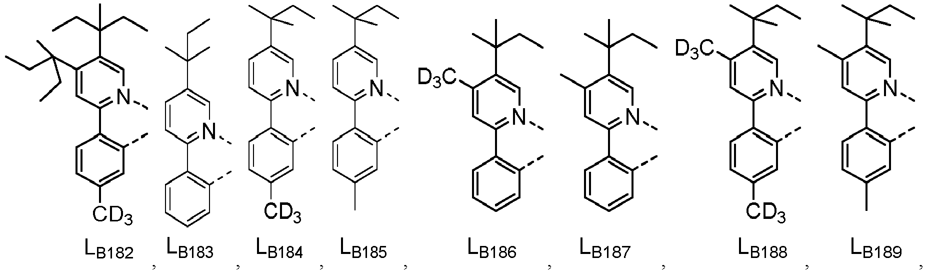 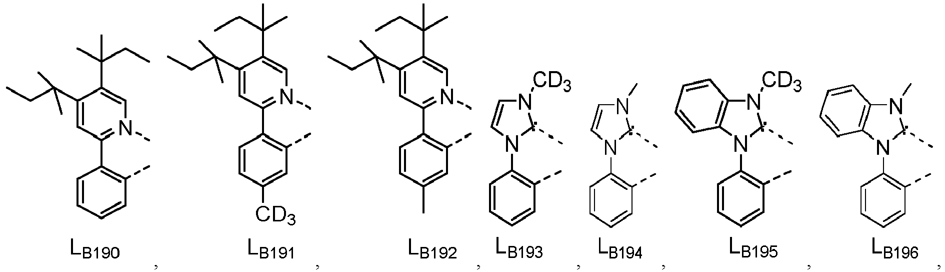 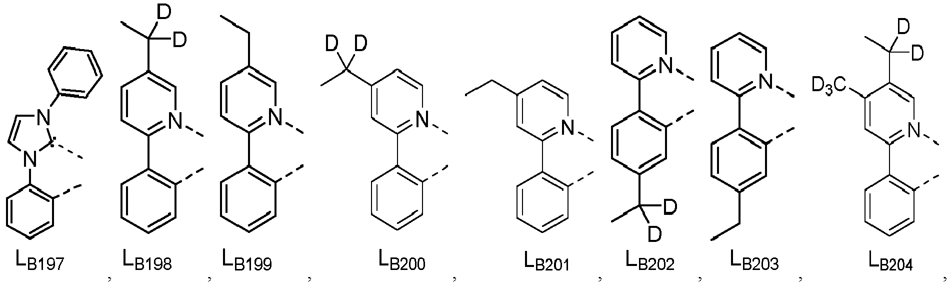 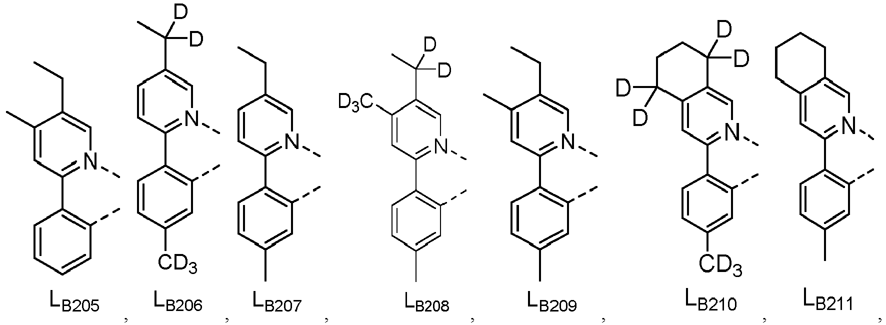 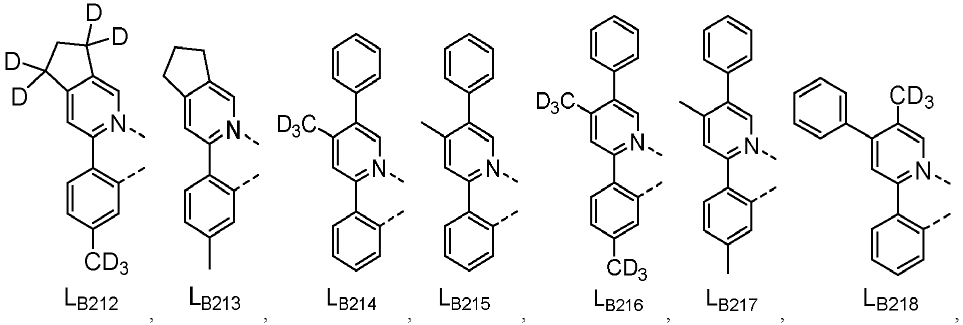 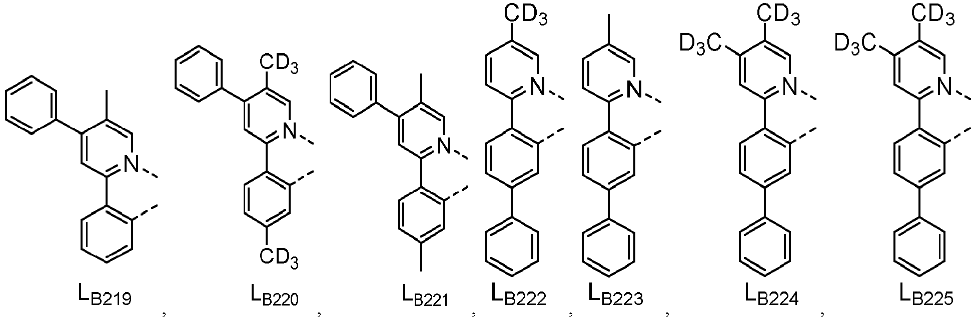 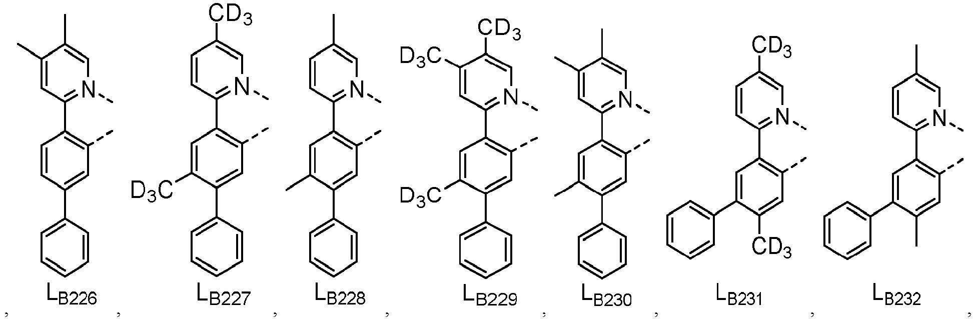 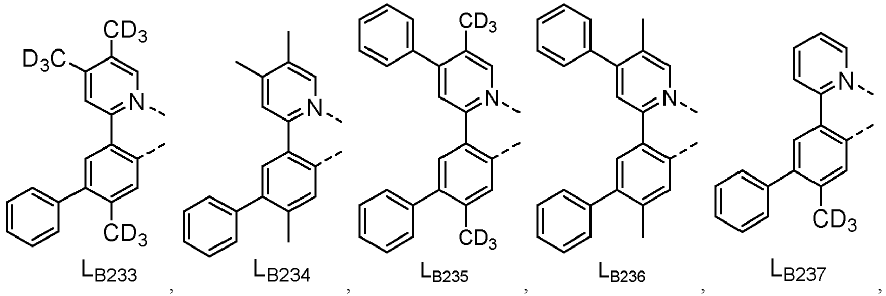 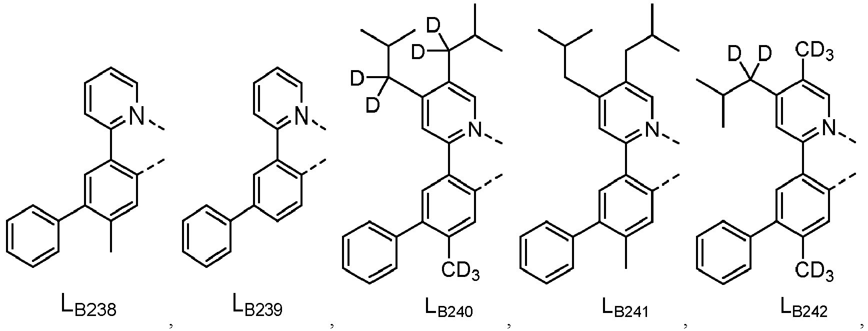 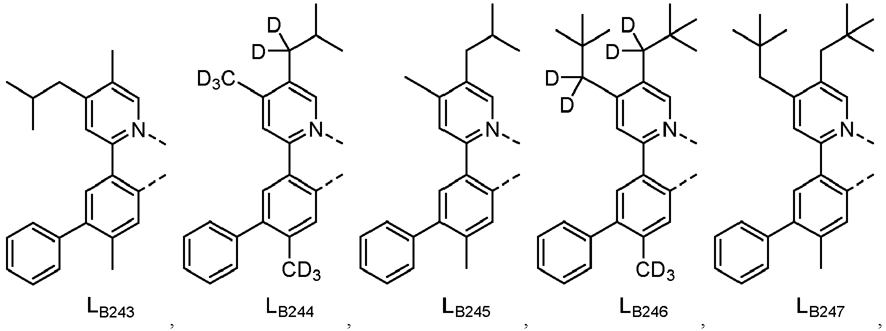 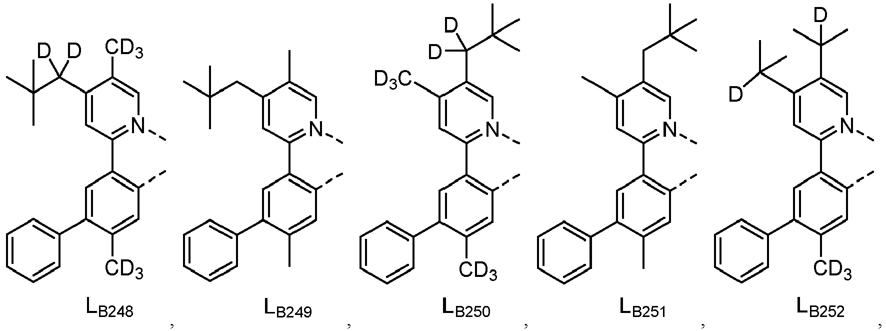 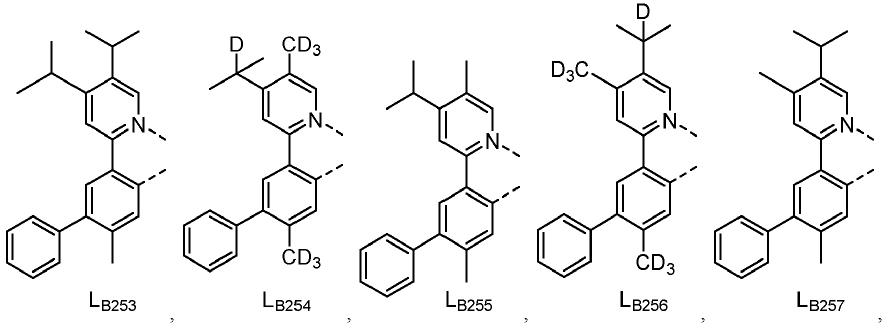 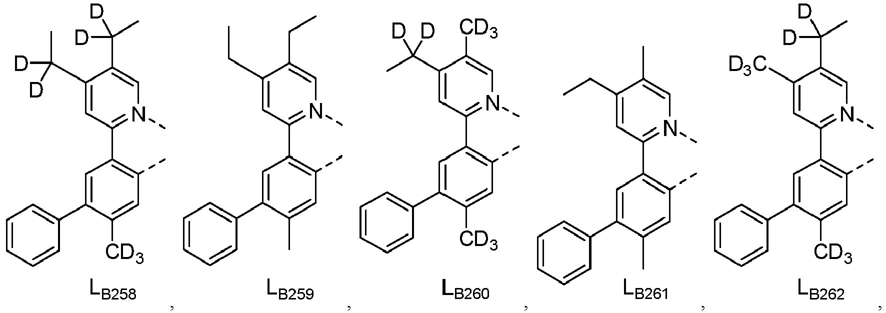 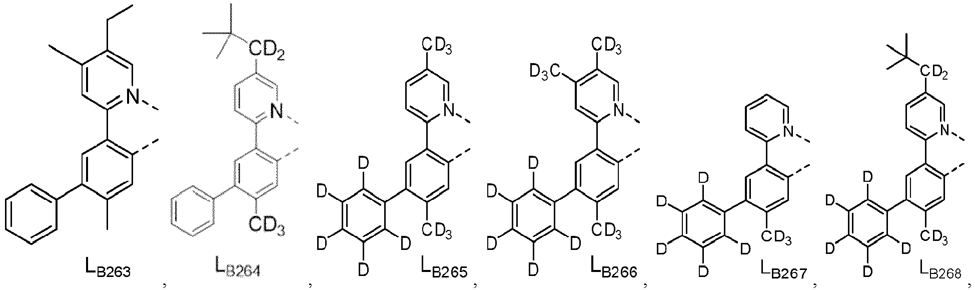 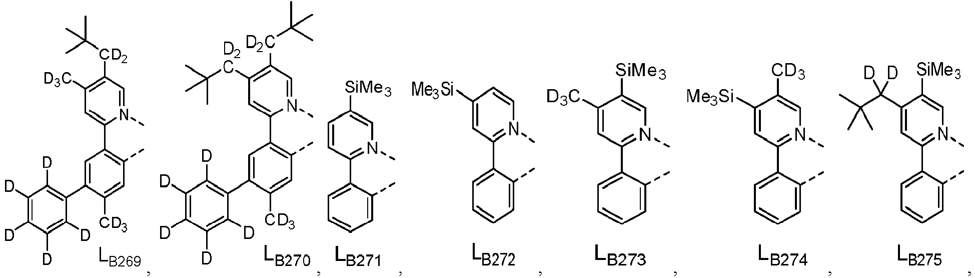 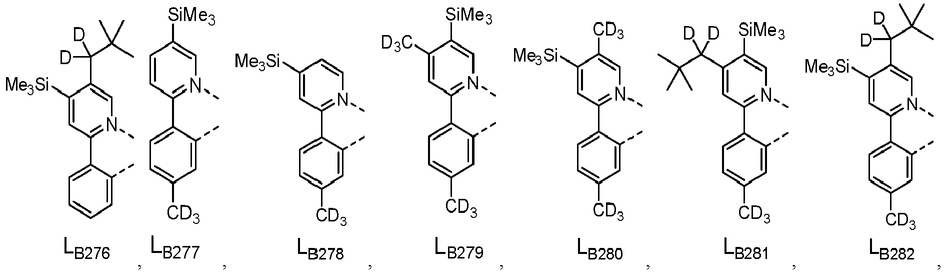 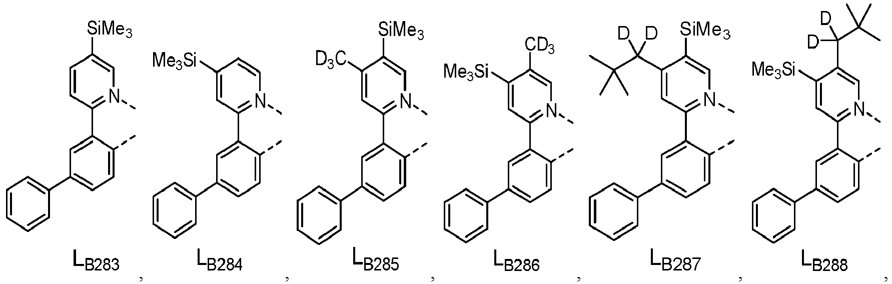 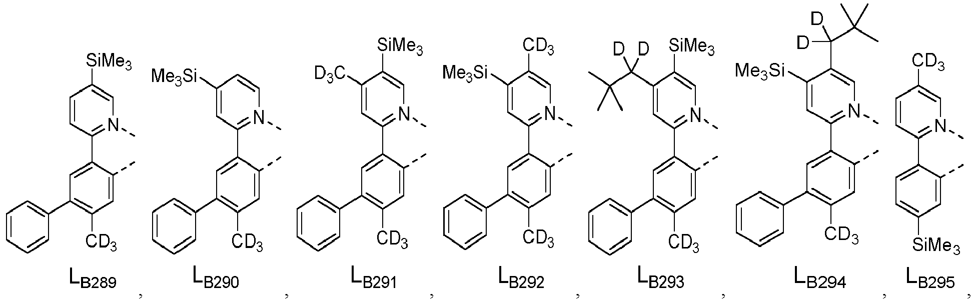 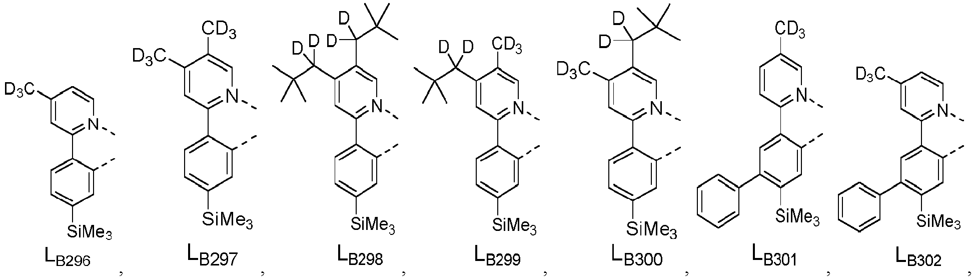 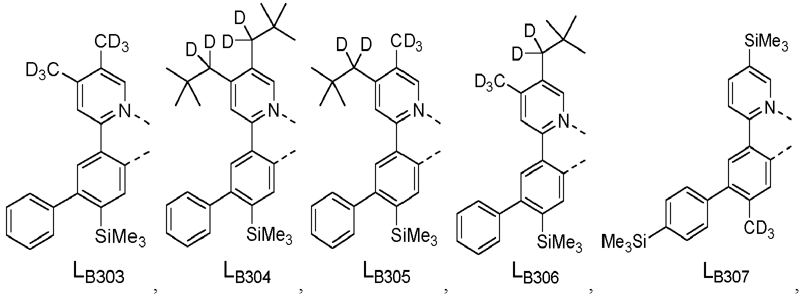 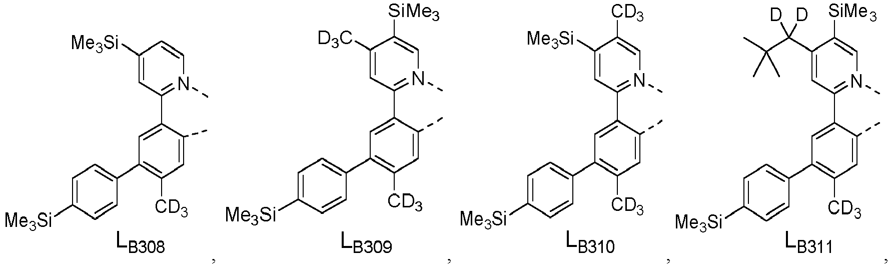 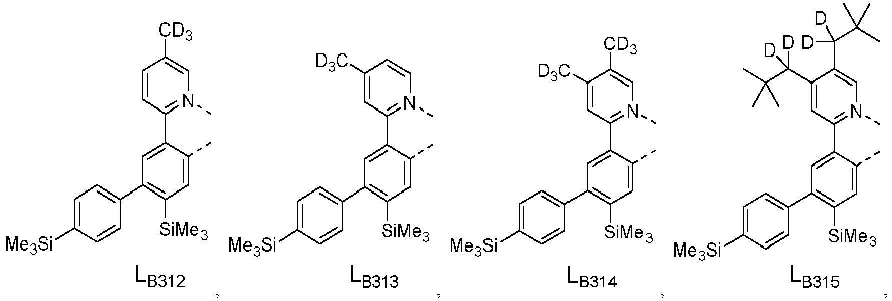 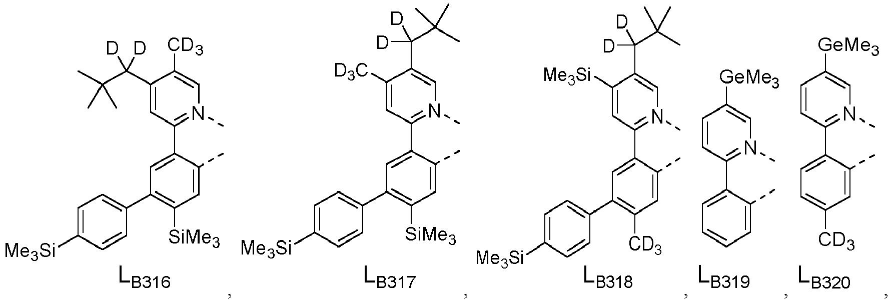 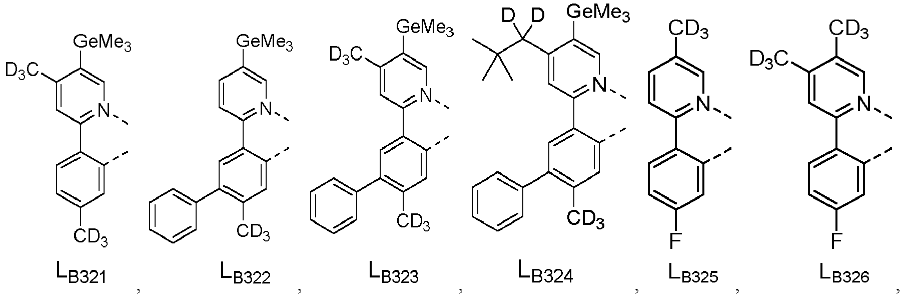 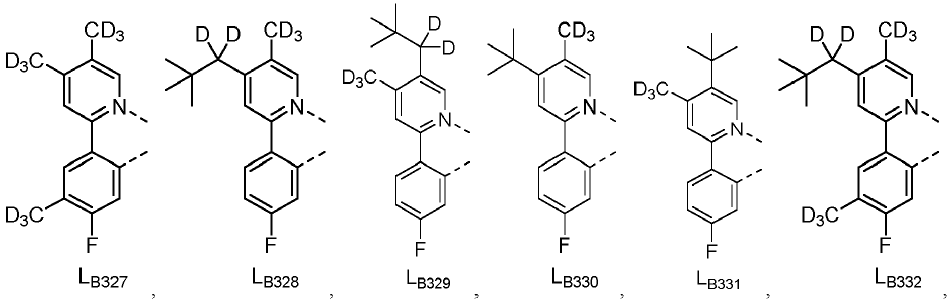 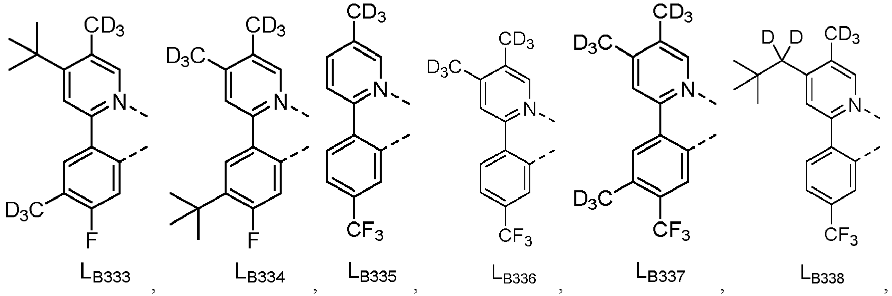 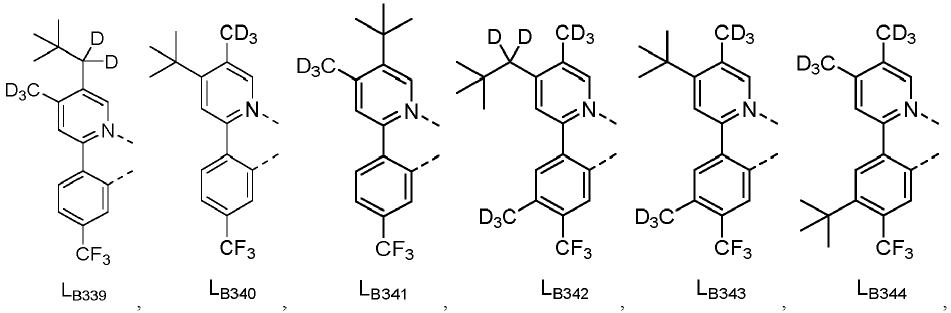 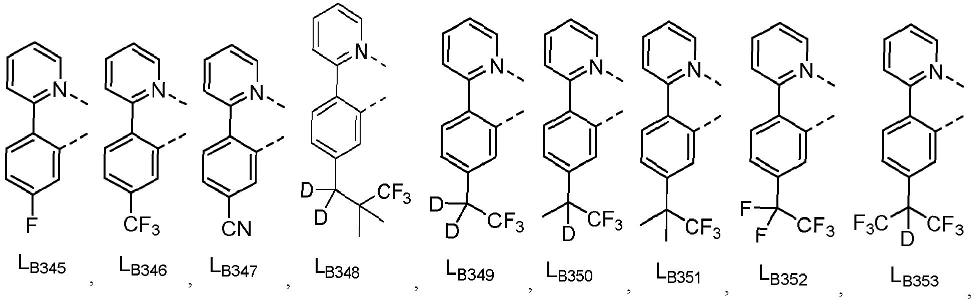 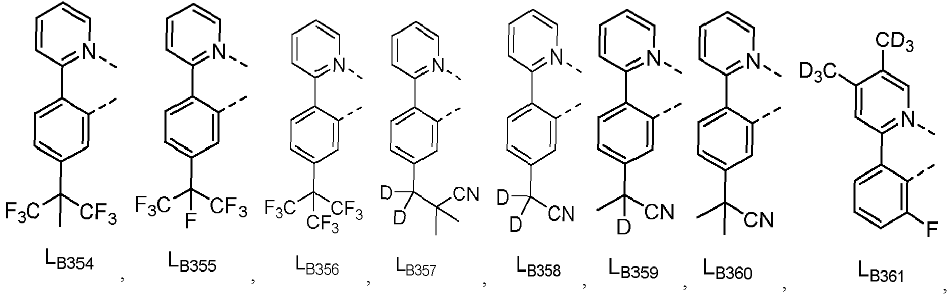 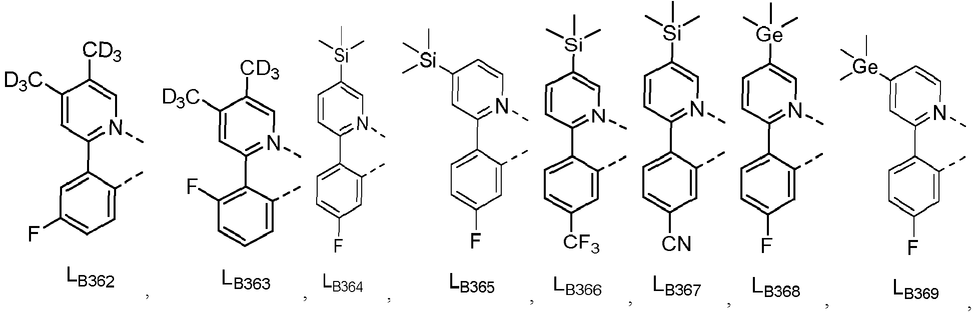 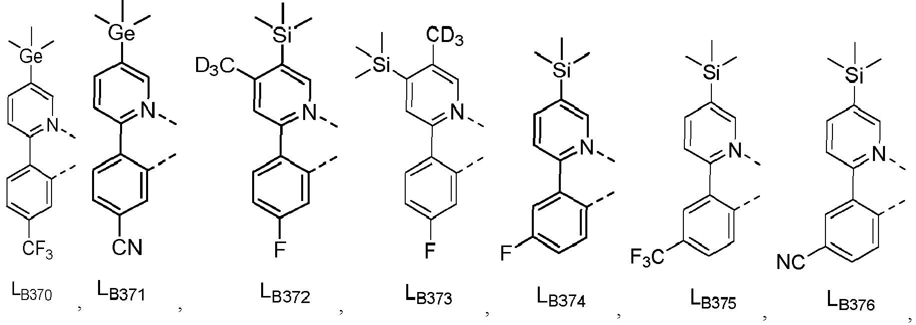 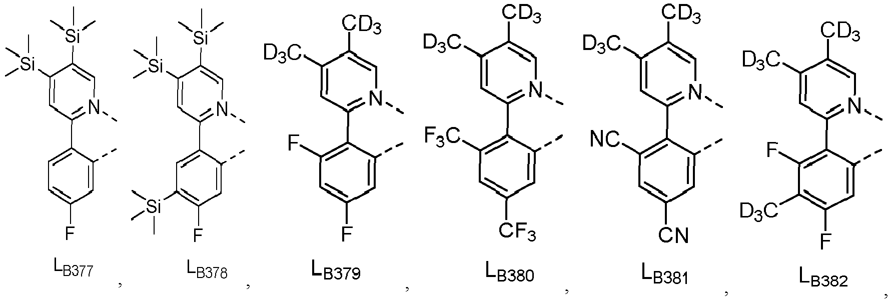 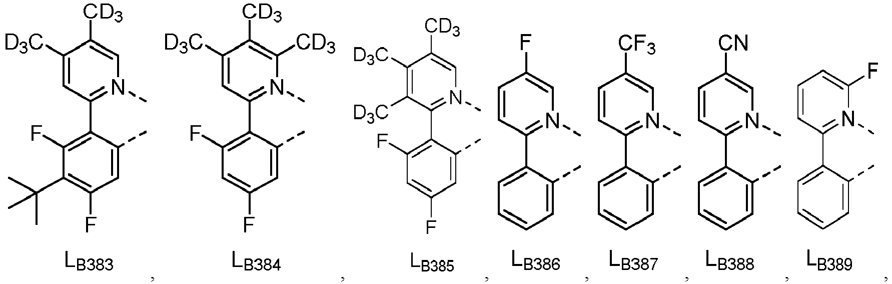 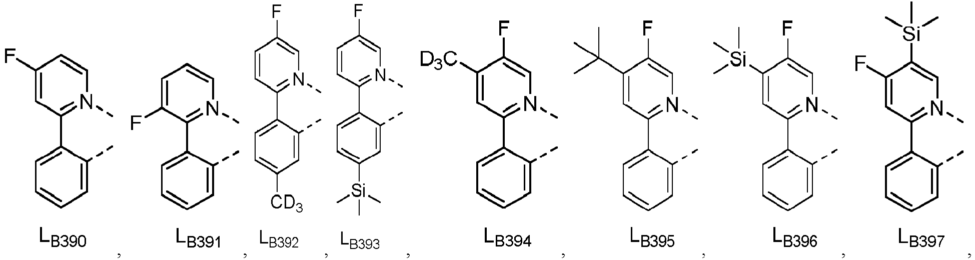 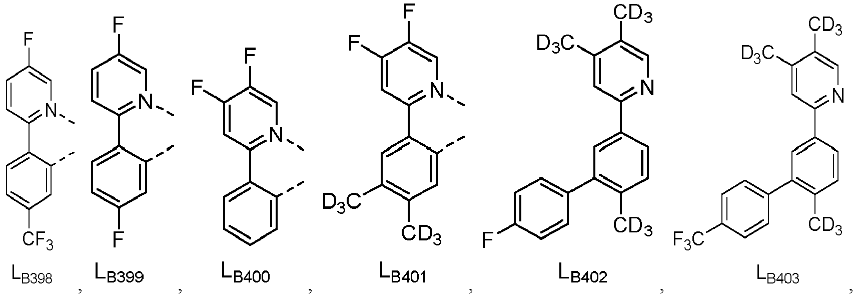 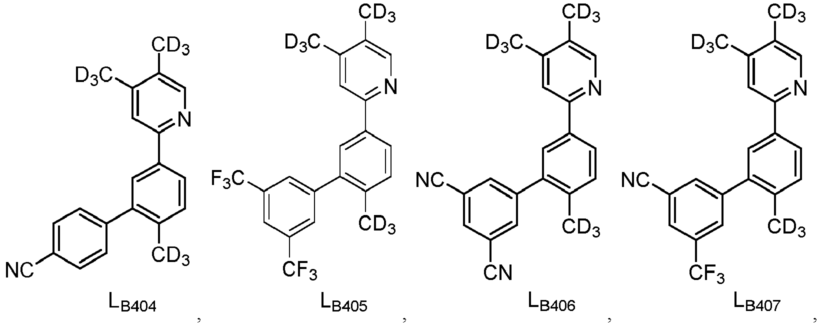 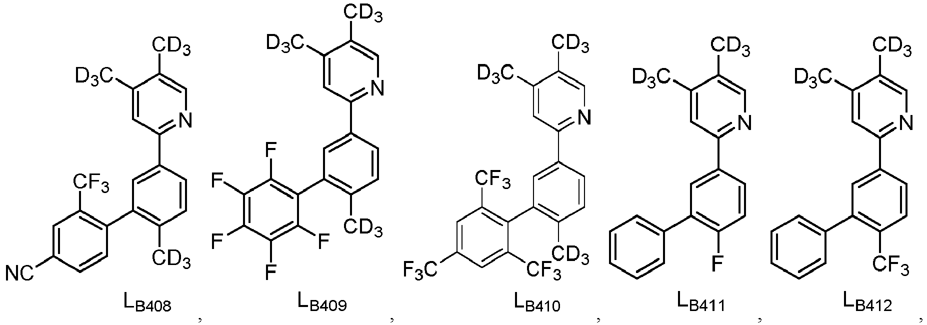 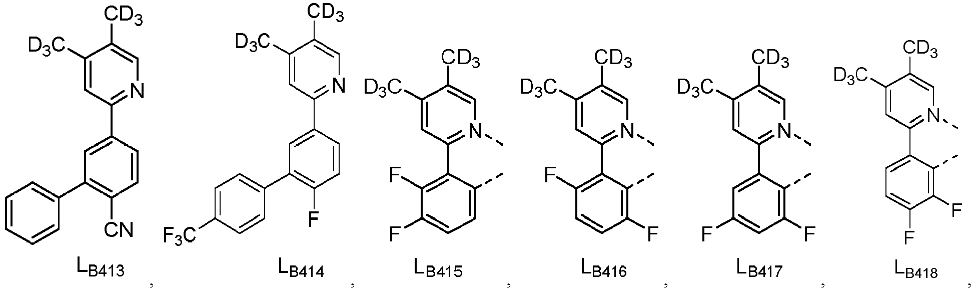 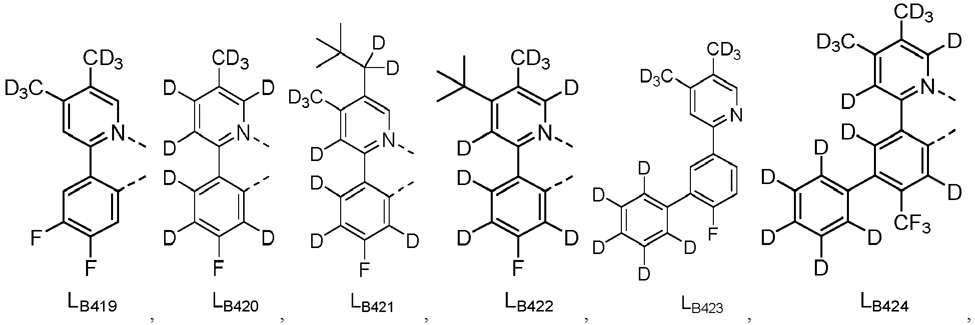 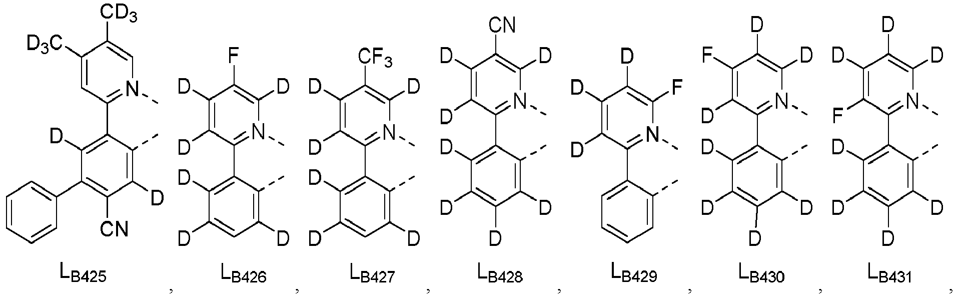 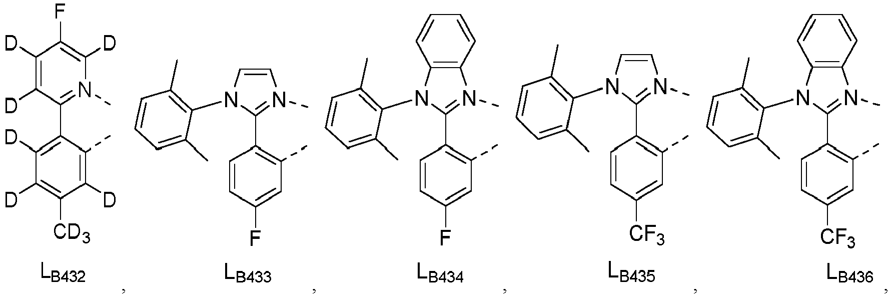 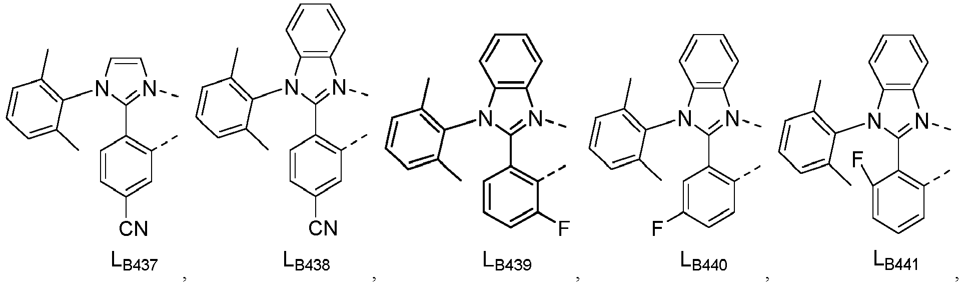 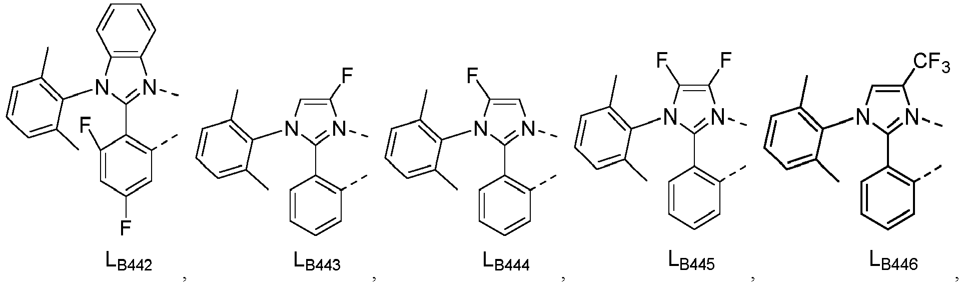 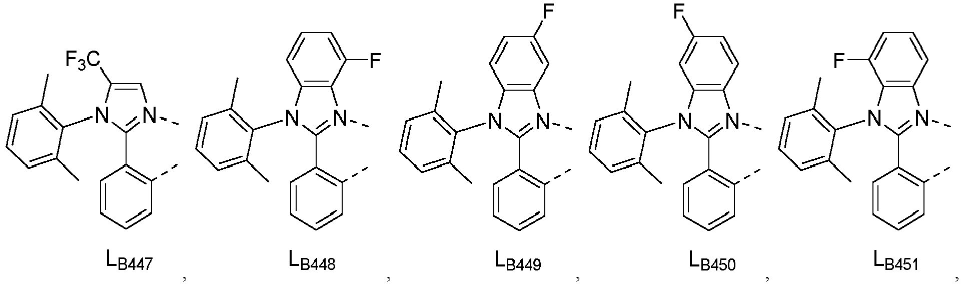 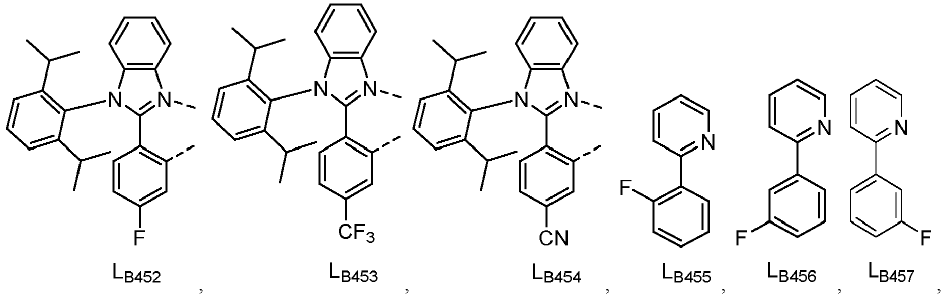 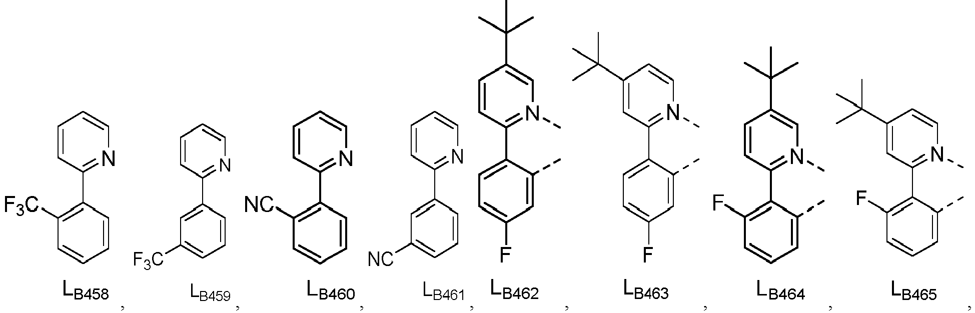 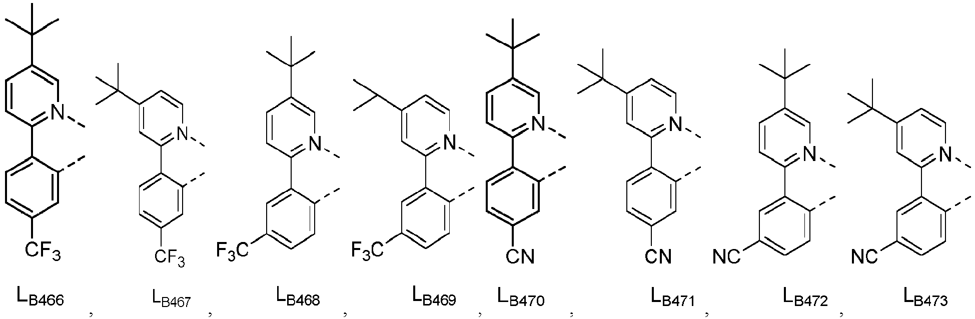 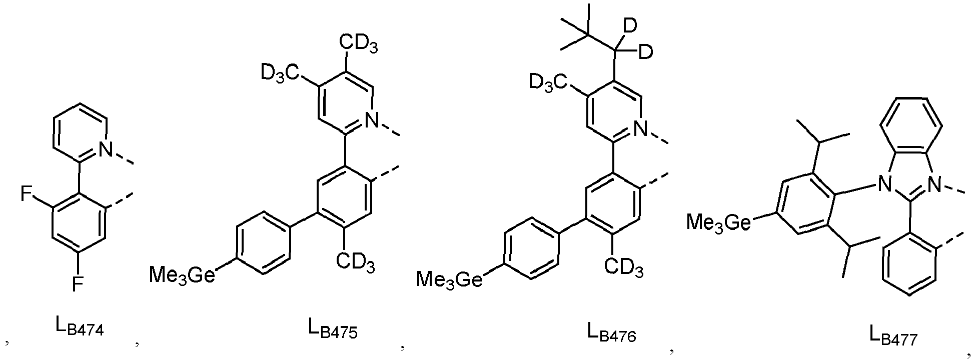 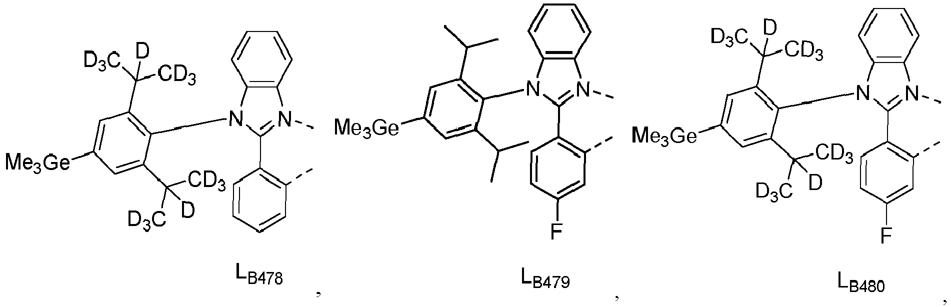 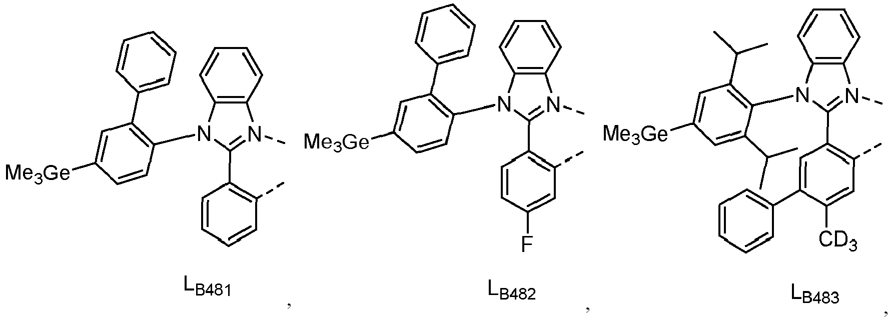 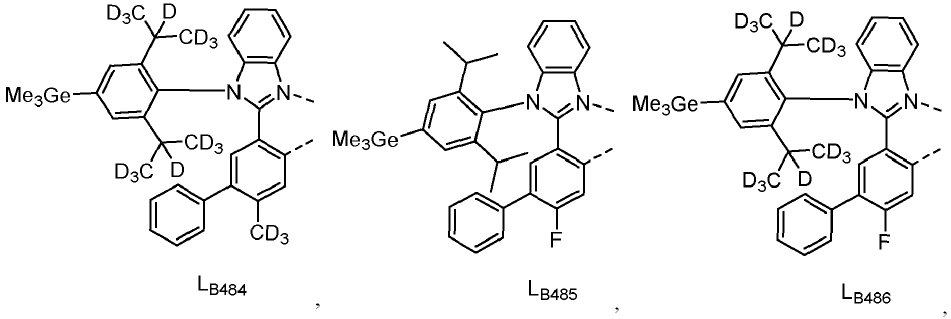 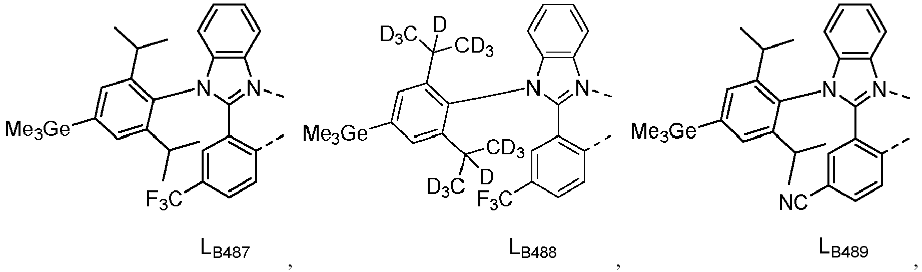 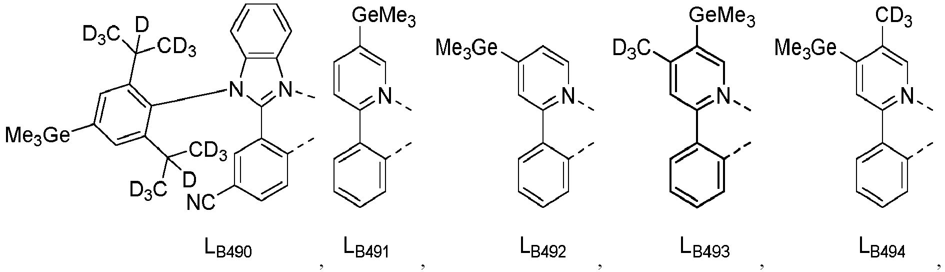 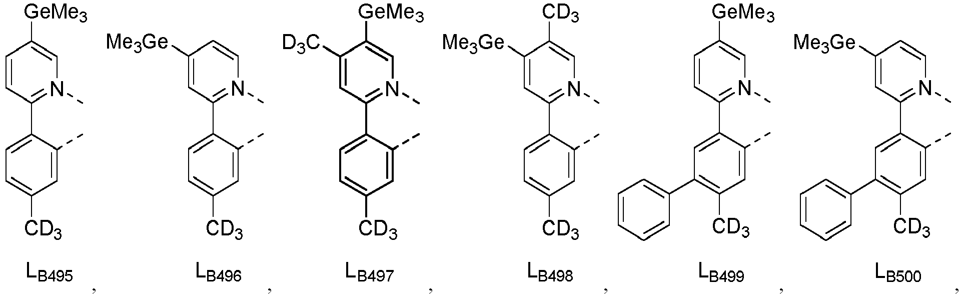 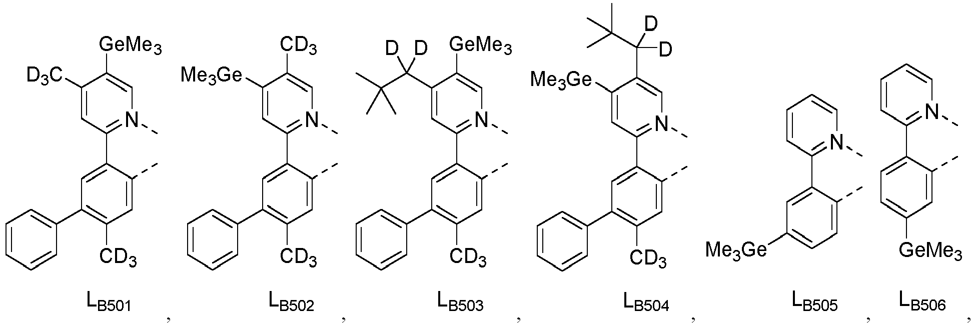 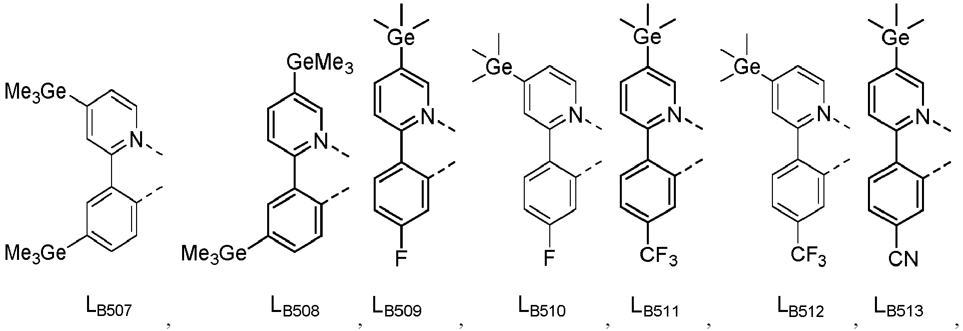 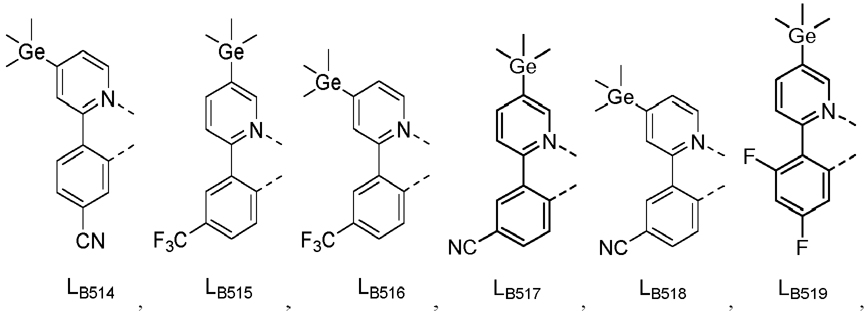 and 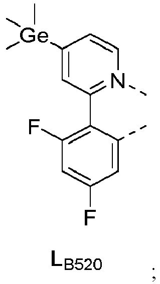 wherein each L_{*Cj*-I} has a structure based on formula 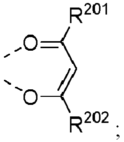 and
each L_{*Cj*-II} has a structure based on formula 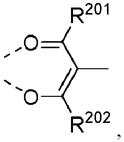 wherein for each L*_{Cj}* in L_{*Cj*-I} and L_{*Cj*-II}, R²⁰¹ and R²⁰² are each independently defined in the following LIST 10:

| **L*_{Cj}*** | **R²⁰¹** | **R²⁰²** | **L*_{Cj}*** | **R²⁰¹** | **R²⁰²** | **L*_{Cj}*** | **R²⁰¹** | **R²⁰²** | **L*_{Cj}*** | **R²⁰¹** | **R²⁰²** |
|---|---|---|---|---|---|---|---|---|---|---|---|
| L_{C1} | R^{D1} | R^{D1} | L_{C193} | R^{D1} | R^{D3} | L_{C385} | R^{D17} | R^{D40} | L_{C577} | R^{D143} | R^{D120} |
| L_{C2} | R^{D2} | R^{D2} | L_{C194} | R^{D1} | R^{D4} | L_{C386} | R^{D17} | R^{D41} | L_{C578} | R^{D143} | R^{D133} |
| L_{C3} | R^{D3} | R^{D3} | L_{C195} | R^{D1} | R^{D5} | L_{C387} | R^{D17} | R^{D42} | L_{C579} | R^{D143} | R^{D134} |
| L_{C4} | R^{D4} | R^{D4} | L_{C196} | R^{D1} | R^{D9} | L_{C388} | R^{D17} | R^{D43} | L_{C580} | R^{D143} | R^{D135} |
| L_{C5} | R^{D5} | R^{D5} | L_{C197} | R^{D1} | R^{D10} | L_{C389} | R^{D17} | R^{D48} | L_{C581} | R^{D143} | R^{D136} |
| L_{C6} | R^{D6} | R^{D6} | L_{C198} | R^{D1} | R^{D17} | L_{C390} | R^{D17} | R^{D49} | L_{C582} | R^{D143} | R^{D144} |
| L_{C7} | R^{D7} | R^{D7} | L_{C199} | R^{D1} | R^{D18} | L_{C391} | R^{D17} | R^{D50} | L_{C583} | R^{D143} | R^{D145} |
| L_{C8} | R^{D8} | R^{D8} | L_{C200} | R^{D1} | R^{D20} | L_{C392} | R^{D17} | R^{D54} | L_{C584} | R^{D143} | R^{D146} |
| L_{C9} | R^{D9} | R^{D9} | L_{C201} | R^{D1} | R^{D22} | L_{C393} | R^{D17} | R^{D55} | L_{C585} | R^{D143} | R^{D147} |
| L_{C10} | R^{D10} | R^{D10} | L_{C202} | R^{D1} | R^{D37} | L_{C394} | R^{D17} | R^{D58} | L_{C586} | R^{D143} | R^{D149} |
| L_{C11} | R^{D11} | R^{D11} | L_{C203} | R^{D1} | R^{D40} | L_{C395} | R^{D17} | R^{D59} | L_{C587} | R^{D143} | R^{D151} |
| L_{C12} | R^{D12} | R^{D12} | L_{C204} | R^{D1} | R^{D41} | L_{C396} | R^{D17} | R^{D78} | L_{C588} | R^{D143} | R^{D154} |
| L_{C13} | R^{D13} | R^{D13} | L_{C205} | R^{D1} | R^{D42} | L_{C397} | R^{D17} | R^{D79} | L_{C589} | R^{P143} | R^{D155} |
| L_{C14} | R^{D14} | R^{D14} | L_{C206} | R^{D1} | R^{D43} | L_{C398} | R^{D17} | R^{D81} | L_{C590} | R^{D143} | R^{D161} |
| L_{C15} | R^{D15} | R^{D15} | L_{C207} | R^{D1} | R^{D48} | L_{C399} | R^{P17} | R^{D87} | L_{C591} | R^{P143} | R^{P175} |
| L_{C16} | R^{D16} | R^{D16} | L_{C208} | R^{D1} | R^{D49} | L_{C400} | R^{D17} | R^{D88} | L_{C592} | R^{D144} | R^{D3} |
| L_{C17} | R^{D17} | R^{D17} | L_{C209} | R^{D1} | R^{D50} | L_{C401} | R^{D17} | R^{D89} | L_{C593} | R^{D144} | R^{D5} |
| L_{C18} | R^{D18} | R^{D18} | L_{C210} | R^{D1} | R^{D54} | L_{C402} | R^{D17} | R^{D93} | L_{C594} | R^{D144} | R^{D17} |
| L_{C19} | R^{D19} | R^{D19} | L_{C211} | R^{D1} | R^{D55} | L_{C403} | R^{D17} | R^{D116} | L_{C595} | R^{D144} | R^{D18} |
| L_{C20} | R^{D20} | R^{D20} | L_{C212} | R^{D1} | R^{D58} | L_{C404} | R^{D17} | R^{D117} | L_{C596} | R^{D144} | R^{D20} |
| L_{C21} | R^{D21} | R^{D21} | L_{C213} | R^{D1} | R^{D59} | L_{C405} | R^{P17} | R^{D118} | L_{C597} | R^{D144} | R^{D22} |
| L_{C22} | R^{D22} | R^{D22} | L_{C214} | R^{D1} | R^{D78} | L_{C406} | R^{D17} | R^{D119} | L_{C598} | R^{D144} | R^{D37} |
| L_{C23} | R^{D23} | R^{D23} | L_{C215} | R^{D1} | R^{D79} | L_{C407} | R^{D17} | R^{D120} | L_{C599} | R^{D144} | R^{D40} |
| L_{C24} | R^{D24} | R^{D24} | L_{C216} | R^{D1} | R^{D81} | L_{C408} | R^{D17} | R^{D133} | L_{C600} | R^{D144} | R^{D41} |
| L_{C25} | R^{D25} | R^{D25} | L_{C217} | R^{D1} | R^{D87} | L_{C409} | R^{D17} | R^{P134} | L_{C601} | R^{D144} | R^{P42} |
| L_{C26} | R^{D26} | R^{D26} | L_{C218} | R^{D1} | R^{D88} | L_{C410} | R^{D17} | R^{D135} | L_{C602} | R^{D144} | R^{D43} |
| L_{C27} | R^{D27} | R^{D27} | L_{C219} | R^{D1} | R^{D89} | L_{C411} | R^{D17} | R^{D136} | L_{C603} | R^{D144} | R^{D48} |
| L_{C28} | R^{D28} | R^{D28} | L_{C220} | R^{D1} | R^{D93} | L_{C412} | R^{D17} | R^{D143} | L_{C604} | R^{D144} | R^{D49} |
| L_{C29} | R^{D29} | R^{D29} | L_{C221} | R^{D1} | R^{D116} | L_{C413} | R^{D17} | R^{D144} | L_{C605} | R^{D144} | R^{D54} |
| L_{C30} | R^{D30} | R^{D30} | L_{C222} | R^{D1} | R^{D117} | L_{C414} | R^{D17} | R^{D145} | L_{C606} | R^{D144} | R^{D58} |
| L_{C31} | R^{D31} | R^{D31} | L_{C223} | R^{D1} | R^{D118} | L_{C415} | R^{D17} | R^{D146} | L_{C607} | R^{D144} | R^{D59} |
| L_{C32} | R^{D32} | R^{D32} | L_{C224} | R^{D1} | R^{D119} | L_{C416} | R^{D17} | R^{D147} | L_{C608} | R^{D144} | R^{D78} |
| L_{C33} | R^{D33} | R^{D33} | L_{C225} | R^{D1} | R^{D120} | L_{C417} | R^{D17} | R^{D149} | L_{C609} | R^{D144} | R^{D79} |
| L_{C34} | R^{D34} | R^{D34} | L_{C226} | R^{D1} | R^{D133} | L_{C418} | R^{D17} | R^{D151} | L_{C610} | R^{D144} | R^{D81} |
| L_{C35} | R^{D35} | R^{D35} | L_{C227} | R^{D1} | R^{D134} | L_{C419} | R^{D17} | R^{D154} | L_{C611} | R^{D144} | R^{D87} |
| L_{C36} | R^{D36} | R^{D36} | L_{C228} | R^{D1} | R^{D135} | L_{C420} | R^{D17} | R^{D155} | L_{C612} | R^{D144} | R^{D88} |
| L_{C37} | R^{D37} | R^{D37} | L_{C229} | R^{D1} | R^{D136} | L_{C421} | R^{D17} | R^{D161} | L_{C613} | R^{D144} | R^{D89} |
| L_{C38} | R^{D38} | R^{D38} | L_{C230} | R^{D1} | R^{P143} | L_{C422} | R^{D17} | R^{D175} | L_{C614} | R^{D144} | R^{D93} |
| L_{C39} | R^{D39} | R^{D39} | L_{C231} | R^{D1} | R^{D144} | L_{C423} | R^{D50} | R^{D3} | L_{C615} | R^{D144} | R^{D116} |
| L_{C40} | R^{D40} | R^{D40} | L_{C232} | R^{D1} | R^{P145} | L_{C424} | R^{D50} | R^{D5} | L_{C616} | R^{D144} | R^{D117} |
| L_{C41} | R^{D41} | R^{D41} | L_{C233} | R^{D1} | R^{D146} | L_{C425} | R^{D50} | R^{D18} | L_{C617} | R^{D144} | R^{D118} |
| L_{C42} | R^{D42} | R^{D42} | L_{C234} | R^{D1} | R^{D147} | L_{C426} | R^{D50} | R^{D20} | L_{C618} | R^{D144} | R^{D119} |
| L_{C43} | R^{D43} | R^{D43} | L_{C235} | R^{D1} | R^{P149} | L_{C427} | R^{D50} | R^{D22} | L_{C619} | R^{D144} | R^{D120} |
| L_{C44} | R^{D44} | R^{D44} | L_{C236} | R^{D1} | R^{D151} | L_{C428} | R^{D50} | R^{D37} | L_{C620} | R^{D144} | R^{D133} |
| L_{C45} | R^{D45} | R^{D45} | L_{C237} | R^{D1} | R^{D154} | L_{C429} | R^{D50} | R^{D40} | L_{C621} | R^{D144} | R^{D134} |
| L_{C46} | R^{D46} | R^{D46} | L_{C238} | R^{D1} | R^{D155} | L_{C430} | R^{D50} | R^{D41} | L_{C622} | R^{D144} | R^{D135} |
| L_{C47} | R^{D47} | R^{D47} | L_{C239} | R^{D1} | R^{D161} | L_{C431} | R^{D50} | R^{D42} | L_{C623} | R^{D144} | R^{D136} |
| L_{C48} | R^{D48} | R^{D48} | L_{C240} | R^{D1} | R^{D175} | L_{C432} | R^{D50} | R^{D43} | L_{C624} | R^{D144} | R^{P145} |
| L_{C49} | R^{D49} | R^{D49} | L_{C241} | R^{D4} | R^{D3} | L_{C433} | R^{D50} | R^{D48} | L_{C625} | R^{D144} | R^{D146} |
| L_{C50} | R^{D50} | R^{D50} | L_{C242} | R^{D4} | R^{D5} | L_{C434} | R^{D50} | R^{D49} | L_{C626} | R^{D144} | R^{D147} |
| L_{C51} | R^{D51} | R^{D51} | L_{C243} | R^{D4} | R^{D9} | L_{C435} | R^{D50} | R^{D54} | L_{C627} | R^{D144} | R^{D149} |
| L_{C52} | R^{D52} | R^{D52} | L_{C244} | R^{D4} | R^{D10} | L_{C436} | R^{D50} | R^{D55} | L_{C628} | R^{D144} | R^{D151} |
| L_{C53} | R^{D53} | R^{D53} | L_{C245} | R^{D4} | R^{D17} | L_{C437} | R^{D50} | R^{D58} | L_{C629} | R^{D144} | R^{D154} |
| L_{C54} | R^{D54} | R^{D54} | L_{C246} | R^{D4} | R^{D18} | L_{C438} | R^{D50} | R^{D59} | L_{C630} | R^{D144} | R^{D155} |
| L_{C55} | R^{D55} | R^{D55} | L_{C247} | R^{D4} | R^{D20} | L_{C439} | R^{D50} | R^{D78} | L_{C631} | R^{D144} | R^{D161} |
| L_{C56} | R^{D56} | R^{D56} | L_{C248} | R^{D4} | R^{D22} | L_{C440} | R^{D50} | R^{D79} | L_{C632} | R^{D144} | R^{D175} |
| L_{C57} | R^{D57} | R^{D57} | L_{C249} | R^{D4} | R^{D37} | L_{C441} | R^{D50} | R^{D81} | L_{C633} | R^{D145} | R^{D3} |
| L_{C58} | R^{D58} | R^{D58} | L_{C250} | R^{D4} | R^{D40} | L_{C442} | R^{D50} | R^{D87} | L_{C634} | R^{D145} | R^{D5} |
| L_{C59} | R^{D59} | R^{D59} | L_{C251} | R^{D4} | R^{D41} | L_{C443} | R^{D50} | R^{D88} | L_{C635} | R^{D145} | R^{D17} |
| L_{C60} | R^{D60} | R^{D60} | L_{C252} | R^{D4} | R^{D42} | L_{C444} | R^{D50} | R^{D89} | L_{C636} | R^{D145} | R^{D18} |
| L_{C61} | R^{D61} | R^{D61} | L_{C253} | R^{D4} | R^{D43} | L_{C445} | R^{D50} | R^{D93} | L_{C637} | R^{D145} | R^{D20} |
| L_{C62} | R^{D62} | R^{D62} | L_{C254} | R^{D4} | R^{D48} | L_{C446} | R^{D50} | R^{D116} | L_{C638} | R^{D145} | R^{D22} |
| L_{C63} | R^{D63} | R^{D63} | L_{C255} | R^{D4} | R^{D49} | L_{C447} | R^{D50} | R^{D117} | L_{C639} | R^{P145} | R^{D37} |
| L_{C64} | R^{D64} | R^{D64} | L_{C256} | R^{D4} | R^{D50} | L_{C448} | R^{D50} | R^{D118} | L_{C640} | R^{P145} | R^{D40} |
| L_{C65} | R^{D65} | R^{D65} | L_{C257} | R^{D4} | R^{P54} | L_{C449} | R^{D50} | R^{D119} | L_{C641} | R^{P145} | R^{D41} |
| L_{C66} | R^{D66} | R^{D66} | L_{C258} | R^{D4} | R^{D55} | L_{C450} | R^{D50} | R^{D120} | L_{C642} | R^{D145} | R^{D42} |
| L_{C67} | R^{D67} | R^{D67} | L_{C259} | R^{D4} | R^{D58} | L_{C451} | R^{D50} | R^{D133} | L_{C643} | R^{D145} | R^{D43} |
| L_{C68} | R^{D68} | R^{D68} | L_{C260} | R^{D4} | R^{D59} | L_{C452} | R^{D50} | R^{D134} | L_{C644} | R^{D145} | R^{D48} |
| L_{C69} | R^{D69} | R^{D69} | L_{C261} | R^{D4} | R^{D78} | L_{C453} | R^{D50} | R^{D135} | L_{C645} | R^{D145} | R^{D49} |
| L_{C70} | R^{D70} | R^{D70} | L_{C262} | R^{D4} | R^{D79} | L_{C454} | R^{D50} | R^{D136} | L_{C646} | R^{D145} | R^{D54} |
| L_{C71} | R^{D71} | R^{D71} | L_{C263} | R^{D4} | R^{D81} | L_{C455} | R^{D50} | R^{D143} | L_{C647} | R^{D145} | R^{D58} |
| L_{C72} | R^{D72} | R^{D72} | L_{C264} | R^{D4} | R^{D87} | L_{C456} | R^{D50} | R^{D144} | L_{C648} | R^{D145} | R^{D59} |
| L_{C73} | R^{D73} | R^{D73} | L_{C265} | R^{D4} | R^{D88} | L_{C457} | R^{D50} | R^{D145} | L_{C649} | R^{D145} | R^{D78} |
| L_{C74} | R^{D74} | R^{D74} | L_{C266} | R^{D4} | R^{D89} | L_{C458} | R^{D50} | R^{D146} | L_{C650} | R^{D145} | R^{D79} |
| L_{C75} | R^{D75} | R^{D75} | L_{C267} | R^{D4} | R^{D93} | L_{C459} | R^{D50} | R^{D147} | L_{C651} | R^{D145} | R^{D81} |
| L_{C76} | R^{D76} | R^{D76} | L_{C268} | R^{D4} | R^{D116} | L_{C460} | R^{D50} | R^{D149} | L_{C652} | R^{D145} | R^{D87} |
| L_{C77} | R^{D77} | R^{D77} | L_{C269} | R^{D4} | R^{D117} | L_{C461} | R^{D50} | R^{D151} | L_{C653} | R^{D145} | R^{D88} |
| L_{C78} | R^{D78} | R^{D78} | L_{C270} | R^{D4} | R^{D118} | L_{C462} | R^{D50} | R^{D154} | L_{C654} | R^{D145} | R^{D89} |
| L_{C79} | R^{D79} | R^{D79} | L_{C271} | R^{D4} | R^{D119} | L_{C463} | R^{D50} | R^{D155} | L_{C655} | R^{D145} | R^{D93} |
| L_{C80} | R^{D80} | R^{D80} | L_{C272} | R^{D4} | R^{D120} | L_{C464} | R^{D50} | R^{D161} | L_{C656} | R^{D145} | R^{D116} |
| L_{C81} | R^{D81} | R^{D81} | L_{C273} | R^{D4} | R^{D133} | L_{C465} | R^{D50} | R^{D175} | L_{C657} | R^{D145} | R^{D117} |
| L_{C82} | R^{D82} | R^{D82} | L_{C274} | R^{D4} | R^{D134} | L_{C466} | R^{D55} | R^{D3} | L_{C658} | R^{D145} | R^{D118} |
| L_{C83} | R^{D83} | R^{D83} | L_{C275} | R^{D4} | R^{D135} | L_{C467} | R^{D55} | R^{D5} | L_{C659} | R^{D145} | R^{D119} |
| L_{C84} | R^{D84} | R^{D84} | L_{C276} | R^{D4} | R^{D136} | L_{C468} | R^{D55} | R^{D18} | L_{C660} | R^{D145} | R^{D120} |
| L_{C85} | R^{D85} | R^{D85} | L_{C277} | R^{D4} | R^{D143} | L_{C469} | R^{D55} | R^{D20} | L_{C661} | R^{D145} | R^{D133} |
| L_{C86} | R^{D86} | R^{D86} | L_{C278} | R^{D4} | R^{D144} | L_{C470} | R^{D55} | R^{D22} | L_{C662} | R^{D145} | R^{D134} |
| L_{C87} | R^{D87} | R^{D87} | L_{C279} | R^{D4} | R^{D145} | L_{C471} | R^{D55} | R^{D37} | L_{C663} | R^{D145} | R^{D135} |
| L_{C88} | R^{D88} | R^{D88} | L_{C280} | R^{D4} | R^{D146} | L_{C472} | R^{D55} | R^{D40} | L_{C664} | R^{D145} | R^{D136} |
| L_{C89} | R^{D89} | R^{D89} | L_{C281} | R^{D4} | R^{D147} | L_{C473} | R^{D55} | R^{D41} | L_{C665} | R^{D145} | R^{D146} |
| L_{C90} | R^{D90} | R^{D90} | L_{C282} | R^{D4} | R^{D149} | L_{C474} | R^{D55} | R^{D42} | L_{C666} | R^{D145} | R^{D147} |
| L_{C91} | R^{D91} | R^{D91} | L_{C283} | R^{D4} | R^{D151} | L_{C475} | R^{D55} | R^{D43} | L_{C667} | R^{D145} | R^{D149} |
| L_{C92} | R^{D92} | R^{D92} | L_{C284} | R^{D4} | R^{D154} | L_{C476} | R^{D55} | R^{D48} | L_{C668} | R^{D145} | R^{D151} |
| L_{C93} | R^{D93} | R^{D93} | L_{C285} | R^{D4} | R^{D155} | L_{C477} | R^{D55} | R^{D49} | L_{C669} | R^{D145} | R^{D154} |
| L_{C94} | R^{D94} | R^{D94} | L_{C286} | R^{D4} | R^{D161} | L_{C478} | R^{D55} | R^{D54} | L_{C670} | R^{D145} | R^{D155} |
| L_{C95} | R^{D95} | R^{D95} | L_{C287} | R^{D4} | R^{D175} | L_{C479} | R^{D55} | R^{D58} | L_{C671} | R^{D145} | R^{D161} |
| L_{C96} | R^{D96} | R^{D96} | L_{C288} | R^{D9} | R^{D3} | L_{C480} | R^{D55} | R^{D59} | L_{C672} | R^{D145} | R^{D175} |
| L_{C97} | R^{D97} | R^{P97} | L_{C289} | R^{D9} | R^{D5} | L_{C481} | R^{D55} | R^{D78} | L_{C673} | R^{D146} | R^{D3} |
| L_{C98} | R^{D98} | R^{D98} | L_{C290} | R^{D9} | R^{D10} | L_{C482} | R^{D55} | R^{D79} | L_{C674} | R^{D146} | R^{D5} |
| L_{C99} | R^{D99} | R^{D99} | L_{C291} | R^{D9} | R^{D17} | L_{C483} | R^{D55} | R^{D81} | L_{C675} | R^{D146} | R^{D17} |
| L_{C100} | R^{D100} | R^{D100} | L_{C292} | R^{D9} | R^{D18} | L_{C484} | R^{D55} | R^{D87} | L_{C676} | R^{D146} | R^{D18} |
| L_{C101} | R^{D101} | R^{D101} | L_{C293} | R^{D9} | R^{D20} | L_{C485} | R^{D55} | R^{D88} | L_{C677} | R^{D146} | R^{D20} |
| L_{C102} | R^{D102} | R^{D102} | L_{C294} | R^{D9} | R^{D22} | L_{C486} | R^{D55} | R^{D89} | L_{C678} | R^{D146} | R^{D22} |
| L_{C103} | R^{D103} | R^{D103} | L_{C295} | R^{D9} | R^{D37} | L_{C487} | R^{D55} | R^{D93} | L_{C679} | R^{D146} | R^{D37} |
| L_{C104} | R^{D104} | R^{D104} | L_{C296} | R^{D9} | R^{D40} | L_{C488} | R^{D55} | R^{D116} | L_{C680} | R^{D146} | R^{D40} |
| L_{C105} | R^{D105} | R^{D105} | L_{C297} | R^{D9} | R^{D41} | L_{C489} | R^{D55} | R^{D117} | L_{C681} | R^{D146} | R^{D41} |
| L_{C106} | R^{D106} | R^{D106} | L_{C298} | R^{D9} | R^{D42} | L_{C490} | R^{D55} | R^{D118} | L_{C682} | R^{D146} | R^{D42} |
| L_{C107} | R^{D107} | R^{D107} | L_{C299} | R^{D9} | R^{D43} | L_{C491} | R^{D55} | R^{D119} | L_{C683} | R^{D146} | R^{D43} |
| L_{C108} | R^{D108} | R^{D108} | L_{C300} | R^{D9} | R^{D48} | L_{C492} | R^{D55} | R^{D120} | L_{C684} | R^{D146} | R^{D48} |
| L_{C109} | R^{D109} | R^{D109} | L_{C301} | R^{D9} | R^{D49} | L_{C493} | R^{D55} | R^{D133} | L_{C685} | R^{D146} | R^{D49} |
| L_{C110} | R^{D110} | R^{D110} | L_{C302} | R^{D9} | R^{D50} | L_{C494} | R^{D55} | R^{D134} | L_{C686} | R^{D146} | R^{D54} |
| L_{C111} | R^{D111} | R^{D111} | L_{C303} | R^{D9} | R^{D54} | L_{C495} | R^{D55} | R^{D135} | L_{C687} | R^{D146} | R^{D58} |
| L_{C112} | R^{D112} | R^{D112} | L_{C304} | R^{D9} | R^{D55} | L_{C496} | R^{D55} | R^{D136} | L_{C688} | R^{D146} | R^{D59} |
| L_{C113} | R^{D113} | R^{D113} | L_{C305} | R^{D9} | R^{D58} | L_{C497} | R^{D55} | R^{D143} | L_{C689} | R^{D146} | R^{D78} |
| L_{C114} | R^{D114} | R^{D114} | L_{C306} | R^{D9} | R^{D59} | L_{C498} | R^{D55} | R^{D144} | L_{C690} | R^{D146} | R^{D79} |
| L_{C115} | R^{D115} | R^{D115} | L_{C307} | R^{D9} | R^{D78} | L_{C499} | R^{D55} | R^{D145} | L_{C691} | R^{D146} | R^{D81} |
| L_{C116} | R^{D116} | R^{D116} | L_{C308} | R^{D9} | R^{D79} | L_{C500} | R^{D55} | R^{D146} | L_{C692} | R^{D146} | R^{P87} |
| L_{C117} | R^{D117} | R^{D117} | L_{C309} | R^{D9} | R^{D81} | L_{C501} | R^{D55} | R^{D147} | L_{C693} | R^{D146} | R^{D88} |
| L_{C118} | R^{D118} | R^{D118} | L_{C310} | R^{D9} | R^{D87} | L_{C502} | R^{D55} | R^{D149} | L_{C694} | R^{D146} | R^{D89} |
| L_{C119} | R^{D119} | R^{D119} | L_{C311} | R^{D9} | R^{D88} | L_{C503} | R^{D55} | R^{D151} | L_{C695} | R^{D146} | R^{D93} |
| L_{C120} | R^{D120} | R^{D120} | L_{C312} | R^{D9} | R^{D89} | L_{C504} | R^{D55} | R^{D154} | L_{C696} | R^{D146} | R^{D117} |
| L_{C121} | R^{D121} | R^{D121} | L_{C313} | R^{D9} | R^{D96} | L_{C505} | R^{D55} | R^{D155} | L_{C697} | R^{D146} | R^{D118} |
| L_{C122} | R^{D122} | R^{D122} | L_{C314} | R^{D9} | R^{D116} | L_{C506} | R^{D55} | R^{D161} | L_{C698} | R^{D146} | R^{D119} |
| L_{C123} | R^{D123} | R^{D123} | L_{C315} | R^{D9} | R^{D117} | L_{C507} | R^{D55} | R^{D175} | L_{C699} | R^{D146} | R^{D120} |
| L_{C124} | R^{D124} | R^{D124} | L_{C316} | R^{D9} | R^{D118} | L_{C508} | R^{D116} | R^{D3} | L_{C700} | R^{D146} | R^{D133} |
| L_{C125} | R^{D125} | R^{D125} | L_{C317} | R^{D9} | R^{D119} | L_{C509} | R^{D116} | R^{D5} | L_{C701} | R^{D146} | R^{D134} |
| L_{C126} | R^{D126} | R^{D126} | L_{C318} | R^{D9} | R^{D120} | L_{C510} | R^{D116} | R^{D17} | L_{C702} | R^{D146} | R^{D135} |
| L_{C127} | R^{D127} | R^{D127} | L_{C319} | R^{D9} | R^{D133} | L_{C511} | R^{D116} | R^{D18} | L_{C703} | R^{D146} | R^{D136} |
| L_{C128} | R^{D128} | R^{D128} | L_{C320} | R^{D9} | R^{D134} | L_{C512} | R^{D116} | R^{D20} | L_{C704} | R^{D146} | R^{D146} |
| L_{C129} | R^{D129} | R^{D129} | L_{C321} | R^{D9} | R^{D135} | L_{C513} | R^{D116} | R^{D22} | L_{C705} | R^{D146} | R^{D147} |
| L_{C130} | R^{D130} | R^{D130} | L_{C322} | R^{D9} | R^{D136} | L_{C514} | R^{D116} | R^{D37} | L_{C706} | R^{D146} | R^{D149} |
| L_{C131} | R^{D131} | R^{D131} | L_{C323} | R^{D9} | R^{D143} | L_{C515} | R^{D116} | R^{D40} | L_{C707} | R^{D146} | R^{D151} |
| L_{C132} | R^{D132} | R^{D132} | L_{C324} | R^{D9} | R^{D144} | L_{C516} | R^{D116} | R^{D41} | L_{C708} | R^{D146} | R^{D154} |
| L_{C133} | R^{D133} | R^{D133} | L_{C325} | R^{D9} | R^{D145} | L_{C517} | R^{D116} | R^{D42} | L_{C709} | R^{D146} | R^{D155} |
| L_{C134} | R^{D134} | R^{D134} | L_{C326} | R^{D9} | R^{D146} | L_{C518} | R^{D116} | R^{D43} | L_{C710} | R^{D146} | R^{D161} |
| L_{C135} | R^{D135} | R^{D135} | L_{C327} | R^{D9} | R^{D147} | L_{C519} | R^{D116} | R^{D48} | L_{C711} | R^{D146} | R^{D175} |
| L_{C136} | R^{D136} | R^{D136} | L_{C328} | R^{D9} | R^{D149} | L_{C520} | R^{D116} | R^{D49} | L_{C712} | R^{D133} | R^{D3} |
| L_{C137} | R^{D137} | R^{D137} | L_{C329} | R^{D9} | R^{D151} | L_{C521} | R^{D116} | R^{D54} | L_{C713} | R^{D133} | R^{D5} |
| L_{C138} | R^{D138} | R^{D138} | L_{C330} | R^{D9} | R^{D154} | L_{C522} | R^{D116} | R^{D58} | L_{C714} | R^{D133} | R^{D3} |
| L_{C139} | R^{D139} | R^{D139} | L_{C331} | R^{D9} | R^{D155} | L_{C523} | R^{D116} | R^{D59} | L_{C715} | R^{D133} | R^{D18} |
| L_{C140} | R^{D140} | R^{D140} | L_{C332} | R^{D9} | R^{D161} | L_{C524} | R^{D116} | R^{D78} | L_{C716} | R^{D133} | R^{D20} |
| L_{C141} | R^{D141} | R^{D141} | L_{C333} | R^{D9} | R^{D175} | L_{C525} | R^{D116} | R^{D79} | L_{C717} | R^{D133} | R^{D22} |
| L_{C142} | R^{D142} | R^{D142} | L_{C334} | R^{D10} | R^{D3} | L_{C526} | R^{D116} | R^{D81} | L_{C718} | R^{D133} | R^{D37} |
| L_{C143} | R^{D143} | R^{D143} | L_{C335} | R^{D10} | R^{D5} | L_{C527} | R^{D116} | R^{D87} | L_{C719} | R^{D133} | R^{D40} |
| L_{C144} | R^{D144} | R^{D144} | L_{C336} | R^{D10} | R^{D17} | L_{C528} | R^{D116} | R^{D88} | L_{C720} | R^{D133} | R^{D41} |
| L_{C145} | R^{D145} | R^{D145} | L_{C337} | R^{D10} | R^{D18} | L_{C529} | R^{D116} | R^{D89} | L_{C721} | R^{D133} | R^{D42} |
| L_{C146} | R^{D146} | R^{D146} | L_{C338} | R^{D10} | R^{D20} | L_{C530} | R^{D116} | R^{D93} | L_{C722} | R^{D133} | R^{D43} |
| L_{C147} | R^{D147} | R^{D147} | L_{C339} | R^{D10} | R^{D22} | L_{C531} | R^{D116} | R^{D117} | L_{C723} | R^{D133} | R^{D48} |
| L_{C148} | R^{D148} | R^{D148} | L_{C340} | R^{D10} | R^{D37} | L_{C532} | R^{D116} | R^{D118} | L_{C724} | R^{D133} | R^{D49} |
| L_{C149} | R^{D149} | R^{D149} | L_{C341} | R^{D10} | R^{D40} | L_{C533} | R^{D116} | R^{D119} | L_{C725} | R^{D133} | R^{D54} |
| L_{C150} | R^{D150} | R^{D150} | L_{C342} | R^{D10} | R^{D41} | L_{C534} | R^{D116} | R^{D120} | L_{C726} | R^{D133} | R^{D58} |
| L_{C151} | R^{D151} | R^{D151} | L_{C343} | R^{D10} | R^{D42} | L_{C535} | R^{D116} | R^{D133} | L_{C727} | R^{D133} | R^{D59} |
| L_{C152} | R^{D152} | R^{D152} | L_{C344} | R^{D10} | R^{D43} | L_{C536} | R^{D116} | R^{D134} | L_{C728} | R^{D133} | R^{D78} |
| L_{C153} | R^{D153} | R^{D153} | L_{C345} | R^{D10} | R^{D48} | L_{C537} | R^{D116} | R^{D135} | L_{C729} | R^{D133} | R^{D79} |
| L_{C154} | R^{D154} | R^{D154} | L_{C346} | R^{D10} | R^{D49} | L_{C538} | R^{D116} | R^{D136} | L_{C730} | R^{D133} | R^{D81} |
| L_{C155} | R^{D155} | R^{D155} | L_{C347} | R^{D10} | R^{D50} | L_{C539} | R^{D116} | R^{D143} | L_{C731} | R^{D133} | R^{D87} |
| L_{C156} | R^{D156} | R^{D156} | L_{C348} | R^{D10} | R^{D54} | L_{C540} | R^{D116} | R^{D144} | L_{C732} | R^{D133} | R^{D88} |
| L_{C157} | R^{D157} | R^{D157} | L_{C349} | R^{D10} | R^{D55} | L_{C541} | R^{D116} | R^{D145} | L_{C733} | R^{D133} | R^{D89} |
| L_{C158} | R^{D158} | R^{D158} | L_{C350} | R^{D10} | R^{D58} | L_{C542} | R^{D116} | R^{D146} | L_{C734} | R^{D133} | R^{D93} |
| L_{C159} | R^{D159} | R^{D159} | L_{C351} | R^{D10} | R^{D59} | L_{C543} | R^{D116} | R^{D147} | L_{C735} | R^{D133} | R^{D117} |
| L_{C160} | R^{D160} | R^{D160} | L_{C352} | R^{D10} | R^{D78} | L_{C544} | R^{D116} | R^{D149} | L_{C736} | R^{D133} | R^{D118} |
| L_{C161} | R^{D161} | R^{D161} | L_{C353} | R^{D10} | R^{D79} | L_{C545} | R^{D116} | R^{D151} | L_{C737} | R^{D133} | R^{D119} |
| L_{C162} | R^{D162} | R^{D162} | L_{C354} | R^{D10} | R^{D81} | L_{C546} | R^{D116} | R^{D154} | L_{C738} | R^{D133} | R^{D120} |
| L_{C163} | R^{D163} | R^{D163} | L_{C355} | R^{D10} | R^{D87} | L_{C547} | R^{D116} | R^{D155} | L_{C739} | R^{D133} | R^{D133} |
| L_{C164} | R^{D164} | R^{D164} | L_{C356} | R^{D10} | R^{D88} | L_{C548} | R^{D116} | R^{D161} | L_{C740} | R^{D133} | R^{D134} |
| L_{C165} | R^{D165} | R^{D165} | L_{C357} | R^{D10} | R^{D89} | L_{C549} | R^{D116} | R^{D175} | L_{C741} | R^{D133} | R^{D135} |
| L_{C166} | R^{D166} | R^{D166} | L_{C358} | R^{D10} | R^{D93} | L_{C550} | R^{D143} | R^{D3} | L_{C742} | R^{D133} | R^{D136} |
| L_{C167} | R^{D167} | R^{D167} | L_{C359} | R^{D10} | R^{D116} | L_{C551} | R^{D143} | R^{D5} | L_{C743} | R^{D133} | R^{D146} |
| L_{C168} | R^{D168} | R^{D168} | L_{C360} | R^{D10} | R^{D117} | L_{C552} | R^{D143} | R^{D17} | L_{C744} | R^{D133} | R^{D147} |
| L_{C169} | R^{D169} | R^{D169} | L_{C361} | R^{D10} | R^{D118} | L_{C553} | R^{D143} | R^{D18} | L_{C745} | R^{D133} | R^{D149} |
| L_{C170} | R^{D170} | R^{D170} | L_{C362} | R^{D10} | R^{D119} | L_{C554} | R^{D143} | R^{D20} | L_{C746} | R^{D133} | R^{D151} |
| L_{C171} | R^{D171} | R^{D171} | L_{C363} | R^{D10} | R^{D120} | L_{C555} | R^{D143} | R^{D22} | L_{C747} | R^{D133} | R^{D154} |
| L_{C172} | R^{D172} | R^{D172} | L_{C364} | R^{D10} | R^{D133} | L_{C556} | R^{D143} | R^{D37} | L_{C748} | R^{D133} | R^{D155} |
| L_{C173} | R^{D173} | R^{D173} | L_{C365} | R^{D10} | R^{D134} | L_{C557} | R^{D143} | R^{D40} | L_{C749} | R^{D133} | R^{D161} |
| L_{C174} | R^{D174} | R^{D174} | L_{C366} | R^{D10} | R^{D135} | L_{C558} | R^{D143} | R^{D41} | L_{C750} | R^{D133} | RD¹⁷⁵ |
| L_{C175} | RD¹⁷⁵ | RD¹⁷⁵ | L_{C367} | R^{D10} | R^{D136} | L_{C559} | R^{D143} | R^{D42} | L_{C751} | RD¹⁷⁵ | R^{D3} |
| L_{C176} | R^{D176} | R^{D176} | L_{C368} | R^{D10} | R^{D143} | L_{C560} | R^{D143} | R^{D43} | L_{C752} | RD¹⁷⁵ | R^{D5} |
| L_{C177} | R^{D177} | R^{D177} | L_{C369} | R^{D10} | R^{D144} | L_{C561} | R^{D143} | R^{D48} | L_{C753} | RD¹⁷⁵ | R^{D18} |
| L_{C178} | R^{D178} | R^{D178} | L_{C370} | R^{D10} | R^{D145} | L_{C562} | R^{D143} | R^{D49} | L_{C754} | RD¹⁷⁵ | R^{D20} |
| L_{C179} | R^{D179} | R^{D179} | L_{C371} | R^{D10} | R^{D146} | L_{C563} | R^{D143} | R^{D54} | L_{C755} | RD¹⁷⁵ | R^{D22} |
| L_{C180} | R^{D180} | R^{D180} | L_{C372} | R^{D10} | R^{D147} | L_{C564} | R^{D143} | R^{D58} | L_{C756} | RD¹⁷⁵ | R^{D37} |
| L_{C181} | R^{D181} | R^{D181} | L_{C373} | R^{D10} | R^{D149} | L_{C565} | R^{D143} | R^{D59} | L_{C757} | RD¹⁷⁵ | R^{D40} |
| L_{C182} | R^{D182} | R^{D182} | L_{C374} | R^{D10} | R^{D151} | L_{C566} | R^{D143} | R^{D78} | L_{C758} | RD¹⁷⁵ | R^{D41} |
| L_{C183} | R^{D183} | R^{D183} | L_{C375} | R^{D10} | R^{D154} | L_{C567} | R^{D143} | R^{D79} | L_{C759} | RD¹⁷⁵ | R^{D42} |
| L_{C184} | R^{D184} | R^{D184} | L_{C376} | R^{D10} | R^{D155} | L_{C568} | R^{D143} | R^{D81} | L_{C760} | R^{D175} | R^{D43} |
| L_{C185} | R^{D185} | R^{D185} | L_{C377} | R^{D10} | R^{D161} | L_{C569} | R^{D143} | R^{D87} | L_{C761} | RD¹⁷⁵ | R^{D48} |
| L_{C186} | R^{D186} | R^{D186} | L_{C378} | R^{D10} | RD¹⁷⁵ | L_{C570} | R^{D143} | R^{D88} | L_{C762} | RD¹⁷⁵ | R^{D49} |
| L_{C187} | R^{D187} | R^{D187} | L_{C379} | R^{D17} | R^{D3} | L_{C571} | R^{D143} | R^{D89} | L_{C763} | RD¹⁷⁵ | R^{D54} |
| L_{C188} | R^{D188} | R^{D188} | L_{C380} | R^{D17} | R^{D5} | L_{C572} | R^{D143} | R^{D93} | L_{C764} | RD¹⁷⁵ | R^{D58} |
| L_{C189} | R^{D189} | R^{D189} | L_{C381} | R^{D17} | R^{D18} | L_{C573} | R^{D143} | R^{D116} | L_{C765} | RD¹⁷⁵ | R^{D59} |
| L_{C190} | R^{D190} | R^{D190} | L_{C382} | R^{D17} | R^{D20} | L_{C574} | R^{D143} | R^{D117} | L_{C766} | RD¹⁷⁵ | R^{D78} |
| L_{C191} | R^{D191} | R^{D191} | L_{C383} | R^{D17} | R^{D22} | L_{C575} | R^{D143} | R^{D118} | L_{C767} | RD¹⁷⁵ | R^{D79} |
| L_{C192} | R^{D192} | R^{D192} | L_{C384} | R^{D17} | R^{D37} | L_{C576} | R^{D143} | R^{D119} | L_{C768} | RD¹⁷⁵ | R^{D81} |
| L_{C769} | R^{D193} | R^{D193} | L_{C877} | R^{D1} | R^{D193} | L_{C985} | R^{D4} | R^{D193} | L_{C1093} | R^{D9} | R^{D193} |
| L_{C770} | R^{D194} | R^{D194} | L_{C878} | R^{D1} | R^{D194} | L_{C986} | R^{D4} | R^{D194} | L_{C1094} | R^{D9} | R^{D194} |
| L_{C771} | R^{D195} | R^{D195} | L_{C879} | R^{D1} | R^{D195} | L_{C987} | R^{D4} | R^{D195} | L_{C1095} | R^{D9} | R^{D195} |
| L_{C772} | R^{D196} | R^{D196} | L_{C880} | R^{D1} | R^{D196} | L_{C988} | R^{D4} | R^{D196} | L_{C1096} | R^{D9} | R^{D196} |
| L_{C773} | R^{D197} | R^{D197} | L_{C881} | R^{D1} | R^{D197} | L_{C989} | R^{D4} | R^{D197} | L_{C1097} | R^{D9} | R^{D197} |
| L_{C774} | R^{D198} | R^{D198} | L_{C882} | R^{D1} | R^{D198} | L_{C990} | R^{D4} | R^{D198} | L_{C1098} | R^{D9} | R^{D198} |
| L_{C775} | R^{D199} | R^{D199} | L_{C883} | R^{D1} | R^{D199} | L_{C991} | R^{D4} | R^{D199} | L_{C1099} | R^{D9} | R^{D199} |
| L_{C776} | R^{D200} | R^{D200} | L_{C884} | R^{D1} | R^{D200} | L_{C992} | R^{D4} | R^{D200} | L_{C1100} | R^{D9} | R^{D200} |
| L_{C777} | R^{D201} | R^{D201} | L_{C885} | R^{D1} | R^{D201} | L_{C993} | R^{D4} | R^{D201} | L_{C1101} | R^{D9} | R^{D201} |
| L_{C778} | R^{D202} | R^{D202} | L_{C886} | R^{D1} | R^{D202} | L_{C994} | R^{D4} | R^{D202} | L_{C1102} | R^{D9} | R^{D202} |
| L_{C779} | R^{D203} | R^{D203} | L_{C887} | R^{D1} | R^{D203} | L_{C995} | R^{D4} | R^{D203} | L_{C1103} | R^{D9} | R^{D203} |
| L_{C780} | R^{D204} | R^{D204} | L_{C888} | R^{D1} | R^{D204} | L_{C996} | R^{D4} | R^{D204} | L_{C1104} | R^{D9} | R^{D204} |
| L_{C781} | R^{D205} | R^{D205} | L_{C889} | R^{D1} | R^{D205} | L_{C997} | R^{D4} | R^{D205} | L_{C1105} | R^{D9} | R^{D205} |
| L_{C782} | R^{D206} | R^{D206} | L_{C890} | R^{D1} | R^{D206} | L_{C998} | R^{D4} | R^{D206} | L_{C1106} | R^{D9} | R^{D206} |
| L_{C783} | R^{D207} | R^{D207} | L_{C891} | R^{D1} | R^{D207} | L_{C999} | R^{D4} | R^{D207} | L_{C1107} | R^{D9} | R^{D207} |
| L_{C784} | R^{D208} | R^{D208} | L_{C892} | R^{D1} | R^{D208} | L_{C1000} | R^{D4} | R^{D208} | L_{C1108} | R^{D9} | R^{D208} |
| L_{C785} | R^{D209} | R^{D209} | L_{C893} | R^{D1} | R^{D209} | L_{C1001} | R^{D4} | R^{D209} | L_{C1109} | R^{D9} | R^{D209} |
| L_{C786} | R^{D210} | R^{D210} | L_{C894} | R^{D1} | R^{D210} | L_{C1002} | R^{D4} | R^{D210} | L_{C1110} | R^{D9} | R^{D210} |
| L_{C787} | R^{D211} | R^{D211} | L_{C895} | R^{D1} | R^{D211} | L_{C1003} | R^{D4} | R^{D211} | L_{C1111} | R^{D9} | R^{D211} |
| L_{C788} | R^{D212} | R^{D212} | L_{C896} | R^{D1} | R^{D212} | L_{C1004} | R^{D4} | R^{D212} | L_{C1112} | R^{D9} | R^{D212} |
| L_{C789} | R^{D213} | R^{D213} | L_{C897} | R^{D1} | R^{D213} | L_{C1005} | R^{D4} | R^{D213} | L_{C1113} | R^{D9} | R^{D213} |
| L_{C790} | R^{D214} | R^{D214} | L_{C898} | R^{D1} | R^{D214} | Lc₁₀₀₆ | R^{D4} | R^{D214} | L_{C1114} | R^{D9} | R^{D214} |
| L_{C791} | R^{D215} | R^{D215} | L_{C899} | R^{D1} | R^{D215} | L_{C1007} | R^{D4} | R^{D215} | L_{C1115} | R^{D9} | R^{D215} |
| L_{C792} | R^{D216} | R^{D216} | L_{C900} | R^{D1} | R^{D216} | L_{C1008} | R^{D4} | R^{D216} | L_{C1116} | R^{D9} | R^{D216} |
| L_{C793} | R^{D217} | R^{D217} | L_{C901} | R^{D1} | R^{D217} | L_{C1009} | R^{D4} | R^{D217} | L_{C1117} | R^{D9} | R^{D217} |
| L_{C794} | R^{D218} | R^{D218} | L_{C902} | R^{D1} | R^{D218} | L_{C1010} | R^{D4} | R^{D218} | L_{C1118} | R^{D9} | R^{D218} |
| L_{C795} | R^{D219} | R^{D219} | L_{C903} | R^{D1} | R^{D219} | L_{C1011} | R^{D4} | R^{D219} | L_{C1119} | R^{D9} | R^{D219} |
| L_{C796} | R^{D220} | R^{D220} | L_{C904} | R^{D1} | R^{D220} | L_{C1012} | R^{D4} | R^{D220} | L_{C1120} | R^{D9} | R^{D220} |
| L_{C797} | R^{D221} | R^{D221} | L_{C905} | R^{D1} | R^{D221} | L_{C1013} | R^{D4} | R^{D221} | L_{C1121} | R^{D9} | R^{D221} |
| L_{C798} | R^{D222} | R^{D222} | L_{C906} | R^{D1} | R^{D222} | L_{C1014} | R^{D4} | R^{D222} | L_{C1122} | R^{D9} | R^{D222} |
| L_{C799} | R^{D223} | R^{D223} | L_{C907} | R^{D1} | R^{D223} | L_{C1015} | R^{D4} | R^{D223} | L_{C1123} | R^{D9} | R^{D223} |
| L_{C800} | R^{D224} | R^{D224} | L_{C908} | R^{D1} | R^{D224} | L_{C1016} | R^{D4} | R^{D224} | L_{C1124} | R^{D9} | R^{D224} |
| L_{C801} | R^{D225} | R^{D225} | L_{C909} | R^{D1} | R^{D225} | L_{C1017} | R^{D4} | R^{D225} | L_{C1125} | R^{D9} | R^{D225} |
| L_{C802} | R^{D226} | R^{D226} | L_{C910} | R^{D1} | R^{D226} | L_{C1018} | R^{D4} | R^{D226} | L_{C1126} | R^{D9} | R^{D226} |
| L_{C803} | R^{D227} | R^{D227} | L_{C911} | R^{D1} | R^{D227} | L_{C1019} | R^{D4} | R^{D227} | L_{C1127} | R^{D9} | R^{D227} |
| L_{C804} | R^{D228} | R^{D228} | L_{C912} | R^{D1} | R^{D228} | L_{C1020} | R^{D4} | R^{D228} | L_{C1128} | R^{D9} | R^{D228} |
| L_{C805} | R^{D229} | R^{D229} | L_{C913} | R^{D1} | R^{D229} | L_{C1021} | R^{D4} | R^{D229} | L_{C1129} | R^{D9} | R^{D229} |
| L_{C806} | R^{D230} | R^{D230} | L_{C914} | R^{D1} | R^{D230} | L_{C1022} | R^{D4} | R^{D230} | L_{C1130} | R^{D9} | R^{D230} |
| L_{C807} | R^{D231} | R^{D231} | L_{C915} | R^{D1} | R^{D231} | L_{C1023} | R^{D4} | R^{D231} | L_{C1131} | R^{D9} | R^{D231} |
| L_{C808} | R^{D232} | R^{D232} | L_{C916} | R^{D1} | R^{D232} | L_{C1024} | R^{D4} | R^{D232} | L_{C1132} | R^{D9} | R^{D232} |
| L_{C809} | R^{D233} | R^{D233} | L_{C917} | R^{D1} | R^{D233} | L_{C1025} | R^{D4} | R^{D233} | L_{C1133} | R^{D9} | R^{D233} |
| L_{C810} | R^{D234} | R^{D234} | L_{C918} | R^{D1} | R^{D234} | L_{C1026} | R^{D4} | R^{D234} | L_{C1134} | R^{D9} | R^{D234} |
| L_{C811} | R^{D235} | R^{D235} | L_{C919} | R^{D1} | R^{D235} | L_{C1027} | R^{D4} | R^{D235} | L_{C1135} | R^{D9} | R^{D235} |
| L_{C812} | R^{D236} | R^{D236} | L_{C920} | R^{D1} | R^{D236} | L_{C1028} | R^{D4} | R^{D236} | L_{C1136} | R^{D9} | R^{D236} |
| L_{C813} | R^{D237} | R^{D237} | L_{C921} | R^{D1} | R^{D237} | L_{C1029} | R^{D4} | R^{D237} | L_{C1137} | R^{D9} | R^{D237} |
| L_{C814} | R^{D238} | R^{D238} | L_{C922} | R^{D1} | R^{D238} | L_{C1030} | R^{D4} | R^{D238} | L_{C1138} | R^{D9} | R^{D238} |
| L_{C815} | R^{D239} | R^{D239} | L_{C923} | R^{D1} | R^{D239} | L_{C1031} | R^{D4} | R^{D239} | L_{C1139} | R^{D9} | R^{D239} |
| L_{C816} | R^{D240} | R^{D240} | L_{C924} | R^{D1} | R^{D240} | L_{C1032} | R^{D4} | R^{D240} | L_{C1140} | R^{D9} | R^{D240} |
| L_{C817} | R^{D241} | R^{D241} | L_{C925} | R^{D1} | R^{D241} | L_{C1033} | R^{D4} | R^{D241} | L_{C1141} | R^{D9} | R^{D241} |
| L_{C818} | R^{D242} | R^{D242} | L_{C926} | R^{D1} | R^{D242} | L_{C1034} | R^{D4} | R^{D242} | L_{C1142} | R^{D9} | R^{D242} |
| L_{C819} | R^{D243} | R^{D243} | L_{C927} | R^{D1} | R^{D243} | L_{C1035} | R^{D4} | R^{D243} | L_{C1143} | R^{D9} | R^{D243} |
| L_{C820} | R^{D244} | R^{D244} | L_{C928} | R^{D1} | R^{D244} | L_{C1036} | R^{D4} | R^{D244} | L_{C1144} | R^{D9} | R^{D244} |
| L_{C821} | R^{D245} | R^{D245} | L_{C929} | R^{D1} | R^{D245} | L_{C1037} | R^{D4} | R^{D245} | L_{C1145} | R^{D9} | R^{D245} |
| L_{C822} | R^{D246} | R^{D246} | L_{C930} | R^{D1} | R^{D246} | L_{C1038} | R^{D4} | R^{D246} | L_{C1146} | R^{D9} | R^{D246} |
| L_{C823} | R^{D17} | R^{D193} | L_{C931} | R^{D50} | R^{D193} | L_{C1039} | R^{D145} | R^{D193} | L_{C1147} | R^{D168} | R^{D193} |
| L_{C824} | R^{D17} | R^{D194} | L_{C932} | R^{D50} | R^{D194} | L_{C1040} | R^{D145} | R^{D194} | L_{C1148} | R^{D168} | R^{D194} |
| L_{C825} | R^{D17} | R^{D195} | L_{C933} | R^{D50} | R^{D195} | L_{C1041} | R^{D145} | R^{D195} | L_{C1149} | R^{D168} | R^{D195} |
| L_{C826} | R^{D17} | R^{D196} | L_{C934} | R^{D50} | R^{D196} | L_{C1042} | R^{D145} | R^{D196} | L_{C1150} | R^{D168} | R^{D196} |
| L_{C827} | R^{D17} | R^{D197} | L_{C935} | R^{D50} | R^{D197} | L_{C1043} | R^{D145} | R^{D197} | L_{C1151} | R^{D168} | R^{D197} |
| L_{C828} | R^{D17} | R^{D198} | L_{C936} | R^{D50} | R^{D198} | L_{C1044} | R^{D145} | R^{D198} | L_{C1152} | R^{D168} | R^{D198} |
| L_{C829} | R^{D17} | R^{D199} | L_{C937} | R^{D50} | R^{D199} | L_{C1045} | R^{D145} | R^{D199} | L_{C1153} | R^{D168} | R^{D199} |
| L_{C830} | R^{D17} | R^{D200} | L_{C938} | R^{D50} | R^{D200} | L_{C1046} | R^{D145} | R^{D200} | L_{C1154} | R^{D168} | R^{D200} |
| L_{C831} | R^{D17} | R^{D201} | L_{C939} | R^{D50} | R^{D201} | L_{C1047} | R^{D145} | R^{D201} | L_{C1155} | R^{D168} | R^{D201} |
| L_{C832} | R^{D17} | R^{D202} | L_{C940} | R^{D50} | R^{D202} | L_{C1048} | R^{D145} | R^{D202} | L_{C1156} | R^{D168} | R^{D202} |
| L_{C833} | R^{D17} | R^{D203} | L_{C941} | R^{D50} | R^{D203} | L_{C1049} | R^{D145} | R^{D203} | L_{C1157} | R^{D168} | R^{D203} |
| L_{C834} | R^{D17} | R^{D204} | L_{C942} | R^{D50} | R^{D204} | L_{C1050} | R^{D145} | R^{D204} | L_{C1158} | R^{D168} | R^{D204} |
| L_{C835} | R^{D17} | R^{D205} | L_{C943} | R^{D50} | R^{D205} | L_{C1051} | R^{D145} | R^{D205} | L_{C1159} | R^{D168} | R^{D205} |
| L_{C836} | R^{D17} | R^{D206} | L_{C944} | R^{D50} | R^{D206} | L_{C1052} | R^{D145} | R^{D206} | L_{C1160} | R^{D168} | R^{D206} |
| L_{C837} | R^{D17} | R^{D207} | L_{C945} | R^{D50} | R^{D207} | L_{C1053} | R^{D145} | R^{D207} | L_{C1161} | R^{D168} | R^{D207} |
| L_{C838} | R^{D17} | R^{D208} | L_{C946} | R^{D50} | R^{D208} | L_{C1054} | R^{D145} | R^{D208} | L_{C1162} | R^{D168} | R^{D208} |
| L_{C839} | R^{D17} | R^{D209} | L_{C947} | R^{D50} | R^{D209} | L_{C1055} | R^{D145} | R^{D209} | L_{C1163} | R^{D168} | R^{D209} |
| L_{C840} | R^{D17} | R^{D210} | L_{C948} | R^{D50} | R^{D210} | L_{C1056} | R^{D145} | R^{D210} | L_{C1164} | R^{D168} | R^{D210} |
| L_{C841} | R^{D17} | R^{D211} | L_{C949} | R^{D50} | R^{D211} | L_{C1057} | R^{D145} | R^{D211} | L_{C1165} | R^{D168} | R^{D211} |
| L_{C842} | R^{D17} | R^{D212} | L_{C950} | R^{D50} | R^{D212} | L_{C1058} | R^{D145} | R^{D212} | L_{C1166} | R^{D168} | R^{D212} |
| L_{C843} | R^{D17} | R^{D213} | L_{C951} | R^{D50} | R^{D213} | L_{C1059} | R^{D145} | R^{D213} | L_{C1167} | R^{D168} | R^{D213} |
| L_{C844} | R^{D17} | R^{D214} | L_{C952} | R^{D50} | R^{D214} | L_{C1060} | R^{D145} | R^{D214} | L_{C1168} | R^{D168} | R^{D214} |
| L_{C845} | R^{D17} | R^{D215} | L_{C953} | R^{D50} | R^{D215} | L_{C1061} | R^{D145} | R^{D215} | L_{C1169} | R^{D168} | R^{D215} |
| L_{C846} | R^{D17} | R^{D216} | L_{C954} | R^{D50} | R^{D216} | L_{C1062} | R^{D145} | R^{D216} | L_{C1170} | R^{D168} | R^{D216} |
| L_{C847} | R^{D17} | R^{D217} | L_{C955} | R^{D50} | R^{D217} | L_{C1063} | R^{D145} | R^{D217} | L_{C1171} | R^{D168} | R^{D217} |
| L_{C848} | R^{D17} | R^{D218} | L_{C956} | R^{D50} | R^{D218} | L_{C1064} | R^{D145} | R^{D218} | L_{C1172} | R^{D168} | R^{D218} |
| L_{C849} | R^{D17} | R^{D219} | L_{C957} | R^{D50} | R^{D219} | L_{C1065} | R^{D145} | R^{D219} | L_{C1173} | R^{D168} | R^{D219} |
| L_{C850} | R^{D17} | R^{D220} | L_{C958} | R^{D50} | R^{D220} | L_{C1066} | R^{D145} | R^{D220} | L_{C1174} | R^{D168} | R^{D220} |
| L_{C851} | R^{D17} | R^{D221} | L_{C959} | R^{D50} | R^{D221} | L_{C1067} | R^{D145} | R^{D221} | L_{C1175} | R^{D168} | R^{D221} |
| L_{C852} | R^{D17} | R^{D222} | L_{C960} | R^{D50} | R^{D222} | L_{C1068} | R^{D145} | R^{D222} | L_{C1176} | R^{D168} | R^{D222} |
| L_{C853} | R^{D17} | R^{D223} | L_{C961} | R^{D50} | R^{D223} | L_{C1069} | R^{D145} | R^{D223} | L_{C1177} | R^{D168} | R^{D223} |
| L_{C854} | R^{D17} | R^{D224} | L_{C962} | R^{D50} | R^{D224} | L_{C1070} | R^{D145} | R^{D224} | L_{C1178} | R^{D168} | R^{D224} |
| L_{C855} | R^{D17} | R^{D225} | L_{C963} | R^{D50} | R^{D225} | L_{C1071} | R^{D145} | R^{D225} | L_{C1179} | R^{D168} | R^{D225} |
| L_{C856} | R^{D17} | R^{D226} | L_{C964} | R^{D50} | R^{D226} | L_{C1072} | R^{D145} | R^{D226} | L_{C1180} | R^{D168} | R^{D226} |
| L_{C857} | R^{D17} | R^{D227} | L_{C965} | R^{D50} | R^{D227} | L_{C1073} | R^{D145} | R^{D227} | L_{C1181} | R^{D168} | R^{D227} |
| L_{C858} | R^{D17} | R^{D228} | L_{C966} | R^{D50} | R^{D228} | L_{C1074} | R^{D145} | R^{D228} | L_{C1182} | R^{D168} | R^{D228} |
| L_{C859} | R^{D17} | R^{D229} | L_{C967} | R^{D50} | R^{D229} | L_{C1075} | R^{D145} | R^{D229} | L_{C1183} | R^{D168} | R^{D229} |
| L_{C860} | R^{D17} | R^{D230} | L_{C968} | R^{D50} | R^{D230} | L_{C1076} | R^{D145} | R^{D230} | L_{C1184} | R^{D168} | R^{D230} |
| L_{C861} | R^{D17} | R^{D231} | L_{C969} | R^{D50} | R^{D231} | L_{C1077} | R^{D145} | R^{D231} | L_{C1185} | R^{D168} | R^{D231} |
| L_{C862} | R^{D17} | R^{D232} | L_{C970} | R^{D50} | R^{D232} | L_{C1078} | R^{D145} | R^{D232} | L_{C1186} | R^{D168} | R^{D232} |
| L_{C863} | R^{D17} | R^{D233} | L_{C971} | R^{D50} | R^{D233} | L_{C1079} | R^{D145} | R^{D233} | L_{C1187} | R^{D168} | R^{D233} |
| L_{C864} | R^{D17} | R^{D234} | L_{C972} | R^{D50} | R^{D234} | L_{C1080} | R^{D145} | R^{D234} | L_{C1188} | R^{D168} | R^{D234} |
| L_{C865} | R^{D17} | R^{D235} | L_{C973} | R^{D50} | R^{D235} | L_{C1081} | R^{D145} | R^{D235} | L_{C1189} | R^{D168} | R^{D235} |
| L_{C866} | R^{D17} | R^{D236} | L_{C974} | R^{D50} | R^{D236} | L_{C1082} | R^{D145} | R^{D236} | L_{C1190} | R^{D168} | R^{D236} |
| L_{C867} | R^{D17} | R^{D237} | L_{C975} | R^{D50} | R^{D237} | L_{C1083} | R^{D145} | R^{D237} | L_{C1191} | R^{D168} | R^{D237} |
| L_{C868} | R^{D17} | R^{D238} | L_{C976} | R^{D50} | R^{D238} | L_{C1084} | R^{D145} | R^{D238} | L_{C1192} | R^{D168} | R^{D238} |
| L_{C869} | R^{D17} | R^{D239} | L_{C977} | R^{D50} | R^{D239} | L_{C1085} | R^{D145} | R^{D239} | L_{C1193} | R^{D168} | R^{D239} |
| L_{C870} | R^{D17} | R^{D240} | L_{C978} | R^{D50} | R^{D240} | L_{C1086} | R^{D145} | R^{D240} | L_{C1194} | R^{D168} | R^{D240} |
| L_{C871} | R^{D17} | R^{D241} | L_{C979} | R^{D50} | R^{D241} | L_{C1087} | R^{D145} | R^{D241} | L_{C1195} | R^{D168} | R^{D241} |
| L_{C872} | R^{D17} | R^{D242} | L_{C980} | R^{D50} | R^{D242} | L_{C1088} | R^{D145} | R^{D242} | L_{C1196} | R^{D168} | R^{D242} |
| L_{C873} | R^{D17} | R^{D243} | L_{C981} | R^{D50} | R^{D243} | L_{C1089} | R^{D145} | R^{D243} | L_{C1197} | R^{D168} | R^{D243} |
| L_{C874} | R^{D17} | R^{D244} | L_{C982} | R^{D50} | R^{D244} | L_{C1090} | R^{D145} | R^{D244} | L_{C1198} | R^{D168} | R^{D244} |
| L_{C875} | R^{D17} | R^{D245} | L_{C983} | R^{D50} | R^{D245} | L_{C1091} | R^{D145} | R^{D245} | L_{C1199} | R^{D168} | R^{D245} |
| L_{C876} | R^{D17} | R^{D246} | L_{C984} | R^{D50} | R^{D246} | L_{C1092} | R^{D145} | R^{D246} | L_{C1200} | R^{D168} | R^{D246} |
| L_{C1201} | R^{D10} | R^{D193} | L_{C1255} | R^{D55} | R^{D193} | L_{C1309} | R^{D37} | R^{D193} | L_{C1363} | R^{D143} | R^{D193} |
| L_{C1202} | R^{D10} | R^{D194} | L_{C1256} | R^{D55} | R^{D194} | L_{C1310} | R^{D37} | R^{D194} | L_{C1364} | R^{D143} | R^{D194} |
| L_{C1203} | R^{D10} | R^{D195} | L_{C1257} | R^{D55} | R^{D195} | L_{C1311} | R^{D37} | R^{D195} | L_{C1365} | R^{D143} | R^{D195} |
| L_{C1204} | R^{D10} | R^{D196} | L_{C1258} | R^{D55} | R^{D196} | L_{C1312} | R^{D37} | R^{D196} | L_{C1366} | R^{D143} | R^{D196} |
| L_{C1205} | R^{D10} | R^{D197} | L_{C1259} | R^{D55} | R^{D197} | L_{C1313} | R^{D37} | R^{D197} | L_{C1367} | R^{D143} | R^{D197} |
| L_{C1206} | R^{D10} | R^{D198} | L_{C1260} | R^{D55} | R^{D198} | L_{C1314} | R^{D37} | R^{D198} | L_{C1368} | R^{D143} | R^{D198} |
| L_{C1207} | R^{D10} | R^{D199} | L_{C1261} | R^{D55} | R^{D199} | L_{C1315} | R^{D37} | R^{D199} | L_{C1369} | R^{D143} | R^{D199} |
| L_{C1208} | R^{D10} | R^{D200} | L_{C1262} | R^{D55} | R^{D200} | L_{C1316} | R^{D37} | R^{D200} | L_{C1370} | R^{D143} | R^{D200} |
| L_{C1209} | R^{D10} | R^{D201} | L_{C1263} | R^{D55} | R^{D201} | L_{C1317} | R^{D37} | R^{D201} | L_{C1371} | R^{D143} | R^{D201} |
| L_{C1210} | R^{D10} | R^{D202} | L_{C1264} | R^{D55} | R^{D202} | L_{C1318} | R^{D37} | R^{D202} | L_{C1372} | R^{D143} | R^{D202} |
| L_{C1211} | R^{D10} | R^{D203} | L_{C1265} | R^{D55} | R^{D203} | L_{C1319} | R^{D37} | R^{D203} | L_{C1373} | R^{D143} | R^{D203} |
| L_{C1212} | R^{D10} | R^{D204} | L_{C1266} | R^{D55} | R^{D204} | L_{C1320} | R^{D37} | R^{D204} | L_{C1374} | R^{D143} | R^{D204} |
| L_{C1213} | R^{D10} | R^{D205} | L_{C1267} | R^{D55} | R^{D205} | L_{C1321} | R^{D37} | R^{D205} | L_{C1375} | R^{D143} | R^{D205} |
| L_{C1214} | R^{D10} | R^{D206} | L_{C1268} | R^{D55} | R^{D206} | L_{C1322} | R^{D37} | R^{D206} | L_{C1376} | R^{D143} | R^{D206} |
| L_{C1215} | R^{D10} | R^{D207} | L_{C1269} | R^{D55} | R^{D207} | L_{C1323} | R^{D37} | R^{D207} | L_{C1377} | R^{D143} | R^{D207} |
| L_{C1216} | R^{D10} | R^{D208} | L_{C1270} | R^{D55} | R^{D208} | L_{C1324} | R^{D37} | R^{D208} | L_{C1378} | R^{D143} | R^{D208} |
| L_{C1217} | R^{D10} | R^{D209} | L_{C1271} | R^{D55} | R^{D209} | L_{C1325} | R^{D37} | R^{D209} | L_{C1379} | R^{D143} | R^{D209} |
| L_{C1218} | R^{D10} | R^{D210} | L_{C1272} | R^{D55} | R^{D210} | L_{C1326} | R^{D37} | R^{D210} | L_{C1380} | R^{D143} | R^{D210} |
| L_{C1219} | R^{D10} | R^{D211} | L_{C1273} | R^{D55} | R^{D211} | L_{C1327} | R^{D37} | R^{D211} | L_{C1381} | R^{D143} | R^{D211} |
| L_{C1220} | R^{D10} | R^{D212} | L_{C1274} | R^{D55} | R^{D212} | L_{C1328} | R^{D37} | R^{D212} | L_{C1382} | R^{D143} | R^{D212} |
| L_{C1221} | R^{D10} | R^{D213} | L_{C1275} | R^{D55} | R^{D213} | L_{C1329} | R^{D37} | R^{D213} | L_{C1383} | R^{D143} | R^{D213} |
| L_{C1222} | R^{D10} | R^{D214} | L_{C1276} | R^{D55} | R^{D214} | L_{C1330} | R^{D37} | R^{D214} | L_{C1384} | R^{D143} | R^{D214} |
| L_{C1223} | R^{D10} | R^{D215} | L_{C1277} | R^{D55} | R^{D215} | L_{C1331} | R^{D37} | R^{D215} | L_{C1385} | R^{D143} | R^{D215} |
| L_{C1224} | R^{D10} | R^{D216} | L_{C1278} | R^{D55} | R^{D216} | L_{C1332} | R^{D37} | R^{D216} | L_{C1386} | R^{D143} | R^{D216} |
| L_{C1225} | R^{D10} | R^{D217} | L_{C1279} | R^{D55} | R^{D217} | L_{C1333} | R^{D37} | R^{D217} | L_{C1387} | R^{D143} | R^{D217} |
| L_{C1226} | R^{D10} | R^{D218} | L_{C1280} | R^{D55} | R^{D218} | L_{C1334} | R^{D37} | R^{D218} | L_{C1388} | R^{D143} | R^{D218} |
| L_{C1227} | R^{D10} | R^{D219} | L_{C1281} | R^{D55} | R^{D219} | L_{C1335} | R^{D37} | R^{D219} | L_{C1389} | R^{D143} | R^{D219} |
| L_{C1228} | R^{D10} | R^{D220} | L_{C1282} | R^{D55} | R^{D220} | L_{C1336} | R^{D37} | R^{D220} | L_{C1390} | R^{D143} | R^{D220} |
| L_{C1229} | R^{D10} | R^{D221} | L_{C1283} | R^{D55} | R^{D221} | L_{C1337} | R^{D37} | R^{D221} | L_{C1391} | R^{D143} | R^{D221} |
| L_{C1230} | R^{D10} | R^{D222} | L_{C1284} | R^{D55} | R^{D222} | L_{C1338} | R^{D37} | R^{D222} | L_{C1392} | R^{D143} | R^{D222} |
| L_{C1231} | R^{D10} | R^{D223} | L_{C1285} | R^{D55} | R^{D223} | L_{C1339} | R^{D37} | R^{D223} | L_{C1393} | R^{D143} | R^{D223} |
| L_{C1232} | R^{D10} | R^{D224} | L_{C1286} | R^{D55} | R^{D224} | L_{C1340} | R^{D37} | R^{D224} | L_{C1394} | R^{D143} | R^{D224} |
| L_{C1233} | R^{D10} | R^{D225} | L_{C1287} | R^{D55} | R^{D225} | L_{C1341} | R^{D37} | R^{D225} | L_{C1395} | R^{D143} | R^{D225} |
| L_{C1234} | R^{D10} | R^{D226} | L_{C1288} | R^{D55} | R^{D226} | L_{C1342} | R^{D37} | R^{D226} | L_{C1396} | R^{D143} | R^{D226} |
| L_{C1235} | R^{D10} | R^{D227} | L_{C1289} | R^{D55} | R^{D227} | L_{C1343} | R^{D37} | R^{D227} | L_{C1397} | R^{D143} | R^{D227} |
| L_{C1236} | R^{D10} | R^{D228} | L_{C1290} | R^{D55} | R^{D228} | L_{C1344} | R^{D37} | R^{D228} | L_{C1398} | R^{D143} | R^{D228} |
| L_{C1237} | R^{D10} | R^{D229} | L_{C1291} | R^{D55} | R^{D229} | L_{C1345} | R^{D37} | R^{D229} | L_{C1399} | R^{D143} | R^{D229} |
| L_{C1238} | R^{D10} | R^{D230} | L_{C1292} | R^{D55} | R^{D230} | L_{C1346} | R^{D37} | R^{D230} | L_{C1400} | R^{D143} | R^{D230} |
| L_{C1239} | R^{D10} | R^{D231} | L_{C1293} | R^{D55} | R^{D231} | L_{C1347} | R^{D37} | R^{D231} | L_{C1401} | R^{D143} | R^{D231} |
| L_{C1240} | R^{D10} | R^{D232} | L_{C1294} | R^{D55} | R^{D232} | L_{C1348} | R^{D37} | R^{D232} | L_{C1402} | R^{D143} | R^{D232} |
| L_{C1241} | R^{D10} | R^{D233} | L_{C1295} | R^{D55} | R^{D233} | L_{C1349} | R^{D37} | R^{D233} | L_{C1403} | R^{D143} | R^{D233} |
| L_{C1242} | R^{D10} | R^{D234} | L_{C1296} | R^{D55} | R^{D234} | L_{C1350} | R^{D37} | R^{D234} | L_{C1404} | R^{D143} | R^{D234} |
| L_{C1243} | R^{D10} | R^{D235} | L_{C1297} | R^{D55} | R^{D235} | L_{C1351} | R^{D37} | R^{D235} | L_{C1405} | R^{D143} | R^{D235} |
| L_{C1244} | R^{D10} | R^{D236} | L_{C1298} | R^{D55} | R^{D236} | L_{C1352} | R^{D37} | R^{D236} | L_{C1406} | R^{D143} | R^{D236} |
| L_{C1245} | R^{D10} | R^{D237} | L_{C1299} | R^{D55} | R^{D237} | L_{C1353} | R^{D37} | R^{D237} | L_{C1407} | R^{D143} | R^{D237} |
| L_{C1246} | R^{D10} | R^{D238} | L_{C1300} | R^{D55} | R^{D238} | L_{C1354} | R^{D37} | R^{D238} | L_{C1408} | R^{D143} | R^{D238} |
| L_{C1247} | R^{D10} | R^{D239} | L_{C1301} | R^{D55} | R^{D239} | L_{C1355} | R^{D37} | R^{D239} | L_{C1409} | R^{D143} | R^{D239} |
| L_{C1248} | R^{D10} | R^{D240} | L_{C1302} | R^{D55} | R^{D240} | L_{C1356} | R^{D37} | R^{D240} | L_{C1410} | R^{D143} | R^{D240} |
| L_{C1249} | R^{D10} | R^{D241} | L_{C1303} | R^{D55} | R^{D241} | L_{C1357} | R^{D37} | R^{D241} | L_{C1411} | R^{D143} | R^{D241} |
| L_{C1250} | R^{D10} | R^{D242} | L_{C1304} | R^{D55} | R^{D242} | L_{C1358} | R^{D37} | R^{D242} | L_{C1412} | R^{D143} | R^{D242} |
| L_{C1251} | R^{D10} | R^{D243} | L_{C1305} | R^{D55} | R^{D243} | L_{C1359} | R^{D37} | R^{D243} | L_{C1413} | R^{D143} | R^{D243} |
| L_{C1252} | R^{D10} | R^{D244} | L_{C1306} | R^{D55} | R^{D244} | L_{C1360} | R^{D37} | R^{D244} | L_{C1414} | R^{D143} | R^{D244} |
| L_{C1253} | R^{D10} | R^{D245} | L_{C1307} | R^{D55} | R^{D245} | L_{C1361} | R^{D37} | R^{D245} | L_{C1415} | R^{D143} | R^{D245} |
| L_{C1254} | R^{D10} | R^{D246} | L_{C1308} | R^{D55} | R^{D246} | L_{C1362} | R^{D37} | R^{D246} | L_{C1416} | R^{D143} | R^{D246} |

wherein R^{D1} to R^{D246} have the structures in the following LIST 11:

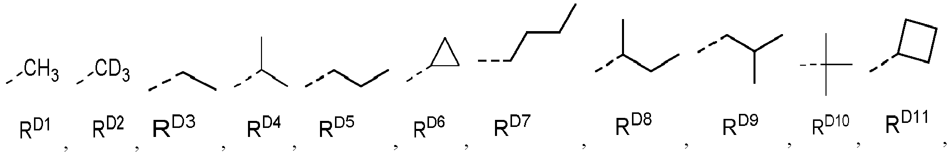

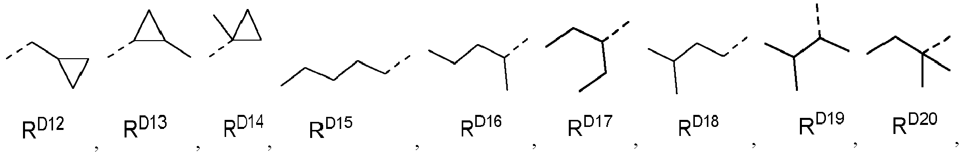

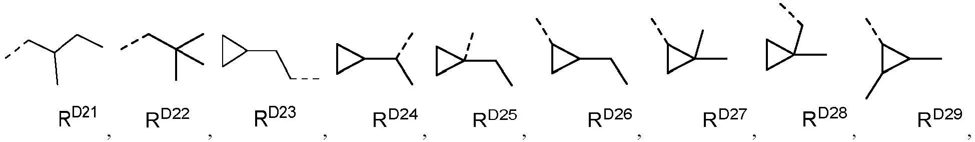

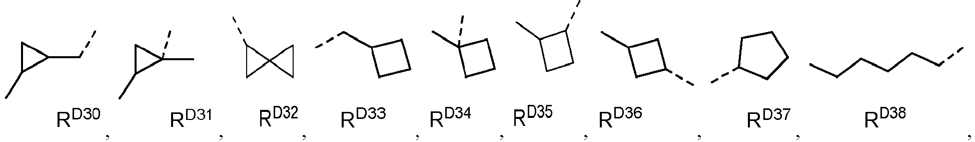

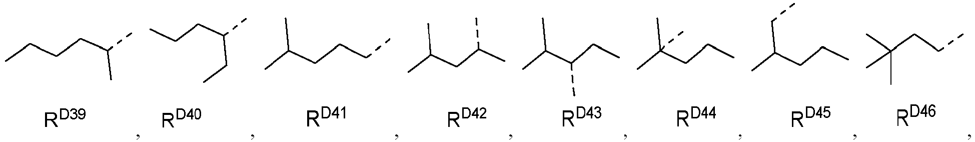

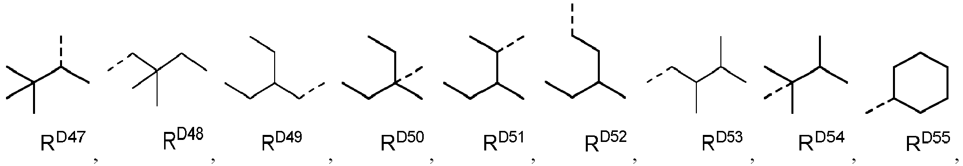

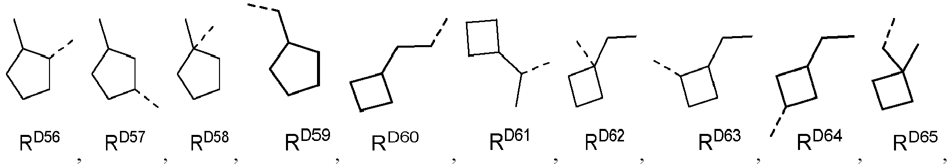

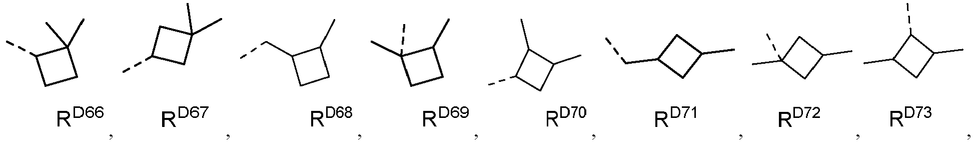

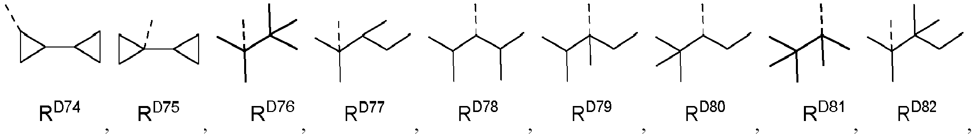

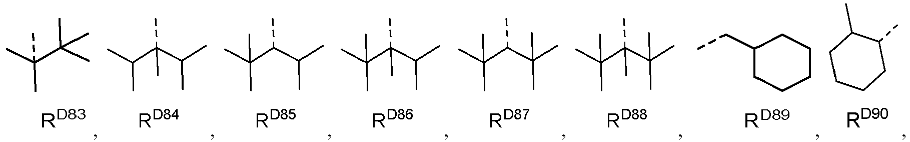

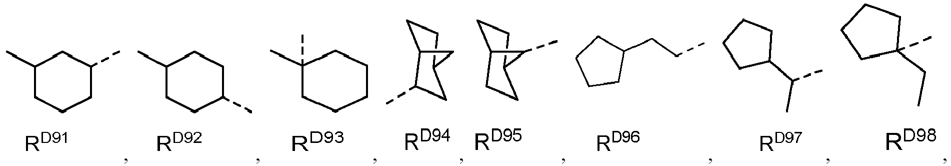

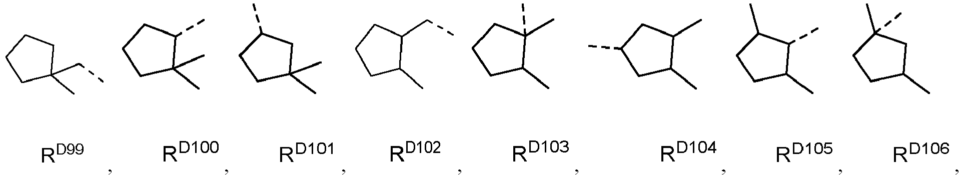

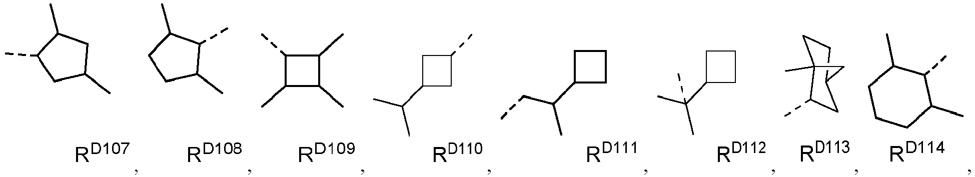

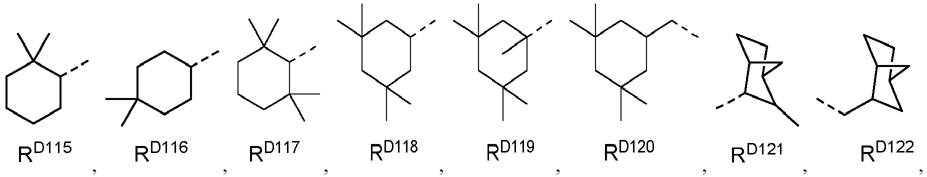

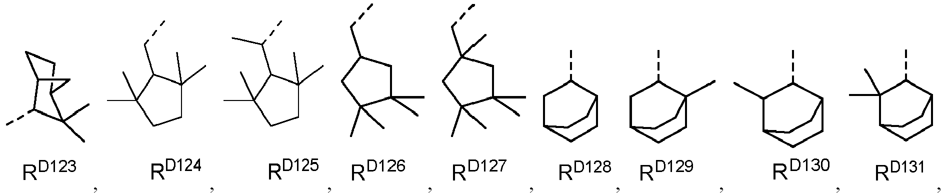

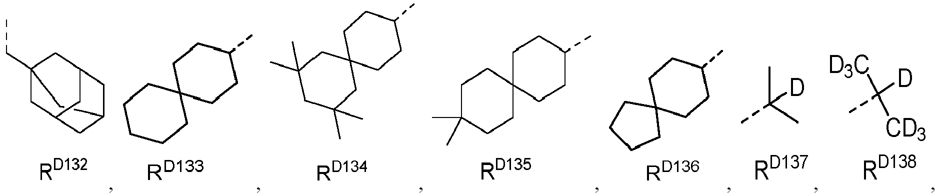

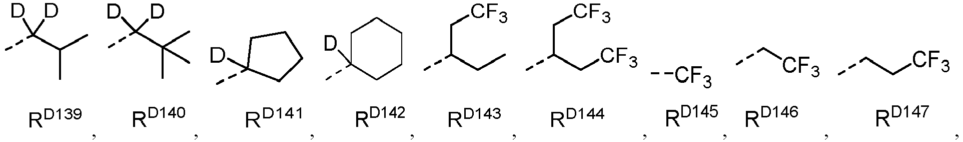

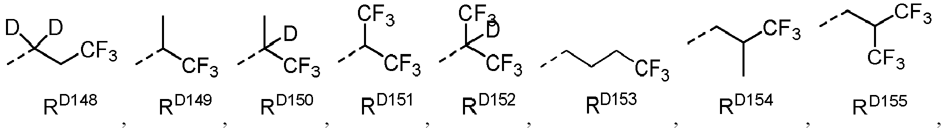

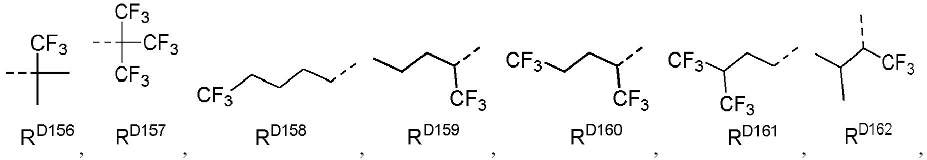

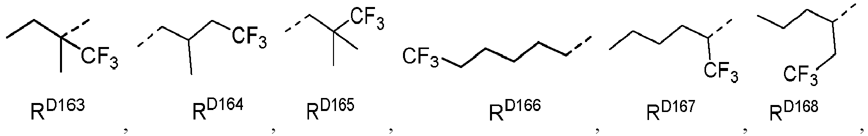

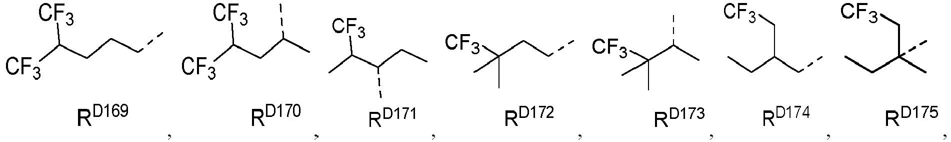

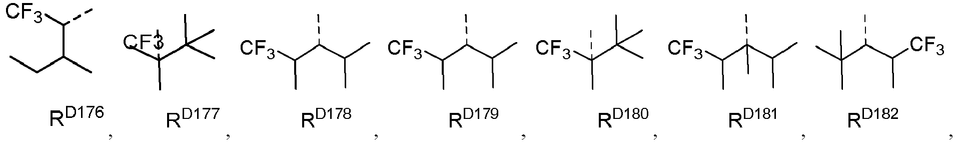

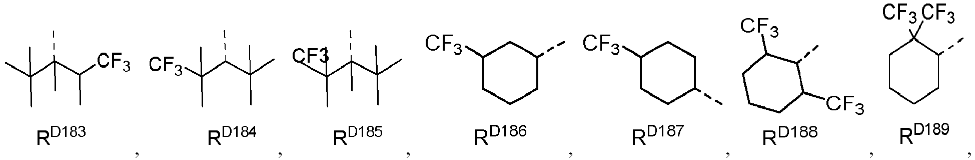

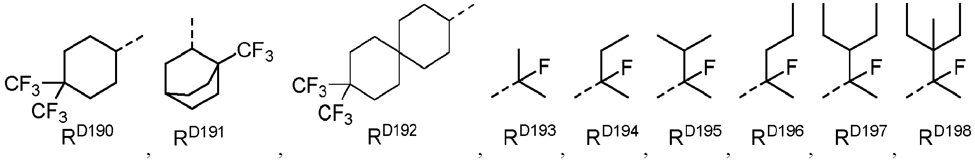

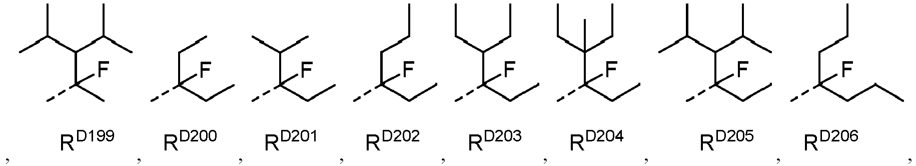

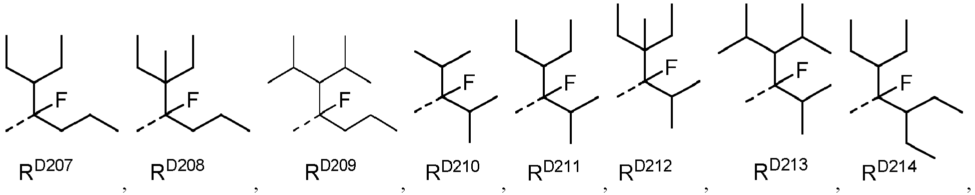

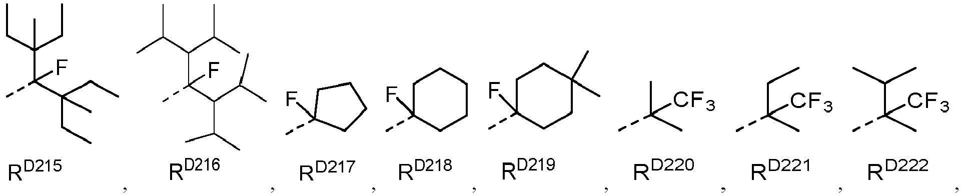

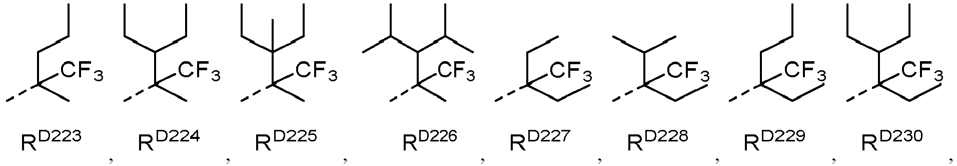

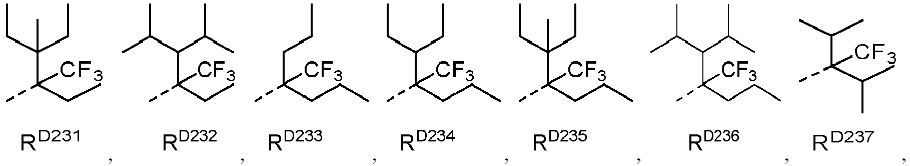

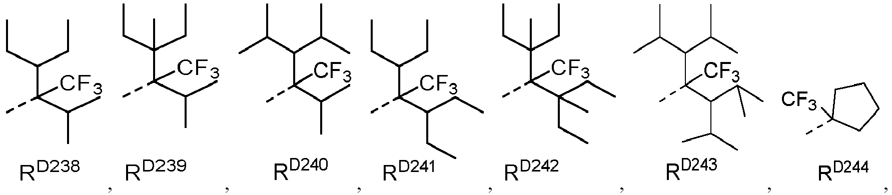

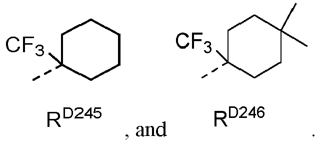

In some embodiments, the compound is selected from the group consisting of only those compounds whose L_{B*k*} corresponds to one of the following: L_{B1}, L_{B2}, L_{B18}, L_{B28}, L_{B38}, L_{B108}, L_{B118}, L_{B122}, L_{B124}, L_{B126}, L_{B128}, L_{B130}, L_{B132}, L_{B134}, L_{B136}, L_{B138}, L_{B140}, L_{B142}, L_{B144}, L_{B156}, L_{B158}, L_{B160}, L_{B162}, L_{B164}, L_{B168}, L_{B172}, L_{B175}, L_{B204}, L_{B206}, L_{B214}, L_{B216}, L_{B218}, L_{B220}, L_{B222}, L_{B231}, L_{B233}, L_{B235}, L_{B237}, L_{B240}, L_{B242}, L_{B244}, L_{B246}, L_{B248}, L_{B250}, L_{B252}, L_{B254}, L_{B256}, L_{B258}, L_{B260}, L_{B262}, L_{B264}, L_{B265}, L_{B266}, L_{B267}, L_{B268}, L_{B269}, and L_{B270}.

In some embodiments, the compound is selected from the group consisting of only those compounds whose Lat corresponds to one of the following: L_{B1}, L_{B2}, L_{B18}, L_{B28}, L_{B38}, L_{B108}, L_{B118}, L_{B122}, L_{B126}, L_{B128}, L_{B132}, L_{B136}, L_{B138}, L_{B142}, L_{B156}, L_{B162}, L_{B204}, L_{B206}, L_{B214}, L_{B216}, L_{B218}, L_{B220}, L_{B231}, L_{B233}, L_{B 237}, L_{B 264}, L_{B265}, L_{B266}, L_{B267}, L_{B268}, L_{B269}, and LB270.

In some embodiments, the compound is selected from the group consisting of only those compounds having L_{C*j*-I} or L_{C*j*-II} ligand whose corresponding R²⁰¹ and R²⁰² are defined to be one of the following structures: R^{D1}, R^{D3}, R^{D4}, R^{D5}, R^{D9}, R^{D10}, R¹⁷, R^{D18}, R^{D20}, R^{D22}, R^{D37}, R^{D40}, R^{D41}, R^{D42}, R^{D43}, R^{D48}, R^{D49}, R^{D50}, R^{D54}, R^{D55}, R^{D58}, R^{D59}, R^{D78}, R^{D79}, R^{D81}, R^{D87}, R^{D88}, R^{D89}, R^{D93}, R^{D116}, R^{D117}, R^{D118}, R^{D119}, R^{D120}, R^{D133}, R^{D134}, R^{D135}, R^{D136}, R^{D143}, R^{D144}, R^{D145}, R^{D146}, R^{D147}, R^{D149}, R^{D151}, R^{D154}, R^{D155}, R^{D161}, R^{D175} R^{P190}, R^{P193}, R^{D200}, R^{D201}, R^{D206}, R^{P210}, R^{D214}, R^{D215}, R^{D216}, R^{D218}, R^{D219}, R^{D220}, R^{D227}, R^{D237}, R^{D241}, R^{D242}, R^{D245}, and R^{D246}.

In some embodiments, the compound is selected from the group consisting of only those compounds having L_{C*j*-I} or L_{C*j*-II} ligand whose corresponding R²⁰¹ and R²⁰² are defined to be one of selected from the following structures: R^{D1}, R^{D3}, R^{D4}, R^{D5}, R^{D9}, R^{D10}, R^{D17}, R^{D22}, R^{D43}, R^{D50}, R^{D78}, R^{D116}, R^{D118}, R^{D133}, R^{D134}, R^{D135}, R^{D136}, R^{D143}, R^{D144}, R^{D145}, R^{D146}, R^{D149}, R^{D151}, R^{D154}, R^{D155} R^{D190}, R^{D193}, R^{D200}, R^{D201}, R^{D206}, R^{D210}, R^{D214}, R^{D215}, R^{D216}, R^{D218}, R^{D219}, R^{D220}, R^{D227}, R^{D237}, R^{D241}, R^{D242}, R^{D245}, and R^{D246}.

In some embodiments, the compound is selected from the group consisting of only those compounds having one of the following structures for the L_{C*j*-I} ligand:

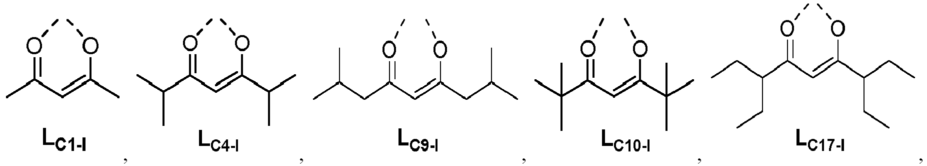

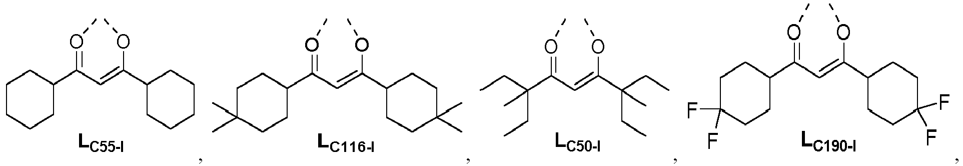

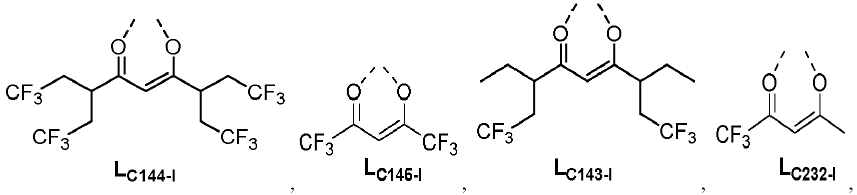

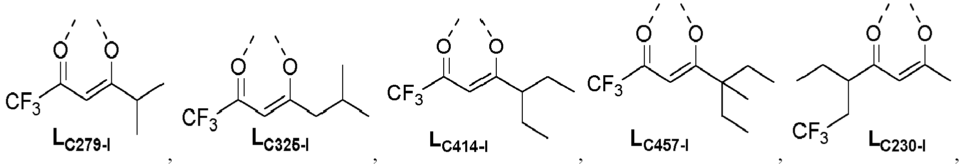

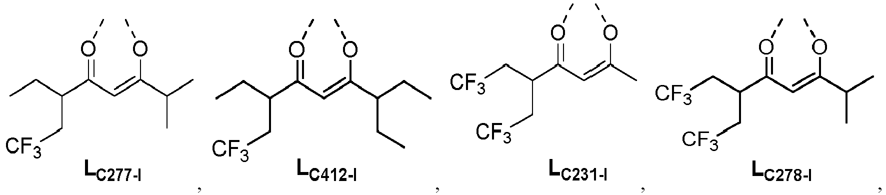

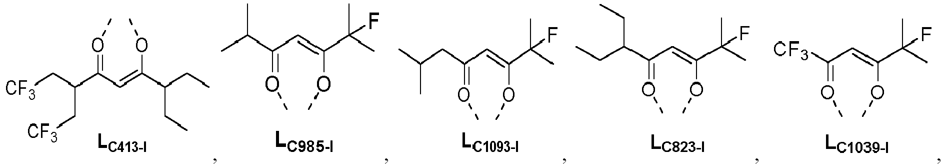

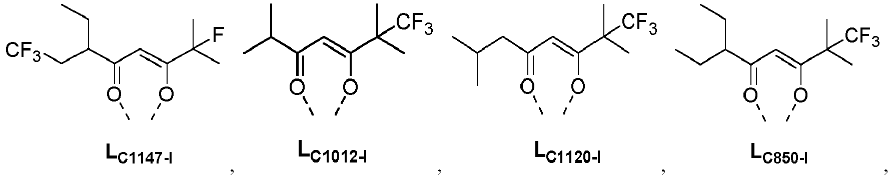

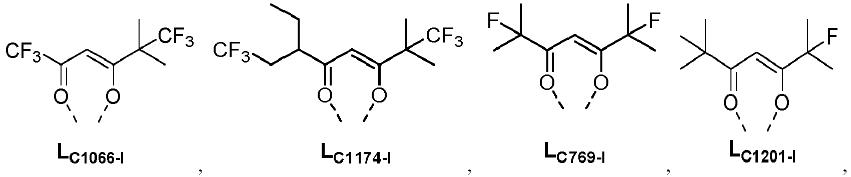

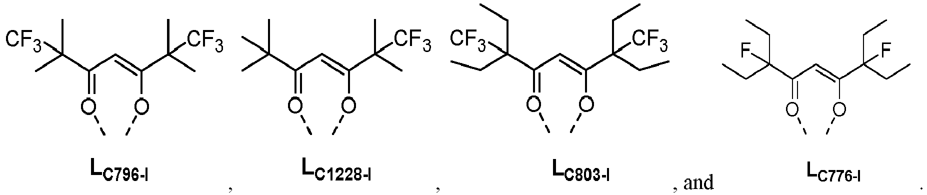

In some embodiments, the compound comprising a first ligand L_{A} of Formula I may be selected from the group consisting of the following structures: 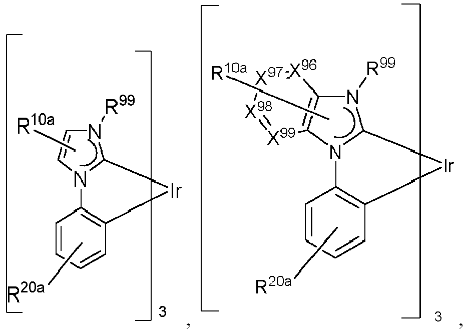 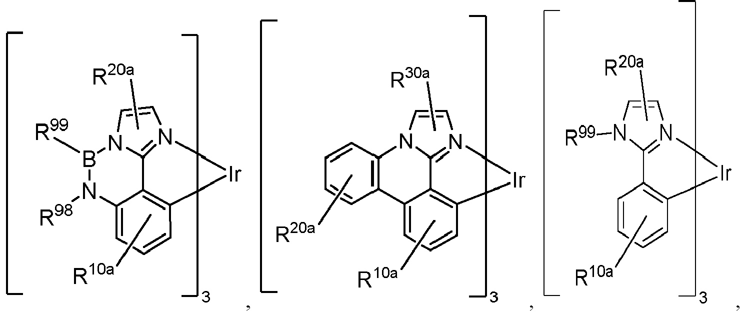 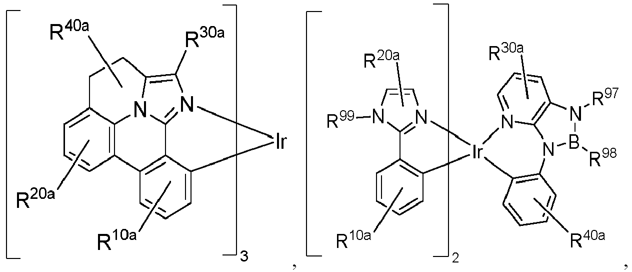 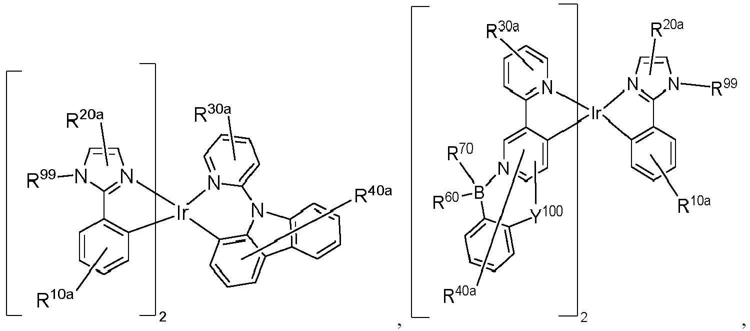 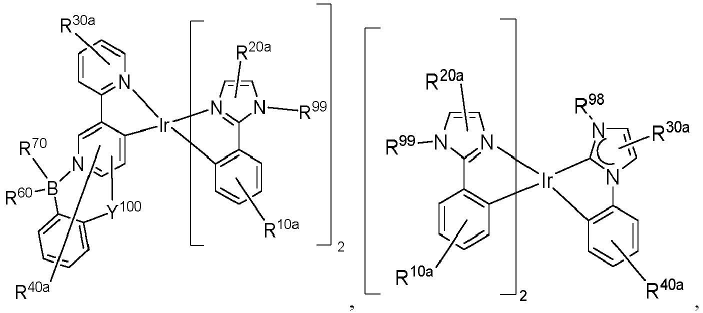 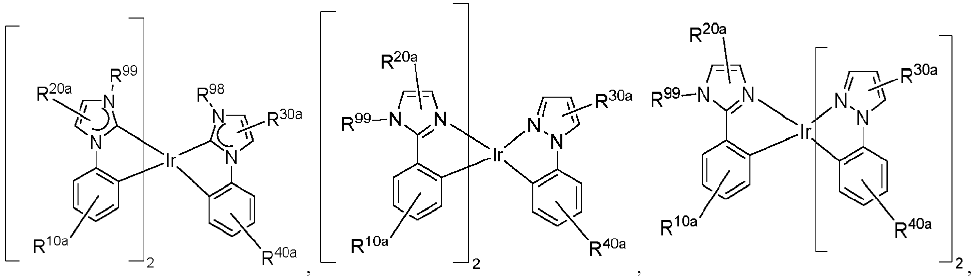 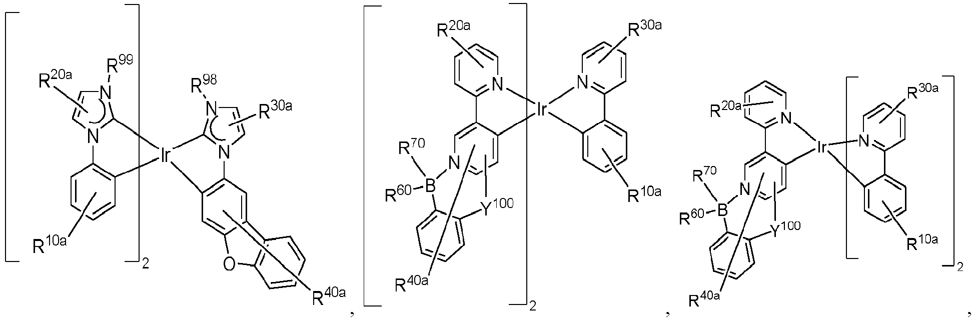 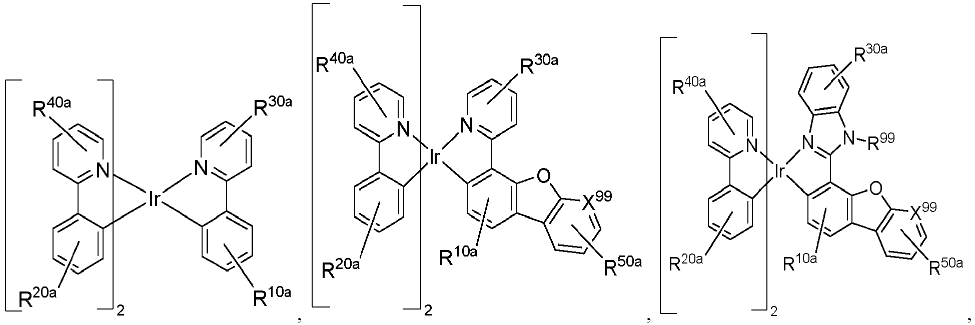 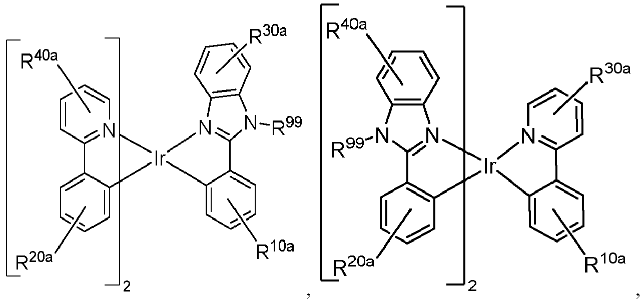 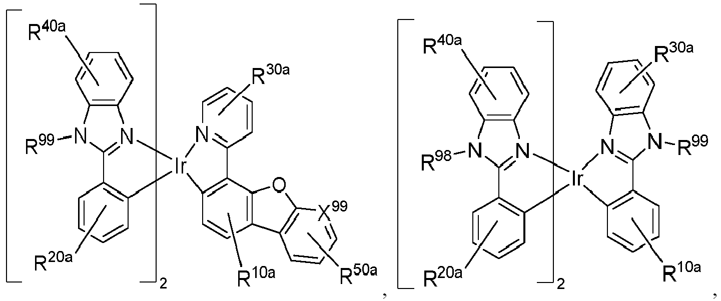 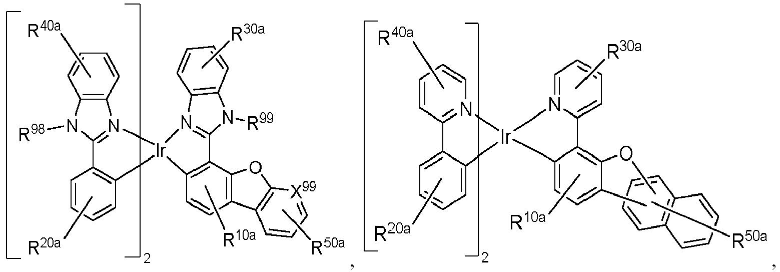 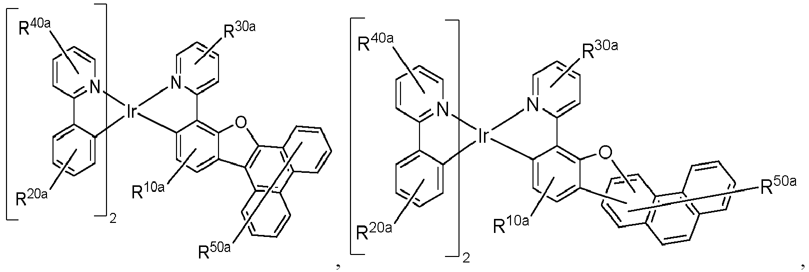 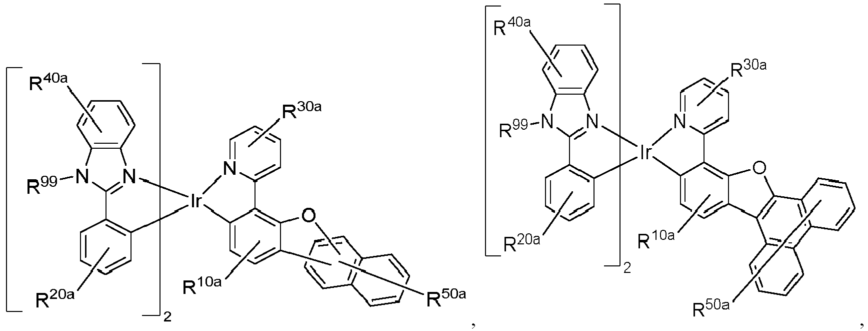 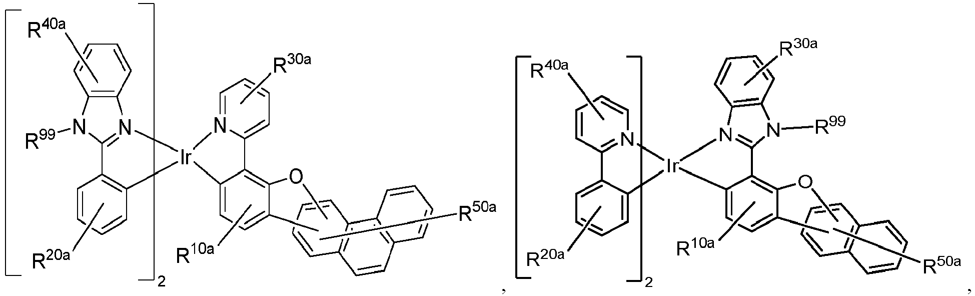 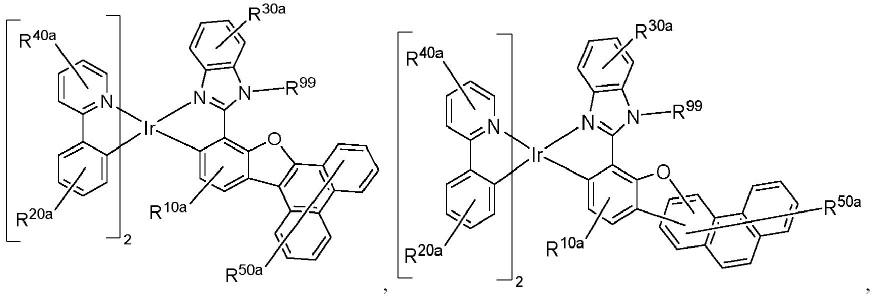 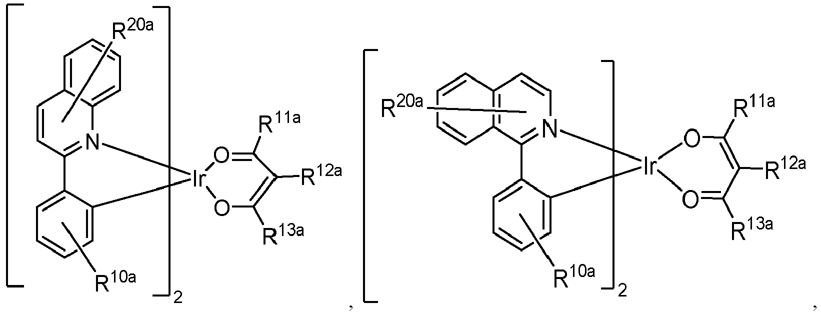 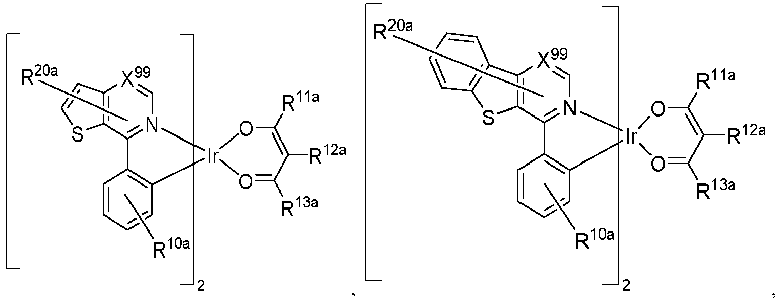 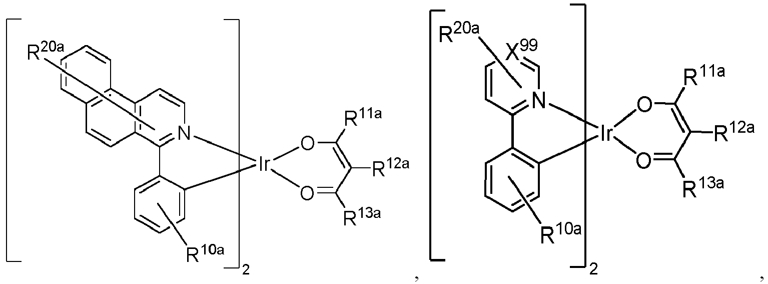 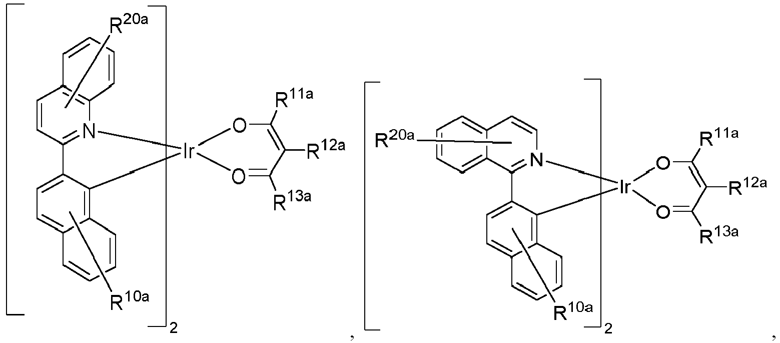 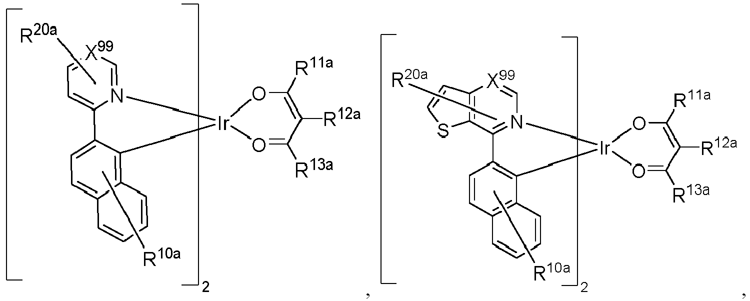 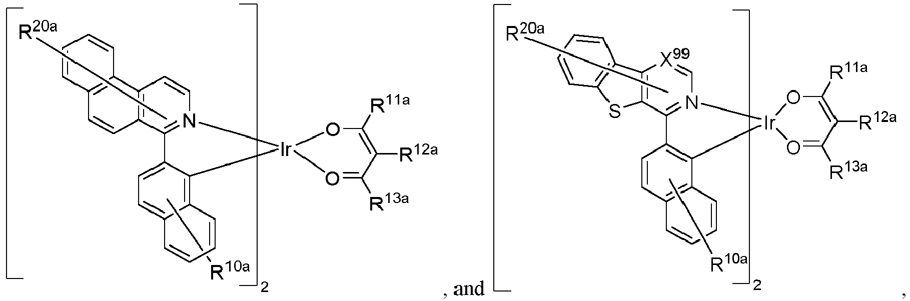 wherein:
each of X⁹⁶ to X⁹⁹ is independently C or N;
each Y¹⁰⁰ is independently selected from the group consisting of a NR", O, S, and Se;
each of R^{10a}, R^{20a}, R^{30a}, R^{40a}, and R^{50a} independently represents mono substitution, up to the maximum substitutions, or no substitutions;
each of R, R', R", R^{10a}, R^{11a}, R^{12a}, R^{13a}, R^{20a}, R^{30a}, R^{40a}, R^{50a}, R⁶⁰, R⁷⁰, R⁹⁷, R⁹⁸, and R⁹⁹ is independently a hydrogen or a substituent selected from the group consisting of the General Substituents defined herein;
at least one of R^{10a}, R^{20a}, R^{30a}, R^{40a}, or R^{50a} has a structure of Formula II, ---L-GeR¹R²R³; and
any two R^{10a}, R^{11a}, R^{12a}, R^{13a}, R^{20a}, R^{30a}, R^{40a}, R^{50a}, R⁶⁰, R⁷⁰, R⁹⁷, R⁹⁸, and R⁹⁹ can be joined or fused to form a ring.

In some embodiments, the compound is selected from the group consisting of the structures of the following LIST 12:

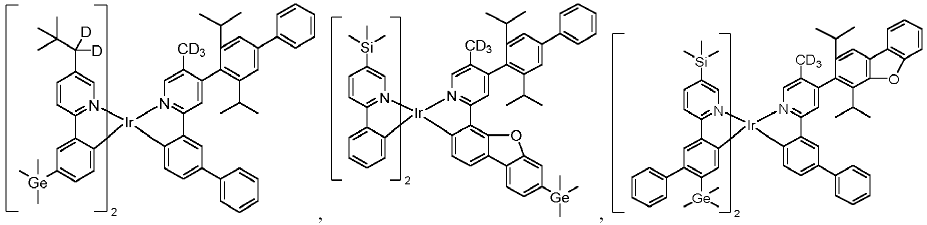

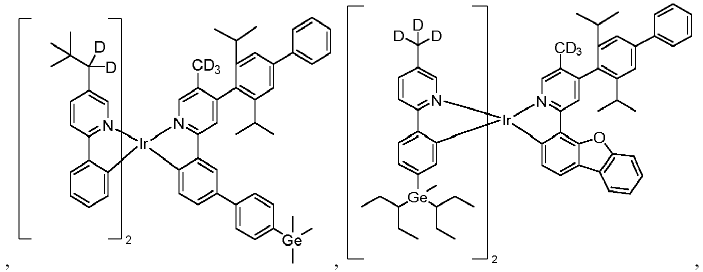

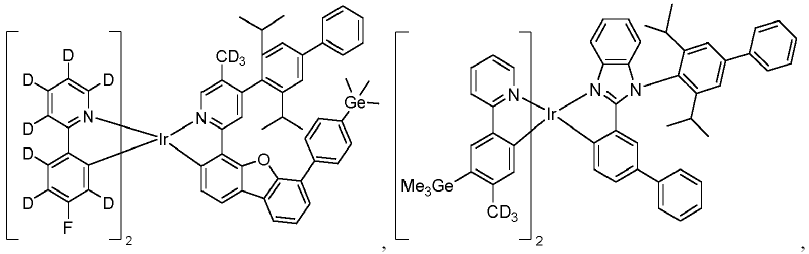

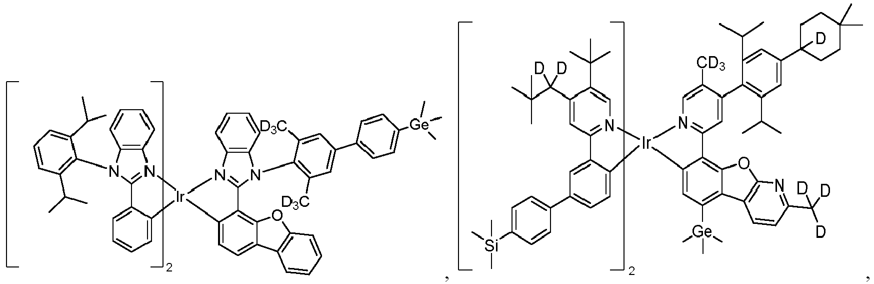

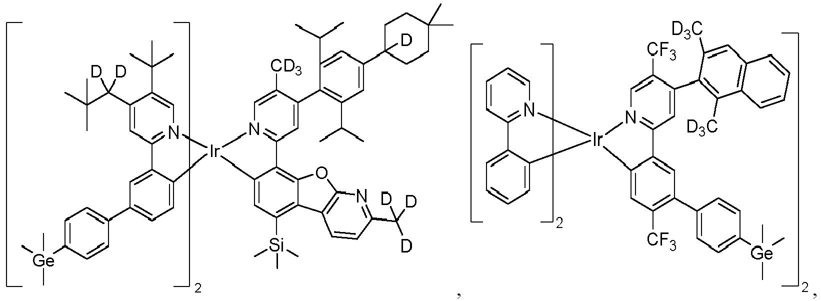

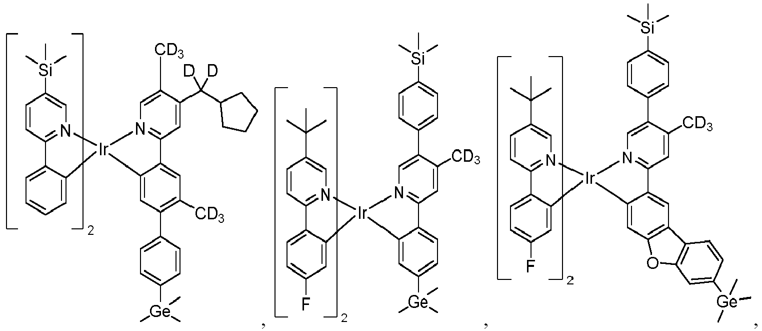

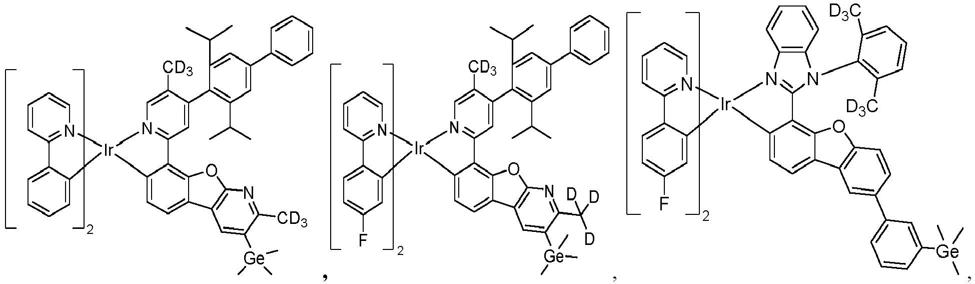

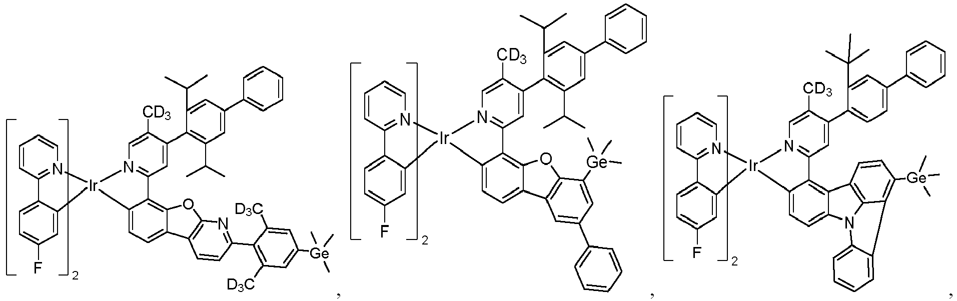

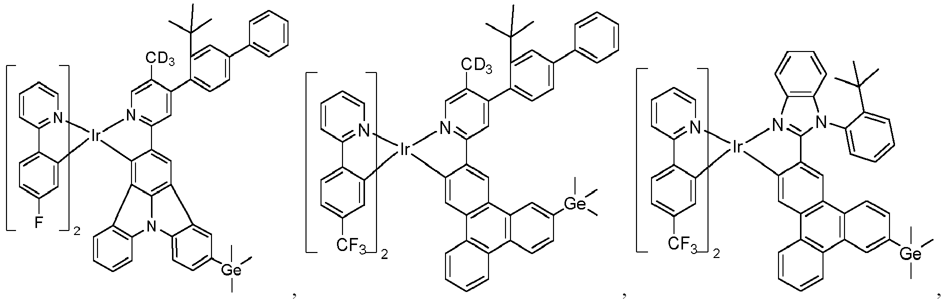

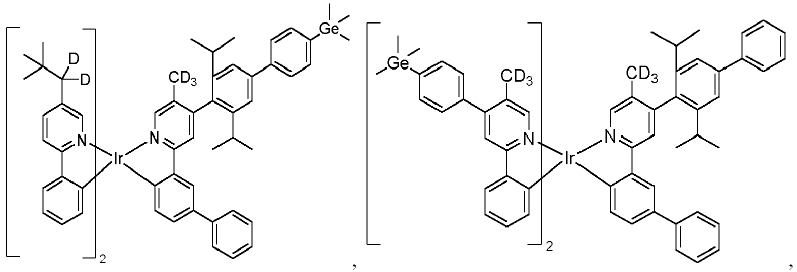

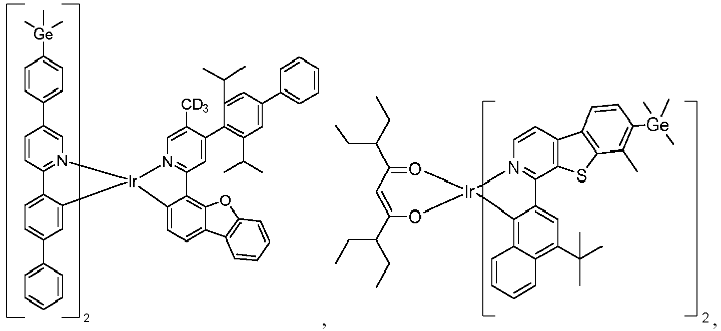

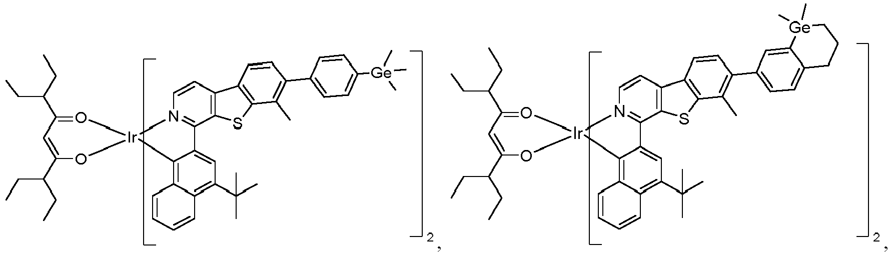

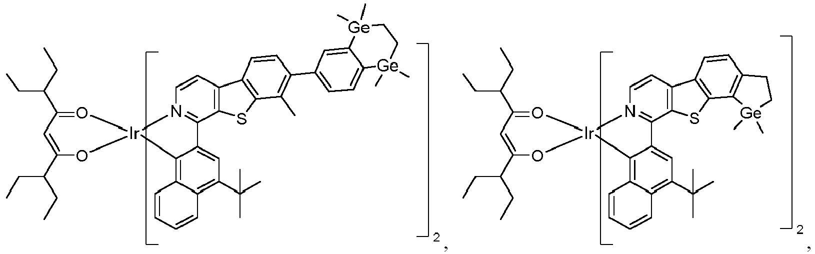

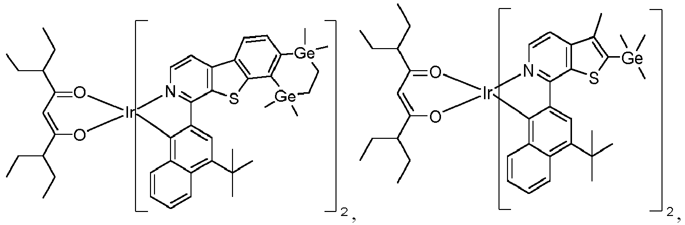

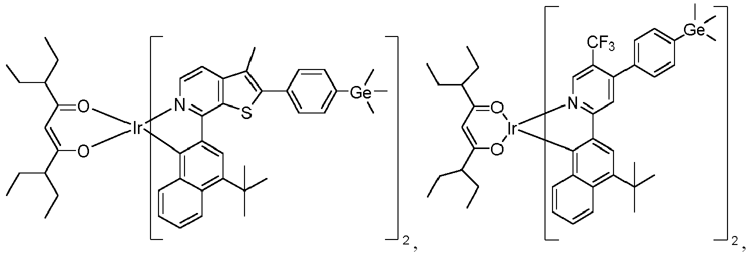

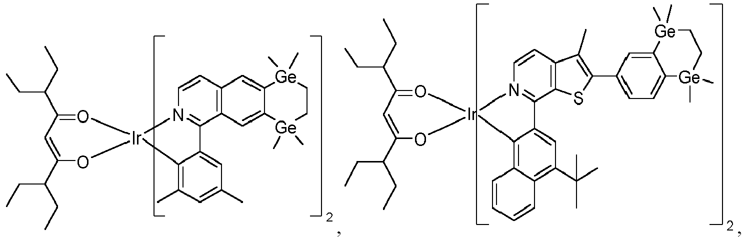

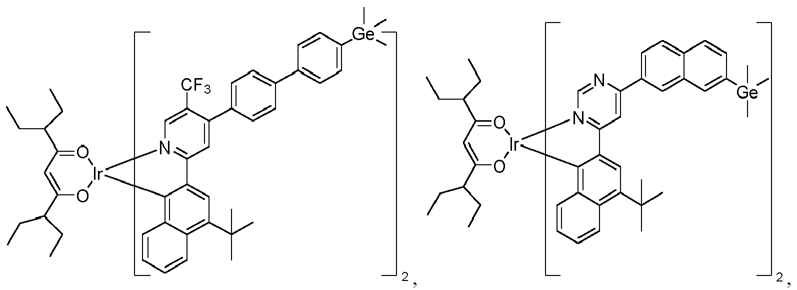

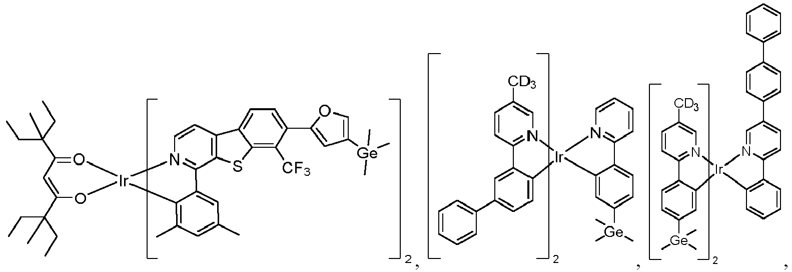

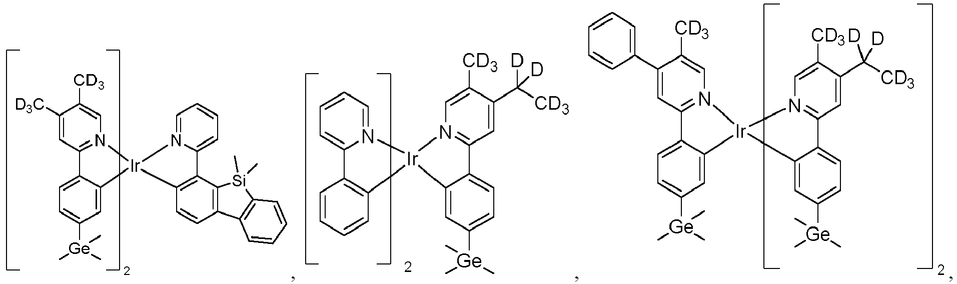

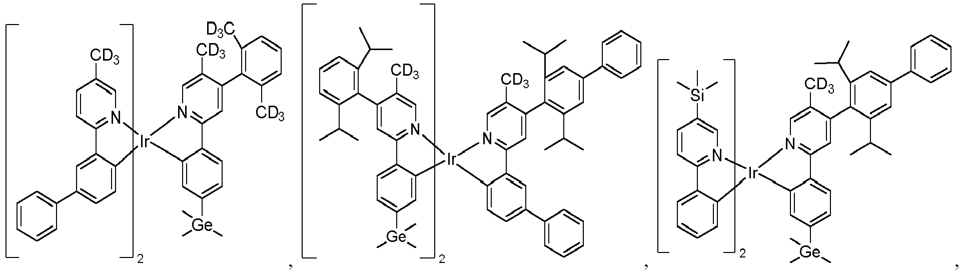

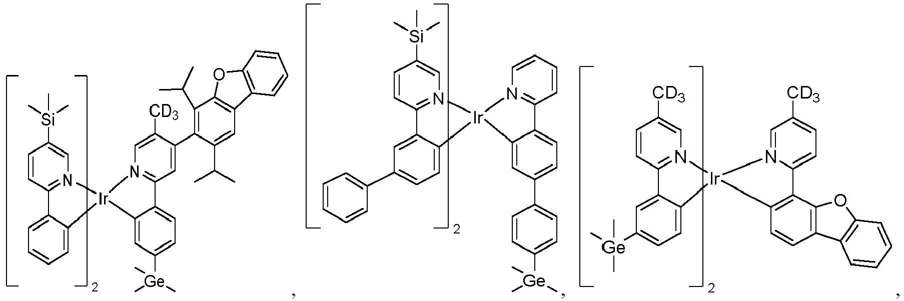

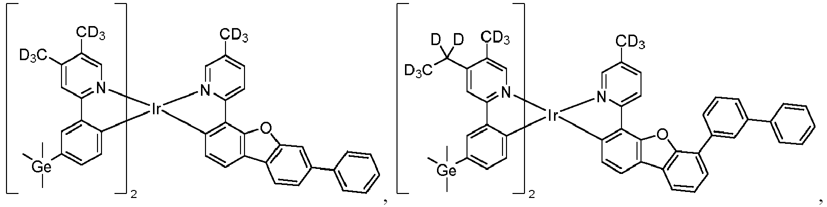

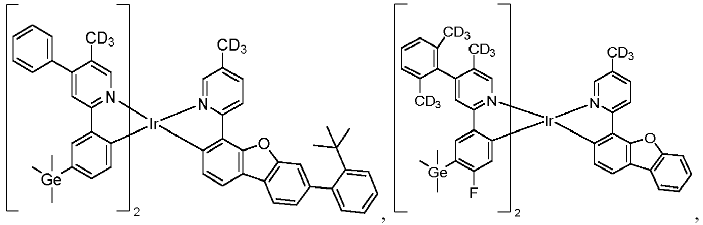

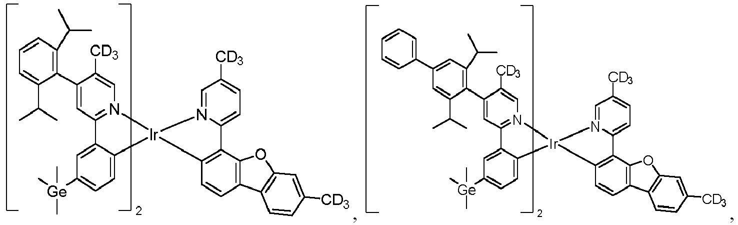

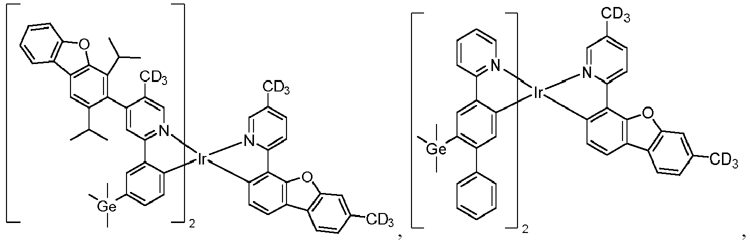

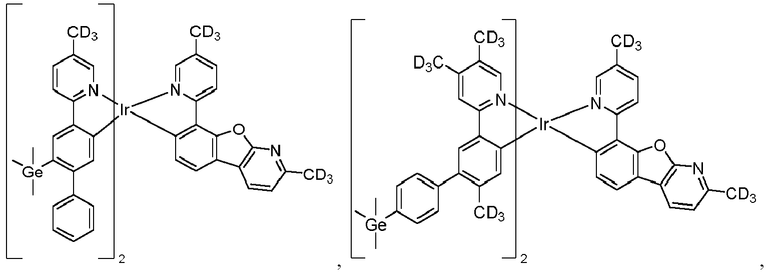

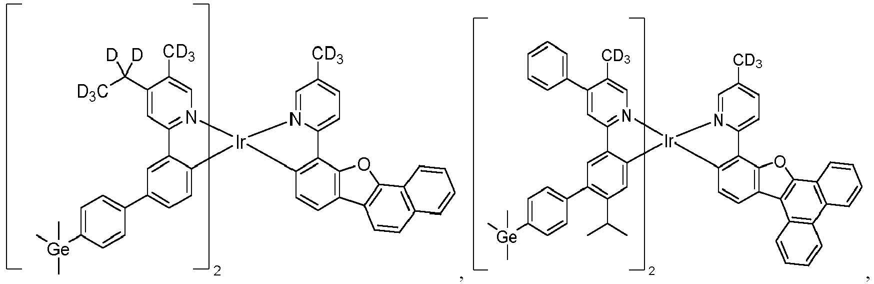

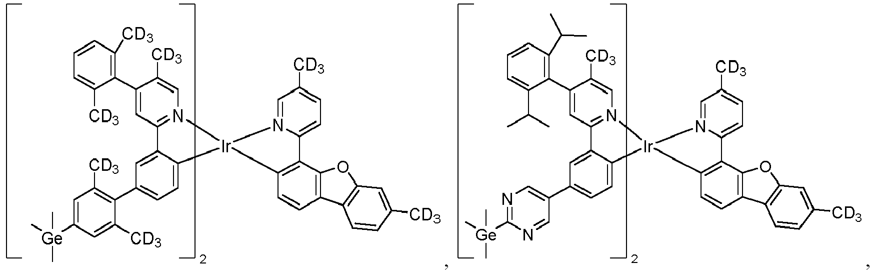

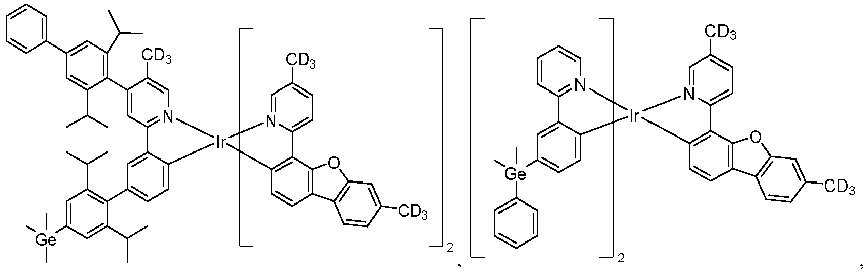

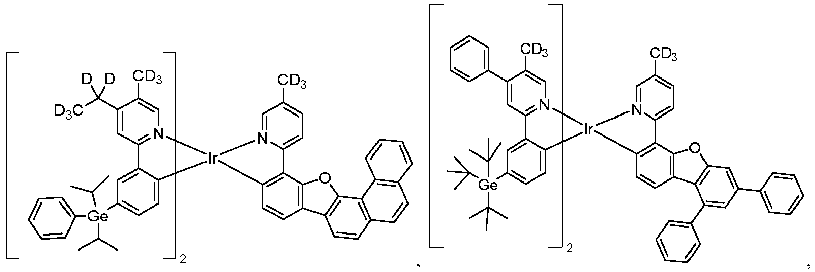

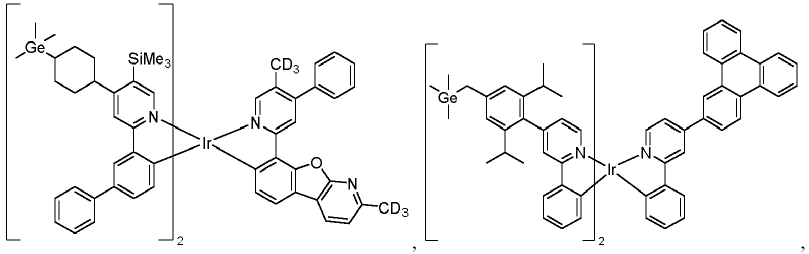

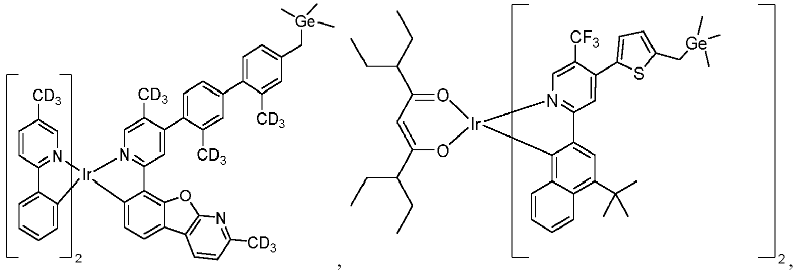

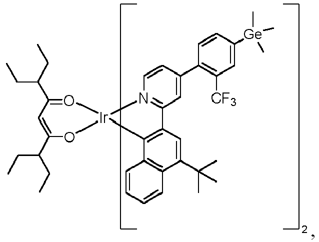

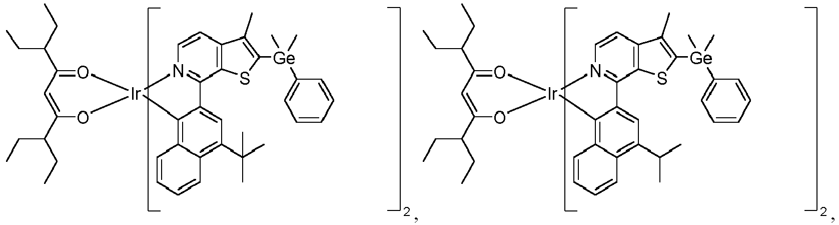

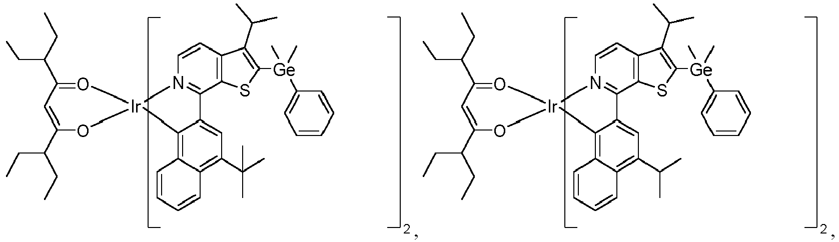

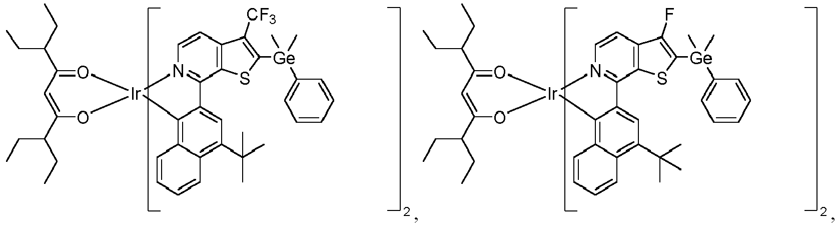

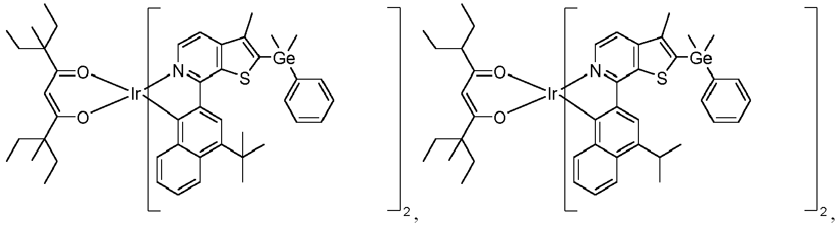

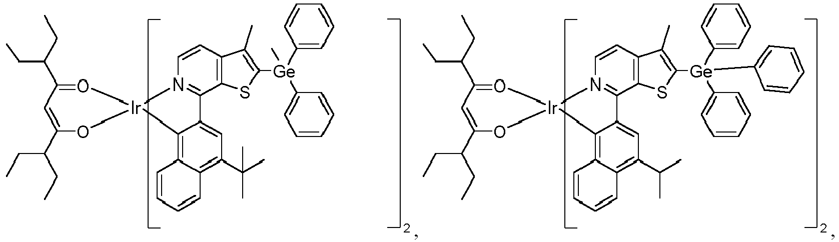

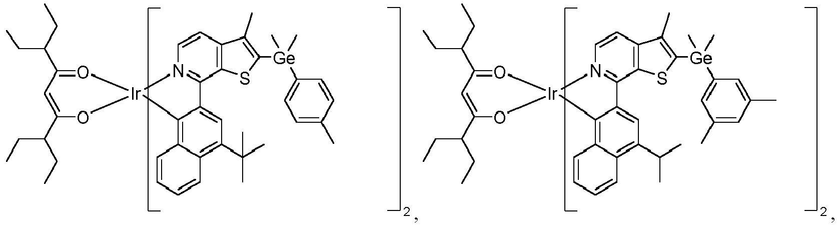

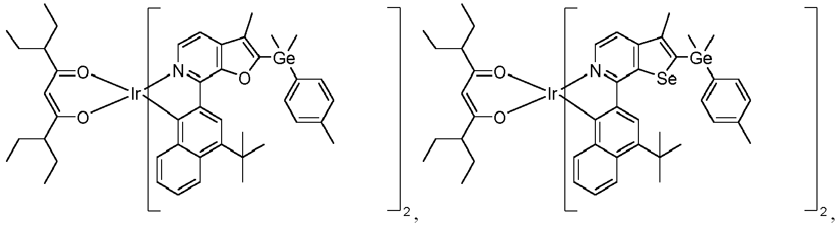

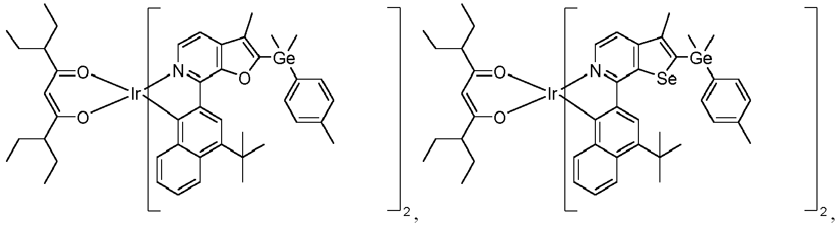

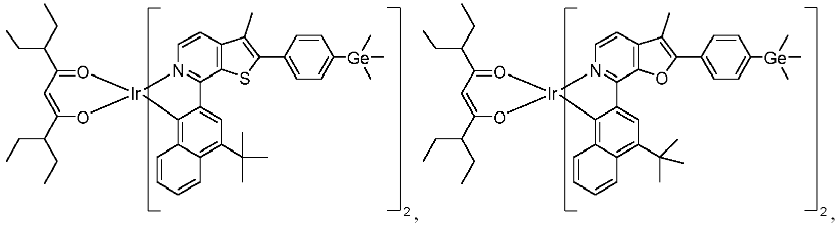

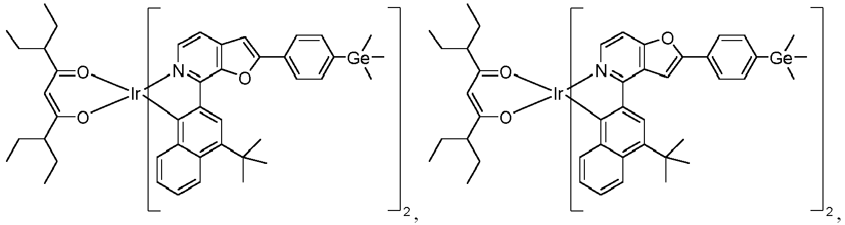

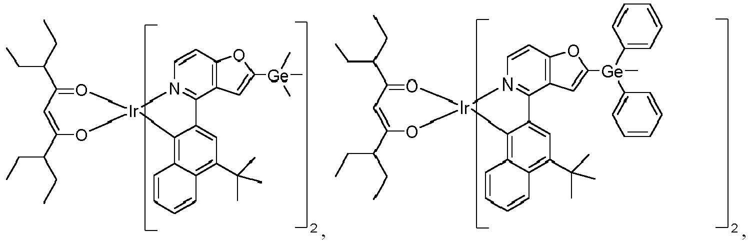

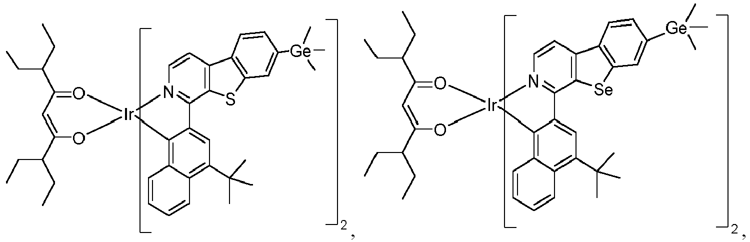

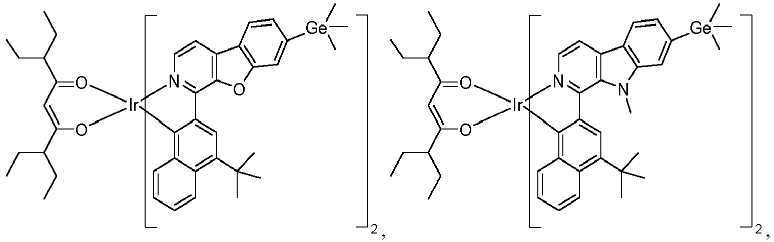

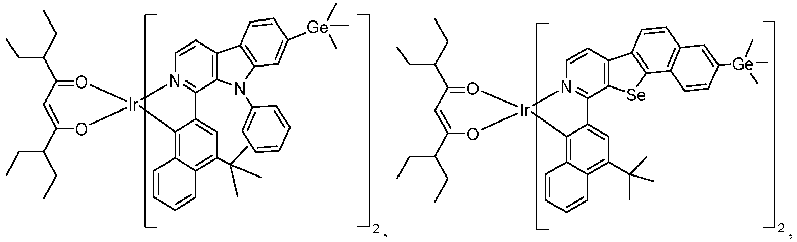

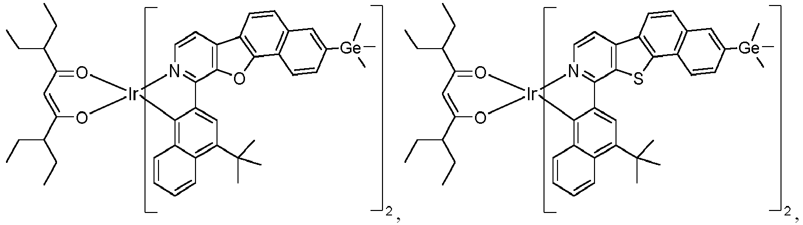

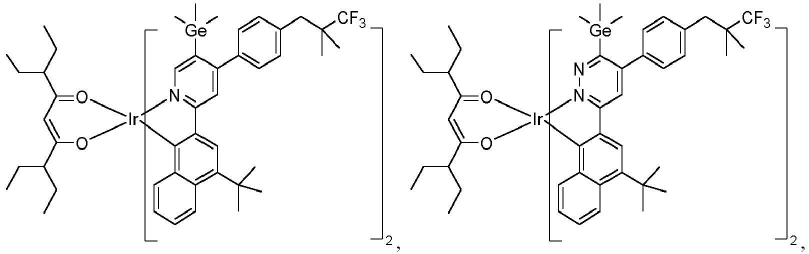

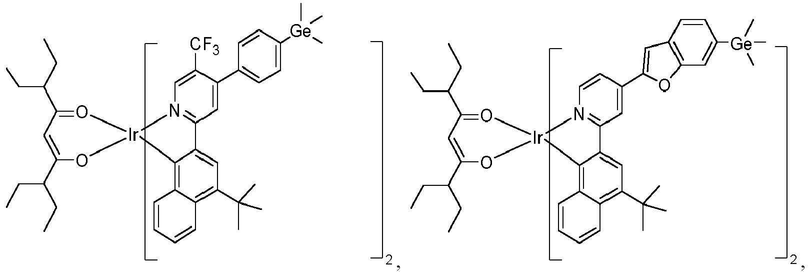

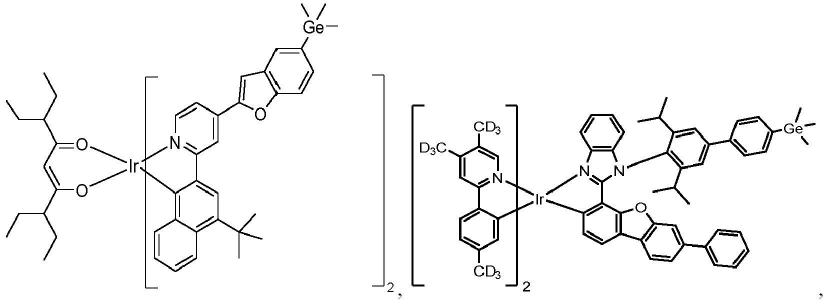

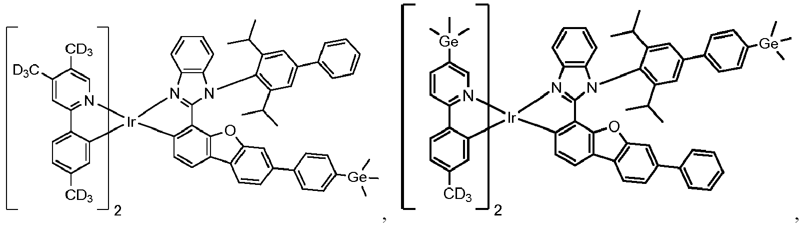

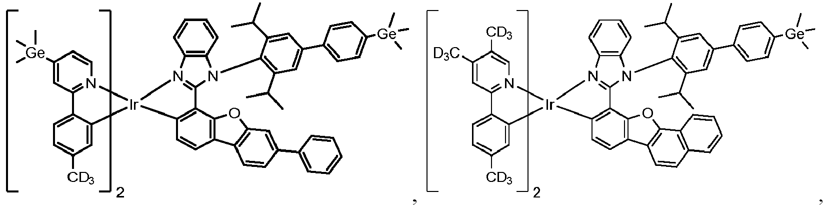

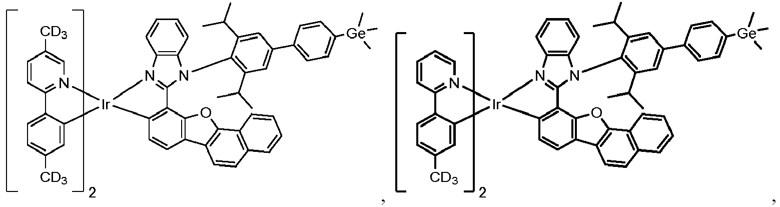

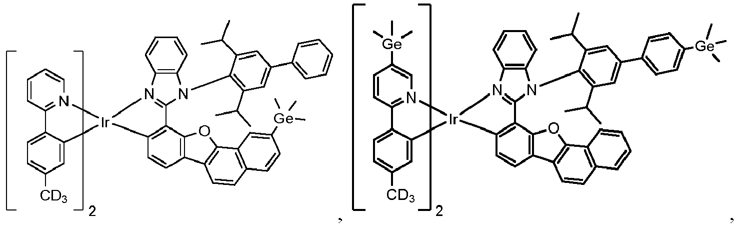

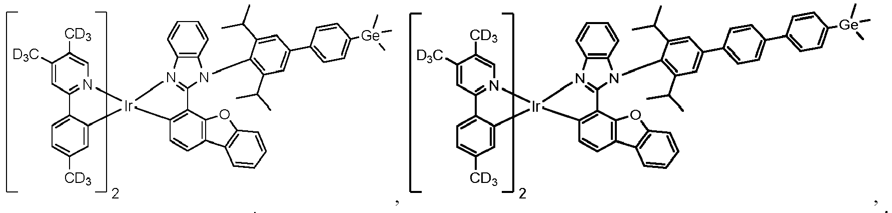

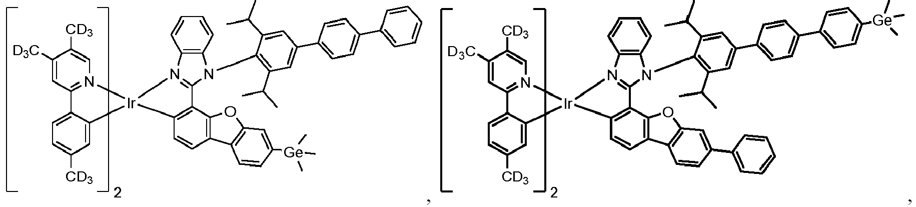

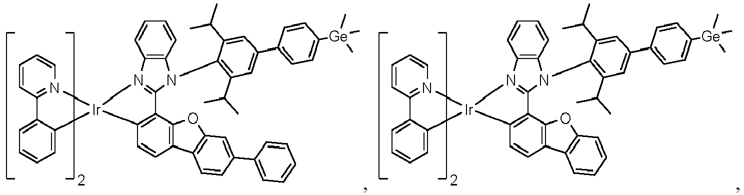

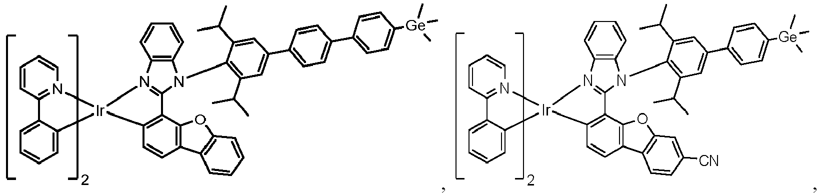

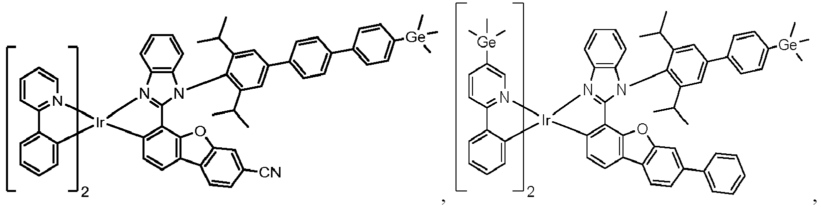

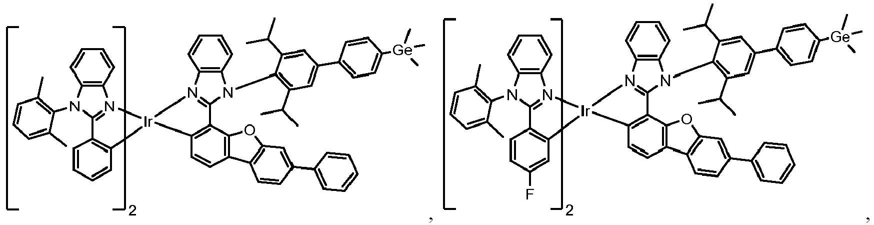

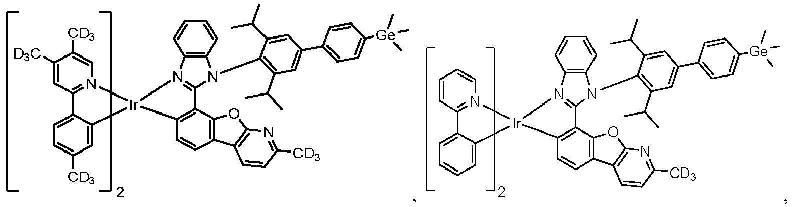

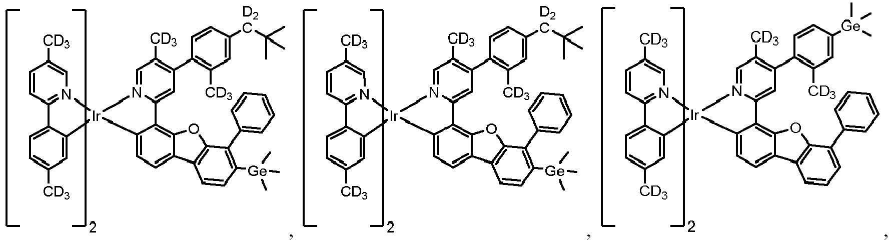

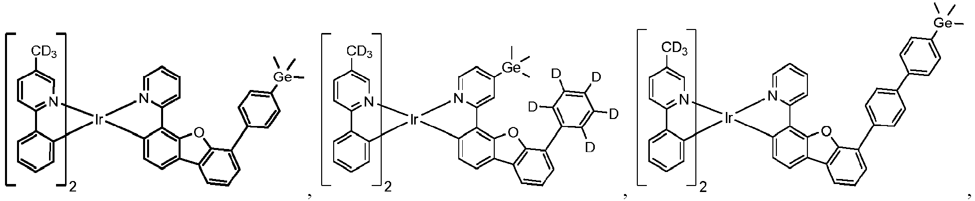

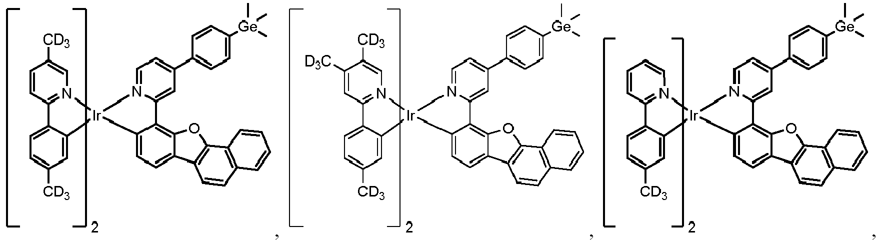

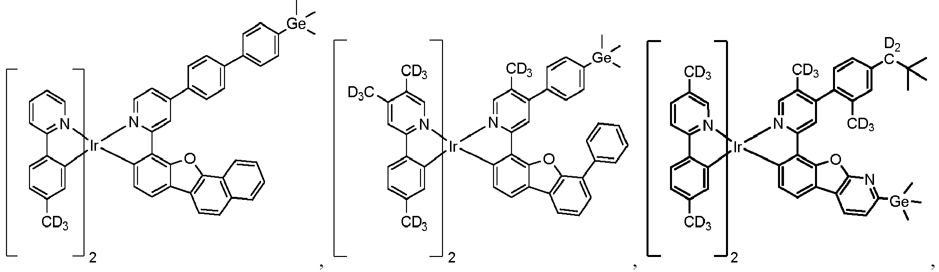

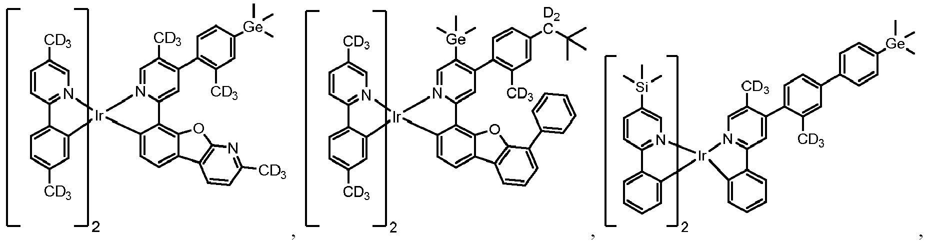

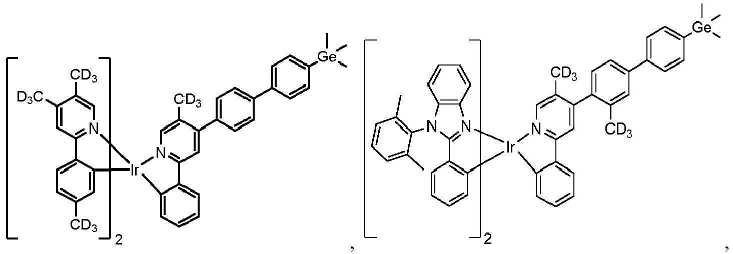

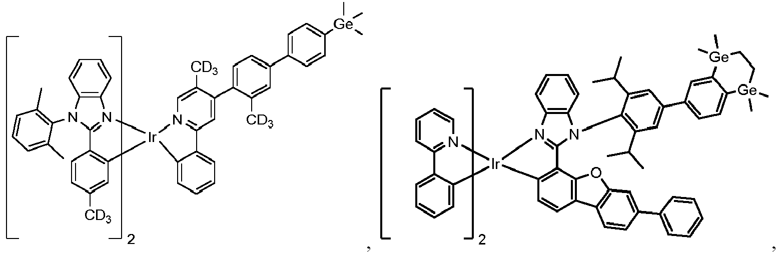

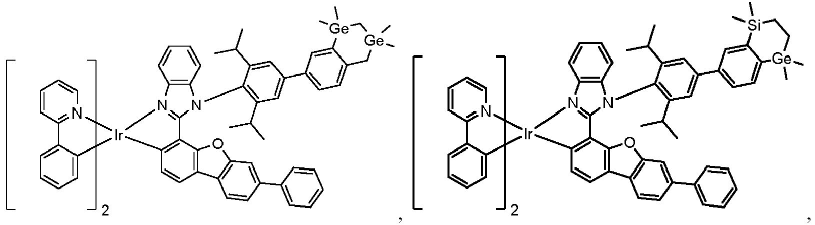

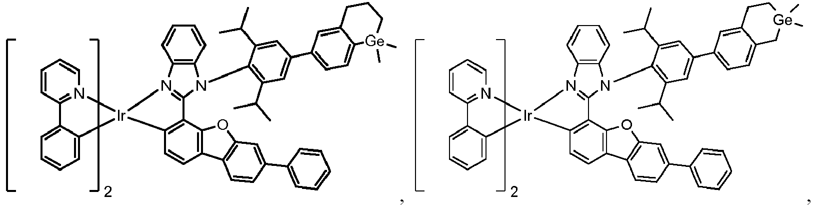

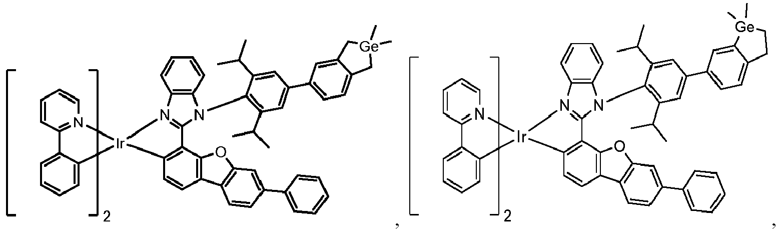

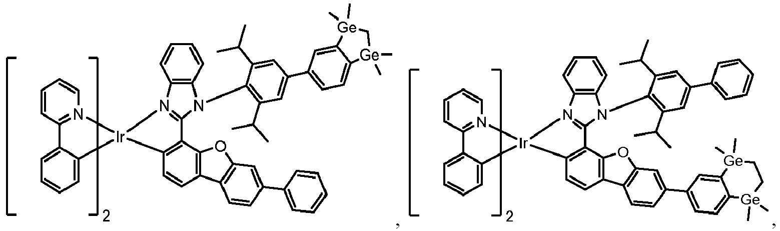

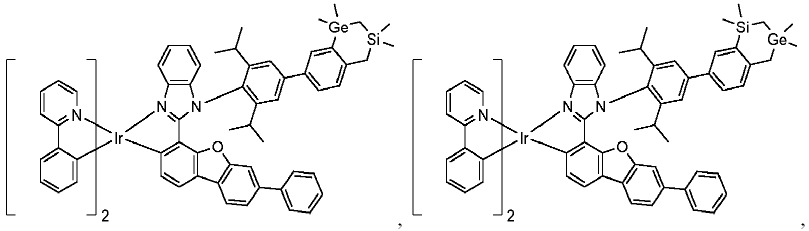

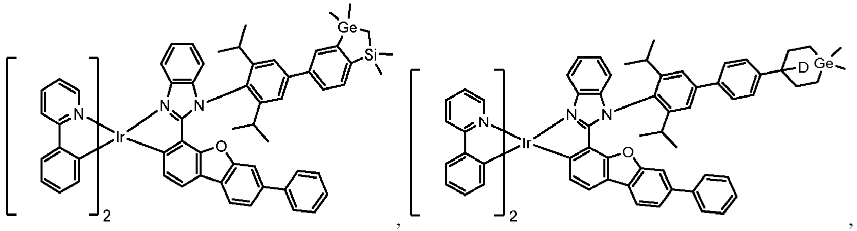

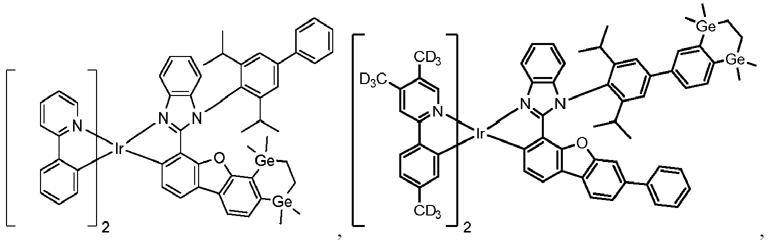

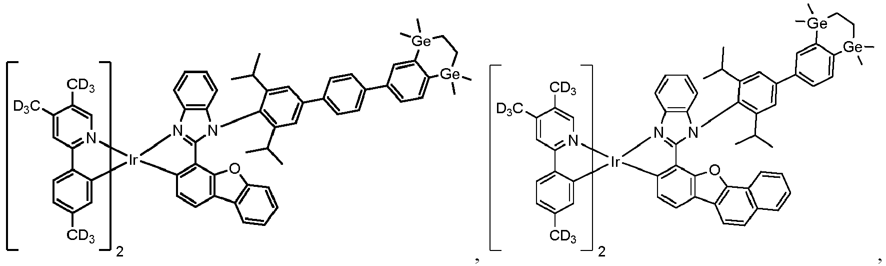

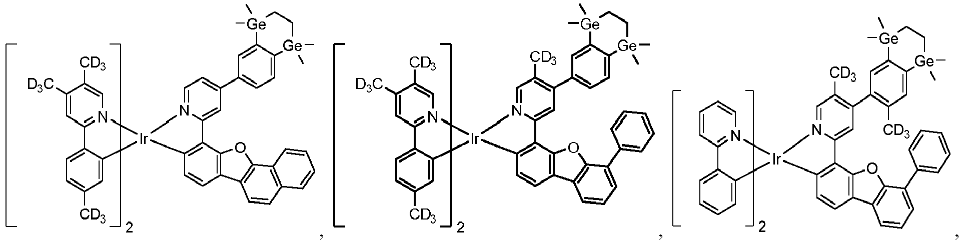

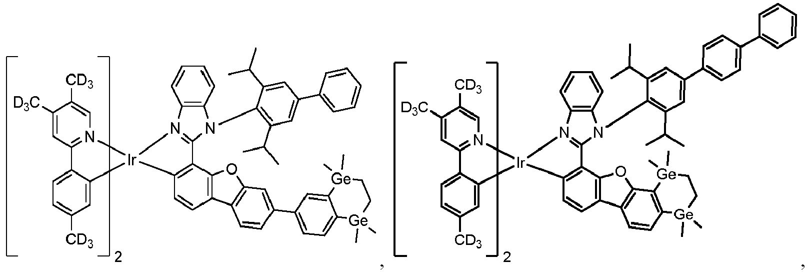

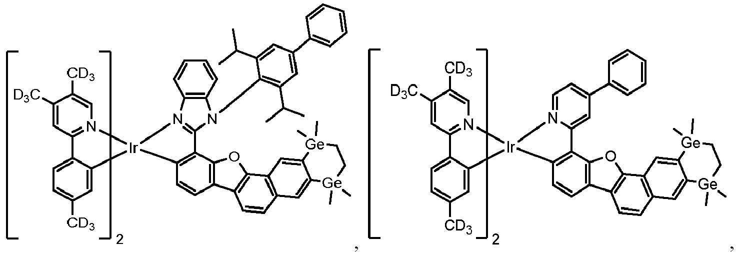

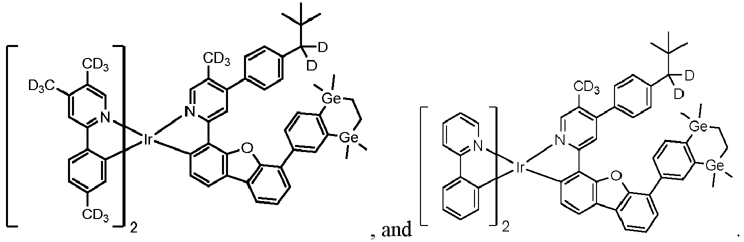

In some embodiments, the compound has a structure of Formula III, 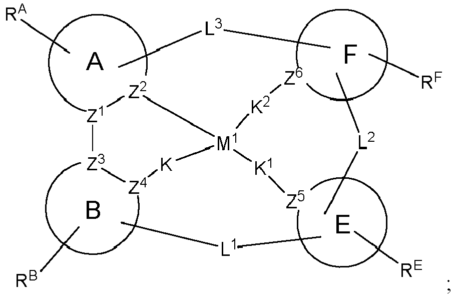 wherein:
M¹ is Pd or Pt;
moieties E and F are each independently monocyclic or polycyclic ring structure comprising 5-membered and/or 6-membered carbocyclic or heterocyclic rings;
Z⁵ and Z⁶ are each independently C or N;
K¹ and K² are each independently selected from the group consisting of a direct bond, O, and S, wherein at least two of them are direct bonds;
L¹, L², and L³ are each independently selected from the group consisting of a direct bond, BR, BRR', NR, PR, P(O)R, O, S, Se, C=O, C=S, C=Se, C=NR, C= CRR', S=O, SO₂, CR, CRR', SiRR', GeRR', alkylene, cycloalkyl, aryl, cycloalkylene, arylene, heteroarylene, and combinations thereof, wherein at least one of L¹ and L² is present;
R^{E} and R^{F} each independently represents zero, mono, or up to a maximum allowed number of substitutions to its associated ring;
each of R, R', R^{E}, and R^{F} is independently a hydrogen or a substituent selected from the group consisting of the Preferred General Substituents defined herein; and
any two R R', R^{A}, R^{B}, R^{C}, R^{E}, and R^{F} can be joined or fused together to form a ring where chemically feasible.

In some embodiments of Formula III, moiety E and moiety F are both 6-membered aromatic rings.

In some embodiments of Formula III, moiety F is a 5-membered or 6-membered heteroaromatic ring.

In some embodiments of Formula III, L¹ is O or CRR'.

In some embodiments of Formula III, Z⁶ is N and Z⁵ is C. In some embodiments of Formula III, Z⁶ is C and Z⁵ is N.

In some embodiments of Formula III, L² is a direct bond. In some embodiments of Formula III, L² is NR.

In some embodiments of Formula III, K, K¹, and K² are all direct bonds. In some embodiments of Formula II, one of K, K¹, and K² is O.

In some embodiments of Formula III, the compound is selected from the group consisting of the following structures: 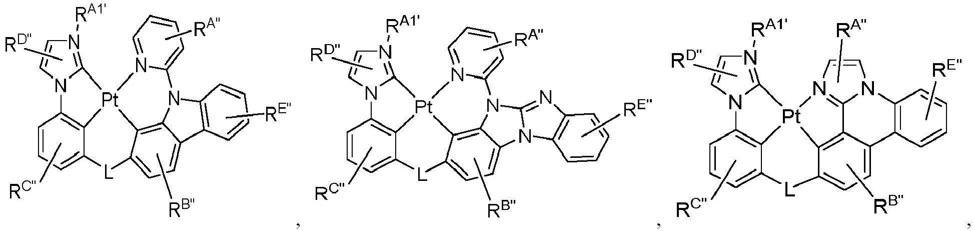 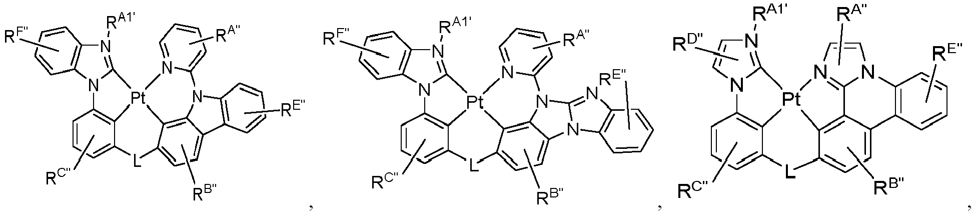 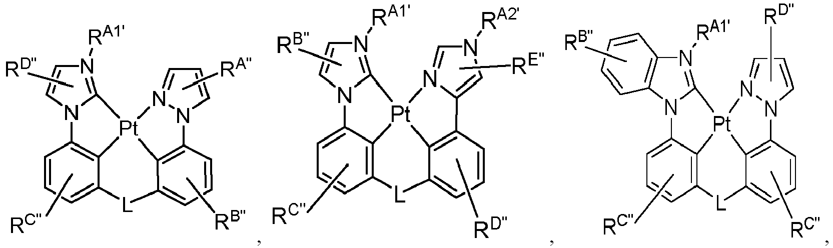 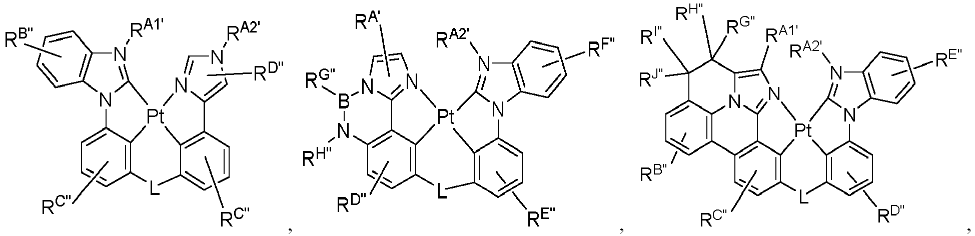 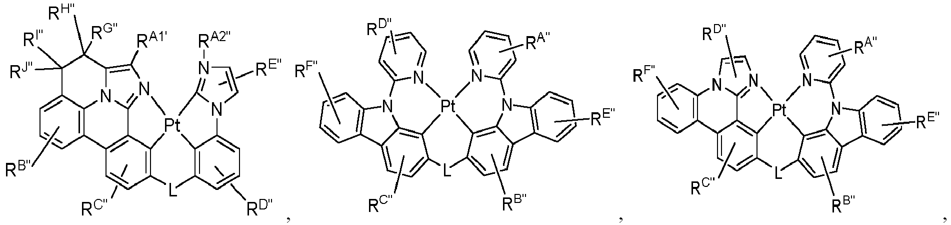 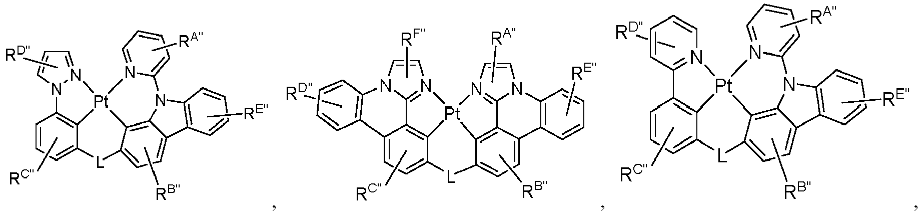 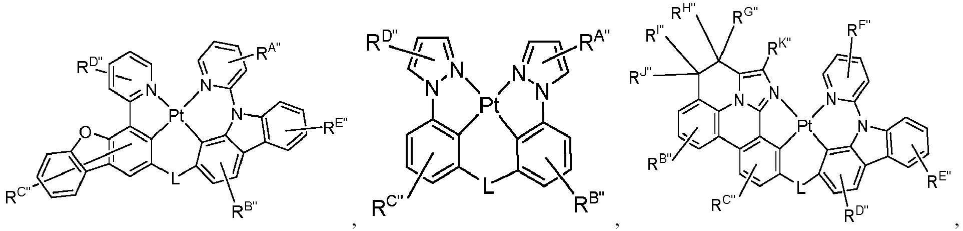 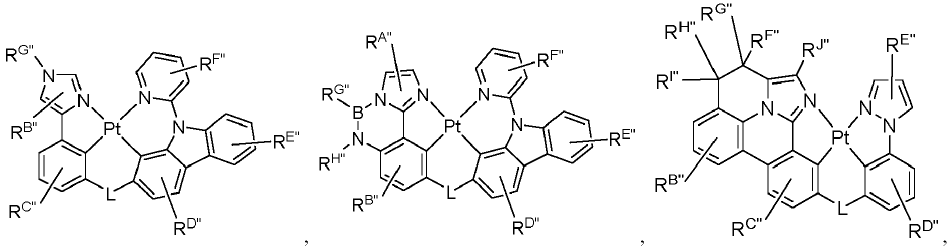 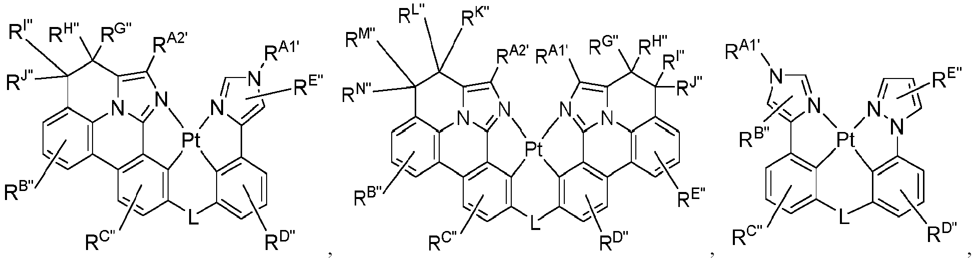 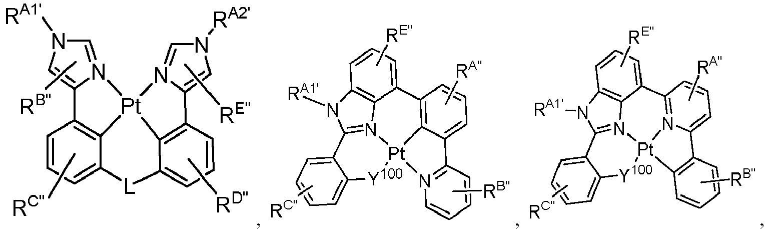 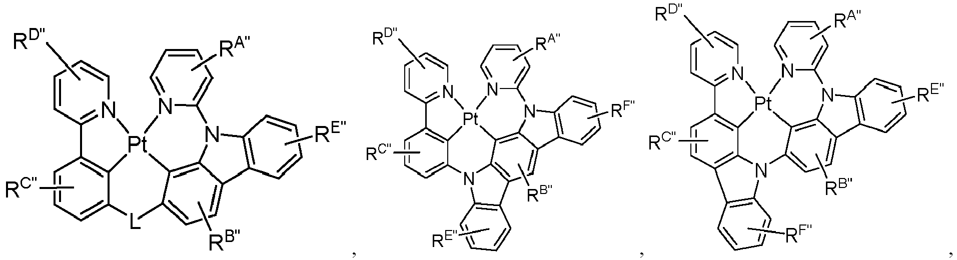 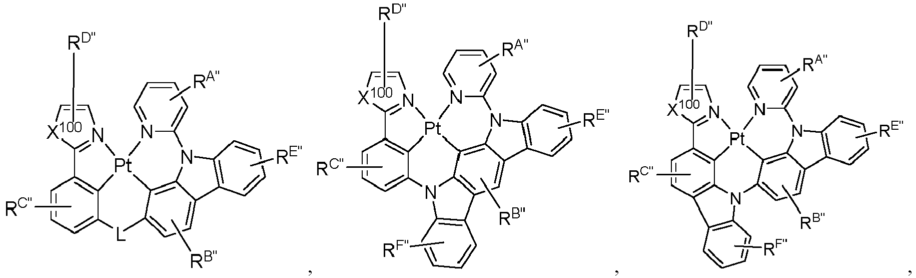 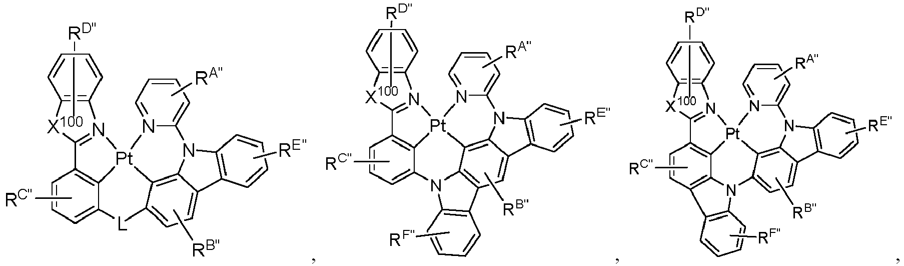 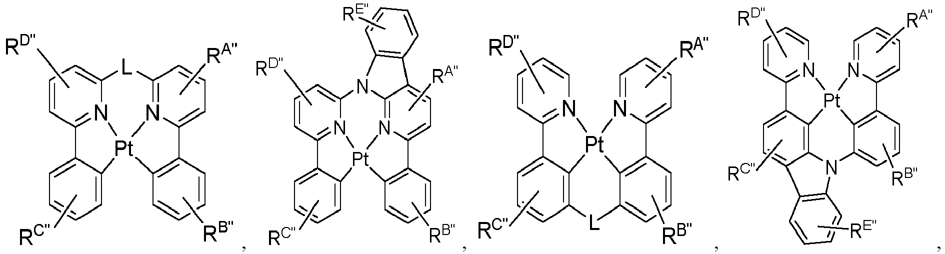 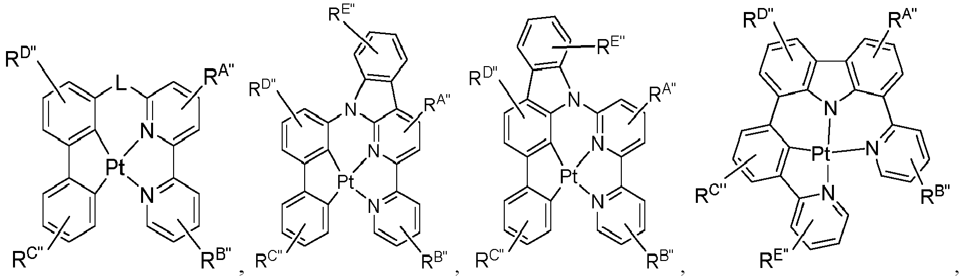 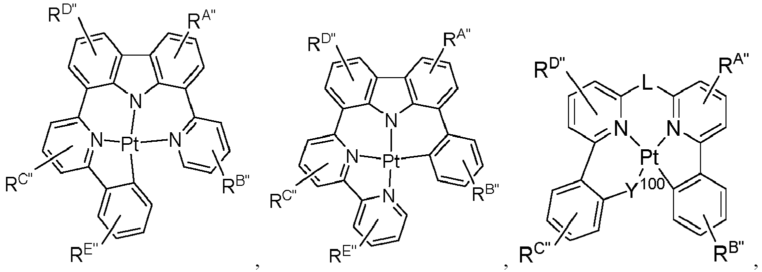 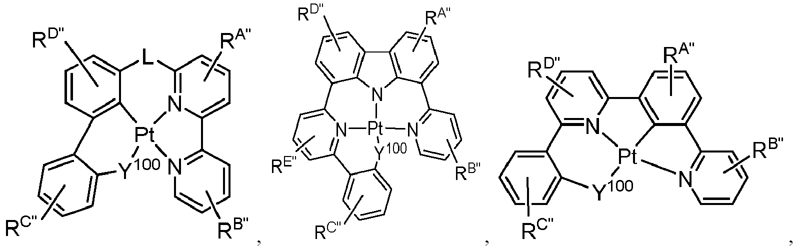 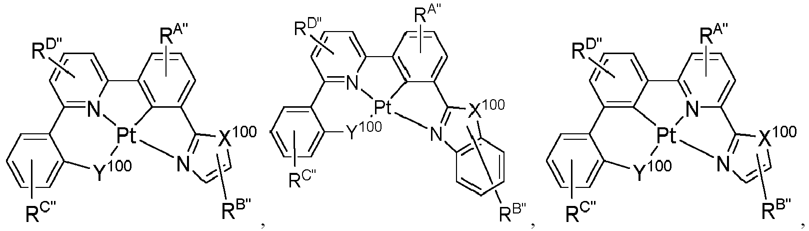 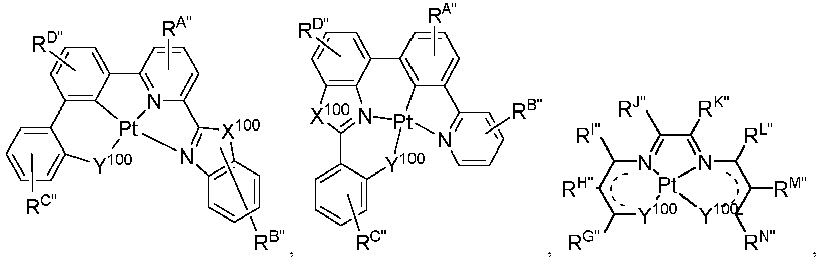 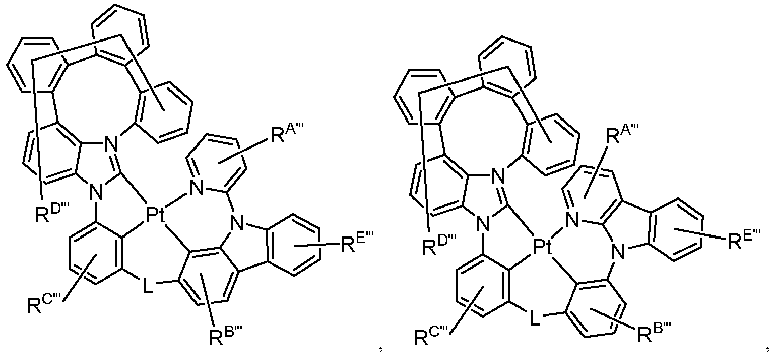 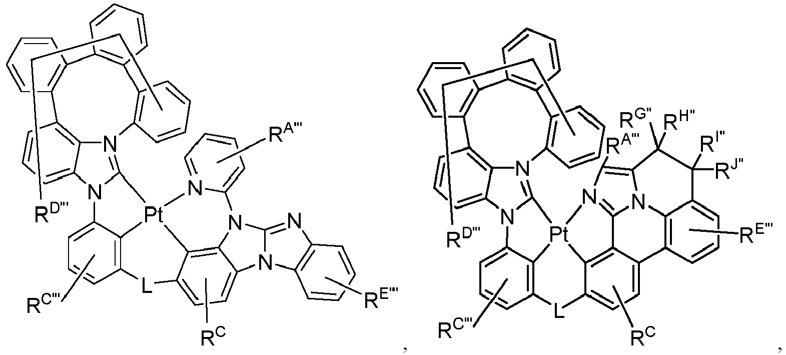 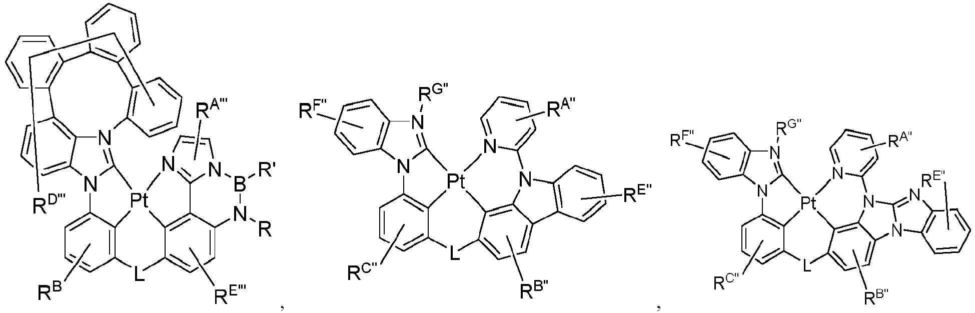 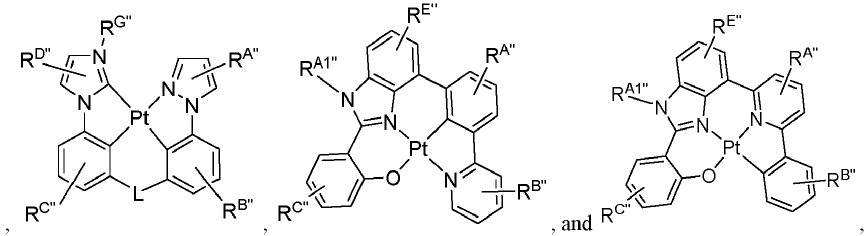 wherein:
each Y¹⁰⁰ is independently selected from the group consisting of a NR", O, S, and Se;
L is independently selected from the group consisting of a direct bond, BR", BR"R‴, NR", PR", O, S, Se, C=O, C=S, C=Se, C=NR", C=CR"R‴, S=O, SO₂, CR", CR"R‴, SiR"R‴, GeR"R‴, alkyl, cycloalkyl, aryl, heteroaryl, and combinations thereof;
X¹⁰⁰ for each occurrence is selected from the group consisting of O, S, Se, NR", and CR"R‴;
each R^{A"}, R^{B"}, R^{C"}, R^{D"}, R^{E"}, and R^{F"} independently represents mono-, up to the maximum substitutions, or no substitutions;
each of R, R', R", R‴, R^{A1'}, R^{A2'}, R^{A"}, R^{B"}, R^{C"}, R^{D"}, R^{E"}, R^{F"}, R^{G"}, R^{H"}, R^{I"}, R^{J"}, R^{K"}, R^{L"}, R^{M"}, and R^{N"} is independently a hydrogen or a substituent selected from the group consisting of deuterium, halogen, alkyl, cycloalkyl, heteroalkyl, heterocycloalkyl, boryl, arylalkyl, alkoxy, aryloxy, amino, silyl, germyl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, selenyl, and combinations thereof; and at least one of R, R', R", R‴, R^{A1'}, R^{A2'}, R^{A"}, R^{B"}, R^{C"}, R^{D"}, R^{E"}, R^{F"}, R^{G"}, R^{H"}, R^{I"}, R^{J"}, R^{K"}, R^{L"}, R^{M"}, and R^{N"} comprises a germyl group.

In some embodiments, the compound may have the formula IV; 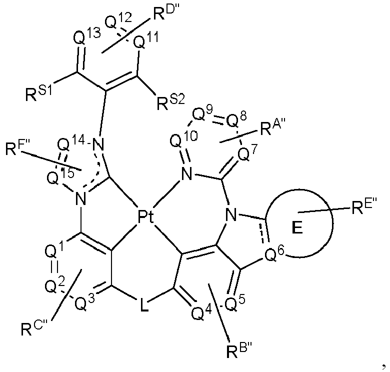
Ring E is a 5-membered or 6-membered carbocyclic or heterocyclic ring;
Q¹ to Q¹⁵ is C or N;
L is independently selected from the group consisting of a direct bond, BR", BR"R‴, NR", PR", O, S, Se, C=O, C=S, C=Se, C=NR", C=CR"R‴, S=O, SO₂, CR", CR"R‴, SiR"R‴, GeR"R‴, alkyl, cycloalkyl, aryl, heteroaryl, and combinations thereof;
each R^{A"}, R^{B"}, R^{C"}, R^{D"}, R^{E"}, and R^{F"} independently represents mono-, up to the maximum substitutions, or no substitutions;
each of R", R‴, R^{A"}, R^{B"}, R^{C"}, R^{D"}, R^{E"}, R^{F"}, R^{S1}, and R^{S2} is independently a hydrogen or a substituent selected from the group consisting of deuterium, halogen, alkyl, cycloalkyl, heteroalkyl, heterocycloalkyl, boryl, arylalkyl, alkoxy, aryloxy, amino, silyl, germyl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, selenyl, and combinations thereof; and at least one of R", R‴, R^{A1'}, R^{A2'}, R^{A"}, R^{B"}, R^{C"}, R^{D"}, R^{E"}, R^{F"}, R^{S1}, and R^{S2} comprises a germyl group;
any two R", R‴, R^{A"}, R^{B"}, R^{C"}, R^{D"}, R^{E"}, R^{F"}, R^{S1}, and R^{S2} can be joined or fused together to form a ring where chemically feasible.

In some embodiments, at least one of the following eleven conditions is true;
1. R^{S1} comprises a germyl group.
2. R^{S1} and R^{S2} are different.
3. R^{S1} and R^{S2} each comprise a substituent selected from the group consisting of deuterium, halogen, alkyl, cycloalkyl, heteroalkyl, heterocycloalkyl, boryl, arylalkyl, alkoxy, aryloxy, amino, silyl, germyl, alkenyl, cycloalkenyl, heteroalkenyl, alkynyl, heteroaryl, acyl, carboxylic acid, ether, ester, nitrile, isonitrile, sulfanyl, sulfinyl, sulfonyl, phosphino, selenyl, and combinations thereof.
4. At least one of Q¹ to Q¹⁵ is N.
5. Ring E is a heterocyclic ring.
6. Q¹² is C and R^{D"} is a non hydrogen substitutent substituted at Q¹².
7. At least one of R^{S1} and R^{S2} is a substituted phenyl ring.
8. At least one of R^{D"} is a substituted phenyl ring.
9. L is selected from the group consisting of BR", BR"R‴, PR", NR", S, Se, C=O, C=S, C=Se, C=NR", C=CR"R‴, S=O, SO₂, CR", CR"R‴, SiR"R‴, GeR"R‴, alkyl, cycloalkyl, aryl, heteroaryl, and combinations thereof.
10. At least two of R", R‴, R^{A"}, R^{B"}, R^{C"}, R^{D"}, R^{E"}, R^{F"}, R^{S1}, and R^{S2} are joined or fused together to form a ring, with the proviso that if two R^{F"} are joining to form a benzene ring, then at least two additional of R", R‴, R^{A"}, R^{B"}, R^{C"}, R^{D"}, R^{E"}, R^{F"}, R^{S1}, and R^{S2} are joined or fused together to form a ring.
11. one or more combinations of 1 to 10.

In some embodiments, at least one of R^{S1} and R^{S2} is joined with R^{F"} to form a ring.

In some embodiments, two R^{F"} are joined to form a 5 to 12-membered ring.

In some embodiments, two R^{F"} are joined to form a 6-memebered ring.

In some embodiments, R^{S1} and R^{S2} are each a substituted or unsubstituted 5-membered or 6-membered ring.

In some embodiments, R^{S1} and R^{S2} are each a substituted or unsubstituted phenyl ring.

In some embodiments, R^{S1} and R^{S2} are each independently a substituted phenyl ring.

In some embodiments, R^{S1} and R^{S2} are each a phenyl ring substituted with a a substituent selected from the group consisting of deuterium, alkyl, cycloalkyl, heteroalkyl, heterocycloalkyl, arylalkyl, silyl, germyl, aryl, heteroaryl, nitrile, and combinations thereof.

In some embodiments, at least one of R^{S1} and R^{S2} is an alkyl group

In some embodiments, at least one of R^{S1} and R^{S2} is selected from fully or partially deuterated alkyl, fully or partially deuterated cycloalkyl, fully or partially deuterated aryl, silyl, tert-butyl, and combinations thereof.

In some embodiments, Q¹² is C and substituted with R^{D"} selected from the group consisting of deuterium, alky, aryl, silyl, germyl, and combinations thereof.

In some embodiments, ring E is an imidazole ring

In some embodiments, two R^{E"} are joined to form a ring.

In some embodiments of Formula III, the compound is selected from the group consisting of the structures of the following LIST 13: 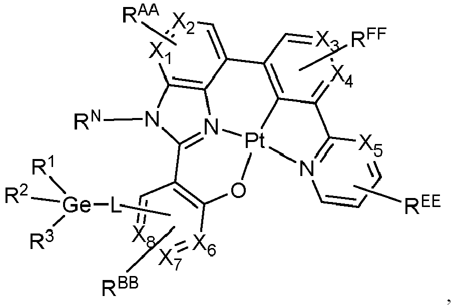 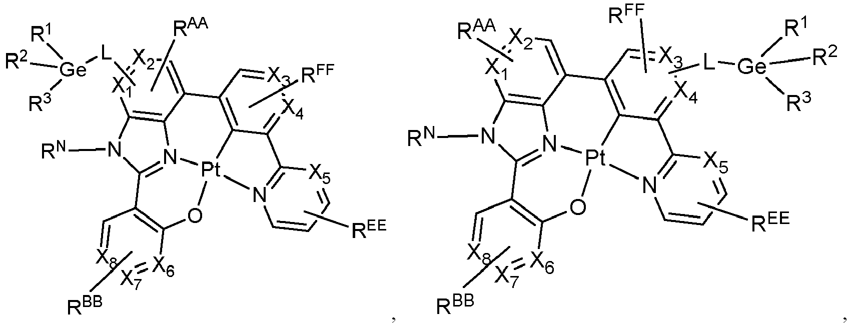 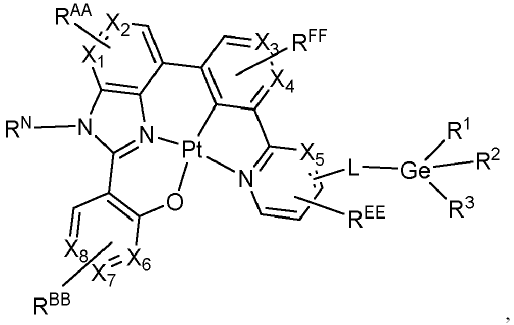 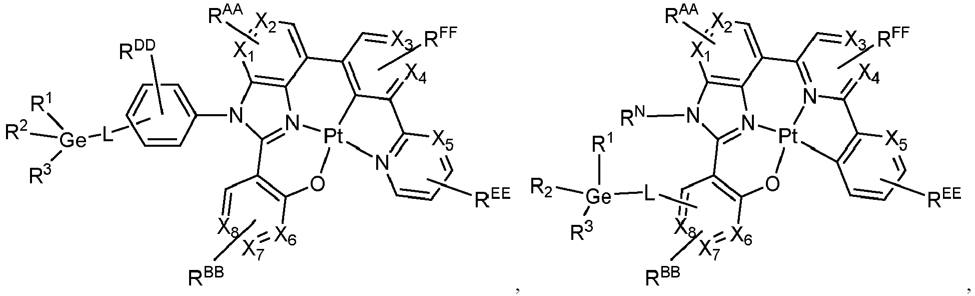 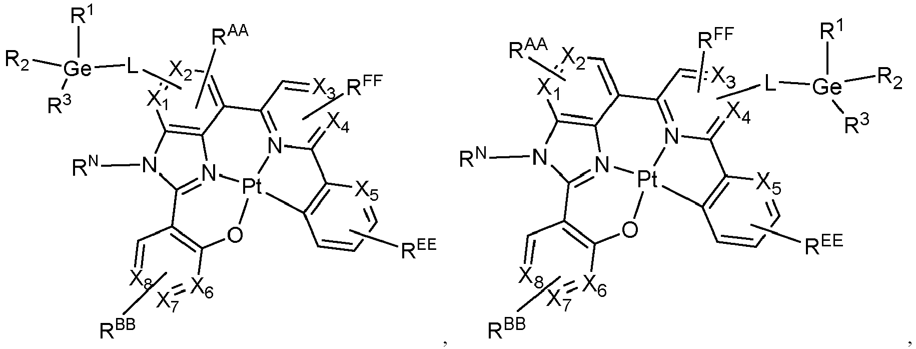 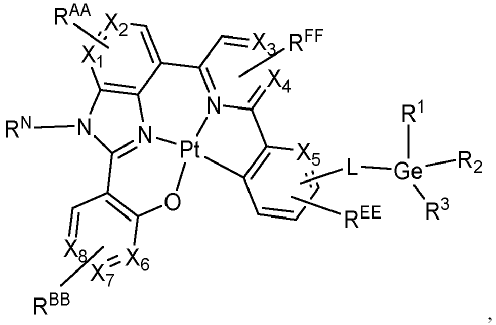 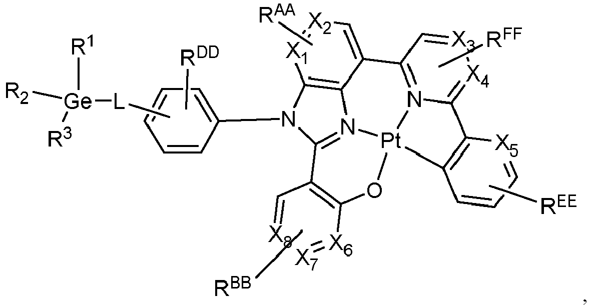 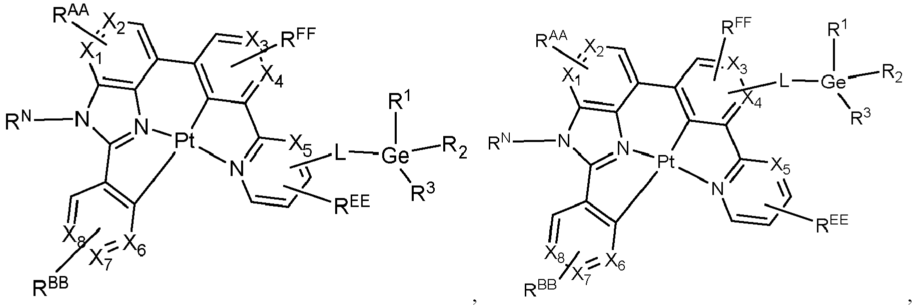 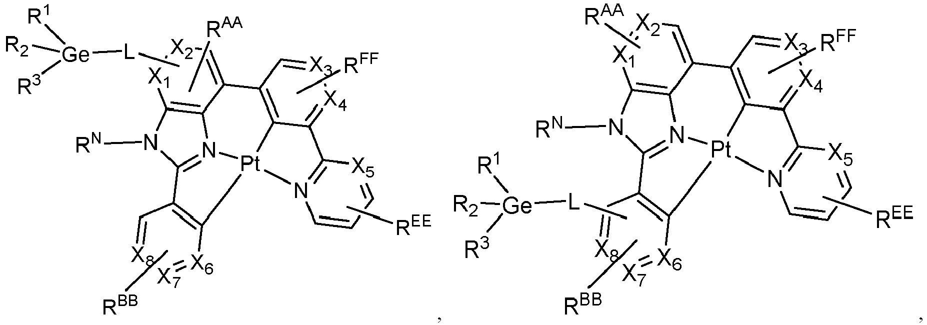 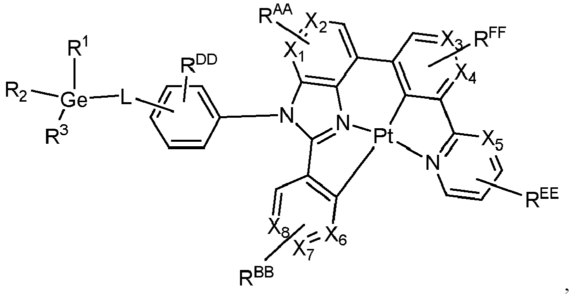 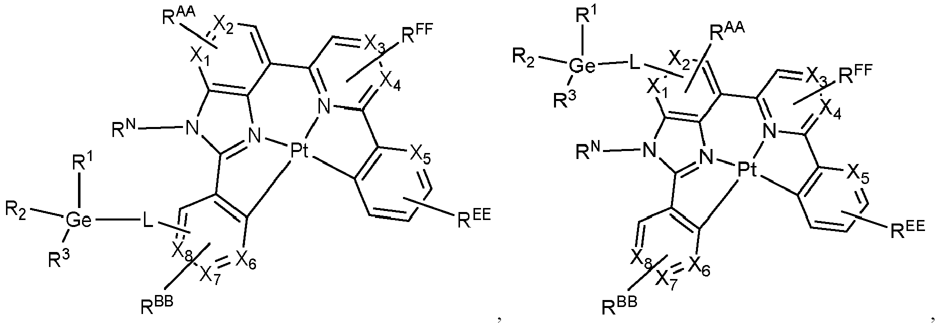 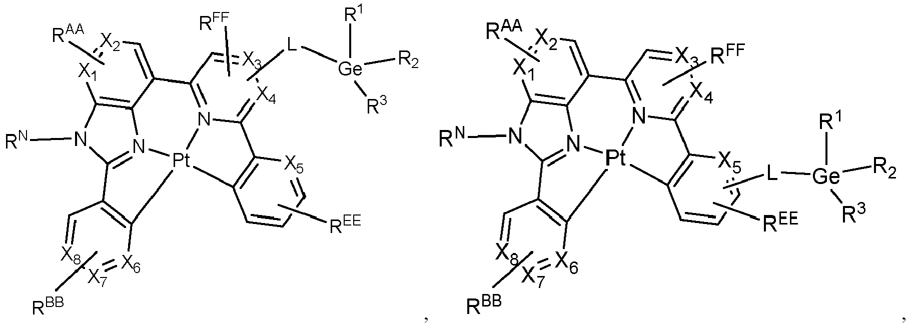 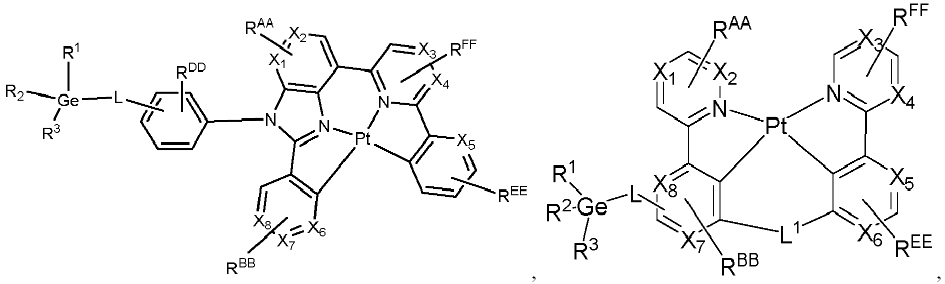 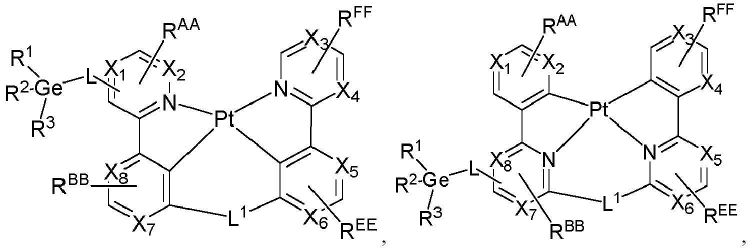 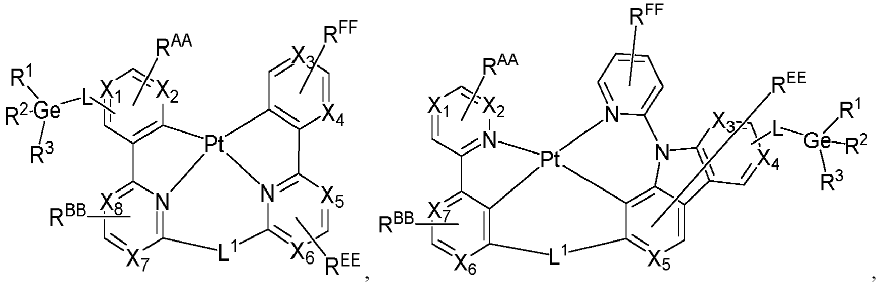 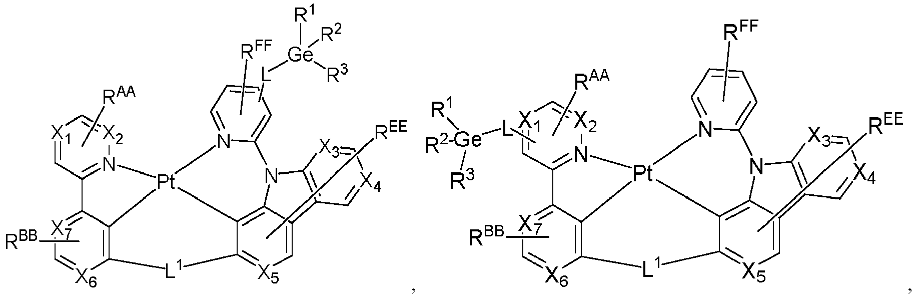 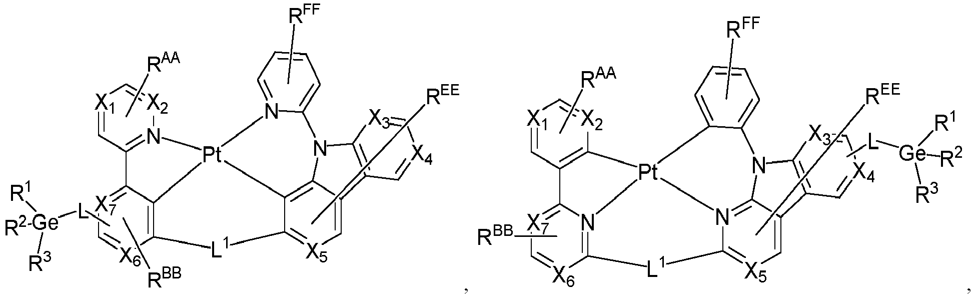 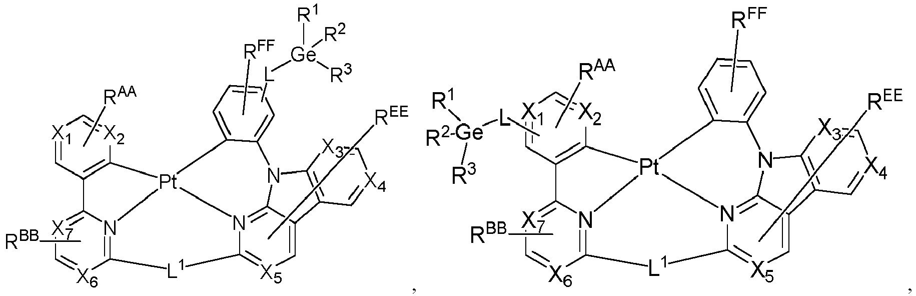 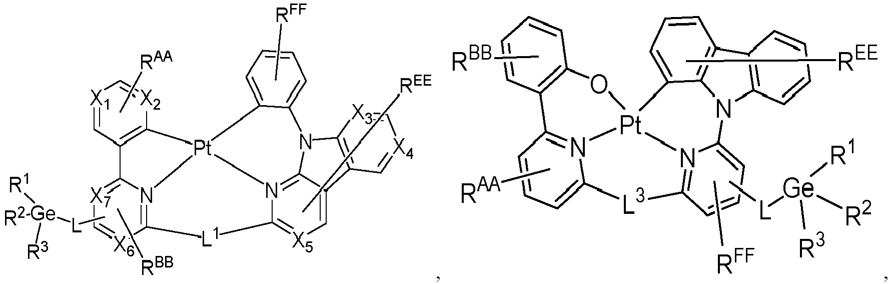 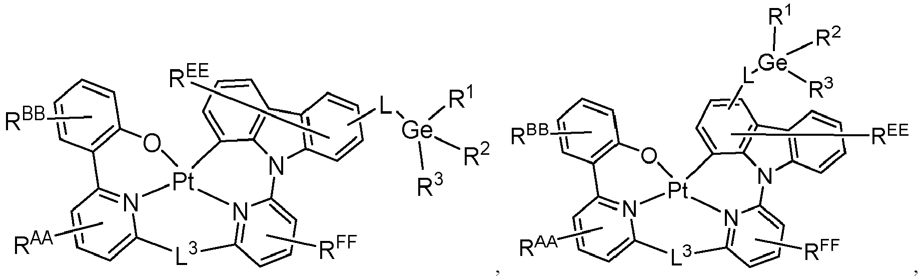 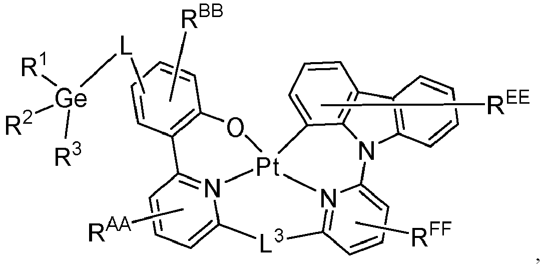 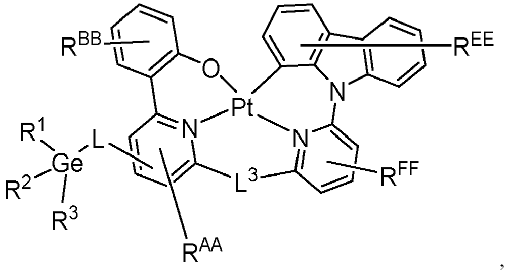 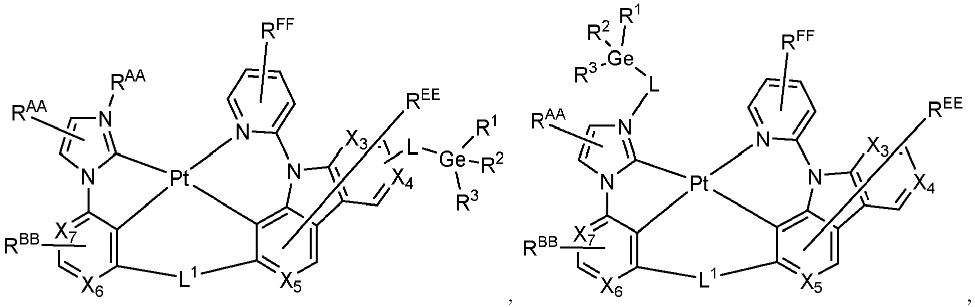 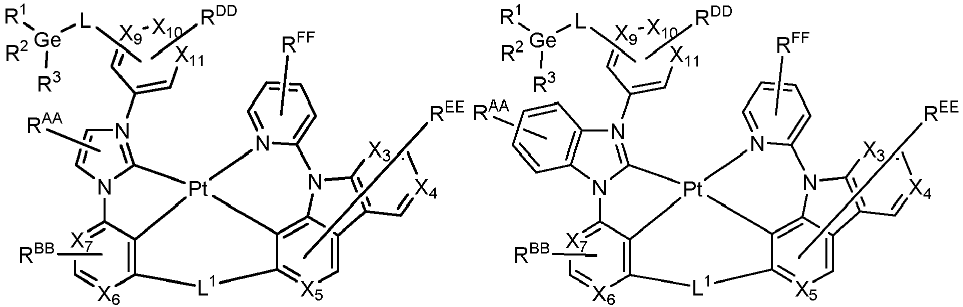 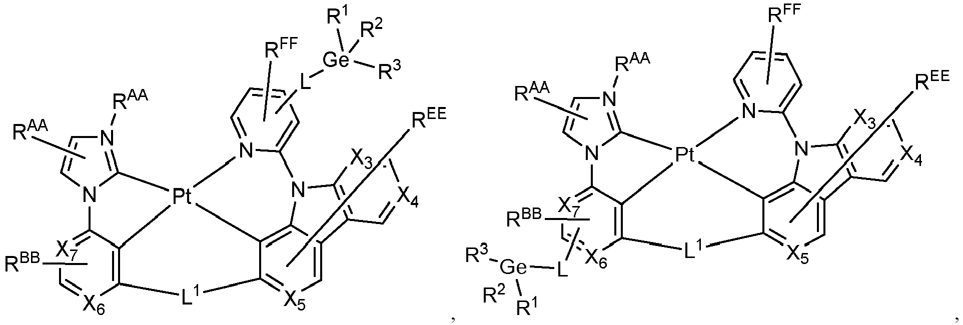 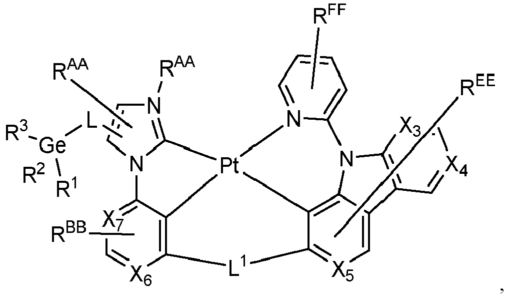 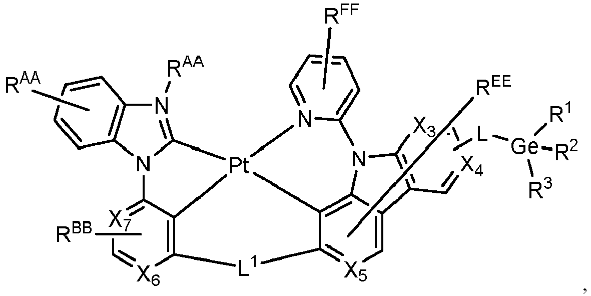 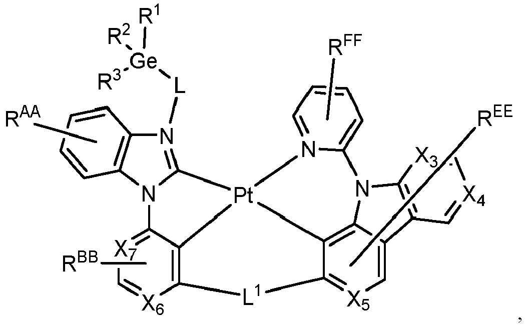 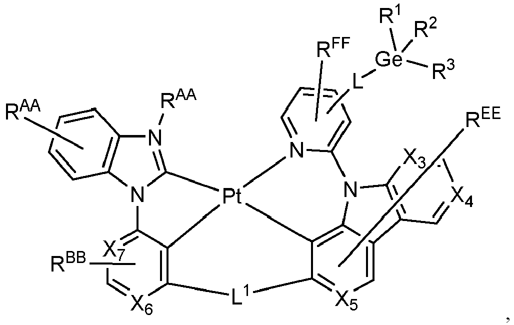 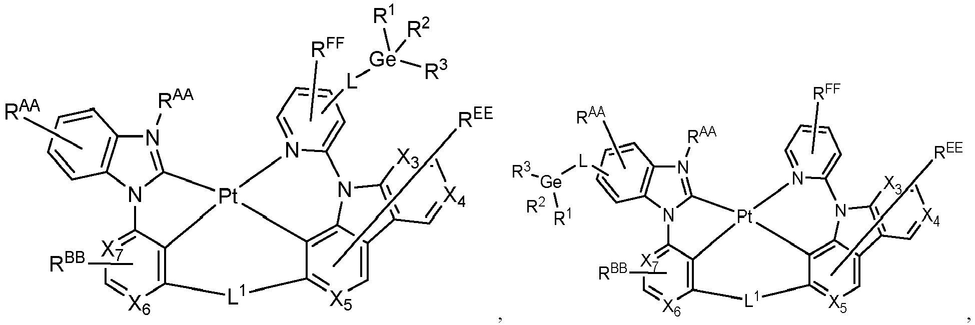 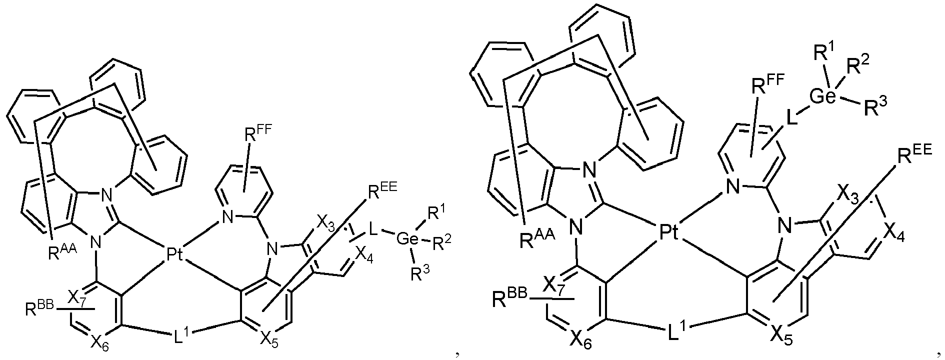 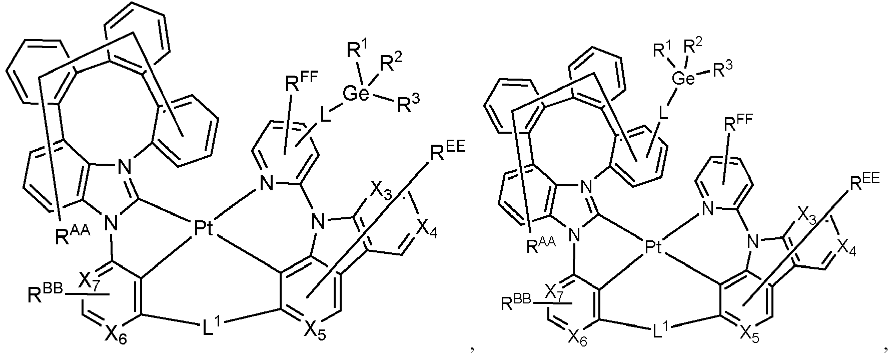 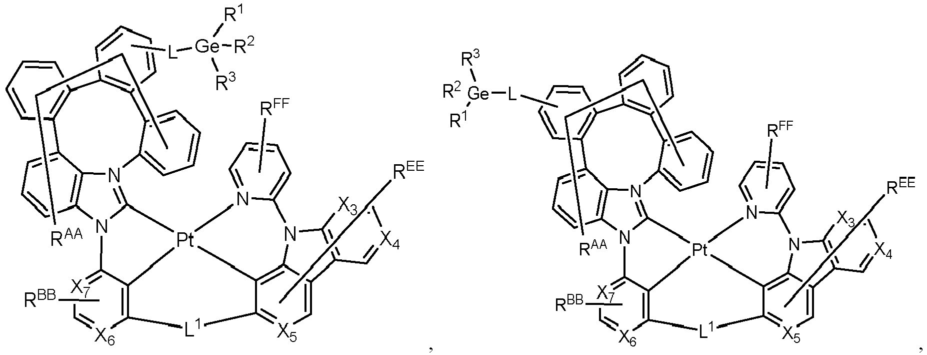 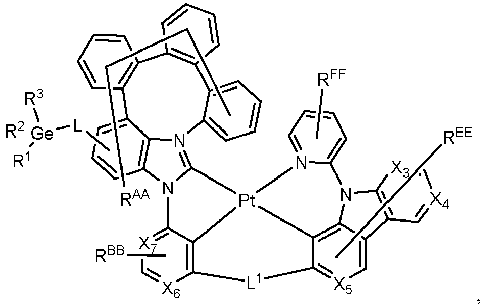 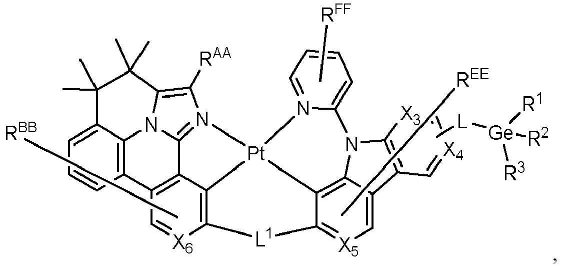 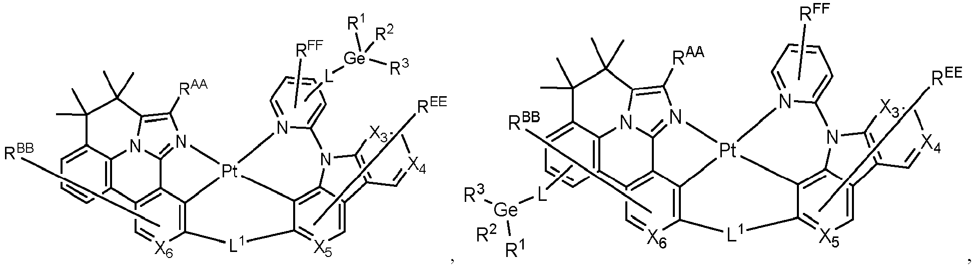 and 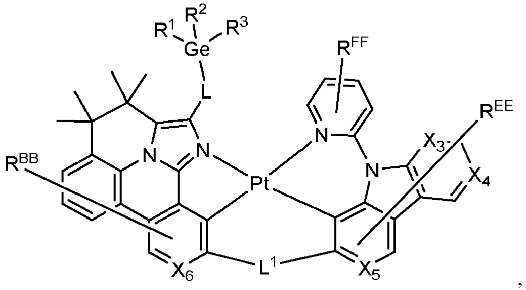
wherein R^{AA}, R^{BB}, R^{DD}, R^{EE}, and R^{FF} are each independently represent mono to the maximum allowable substitution, or no substitution;
X₁, X₂, X₃, X₄, X₅, X₆, X₇, and X₈ are each independently C or N;
each R^{N}, R^{AA}, R^{BB}, R^{DD}, R^{EE}, and R^{FF} is independently a hydrogen or a substituent selected from the group consisting of the General Substituents defined herein; and
any two substituents can be joined or fused to form a ring.

In some embodiments, the compound is selected from the group consisting of the compounds defined in the following LIST 14:

| | Structure of Pt_{A} |
|---|---|
| Pt1-(R*o*)(R*q*)(R*r*)(R*s*)(R*t*)(T*w*), wherein Pt1-(R1)(R1)(R1)(R1)(R1)(T1) to Pt1-(R86)(R86)(R86)(R86)(R86)(T10), have the structure | 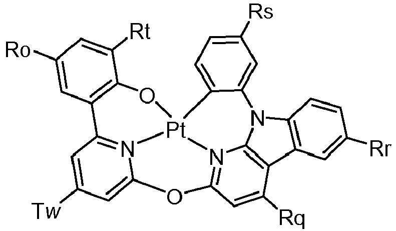 |
| Pt2-(R*o*)(R*p*)(R*q*)(R*r*)(R*t*)(T*w*), wherein Pt2-(R1)(R1)(R1)(R1)(R1)(T1) to Pt2-(R86)(R86)(R86)(R86)(R86)(T10), have the structure | 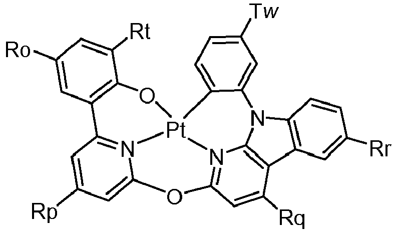 |
| Pt3-(R*o*)(R*p*)(R*q*)(R*s*)(R*t*)(T*w*), wherein Pt3-(R1)(R1)(R1)(R1)(R1)(T1) to Pt3-(R86)(R86)(R86)(R86)(R86)(T10), have the structure | 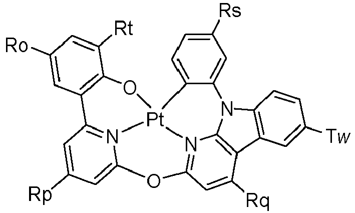 |
| Pt4-(R*o*)(R*p*)(R*q*)(R*s*)(R*t*)(T*w*), wherein Pt4-(R1)(R1)(R1)(R1)(R1)(T1) to Pt4-(R86)(R86)(R86)(R86)(R86)(T10), have the structure | 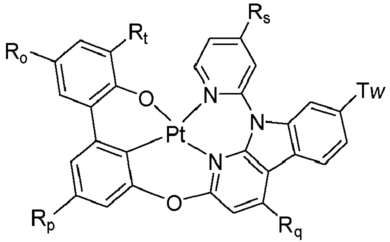 |
| Pt5-(R*o*)(R*p*)(R*q*)(R*r*)(R*t*)(T*w*), wherein Pt5-(R1)(R1)(R1)(R1)(R1)(T1) to Pt5-(R86)(R86)(R86)(R86)(R86)(T10), have the structure | 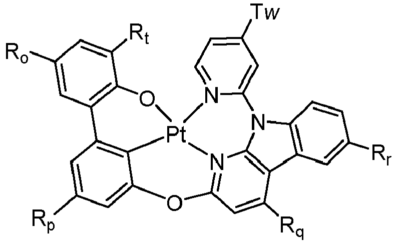 |
| Pt6-(R*o*)(R*q*)(R*r*)(R*s*)(R*t*)(T*w*), wherein Pt6-(R1)(R1)(R1)(R1)(R1)(T1) to Pt6-(R86)(R86)(R86)(R86)(R86)(T10), have the structure | 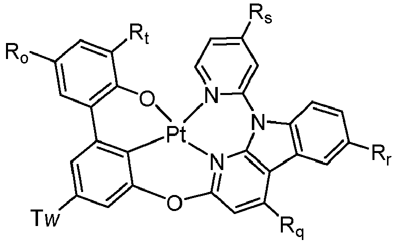 |
| Pt7-(R*o*)(R*p*)(R*q*)(R*r*)(R*s*)(R*t*)(T*w*), wherein Pt7-(R1)(R1)(R1)(R1)(R1)(R1)(T1) to Pt7-(R86)(R86)(R86)(R86)(R86)(R86)(T10), have the structure | 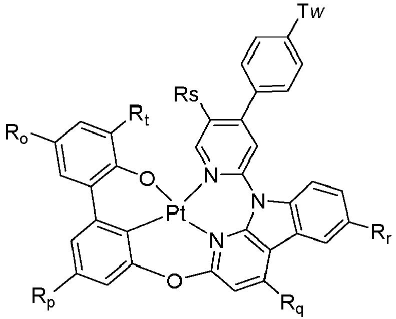 |
| Pt8-(R*o*)(R*p*)(R*q*)(R*r*)(R*t*)(T*w*), wherein Pt8-(R1)(R1)(R1)(R1)(R1)(T1) to Pt8-(R86)(R86)(R86)(R86)(R86)(T10), have the structure | 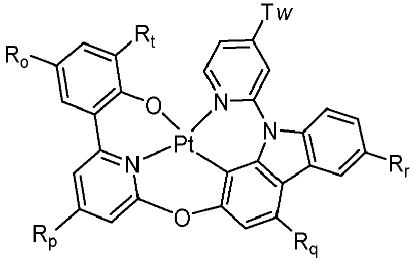 |
| Pt9-(R*o*)(R*p*)(R*q*)(R*s*)(R*t*)(T*w*), wherein Pt9-(R1)(R1)(R1)(R1)(R1)(T1) to Pt9-(R86)(R86)(R86)(R86)(R86)(T10), have the structure | 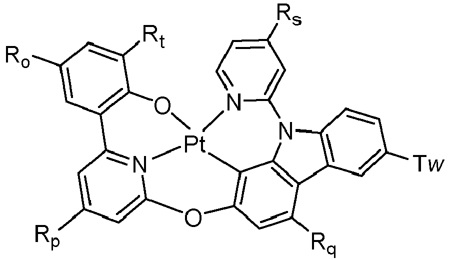 |
| Pt10-(R*o*)(R*q*)(R*r*)(R*s*)(R*t*)(T*w*), wherein Pt10-(R1)(R1)(R1)(R1)(R1)(T1) to Pt3-(R86)(R86)(R86)(R86)(R86)(T10), have the structure | 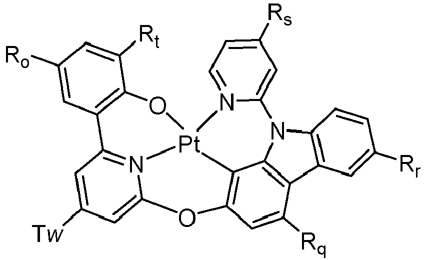 |
| Pt11-(R*o*)(R*p*)(R*q*)(R*s*)(R*t*)(T*w*), wherein Pt11-(R1)(R1)(R1)(R1)(R1)(T1) to Pt11-(R86)(R86)(R86)(R86)(R86)(T10), have the structure | 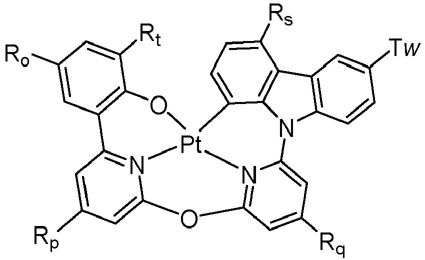 |
| Pt12-(R*o*)(R*p*)(R*r*)(R*s*)(R*t*)(T*w*), wherein Pt12-(R1)(R1)(R1)(R1)(R1)(T1) to Pt3-(R86)(R86)(R86)(R86)(R86)(T10), have the structure | 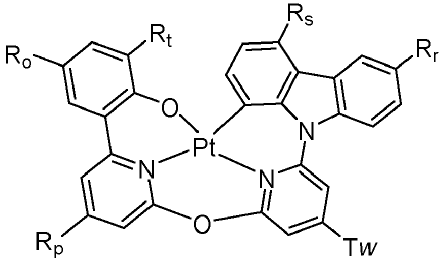 |
| Pt13-(R*o*)(R*q*)(R*r*)(R*s*)(R*t*)(T*w*), wherein Pt13-(R1)(R1)(R1)(R1)(R1)(T1) to Pt13-(R86)(R86)(R86)(R86)(R86)(T10), have the structure | 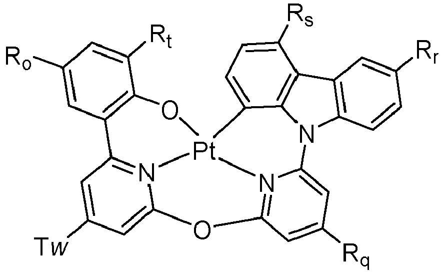 |
| Pt14-(R*o*)(R*p*)(R*q*)(R*s*)(R*t*)(T*w*), wherein Pt14-(R1)(R1)(R1)(R1)(R1)(T1) to Pt14-(R86)(R86)(R86)(R86)(R86)(T10), have the structure | 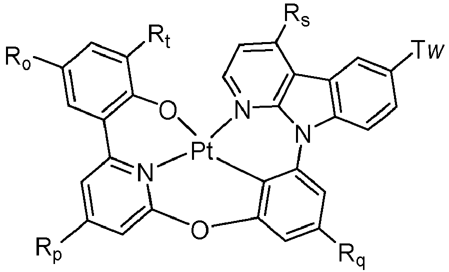 |
| Pt15-(R*o*)(R*p*)(R*r*)(R*s*)(R*t*)(T*w*), wherein Pt15-(R1)(R1)(R1)(R1)(R1)(T1) to Pt15-(R86)(R86)(R86)(R86)(R86)(T10), have the structure | 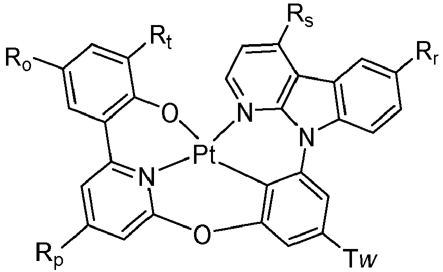 |
| Pt16-(R*o*)(R*p*)(R*r*)(R*s*)(R*t*)(R*u*)(T*w*), wherein Pt16-(R1)(R1)(R1)(R1)(R1)(R1)(T1) to Pt16-(R86)(R86)(R86)(R86)(R86)(R86)(T10), have the structure | 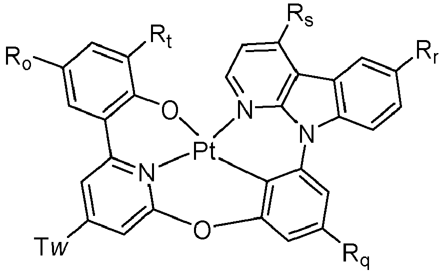 |
| Pt17-(R*o*)(R*p*)(R*q*)(R*r*)(R*t*)(R*u*)(T*w*), wherein Pt17-(R1)(R1)(R1)(R1)(R1)(R1)(T1) to Pt17-(R86)(R86)(R86)(R86)(R86)(R86)(T10), have the structure | 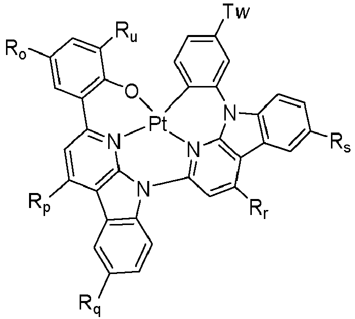 |
| Pt18-(R*o*)(R*p*)(R*q*)(R*r*)(R*s*)(R*u*)(T*w*), wherein Pt18-(R1)(R1)(R1)(R1)(R1)(R1)(T1) to Pt18-(R86)(R86)(R86)(R86)(R86)(R86)(T10), have the structure | 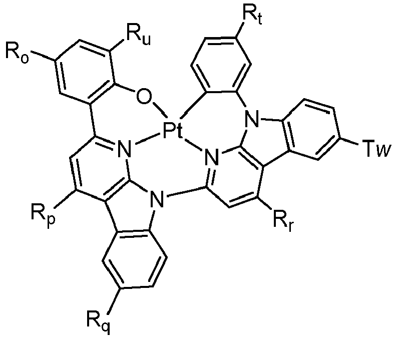 |
| Pt19-(R*o*)(R*p*)(R*r*)(R*s*)(R*t*)(R*u*)(T*w*), wherein Pt9-(R1)(R1)(R1)(R1)(R1)(R1)(R1)(T1) to Pt9-(R86)(R86)(R86)(R86)(R86)(R86)(R86)(T 10), have the structure | 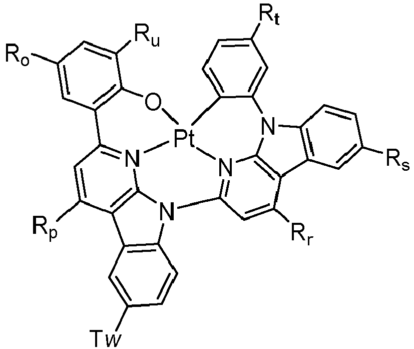 |
| Pt20-(R*o*)(R*p*)(R*q*)(R*r*)(R*s*)(R*u*)(T*w*), wherein Pt20-(R1)(R1)(R1)(R1)(R1)(R1)(T1) to Pt13-(R86)(R86)(R86)(R86)(R86)(R86)(T10), have the structure | 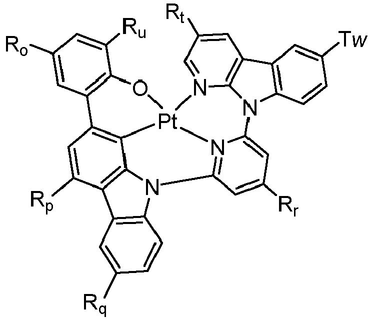 |
| Pt21-(R*o*)(R*p*)(R*q*)(R*r*)(R*t*)(R*u*)(T*w*), wherein Pt21-(R1)(R1)(R1)(R1)(R1)(R1)(R1)(T1) to Pt21-(R86)(R86)(R86)(R86)(R86)(R86)(T10), have the structure | 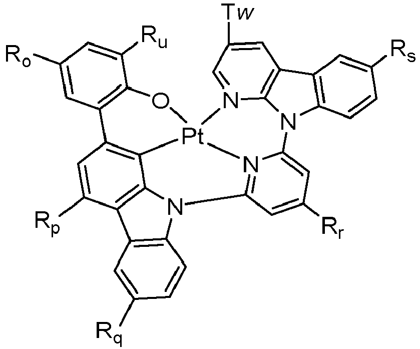 |
| Pt22-(R*o*)(R*q*)(R*r*)(R*s*)(R*t*)(R*u*)(T*w*), wherein Pt22-(R1)(R1)(R1)(R1)(R1)(R1)(T1) to Pt13-(R86)(R86)(R86)(R86)(R86)(R86)(T10), have the structure | 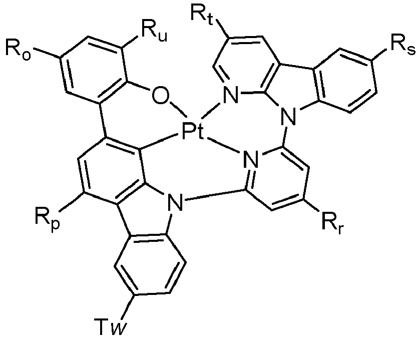 |
| Pt23-(R*o*)(R*p*)(R*q*)(R*r*)(R*s*)(R*u*)(T*w*), wherein Pt23-(R1)(R1)(R1)(R1)(R1)(R1)(T1) to Pt23-(R86)(R86)(R86)(R86)(R86)(R86)(T10), have the structure | 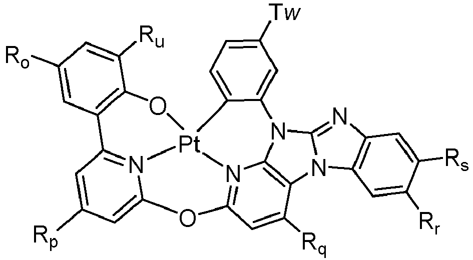 |
| Pt24-(R*o*)(R*p*)(R*q*)(R*r*)(R*t*)(R*u*)(T*w*), wherein Pt24-(R1)(R1)(R1)(R1)(R1)(R1)(R1)(T1) to Pt24-(R86)(R86)(R86)(R86)(R86)(R86)(T10), have the structure | 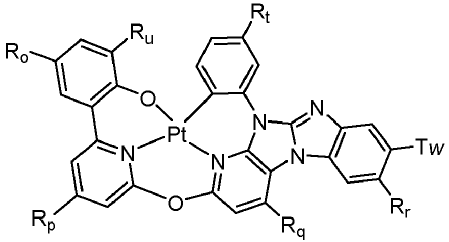 |
| Pt25-(R*o*)(R*q*)(R*r*)(R*s*)(R*t*)(R*u*)(T*w*), wherein Pt25-(R1)(R1)(R1)(R1)(R1)(R1)(T1) to Pt25-(R86)(R86)(R86)(R86)(R86)(R86)(T10), have the structure | 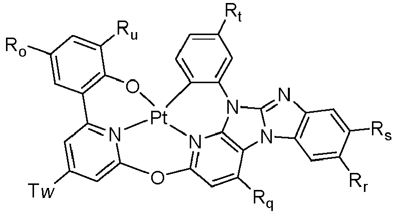 |
| Pt26-(R*o*)(R*p*)(R*q*)(R*r*)(R*t*)(R*u*)(T*w*), wherein Pt26-(R1)(R1)(R1)(R1)(R1)(R1)(T1) to Pt26-(R86)(R86)(R86)(R86)(R86)(R86)(T10), have the structure | 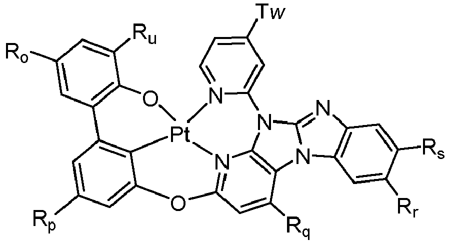 |
| Pt27-(R*o*)(R*p*)(R*r*)(R*s*)(R*t*)(R*u*)(T*w*), wherein Pt27-(R1)(R1)(R1)(R1)(R1)(R1)(T1) to Pt27-(R86)(R86)(R86)(R86)(R86)(R86)(T10), have the structure | 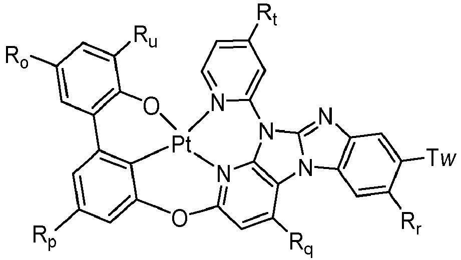 |
| Pt28-(R*o*)(R*q*)(R*r*)(R*s*)(R*t*)(R*u*)(T*w*), wherein Pt28-(R1)(R1)(R1)(R1)(R1)(R1)(T1) to Pt28-(R86)(R86)(R86)(R86)(R86)(R86)(T10), have the structure | 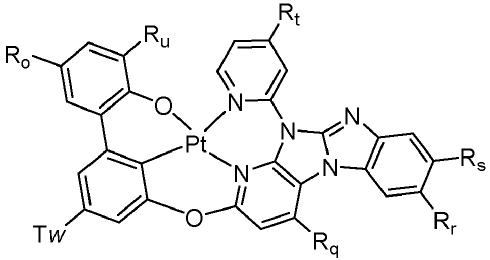 |
| Pt29-(R*o*)(R*q*)(R*r*)(R*s*)(R*t*)(R*u*)(R*v*)(T*w*), wherein Pt29-(R1)(R1)(R1)(R1)(R1)(R1)(R1)(T1) to Pt29-(R86)(R86)(R86)(R86)(R86)(R86)(R86)(T 10), have the structure | 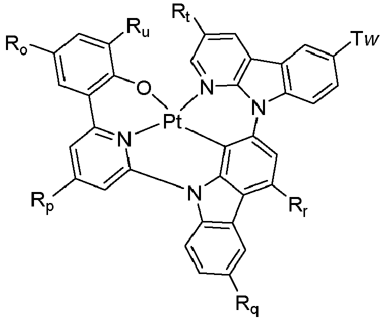 |
| Pt30-(R*o*)(R*p*)(R*q*)(R*r*)(R*s*)(R*u*)(R*v*)(T*w*), wherein Pt30-(R1)(R1)(R1)(R1)(R1)(R1)(R1)(T1) to Pt30-(R86)(R86)(R86)(R86)(R86)(R86)(R86)(T 10), have the structure | 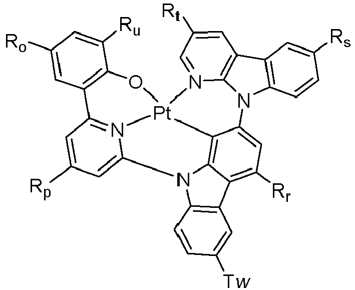 |
| Pt31-(R*o*)(R*p*)(R*q*)(R*r*)(R*s*)(R*t*)(R*v*)(T*w*), wherein Pt31-(R1)(R1)(R1)(R1)(R1)(R1)(R1)(T1) to Pt31-(R86)(R86)(R86)(R86)(R86)(R86)(R86)(T 10), have the structure | 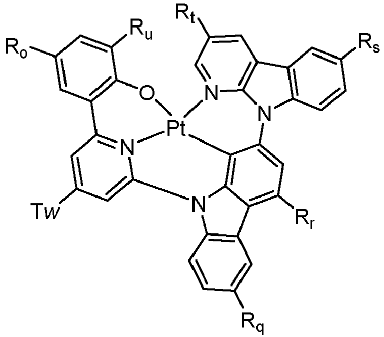 |
| Pt32-(R*o*)(R*p*)(R*q*)(R*r*)(R*s*)(R*u*)(R*v*)(T*w*), wherein Pt32-(R1)(R1)(R1)(R1)(R1)(R1)(R1)(T1) to Pt32-(R86)(R86)(R86)(R86)(R86)(R86)(R86)(T 10), have the structure | 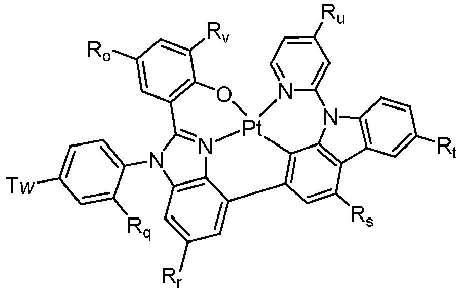 |
| Pt33-(R*o*)(R*p*)(R*q*)(R*r*)(R*t*)(R*u*)(R*v*)(T*w*), wherein Pt33-(R1)(R1)(R1)(R1)(R1)(R1)(R1)(T1) to Pt33-(R86)(R86)(R86)(R86)(R86)(R86)(R86)(T 10), have the structure | 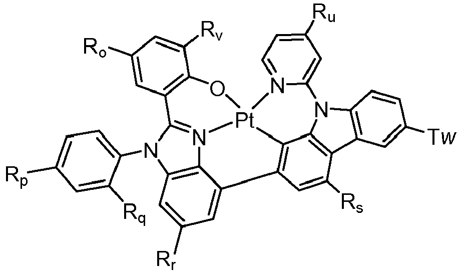 |
| Pt34-(R*o*)(R*q*)(R*r*)(R*s*)(R*t*)(R*u*)(R*v*)(T*w*), wherein Pt34-(R1)(R1)(R1)(R1)(R1)(R1)(R1)(T1) to Pt34-(R86)(R86)(R86)(R86)(R86)(R86)(R86)(T 10), have the structure | 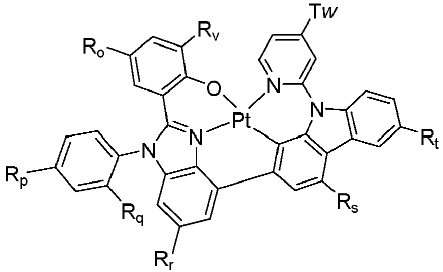 |
| Pt35-(R*p*)(R*q*)(R*r*)(R*s*)(R*t*)(R*u*)(R*v*)(T*w*), wherein Pt35-(R1)(R1)(R1)(R1)(R1)(R1)(R1)(T1) to Pt35-(R86)(R86)(R86)(R86)(R86)(R86)(R86)(T 10), have the structure | 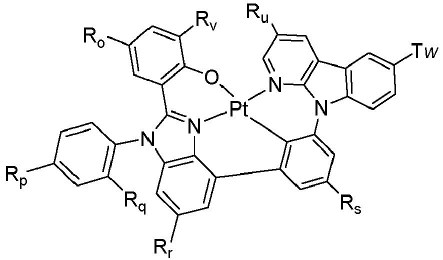 |
| Pt36-(R*o*)(R*p*)(R*r*)(R*s*)(R*t*)(R*u*)(R*v*)(T*w*), wherein Pt36-(R1)(R1)(R1)(R1)(R1)(R1)(R1)(T1) to Pt36-(R86)(R86)(R86)(R86)(R86)(R86)(R86)(T 10), have the structure | 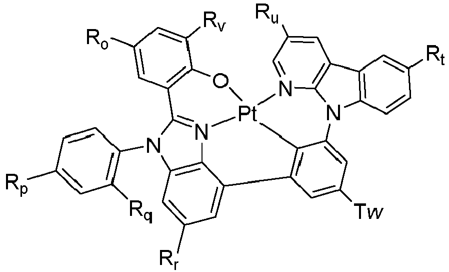 |
| Pt37-(R*o*)(R*q*)(R*q*)(R*r*)(R*t*)(R*u*)(R*v*)(T*w*), wherein Pt37-(R1)(R1)(R1)(R1)(R1)(R1)(R1)(T1) to Pt37-(R86)(R86)(R86)(R86)(R86)(R86)(R86)(T 10), have the structure | 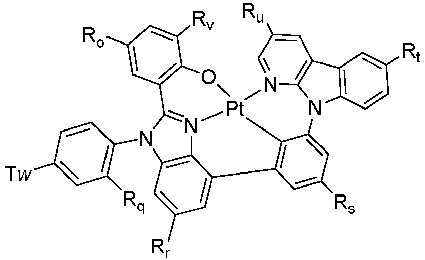 |
| Pt38-(R*p*)(R*q*)(R*r*)(R*s*)(R*t*)(R*u*)(R*v*)(T*w*), wherein Pt38-(R1)(R1)(R1)(R1)(R1)(R1)(R1)(T1) to Pt38-(R86)(R86)(R86)(R86)(R86)(R86)(R86)(T 10), have the structure | 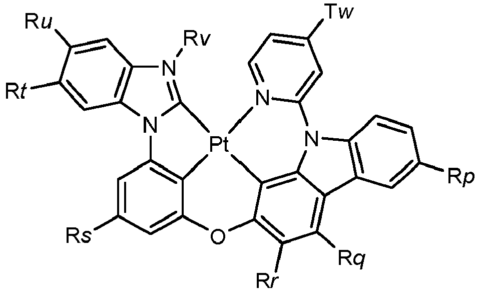 |
| Pt39-(R*o*)(R*q*)(R*r*)(R*s*)(R*t*)(R*u*)(R*v*)(T*w*), wherein Pt39-(R1)(R1)(R1)(R1)(R1)(R1)(R1)(T1) to Pt39-(R86)(R86)(R86)(R86)(R86)(R86)(R86)(T 10), have the structure | 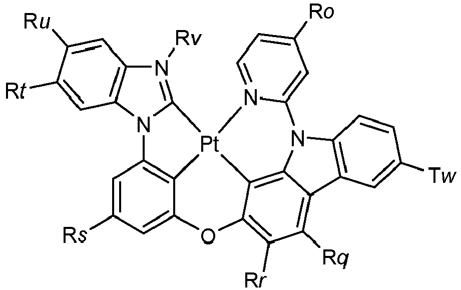 |
| Pt40-(R*o*)(R*q*)(R*q*)(R*r*)(R*t*)(R*u*)(R*v*)(T*w*), wherein Pt40-(R1)(R1)(R1)(R1)(R1)(R1)(R1)(T1) to Pt40-(R86)(R86)(R86)(R86)(R86)(R86)(R86)(T 10), have the structure | 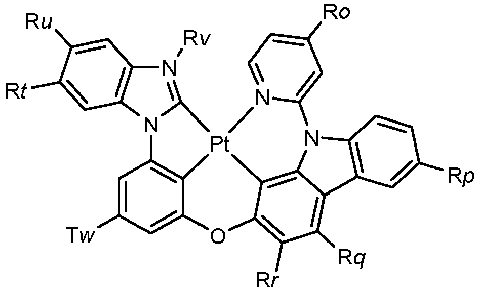 |
| Pt41-(R*p*)(R*q*)(R*r*)(R*s*)(R*t*)(R*u*)(R*v*)(T*w*), wherein Pt41-(R1)(R1)(R1)(R1)(R1)(R1)(R1)(T1) to Pt41-(R86)(R86)(R86)(R86)(R86)(R86)(R86)(T 10), have the structure | 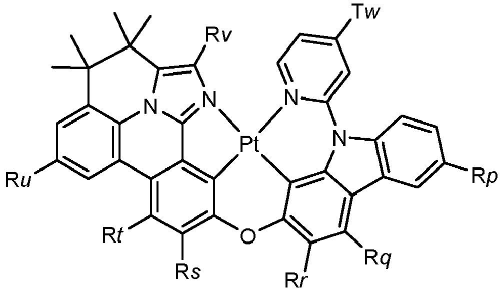 |
| Pt42-(R*o*)(R*q*)(R*r*)(R*s*)(R*t*)(R*u*)(R*v*)(T*w*), wherein Pt42-(R1)(R1)(R1)(R1)(R1)(R1)(R1)(T1) to Pt42-(R86)(R86)(R86)(R86)(R86)(R86)(R86)(T 10), have the structure | 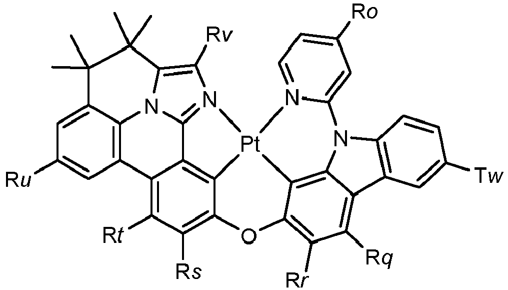 |
| Pt43-(R*o*)(R*q*)(R*q*)(R*r*)(R*t*)(R*u*)(R*v*)(T*w*), wherein Pt43-(R1)(R1)(R1)(R1)(R1)(R1)(R1)(T1) to Pt43-(R86)(R86)(R86)(R86)(R86)(R86)(R86)(T 10), have the structure | 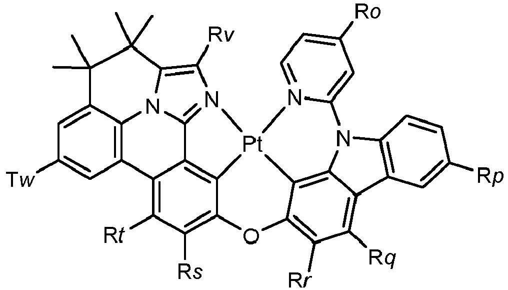 |
| Pt44-(R*o*)(R*q*)(R*r*)(R*s*)(R*t*)(R*u*)(R*v*)(T*w*), wherein Pt44-(R1)(R1)(R1)(R1)(R1)(R1)(R1)(T1) to Pt44-(R86)(R86)(R86)(R86)(R86)(R86)(R86)(T 10), have the structure | 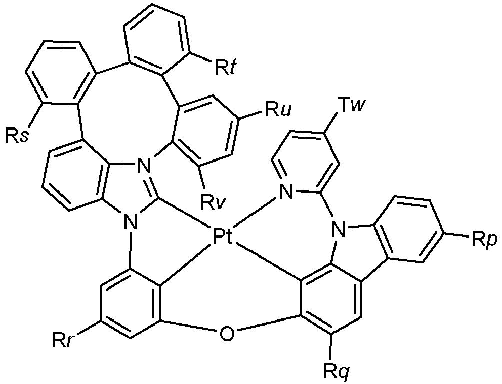 |
| Pt45-(R*o*)(R*q*)(R*q*)(R*r*)(R*t*)(R*u*)(R*v*)(T*w*), wherein Pt45-(R1)(R1)(R1)(R1)(R1)(R1)(R1)(T1) to Pt45-(R86)(R86)(R86)(R86)(R86)(R86)(R86)(T 10), have the structure | 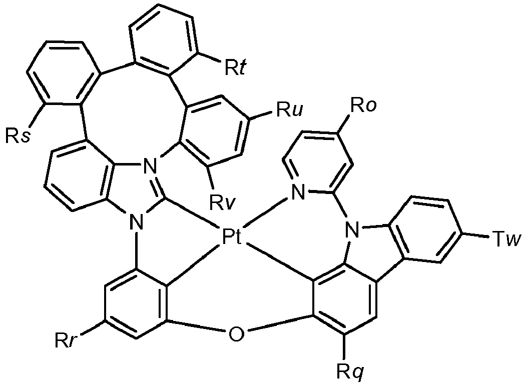 |
| Pt46-(R*o*)(R*q*)(R*q*)(R*r*)(R*t*)(R*u*)(R*v*)(T*w*), wherein Pt46-(R1)(R1)(R1)(R1)(R1)(R1)(R1)(T1) to Pt46-(R86)(R86)(R86)(R86)(R86)(R86)(R86)(T 10), have the structure | 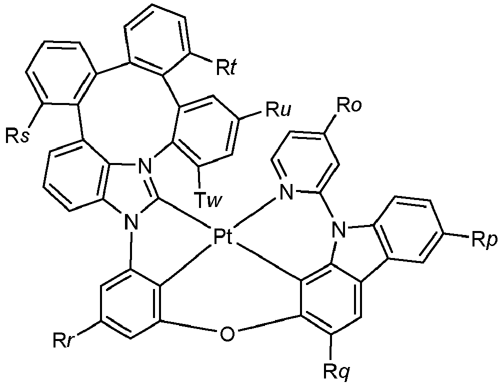 |

wherein each of *o, p, q, r, s, t, u,* and v is independently an integer from 1 to 86; and *w* is an integer from 1 to 10; and
wherein R1 to R86 have the structures defined in the following LIST 15: 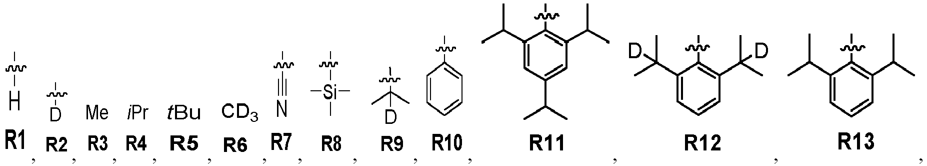 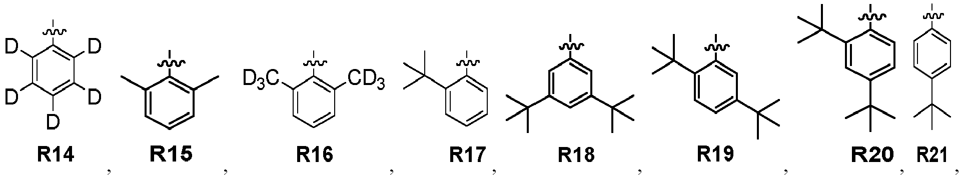 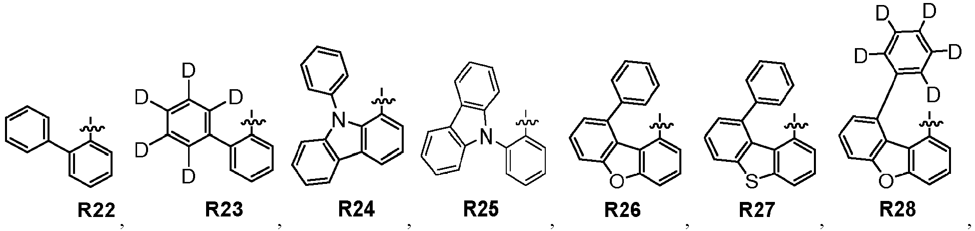 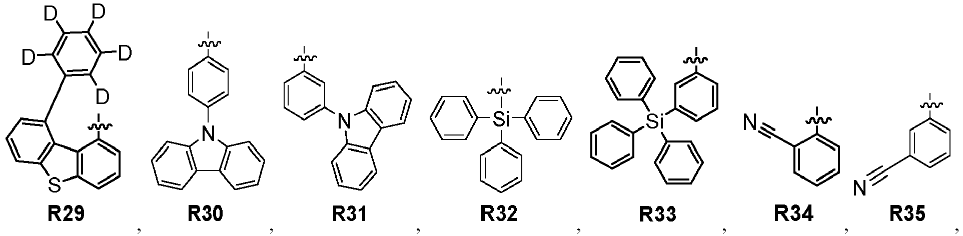 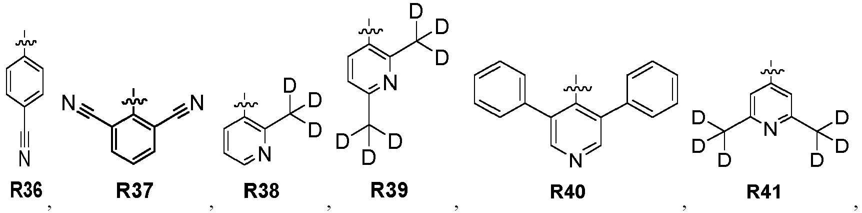 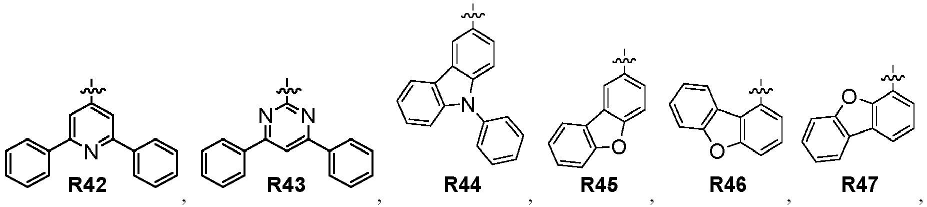 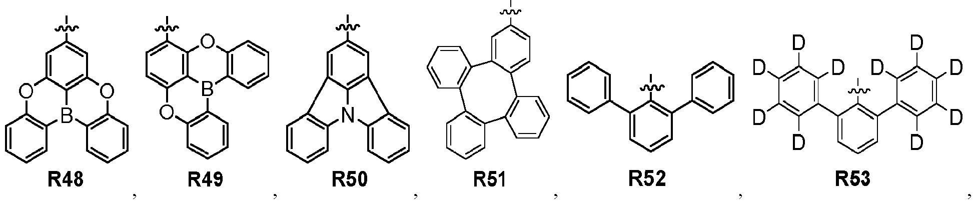 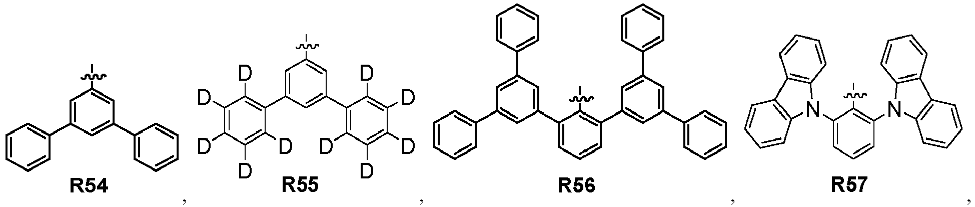 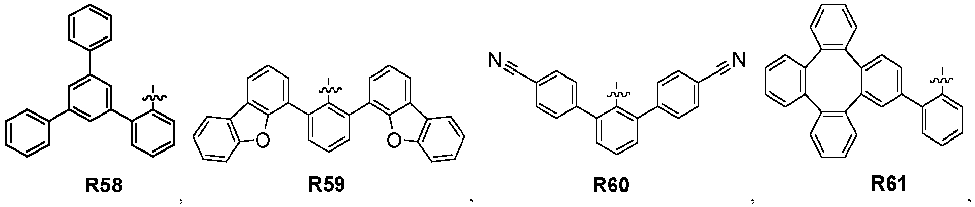 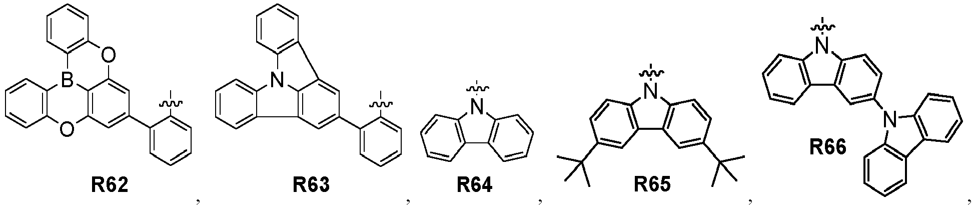 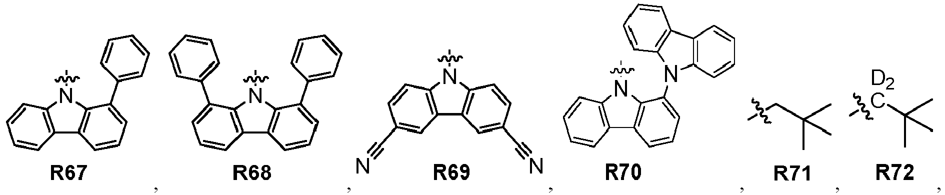 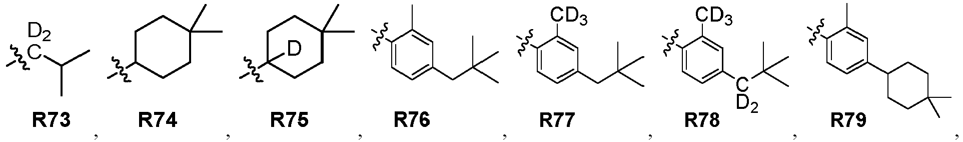 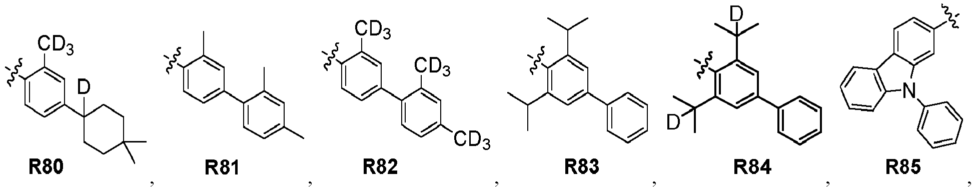 and 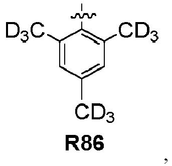 and where in T 1 to T10 have the structures defined in the following LIST 16:

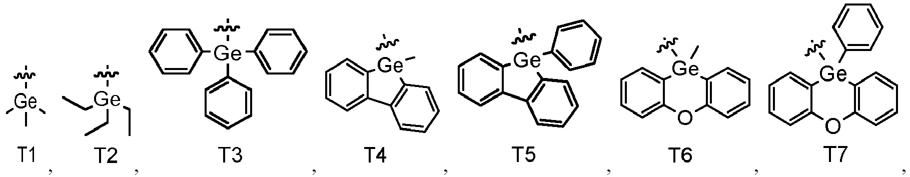

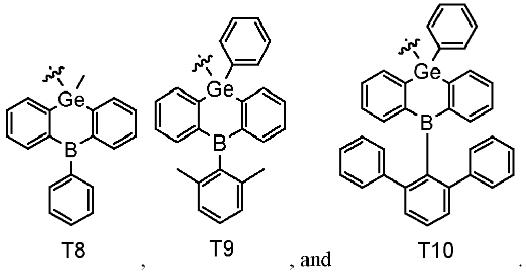

In some embodiments, the compound comprising a first ligand of L_{A} of Formula I may be selected from the group consisting of: 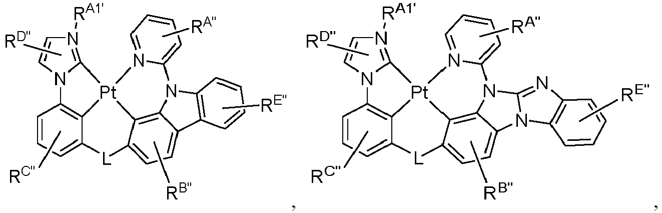 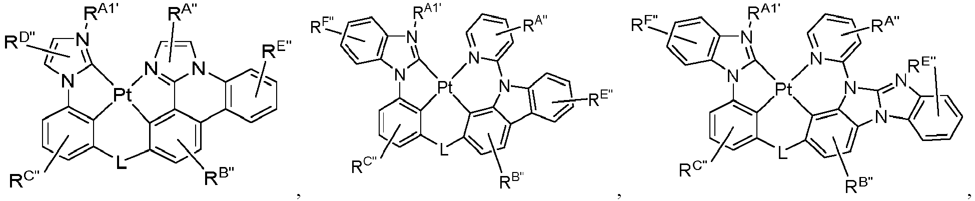 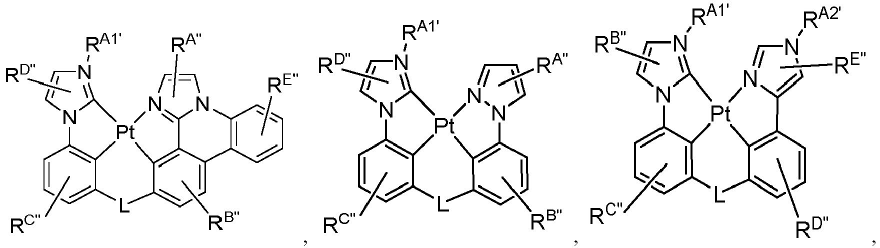 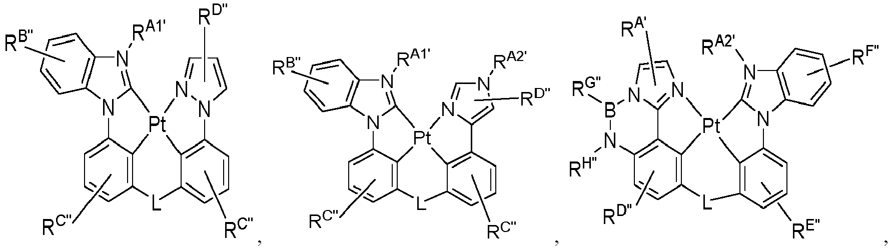 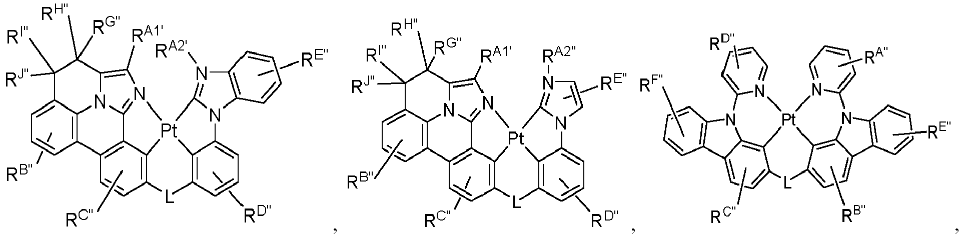 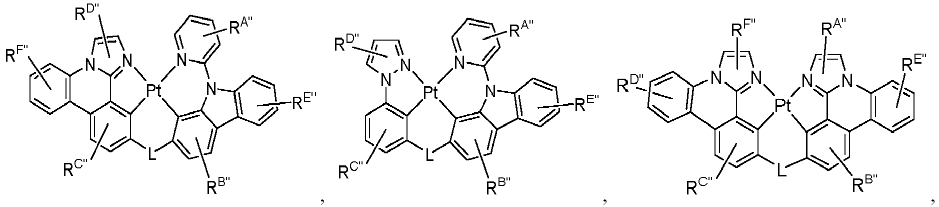 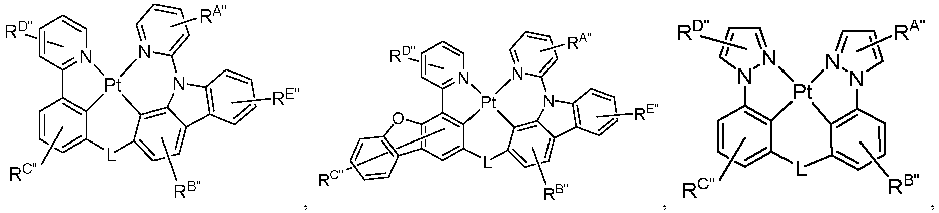 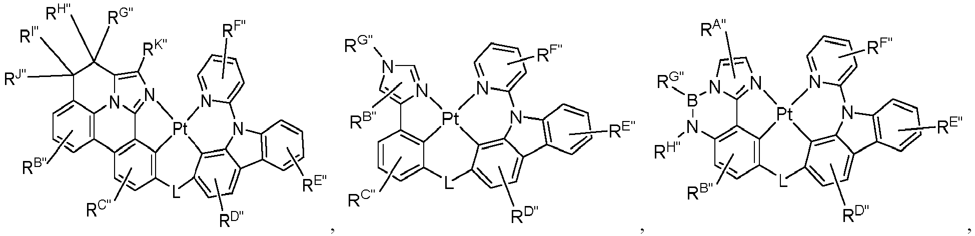 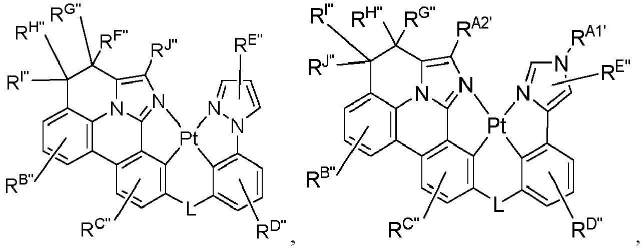 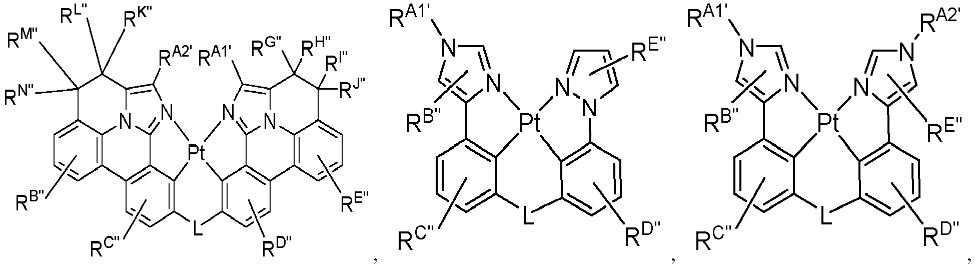 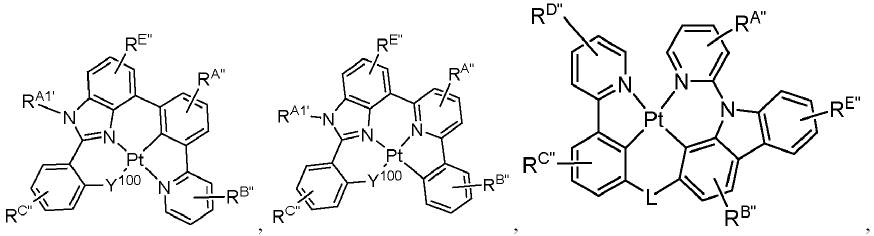 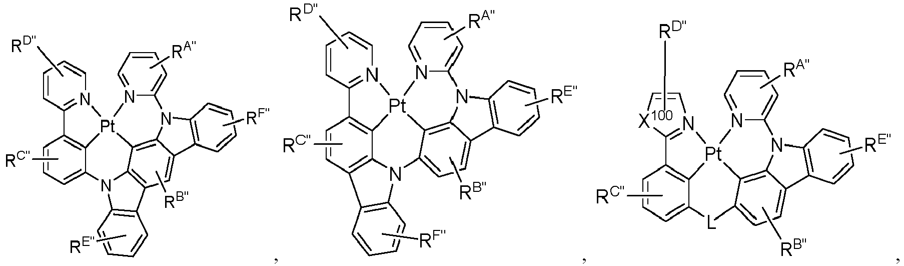 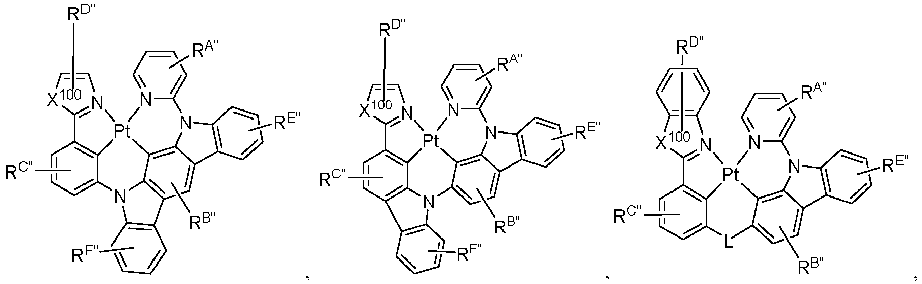 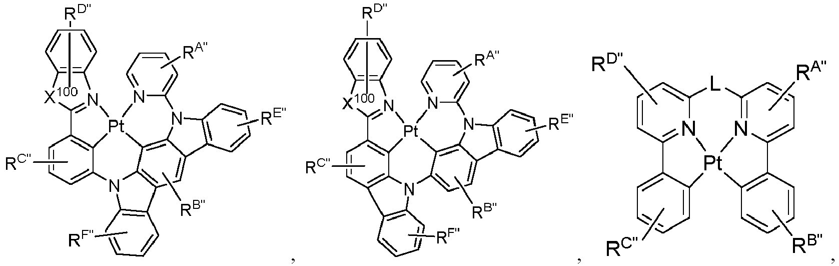 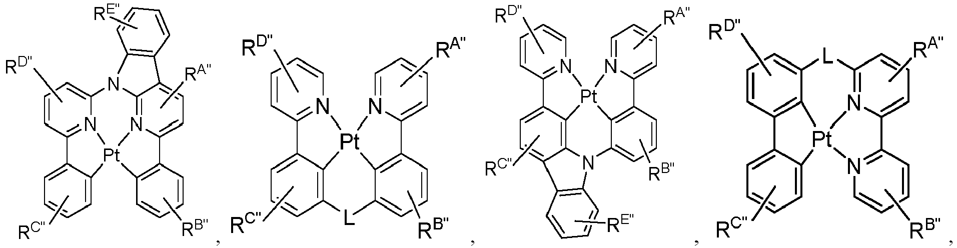 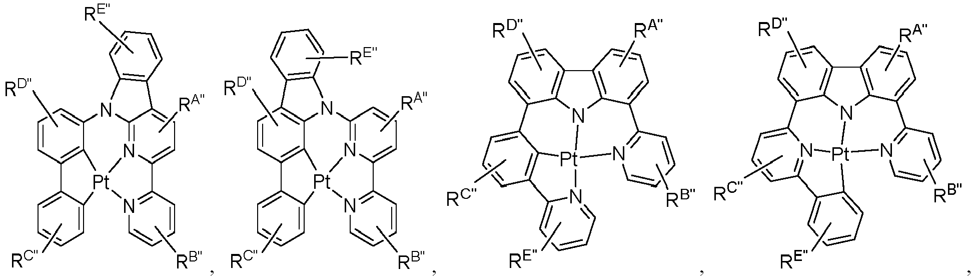 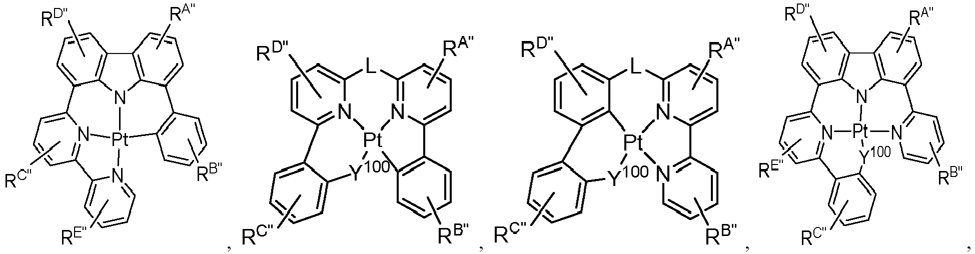 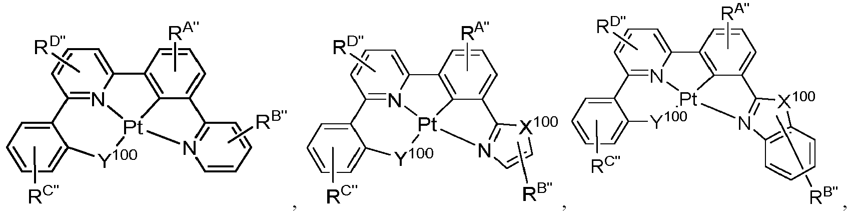 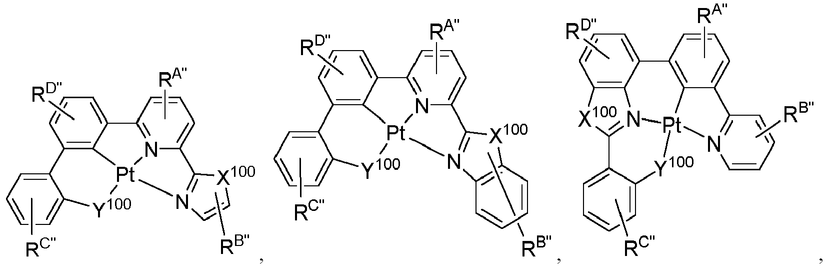 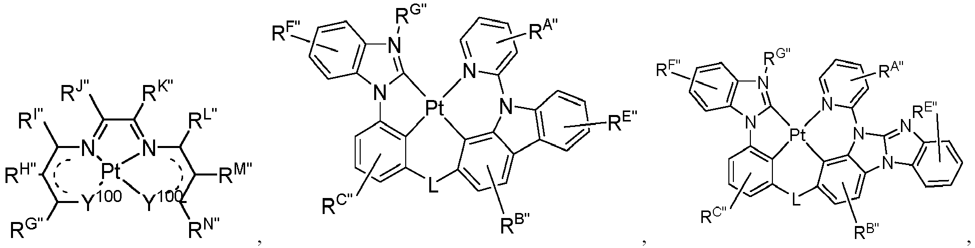 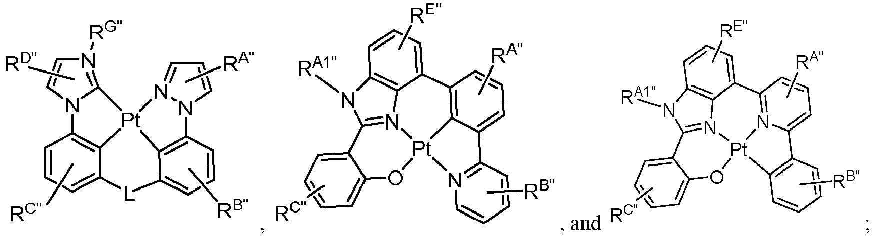 wherein:
each Y¹⁰⁰ is independently selected from the group consisting of a NR", O, S, and Se;
L is independently selected from the group consisting of a direct bond, BR", BR"R"', NR", PR", O, S, Se, C=O, C=S, C=Se, C=NR", C=CR"R‴, S=O, SO₂, CR", CR"R‴, SiR"R‴, GeR"R‴, alkyl, cycloalkyl, aryl, heteroaryl, and combinations thereof;
X¹⁰⁰ for each occurrence is selected from the group consisting of O, S, Se, NR", and CR"R"';
each of R^{A"}, R^{B"}, R^{C"}, R^{D"}, R^{E"}, and R^{F"} independently represents mono-, up to the maximum substitutions, or no substitutions;
each R, R', R", R'", R^{A1'}, R^{A2'}, R^{A"}, R^{B"}, R^{C"}, R^{D"}, R^{E"}, R^{F"}, R^{G"}, R^{H"}, R^{I"}, R^{J"}, R^{K"}, R^{L"}, R^{M"}, and R^{N"} is independently a hydrogen or a substituent selected from the group consisting of the General Substituents defined herein;
at least one of R^{A"}, R^{B"}, R^{C"}, R^{D"}, R^{E"}, or R^{F"} has a structure of Formula II, ---L-GeR¹R²R³; and
any two R, R', R", R‴, R^{A1'}, R^{A2'}, R^{A"}, R^{B"}, R^{C"}, R^{D"}, R^{E"}, R^{F"}, R^{G"}, R^{H"}, R^{I"}, R^{J"}, R^{K"}, R^{L"}, R^{M"}, and R^{N"} may be optionally joined to form a ring.

In some embodiments of Formula III, moiety A links to another fused or unfused aromatic ring in addition to moiety B, and the another fused or unfused aromatic ring coordinates to Pt.

In some embodiments, the compound is selected from the group consisting of 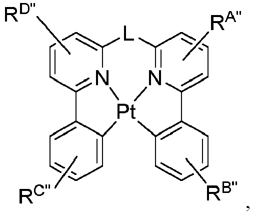 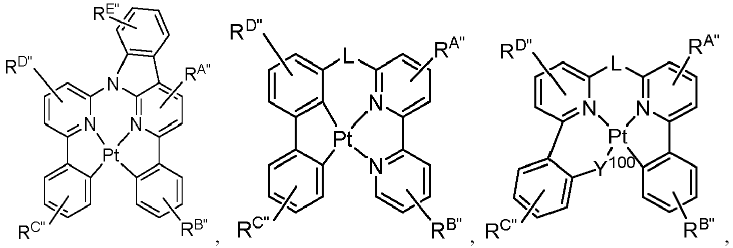 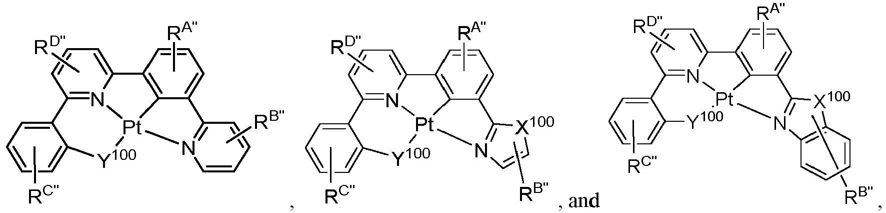 where at least one R^{D"} is R*; or 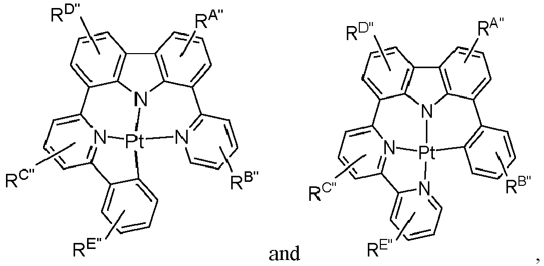 where at least one R^{C"} is R*; or 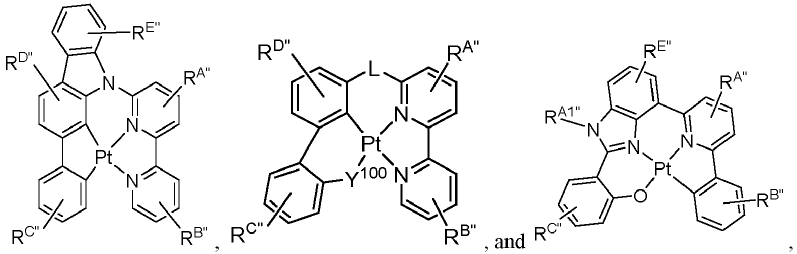 where at least one R^{A"} is R*; or 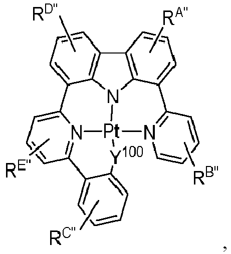 where at least one R^{E"} is R*.

In some embodiments, the compound is selected from the group consisting of the structures of the following LIST 16:

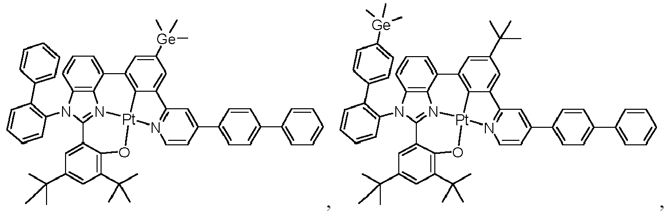

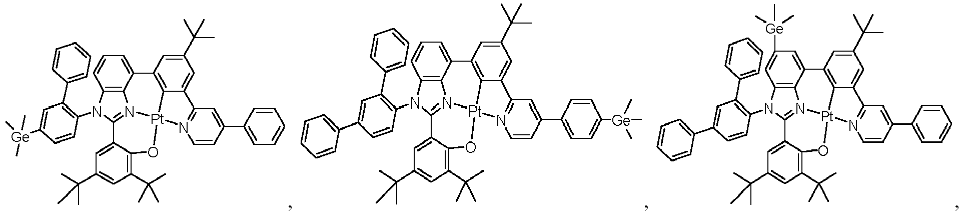

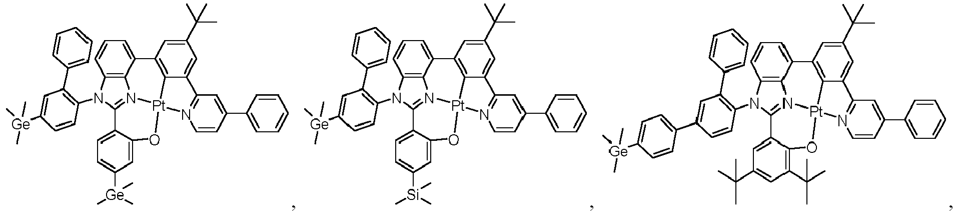

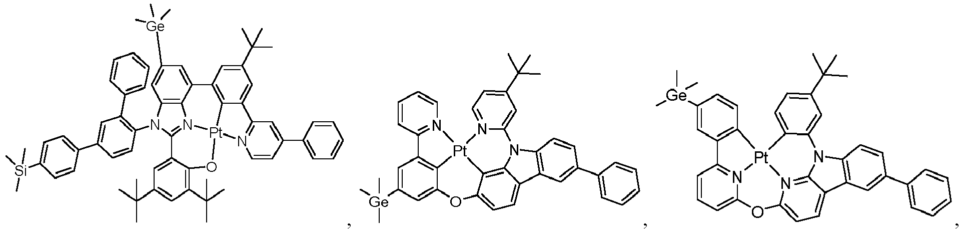

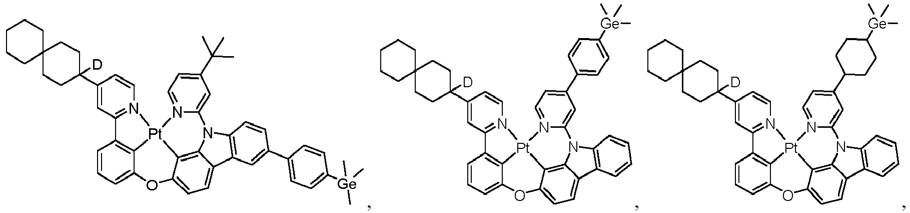

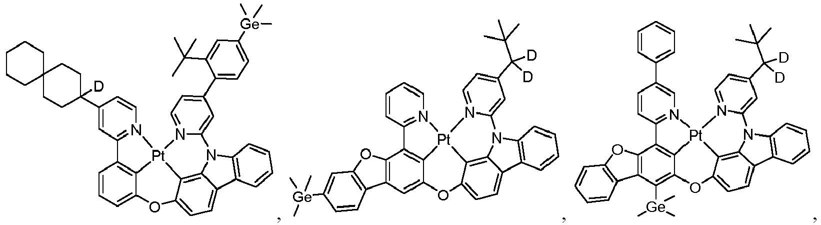

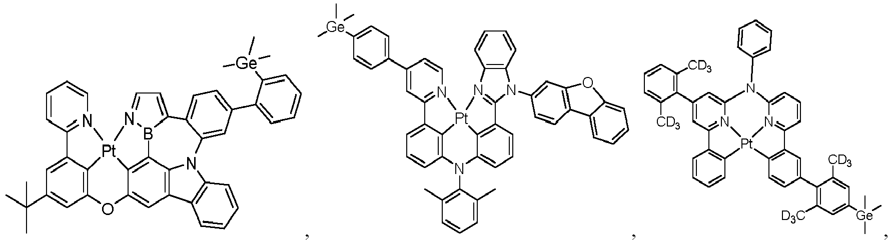

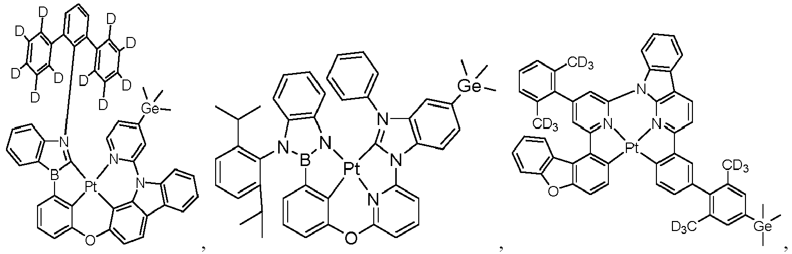

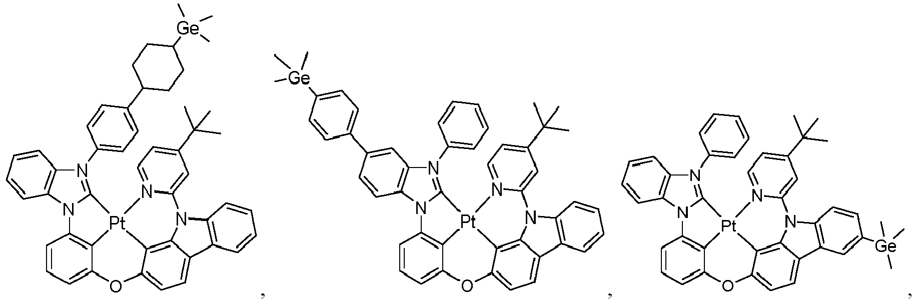

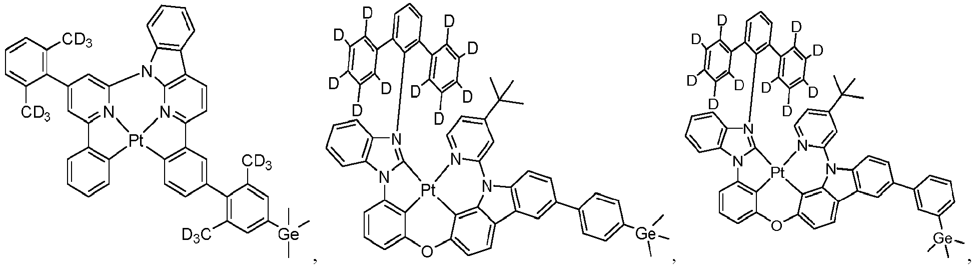

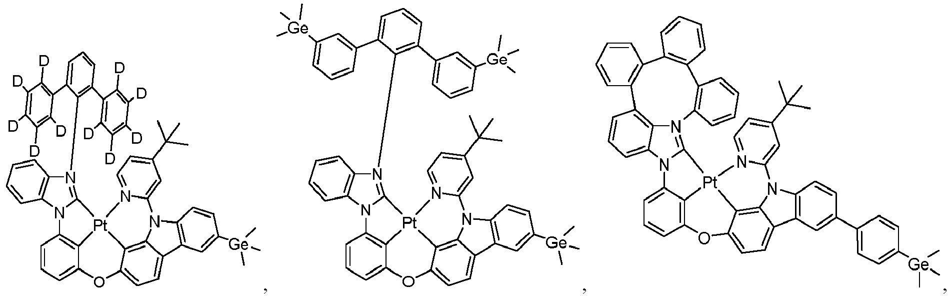

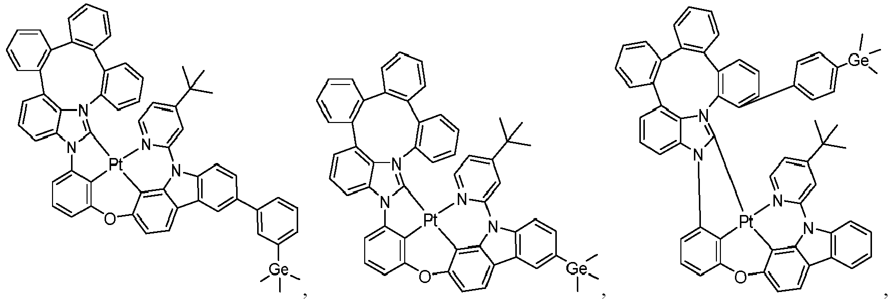

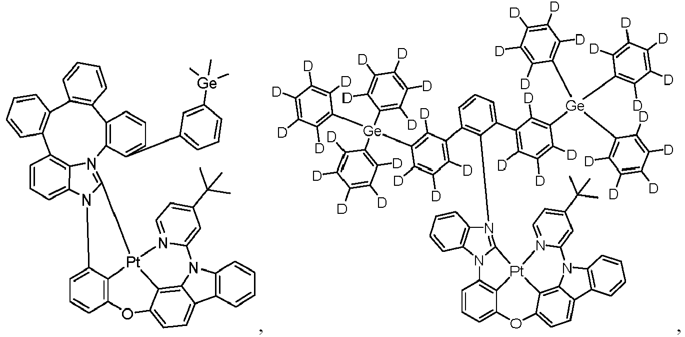

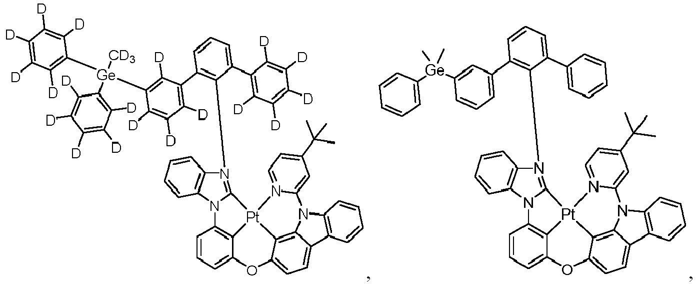

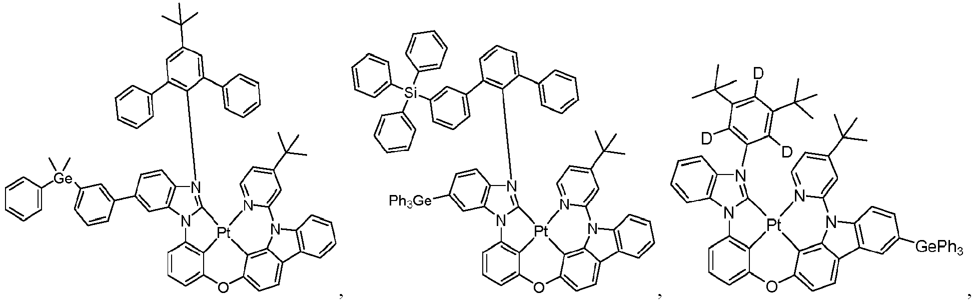

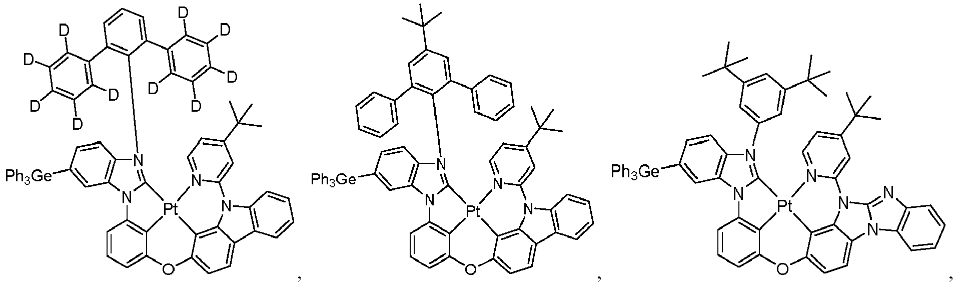

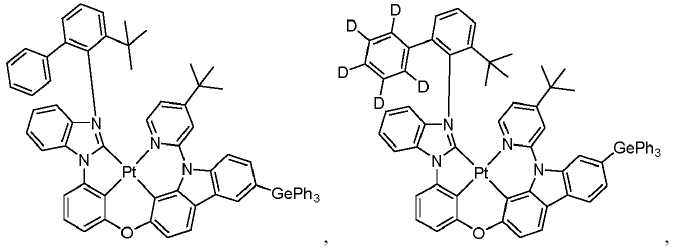

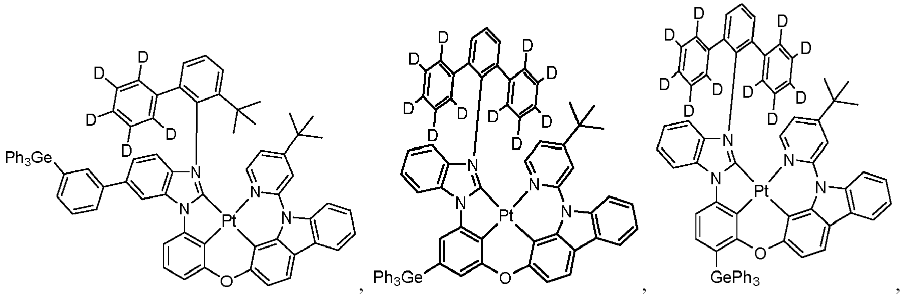

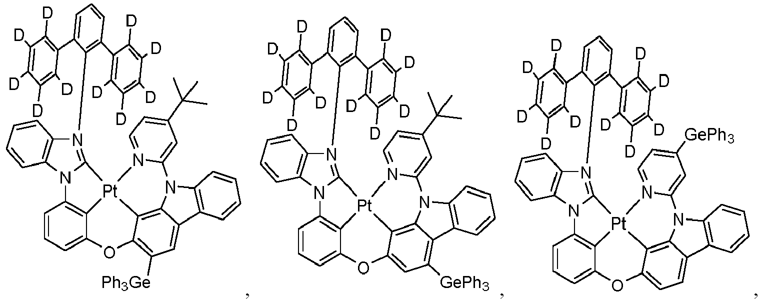

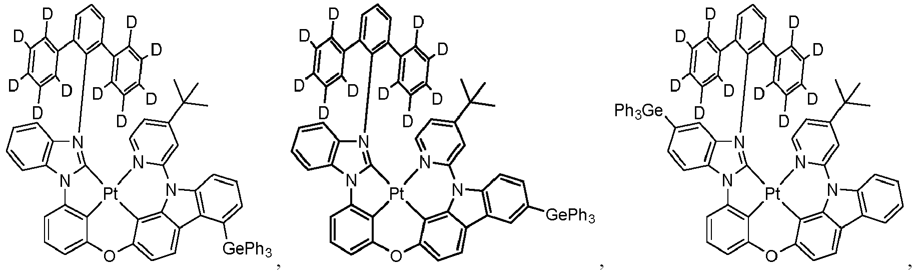

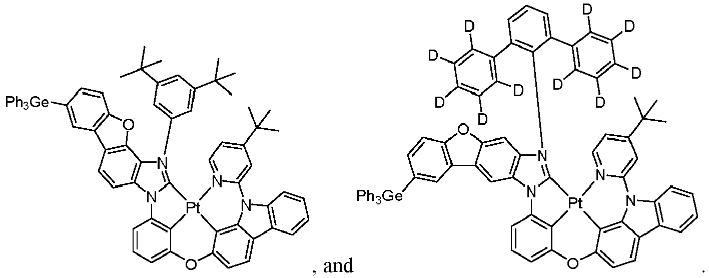

In another aspect, the present disclosure provides a compound having a structure of Formula IIIA, 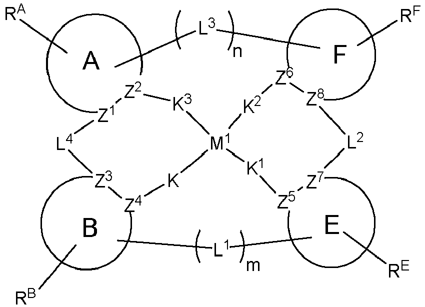 wherein:
M¹ is Pd or Pt;
moieties A, B, E and F are each independently a monocyclic or polycyclic ring structure comprising 5-membered and/or 6-membered carbocyclic or heterocyclic rings;
Z¹, to Z⁸ are each independently C or N;
K, K¹, K², and K³ are each independently selected from the group consisting of a direct bond, O, and S, wherein at least two of them are direct bonds;
each m, and n is 0 or 1; when m is 0, L¹ is not present; when m is 1, L¹ is present; when n is 0, L³ is not present; when n is 1, L³ is present; m+n is at least 1;
each L¹, L², L³, and L⁴ is independently selected from the group consisting of a direct bond, BR, BRR', NR, PR, P(O)R, O, S, Se, C=O, C=S, C=Se, C=NR, C=CRR', S=O, SO₂, CR, CRR', SiRR', GeRR', alkylene, cycloalkyl, aryl, cycloalkylene, arylene, heteroarylene, and combinations thereof;
each R^{A}, R^{B}, R^{E} and R^{F} independently represents zero, mono, or up to a maximum allowed number of substitutions to its associated ring;
each of R, R', R^{A}, R^{B}, R^{E}, and R^{F} is independently a hydrogen or a substituent selected from the group consisting of deuterium, halogen, alkyl, cycloalkyl, heteroalkyl, heterocycloalkyl, arylalkyl, alkoxy, aryloxy, amino, silyl, germyl, boryl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, selenyl, and combinations thereof;
at least one R^{A}, R^{B}, R^{E} and R^{F} comprises R*, wherein R* has a structure of Formula II, ---L-GeR¹R²R³;
L is a direct bond or an organic linker;
each R¹, R², and R³ is independently selected from the group consisting of deuterium, halogen, alkyl, cycloalkyl, heteroalkyl, heterocycloalkyl, arylalkyl, alkoxy, aryloxy, amino, silyl, germyl, boryl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, selenyl, and combinations thereof;
any two R¹, R², R³, R, R', R^{A}, R^{B}, R^{E}, and R^{F} can be joined or fused together to form a ring where chemically feasible.

In some embodiments, each of the following provisos is true:
(1) when M is Pt, Ge in R* belongs to a ring atom of a first ring, then the rest ring atoms and ring bonds of the first ring don't comprise any L¹, L², L³, and L⁴;
(2) when M is Pt, m is 1, n is 0, L⁴ is direct bond, L² is direct bond or C=CRR', Z² and Z⁶ are N, Z⁴ and Z⁵ are C, then L¹ is not NR; and
(3) when M is Pt, Z² is N, at least one R^{A} is R*, then moiety A is not an unfused pyrazole.

In some embodiments, the compound comprises at least one metal-carbene bond.

In some embodiments, the compound comprises at least one metal-O bond.

In some embodiments, each K, K¹, K², and K³ is a direct bond.

In some embodiments, K is O, each K¹, K², and K³ is a direct bond.

In some embodiments, two of Z², Z⁴, Z⁵ and Z⁶ are C, and two of Z², Z⁴, Z⁵ and Z⁶ are N.

In some embodiments, three of Z2, Z4, Z5 and Z6 are C, and remaining one of Z2, Z4, Z5 and Z6 is N.

In some embodiments, m+n is 1. In some embodiments, m =0, and n=1. In some embodiments, m=1 and n=0. In some embodiments, L⁴ is a direct bond.

In some embodiments, three moieties of A, B, E and F are each independently a 6-membered carbocyclic or heterocyclic rings, and the remaining one of moieties of A, B, E and F is a 5-membered heterocyclic ring.

In some embodiments, each of moieties A, B, E and F is independently a 6-membered carbocyclic or heterocyclic rings.

In some embodiments, each moiety of A, B, E and F is independently an unfused 5-membered or 6-membered carbocyclic or heterocyclic rings.

In some embodiments, at least one of moieties A, B, E and F is a fused 5-membered or 6-membered carbocyclic or heterocyclic rings.

In some embodiments, at least two of moieties A, B, E and F are a fused 5-membered or 6-membered carbocyclic or heterocyclic rings.

In some embodiments, each moiety of A, B, E and F is independently selected from the group consisting of phenyl, pyridine, pyrimidine, pyridazine, pyrazine, triazine, imidazole, pyrazole, pyrrole, oxazole, furan, thiophene, thiazole, and heterocyclic carbene.

In some embodiments, each moiety of A, B, E and F is independently selected from the group consisting of phenyl, pyridine, pyrimidine, imidazole, furan, thiophene, and imidazole-derived carbene.

In some embodiments, each of R, R', R^{A}, R^{B}, R^{E}, and R^{F} is independently a hydrogen or a substituent selected from the group consisting of deuterium, fluorine, alkyl, cycloalkyl, heteroalkyl, alkoxy, aryloxy, amino, silyl, boryl, alkenyl, cycloalkenyl, heteroalkenyl, aryl, heteroaryl, nitrile, isonitrile, sulfanyl, boryl, and combinations thereof; and wherein each R¹, R², and R³ is independently selected from the group consisting of alkyl, heteroalkyl, cycloalkyl, heterocycloalkyl, aryl, heteroaryl, and combinations thereof.

In some embodiments, each L¹, L², L³, and L⁴ is independently selected from the group consisting of a direct bond, NR, C=CRR', and O.

In some embodiments, Ge in R* directly attaches to moiety A, B, E or F.

In some embodiments, Ge in R* does not directly attach to moiety A, B, E or F.

In some embodiments, Ge in R* belongs to a ring atom of a first ring.

In some embodiments, Ge in R* belongs to a ring atom of a first ring which is fused to moiety A, B, E or F.

In some embodiments, Ge in R* belongs to a ring atom of a first ring which is fused to one or more rings before fused to moiety A, B, E or F.

In some embodiments, Ge in R* belongs to a ring atom of a first ring which is fused to one or more rings but not fused to moiety A, B, E or F.

In some embodiments, Ge in R* is comprised by one of the following structures selected from the group consisting of: 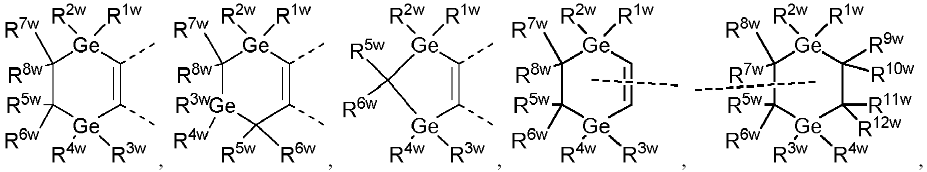 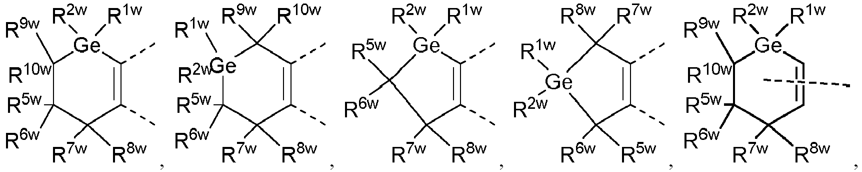 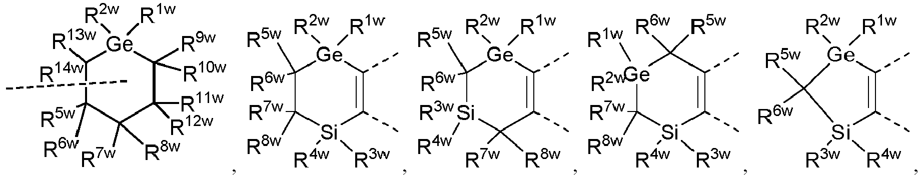 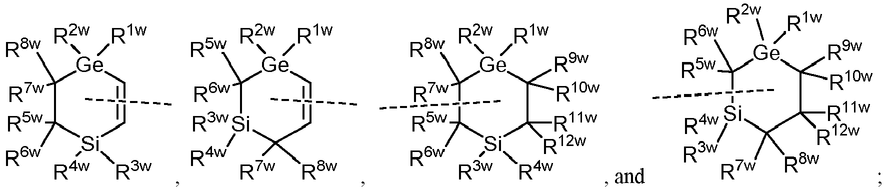 wherein each R^{1w} to R^{14w} is independently a hydrogen or a substituent selected from the group consisting of deuterium, halogen, alkyl, cycloalkyl, heteroalkyl, heterocycloalkyl, arylalkyl, alkoxy, aryloxy, amino, silyl, germyl, boryl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, selenyl, and combinations thereof; and wherein any two R^{1w} to R^{14w} can be joined or fused into a ring.

In some embodiments, at least two of the R^{1w} to R^{14w} are joined to form into a bridged fused ring system. In some embodiments, at least one pair of the neighboring R^{1w} to R^{14w} attaching to the same atom are joined to form into a spiro structure. In some embodiments, at least one R^{1w} to R^{14w} is partially or fully deuterated, partially or fully fluorinated, or the combinations thereof.

In some embodiments, the compound of Formula IIIA has a first substituent R^{I} from one of R^{A} and R^{B} having a first atom in R¹ that is the farthest away from M¹ among all atoms in R^{A} and R^{B}; and a second substituent R^{II} from one of R^{E} and R^{F} having a first atom in R^{II} that is the farthest away from M¹ among all atoms in R^{E} and R^{F}; wherein:
a distance D¹ is the distance between M¹ and the first atom in R¹;
a distance D² is the distance between M¹ and the first atom in R^{II};
a sphere having radius r is defined whose center is the M¹ and the radius r is the smallest radius that will allow the sphere to enclose all atoms in the compound that are not part of the substituents R^{I}, and R^{II}; and wherein at least one of D¹ and D² is longer than r by at least 1.5 Å.

In some embodiments, at least one of D¹ and D² is longer than r by at least 2.9 Å. In some embodiments, at least one of D¹ and D² is longer than r by at least 3.0 Å. In some embodiments, at least one of D¹ and D² is longer than r by at least 4.3 Å. In some embodiments, at least one of D¹ and D² is longer than r by at least 4.4 Å. In some embodiments, at least one of D¹ and D² is longer than r by at least 5.2 Å. In some embodiments, at least one of D¹ and D² is longer than *r* by at least 5.9 Å. In some embodiments, at least one of D¹ and D² is longer than r by at least 7.3 Å. In some embodiments, at least one of D¹ and D² is longer than r by at least 8.8 Å. In some embodiments, at least one of D¹ and D² is longer than r by at least 10.3 Å. In some embodiments, at least one of D¹ and D² is longer than *r* by at least 13.1 Å. In some embodiments, at least one of D¹ and D² is longer than *r* by at least 17.6 Å. In some embodiments, at least one of D¹ and D² is longer than r by at least 19.1 Å.

In some embodiments, the compound of Formula IIIA has a transition dipole moment axis; and wherein an angle between the transition dipole moment axis and an axis along the D¹, or D² is less than 40°. In some embodiments, the compound of Formula IIIA has a transition dipole moment axis; and wherein an angle between the transition dipole moment axis and an axis along the D¹, or D² is less than 30°. In some embodiments, the compound of Formula IIIA has a transition dipole moment axis; and wherein an angle between the transition dipole moment axis and an axis along the D¹, or D² is less than 20°. In some embodiments, the compound of Formula IIIA has a transition dipole moment axis; and wherein an angle between the transition dipole moment axis and an axis along the D¹, or D² is less than 15°. In some embodiments, the compound of Formula IIIA has a transition dipole moment axis; and wherein an angle between the transition dipole moment axis and an axis along the D¹, or D² is less than 10°.

In some embodiments, the compound of Formula IIIA has a vertical dipole ratio; wherein the vertical dipole ratio has a value of 0.33 or less. In some embodiments, the compound of Formula IIIA has a vertical dipole ratio; wherein the vertical dipole ratio has a value of 0.30 or less. In some embodiments, the compound of Formula IIIA has a vertical dipole ratio; wherein the vertical dipole ratio has a value of 0.25 or less. In some embodiments, the compound of Formula IIIA has a vertical dipole ratio; wherein the vertical dipole ratio has a value of 0.20 or less. In some embodiments, the compound of Formula IIIA has a vertical dipole ratio; wherein the vertical dipole ratio has a value of 0.15 or less.

In some embodiments, the compound of Formula IIIA is selected from the group consisting of the structures of LIST 13 defined herein;
wherein R^{AA}, R^{BB}, R^{DD}, R^{EE}, and R^{FF} are each independently represent mono to the maximum allowable substitution, or no substitution;
X₁, X₂, X₃, X₄, X₅, X₆, X₇, and X₈ are each independently C or N;
each R^{N}, R^{AA}, R^{BB}, R^{DD}, R^{EE}, and R^{FF} is independently a hydrogen or a substituent selected from the group consisting of deuterium, halogen, alkyl, cycloalkyl, heteroalkyl, heterocycloalkyl, arylalkyl, alkoxy, aryloxy, amino, silyl, germyl, boryl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, selenyl, and combinations thereof; and
any two substituents can be joined or fused to form a ring.

In some embodiments, the compound of Formula IIIA is selected from the group consisting of the compounds defined in LIST 14 defined herein;
wherein each of o, *p, q, r, s, t, u,* and v is independently an integer from 1 to 86; and
wherein R1 to R86 have the structures defined in LIST 15 defined herein.

In some embodiments, the compound of Formula IIIA is selected from the group consisting of the structures of LIST 16 defined herein.

In some embodiments, the compound is selected from the group consisting of compounds having the formula of Pt(L_{A"},)(L*y*'): 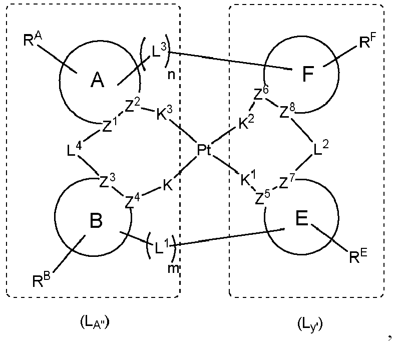 wherein L_{A"} is selected from the group consisting of the following structures (LIST 17):

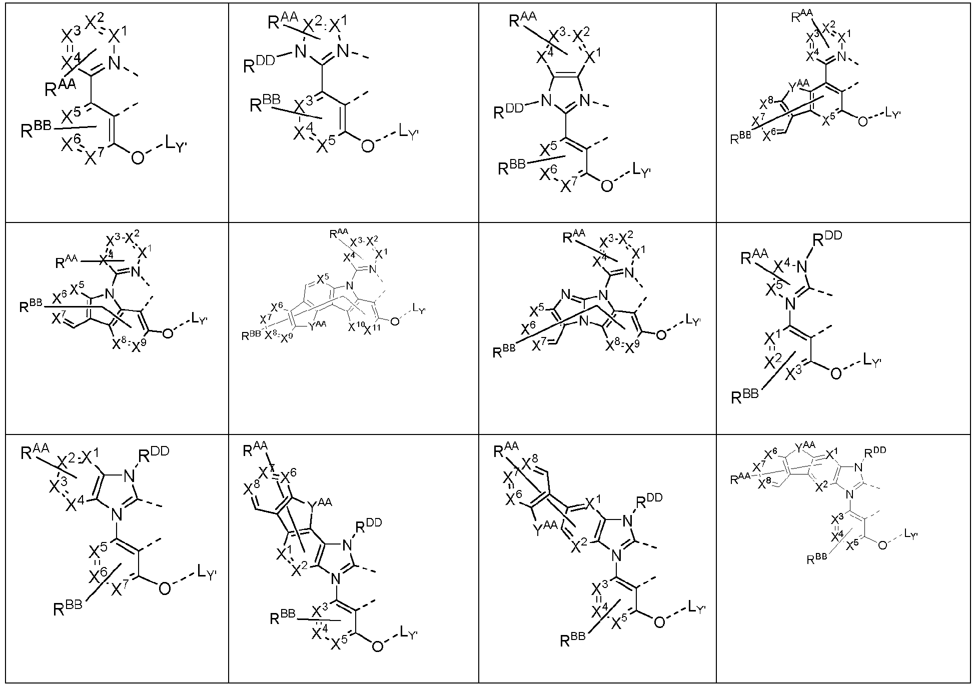

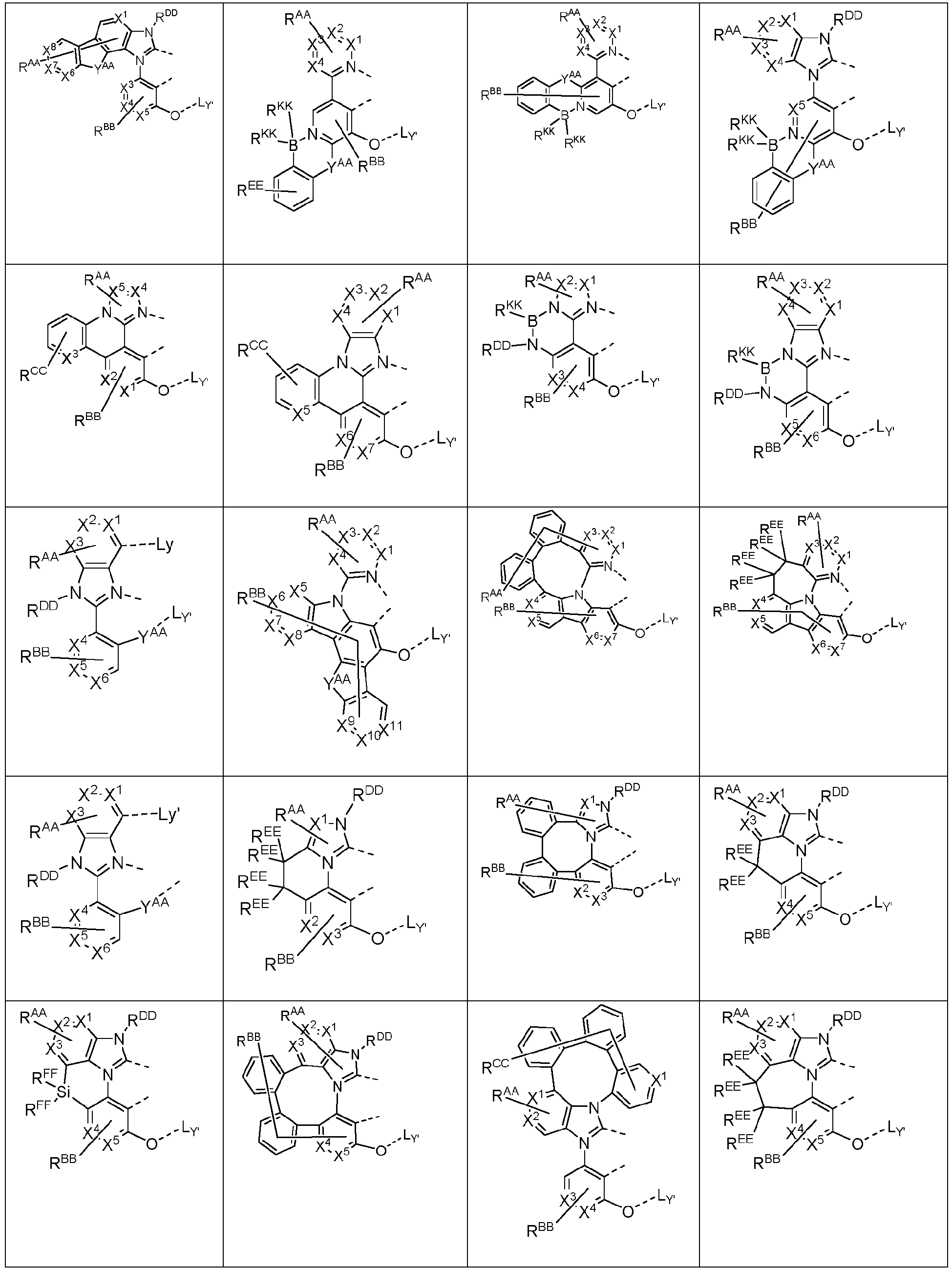

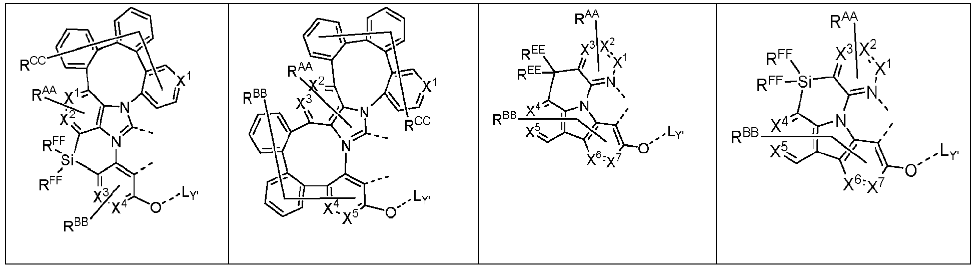

wherein L_{Y'} is selected from the group consisting of the following structures (LIST 18):

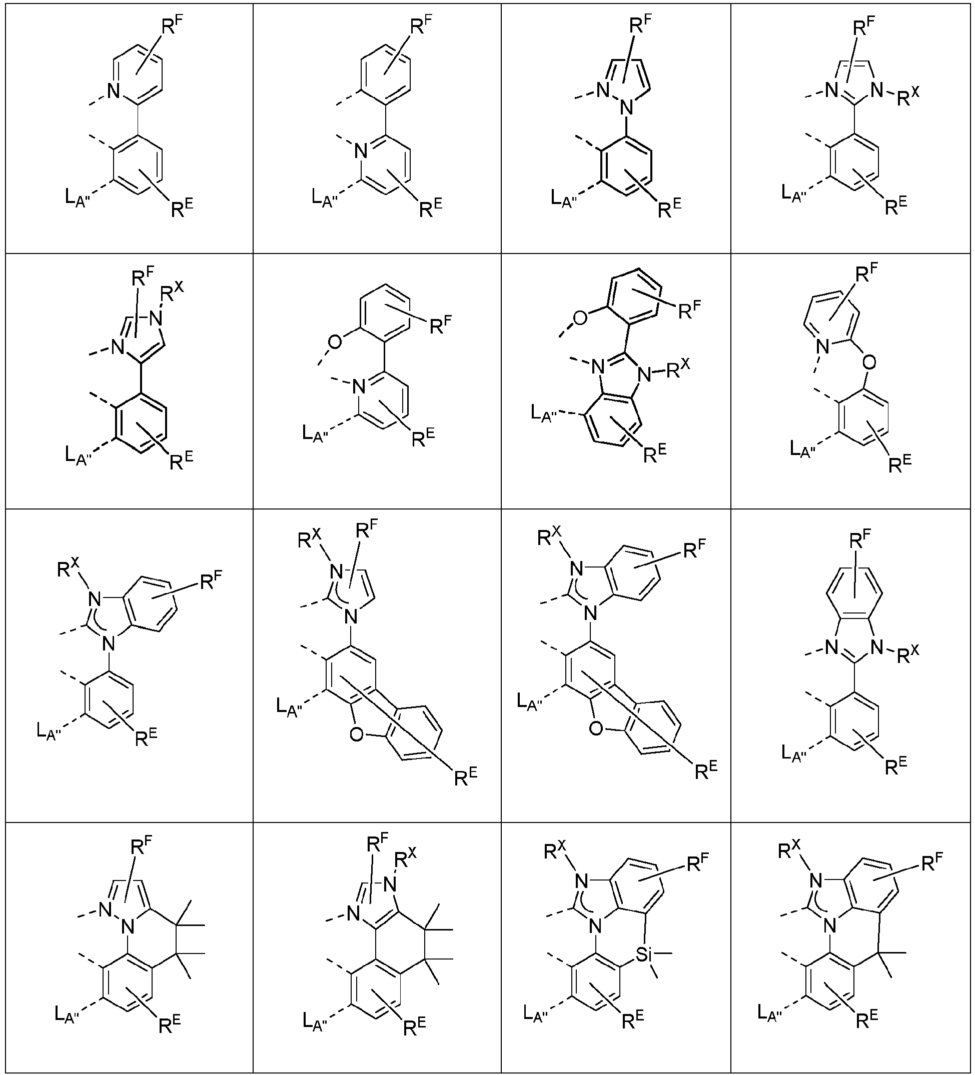

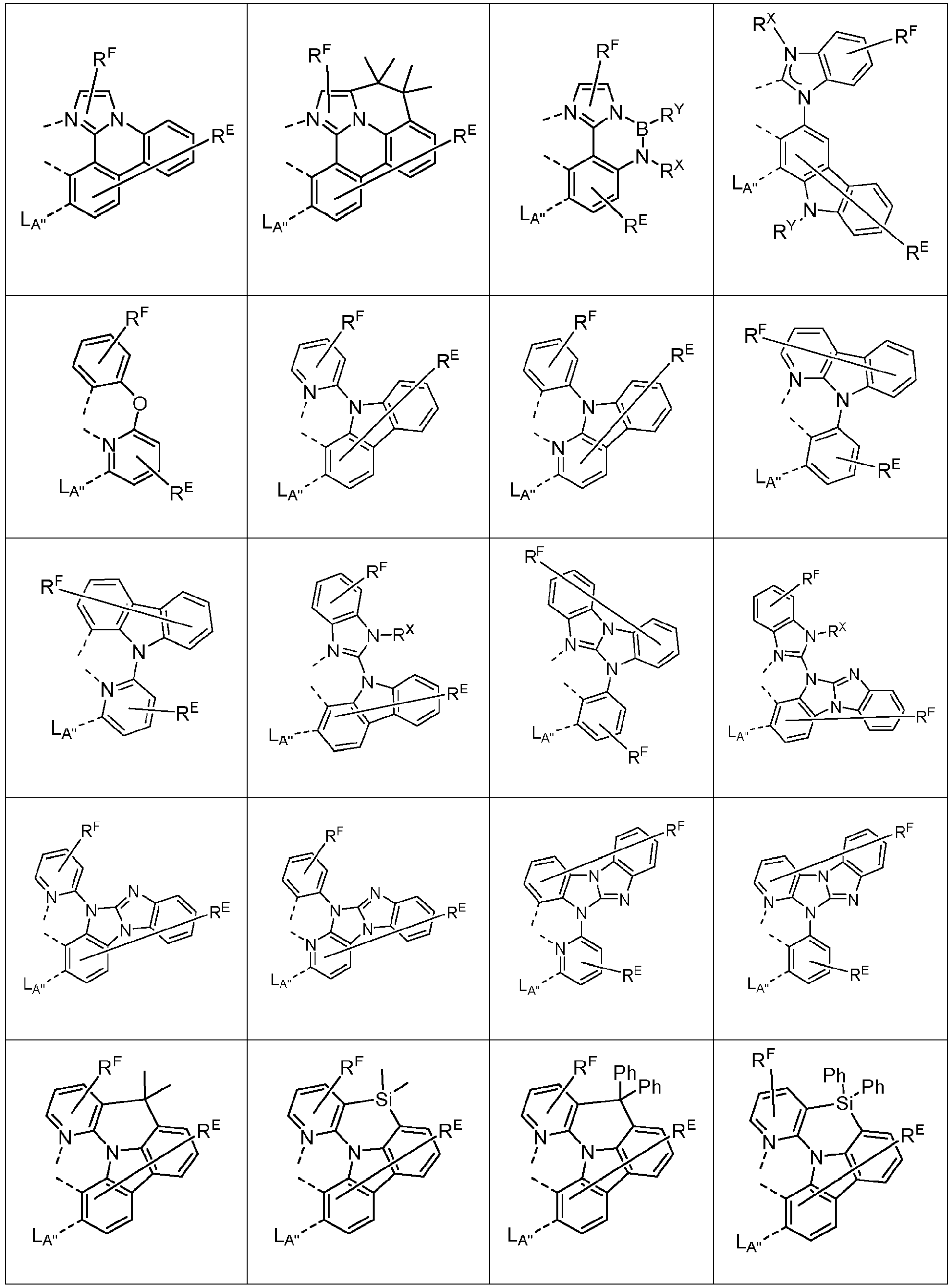

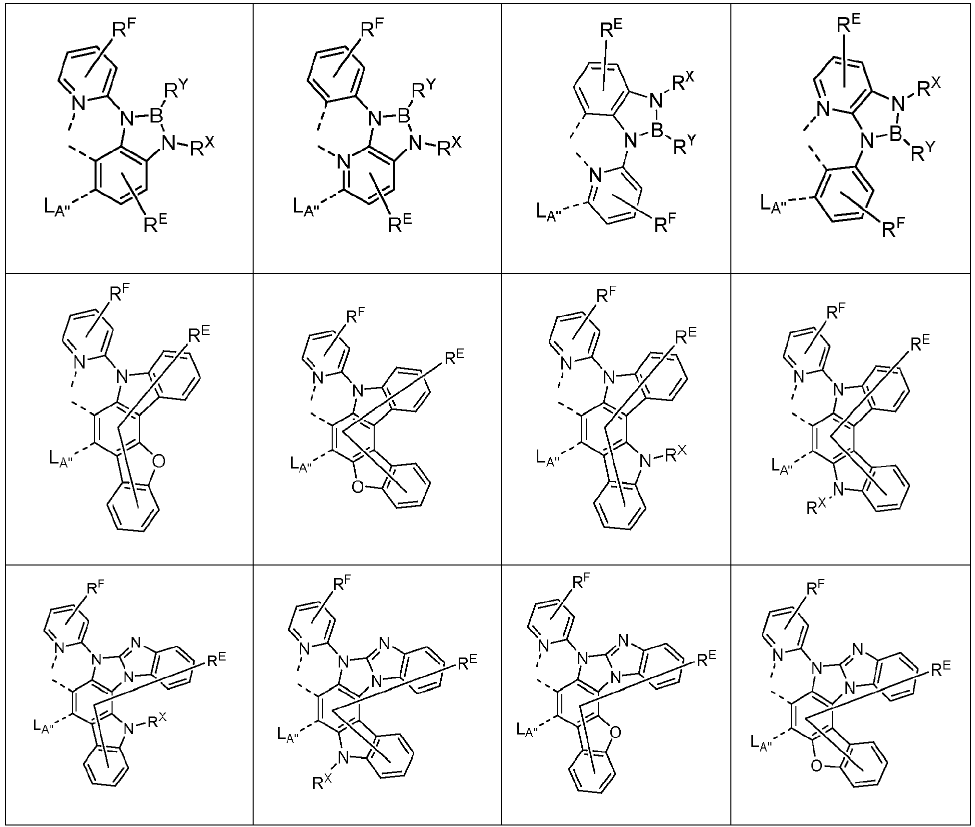

wherein at least one of R^{AA}, R^{BB}, R^{CC}, R^{DD}, R^{EE}, R^{FF}, R^{GG}, R^{HH}, R^{II}, R^{E}, R^{F}, and R^{X} comprises Formula II, , ---L-GeR¹R²R³;
wherein Ph represents phenyl;
wherein X¹, X², X³, X⁴, X⁵, X⁶, X⁷, X⁸, X⁹, X¹⁰, and X¹¹ are each independently C or N;
wherein Y^{AA} is chosen from O, S, Se, NR, BR, or CRR';
wherein each R¹, R², R³, R^{AA}, R^{BB}, R^{CC}, R^{DD}, R^{EE}, R^{FF}, R^{GG}, R^{HH}, R^{II}, R^{E}, R^{F}, and R^{X} is independently selected from the group consisting of the structures of the following LIST 18a:

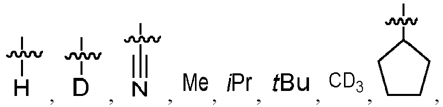

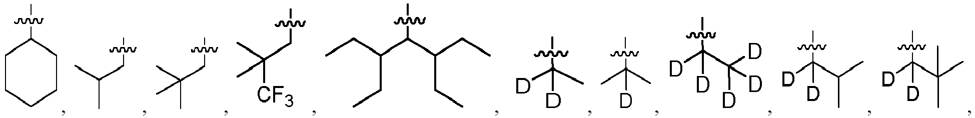

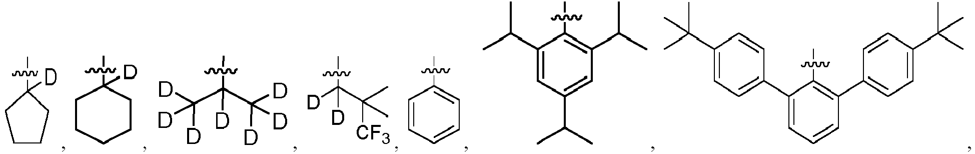

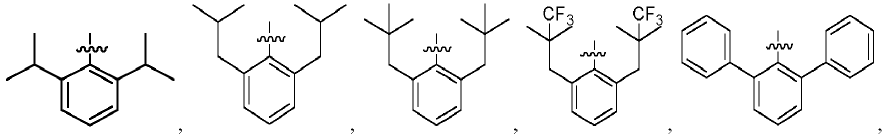

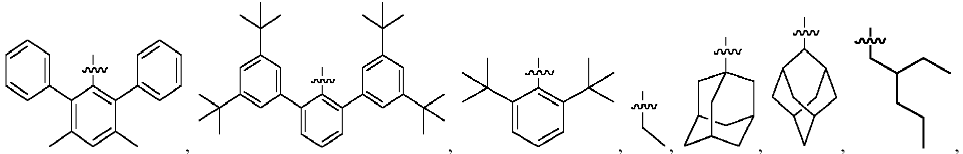

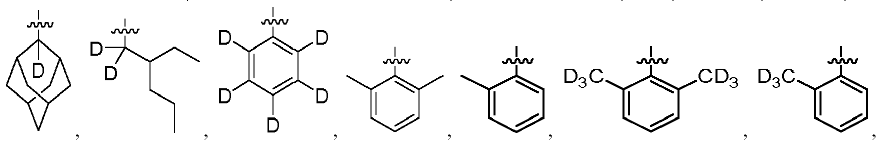

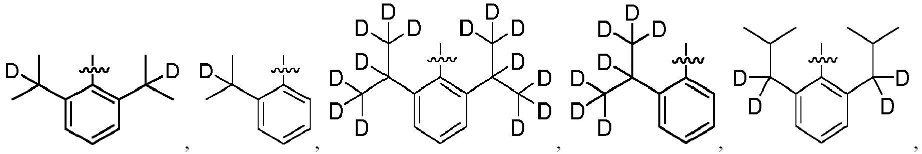

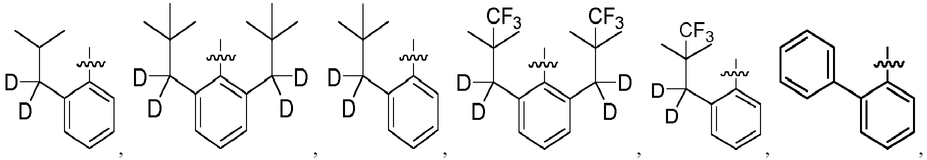

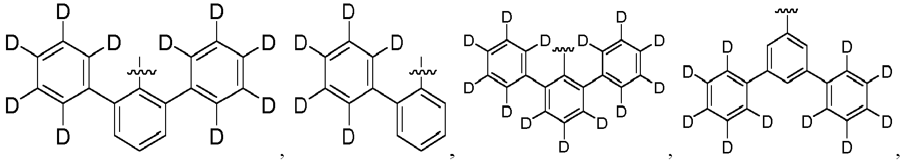

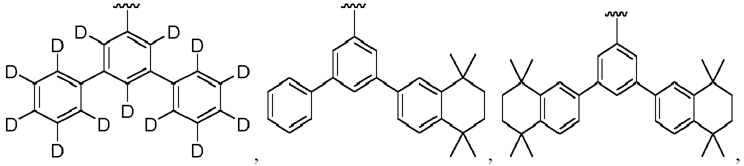

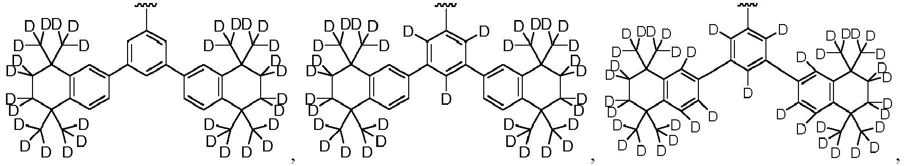

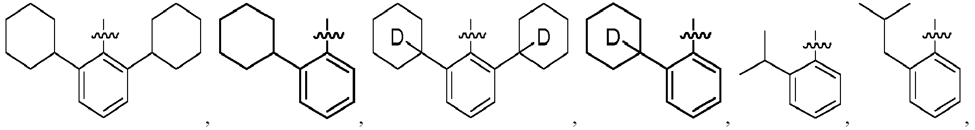

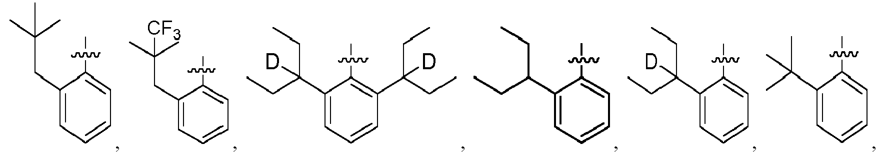

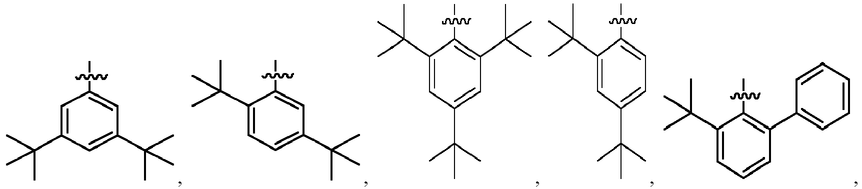

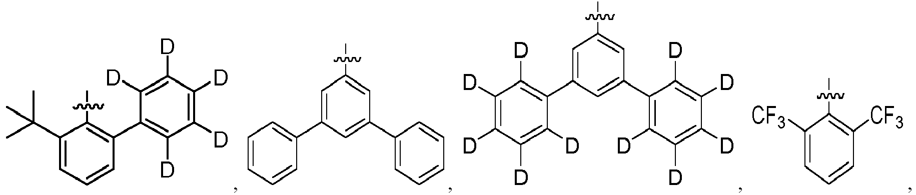

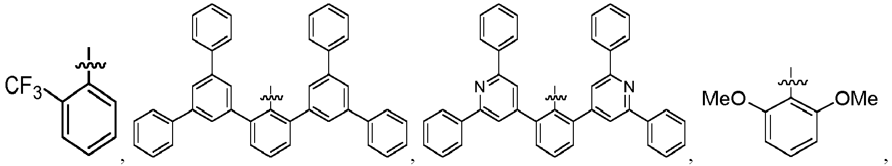

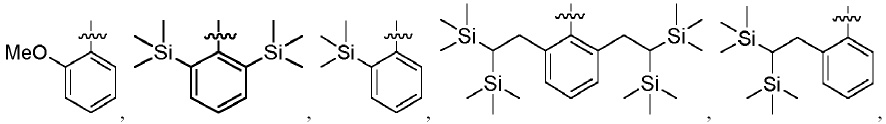

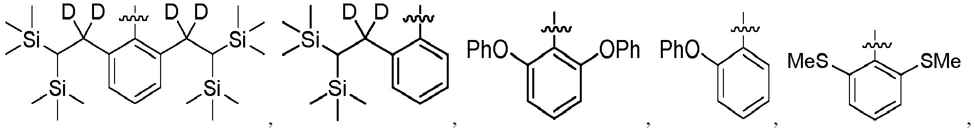

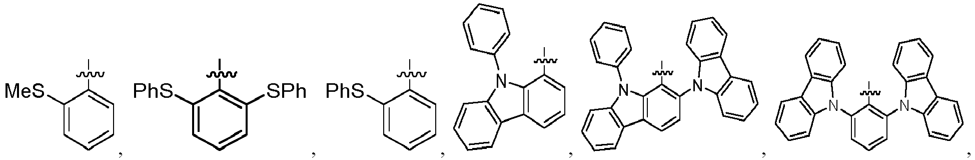

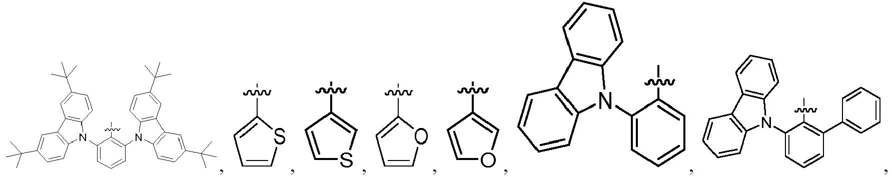

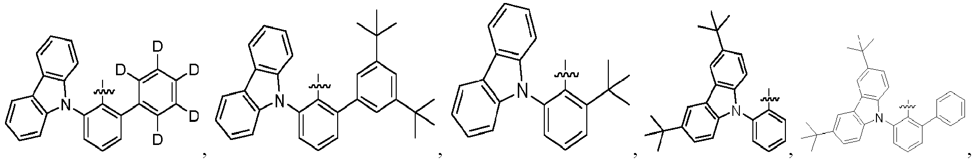

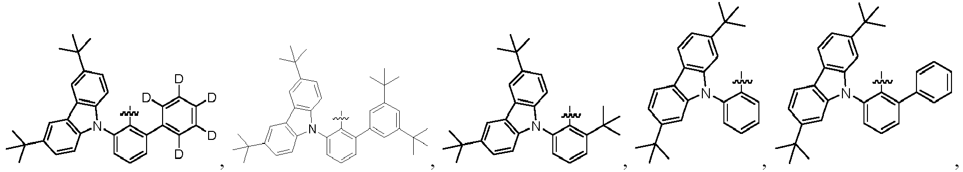

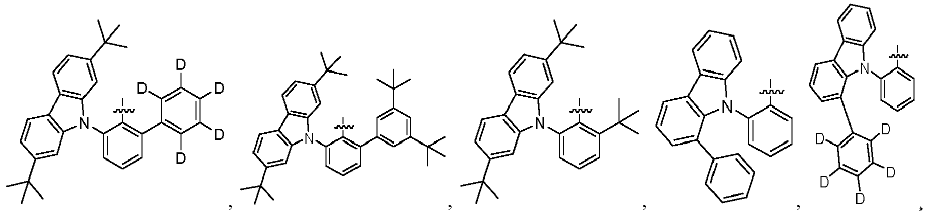

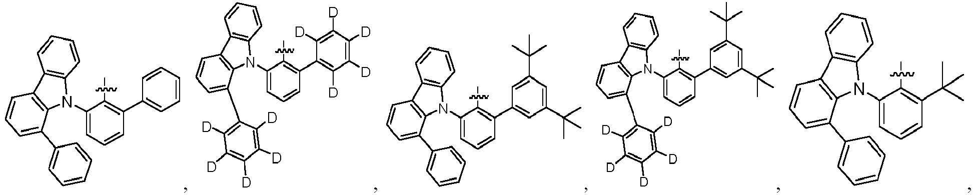

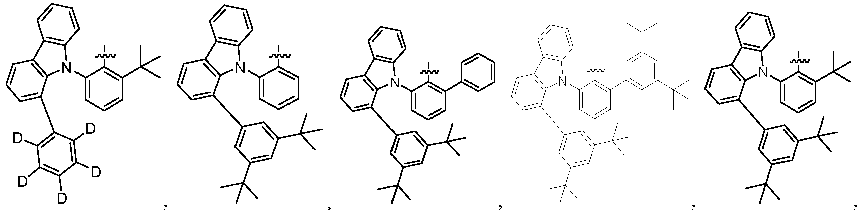

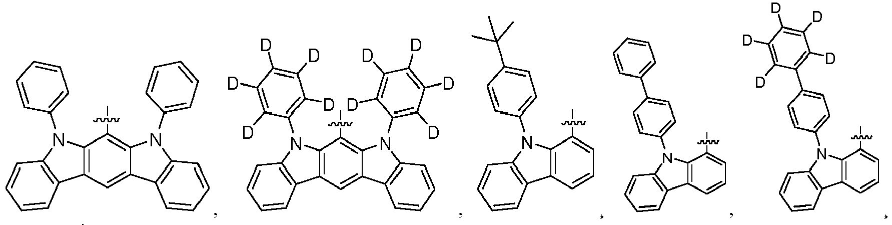

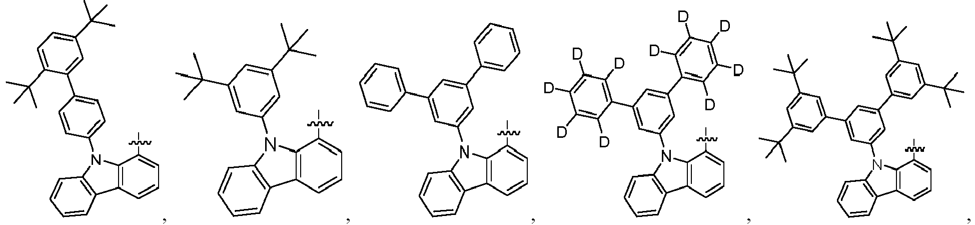

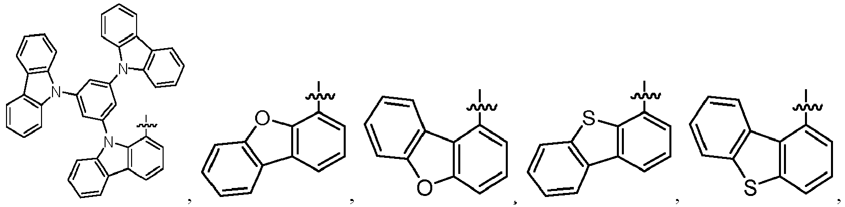

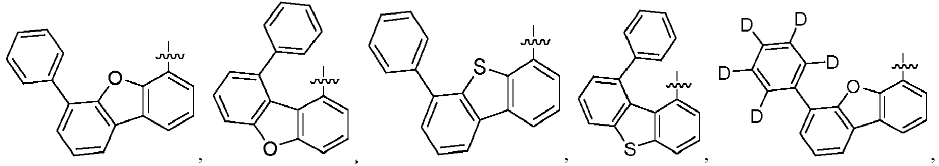

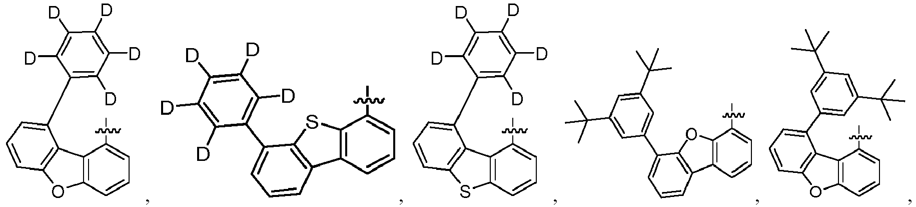

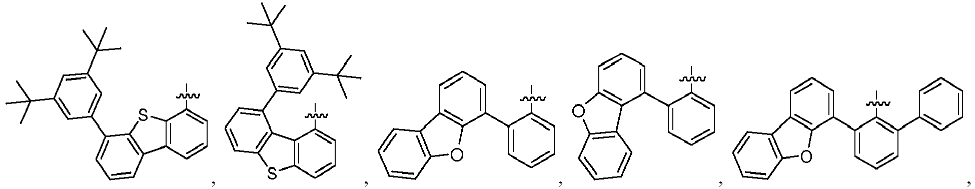

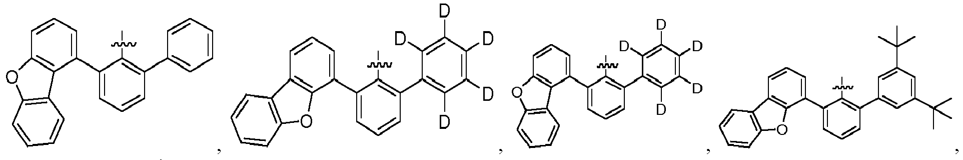

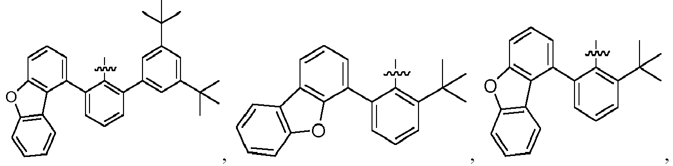

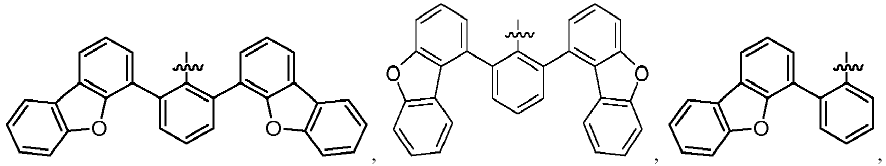

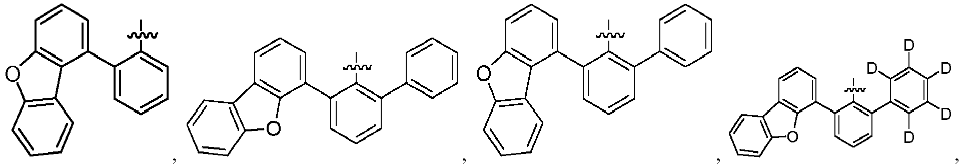

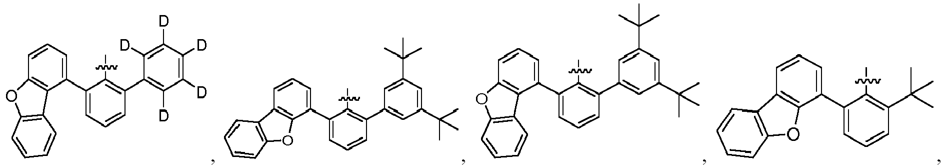

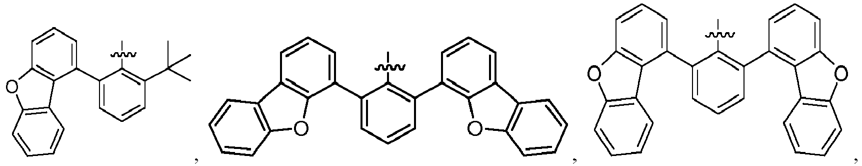

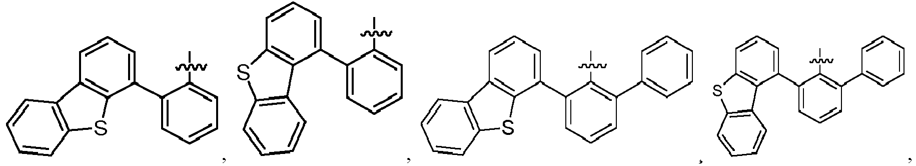

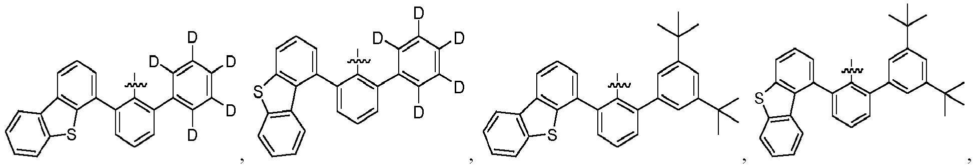

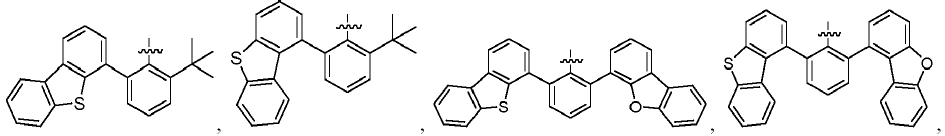

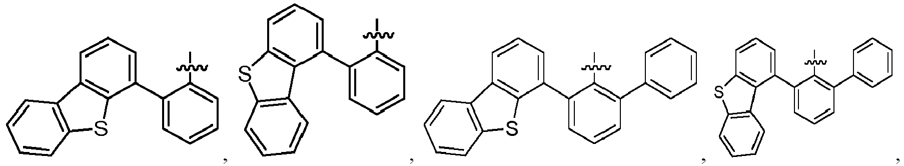

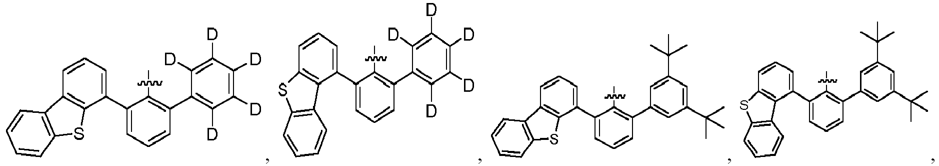

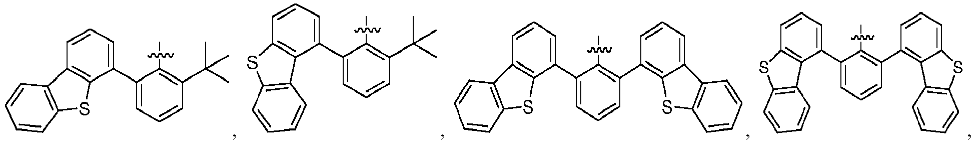

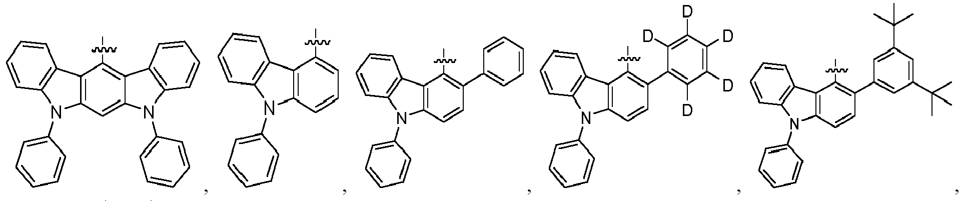

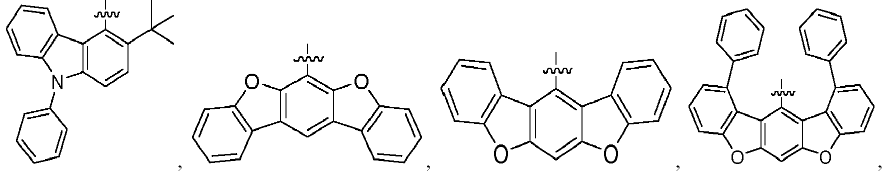

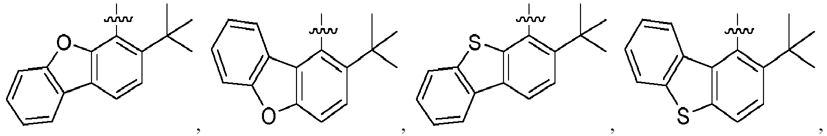

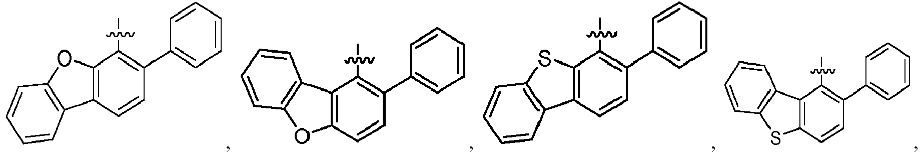

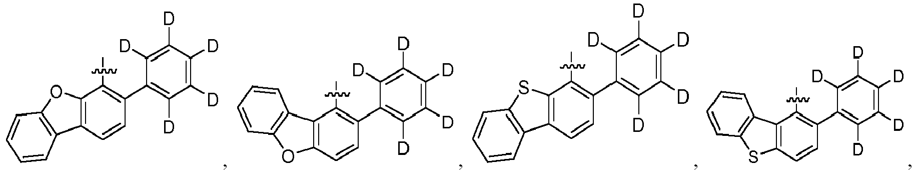

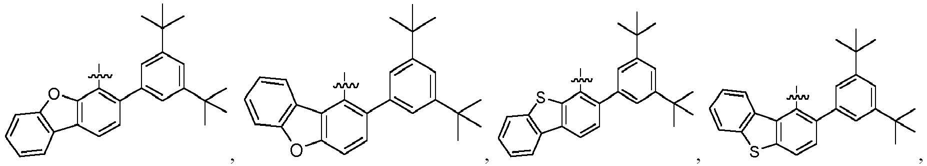

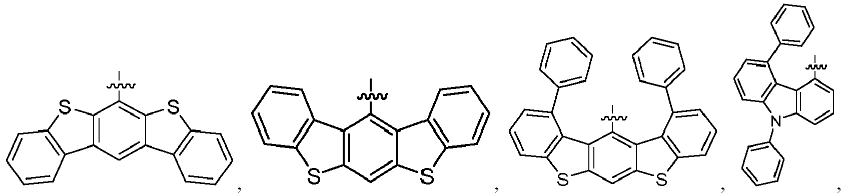

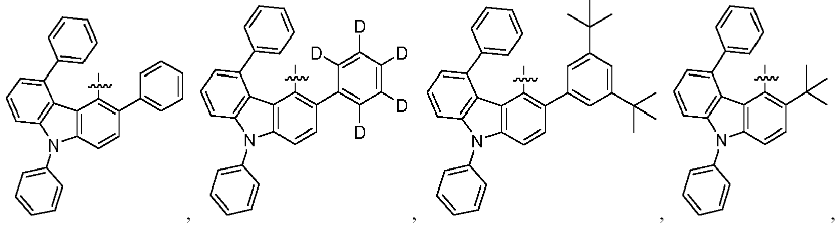

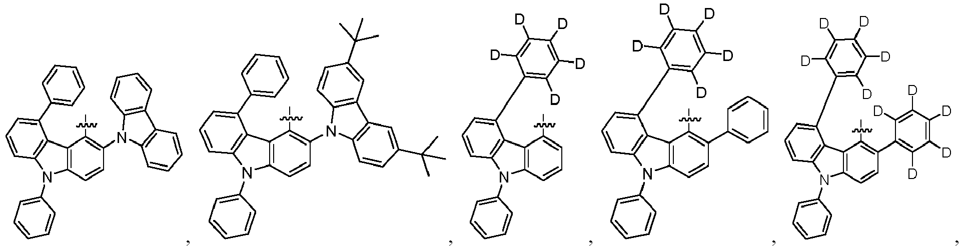

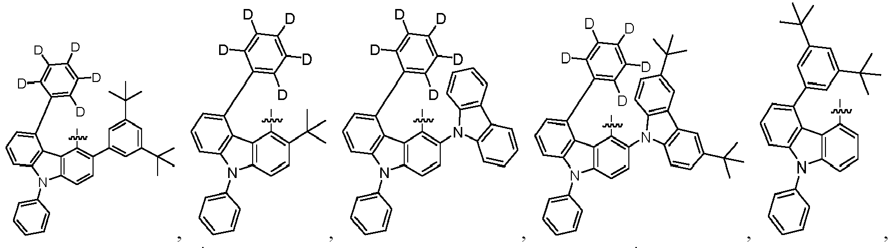

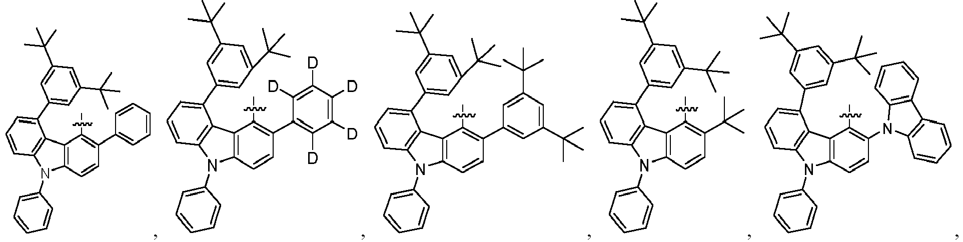

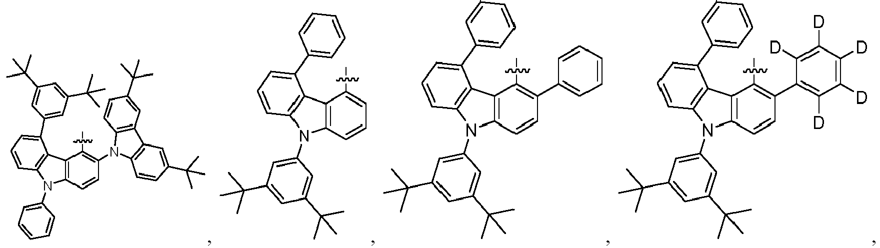

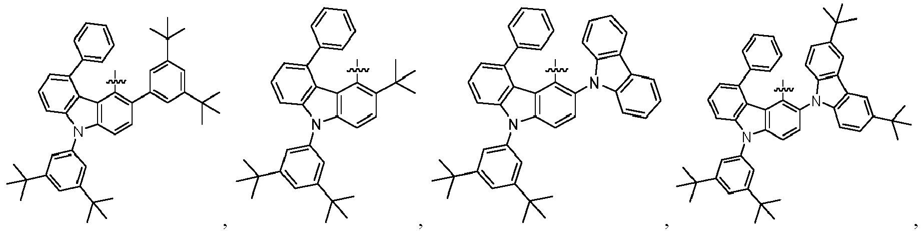

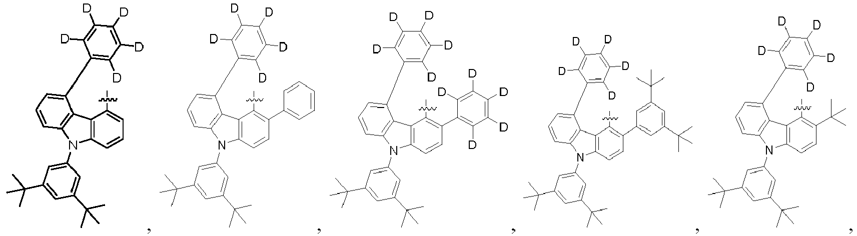

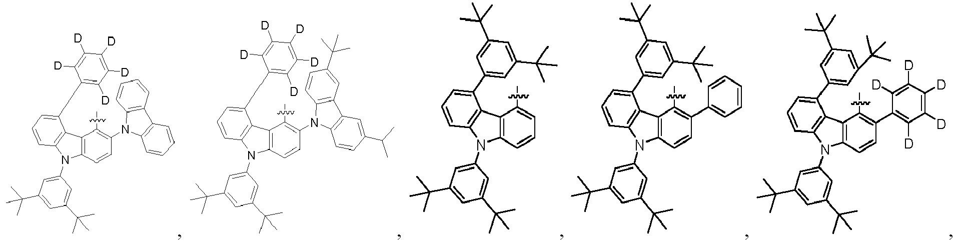

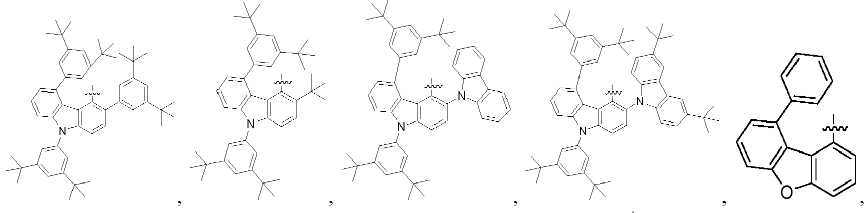

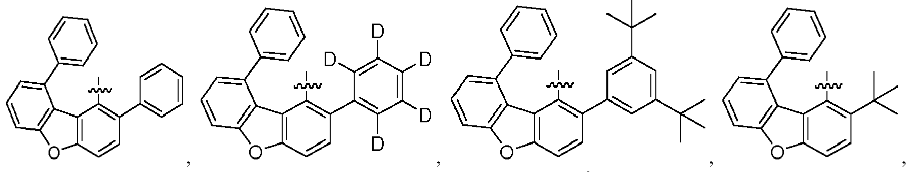

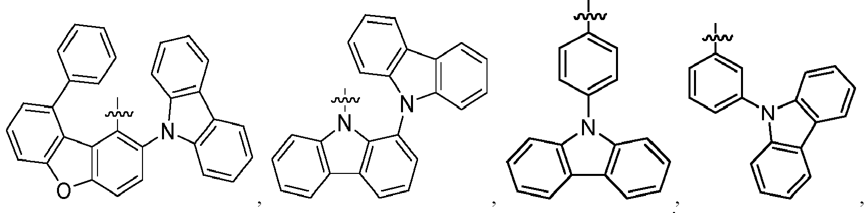

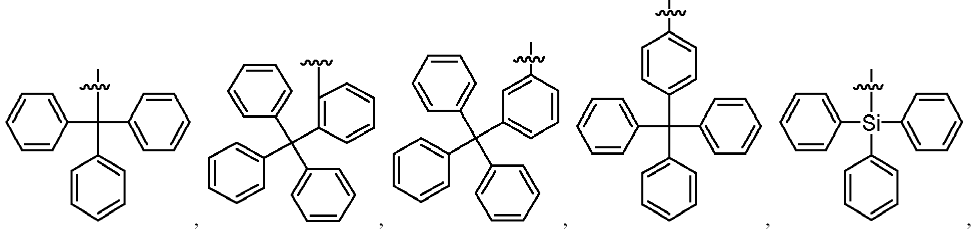

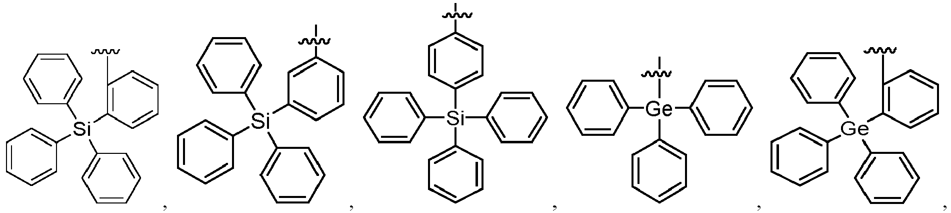

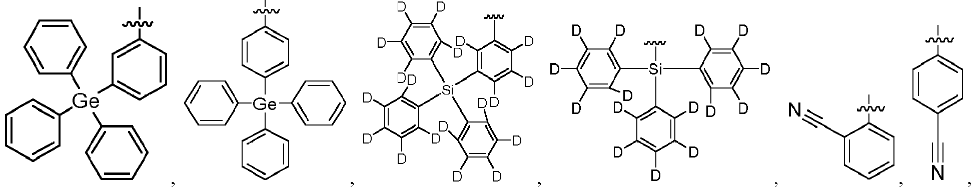

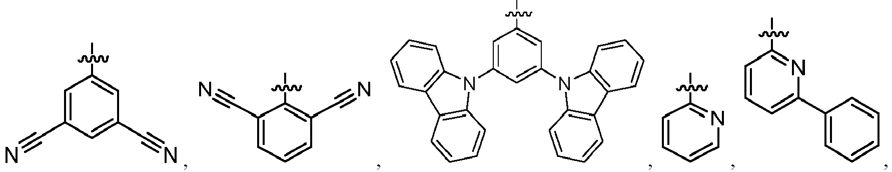

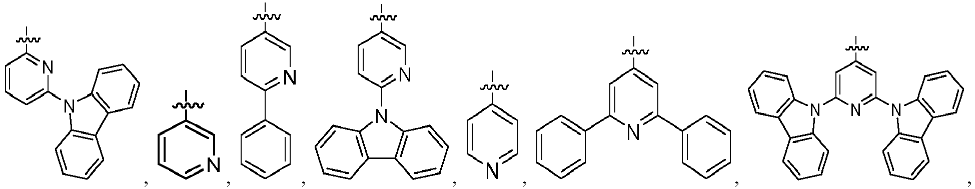

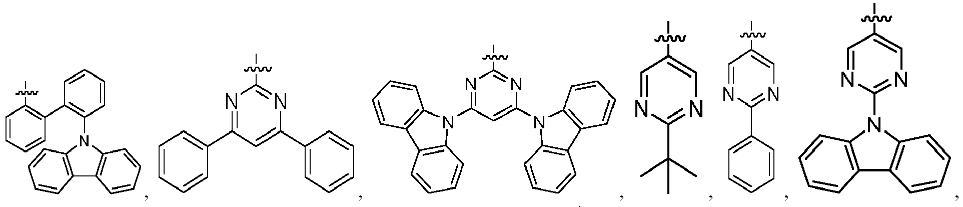

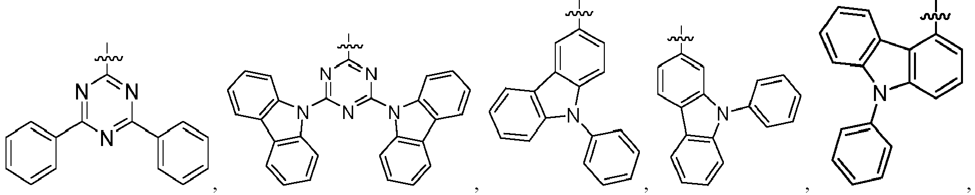

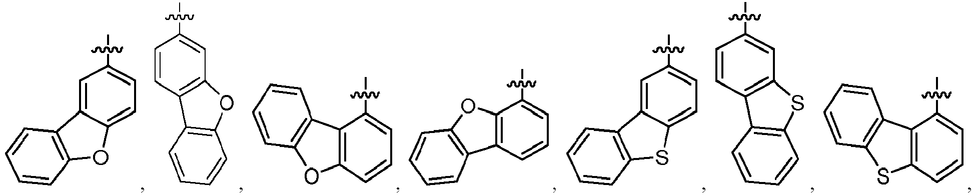

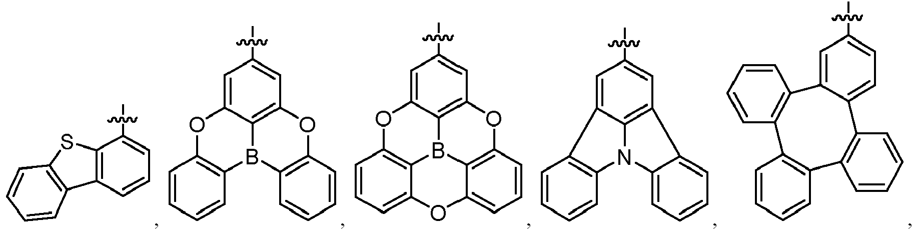

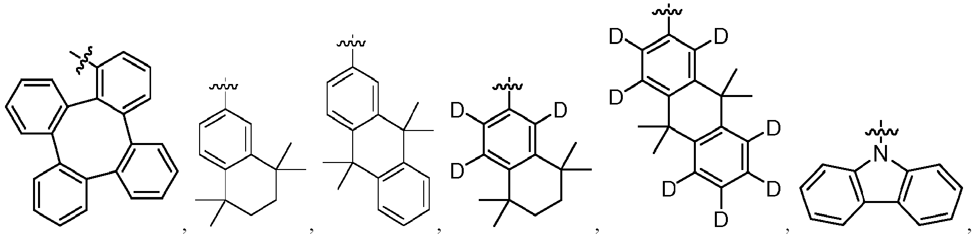

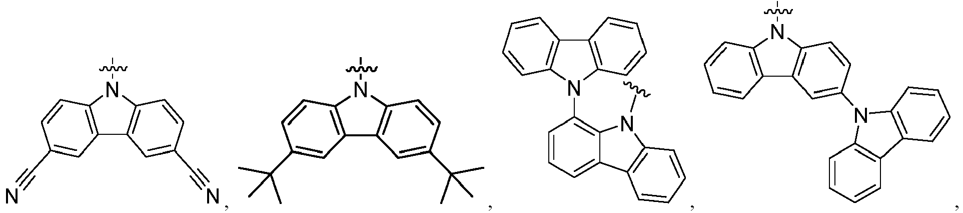

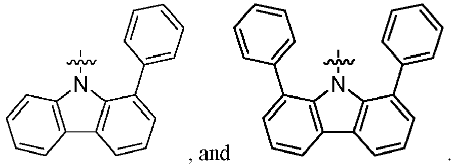

In some embodiments, the compound is selected from the group consisting of compounds having the formula of Pt(L_{A'})(L*y*): 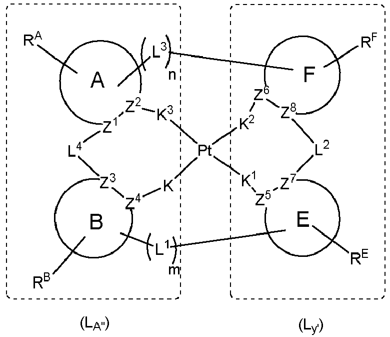 wherein L_{A"} is selected from the structures in the following LIST 19:

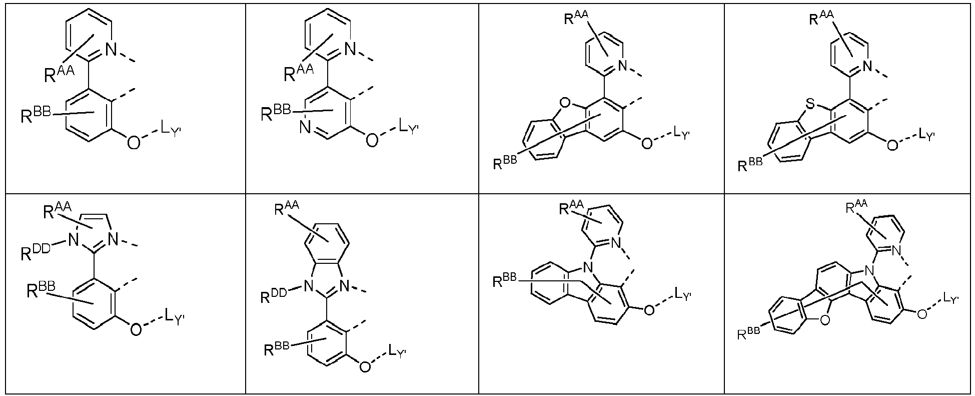

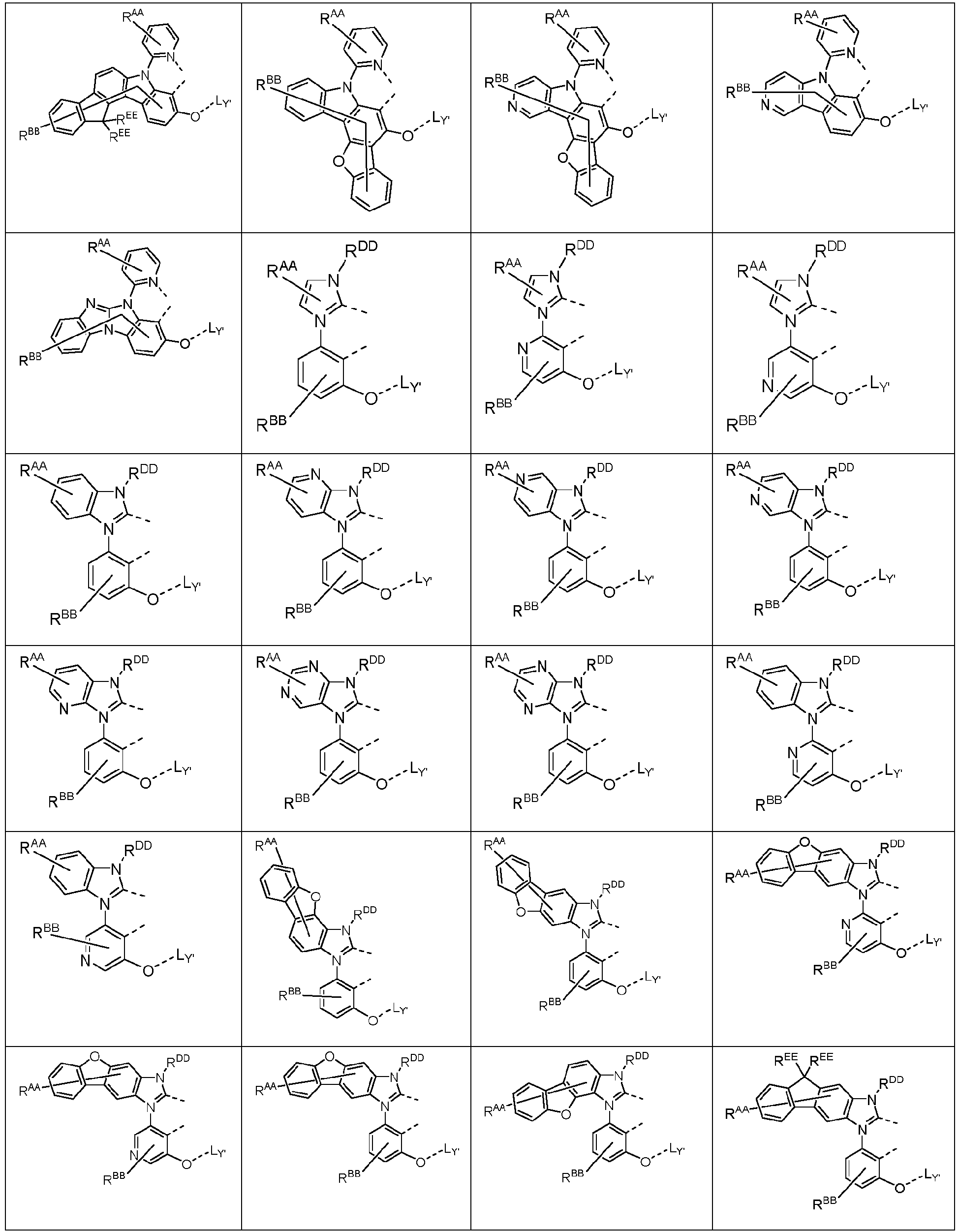

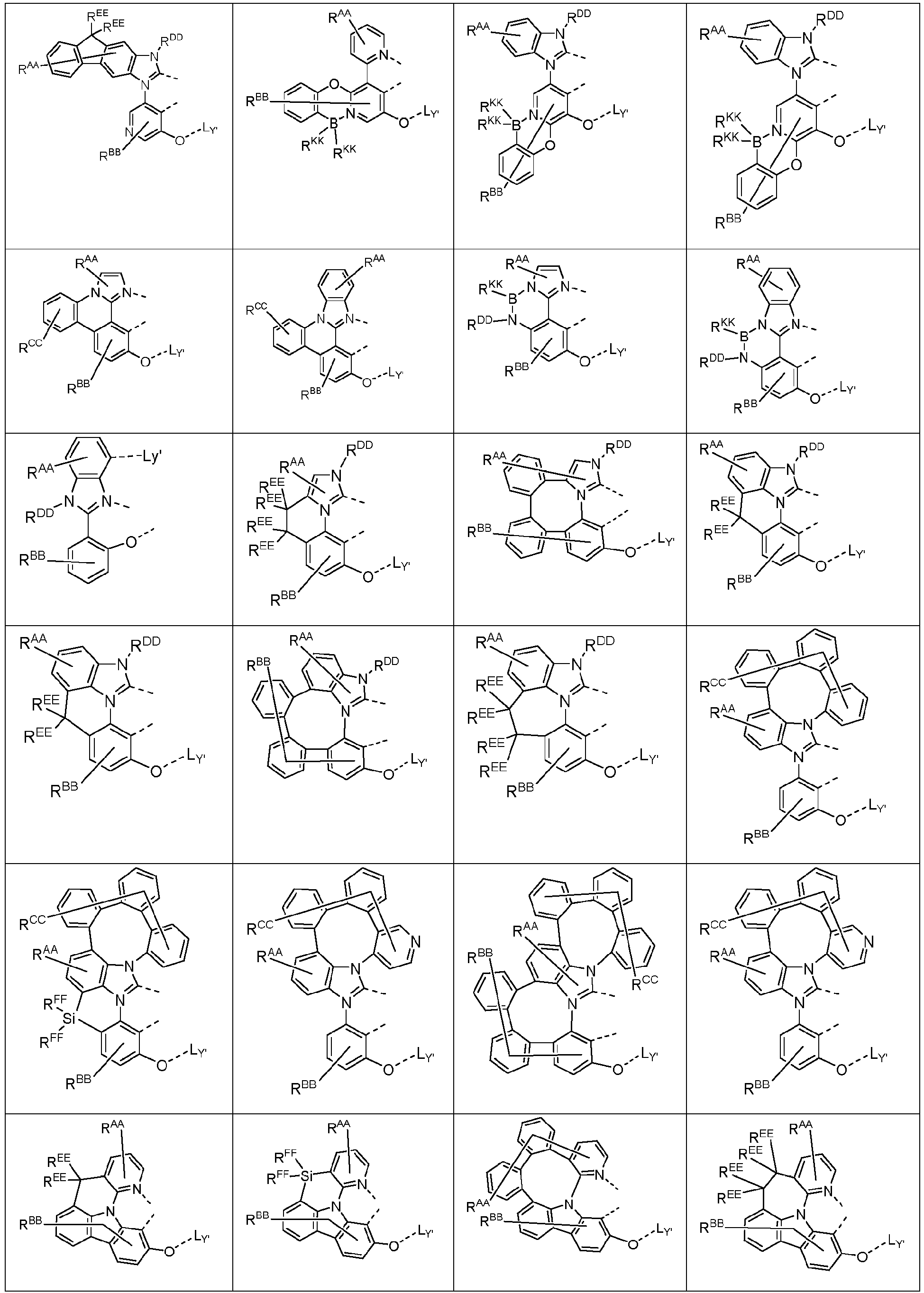

and wherein Ly" is the same as the structures in LIST 18.

In some embodiments, the compound is selected from the group consisting of compounds having the formula of Pt(L_{A"},)(L*y*'):
wherein L_{A'} is selected from the group consisting of L_{A"}1-(R*i*)(R*j*)(R*k*) - L_{A"}56-(R*i*)(R*j*)(R*k*) ); wherein each of *i,j, k,* /*, m, n, o, p,* and *q* is independently an integer from 1 to 135, and wherein each of L_{A"}1-(R*1*)(R*1*)(R*1*) to L_{A}56-*(R135)(R135)(R135)(R135)* is defined in the following LIST 20:

| | | | |
|---|---|---|---|
| L_{A"}1-(R*u*)(R*v*)(R*w*)(R*x*), wherein L_{A"}1-(R1)(R1)(R1)(R1) to L_{A"}1-(R135)(R135)(R135)(R 135) have the structure | 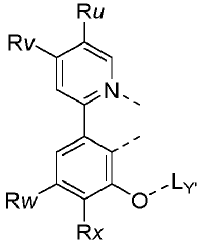 | L_{A"}29-(R*n*)(R*u*)(R*v*)(R*w*), wherein L_{A"}29-(R1)(R1)(R1)(R1) to L_{A"}2'9-(R135)(R135)(R135)(R13 5) have the structure | 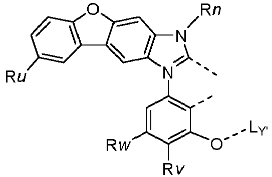 |
| L_{A"}2-(R*u*)(R*v*)(R*w*)(R*x*), wherein L_{A"}2-(R1)(R1)(R1)(R1) to L_{A"}2-(R135)(R135)(R135)(R 135) have the structure | 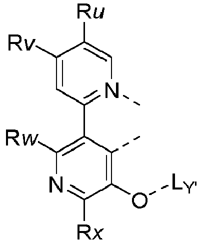 | L_{A"}30-(R*n*)(R*u*)(R*v*)(R*w*)(R*x*), wherein L_{A"}30-(R1)(R1)(R1)(R1)(R1) to L_{A"}30-(R135)(R135)(R135)(R13 5)(R135) have the structure | 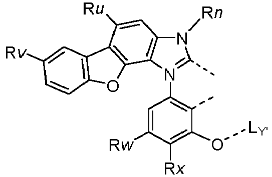 |
| L_{A"}3-(R*u*)(R*v*)(R*w*)(R*x*), wherein L_{A"}3 - (R1)(R1)(R1)(R1) to L_{A"}3-(R135)(R135)(R135)(R 135) have the structure | 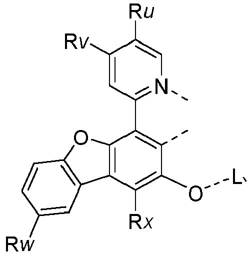 | L_{A"}31-(R*c'*)(R*n*)(R*u*)(R*v*)(R*w*), wherein L_{A"}31-(R1)(R1)(R1)(R1)(R1) to L_{A"}31-(R135)(R135)(R135)(R13 5)(R135) have the structure | 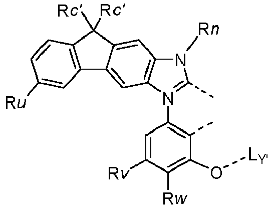 |
| L_{A"}4-(R*u*)(R*v*)(R*w*)(R*x*), wherein L_{A"}4-(R1)(R1)(R1)(R1) to L_{A"}4-(R135)(R135)(R135)(R 135) have the structure | 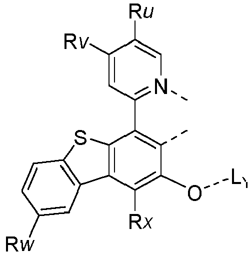 | L_{A"}32-(R*c*')(R*n*)(R*u*)(R*v*)(R*w*), wherein L_{A"}32-(R1)(R1)(R1)(R1)(R1) to L_{A"}32-(R135)(R135)(R135)(R13 5)(R135) have the structure | 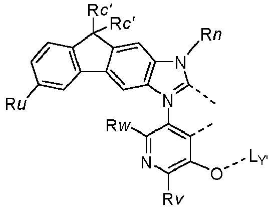 |
| L_{A"}5-(R*n*)(R*u*)(R*v*)(R*w*), wherein L_{A"}5-(R1)(R1)(R1)(R1) to L_{A"}5-(R135)(R135)(R135)(R 135) have the structure | 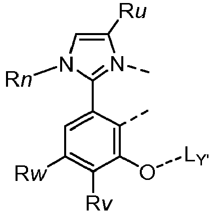 | L_{A"}33-(R*b*')(R*u*)(R*v*), wherein L_{A"}33-(R1)(R1)(R1) to L_{A"}33-(R135)(R135)(R135) have the structure | 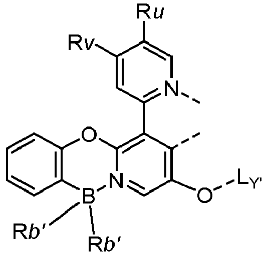 |
| L_{A"}6-(R*n*)(R*u*)(R*v*), wherein L_{A"}6-(R1)(R1)(R1) to L_{A"}6-(R135)(R135)(R135) have the structure | 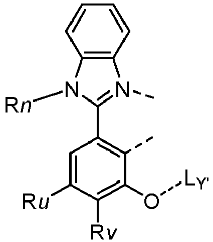 | L_{A"}34-(R*b*')(R*n*)(R*u*)(R*v*), wherein L_{A"}34-(R1)(R1)(R1)(R1) to L_{A"}34-(R135)(R135)(R135)(R13 5) have the structure | 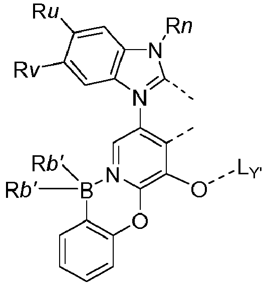 |
| L_{A"}7-(R*u*)(R*v*)(R*w*)(R*x*), wherein L_{A"}7-(R1)(R1)(R1)(R1) to L_{A"}7-(R135)(R135)(R135)(R 135) have the structure | 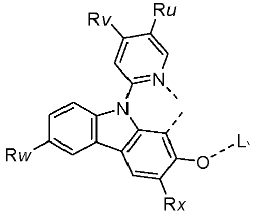 | L_{A"}35-(R*b* ')(R*n*)(R*u*)(R*v*), wherein L_{A"}35-(R1)(R1)(R1)(R1) to L_{A"}35-(R135)(R135)(R135)(R13 5) have the structure | 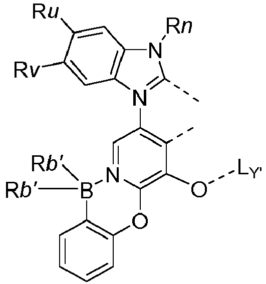 |
| LA' 8-(R*u*)(R*v*)(R*w*)(R*x*), wherein L_{A'} 8-(R1)(R1)(R1)(R1) to L_{A'} 8-(R135)(R135)(R135)(R 135) have the structure | 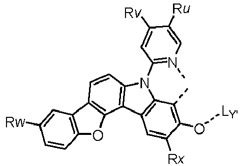 | L_{A"}36-(R*u*)(R*v*)(R*w*), wherein L_{A"}36-(R1)(R1)(R1) to L_{A"}36-(R135)(R135)(R135) have the structure | 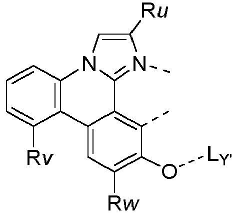 |
| L_{A"}9-(R*c* ')(R*u*)(R*v*)(R*w*)(R*x*) , wherein L_{A"}9-(R1)(R1)(R1)(R1)(R1) to L_{A"}9-(R135)(R135)(R135)(R 135)(R135) have the structure | 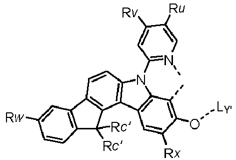 | L_{A"}37-(R*u*)(R*v*)(R*w*), wherein L_{A"}37-(R1)(R1)(R1) to L_{A"}37-(R135)(R135)(R135) have the structure | 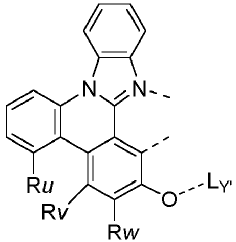 |
| L_{A"}10-(R*u*)(R*v*)(R*w*), wherein L_{A"}10-(R1)(R1)(R1) to L_{A"}10-(R135)(R135)(R135) have the structure | 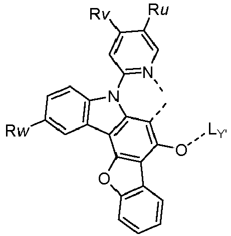 | L_{A"}38-(R*b* ')(R*n*)(R*u*)(R*v*)(R*w*), wherein L_{A"}38-(R1)(R1)(R1)(R1)(R1) to L_{A"}38-(R135)(R135)(R135)(R13 5)(R135) have the structure | 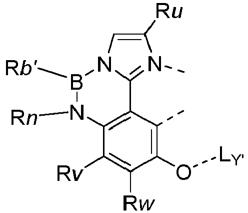 |
| L_{A"}11-(R*u*)(R*v*)(R*w*)(R*x*)(R*y*), wherein L_{A"} 11-(R1)(R1)(R1)(R1)(R1) to L_{A"}11-(R135)(R135)(R135)(R 135)(R135) have the structure | 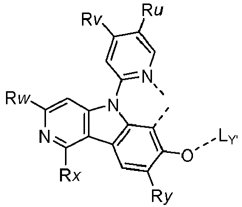 | L_{A"}39-(R*b* ')(R*n*)(R*u*)(R*v*), wherein L_{A"}39-(R1)(R1)(R1)(R1) to L_{A"}39-(R135)(R135)(R135)(R13 5) have the structure | 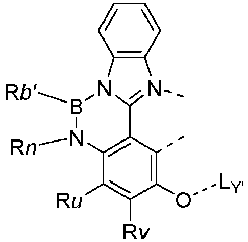 |
| L_{A"} 12-(R*u*)(R*v*)(R*w*)(R*x*), wherein L_{A"}12-(R1)(R1)(R1)(R1) to L_{A"}12-(R135)(R135)(R135)(R 135) have the structure | 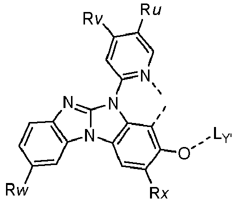 | L_{A"}40-(R*n*)(R*u*)(R*v*), wherein L_{A"}40-(R1)(R1)(R1) to L_{A"}40-(R135)(R135)(R135) have the structure | 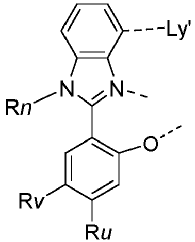 |
| L_{A"} 13-(R*n*)(R*u*)(R*v*)(R*w*)(R*x*), wherein L_{A"}13-(R1)(R1)(R1)(R1)(R1) to L_{A"}13-(R135)(R135)(R135)(R 135)(R135) have the structure | 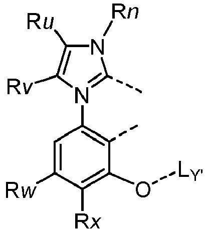 | L_{A"}41-(R*c*')(R*n*)(R*u*)(R*v*)(R*w*), wherein L_{A"}41-(R1)(R1)(R1)(R1)(R1) to L_{A"}41-(R135)(R135)(R135)(R13 5)(R135) have the structure | 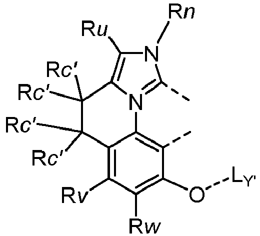 |
| L_{A"}14-(R*n*)(R*u*)(R*v*)(R*w*)(R*x*), wherein L_{A"}14-(R1)(R1)(R1)(R1)(R1) to L_{A"}14-(R135)(R135)(R135)(R 135)(R135) have the structure | 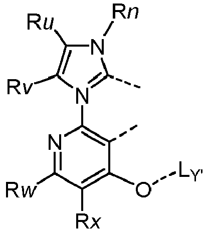 | L_{A"}42-(R*n*)(R*u*)(R*v*)(R*w*), wherein L_{A"}42-(R1)(R1)(R1)(R1) to L_{A"}42-(R135)(R135)(R135)(R13 5) have the structure | 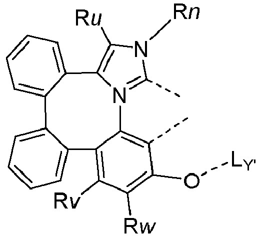 |
| L_{A"} 15-(R*n*)(R*u*)(R*v*)(R*w*)(R*x*), wherein L_{A"} 15-(R1)(R1)(R1)(R1)(R1) to L_{A"}15-(R135)(R135)(R135)(R 135)(R135) have the structure | 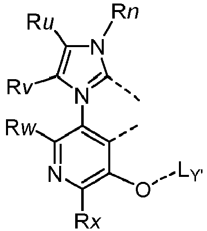 | L_{A"}43-(R*c*')(R*n*)(R*u*)(R*v*)(R*w*)(R *x*), wherein L_{A"}43-(R1)(R1)(R1)(R1)(R1)(R 1) to L_{A"}43-(R135)(R135)(R135)(R13 5)(R135)(R135) have the structure | 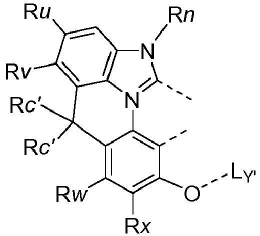 |
| L_{A"}16-(R*n*)(R*u*)(R*v*)(R*w*)(R*x*), wherein L_{A"}16-(R1)(R1)(R1)(R1)(R1) to L_{A"16}-(R135)(R135)(R135)(R 135)(R135) have the structure | 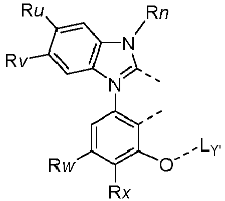 | L_{A"}44-(R*c*')(R*n*)(R*u*)(R*v*)(R*w*)(R *x*), wherein L_{A"}44-(R1)(R1)(R1)(R1)(R1)(R 1) to L_{A"}44-(R135)(R135)(R135)(R13 5)(R135)(R135) have the structure | 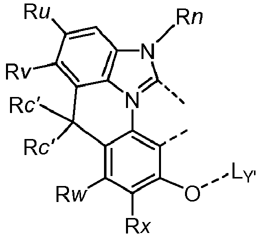 |
| L_{A"}17-(R*n*)(R*u*)(R*v*)(R*w*)(R*x*), wherein L_{A"}17-(R1)(R1)(R1)(R1)(R1) to L_{A"}17-(R135)(R135)(R135)(R 135)(R135) have the structure | 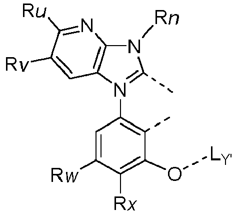 | L_{A"}45-(R*n*)(R*u*)(R*v*)(R*w*)(R*x*), wherein L_{A"}45-(R1)(R1)(R1)(R1)(R1) to L_{A"}45-(R135)(R135)(R135)(R13 5)(R135) have the structure | 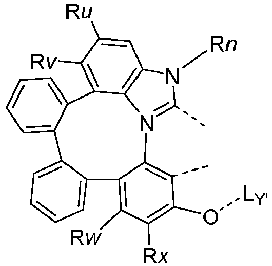 |
| L_{A"}18-(R*n*)(R*u*)(R*v*)(R*w*)(R*x*), wherein L_{A"}18-(R1)(R1)(R1)(R1)(R1) to L_{A"18}-(R135)(R135)(R135)(R 135)(R135) have the structure | 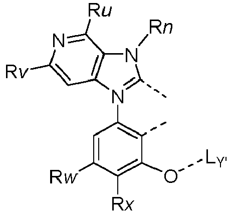 | L_{A"}46-(R*c*')(R*n*)(R*u*)(R*v*)(R*w*)(R *x*), wherein L_{A"}46-(R1)(R1)(R1)(R1)(R1)(R 1) to L_{A"}46-(R135)(R135)(R135)(R13 5)(R135)(R135) have the structure | 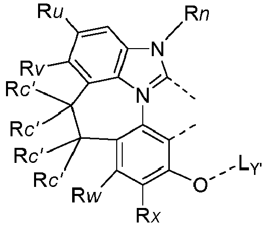 |
| L_{A"}19-(R*n*)(R*u*)(R*v*)(R*w*)(R*x*), wherein L_{A"}19-(R1)(R1)(R1)(R1)(R1) to L_{A"}19-(R135)(R135)(R135)(R 135)(R135) have the structure | 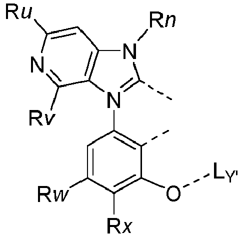 | L_{A"}47-(R*u*)(R*v*)(R*w*)(R*x*)(R*y*), wherein L_{A"}47-(R1)(R1)(R1)(R1)(R1) to L_{A"}47-(R135)(R135)(R135)(R13 5)(R135) have the structure | 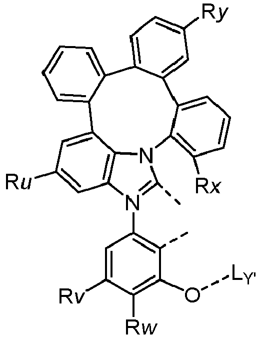 |
| L_{A"}20-(R*n*)(R*u*)(R*v*)(R*w*)(R*x*), wherein L_{A"}20-(R1)(R1)(R1)(R1)(R1) to L_{A"}20-(R135)(R135)(R135)(R 135)(R135) have the structure | 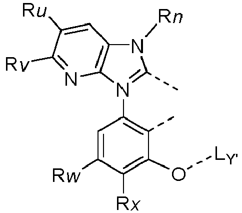 | L_{A"}48-(R*s*')(R*n*)(R*v*)(R*w*)(R*x*)(R *y*), wherein L_{A"}48-(R1)(R1)(R1)(R1)(R1)(R 1) to L_{A"}48-(R135)(R135)(R135)(R13 5)(R135)(R135) have the structure | 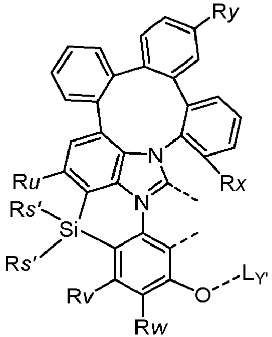 |
| L_{A"}21-(R*n*)(R*u*)(R*v*)(R*w*)(R*x*), wherein L_{A"}21-(R1)(R1)(R1)(R1)(R1) to L_{A"}21-(R135)(R135)(R135)(R 135)(R135) have the structure | 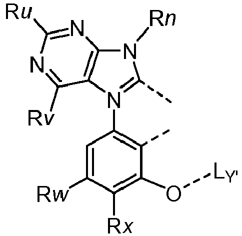 | L_{A"}49-(R*u*)(R*v*)(R*w*)(R*x*)(R*y*)(R*z* )(R*z*'), wherein L_{A"}49-(R1)(R1)(R1)(R1)(R1)(R 1)(R1) to L_{A"}49-(R135)(R135)(R135)(R13 5)(R135)(R135)(R135) have the structure | 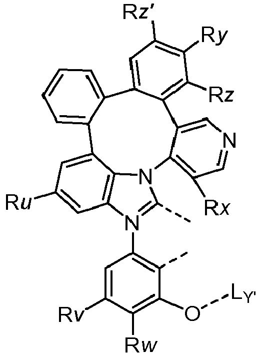 |
| L_{A"}22-(R*n*)(R*u*)(R*v*)(R*w*)(R*x*), wherein L_{A"}22-(R1)(R1)(R1)(R1)(R1) to L_{A"}22-(R135)(R135)(R135)(R 135)(R135) have the structure | 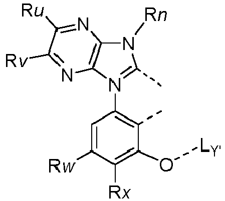 | L_{A"}50-(R*u*)(R*v*)(R*w*)(R*x*)(R*y*)(R*z* ), wherein L_{A"}50-(R1)(R1)(R1)(R1)(R1)(R 1) to L_{A"}50-(R135)(R135)(R135)(R13 5)(R135)(R135) have the structure | 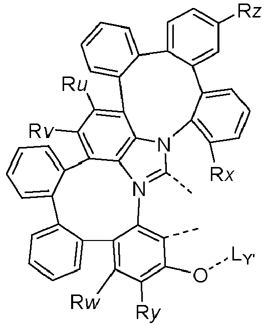 |
| L_{A"}23-(R*n*)(R*u*)(R*v*)(R*w*)(R*x*), wherein L_{A"}23-(R1)(R1)(R1)(R1)(R1) to L_{A"}23-(R135)(R135)(R135)(R 135)(R135) have the structure | 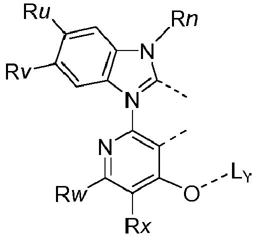 | L_{A"}51-(R*u*)(R*v*)(R*w*)(R*x*)(R*y*)(R*z* ), wherein L_{A"}51-(R1)(R1)(R1)(R1)(R1)(R 1) to L_{A"}51-(R135)(R135)(R135)(R13 5)(R135)(R135) have the structure | 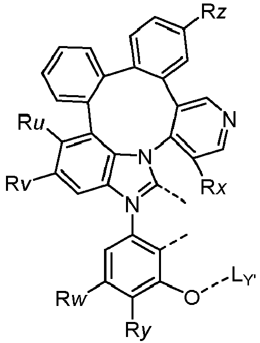 |
| L_{A"}24-(R*n*)(R*u*)(R*v*)(R*w*)(R*x*), wherein L_{A"}24-(R1)(R1)(R1)(R1)(R1) to L_{A"}24-(R135)(R135)(R135)(R 135)(R135) have the structure | 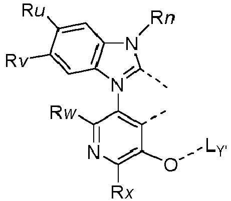 | L_{A"}52-(R*c*')(R*u*)(R*v*)(R*w*), wherein L_{A"}52-(R1)(R1)(R1)(R1) to L_{A"}52-(R135)(R135)(R135)(R13 5) have the structure | 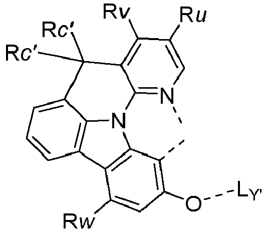 |
| L_{A"}25-(R*n*)(R*u*)(R*v*)(R*w*), wherein L_{A"}25-(R1)(R1)(R1)(R1) to L_{A"}25-(R135)(R135)(R135)(R 135) have the structure | 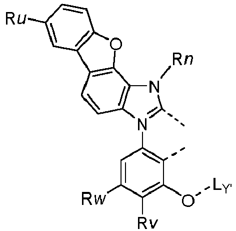 | L_{A"}53-(R*s*')(R*u*)(R*v*)(R*w*)(R*x*), wherein L_{A"}53-(R1)(R1)(R1)(R1)(R1) to L_{A"}53-(R135)(R135)(R135)(R13 5)(R135) have the structure | 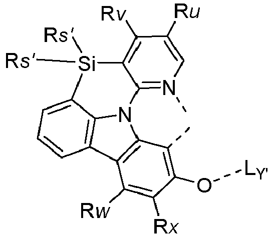 |
| L_{A"}26-(R*n*)(R*u*)(R*v*)(R*w*), wherein L_{A"}26-(R1)(R1)(R1)(R1) to L_{A"}26-(R135)(R135)(R135)(R 135) have the structure | 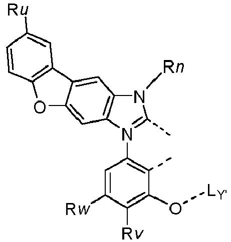 | L_{A"}54-(R*u*)(R*v*)(R*w*)(R*x*), wherein L_{A"}54-(R1)(R1)(R1)(R1) to L_{A"}54-(R135)(R135)(R135)(R13 5) have the structure | 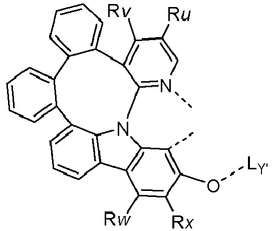 |
| L_{A"}27-(R*n*)(R*u*)(R*v*)(R*w*), wherein L_{A"}27-(R1)(R1)(R1)(R1) to L_{A"}27-(R135)(R135)(R135)(R 135) have the structure | 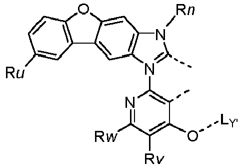 | L_{A"}55-(R*c*')(R*u*)(R*v*)(R*w*)(R*x*), wherein L_{A"}55-(R1)(R1)(R1)(R1)(R1) to L_{A"}55-(R135)(R135)(R135)(R13 5)(R135) have the structure | 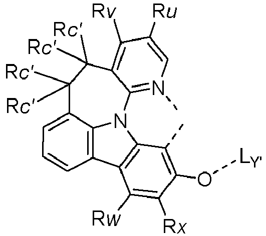 |
| L_{A"}28-(R*n*)(R*u*)(R*v*)(R*w*), wherein L_{A"}28-(R1)(R1)(R1)(R1) to L_{A"}28-(R135)(R135)(R135)(R 135) have the structure | 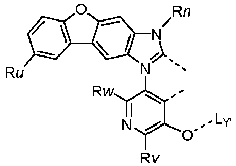 | L_{A"}56-(R*u*)(R*v*)(R*w*)(R*x*), wherein L_{A"}56-(R1)(R1)(R1)(R1) to L_{A"}56-(R135)(R135)(R135)(R13 5) have the structure | 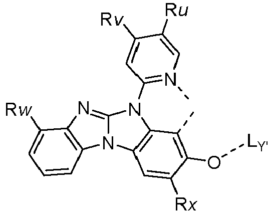 |

wherein L_{*y*'} is selected from the group consisting of the structures in the following LIST 21:

| L_{y} | Structure of L*_{y}* | L_{y} | Structure of L*_{y}* |
|---|---|---|---|
| L_{y'}1-(R*q*)(R*r*)(R*s*), wherein L_{y'}1-(R1)(R1)(R1) to L_{y'}1-(R135)(R135)(R135) have the structure | 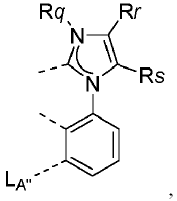 | L_{y'} 18-(Rq)(Rr)(Rt'), wherein L_{y'}18-(R1)(R1)(R1) to L_{y'}18-(R135)(R135)(R135) have the structure | 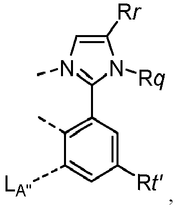 |
| L_{y'}2-(R*q*)(R*r*)(R*s*), wherein L_{y'}2-(R1)(R1)(R1) to L_{y'}2-(R135)(R135)(R135) have the structure | 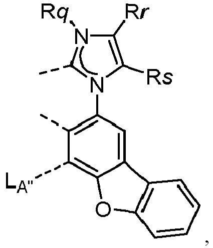 | L_{y'}19-(R*_{q}*)(R*r*)(R*t '*), wherein L_{y'} 19-(R1)(R1)(R1) to L_{y'}19-(R135)(R135)(R135) have the structure | 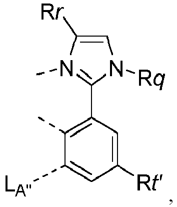 |
| L_{y'}3-(R*q*)(R*r*)(R*t* '), wherein L_{y'}3-(R1)(R1)(R1) to L_{y'}3-(R135)(R135)(R135) have the structure | 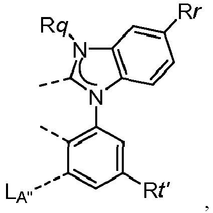 | L_{y'}20-(R*r*)(R*s*)(R*t* '), wherein L_{y'}20-(R1)(R1)(R1) to L_{y'}20-(R135)(R135)(R135) have the structure | 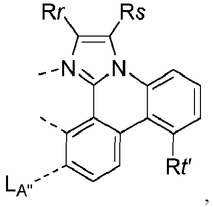 |
| L_{y'}4-(R*q*)(R*r*)(R*s*), wherein L_{y'}4-(R1)(R1)(R1) to L_{y'}4-(R135)(R135)(R135) have the structure | 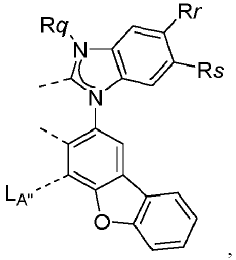 | L_{y'}21-(Rq)(R*r*)(R*t* '), wherein L_{y'}21-(R1)(R1)(R1) to L_{y'}21-(R135)(R135)(R135) have the structure | 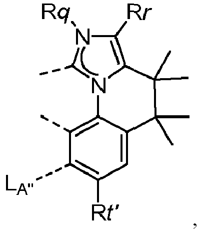 |
| L_{y'}5-(R*r*)(R*s*)(R*t* '), wherein L_{y'}5-(R1)(R1)(R1) to L_{y'}5-(R135)(R135)(R135) have the structure | 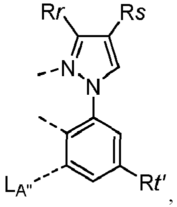 | L_{y'}22-(R*q*)(R*t* ')(R*w* '), wherein L_{y'}22-(R1)(R1)(R1) to L_{y'}22-(R135)(R135)(R135) have the structure | 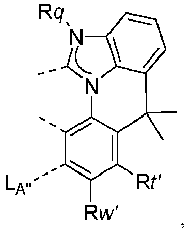 |
| L_{y'}6-(R*r*)(R*s*)(R*t* '), wherein L_{y'}6-(R1)(R1)(R1) to L_{y'}6-(R135)(R135)(R135) have the structure | 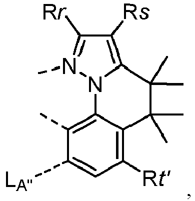 | L_{y'}23-(R*q*)(R*t* ')(R*w* '), wherein L_{y'}23-(R1)(R1)(R1) to L_{y'}23-(R135)(R135)(R135) have the structure | 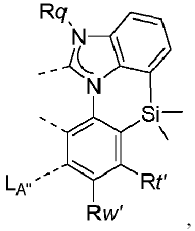 |
| L_{y'}7-(R*r*)(R*q*)(R*t* '), wherein L_{y'}7-(R1)(R1)(R1) to L_{y'}7-(R135)(R135)(R135) have the structure | 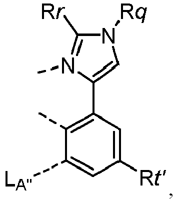 | L_{y'}24-(R*e* ')(R*q*)(R*s*), wherein L_{y'}24-(R1)(R1)(R1) to L_{y'}24-(R135)(R135)(R135) have the structure | 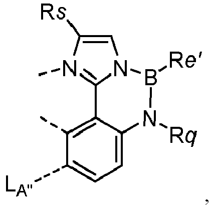 |
| L_{y'}8-(R*r*)(R*q*)(R*t* '), wherein L_{y'}8-(R1)(R1)(R1) to L_{y'}8-(R135)(R135)(R135) have the structure | 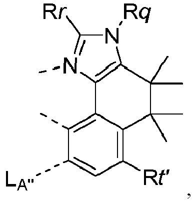 | L_{y'}25-(R*r*)(R*s*)(R*t* '), wherein L_{y'}25-(R1)(R1)(R1) to L_{y'}25-(R135)(R135)(R135) have the structure | 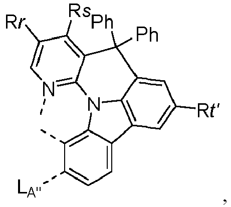 |
| L_{y'}9-(R*r*)(R*s*)(R*t* '), wherein L_{y'}9-(R1)(R1)(R1) to L_{y'}9-(R135)(R135)(R135) have the structure | 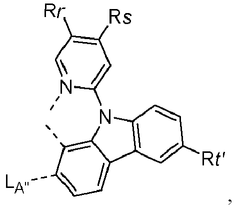 | L_{y'}26-(R*r*)(R*s*)(R*t* '). wherein L_{y'}26-(R1)(R1)(R1) to L_{y'}26-(R135)(R135)(R135) have the structure | 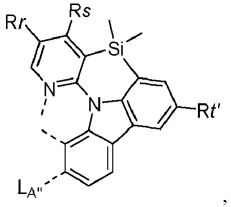 |
| L_{y'}10-(R*r*)(R*s*)(R*t* '), wherein L_{y'} 10-(R1)(R1)(R1) to L_{y'}10-(R135)(R135)(R135) have the structure | 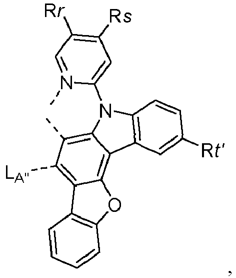 | L_{y'}27-(R*r*)(R*s*)(R*t* '), wherein L_{y'}27-(R1)(R1)(R1) to L_{y'}27-(R135)(R135)(R135) have the structure | 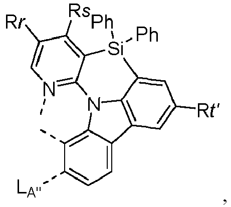 |
| L_{y'}11-(R*r*)(R*s*)(R*t* '), wherein L_{y'}11-(R1)(R1)(R1) to L_{y'}11-(R135)(R135)(R135) have the structure | 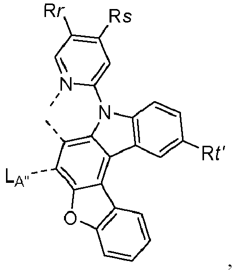 | L_{y'}28-(R*r*)(R*s*)(R*t* '), wherein L_{y'}28-(R1)(R1)(R1) to L_{y'}28-(R135)(R135)(R135) have the structure | 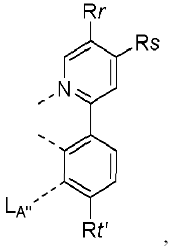 |
| L_{y'}12-(R*r*)(R*s*)(R*t* '), wherein L_{y'}12-(R1)(R1)(R1) to L_{y'}12-(R135)(R135)(R135) have the structure | 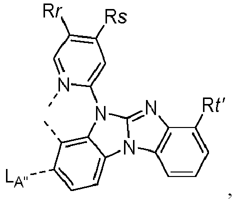 | L_{y'}29-(R*s*)(R*t* ')(R*w* '), wherein L_{y'}29-(R1)(R1)(R1) to L_{y'}29-(R135)(R135)(R135) have the structure | 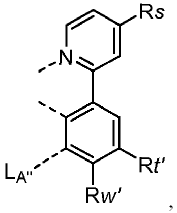 |
| L_{y'}13 -(R*r*)(R*s*)(R*t* '), wherein L_{y'}13-(R1)( R1)(R1) to L_{y'}13-(R135)(R135)(R135) have the structure | 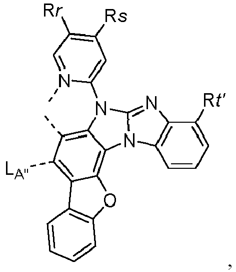 | L_{y'}30-(R*r*)(R*s*)(R*t* '), wherein L_{y'}30-(R1)(R1)(R1) to L_{y'}30-(R135)(R135)(R135) have the structure | 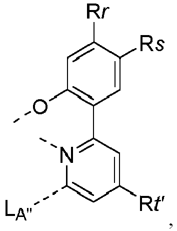 |
| L_{y'}14-(Rr)(Rs) Rt'), wherein L_{y'}14-(R1)(R1)(R1) to L_{y'}14-(R135)(R135)(R135) have the structure | 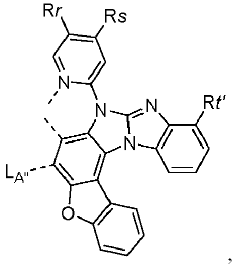 | L_{y}31-(R*q*)(R*r*)(R*s*), wherein L_{y}31-(R1)(R1)(R1) to L_{y}31-(R135) R135)(R135) have the structure | 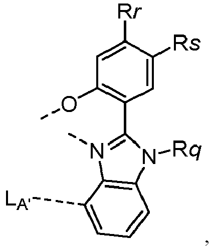 |
| L_{y'}15-(R*q*)(R*t*)(R*w* '), wherein L_{y'}15-(R1)(R1)(R1) to L_{y'}15-(R135)(R135)(R135) have the structure | 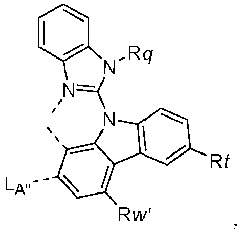 | L_{y'}32-(R*q*)(R*r*)(R*e* '), wherein L_{y'}32-(R1)(R1)(R1) to L_{y'}32-(R135)(R135)(R135) have the structure | 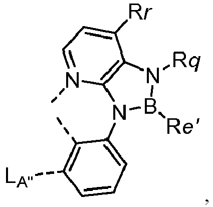 |
| L_{y'}16-(Rq)(Rt ')(Rw '), wherein Ly 16-(R1)(R1)(R1) to L_{y'}16-(R135)(R135)(R135) have the structure | 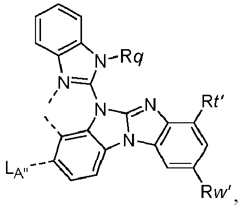 | L_{y'}33-(R*q*)(R*r*)(R*e* '), wherein L_{y'}33-(R1)(R1)(R1) to L_{y'}33-(R135)(R135)(R135) have the structure | 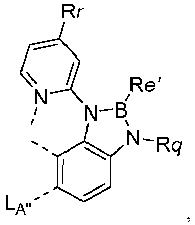 |
| L_{y'}17-(R*s*)(R*t* ')(R*w* '), wherein L_{y'}17-(R1)(R1)(R1) to L_{y'}17-(R135)(R135)(R135) have the structure | 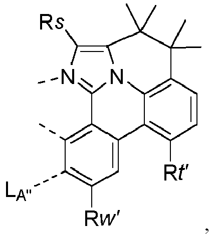 | | |

wherein each of n, u, v, w, x, y, z, q, r, s, b', c', e', t', w', and z' is independently an integer from 1 to 135;
wherein R1 to R135 are defined in the following LIST 21:

| | Structure | | Structure | | Structure |
|---|---|---|---|---|---|
| R1 | 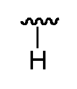 | R2 | 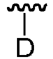 | R3 | 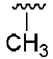 |
| R4 | 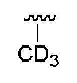 | R5 | 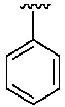 | R6 | 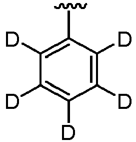 |
| R7 | 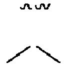 | R8 | 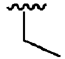 | R9 | 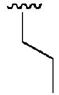 |
| R10 | 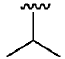 | R11 | 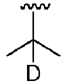 | R12 | 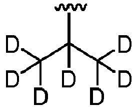 |
| R13 | 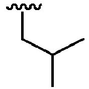 | R14 | 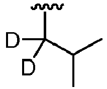 | R15 | 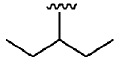 |
| R16 | 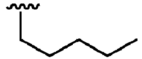 | R17 | 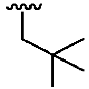 | R18 | 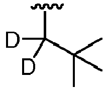 |
| R19 | 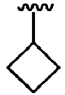 | R20 | 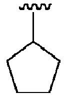 | R21 | 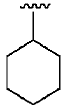 |
| R22 | 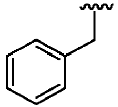 | R23 | 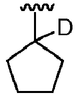 | R24 | 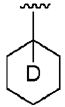 |
| R25 | 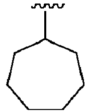 | R26 | 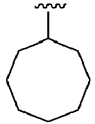 | R27 | 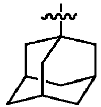 |
| R28 | 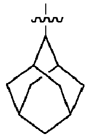 | R29 | 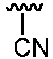 | R30 | 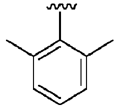 |
| R31 | 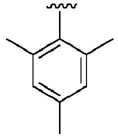 | R32 | 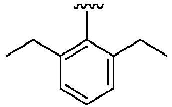 | R33 | 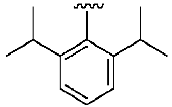 |
| R34 | 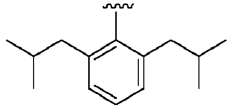 | R35 | 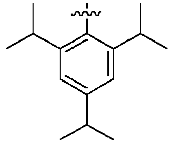 | R36 | 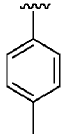 |
| R37 | 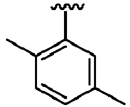 | R38 | 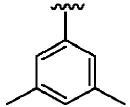 | R39 | 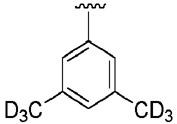 |
| R40 | 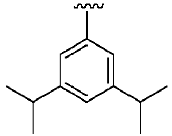 | R41 | 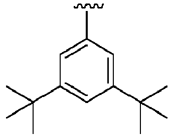 | R42 | 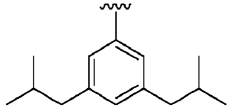 |
| R43 | 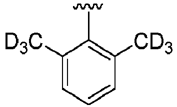 | R44 | 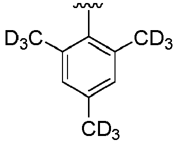 | R45 | 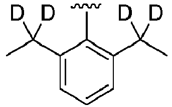 |
| R46 | 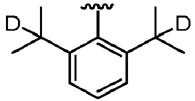 | R47 | 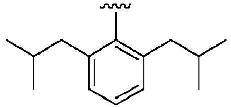 | R48 | 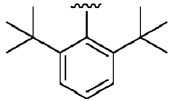 |
| R49 | 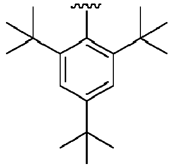 | R50 | 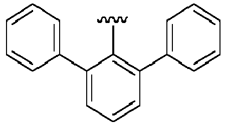 | R51 | 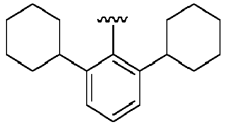 |
| R52 | 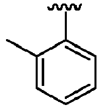 | R53 | 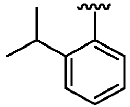 | R54 | 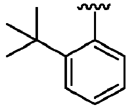 |
| R55 | 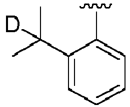 | R56 | 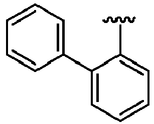 | R57 | 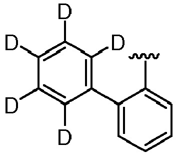 |
| R58 | 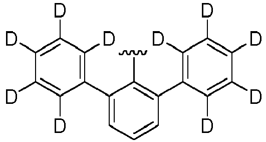 | R59 | 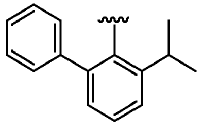 | R60 | 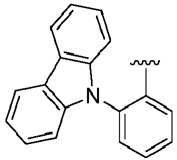 |
| R61 | 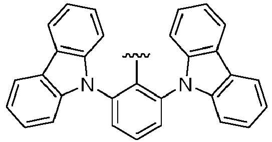 | R62 | 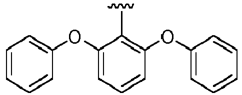 | R63 | 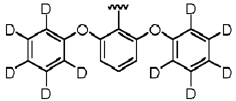 |
| R64 | 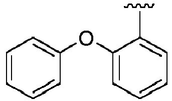 | R65 | 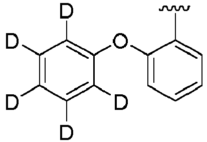 | R66 | 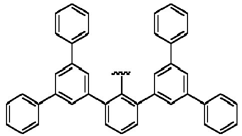 |
| R67 | 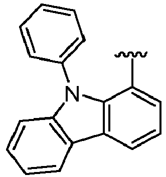 | R68 | 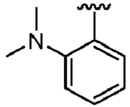 | R69 | 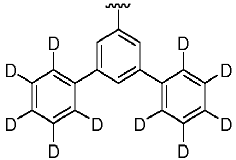 |
| R70 | 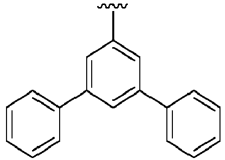 | R71 | 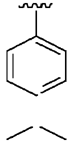 | R72 | 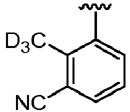 |
| R73 | 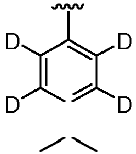 | R74 | 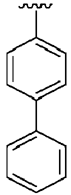 | R75 | 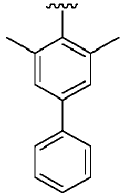 |
| R76 | 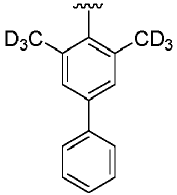 | R77 | 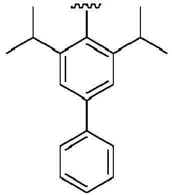 | R78 | 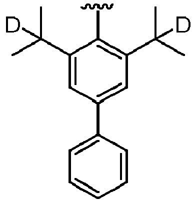 |
| R79 | 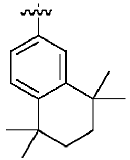 | R80 | 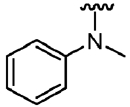 | R81 | 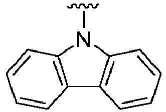 |
| R82 | 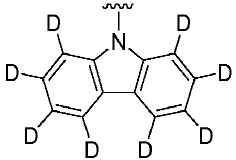 | R83 | 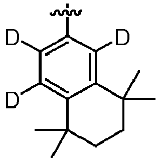 | R84 | 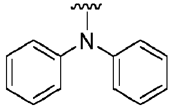 |
| R85 | 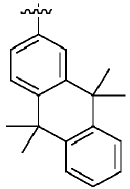 | R86 | 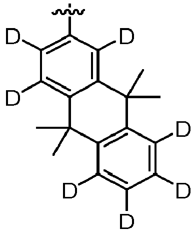 | R87 | 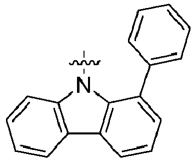 |
| R88 | 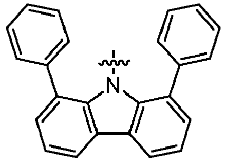 | R89 | 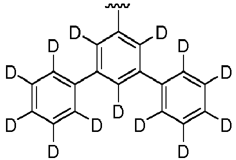 | R90 | 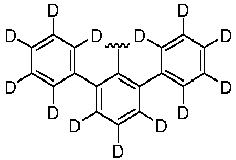 |
| R91 | 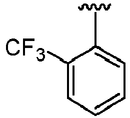 | R92 | 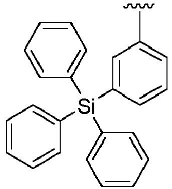 | R93 | 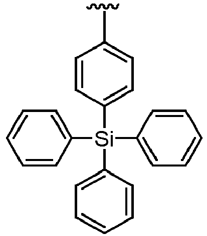 |
| R94 | 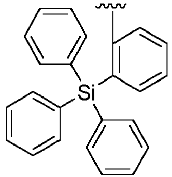 | R95 | 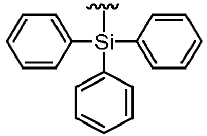 | R96 | 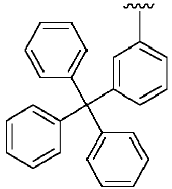 |
| R97 | 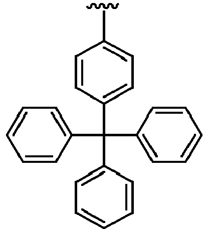 | R98 | 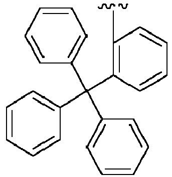 | R99 | 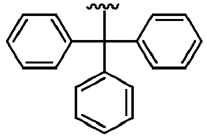 |
| R100 | 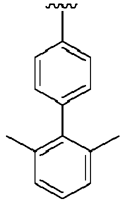 | R101 | 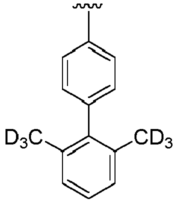 | R102 | 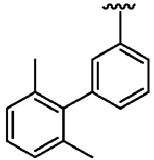 |
| R103 | 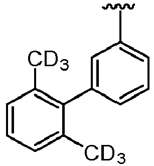 | R104 | 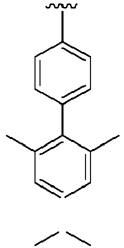 | R105 | 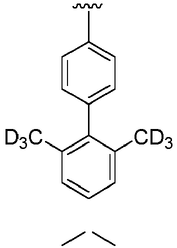 |
| R106 | 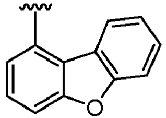 | R107 | 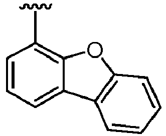 | R108 | 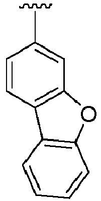 |
| R109 | 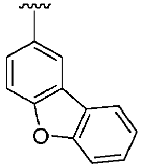 | R110 | 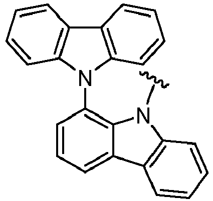 | R111 | 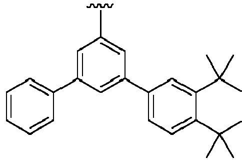 |
| R112 | 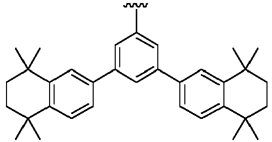 | R113 | 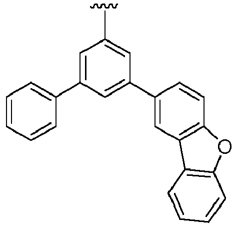 | R114 | 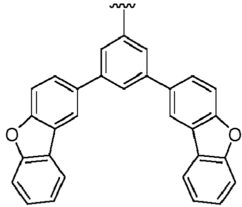 |
| R115 | 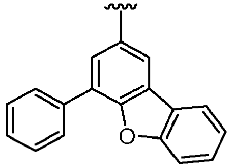 | R116 | 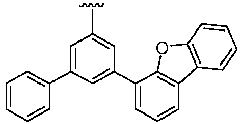 | R117 | 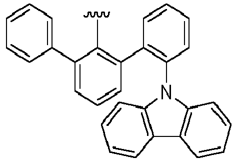 |
| R118 | 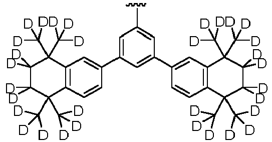 | R119 | 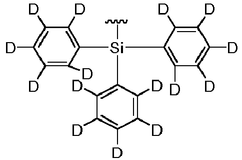 | R120 | 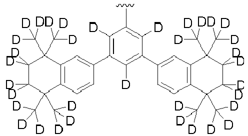 |
| R121 | 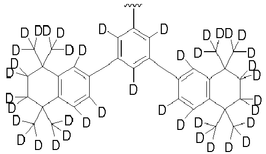 | R122 | 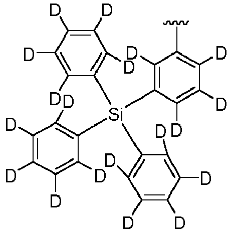 | R123 | 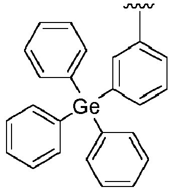 |
| R124 | 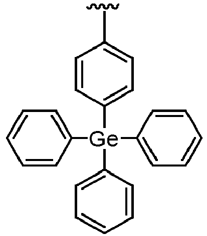 | R125 | 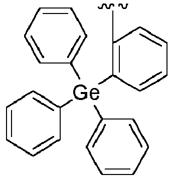 | R126 | 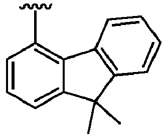 |
| R127 | 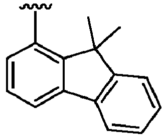 | R128 | 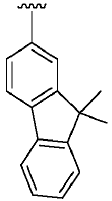 | R129 | 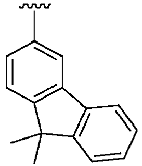 |
| R130 | 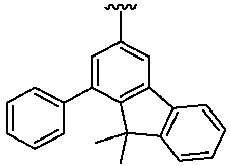 | R131 | 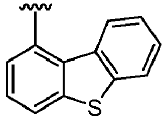 | R132 | 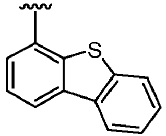 |
| R133 | 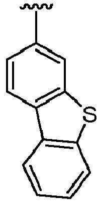 | R134 | 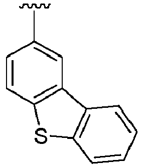 | R135 | 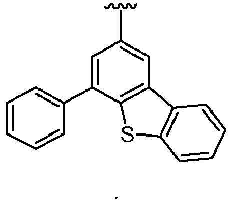 |

In some embodiments, the compound is selected from the group consisting of:

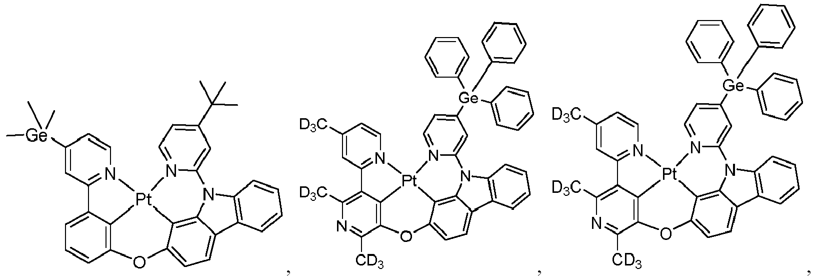

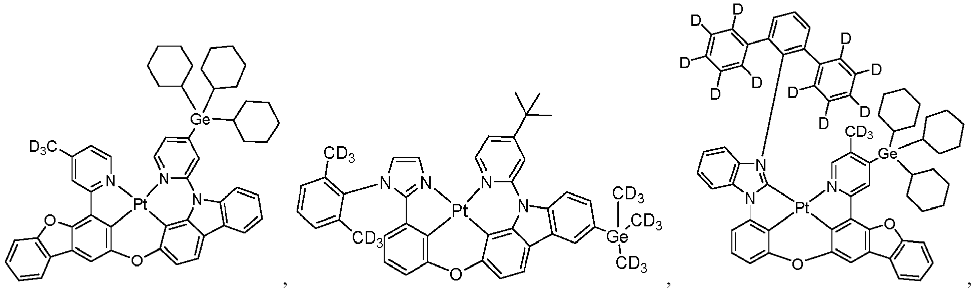

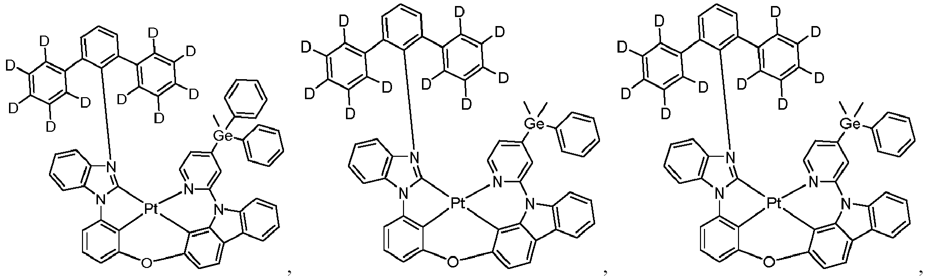

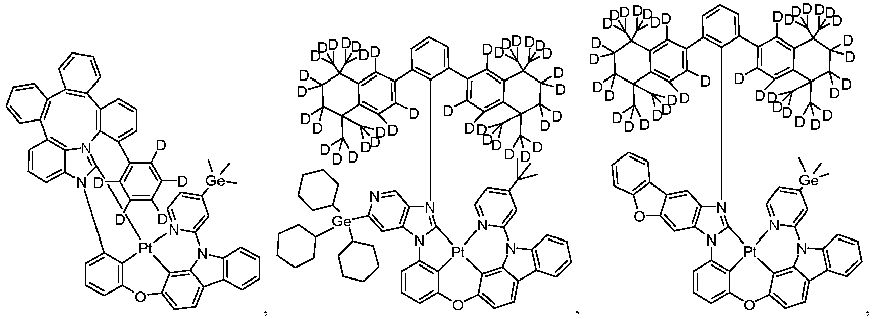

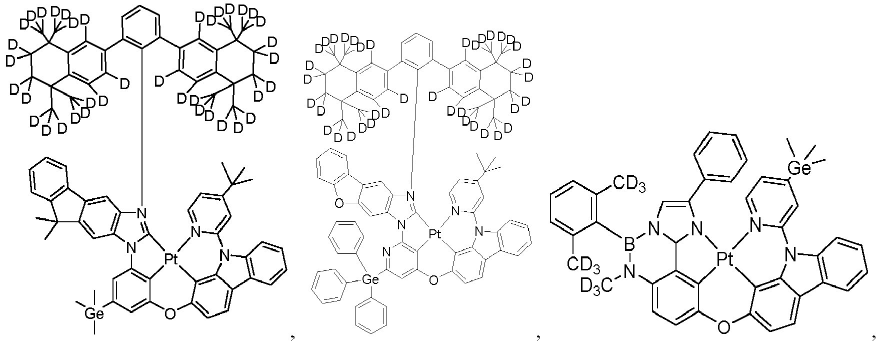

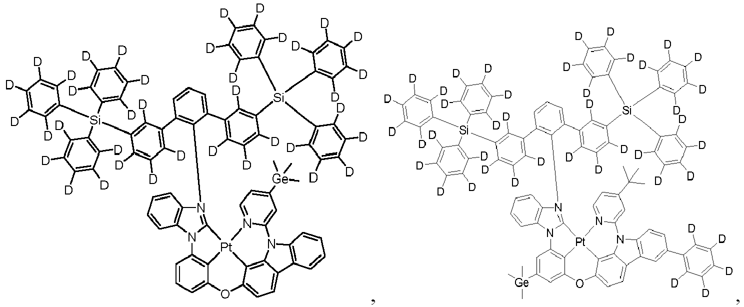

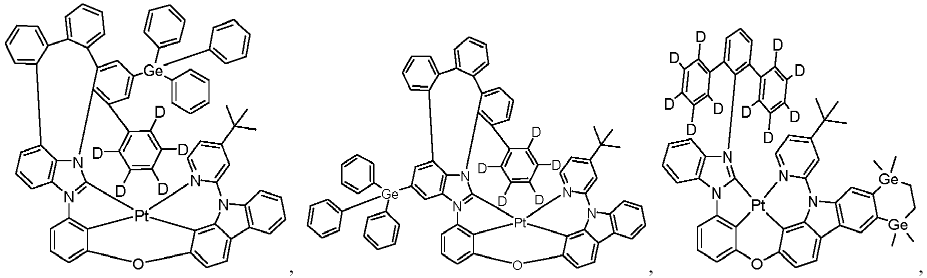

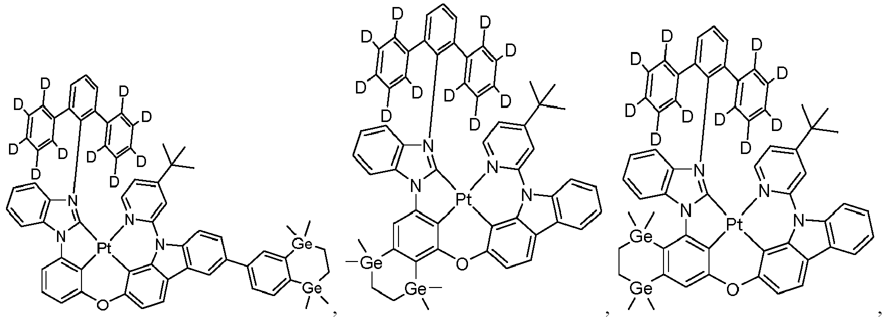

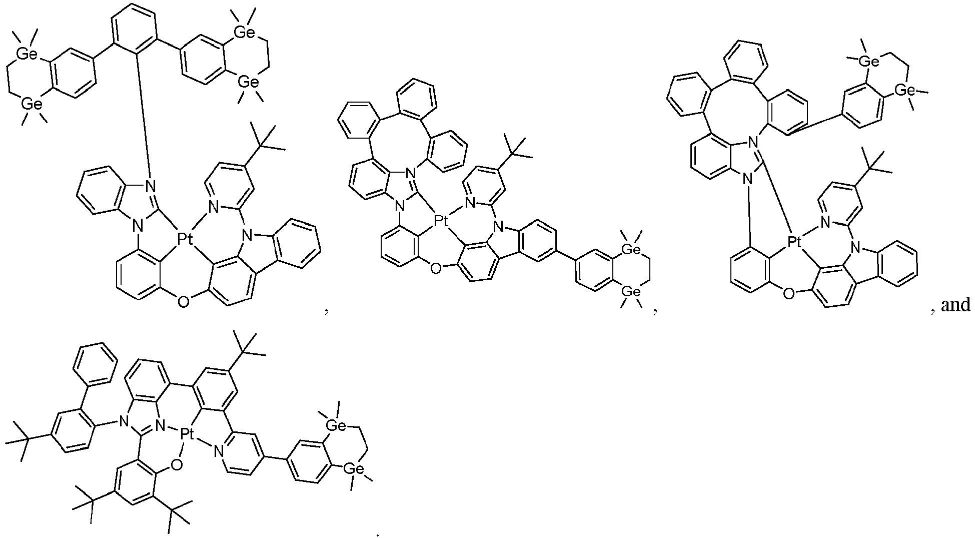

In should be undertstood that some structural features of the present disclosure are intended to be interchangeable/applicable throughout the disclosure so long as they are chemically feasiable. It should also be understood that the electron-withdrawing related groups are applicable to all the structures of the present disclosure.

In some embodiments, the compound described in this application can be at least 30% deuterated, at least 40% deuterated, at least 50% deuterated, at least 60% deuterated, at least 70% deuterated, at least 80% deuterated, at least 90% deuterated, at least 95% deuterated, at least 99% deuterated, or 100% deuterated. As used herein, percent deuteration has its ordinary meaning and includes the percent of possible hydrogen atoms (e.g., positions that are hydrogen or deuterium) that are replaced by deuterium atoms.

In some embodiments of the compound, the compound comprises at least one electron-withdrawing group (R**). The electron-withdrawing group commonly comprises one or more highly electronegative elements including but not limited to fluorine, oxygen, sulfur, nitrogen, chlorine, and bromine. In some embodiments of the compound, the electron-withdrawing group has a Hammett constant larger than 0. In some embodiments, the electron-withdrawing group has a Hammett constant equal or larger than 0.1, 0.2, 0.3, 0.4, 0.5, 0.6, 0.7, 0.8, 0.9, 1.0, or 1.1.

In some embodiments, the electron-withdrawn group is selected from the group consisting of the structures in the following LIST EWG 1: F, CF₃, CN, COCH₃, CHO, COCF₃, COOMe, COOCF₃, NO₂, SF₃, SiF₃, PF₄, SF₅, OCF₃, SCF₃, SeCF₃, SOCF₃, SeOCF₃, SO₂F, SO₂CF₃, SeO₂CF₃, OSeO₂CF₃, OCN, SCN, SeCN, NC, ⁺N(R^{k2})₃, (R^{k2})₂CCN, (R^{k2})₂CCF₃, CNC(CF₃)₂, BR^{k3}R^{k2}, substituted or unsubstituted dibenzoborole, 1-substituted carbazole, 1,9-substituted carbazole, substituted or unsubstituted carbazole, substituted or unsubstituted pyridine, substituted or unsubstituted pyrimidine, substituted or unsubstituted pyrazine, substituted or unsubstituted pyridoxine, substituted or unsubstituted triazine, substituted or unsubstituted oxazole, substituted or unsubstituted benzoxazole, substituted or unsubstituted thiazole, substituted or unsubstituted benzothiazole, substituted or unsubstituted imidazole, substituted or unsubstituted benzimidazole, ketone, carboxylic acid, ester, nitrile, isonitrile, sulfinyl, sulfonyl, partially and fully fluorinated alkyl, partially and fully fluorinated aryl, partially and fully fluorinated heteroaryl, cyano-containing alkyl, cyano-containing aryl, cyano-containing heteroaryl, isocyanate, 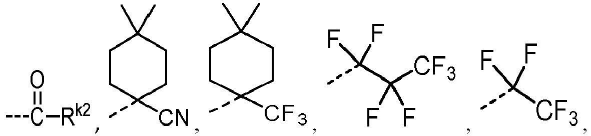 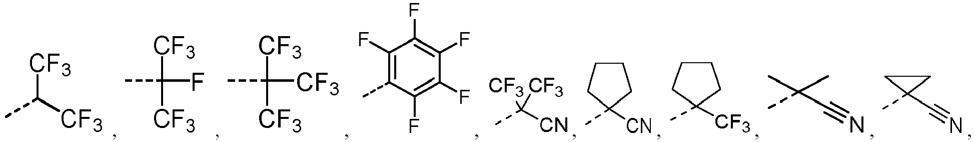 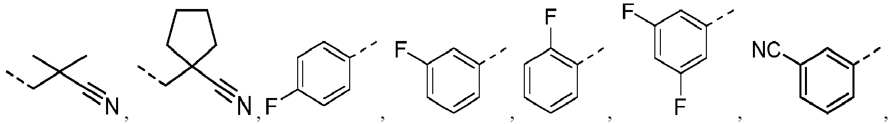 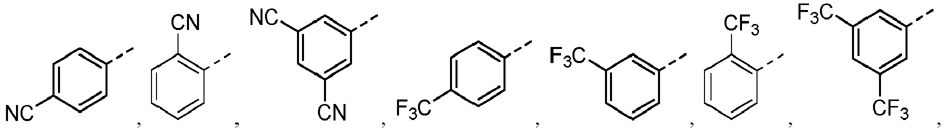 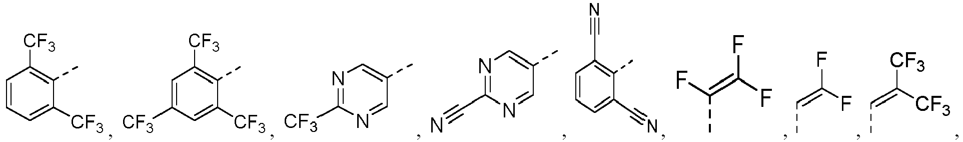 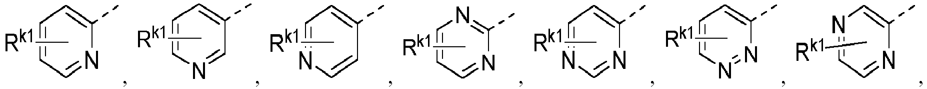 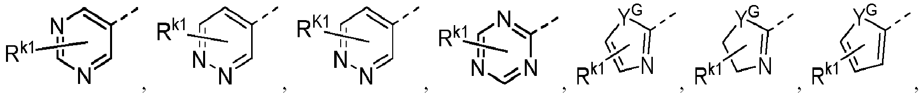 and 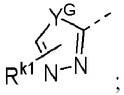
wherein Y^{G} is selected from the group consisting of BRₑ, NRₑ, PRₑ, O, S, Se, C=O, S=O, SO₂, CRₑR_{f}, SiRₑR_{f}, and GeRₑR_{f'}; and
R^{k1} each independently represents mono to the maximum allowable substitutions, or no substitution;
wherein each of R^{k1}, R^{k2}, R^{k3}, Rₑ, and R_{f} is independently a hydrogen or a substituent selected from the group consisting of the General Substituents defined herein.

In some embodiments, the electron-withdrawing group is selected from the group consisting of the structures in the following LIST EWG 2:

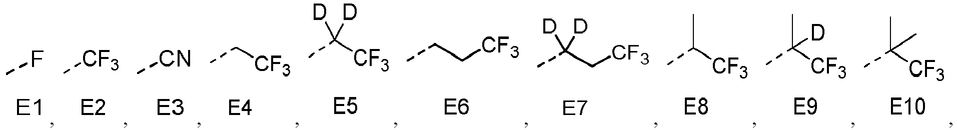

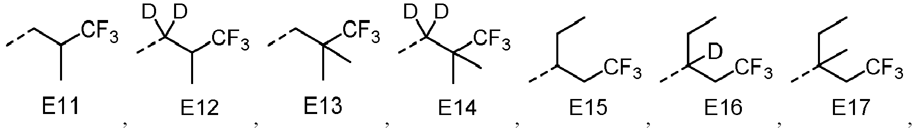

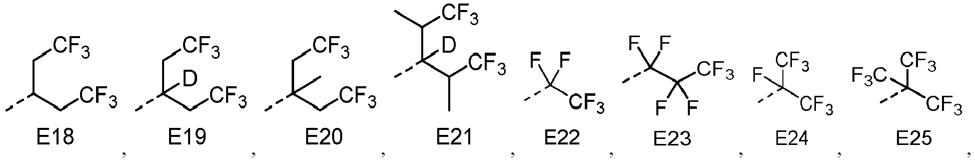

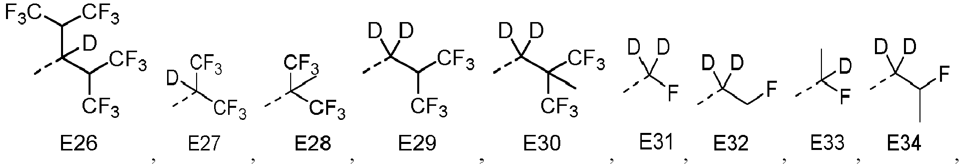

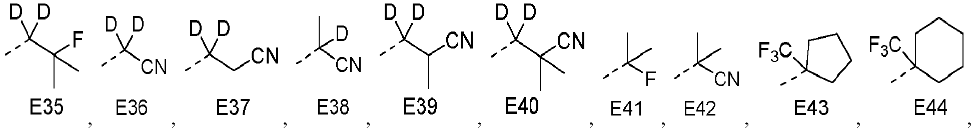

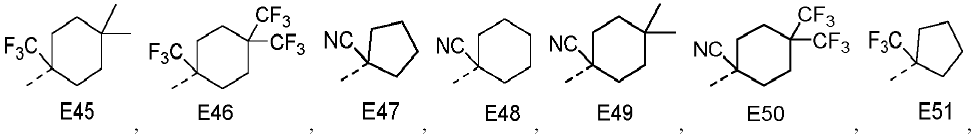

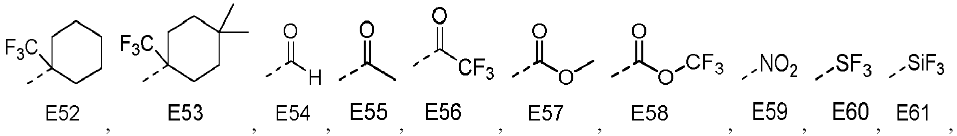

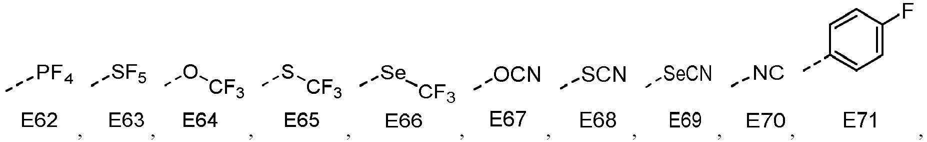

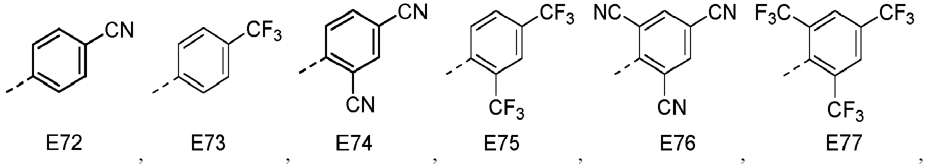

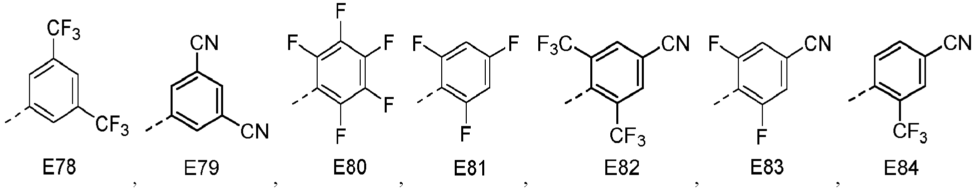

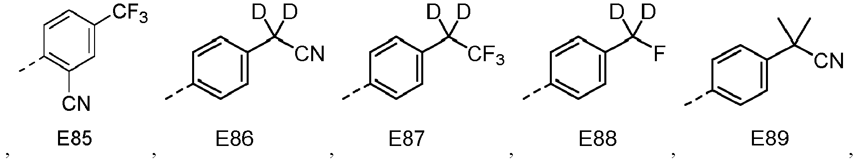

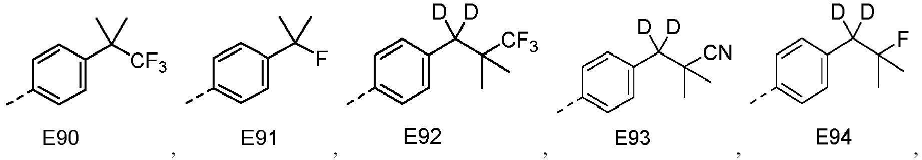

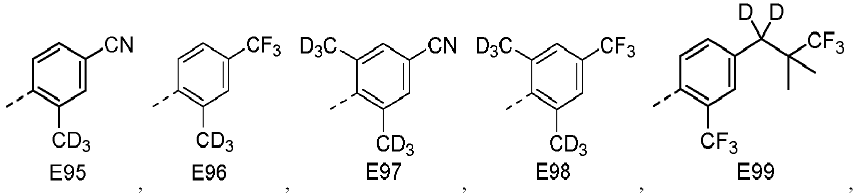

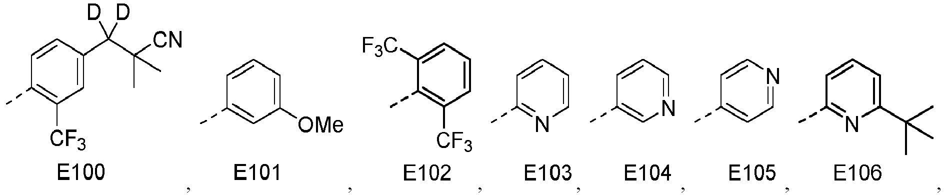

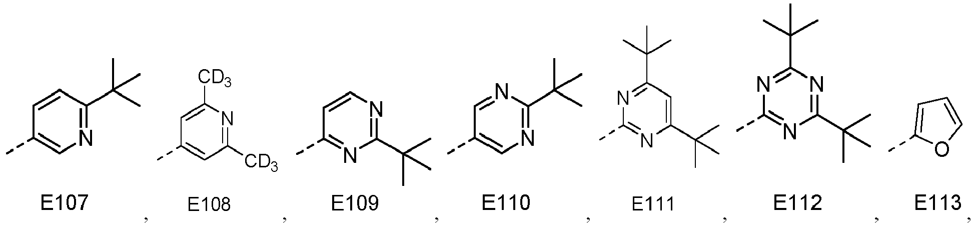

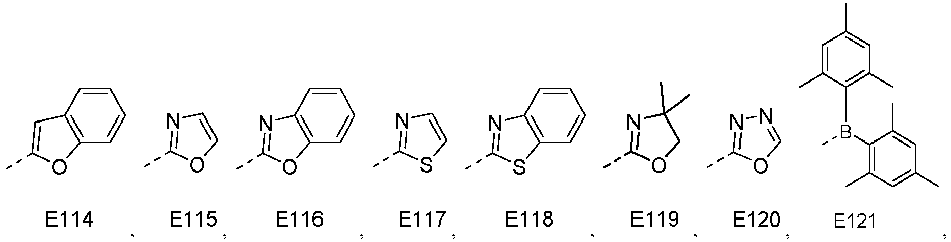

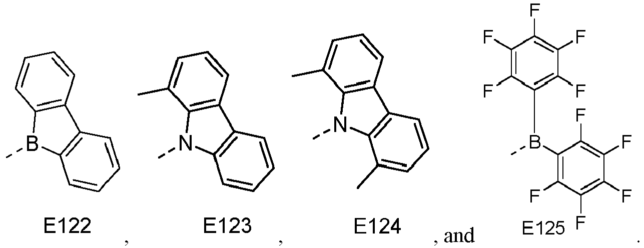

In some embodiments, the electron-withdrawing group is selected from the group consisting of the structures in the following LIST EWG 3:

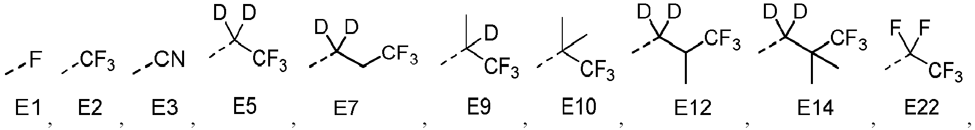

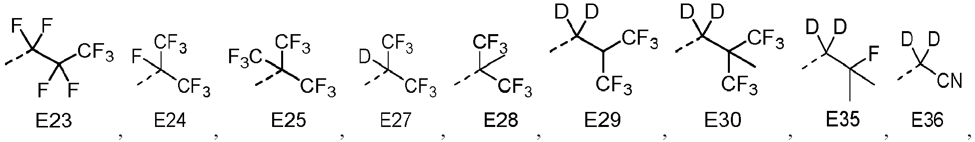

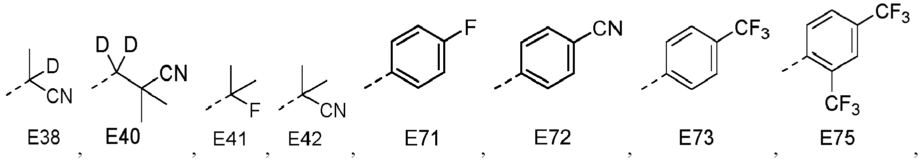

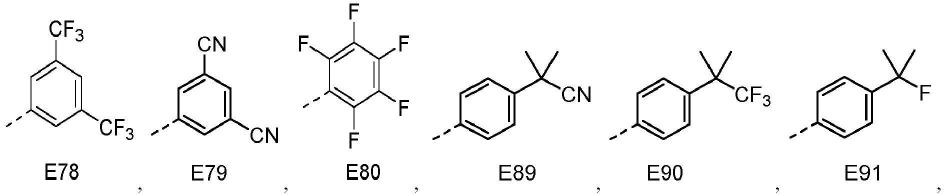

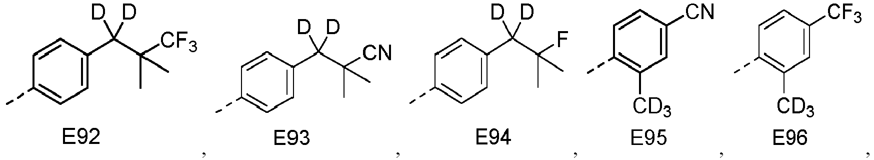

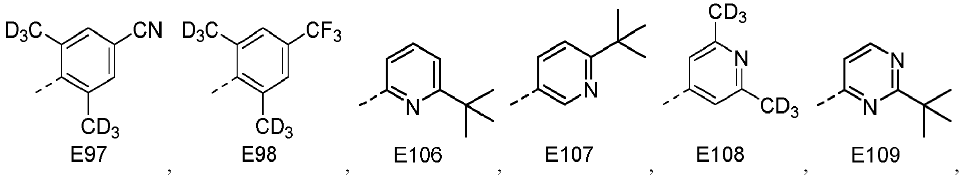

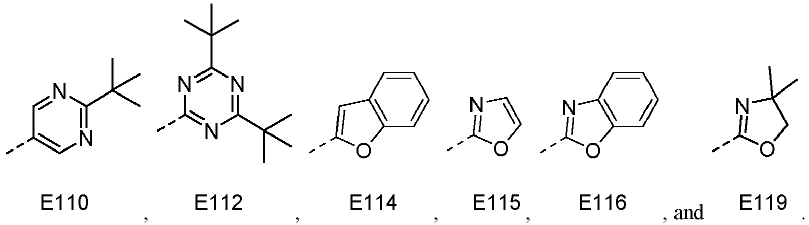

In some embodiments, the electron-withdrawing group is selected from the group consisting of the structures in the following LIST EWG 4:

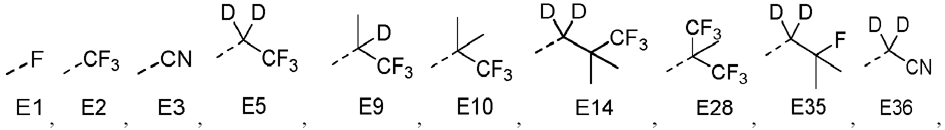

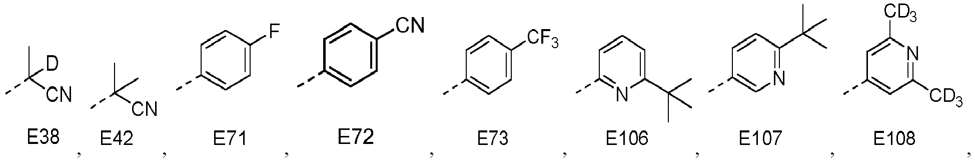

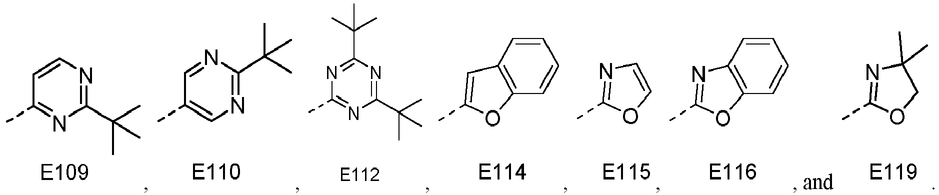

In some embodiments, the electron-withdrawing group is a π-electron deficient electron-withdrawing group. In some embodiments, the π-electron deficient electron-withdrawing group is selected from the group consisting of the structures in the following LIST Pi-EWG: CN, COCH₃, CHO, COCF₃, COOMe, COOCF₃, NO₂, SF₃, SiF₃, PF₄, SF₅, OCF₃, SCF₃, SeCF₃, SOCF₃, SeOCF₃, SO₂F, SO₂CF₃, SeO₂CF₃, OSeO₂CF₃, OCN, SCN, SeCN, NC, ⁺N(R^{k1})₃, BR^{k1}R^{k2}, substituted or unsubstituted dibenzoborole, 1-substituted carbazole, 1,9-substituted carbazole, substituted or unsubstituted carbazole, substituted or unsubstituted pyridine, substituted or unsubstituted pyrimidine, substituted or unsubstituted pyrazine, substituted or unsubstituted pyridazine, substituted or unsubstituted triazine, substituted or unsubstituted oxazole, substituted or unsubstituted benzoxazole, substituted or unsubstituted thiazole, substituted or unsubstituted benzothiazole, substituted or unsubstituted imidazole, substituted or unsubstituted benzimidazole, ketone, carboxylic acid, ester, nitrile, isonitrile, sulfinyl, sulfonyl, partially and fully fluorinated aryl, partially and fully fluorinated heteroaryl, cyano-containing aryl, cyano-containing heteroaryl, isocyanate, 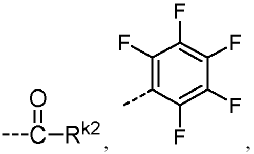 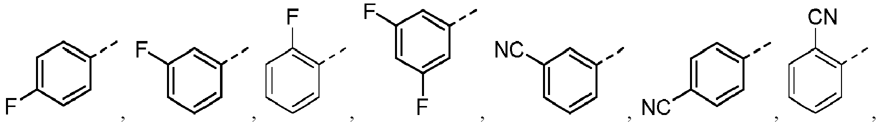 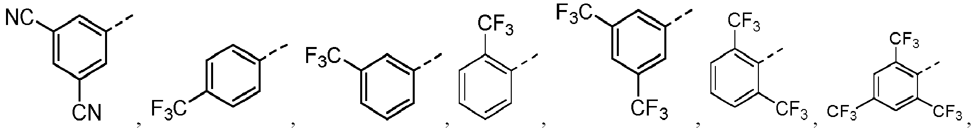 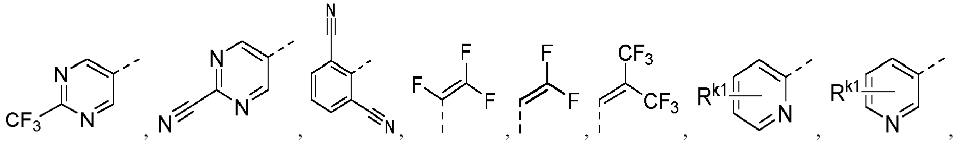 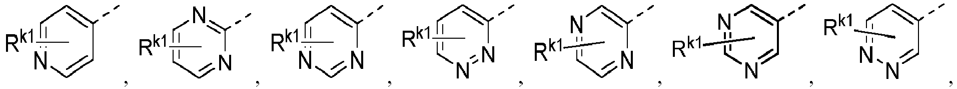 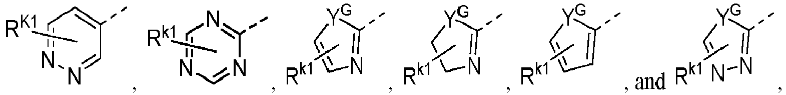 wherein the variables are the same as previously defined.

In some embodiments of the compound having a ligand of Formula I or Ia, at least one of R^{A}, or R^{B} is an electron-withdrawing group from LIST EWG 1 as defined herein. In some embodiments of the compound, at least one of R^{A}, or R^{B} is an electron-withdrawing group from LIST EWG 2 as defined herein. In some embodiments of the compound, at least one of R^{A}, or R^{B} is an electron-withdrawing group from LIST EWG 3 as defined herein. In some embodiments of the compound, at least one of R^{A}, or R^{B} is an electron-withdrawing group from LIST EWG 4 as defined herein. In some embodiments of the compound, at least one of R^{A}, or R^{B} is an electron-withdrawing group from LIST Pi-EWG as defined herein.

In some embodiments of the compound having a ligand of Formula I or Ia, at least one R^{A} is an electron-withdrawing group from LIST EWG 1 as defined herein. In some embodiments of the compound, at least one R^{A} is an electron-withdrawing group from LIST EWG 2 as defined herein. In some embodiments of the compound, at least one R^{A} is an electron-withdrawing group from LIST EWG 3 as defined herein. In some embodiments of the compound at least one R^{A} is an electron-withdrawing group from LIST EWG 4 as defined herein. In some embodiments of the compound, at least one R^{A} is an electron-withdrawing group from LIST Pi-EWG as defined herein.

In some embodiments of the compound having a ligand of Formula I or Ia, at least one R^{B} is an electron-withdrawing group from LIST EWG 1 as defined herein. In some embodiments of the compound, at least one R^{B} is an electron-withdrawing group from LIST EWG 2 as defined herein. In some embodiments of the compound, at least one R^{B} is an electron-withdrawing group from LIST EWG 3 as defined herein. In some embodiments of the compound at least one R^{B} is an electron-withdrawing group from LIST EWG 4 as defined herein. In some embodiments of the compound, at least one R^{B} is an electron-withdrawing group from LIST Pi-EWG as defined herein.

In some embodiments of the compound having a ligand of Formula I, the ligand of Formula I comprises at least one electron-withdrawing group from LIST EWG 1 as defined herein. In some embodiments of the compound having a ligand of Formula I, the ligand of Formula I comprises at least one electron-withdrawing group from LIST EWG 2 as defined herein. In some embodiments of the compound having a ligand of Formula I, the ligand of Formula I comprises at least one electron-withdrawing group from LIST EWG 3 as defined herein. In some embodiments of the compound having a ligand of Formula I, the ligand of Formula I comprises at least one electron-withdrawing group from LIST EWG 4 as defined herein. In some embodiments of the compound having a ligand of Formula I, the ligand of Formula I comprises at least one electron-withdrawing group from LIST Pi-EWG as defined herein.

In some embodiments of the compound having a ligand of Formula Ia, the ligand of Formula Ia comprises at least one electron-withdrawing group from LIST EWG 1 as defined herein. In some embodiments of the compound having a ligand of Formula Ia, the ligand of Formula Ia comprises at least one electron-withdrawing group from LIST EWG 2 as defined herein. In some embodiments of the compound having a ligand of Formula Ia, the ligand of Formula Ia comprises at least one electron-withdrawing group from LIST EWG 3 as defined herein. In some embodiments of the compound having a ligand of Formula Ia, the ligand of Formula Ia comprises at least one electron-withdrawing group from LIST EWG 4 as defined herein. In some embodiments of the compound having a ligand of Formula Ia, the ligand of Formula Ia comprises at least one electron-withdrawing group from LIST Pi-EWG as defined herein.

In some embodiments of the compound of Formula III or Formula IIIA, at least one of R^{A}, R^{B}, R^{E}, or R^{F}, is an electron-withdrawing group from LIST EWG 1 as defined herein. In some embodiments of the compound, at least one of R^{A}, R^{B}, R^{E}, or R^{F}, is an electron-withdrawing group from LIST EWG 2 as defined herein. In some embodiments of the compound, at least one of R^{A}, R^{B}, R^{E}, or R^{F}, is an electron-withdrawing group from LIST EWG 3 as defined herein. In some embodiments of the compound, at least one of R^{A}, R^{B}, R^{E}, or R^{F}, is an electron-withdrawing group from LIST EWG 4 as defined herein. In some embodiments of the compound, at least one of R^{A}, R^{B}, R^{E}, or R^{F}, is an electron-withdrawing group from LIST Pi-EWG as defined herein.

In some embodiments of the compound of Formula III or Formula IIIA, one R^{A} is an electron-withdrawing group from LIST EWG 1 as defined herein. In some embodiments of the compound, one of R^{A} is an electron-withdrawing group from LIST EWG 2 as defined herein. In some embodiments of the compound, one of R^{A} is an electron-withdrawing group from LIST EWG 3 as defined herein. In some embodiments of the compound, one of R^{A} is an electron-withdrawing group from LIST EWG 4 as defined herein. In some embodiments of the compound, one of R^{A} is an electron-withdrawing group from LIST Pi-EWG as defined herein.

In some embodiments of the compound of Formula III or Formula IIIA, one R^{B} is an electron-withdrawing group from LIST EWG 1 as defined herein. In some embodiments of the compound, one of R^{B} is an electron-withdrawing group from LIST EWG 2 as defined herein. In some embodiments of the compound, one of R^{B} is an electron-withdrawing group from LIST EWG 3 as defined herein. In some embodiments of the compound, one of R^{B} is an electron-withdrawing group from LIST EWG 4 as defined herein. In some embodiments of the compound, one of R^{B} is an electron-withdrawing group from LIST Pi-EWG as defined herein.

In some embodiments of the compound of Formula III or Formula IIIA, one R^{E} is an electron-withdrawing group from LIST EWG 1 as defined herein. In some embodiments of the compound, one of R^{E} is an electron-withdrawing group from LIST EWG 2 as defined herein. In some embodiments of the compound, one of R^{E} is an electron-withdrawing group from LIST EWG 3 as defined herein. In some embodiments of the compound, one of R^{E} is an electron-withdrawing group from LIST EWG 4 as defined herein. In some embodiments of the compound, one of R^{E} is an electron-withdrawing group from LIST Pi-EWG as defined herein.

In some embodiments of the compound of Formula III or Formula IIIA, one R^{F} is an electron-withdrawing group from LIST EWG 1 as defined herein. In some embodiments of the compound, one of R^{F} is an electron-withdrawing group from LIST EWG 2 as defined herein. In some embodiments of the compound, one of R^{F} is an electron-withdrawing group from LIST EWG 3 as defined herein. In some embodiments of the compound, one of R^{F} is an electron-withdrawing group from LIST EWG 4 as defined herein. In some embodiments of the compound, one of R^{F} is an electron-withdrawing group from LIST Pi-EWG as defined herein.

In some embodiments of the compound of Formula III or Formula IIIA, the ligand L_{A} comprises an electron-withdrawing group from LIST EWG 1 as defined herein. In some embodiments of the compound, the ligand L_{A} comprises an electron-withdrawing group from LIST EWG 2 as defined herein. In some embodiments of the compound, the ligand L_{A} comprises an electron-withdrawing group from LIST EWG 3 as defined herein. In some embodiments of the compound, the ligand L_{A} comprises an electron-withdrawing group from LIST EWG 4 as defined herein. In some embodiments of the compound, the ligand L_{A} comprises an electron-withdrawing group from LIST Pi-EWG as defined herein.

In some embodiments of the compound of Formula III or Formula IIIA, the compound comprises an electron-withdrawing group from LIST EWG 1 as defined herein. In some embodiments of the compound, the compound comprises an electron-withdrawing group from LIST EWG 2 as defined herein. In some embodiments of the compound, the compound comprises an electron-withdrawing group from LIST EWG 3 as defined herein. In some embodiments of the compound, the compound comprises an electron-withdrawing group from LIST EWG 4 as defined herein. In some embodiments of the compound, the compound comprises an electron-withdrawing group from LIST Pi-EWG as defined herein.

In some embodiments, R* and R** are attached to the same ring. In some embodiments, R* and R** are attached to the different rings but on the same fused ring system. In some embodiments, R* and R** are attached to the different fused ring system. In some embodiments, R* and R** are attached to different rings that are not fused to each other. In some embodiments, R* and R** are attached to the same ligand. In some embodiments, R* and R** are attached to the different ligands.

In some embodiments, the present disclosure provides a compound of Ir(L_{A})ₚ(L_{B})_{q}(L_{C})ᵣ, wherein:
the first ligand L_{A} has a structure of Formula I&, 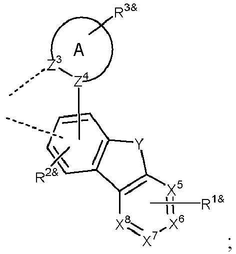 ligand L_{B} has a structure of Formula II&, 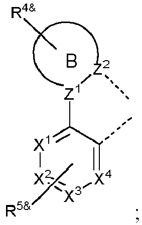 and ligand L_{C} is a bidentate ligand. In the compound of Formula Ir(L_{A})ₚ(L_{B})_{q}(L_{C})ᵣ:
p is 1 or 2; q is 0, 1, or 2; r is 0, 1, or 2;
p+q+r = 3;
moieties A and B are each independently a monocyclic ring or a polycyclic fused ring system, where the monocyclic ring and each ring of the polycyclic fused ring system are independently a 5-membered or 6-membered carbocyclic or heterocyclic ring;
each of X¹ to X⁸ and Z¹ to Z⁴ is independently C or N;
Y is selected from the group consisting of BR, BRR', NR, PR, P(O)R, O, S, Se, C=O, C=S, C=Se, C=NR', C=CR'R", S=O, SO₂, CR, CRR', SiRR', and GeRR';
each of R^{1&}, R^{2&}, R^{3&}, R^{4&}, and R^{5&} independently represents mono to the maximum allowable substitution, or no substitutions;
each R, R', R^{1&}, R^{2&}, R^{3&}, R^{4&}, and R^{5&} is independently hydrogen or a substituent selected from the group consisting of the General Substituents defined herein;
any two R, R', R^{1&}, R^{2&}, R^{3&}, R^{4&}, or R^{5&} may be joined or fused to form a ring, or to form a tetradentate or hexadentate ligand;
at least one R^{1&}, R^{2&}, R^{3&}, R^{4&}, or R^{5&} comprises at least one germyl or silyl group; and
at least one R^{1&}, R^{2&}, R^{3&}, R^{4&}, or R^{5&} comprises at least one electron-withdrawing group.

In some embodiments, at least one R^{1&} comprises an elctron-withdrawing group.

In some embodments, the electron-withdrawn group is selected from the group consisting of the structures of the LIST EWG1 as defined herein. In some embodiments, the electron-withdrawing group is selected from the group consisting of the structures of the LIST EWG2 as defined herein. In some embodiments, the electron-withdrawing group is selected from the group consisting of the structures of the LIST EWG3 as defined herein. In some embodiments, the electron-withdrawing group is selected from the group consisting of the structures of the LIST EWG4 as defined herein. In some embodiments, the electron-withdrawing group is a π-electron deficient electron-withdrawing group consisting of the structrues of the LIST Pi-EWG as defined herein.

In some embodiments, the electron-drawing group can be a cyano group or 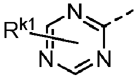 as defined herein.

In some embodiments, if both ring A and ring B are unfused pyridine rings and at least one of R^{4&} and R^{5&} is a germyl group, then (a) at least one of X⁵ to X⁸ is N or (b) Y is not O.

In some embodiemnts, if X⁵ is C, then R^{1&} bonded to X^{5&} is selected from the group consisting of hydrogen, deuterium, cycloalkyl, methyl, phenyl, silyl, germyl, and combinations thereof. In some embodiments, if X⁵ is C, then R^{1&} bonded to X^{5&} is selected from the group consisting of H, D, Me, Ph, substituted or unsubstituted silyl, substituted or unsubstituted germyl, and partially or fully deuterated variants thereof.

In some embodiments, each R^{1&}, R^{2&}, R^{3&}, R^{4&}, and R^{5&} is independently hydrogen or a substituent selected from the group consisting of the Preferred General Substituents defined herein. In some embodiments, each R^{1&}, R^{2&}, R^{3&}, R^{4&}, and R^{5&} is independently hydrogen or a substituent selected from the group consisting of the More Preferred General Substituents defined herein. In some embodiments, each R^{1&}, R^{2&}, R^{3&}, R^{4&}, and R^{5&} is independently hydrogen or a substituent selected from the group consisting of the Most Preferred General Substituents defined herein.

In some embodiments, the germyl group is -Ge(Rₛ)₃, wherein each Rₛ is independently hydrogen or a substituent selected from the group consisting of deuterium, halogen, alkyl, cycloalkyl, heteroalkyl, heterocycloalkyl, arylalkyl, alkoxy, aryloxy, amino, silyl, alkenyl, cycloalkenyl, heteroalkenyl, alkynyl, aryl, heteroaryl, and combination thereof. In some embodiments, it is preferred that Rₛ is selected from the group consisting of alkyl, cycloalkyl, aryl, heteroaryl, and combination thereofcan be same or different.

In some embodiments, the silyl group is -Si(Rₛ)₃, wherein each Rₛ is independently be hydrogen or a substituent selected from the group consisting of deuterium, halogen, alkyl, cycloalkyl, heteroalkyl, heterocycloalkyl, arylalkyl, alkoxy, aryloxy, amino, silyl, alkenyl, cycloalkenyl, heteroalkenyl, alkynyl, aryl, heteroaryl, and combination thereof. In some embodiments, each Rₛ is independently selected from the group consisting of alkyl, cycloalkyl, aryl, heteroaryl, and combination thereof.

In some embodiments, the germyl group is selected from the group consisting of the following list: GeMe₃, GeEt₃, Ge(*ⁱ*Pr)₃, Ge(*^{t}*Bu)₃, GePh₃, Ge(CD₃)₃, CH₂GeMe₃, CD₂GeMe₃, GeMeEt₂, GeMe(*ⁱ*Pr)₂, GeMe(*^{t}*Bu)₂ , 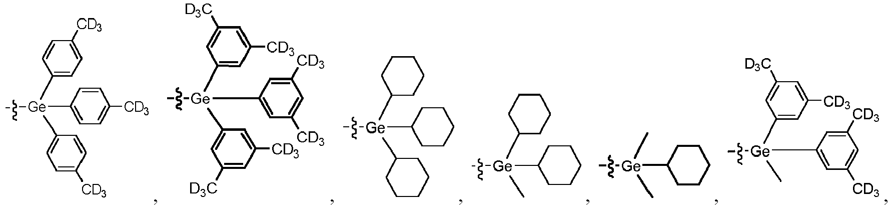 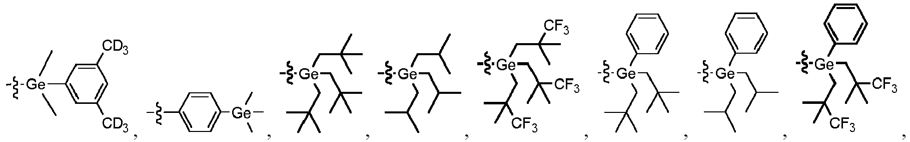 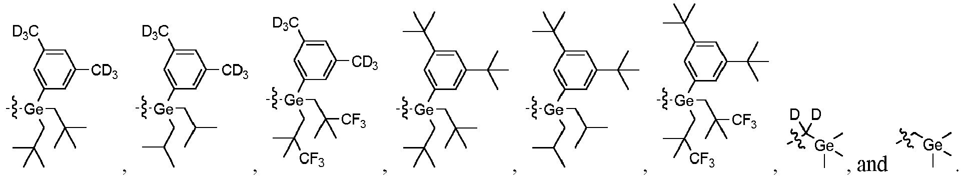 In some embodiments, the silyl group is selected from silyl analogs of the foregoing. As used herein, *ⁱ*Pr represents isopropyl and *^{t}*Bu represents tert-butyl.

In some embodiments, any two Rₛ can be joined or fused to form a ring. In some embodiments, the germyl group is selected from the group consisting of: 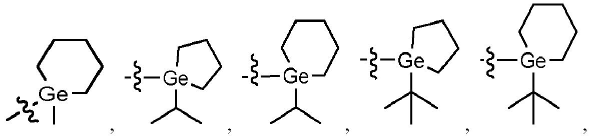 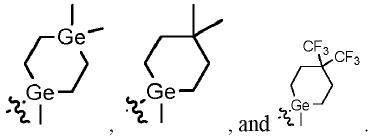 In some embodiments, the silyl group is selected from silyl analogs of the foregoing structures where two Rₛ are joined or fused to form a ring.

In some embodiments, Z¹ is C and Z² is N. In some embodiments, Z¹ is N and Z² is C.

In some embodiments, Z³ is C and Z⁴ is N. In some embodiments, Z³ is N and Z⁴ is C.

In some embodiments, p is 1. In some embodiments, p is 2.

In some embodiments, each of X¹ to X⁴ is C.

In some embodiments, at least one of X¹ to X⁴ is N. In some embodiments, exactly one of X¹ to X⁴ is N.

In some embodiments, each of X⁵ to X⁸ is C.

In some embodiments, at least one of X⁵ to X⁹ is N. In some embodiments, exactly one of X⁵ to X⁹ is N.

In some embodiments, X⁵ is N, and each of X⁶ to X⁸ is C. In some embodiments, X⁶ is N, and each of X⁵, X⁷, and X⁸ is C.

In some embodiments, X⁷ is N, and each of X⁵, X⁶, and X⁸ is C. In some embodiments, X⁸ is N, and each of X⁵, X⁶, and X⁷ is C.

In some embodiments, each of X¹ to X⁸ is C.

In some embodiments, each of moiety A and moiety B is independently selected from the group consisting of benzene, pyridine, pyrimidine, pyridazine, pyrazine, triazine, imidazole, pyrazole, pyrrole, oxazole, furan, thiophene, thiazole, triazole, naphthalene, quinoline, isoquinoline, quinazoline, benzofuran, aza-benzofuran, benzoxazole, aza-benzoxazole, benzothiophene, aza-benzothiophene, benzothiazole, aza-benzothiazole, benzoselenophene, aza-benzoselenophene, indene, aza-indene, indole, aza-indole, benzimidazole, aza-benzimidazole, carbazole, aza-carbazole, dibenzofuran, aza-dibenzofuran, dibenzothiophene, aza-dibenzothiophene, quinoxaline, phthalazine, phenanthrene, aza-phenanathrene, anthracene, aza-antracene, phenanthridine, fluorene, and aza-fluorene. In some embodiments, the aza variant includes one N on a benzo ring. In some embodiments, the aza variant includes one N on a benzo ring and the N is bonded to Ir.

In some embodiments, moiety A is a monocyclic ring. In some embodiments, moiety A is selected from the group consisting of benzene, pyridine, pyrimidine, pyridazine, pyrazine, triazine, imidazole, pyrazole, pyrrole, oxazole, furan, thiophene, thiazole, and triazole. In some embodiments, moiety A is pyridine or imidazole.

In some embodiments, moiety A is a polycyclic fused ring system. In some embodiments, moiety A is selected from the group consisting of naphthalene, quinoline, isoquinoline, quinazoline, benzofuran, aza-benzofuran, benzoxazole, aza-benzoxazole, benzothiophene, aza-benzothiophene, benzothiazole, aza-benzothiazole, benzoselenophene, aza-benzoselenophene, indene, aza-indene, indole, aza-indole, benzimidazole, aza-benzimidazole, carbazole, aza-carbazole, dibenzofuran, aza-dibenzofuran, dibenzothiophene, aza-dibenzothiophene, quinoxaline, phthalazine, phenanthrene, aza-phenanathrene, anthracene, aza-antracene, phenanthridine, fluorene, and aza-fluorene. In some embodiments, moiety A is benzimidazole.

In some embodiments, moiety B is a monocyclic ring. In some embodiments, moiety B is selected from the group consisting of benzene, pyridine, pyrimidine, pyridazine, pyrazine, triazine, imidazole, pyrazole, pyrrole, oxazole, furan, thiophene, thiazole, and triazole. In some embodiments, moiety B is pyridine or imidazole.

In some embodiments, moiety B is a polycyclic fused ring system. In some embodiments, moiety B is selected from the group consisting of naphthalene, quinoline, isoquinoline, quinazoline, benzofuran, aza-benzofuran, benzoxazole, aza-benzoxazole, benzothiophene, aza-benzothiophene, benzothiazole, aza-benzothiazole, benzoselenophene, aza-benzoselenophene, indene, aza-indene, indole, aza-indole, benzimidazole, aza-benzimidazole, carbazole, aza-carbazole, dibenzofuran, aza-dibenzofuran, dibenzothiophene, aza-dibenzothiophene, quinoxaline, phthalazine, phenanthrene, aza-phenanathrene, anthracene, aza-antracene, phenanthridine, fluorene, and aza-fluorene. In some embodiments, moiety B is benzimidazole.

In some embodiments, each of moiety A and moiety B can independently be a polycyclic fused ring structure. In some embodiments, each of moiety A and moiety B can independently be a polycyclic fused ring structure comprising at least three fused rings. In some embodiments, the polycyclic fused ring structure has two 6-membered rings and one 5-membered ring. In some such embodiments, the 5-membered ring is fused to the ring coordinated to the Ir and the second 6-membered ring is fused to the 5-membered ring. In some embodiments, each of moiety A and moiety B can independently be selected from the group consisting of dibenzofuran, dibenzothiophene, dibenzoselenophene, and aza-variants thereof. In some such embodiments, each of moiety A and moiety B can independently be further substituted at the ortho- or meta-position of the O, S, or Se atom by a substituent selected from the group consisting of deuterium, fluorine, nitrile, alkyl, cycloalkyl, aryl, heteroaryl, and combinations thereof. In some such embodiments, the aza-variants contain exactly one N atom at the 6-position (ortho to the O, S, or Se) with a substituent at the 7-position (meta to the O, S, or Se).

In some embodiments, each of moiety A and moiety B can independently be a polycyclic fused ring structure comprising at least four fused rings. In some embodiments, the polycyclic fused ring structure comprises three 6-membered rings and one 5-membered ring. In some such embodiments, the 5-membered ring is fused to the ring coordinated to the Ir, the second 6-membered ring is fused to the 5-membered ring, and the third 6-membered ring is fused to the second 6-membered ring. In some such embodiments, the third 6-membered ring is further substituted by a substituent selected from the group consisting of deuterium, fluorine, nitrile, alkyl, cycloalkyl, aryl, heteroaryl, and combinations thereof.

In some embodiments, each of moiety A and moiety B can independently be a polycyclic fused ring structure comprising at least five fused rings. In some embodiments, the polycyclic fused ring structure comprises four 6-membered rings and one 5-membered ring or three 6-membered rings and two 5-membered rings. In some embodiments comprising two 5-membered rings, the 5-membered rings are fused together. In some embodiments comprising two 5-membered rings, the 5-membered rings are separated by at least one 6-membered ring. In some embodiments with one 5-membered ring, the 5-membered ring is fused to the ring coordinated to the Ir, the second 6-membered ring is fused to the 5-membered ring, the third 6-membered ring is fused to the second 6-membered ring, and the fourth 6-membered ring is fused to the third 6-membered ring.

In some embodiments, each of moiety A and moiety B can independently be an aza version of the polycyclic fused rings described above. In some such embodiments, each of moiety A and moiety B can independently contain exactly one aza N atom. In some such embodiments, each of moiety A and moiety B contains exactly two aza N atoms, which can be in one ring, or in two different rings. In some such embodiments, the ring having aza N atom is separated by at least two other rings from the metal M atom. In some such embodiments, the ring having aza N atom is separated by at least three other rings from the Ir atom. In some such embodiments, each of the ortho position of the aza N atom is substituted.

In some embodiments, Y is selected from the group consisting of O, S, and Se. In some embodiments, Y is not O. In some embodiments, Y is O.

In some embodiments, Y is selected from the group consisting of BR, NR, and PR. In some embodiments, Y is selected from the group consisting of P(O)R, C=O, C=S, C=Se, C=NR', C=CR'R", S=O, and SO₂. In some embodiments, Y is CR. In some embodiments, Y is selected from the group consisting of BRR', CRR', SiRR', and GeRR'.

In some embodiments, at least one of R^{1&}, R^{2&}, R^{3&}, R^{4&}, and R^{5&} is a germyl group.

In some embodiments, at least one of R^{1&}, R^{2&}, R^{3&}, R^{4&}, and R^{5&} is aryl or heteroaryl, and the aryl or heteroaryl is substituted by a substituent that comprises the at least one germyl group. In some such embodiments, at least one germyl is substituted para to the bond with the structure of Formula I& or Formula II&. In some such embodiments, the aryl or heteroaryl is substituted by at least two substituents that comprise germyl groups. In some such embodiments, the aryl or heteroaryl is substituted by at least two substituents that are germyl groups.

In some embodiments where at least one R^{1&}, R^{2&}, R^{3&}, R^{4&}, and R^{5&} is aryl or heteroaryl, at least one position ortho to the bond between the aryl or heteroaryl and the structure of Formula I& or Formula II& is not H or D. In some such embodiments, at least one position ortho to the bond between the aryl or heteroaryl and the structure of Formula I& or Formula II& is selected from the group consisting of alkyl, cycloalkyl, aryl, heteroaryl, and combinations thereof, or partially or fully deuterated variants thereof.

In some embodiments, at least one of R^{1&}, R^{2&}, R^{3&}, R^{4&}, and R^{5&} is aryl or heteroaryl, and the aryl or heteroaryl is substituted by the at least one germyl group. In some embodiments, at least one of R^{1&}, R^{2&}, R^{3&}, R^{4&}, and R^{5&} is phenyl substituted by at least one germyl group. In some such embodiments, the germyl-substituted phenyl is further substituted.

In some embodiments, at least one R^{1&}, R^{2&}, R^{3&}, R^{4&}, and R^{5&} comprises triphenyl-germyl or trimethyl-germyl. In some embodiments, at least one R^{1&}, R^{2&}, R^{3&}, R^{4&}, and R^{5&} is triphenyl-germyl or trimethyl-germyl.

In some embodiments, at least one R^{1&}, R^{2&}, or R^{3&} comprises at least one germyl group. In some embodiments, at least two of R^{1&}, R^{2&}, and R^{3&} comprises at least one germyl group.

In some embodiments, at least one R^{1&}, R^{2&}, or R^{3&} is a germyl group. In some embodiments, at least two of R^{1&}, R^{2&}, or R^{3&} are germyl groups.

In some embodiments, only one R^{1&}, R^{2&}, or R^{3&} comprises at least one germyl group. In some embodiments, two of R^{1&}, R^{2&}, or R^{3&} comprise at least one germyl group.

In some embodiments, at least one R^{1&} comprises at least one germyl group. In some embodiments, at least two R^{1&} comprise at least one germyl group.

In some embodiments, at least one R^{2&} comprises at least one germyl group. In some embodiments, at least two R^{2&} comprise at least one germyl group.

In some embodiments, at least one R^{3&} comprises at least one germyl group. In some embodiments, at least two R^{3&} comprise at least one germyl group.

In some embodiments, two R^{1&} are fused to form a 5-membered or 6-membered ring. In some such embodiments, the 5-membered or 6-membered is selected from the group consisting of benzene, pyridine, pyrimidine, pyridazine, pyrazine, triazine, imidazole, pyrazole, pyrrole, oxazole, furan, thiophene, triazole, and thiazole.

In some embodiments, Z³ is N, moiety A is an unfused pyridine, and the R³ para to the N-Ir bond comprises at least one germyl group.

In some embodiments, Z³ is N; moiety A is imidazole, benzimidazole, or aza-benzimidazole; and the R^{3&} bonded to the other N of the imidazole moiety comprises at least one germyl group.

In some embodiments, at least one R^{4&} or R^{5&} is a germyl group. In some embodiments, at least two of R^{4&} and R^{5&} are a germyl group.

In some embodiments, only one R^{4&} or R^{5&} comprises at least one germyl group. In some embodiments, at least two R^{4&} or R^{5&} comprise at least one germyl group.

In some embodiments, at least one R^{4&} comprises at least one germyl group. In some embodiments, at least two R^{4&} comprises at least one germyl group.

In some embodiments, at least one R^{5&} comprises at least one germyl group. In some embodiments, at least two R^{5&} comprises at least one germyl group.

In some embodiments, Z² is N, moiety B is an unfused pyridine, and the R^{4&} para to Z¹ comprises at least one germyl group. In some embodiments, Z² is N, moiety B is an unfused pyridine, and the R^{4&} para to Z¹ is a germyl group.

In some embodiments, Z² is N, moiety B is an unfused pyridine, and the R^{4&} para to Z² comprises at least one germyl group. In some embodiments, Z² is N, moiety B is an unfused pyridine, and the R^{4&} para to Z² is a germyl group.

In some embodiments, Z² is N; moiety B is imidazole, benzimidazole, or aza-benzimidazole; and the R^{4&} bonded to the other N of the imidazole moiety comprises at least one germyl group.

In some embodiments, the compound comprises one or more electron-withdrawing groups. In some embodiments, the electron-withdrawing groups commonly comprise one or more highly electronegative elements including but not limited to fluorine, oxygen, sulfur, nitrogen, chlorine, and bromine.

In some embodiments of the compound, the electron-withdrawing group has a Hammett constant larger than 0. In some embodiments, the electron-withdrawing group has a Hammett constant equal or larger than 0.1, 0.2, 0.3, 0.4, 0.5, 0.6, 0.7, 0.8, 0.9, 1.0, or 1.1.

In some embodiments, the electron-withdrawn group is selected from the group consisting of the structures of the LIST EWG1 as defined herein.

In some embodiments, the electron-withdrawing group is selected from the group consisting of the structures of the LIST EWG2 as defined herein.

In some embodiments, the electron-withdrawing group is selected from the group consisting of the structures of the LIST EWG3 as defined herein.

In some embodiments, the electron-withdrawing group is selected from the group consisting of the structures of the LIST EWG4 as defined herein.

In some embodiments, the electron-withdrawing group is a π-electron deficient electron-withdrawing group as defined herein.

In some embodiments, at least one of R^{1&}, R^{2&}, or R^{3&} is an electron-withdrawing group from the LIST EWG1 as defined herein. In some embodiments, at least one of R^{1&}, R^{2&}, or R^{3&} is an electron-withdrawing group from the LIST EWG2 as defined herein. In some embodiments, at least one of R^{1&}, R^{2&}, or R^{3&} is an electron-withdrawing group from the LIST EWG3 as defined herein. In some embodiments, at least one of R^{1&}, R^{2&}, or R^{3&} is an electron-withdrawing group from the LIST EWG4 as defined herein. In some embodiments, at least one of R^{1&}, R^{2&}, or R^{3&} is an electron-withdrawing group from the LIST Pi-EWG as defined herein.

In some embodiments, at least one R^{1&} is an electron-withdrawing group from the LIST EWG1 as defined herein. In some embodiments, at least one R^{1&} is an electron-withdrawing group from the LIST EWG2 as defined herein. In some embodiments, at least one R^{1&} is an electron-withdrawing group from the LIST EWG3 as defined herein. In some embodiments, at least one R^{1&} is an electron-withdrawing group from the LIST EWG4 as defined herein. In some embodiments, at least one R^{1&} is an electron-withdrawing group from the LIST Pi-EWG as defined herein.

In some embodiments, at least one R^{2&} is an electron-withdrawing group from the LIST EWG1 as defined herein. In some embodiments, at least one R^{2&} is an electron-withdrawing group from the LIST EWG2 as defined herein. In some embodiments, at least one R^{2&} is an electron-withdrawing group from the LIST EWG3 as defined herein. In some embodiments, at least one R^{2&} is an electron-withdrawing group from the LIST EWG4 as defined herein. In some embodiments, at least one R^{2&} is an electron-withdrawing group from the LIST Pi-EWG as defined herein.

In some embodiments, at least one R^{3&} is an electron-withdrawing group from the LIST EWG1 as defined herein. In some embodiments, at least one R^{3&} is an electron-withdrawing group from the LIST EWG2 as defined herein. In some embodiments, at least one R^{3&} is an electron-withdrawing group from the LIST EWG3 as defined herein. In some embodiments, at least one R^{3&} is an electron-withdrawing group from the LIST EWG4 as defined herein. In some embodiments, at least one R^{3&} is an electron-withdrawing group from the LIST Pi-EWG as defined herein.

In some embodiments, at least one L_{A} is an electron-withdrawing group from the LIST EWG1 as defined herein. In some embodiments, at least one L_{A} is an electron-withdrawing group from the LIST EWG2 as defined herein. In some embodiments, at least one L_{A} is an electron-withdrawing group from the LIST EWG3 as defined herein. In some embodiments, at least one L_{A} is an electron-withdrawing group from the LIST EWG4 as defined herein. In some embodiments, at least one L_{A} is an electron-withdrawing group from the LIST Pi-EWG as defined herein.

In some embodiments, at least one L_{B} is an electron-withdrawing group from the LIST EWG1 as defined herein. In some embodiments, at least one L_{B} is an electron-withdrawing group from the LIST EWG2 as defined herein. In some embodiments, at least one L_{B} is an electron-withdrawing group from the LIST EWG3 as defined herein. In some embodiments, at least one L_{B} is an electron-withdrawing group from the LIST EWG4 as defined herein. In some embodiments, at least one L_{B} is an electron-withdrawing group from the LIST Pi-EWG as defined herein.

In some embodiments, at least one Lc is an electron-withdrawing group from the LIST EWG1 as defined herein. In some embodiments, at least one L_{C} is an electron-withdrawing group from the LIST EWG2 as defined herein. In some embodiments, at least one L_{C} is an electron-withdrawing group from the LIST EWG3 as defined herein. In some embodiments, at least one L_{C} is an electron-withdrawing group from the LIST EWG4 as defined herein. In some embodiments, at least one L_{C} is an electron-withdrawing group from the LIST Pi-EWG as defined herein.

In some embodiments, each of moiety A and moiety B is unfused pyridine rings, at least one R^{1&} or R^{2&} is a germyl group, and at least one of X⁵ to X⁸ is N.

In some embodiments, each of moiety A and moiety B is unfused pyridine rings, at least one R^{1&} or R^{2&} is a germyl group, and Y is not O.

In some embodiments, X⁵ is C, and R^{1&} bonded to X⁵ is selected from the group consisting of hydrogen, deuterium, methyl, phenyl, silyl, germyl, and combinations thereof.

In some embodiments, the R^{1&} bonded to X⁵ comprises cyano. In some embodiments, the R^{1&} bonded to X⁵ is cyano.

In some embodiments, the R^{1&} bonded to X⁶ comprises cyano. In some embodiments, the R^{1&} bonded to X⁶ is cyano.

In some embodiments, the R^{1&} bonded to X⁷ comprises cyano. In some embodiments, the R^{1&} bonded to X⁷ is cyano.

In some embodiments, the R^{1&} bonded to X⁸ comprises cyano. In some embodiments, the R^{1&} bonded to X⁸ is cyano.

In some embodiments, at least one R^{1&}, R^{2&}, R^{3&}, R^{4&}, or R^{5&} comprises a moiety selected from the group consisting of:

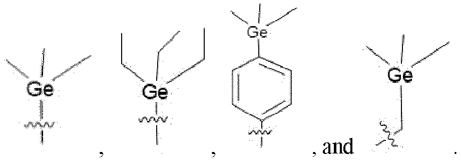

In some embodiments, at least one R^{1&} is not hydrogen or cyano. In some embodiments, at least one R^{1&} is not hydrogen, deuterium, or cyano.

In some embodiments, two R^{1&} are joined or fused to form a ring.

In some embodiments, at least one R^{2&} is not hydrogen. In some embodiments, at least one R^{2&} is not hydrogen or deuterium.

In some embodiments, two R^{2&} are joined or fused to form a ring.

In some embodiments, at least one R^{3&} is not hydrogen. In some embodiments, at least one R^{3&} is not hydrogen or deuterium.

In some embodiments, at least one R^{3&} comprises at least two aryl or heteroaryl moieties that are not fused together. In some embodiments, at least one R^{3&} comprises at least two phenyl moieties that are not fused together.

In some embodiments, at least one R^{3&} comprises at least three aryl or heteroaryl moieties that are not fused together. In some embodiments, at least one R^{3&} comprises at least three phenyl moieties that are not fused together.

In some embodiments, at least one R^{4&} is not hydrogen. In some embodiments, at least one R^{4&} is not hydrogen or deuterium.

In some embodiments, moiety B is a 6-membered ring, and the R^{4&} para to Z¹ is not hydrogen or deuterium. In some embodiments, moiety B is a 6-membered ring, and the R^{4&} para to Z¹ comprises at least one of F, alkyl, or aryl. In some embodiments, moiety B is a 6-membered ring, and the R^{4&} para to Z¹ comprises a germyl group. In some embodiments, moiety B is a 6-membered ring, and the R^{4&} para to Z¹ comprises a germyl group.

In some embodiments, at least one R^{4&} comprises aryl.

In some embodiments, at least one R^{5&} is not hydrogen. In some embodiments, at least one R^{5&} is not hydrogen or deuterium.

In some embodiments, the R^{5&} bonded to X³ is not hydrogen or deuterium. In some embodiments, the R^{5&} bonded to X³ comprises at least one of F, alkyl, or aryl.

In some embodiments, two R^{5&} are joined or fused to form a ring.

In some embodiments, the ligand L_{A} is selected from the group consisting of the structures of the following LIST 1&: 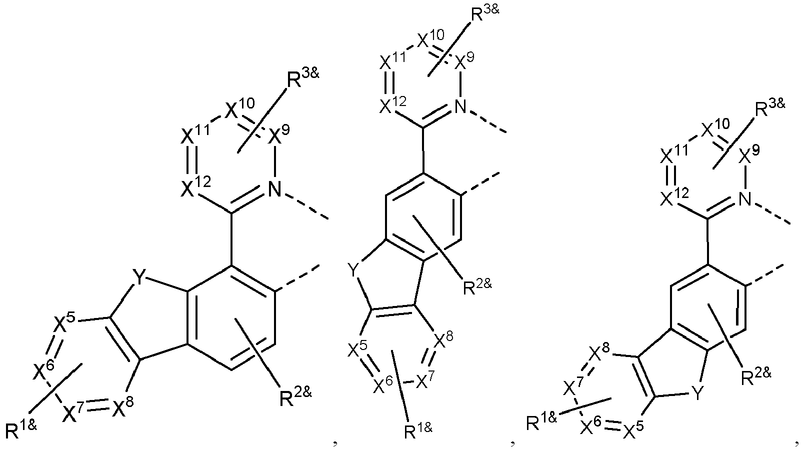 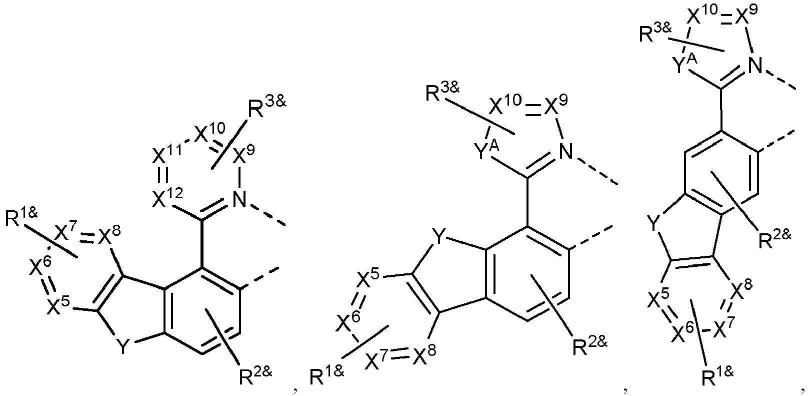 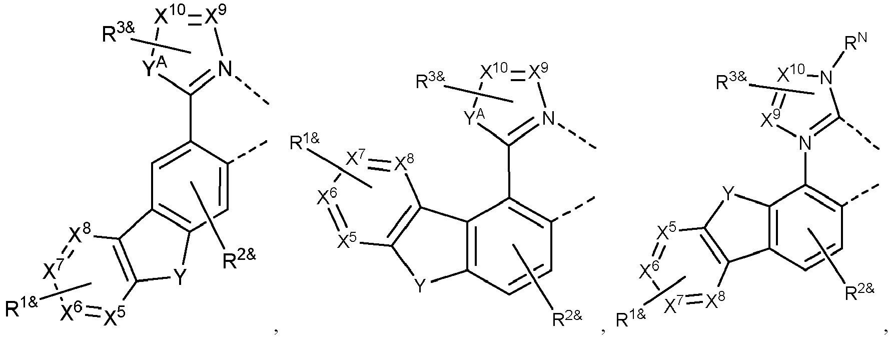 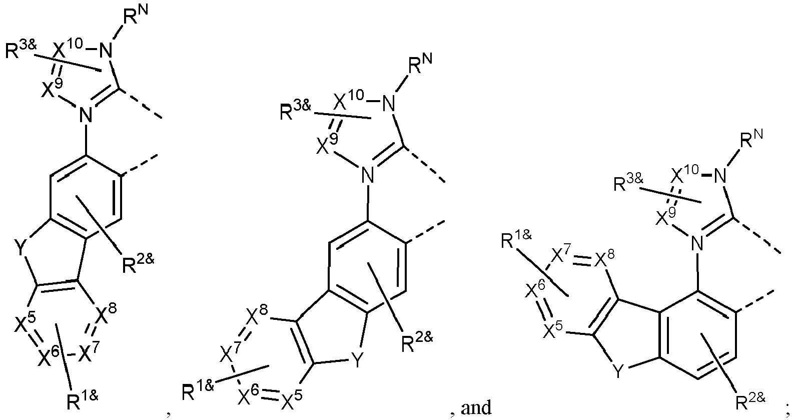 wherein:
each of X⁹ to X¹² is independently C or N;
Y^{A} is selected from the group consisting of BR, BRR', NR, PR, P(O)R, O, S, Se, C=O, C=S, C=Se, C=NR', C=CR'R", S=O, SO₂, CR, CRR', SiRR', and GeRR';
each R, R', R", and R^{N} is independently hydrogen or a substituent selected from the group consisting of the General Substituents defined herein; and
any two substituents can be fused or joined to form a ring.

In some embodiments, the ligand L_{A} is selected from the group consisting of the structures of the following LIST 2&: 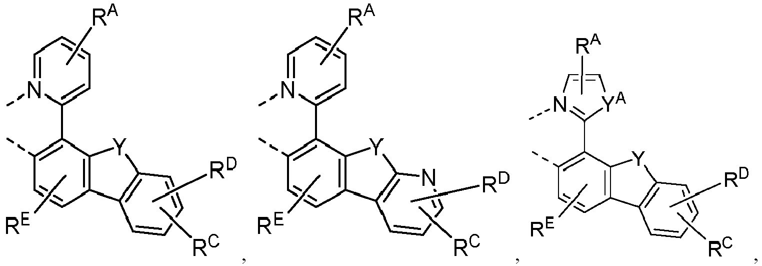 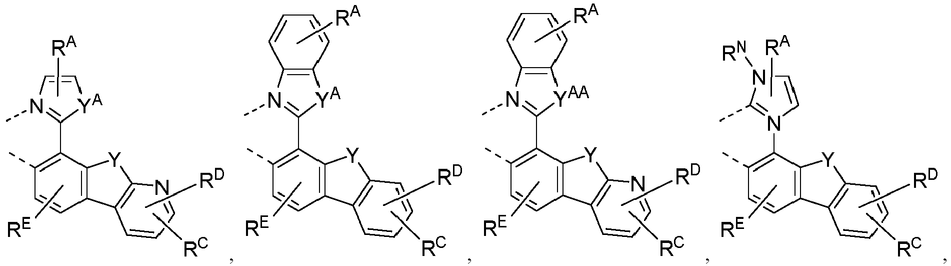 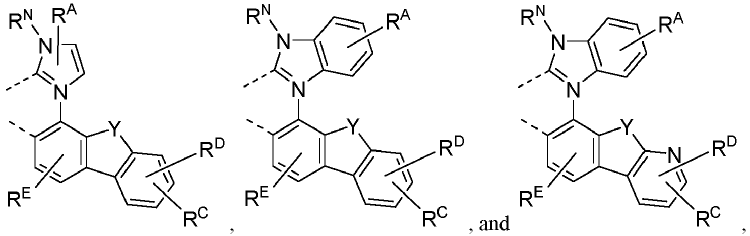 wherein
R^{D} is a monosubstitution selected from the group consisting of cyano group, cyano-containing aryl, and cyano-containing heteroaryl;
each of R^{A}, R^{C}, and R^{E} independently represents mono to the maximum allowable substitution, or no substitutions;
each R^{A}, R^{C}, and R^{E} is independently hydrogen or a substituent selected from the group consisting of the General Substituents defined herein; and
any two substituents can be fused or joined to form a ring.

In some embodiments, at least one of R^{A}, R^{C}, or R^{E} comprises a germyl group. In some embodiments, at least one of R^{A} is/comprises a germyl group. In some embodiments, at least one of R^{C} comprises a germyl group. In some embodiments, at least one of R^{E} comprises a germyl group.

In some embodiments, at least one of R^{A}, R^{C}, or R^{E} is a germyl group. In some embodiments, at least one of R^{A} is a germyl group. In some embodiments, at least one of R^{C} is or comprises a germyl group. In some embodiments, at least one of R^{E} is a germyl group.

In some embodiments, the ligand L_{A} is selected from the group consisting of L_{Ai}(E^{A})(R*^{K}*)(R*^{L}*)(R*^{M}*), L_{A'm}(E^{A})(R*^{K}*)(R*^{L}*)(R*^{M}*), L_{AAn}(E^{A})(R*^{K}*)(R*^{L}*)(R*^{M}*), and L_{AA'o}(E^{A})(R*^{K}*)(R*^{L}*)(R*^{M}*), wherein i and m are each independently an integer from 1 to 56, n and o are each independently an integer from 1 to 14;
wherein, when L_{A} is selected from the group consisting of L_{Ai}(E^{A})(R*^{K}*)(R*^{L}*)(R*^{M}*), i is an integer from 1 to 56; E^{A} is selected from the group consisting of E1 to E40; each of R^{K} and R^{L} is independently selected from the group consisting of R1 to R110; when i is 1, 2, 17, 45-48, or 51-56, R^{M} is selected from the group consisting of R51 to R110; when i is 3-16, 18-44, or 49-50, R^{M} is selected from the group consisting of R1 to R110; and
wherein each of L_{A1}(E1)(R1)(R1)(R51) to L_{A56}(E40)(R110)(R110)(R110) has a structure as defined in the following LIST 3a:

| L_{A} | Structure of L_{A} | L_{A} | Structure of L_{A} |
|---|---|---|---|
| L_{A1}(E^{A})(R*^{K}*)(R*^{L}*)(R*^{M}*), wherein L_{A1}(E1)(R1)(R1)(R51) to L_{A1}(E40)(R110)(R110)(R 110) have the structure | 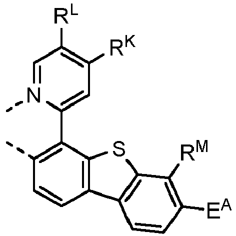 | L_{A2}(E^{A})(R*^{K}*)(R*^{L}*)(R*^{M}*), wherein L_{A2}(E1)(R1)(R1)(R51) to L_{A2}(E40)(R110)(R110)(R 110) have the structure | 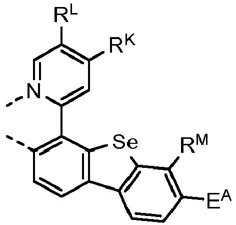 |
| L_{A3}(E^{A})(R*^{K}*)(R*^{L}*)(R*^{M}*), wherein L_{A3}(E1)(R1)(R1)(R1) to L_{A3}(E40)(R110)(R110)(R 110) have the structure | 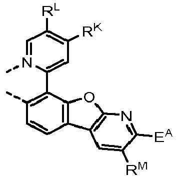 | L_{A4}(E^{A})(R*^{K}*)(R*^{L}*)(R*^{M}*), wherein L_{A4}(E1)(R1)(R1)(R1) to L_{A4}(E40)(R110)(R110)(R 110) have the structure | 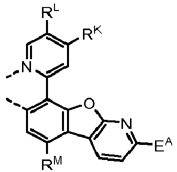 |
| L_{A5}(E^{A})(R*^{K}*)(R*^{L}*)(R*^{M}*), wherein L_{A5}(E1)(R1)(R1)(R1) to L_{A5}(E40)(R110)(R110)(R 110) have the structure | 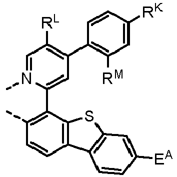 | L_{A6}(E^{A})(R*^{K}*)(R*^{L}*)(R*^{M}*), wherein L_{A6}(E1)(R1)(R1)(R1) to L_{A6}(E40)(R110)(R110)(R 110) have the structure | 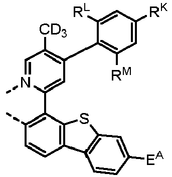 |
| L_{A7}(E^{A})(R*^{K}*)(R*^{L}*)(R*^{M}*), wherein L_{A7}(E1)(R1)(R1)(R1) to L_{A7}(E40)(R110)(R110)(R 110) have the structure | 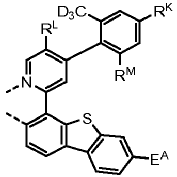 | L_{A8}(E^{A})(R*^{K}*)(R*^{L}*)(R*^{M}*), wherein L_{A8}(E1)(R1)(R1)(R1) to L_{A8}(E40)(R110)(R110)(R 110) have the structure | 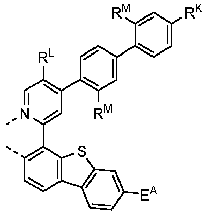 |
| E_{A9}(E^{A})(R*^{K}*)(R*^{L}*)(R*^{M}*), wherein L_{A9}(E1)(R1)(R1)(R1) to L_{A9}(E40)(R110)(R110)(R 110) have the structure | 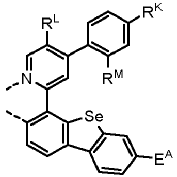 | L_{A10}(E^{A})(R*^{K}*)(R*^{L}*)(R*^{M}*), wherein L_{A10}(E1)(R1)(R1)(R1) to L_{A10}(E40)(R110)(R110)( R110) have the structure | 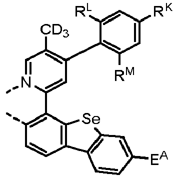 |
| L_{A11}(E^{A})(R*^{K}*)(R*^{L}*)(R*^{M}*), wherein L_{A11}(E1)(R1)(R1)(R1) to L_{A11}(E40)(R110)(R110)( R110) have the structure | 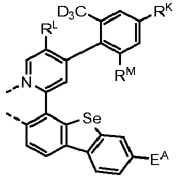 | L_{A12}(E^{A})(R*^{K}*)(R*^{L}*)(R*^{M}*), wherein L_{A12}(E1)(R1)(R1)(R1) to L_{A12}(E40)(R110)(R110)( R110) have the structure | 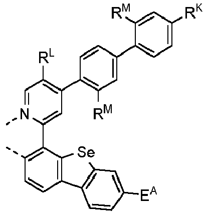 |
| L_{A13}(E^{A})(R*^{K}*)(R*^{L}*)(R*^{M}*), wherein L_{A13}(E1)(R1)(R1)(R1) to L_{A13}(E40)(R110)(R110)( R110) have the structure | 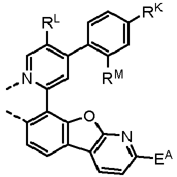 | L_{A14}(E^{A})(R*^{K}*)(R*^{L}*)(R*^{M}*), wherein L_{A14}(E1)(R1)(R1)(R1) to L_{A14}(E40)(R110)(R110)( R110) have the structure | 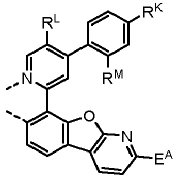 |
| L_{A15}(E^{A})(R*^{K}*)(R*^{L}*)(R*^{M}*), wherein L_{A15}(E1)(R1)(R1)(R1) to L_{A15}(E40)(R110)(R110)( R110) have the structure | 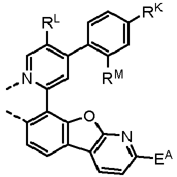 | L_{A16}(E^{A})(R*^{K}*)(R*^{L}*)(R*^{M}*), wherein L_{A16}(E1)(R1)(R1)(R1) to L_{A16}(E40)(R110)(R110)( R110) have the structure | 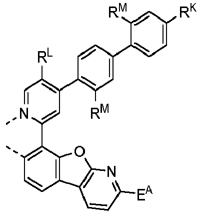 |
| L_{A17}(E^{A})(R*^{K}*)(R*^{L}*)(R*^{M}*), wherein L_{A17}(E1)(R1)(R1)(R51) to L_{A17}(E40)(R110)(R110)( R110) have the structure | 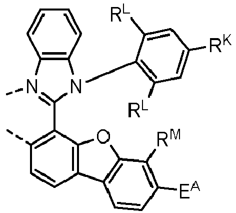 | L_{A18}(E^{A})(R*^{K}*)(R*^{L}*)(R*^{M}*), wherein L_{A18}(E1)(R1)(R1)(R1) to L_{A18}(E40)(R110)(R110)( R110) have the structure | 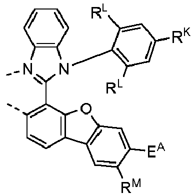 |
| L_{A19}(E^{A})(R*^{K}*)(R*^{L}*)(R*^{M}*), wherein L_{A19}(E1)(R1)(R1)(R1) to L_{A19}(E40)(R110)(R110)( R110) have the structure | 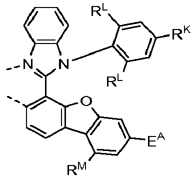 | L_{A20}(E^{A})(R*^{K}*)(R*^{L}*)(R*^{M}*), wherein L_{A20}(E1)(R1)(R1)(R1) to L_{A20}(E40)(R110)(R110)( R110) have the structure | 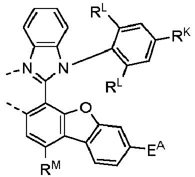 |
| L_{A21}(E^{A})(R*^{K}*)(R*^{L}*)(R*^{M}*), wherein L_{A21}(E1)(R1)(R1)(R1) to L_{A21}(E40)(R110)(R110)( R110) have the structure | 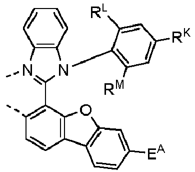 | L_{A22}(E^{A})(R*^{K}*)(R*^{L}*)(R*^{M}*), wherein L_{A22}(E1)(R1)(R1)(R1) to L_{A22}(E40)(R110)(R110)( R110) have the structure | 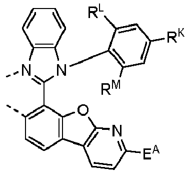 |
| L_{A23}(E^{A})(R*^{K}*)(R*^{L}*)(R*^{M}*), wherein L_{A23}(E1)(R1)(R1)(R1) to L_{A23}(E40)(R110)(R110)( R110) have the structure | 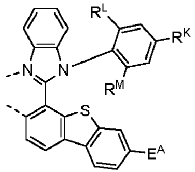 | L_{A24}(E^{A})(R*^{K}*)(R*^{L}*)(R*^{M}*), wherein L_{A24}(E1)(R1)(R1)(R1) to L_{A24}(E40)(R110)(R110)( R110) have the structure | 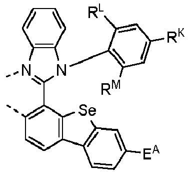 |
| L_{A25}(E^{A})(R*^{K}*)(R*^{L}*)(R*^{M}*), wherein L_{A25}(E1)(R1)(R1)(R1) to L_{A25}(E40)(R110)(R110)( R110) have the structure | 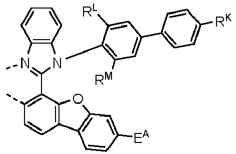 | L_{A26}(E^{A})(R*^{K}*)(R*^{L}*)(R*^{M}*), wherein L_{A26}(E1)(R1)(R1)(R1) to L_{A26}(E40)(R110)(R110)( R110) have the structure | 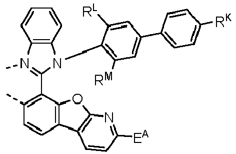 |
| L_{A27}(E^{A})(R*^{K}*)(R*^{L}*)(R*^{M}*), wherein L_{A27}(E1)(R1)(R1)(R1) to L_{A27}(E40)(R110)(R110)( R110) have the structure | 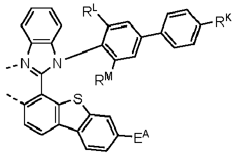 | L_{A28}(E^{A})(R*^{K}*)(R*^{L}*)(R*^{M}*), wherein L_{A28}(E1)(R1)(R1)(R1) to L_{A28}(E40)(R110)(R110)( R110) have the structure | 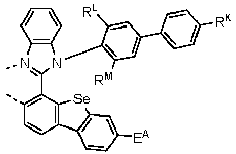 |
| L_{A29}(E^{A})(R*^{K}*)(R*^{L}*)(R*^{M}*). wherein L_{A29}(E1)(R1)(R1)(R1) to L_{A29}(E40)(R110)(R110)( R110) have the structure | 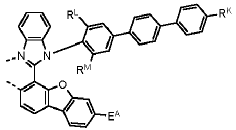 | L_{A30}(E^{A})(R*^{K}*)(R*^{L}*)(R*^{M}*), wherein L_{A30}(E1)(R1)(R1)(R1) to L_{A30}(E40)(R110)(R110)( R110) have the structure | 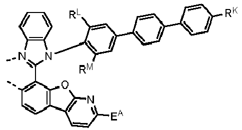 |
| L_{A31}(E^{A})(R*^{K}*)(R*^{L}*)(R*^{M}*), wherein L_{A31}(E1)(R1)(R1)(R1) to L_{A31}(E40)(R110)(R110)( R110) have the structure | 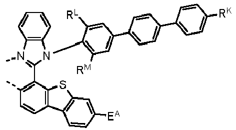 | L_{A32}(E^{A})(R*^{K}*)(R*^{L}*)(R*^{M}*), wherein L_{A32}(E1)(R1)(R1)(R1) to L_{A32}(E40)(R110)(R110)( R110) have the structure | 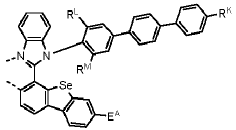 |
| L_{A33}(E^{A})(R*^{K}*)(R*^{L}*)(R*^{M}*), wherein L_{A33}(E1)(R1)(R1)(R1) to L_{A33}(E40)(R110)(R110)( R110) have the structure | 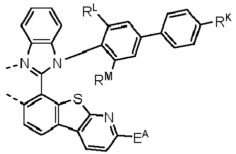 | L_{A34}(E^{A})(R*^{K}*)(R*^{L}*)(R*^{M}*). wherein L_{A34}(E1)(R1)(R1)(R1) to L_{A34}(E40)(R110)(R110)( R110) have the structure | 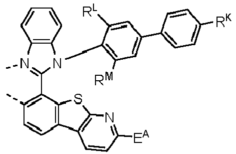 |
| L_{A35}(E^{A})(R*^{K}*)(R*^{L}*)(R*^{M}*), wherein L_{A35}(E1)(R1)(R1)(R1) to L_{A35}(E40)(R110)(R110)( R110) have the structure | 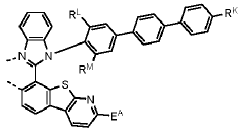 | L_{A36}(E^{A})(R*^{K}*)(R*^{L}*)(R*^{M}*), wherein L_{A36}(E1)(R1)(R1)(R1) to L_{A36}(E40)(R110)(R110)( R110) have the structure | 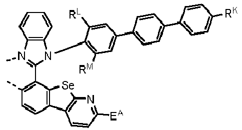 |
| L_{A37}(E^{A})(R*^{K}*)(R*^{L}*)(R*^{M}*), wherein L_{A37}(E1)(R1)(R1)(R1) to L_{A37}(E40)(R110)(R110)( R110) have the structure | 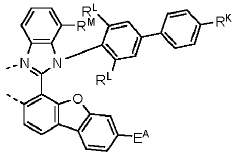 | L_{A38}(E^{A})(R*^{K}*)(R*^{L}*)(R*^{M}*), wherein L_{A38}(E1)(R1)(R1)(R1) to L_{A38}(E40)(R110)(R110)( R110) have the structure | 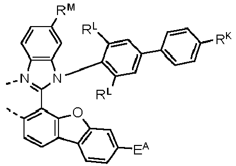 |
| L_{A39}(E^{A})(R*^{K}*)(R*^{L}*)(R*^{M}*), wherein L_{A39}(E1)(R1)(R1)(R1) to L_{A39}(E40)(R110)(R110)( R110) have the structure | 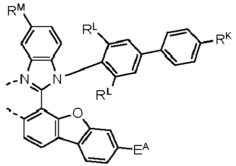 | L_{A40}(E^{A})(R*^{K}*)(R*^{L}*)(R*^{M}*), wherein L_{A40}(E1)(R1)(R1)(R1) to L_{A40}(E40)(R110)(R110)( R110) have the structure | 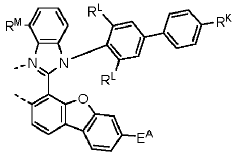 |
| L_{A41}(E^{A})(R*^{K}*)(R*^{L}*)(R*^{M}*), wherein L_{A41}(E1)(R1)(R1)(R1) to L_{A41}(E40)(R110)(R110)( R110) have the structure | 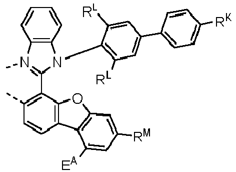 | L_{A42}(E^{A})(R*^{K}*)(R*^{L}*)(R*^{M}*), wherein L_{A42}(E1)(R1)(R1)(R1) to L_{A42}(E40)(R110)(R110)( R110) have the structure | 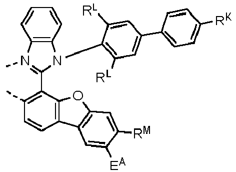 |
| L_{A43}(E^{A})(R*^{K}*)(R*^{L}*)(R*^{M}*), wherein L_{A43}(E1)(R1)(R1)(R1) to L_{A43}(E40)(R110)(R110)( R110) have the structure | 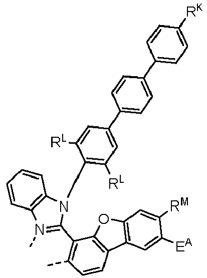 | L_{A44}(E^{A})(R*^{K}*)(R*^{L}*)(R*^{M}*), wherein L_{A44}(E1)(R1)(R1)(R1) to L_{A44}(E40)(R110)(R110)( R110) have the structure | 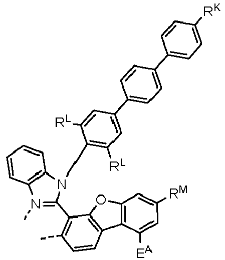 |
| L_{A45}(E^{A})(R*^{K}*)(R*^{L}*)(R*^{M}*), wherein L_{A45}(E1)(R1)(R1)(R51) to L_{A45}(E40)(R110)(R110)( R110) have the structure | 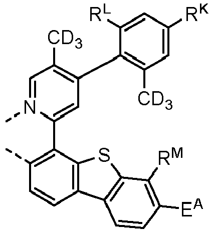 | L_{A46}(E^{A})(R*^{K}*)(R*^{L}*)(R*^{M}*), wherein L_{A46}(E1)(R1)(R1)(R51) to L_{A46}(E40)(R110)(R110)( R110) have the structure | 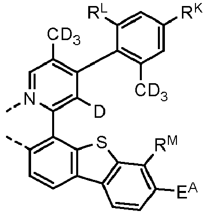 |
| L_{A47}(E^{A})(R*^{K}*)(R*^{L}*)(R*^{M}*), wherein L_{A47}(E1)(R1)(R1)(R51) to L_{A47}(E40)(R110)(R110)( R110) have the structure | 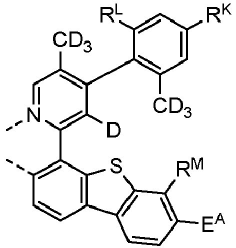 | L_{A48}(E^{A})(R*^{K}*)(R*^{L}*)(R*^{M}*), wherein L_{A48}(E1)(R1)(R1)(R51) to L_{A48}(E40)(R110)(R110)( R110) have the structure | 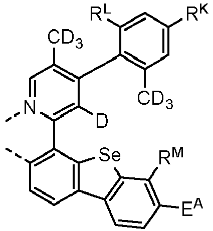 |
| L_{A49}(E^{A})(R*^{K}*)(R*^{L}*)(R*^{M}*), wherein L_{A49}(E1)(R1)(R1)(R1) to L_{A49}(E40)(R110)(R110)( R110) have the structure | 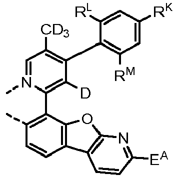 | L_{A50}(E^{A})(R*^{K}*)(R*^{L}*)(R*^{M}*), wherein L_{A50}(E1)(R1)(R1)(R1) to L_{A50}(E40)(R110)(R110)( R110) have the structure | 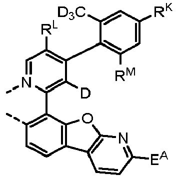 |
| L_{A51}(E^{A})(R*^{K}*)(R*^{L}*)(R*^{M}*), wherein L_{A51}(E1)(R1)(R1)(R51) to L_{A51}(E40)(R110)(R110)( R110) have the structure | 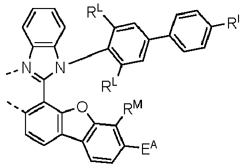 | L_{A52}(E^{A})(R*^{K}*)(R*^{L}*)(R*^{M}*), wherein L_{A52}(E1)(R1)(R1)(R51) to L_{A52}(E40)(R110)(R110)( R110) have the structure | 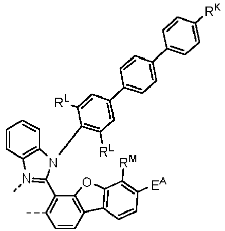 |
| L_{A53}(E^{A})(R*^{K}*)(R*^{L}*)(R*^{M}*), wherein L_{A53}(E1)(R1)(R1)(R51) to L_{A53}(E40)(R110)(R110)( R110) have the structure | 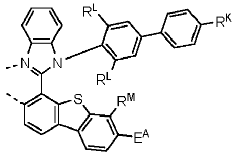 | L_{A54}(E^{A})(R*^{K}*)(R*^{L}*)(R*^{M}*), wherein L_{A54}(E1)(R1)(R1)(R51) to L_{A54}(E40)(R110)(R110)( R110) have the structure | 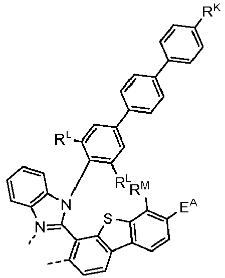 |
| L_{A55}(E^{A})(R*^{K}*)(R*^{L}*)(R*^{M}*), wherein L_{A55}(E1)(R1)(R1)(R51) to L_{A55}(E40)(R110)(R110)( R110) have the structure | 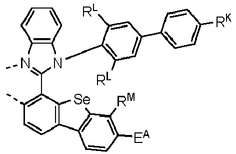 | L_{A56}(E^{A})(R*^{K}*)(R*^{L}*)(R*^{M}*), wherein L_{A56}(E1)(R1)(R1)(R51) to L_{A56}(E40)(R110)(R110)( R110) have the structure | 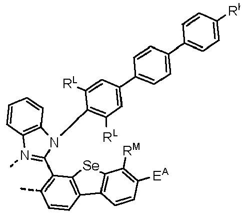 |

wherein, when L_{A} is selected from the group consisting of L_{A'm}(E^{A})(R*^{K}*)(R*^{L}*)(R*^{M}*), m is an integer from 1 to 56; E^{A} is selected from E1 to E40; R^{K} is selected from the group consisting of R71 to R110; R^{L} is independently selected from the group consisting of R1 to R110; when m is 1, 2, 17, or 45-56, R^{M} is selected from the group consisting of R51 to R110; when m is 3-16 or 18-44, R^{M} is selected from the group consisting of R1 to R110; and
each of L_{A'1}(E1)(R71)(R1)(R51) to L_{A56}(E40)(R110)(R110)(R110) has a structure as defined in the following LIST 3b:

| L_{A}, | Structure of L_{A'} | L_{A}, | Structure of L_{A'} |
|---|---|---|---|
| L_{A'1}(E^{A})(R*^{K}*)(R*^{L}*)(R*^{M}*), wherein L_{A'1}(E1)(R71)(R1)(R51) to L_{A'1}(E40)(R110)(R110)(R 110) have the structure | 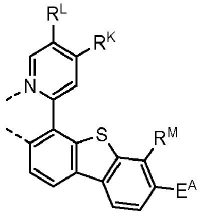 | L_{A'2}(E^{A})(R*^{K}*)(R*^{L}*)(R*^{M}*), wherein L_{A2}(E1)(R71)(R1)(R51) to L_{A'2}(E40)(R110)(R110)(R 110) have the structure | 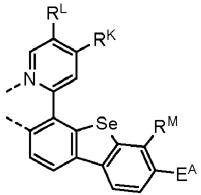 |
| L_{A'3}(E^{A})(R*^{K}*)(R*^{L}*)(R*^{M}*), wherein L_{A'3}(E1)(R71)(R1)(R1) to L_{A'3}(E40)(R110)(R110)(R 110) have the structure | 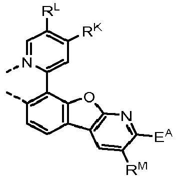 | L_{A'4}(E^{A})(R*^{K}*)(R*^{L}*)(R*^{M}*), wherein L_{A'4}(E1)(R71)(R1)(R1) to L_{A'4}(E40)(R110)(R110)(R 110) have the structure | 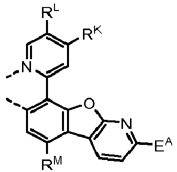 |
| L_{A'5}(E^{A})(R*^{K}*)(R*^{L}*)(R*^{M}*), wherein L_{A'5}(E1)(R71)(R1)(R1) to L_{A'5}(E40)(R110)(R110)(R 110) have the structure | 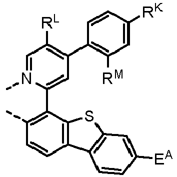 | L_{A'6}(E^{A})(R*^{K}*)(R*^{L}*)(R*^{M}*), wherein L_{A'6}(E1)(R71)(R1)(R1) to L_{A'6}(E40)(R110)(R110)(R 110) have the structure | 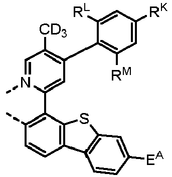 |
| L_{A'7}(E^{A})(R*^{K}*)(R*^{L}*)(R*^{M}*), wherein L_{A'7}(E1)(R71)(R1)(R1) to L_{A'7}(E40)(R110)(R110)(R 110) have the structure | 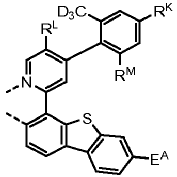 | L_{A'8}(E^{A})(R*^{K}*)(R*^{L}*)(R*^{M}*), wherein L_{A'8}(E1)(R71)(R1)(R1) to L_{A'8}(E40)(R110)(R110)(R 110) have the structure | 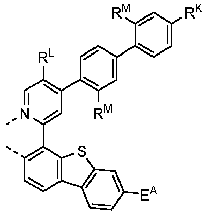 |
| L_{A'9}(E^{A})(R*^{K}*)(R*^{L}*)(R*^{M}*), wherein L_{A'9}(E1)(R71)(R1)(R1) to L_{A'9}(E40)(R110)(R110)(R 110) have the structure | 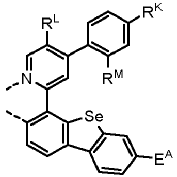 | L_{A'10}(E^{A})(R*^{K}*)(R*^{L}*)(R*^{M}*), wherein L_{A10}(E1)(R71)(R1)(R1) to L_{A'10}(E40)(R110)(R110)( R110) have the structure | 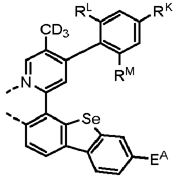 |
| L_{A'11}(E^{A})(R*^{K}*)(R*^{L}*)(R*^{M}*), wherein L_{A'11}(E1)(R71)(R1)(R1) to L_{A'11}(E40)(R110)(R110)( R110) have the structure | 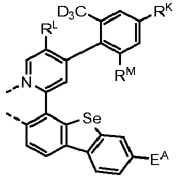 | L_{A'12}(E^{A})(R*^{K}*)(R*^{L}*)(R*^{M}*), wherein L_{A'12}(E1)(R71)(R1)(R1) to L_{A'12}(E40)(R110)(R110)( R110) have the structure | 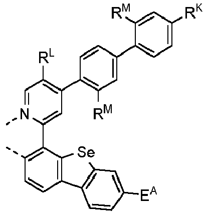 |
| L_{A'13}(E^{A})(R*^{K}*)(R*^{L}*)(R*^{M}*), wherein L_{A13}(E1)(R71)(R1)(R1) to L_{A13}(E40)(R110)(R110)( R110) have the structure | 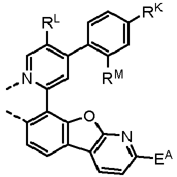 | L_{A'14}(E^{A})(R*^{K}*)(R*^{L}*)(R*^{M}*), wherein L_{A'14}(E1)(R71)(R1)(R1) to L_{A'14}(E40)(R110)(R110)( R110) have the structure | 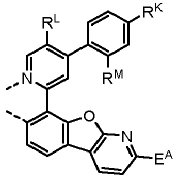 |
| L_{A'15}(E^{A})(R*^{K}*)(R*^{L}*)(R*^{M}*), wherein L_{A'15}(E1)(R71)(R1)(R1) to L_{A'15}(E40)(R110)(R110)( R110) have the structure | 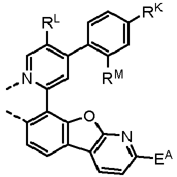 | L_{A'16}(E^{A})(R*^{K}*)(R*^{L}*)(R*^{M}*), wherein L_{A'16}(E1)(R71)(R1)(R1) to L_{A'16}(E40)(R110)(R110)( R110) have the structure | 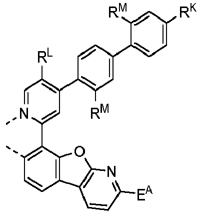 |
| L_{A'17}(E^{A})(R*^{K}*)(R*^{L}*)(R^{*M*'}), wherein L_{A'17}(E1)(R71)(R1)(R51) to L_{A'17}(E40)(R110)(R110)( R110) have the structure | 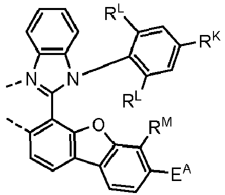 | L_{A'18}(E^{A})(R*^{K}*)(R*^{L}*)(R^{*M*'}). wherein L_{A'18}(E1)(R71)(R1)(R1) to L_{A'18}(E40)(R110)(R110)( R110) have the structure | 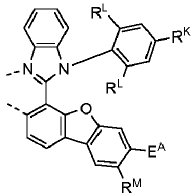 |
| L_{A'19}(E^{A})(R*^{K}*)(R*^{L}*)(R*^{M}*), wherein L_{A19}(E1)(R71)(R1)(R1) to L_{A'19}(E40)(R110)(R110)( R110) have the structure | 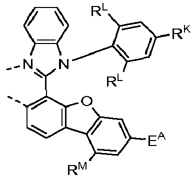 | L_{A'20}(E^{A})(R*^{K}*)(R*^{L}*)(R*^{M}*), wherein L_{A'20}(E1)(R71)(R1)(R1) to L_{A'20}(E40)(R110)(R110)( R110) have the structure | 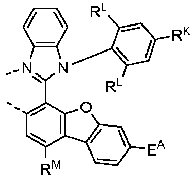 |
| L_{A'21}(E^{A})(R*^{K}*)(R*^{L}*)(R*^{M}*), wherein L_{A'21}(E1)(R71)(R1)(R1) to L_{A'21}(E40)(R110)(R110)( R110) have the structure | 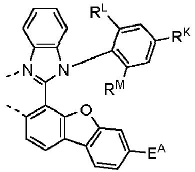 | L_{A'22}(E^{A})(R*^{K}*)(R*^{L}*)(R*^{M}*), wherein L_{A'22}(E1)(R71)(R1)(R1) to L_{A'22}(E40)(R110)(R110)( R110) have the structure | 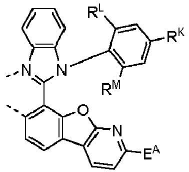 |
| L_{A'23}(E^{A})(R*^{K}*)(R*^{L}*)(R*^{M}*), wherein L_{A'23}(E1)(R71)(R1)(R1) to L_{A23}(E40)(R110)(R110)( R110) have the structure | 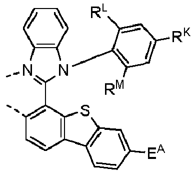 | L_{A'24}(E^{A})(R*^{K}*)(R*^{L}*)(R*^{M}*), wherein L_{A'24}(E1)(R71)(R1)(R1) to L_{A24}(E40)(R110)(R110)( R110) have the structure | 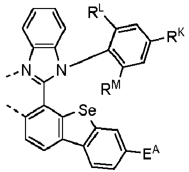 |
| L_{A'25}(E^{A})(R*^{K}*)(R*^{L}*)(R*^{M}*), wherein L_{A'25}(E1)(R71)(R1)(R1) to L_{A25}(E40)(R110)(R110)( R110) have the structure | 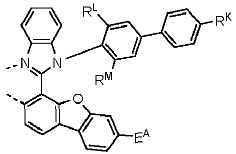 | L_{A'26}(E^{A})(R*^{K}*)(R*^{L}*)(R*^{M}*), wherein L_{A'26}(E1)(R71)(R1)(R1) to L_{A'26}(E40)(R110)(R110)( R110) have the structure | 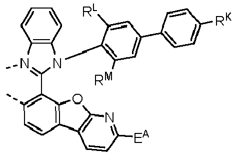 |
| L_{A'27}(E^{A})(R*^{K}*)(R*^{L}*)(R*^{M}*), wherein L_{A'27}(E1)(R71)(R1)(R1) to L_{A'27}(E40)(R110)(R110)( R110) have the structure | 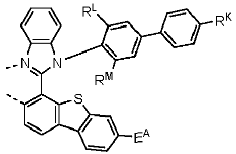 | L_{A'28}(E^{A})(R*^{K}*)(R*^{L}*)(R*^{M}*), wherein L_{A'28}(E1)(R71)(R1)(R1) to L_{A'28}(E40)(R110)(R110)( R110) have the structure | 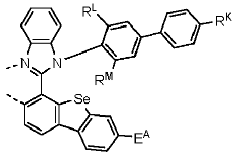 |
| L_{A'29}(E^{A})(R*^{K}*)(R*^{L}*)(R*^{M}*), wherein L_{A'29}(E1)(R71)(R1)(R1) to L_{A'29}(E40)(R110)(R110)( R110) have the structure | 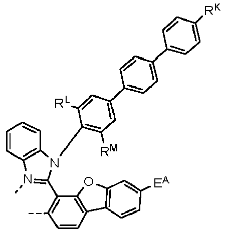 | L_{A'30}(E^{A})(R*^{K}*)(R*^{L}*)(R*^{M}*), wherein L_{A'30}(E1)(R71)(R1)(R1) to L_{A'30}(E40)(R110)(R110)( R110) have the structure | 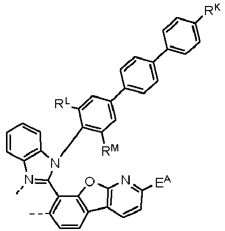 |
| L_{A'31}(E^{A})(R*^{K}*)(R*^{L}*)(R*^{M}*), wherein L_{A'31}(E1)(R71)(R1)(R1) to L_{A'31}(E40)(R110)(R110)( R110) have the structure | 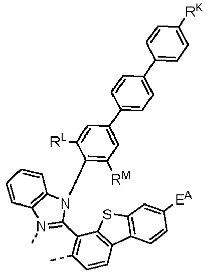 | L_{A'32}(E^{A})(R*^{K}*)(R*^{L}*)(R*^{M}*), wherein L_{A'32}(E1)(R71)(R1)(R1) to L_{A'32}(E40)(R110)(R110)( R110) have the structure | 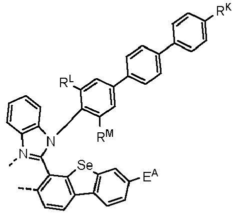 |
| L_{A'33}(E^{A})(R*^{K}*)(R*^{L}*)(R*^{M}*), wherein L_{A'33}(E1)(R71)(R1)(R1) to L_{A'33}(E40)(R110)(R110)( R110) have the structure | 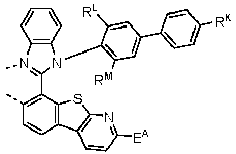 | L_{A'34}(E^{A})(R*^{K}*)(R*^{L}*)(R*^{M}*), wherein L_{A'34}(E1)(R71)(R1)(R1) to L_{A'34}(E40)(R110)(R110)( R110) have the structure | 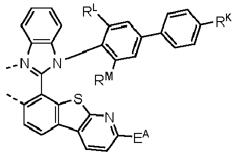 |
| L_{A'35}(E^{A})(R*^{K}*)(R*^{L}*)(R*^{M}*), wherein L_{A'35}(E1)(R71)(R1)(R1) to L_{A'35}(E40)(R110)(R110)( R110) have the structure | 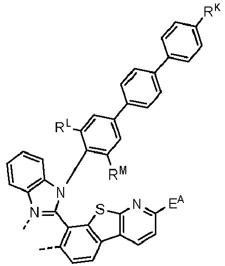 | L_{A'36}(E^{A})(R*^{K}*)(R*^{L}*)(R*^{M}*), wherein L_{A'36}(E1)(R71)(R1)(R1) to L_{A'35}(E40)(R110)(R110)( R110) have the structure | 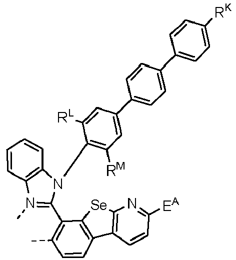 |
| L_{A'37}(E^{A})(R*^{K}*)(R*^{L}*)(R*^{M}*), wherein L_{A'37}(E1)(R71)(R1)(R1) to L_{A'37}(E40)(R110)(R110)( R110) have the structure | 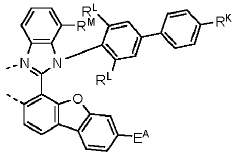 | L_{A'38}(E^{A})(R*^{K}*)(R*^{L}*)(R*^{M}*), wherein L_{A'38}(E1)(R71)(R1)(R1) to L_{A'35}(E40)(R110)(R110)( R110) have the structure | 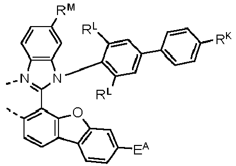 |
| L_{A'39}(E^{A})(R*^{K}*)(R*^{L}*)(R*^{M}*), wherein L_{A39}(E1)(R71)(R1)(R1) to L_{A39}(E40)(R110)(R110)( R110) have the structure | 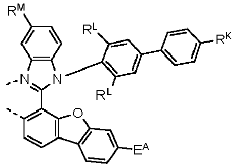 | L_{A'40}(E^{A})(R*^{K}*)(R*^{L}*)(R*^{M}*), wherein L_{A'40}(E1)(R71)(R1)(R1) to L_{A'40}(E40)(R110)(R110)( R110) have the structure | 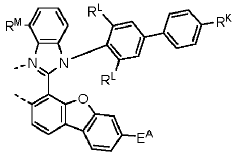 |
| L_{A'41}(E^{A})(R*^{K}*)(R*^{L}*)(R*^{M}*), wherein L_{A'41}(E1)(R71)(R1)(R1) to L_{A'41}(E40)(R110)(R110)( R110) have the structure | 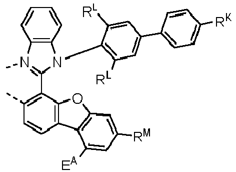 | L_{A'42}(E^{A})(R*^{K}*)(R*^{L}*)(R*^{M}*), wherein L_{A'42}(E1)(R71)(R1)(R1) to L_{A'42}(E40)(R110)(R110)( R110) have the structure | 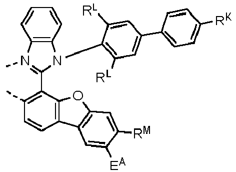 |
| L_{A'43}(E^{A})(R*^{K}*)(R*^{L}*)(R*^{M}*), wherein L_{A'43}(E1)(R71)(R1)(R1) to L_{A'43}(E40)(R110)(R110)( R110) have the structure | 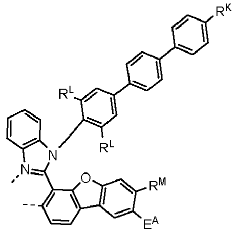 | L_{A'44}(E^{A})(R*^{K}*)(R*^{L}*)(R*^{M}*), wherein L_{A'44}(E1)(R71)(R1)(R1) to L_{A'44}(E40)(R110)(R110)( R110) have the structure | 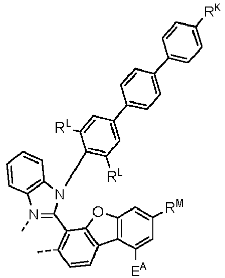 |
| L_{A'45}(E^{A})(R*^{K}*)(R*^{L}*)(R*^{M}*), wherein L_{A'45}(E1)(R71)(R1)(R51) to L_{A'45}(E40)(R110)(R110)( R110) have the structure | 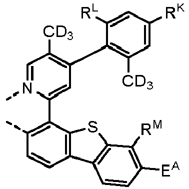 | L_{A'46}(E^{A})(R*^{K}*)(R*^{L}*)(R*^{M}*), wherein L_{A'46}(E1)(R71)(R1)(R51) to L_{A'46}(E40)(R110)(R110)( R110) have the structure | 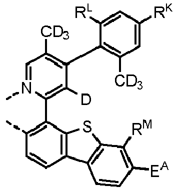 |
| L_{A'47}(E^{A})(R*^{K}*)(R*^{L}*)(R*^{M}*), wherein L_{A'47}(E1)(R71)(R1)(R51) to L_{A'47}(E40)(R110)(R110)( R110) have the structure | 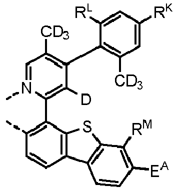 | L_{A'48}(E^{A})(R*^{K}*)(R*^{L}*)(R*^{M}*), wherein L_{A'48}(E1)(R71)(R1)(R51) to L_{A'48}(E40)(R110)(R110)( R110) have the structure | 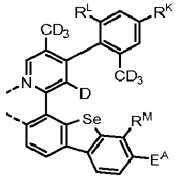 |
| L_{A'49}(E^{A})(R*^{K}*)(R*^{L}*)(R*^{M}*), wherein L_{A'49}(E1)(R71)(R1)(R51) to L_{A'49}(E40)(R110)(R110)( R110) have the structure | 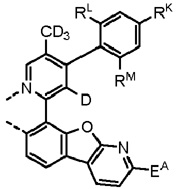 | L_{A'50}(E^{A})(R*^{K}*)(R*^{L}*)(R*^{M}*), wherein L_{A'50}(E1)(R71)(R1)(R51) to L_{A'50}(E^{A})(R*^{K}*)(R*^{L}*)(R*^{M}*), R110) have the structure | 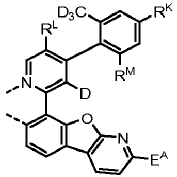 |
| L_{A'51}(E^{A})(R*^{K}*)(R*^{L}*)(R*^{M}*), wherein L_{A'51}(E1)(R71)(R1)(R51) to L_{A'51}(E40)(R110)(R110)( R110) have the structure | 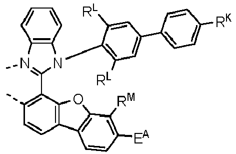 | L_{A'52}(E^{A})(R*^{K}*)(R*^{L}*)(R*^{M}*), wherein L_{A'52}(E1)(R71)(R1)(R51) to L_{A'52}(E40)(R110)(R110)( R110) have the structure | 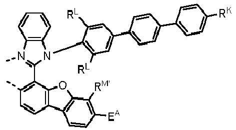 |
| L_{A'53}(E^{A})(R*^{K}*)(R*^{L}*)(R*^{M}*), wherein L_{A'53}(E1)(R71)(R1)(R51) to L_{A'53}(E40)(R110)(R110)( R110) have the structure | 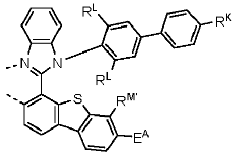 | L_{A'54}(E^{A})(R*^{K}*)(R*^{L}*)(R*^{M}*), wherein L_{A'54}(E1)(R71)(R1)(R51) to L_{A'54}(E40)(R110)(R110)( R110) have the structure | 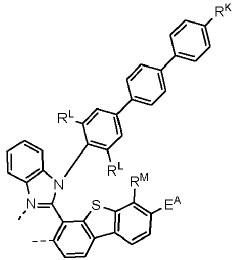 |
| L_{A'55}(E^{A})(R*^{K}*)(R*^{L}*)(R*^{M}*), wherein L_{A'55}(E1)(R71)(R1)(R51) to L_{A'53}(E40)(R110)(R110)( R110) have the structure | 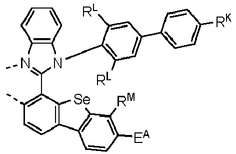 | L_{A'56}(E^{A})(R*^{K}*)(R*^{L}*)(R*^{M}*), wherein L_{A'56}(E1)(R71)(R1)(R51) to L_{A'53}(E40)(R110)(R110)( R110) have the structure | 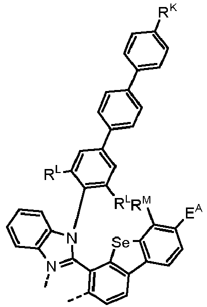 |

wherein, when L_{A} is selected from the group consisting of L_{AAn}(E^{A})(R*^{K}*)(R*^{L}*)(R*^{M}*), n is an integer from 1 to 14, E^{A} is selected from E1 to E40; R^{K} is selected from the group consisting of R1 to R110; when n is 1, R^{L} is selected from the group consising of 51 to 110; when n is 2-14, R^{L} is selected from the group consising of 51 to 110; when n is 1 to 10, R^{M} is selected from the group consising of 1 to 110; when n is 11 to 14, R^{M} is selected from the group consising of 51 to 110; and each of L_{AA1}(E1)(R71)(R51)(R1) to L_{AA14}(E40)(R110)(R110)(R110) has a structure as defined in the following LIST 3c:

| L_{AA} | Structure of L_{AA} | L_{AA} | Structure of L_{AA} |
|---|---|---|---|
| L_{AA1}(E^{A})(R*^{K}*)(R*^{L}*)(R*^{M}*), wherein L_{AA1}(E1)(R1)(R51)(R1) to L_{AA1}(E40)(R110)(R110)( R110) have the structure | 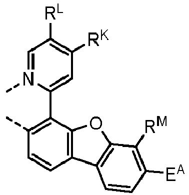 | L_{AA2}(E^{A})(R*^{K}*)(R*^{L}*)(R*^{M}*), wherein L_{AA2}(E1)(R1)(R1)(R1) to L_{AA2}(E40)(R110)(R110)( R110) have the structure | 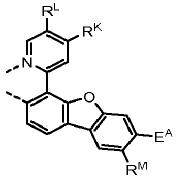 |
| L_{AA3}(E^{A})(R*^{K}*)(R*^{L}*)(R*^{M}*), wherein L_{AA3}(E1)(R1)(R1)(R1) to L_{AA3}(E40)(R110)(R110)( R110) have the structure | 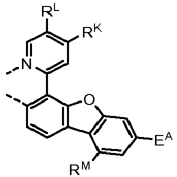 | L_{AA4}(E^{A})(R*^{K}*)(R*^{L}*)(R*^{M}*), wherein L_{AA4}(E1)(R1)(R1)(R1) to L_{AA4}(E40)(R110)(R110)( R110) have the structure | 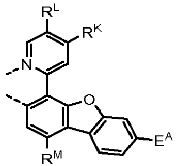 |
| L_{AA5}(E^{A})(R*^{K}*)(R*^{L}*)(R*^{M}*), wherein L_{AA5}(E1)(R1)(R1)(R1) to L_{AA5}(E40)(R110)(R110)( R110) have the structure | 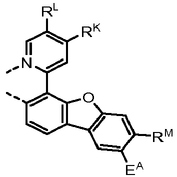 | L_{AA6}(E^{A})(R*^{K}*)(R*^{L}*)(R*^{M}*), wherein L_{AA6}(E1)(R1)(R1)(R1) to L_{AA6}(E40)(R110)(R110)( R110) have the structure | 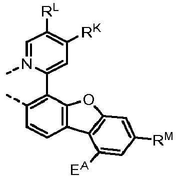 |
| L_{AA7}(E^{A})(R*^{K}*)(R*^{L}*)(R*^{M}*), wherein L_{AA7}(E1)(R1)(R1)(R1) to L_{AA7}(E40)(R110)(R110)( R110) have the structure | 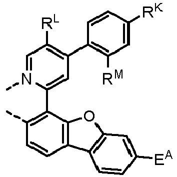 | L_{AA8}(E^{A})(R*^{K}*)(R*^{L}*)(R*^{M}*), wherein L_{AA8}(E1)(R1)(R1)(R1) to L_{AA8}(E40)(R110)(R110)( R110) have the structure | 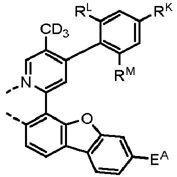 |
| L_{AA9}(E^{A})(R*^{K}*)(R*^{L}*)(R*^{M}*), wherein L_{AA9}(E1)(R1)(R1)(R1) to L_{AA9}(E40)(R110)(R110)( R110) have the structure | 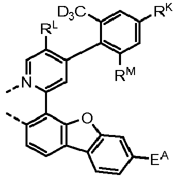 | L_{AA10}(E^{A})(R*^{K}*)(R*^{L}*)(R*^{M}*), wherein LA_{AA10}(E1)(R1)(R1)(R1) to L_{AA10}(E40)(R110)(R110)( R110) have the structure | 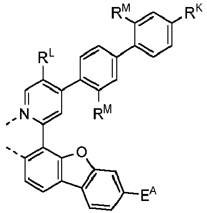 |
| L_{AA11}(E^{A})(R*^{K}*)(R*^{L}*)(R*^{M}*), wherein L_{AA11}(E1)(R1)(R1)(R51) to L_{AA11}(E40)(R110)(R110)( R110) have the structure | 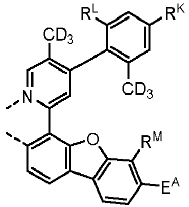 | L_{AA12}(E^{A})(R*^{K}*)(R*^{L}*)(R*^{M}*), wherein L_{AA12}(E1)(R1)(R1)(R51) to L_{AA12}(E40)(R110)(R110)( R110) have the structure | 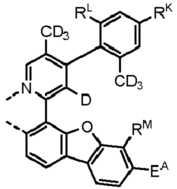 |
| L_{AA13}(E^{A})(R*^{K}*)(R*^{L}*)(R*^{M}*), wherein L_{AA13}(E1)(R1)(R1)(R51) to L_{AA13}(E40)(R110)(R110)( R110) have the structure | 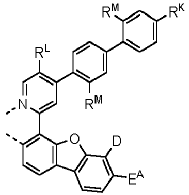 | L_{AA14}(E^{A})(R*^{K}*)(R*^{L}*)(R*^{M}*), wherein L_{AA14}(E1)(R1)(R1)(R51) to L_{AA14}(E40)(R110)(R110)( R110) have the structure | 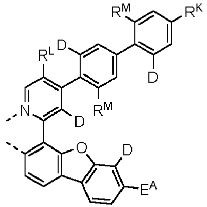 |

wherein, when L_{A} is selected from the group consisting of L_{AA}'ₒ(E^{A})(R*^{K}*)(R*^{L}*)(R*^{M}*); o is an integer from 1 to 14; E^{A} is selected from E1 to E40; R^{K} is selected from the group consisting of R71 to R110; when o is 1, R^{L} is selected from the group consising of 51 to 110; when o is 2-14, R^{L} is selected from the group consising of 51 to 90; when o is 1 to 10, R^{M} is selected from the group consising of 1 to 90; when o is 11 to 14, R^{M} is selected from the group consising of 51 to 110; and each of L_{AA'1}(E1)(R71)(R51)(R1) to L_{AA'14}(E40)(R110)(R110)(R110) has a structure as defined in the following LIST 3d:

| L_{AA'} | Structure of L_{AA'} | L_{AA'} | Structure of L_{AA'} |
|---|---|---|---|
| L_{AA'1}(E^{A})(R*^{K}*)(R*^{L}*)(R*^{M}*), wherein L_{AA'1}(E1)(R71)(R51)(R1) to L_{AA'1}(E40)(R110)(R110)( R110) have the structure | 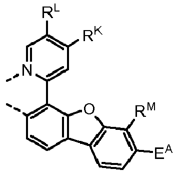 | L_{AA'2}(E^{A})(R*^{K}*)(R*^{L}*)(R*^{M}*), wherein L_{AA'2}(E1)(R71)(R1)(R1) to L_{AA'2}(E40)(R110)(R110)( R110) have the structure | 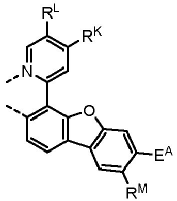 |
| L_{AA'3}(E^{A})(R*^{K}*)(R*^{L}*)(R*^{M}*), wherein L_{AA'3}(E1)(R71)(R1)(R1) to L_{AA'3}(E40)(R110)(R110)( R110) have the structure | 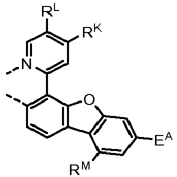 | L_{AA'4}(E^{A})(R*^{K}*)(R*^{L}*)(R*^{M}*), wherein L_{AA'4}(E1)(R71)(R1)(R1) to L_{AA'4}(E40)(R110)(R110)( R110) have the structure | 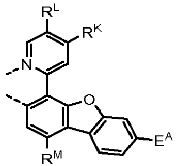 |
| L_{AA'5}(E^{A})(R*^{K}*)(R*^{L}*)(R*^{M}*), wherein L_{AA'5}(E1)(R71)(R1)(R1) to L_{AA'5}(E40)(R110)(R110)( R110) have the structure | 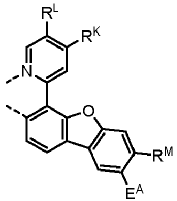 | L_{AA'6}(E^{A})(R*^{K}*)(R*^{L}*)(R*^{M}*), wherein L_{AA'6}(E1)(R71)(R1)(R1) to L_{AA'6}(E40)(R110)(R110)( R110) have the structure | 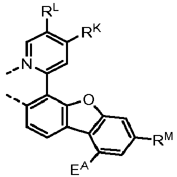 |
| L_{AA'7}(E^{A})(R*^{K}*)(R*^{L}*)(R*^{M}*), wherein L_{AA'7}(E1)(R71)(R1)(R1) to L_{AA'7}(E40)(R110)(R110)( R110) have the structure | 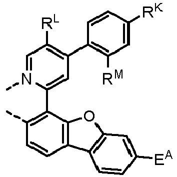 | L_{AA'8}(E^{A})(R*^{K}*)(R*^{L}*)(R*^{M}*), wherein L_{AA'8}(E1)(R71)(R1)(R1) to L_{AA'8}(E40)(R110)(R110)( R110) have the structure | 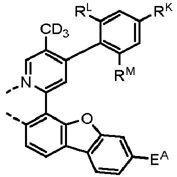 |
| L_{AA'9}(E^{A})(R*^{K}*)(R*^{L}*)(R*^{M}*), wherein L_{AA'953}(E1)(R71)(R1)(R1) to L_{AA'9}(E40)(R110)(R110)( R110) have the structure | 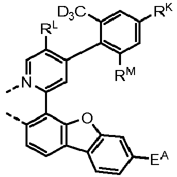 | L_{AA'10}(E^{A})(R*^{K}*)(R*^{L}*)(R*^{M}*), wherein L_{AA'10}(E1)(R71)(R1)(R1) to L_{AA'10}(E40)(R110)(R110) (R110) have the structure | 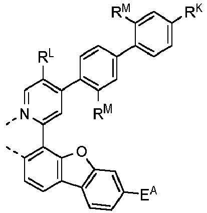 |
| L_{AA'11}(E^{A})(R*^{K}*)(R*^{L}*)(R*^{M}*), wherein L_{AA'1}(E1)(R71)(R1)(R51 ) to L_{AA'11}(E40)(R110)(R110) (R110) have the structure | 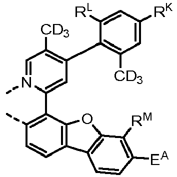 | L_{AA'12}(E^{A})(R*^{K}*)(R*^{L}*)(R*^{M}*), wherein L_{AA'12}(E1)(R71)(R1)(R51 ) to L_{AA'12}(E40)(R110)(R110) (R110) have the structure | 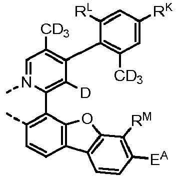 |
| L_{AA'13}(E^{A})(R*^{K}*)(R*^{L}*)(R*^{M}*), wherein L_{AA'13}(E1)(R71)(R1)(R51 ) to L_{AA'13}(E40)(R110)(R110) (R110) have the structure | 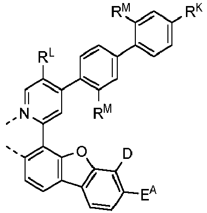 | L_{AA'14}(E^{A})(R*^{K}*)(R*^{L}*)(R*^{M}*), wherein L_{AA'14}(E1)(R71)(R1)(R51 ) to L_{AA'14}(E40)(R110)(R110) (R110) have the structure | 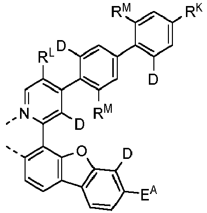 |

wherein R1 to R110 have the structures defined in the following LIST 4&: 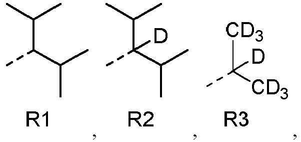 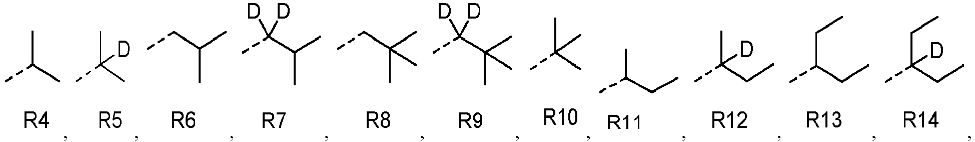 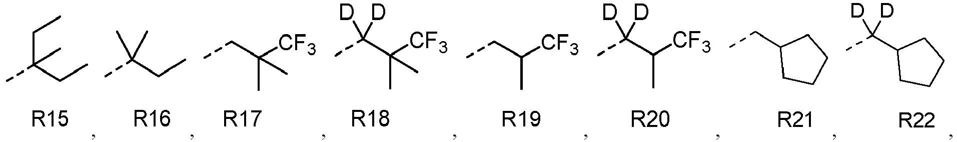 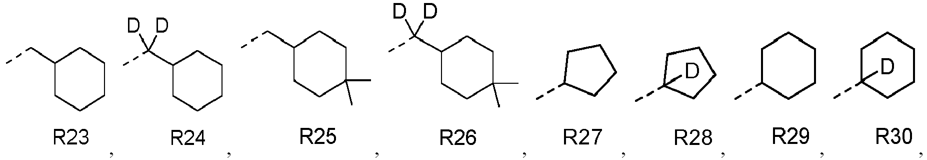 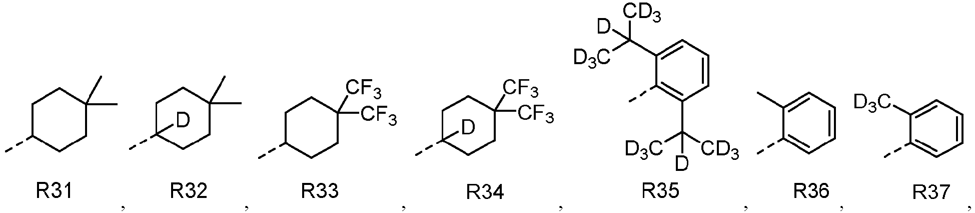 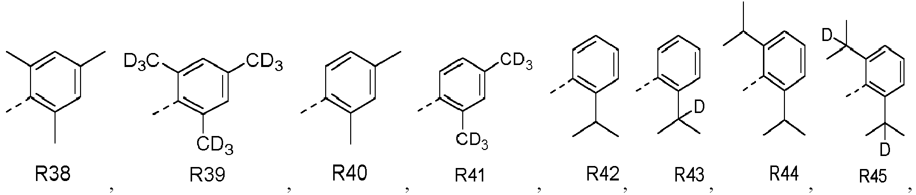 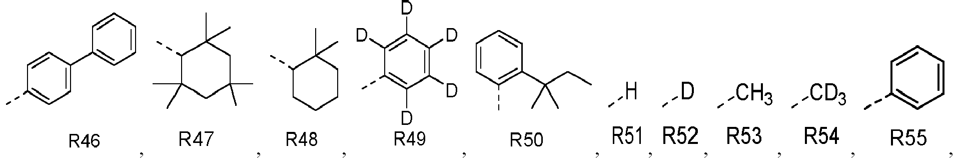 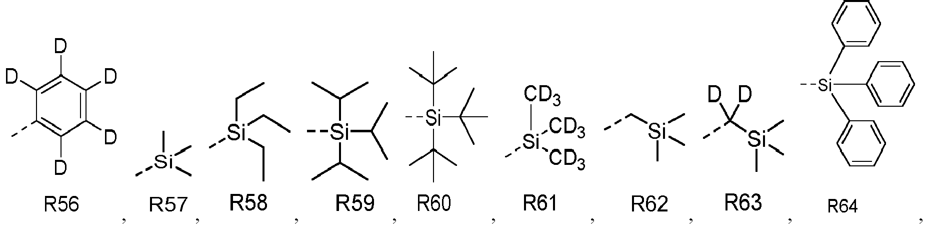 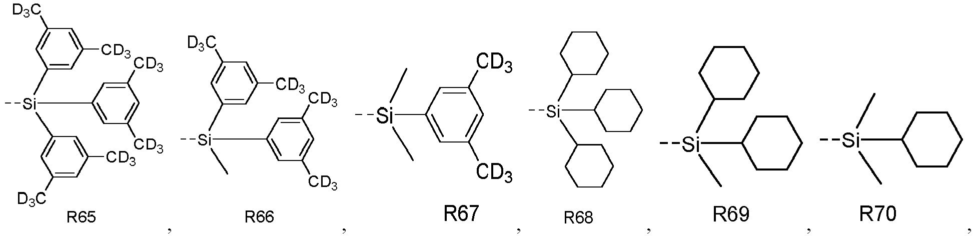 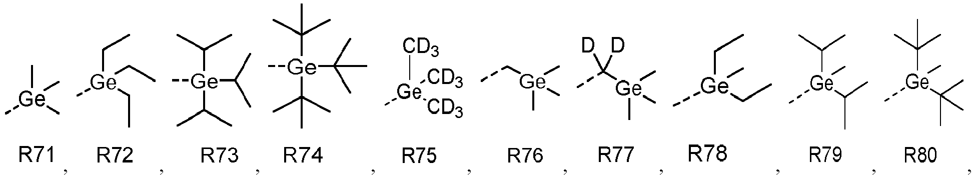 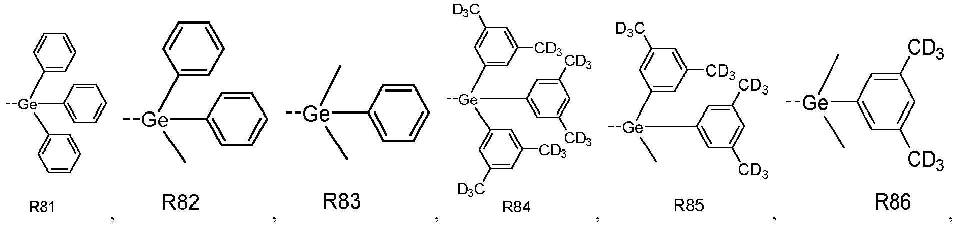 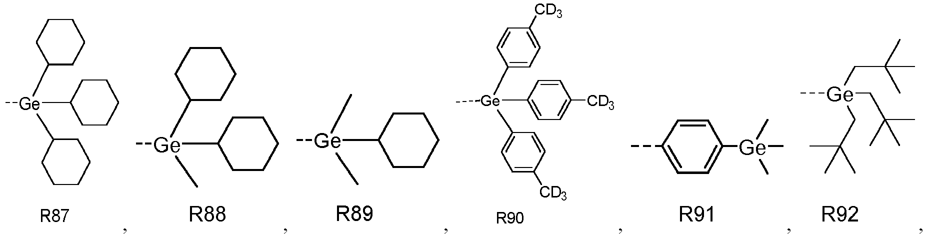 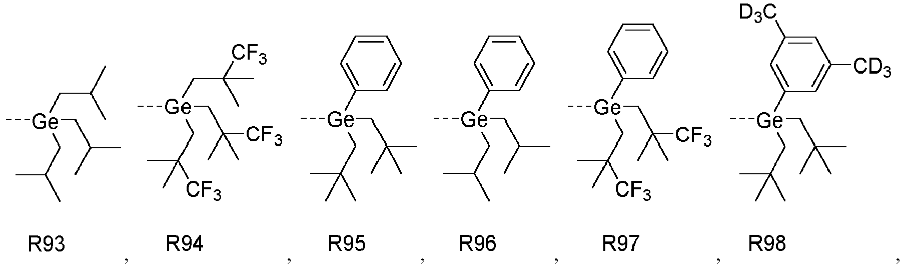 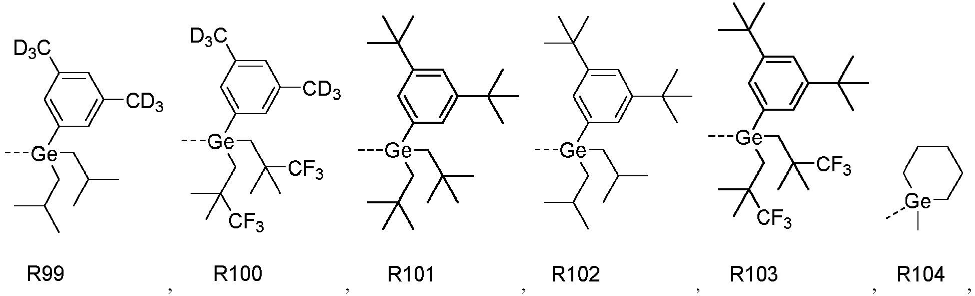 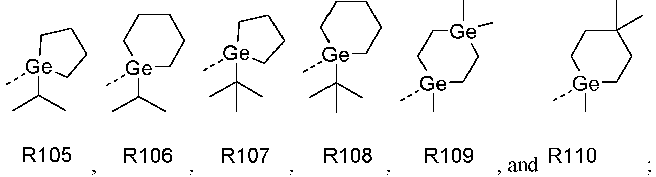 wherein each of E1 to E40 has the structure defined in the following LIST 5&:

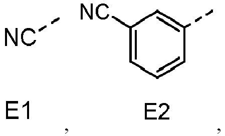

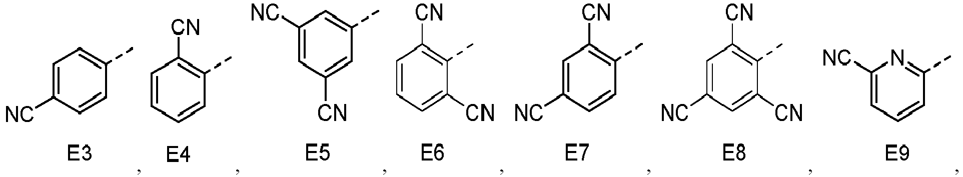

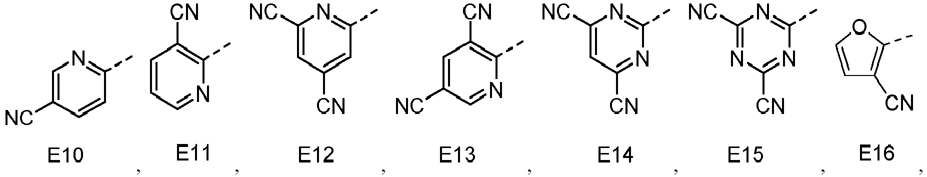

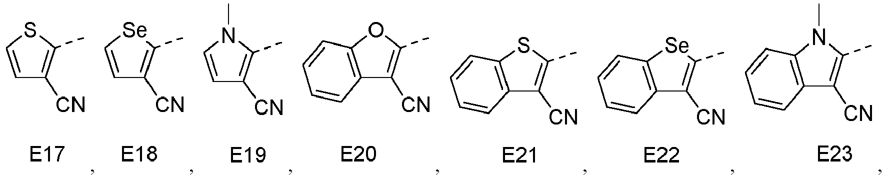

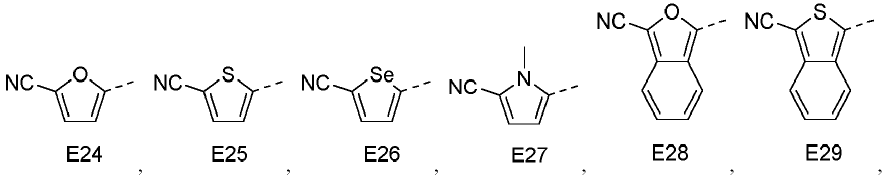

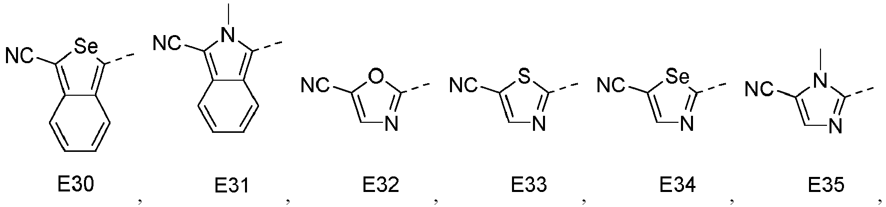

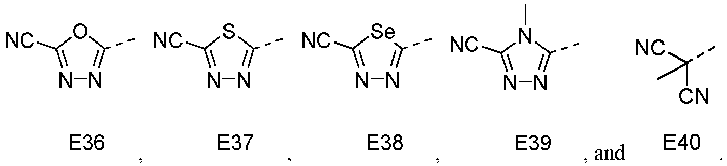

In some embodiments, the compound has a formula selected from the group consisting of Ir(L_{A})₃, Ir(L_{A})(L_{B})₂, Ir(L_{A})₂(L_{B}), Ir(L_{A})₂(L_{C}), and Ir(L_{A})(L_{B})(L_{C}); and wherein L_{A}, L_{B}, and L_{C} are different from each other.

In some embodiments, L_{B} is a substituted or unsubstituted phenylpyridine, and L_{C} is a substituted or unsubstituted acetylacetonate.

In some embodiments, L_{B} and Lc are each independently selected from the group consisting of the structures of the following LIST 6 as defined herein.

In some embodiments, L_{B} and Lc are each independently selected from the group consisting of the structures of the following LIST 8 as defined herein.

In some embodiments, the compound has formula Ir(L_{A})₃, formula Ir(L_{A})(L_{B*k*})₂, formula Ir(L_{A})₂(L_{B*k*}), formula Ir(L_{A})₂(L_{*Cj*-I}), or formula Ir(L_{A})₂(L_{*Cj*-II}),
wherein L_{A} is selected from any L_{A} as described herein, including the structures of L_{Ai}(E^{A})(R*^{K}*)(R*^{L}*)(R*^{M}*), L_{A'm}(E^{A})(R*^{K}*)(R*^{L}*)(R*^{M}*), L_{AAn}(E^{A})(R*^{K}*)(R*^{L}*)(R*^{M}*), and L_{AA'o}(E^{A})(R*^{K}*)(R*^{L}*)(R*^{M}*);
wherein k is an integer from 1 to 520;
wherein j is an integer from 1 to 1416;
with the provisos that:
   when L_{A} is selected from the group consisting of L_{Ai}(E1)(R*^{K}*)(R*^{L}*)(R*^{M}*), k is an integer from 475 to 520; and
   when L_{A} is selected from the group consisting of L_{AAn}(E1)(R*^{K}*)(R*^{L}*)(R*^{M}*), k is an integer from 475 to 490;
   when L_{A} is selected from the group consisting of L_{AA'o}(E1)(R*^{K}*)(R*^{L}*)(R*^{M}*), k is an integer from 1 to 490;
wherein k is an integer from 1 to 520; and each L_{B*k*} has the structure defined in the LIST 9 as defined herein; wherein each L_{*Cj*-I} has a structure based on formula 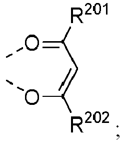 and each L_{*Cj*-II} has a structure based on formula 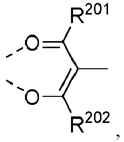 wherein for each L*_{Cj}* in L_{*Cj*-I} and L_{*Cj*-II}, R²⁰¹ and R²⁰² are each independently defined in the following LIST 10 as defined herein.

In some embodiments, the compound is selected from the group consisting of only those compounds whose L_{B*k*} corresponds to one of the following: L_{B1}, L_{B2}, L_{B18}, L_{B28}, L_{B38}, L_{B108}, L_{B118}, L_{B122}, L_{B124}, L_{B126}, L_{B128}, L_{B130}, L_{B132}, L_{B134}, L_{B136}, L_{B138}, L_{B140}, L_{B142}, L_{B144}, L_{B156}, L_{B158}, L_{B160}, L_{B162}, L_{B164}, L_{B168}, L_{B172}, L_{B175}, L_{B204}, L_{B206}, L_{B214}, L_{B216}, L_{B218}, L_{B220}, L_{B222}, L_{B231}, L_{B233}, L_{B235}, L_{B237}, L_{B240}, L_{B242}, L_{B244}, L_{B246}, L_{B248}, L_{B250}, L_{B252}, L_{B254}, L_{B256}, L_{B258}, L_{B260}, L_{B262} and L_{B264}, L_{B265}, L_{B266}, L_{B267}, L_{B268}, L_{B269}, and L_{B270}.

In some embodiments, the compound is selected from the group consisting of only those compounds whose Lat corresponds to one of the following: L_{B1}, L_{B2}, L_{B18}, L_{B28}, L_{B38}, L_{B108}, L_{B118}, L_{B122}, L_{B126}, L_{B128}, L_{B132}, L_{B136}, L_{B138}, L_{B142}, L_{B156}, L_{B162}, L_{B204}, L_{B206}, L_{B214}, L_{B216}, L_{B218}, L_{B220}, L_{B231}, L_{B233}, L_{B 237}, L_{B 264}, L_{B265}, L_{B266}, L_{B267}, L_{B268}, L_{B269}, and L_{B270}.

In some embodiments, the compound is selected from the group consisting of only those compounds having L_{*Cj*-I} or L_{*Cj*-II} ligand whose corresponding R²⁰¹ and R²⁰² are defined to be one of the following structures: R^{D1}, R^{D3}, R^{D4}, R^{D5}, R^{D9}, R^{D10} R^{D17} R^{D18}, R^{D20} R^{D22}, R^{D37} R^{D40}, R^{D41} R^{D42}, R^{D43}, R^{D48}, R^{D49}, R^{D50}, R^{D54}, R^{D55}, R^{D58}, R^{D59}, R^{D78}, R^{D79}, R^{D81}, R^{D87}, R^{D88}, R^{D89}, R^{D93}, R^{D116}, R^{D117}, R^{D118}, R^{D119}, R^{D120}, R^{D133}, R^{D134}, R^{D135}, R^{D136}, R^{D143}, R^{D144}, R^{D145}, R^{D146}, R^{D147}, R^{D149}, R^{D151}, R^{D154}, R^{D155}, R^{D161}, R^{D175} R^{D190}, R^{D193}, R^{D200}, R^{D201}, R^{D206}, R^{D210}, R^{D214}, R^{D215}, R^{D216}, R^{D218}, R^{D219}, R^{D220}, R^{D227}, R^{D237}, R^{D241}, R^{D242}, R^{D245}, and R^{D246}.

In some embodiments, the compound is selected from the group consisting of only those compounds having L_{*Cj*-I} or L_{*Cj*-II} ligand whose corresponding R²⁰¹ and R²⁰² are defined to be one of selected from the following structures: R^{D1}, R^{D3}, R^{D4}, R^{D5}, R^{D9}, R^{D10}, R^{D17}, R^{D22}, R^{D43}, R^{D50}, R^{D78}, R^{D116}, R^{D118}, R^{D133}, R^{D134}, R^{D135}, R^{D136}, R^{D143}, R^{D144}, R^{D145}, R^{D146}, R^{D149}, R^{D151}, R^{D154},R^{D155} R^{D190}, R^{D193}, R^{D200}, R^{D201}, R^{D206}, R^{D210}, R^{D214}, R^{D215}, R^{D216}, R^{D218}, R^{D219}, R^{D220}, R^{D227}, R^{D237}, R^{D241}, R^{D242}, R^{D245}, and R^{D246}.

In some embodiments, the compound is selected from the group consisting of only those compounds having one of the structures of the following L_{*Cj*-I} ligand:

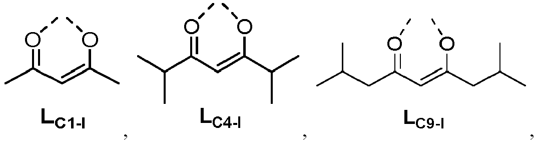

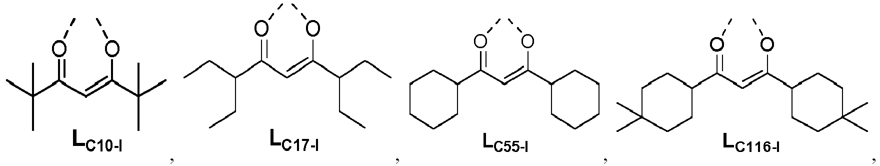

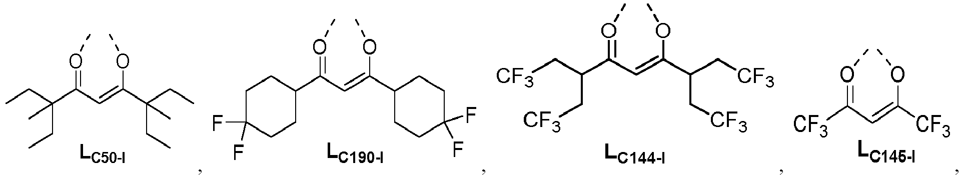

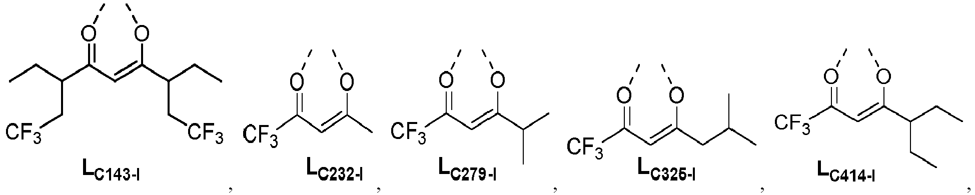

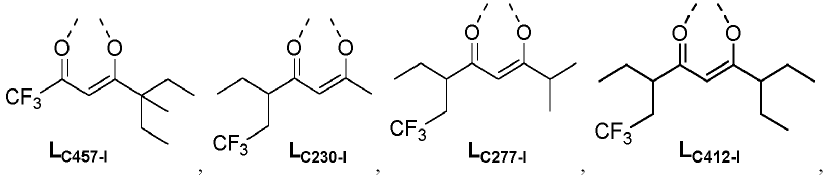

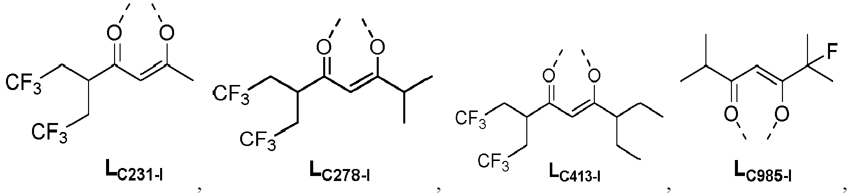

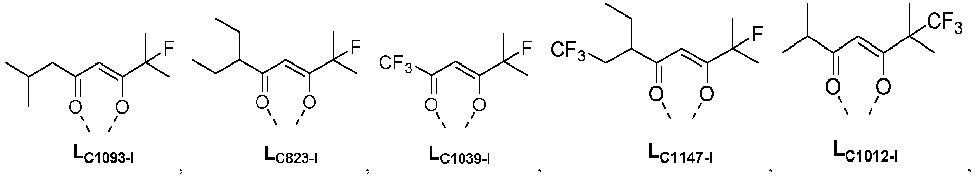

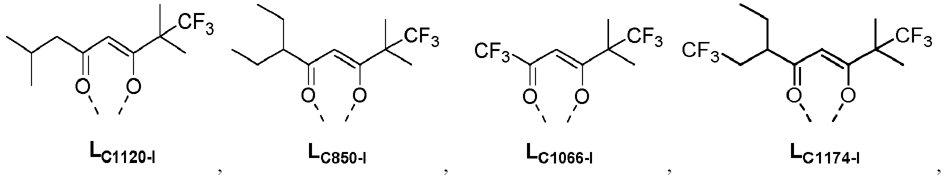

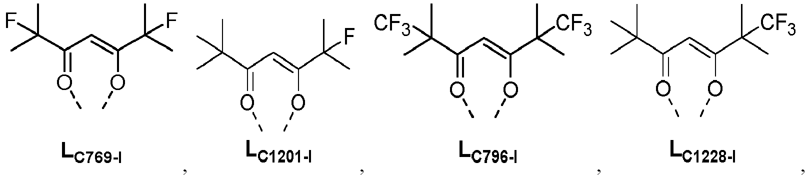

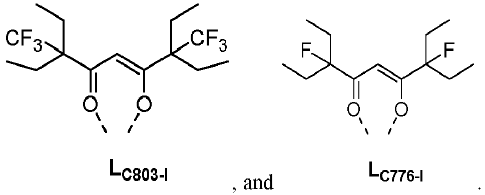

In some embodiments, L_{A} is selected from the group consisting of the structures of LIST 1&, LIST 2&, LIST 3a, LIST 3b, LIST 3c, and LIST 3d, and L_{B} is selected from the group consisting of the structures of LIST 6, LIST 8, and LIST 9. In some embodiments, L_{A} is selected from the group consisting of the structures of LIST 1& and L_{B} is selected from the group consisting of the structures of LIST 9. In some embodiments, L_{A} is selected from the group consisting of the structures of LIST 2& and L_{B} is selected from the group consisting of the structures of LIST 9. In some embodiments, L_{A} is selected from LIST 3a of L_{Ai}(E^{A})(R*^{K}*)(R*^{L}*)(R*^{M}*) consisting of L_{A1}(E^{A})(R*^{K}*)(R*^{L}*)(R*^{M}*) to L_{A44}(E^{A})(R*^{K}*)(R*^{L}*)(R*^{M}*) defined herein wherein i is an integer from 1 to 44, and L_{B} is selected from the group consisting of the structures of LIST 9 of L_{Bk} wherein k is an integer from 1 to 520. In some embodiments, L_{A} is selected from LIST 3b of L_{A'm}(E^{A})(R*^{K}*)(R*^{L}*)(R*^{M}*) consisting of L_{A'1}(E^{A})(R*^{K}*)(R*^{L}*)(R*^{M}*) to L_{A'44}(E^{A})(R*^{K}*)(R*^{L}*)(R*^{M}*) defined herein wherein m is an integer from 1 to 44, and L_{B} is selected from the group consisting of the structures of LIST 9 of L_{Bk} wherein k is an integer from 1 to 520. In some embodiments, L_{A} is selected from LIST 3c of L_{AAn}(E^{A})(R*^{K}*)(R*^{L}*)(R*^{M}*) consisting of L_{AA1}(E^{A})(R*^{K}*)(R*^{L}*)(R*^{M}*) to L_{AA10}(E^{A})(R*^{K}*)(R*^{L}*)(R*^{M}*) defined herein wherein n is an integer from 1 to 10, and L_{B} is selected from the group consisting of the structures of LIST 9 of L_{Bk} wherein k is an integer from 1 to 520. In some embodiments, L_{A} is selected from LIST 3d of L_{AA'o}(E^{A})(R*^{K}*)(R*^{L}*)(R*^{M}*) consisting of L_{AA'1}(E^{A})(R*^{K}*)(R*^{L}*)(R*^{M}*) to L_{AA'10}(E^{A})(R*^{K}*)(R*^{L}*)(R*^{M}*) defined herein wherein o is an integer from 1 to 10, and L_{B} is selected from the group consisting of the structures of LIST 9 of L_{Bk} wherein k is an integer from 1 to 520.

In some embodiments, the compound can be Ir(L_{A})₂(L_{B}), Ir(L_{A})(L_{B})₂, or Ir(L_{A})(L_{B})(L_{C}). In some of these embodiments, L_{A} can have a Formula I as defined herein. In some of these embodiments, L_{A} can be selected from the group consisting of the structures of LIST 1&, LIST 2&, LIST 3a, LIST 3b, LIST 3c, and LIST 3d as defined herein. In some of these embodiments, L_{B} can be selected from the group consisting of the structures of LIST 6, LIST 8, and LIST 9 as defined herein. In some of these embodiments, Lc can be selected from the group consisting of the structures of L_{CJ-I}, and L_{CJ-II} as defined herein. In some of these embodiments, the compound can be Ir(L_{Ai}(E^{A})(R*^{K}*)(R*^{L}*)(R*^{M}*))₂(L_{B}), Ir(L_{A'm}(E^{A})(R*^{K}*)(R*^{L}*)(R*^{M}*))₂(L_{B}), Ir(L_{AAn}(E^{A})(R*^{K}*)(R*^{L}*)(R*^{M}*))₂(L_{B}), Ir(L_{AA'o}(E^{A})(R*^{K}*)(R*^{L}*)(R*^{M}*))₂(L_{B}), Ir(L_{Ai}(E^{A})(R*^{K}*)(R*^{L}*)(R*^{M}*))(L_{B})₂, Ir(L_{A'm}(E^{A})(R*^{K}*)(R*^{L}*)(R*^{M}*))(L_{B})₂, Ir(L_{AAn}(E^{A})(R*^{K}*)(R*^{L}*)(R*^{M}*))(L_{B})₂, Ir(L_{AA'o}(E^{A})(R*^{K}*)(R*^{L}*)(R*^{M}*))(L_{B})₂, Ir(L_{A})₂(L_{Bk}), Ir(L_{A})(L_{Bk})₂, Ir(L_{Ai}(E^{A})(R*^{K}*)(R*^{L}*)(R*^{M}*))₂(L_{Bk}), Ir(L_{A'm}(E^{A})(R*^{K}*)(R*^{L}*)(R*^{M}*))₂(L_{Bk}), Ir(L_{AAn}(E^{A})(R*^{K}*)(R*^{L}*)(R*^{M}*))₂(L_{Bk}), Ir(L_{AA'o}(E^{A})(R*^{K}*)(R*^{L}*)(R*^{M}*))₂(L_{Bk}), Ir(L_{Ai}(E^{A})(R*^{K}*)(R*^{L}*)(R*^{M}*))(L_{Bk})₂, Ir(L_{A'm}(E^{A})(R*^{K}*)(R*^{L}*)(R*^{M}*))(L_{Bk})₂, Ir(L_{AAn}(E^{A})(R*^{K}*)(R*^{L}*)(R*^{M}*))(L_{Bk})₂, Ir(L_{AA'o}(E^{A})(R*^{K}*)(R*^{L}*)(R*^{M}*))(L_{Bk})₂. Ir(L_{A1}(E^{A})(R*^{K}*)(R*^{L}*)(R*^{M}*))(L_{Bk})(L_{CJ-I}), Ir(L_{A'm}(E^{A})(R*^{K}*)(R*^{L}*)(R*^{M}*))(L_{Bk})(L_{CJ-I}), Ir(L_{AAn}(E^{A})(R*^{K}*)(R*^{L}*)(R*^{M}*))(L_{Bk})(L_{CJ-I}), Ir(L_{AA'o}(E^{A})(R*^{K}*)(R*^{L}*)(R*^{M}*))(L_{Bk})(L_{CJ-I}), Ir(L_{Ai}(E^{A})(R*^{K}*)(R*^{L}*)(R*^{M}*))(L_{Bk})(L_{CJ-II}), Ir(L_{A'm}(E^{A})(R*^{K}*)(R*^{L}*)(R*^{M}*))(L_{Bk})(L_{CK-II}), Ir(L_{AAn}(E^{A})(R*^{K}*)(R*^{L}*)(R*^{M}*))(L_{Bk})(L_{CJ-II}), or Ir(L_{AA'o}(E^{A})(R*^{K}*)(R*^{L}*)(R*^{M}*))(L_{Bk})(L_{CJ-II}).

It should be understood that in some embodiments for L_{Ai}(E^{A})(R*^{K}*)(R*^{L}*)(R*^{M}*) to combine with L_{Bk}, k may be from 475 to 520. In some embodiments for L_{AAn}(E^{A})(R*^{K}*)(R*^{L}*)(R*^{M}*) to combine with L_{Bk}, k may be from 475 to 490, when E^{A} is CN. In some embodiments for L_{AA'o}(E*^{A}*)(R*^{K}*)(R*^{L}*)(R*^{M}*) to combine with L_{Bk}, k may be from 1 to 490 when E^{A} is CN.

In some embodiments, the compound is selected from the group consisting of the structures of the following LIST 12&: 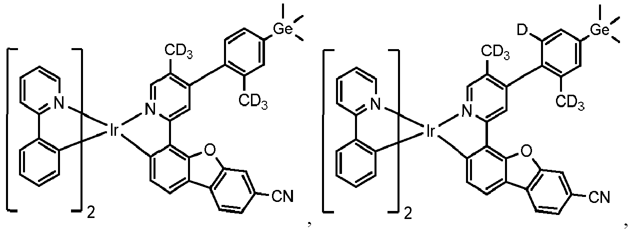 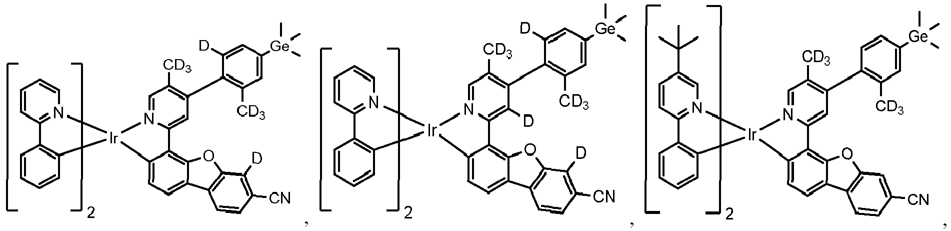 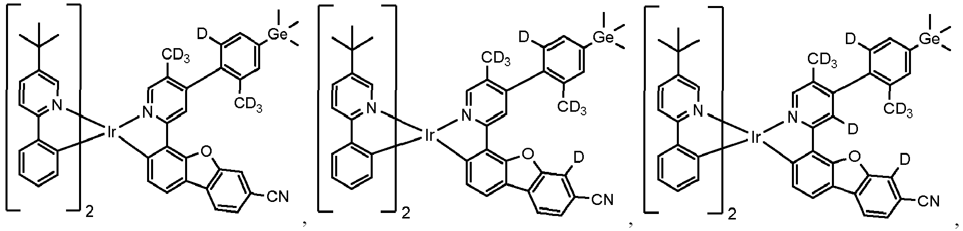 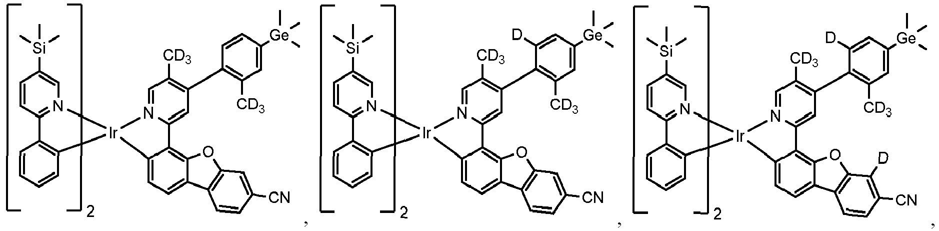 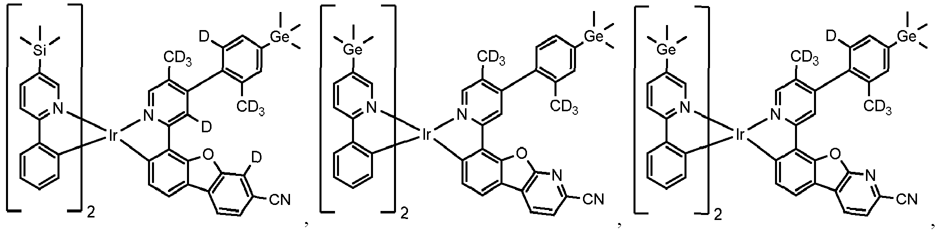 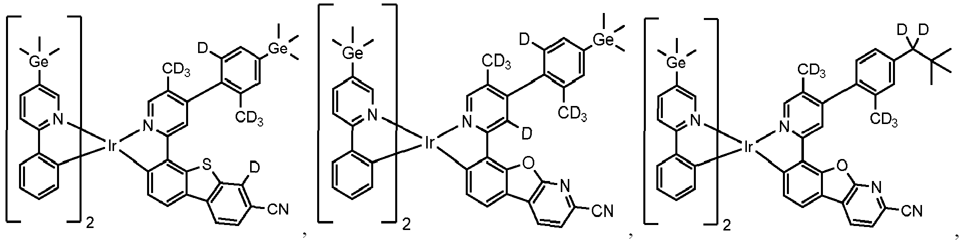 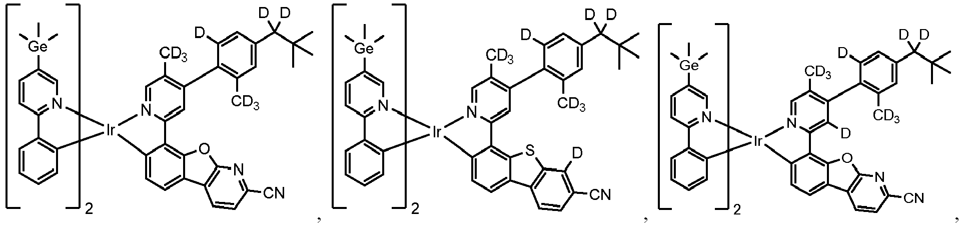 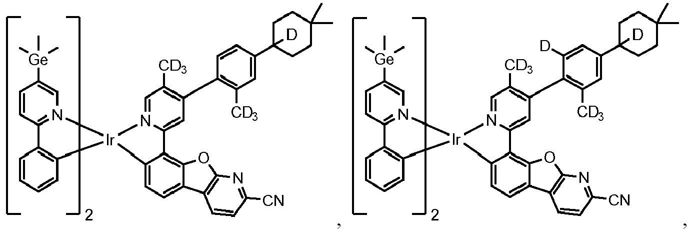 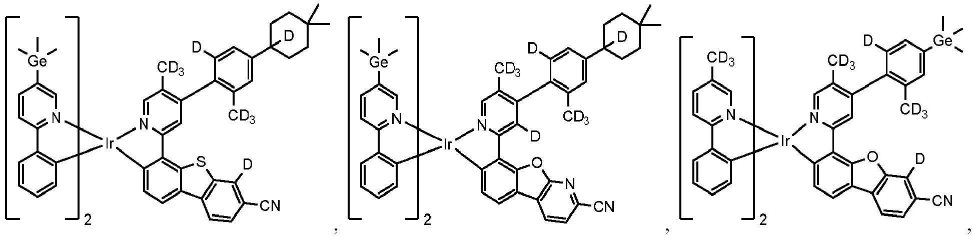 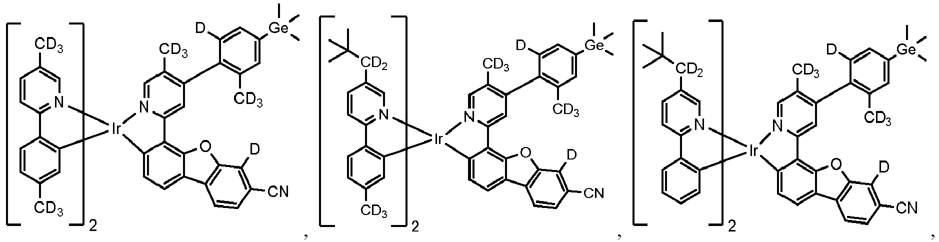 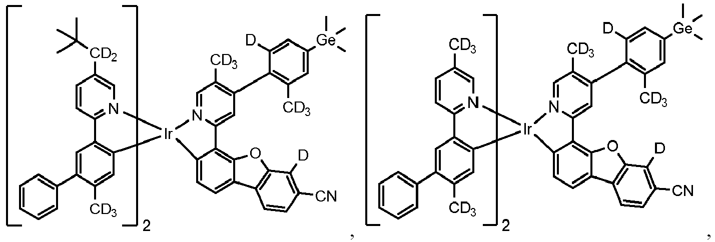 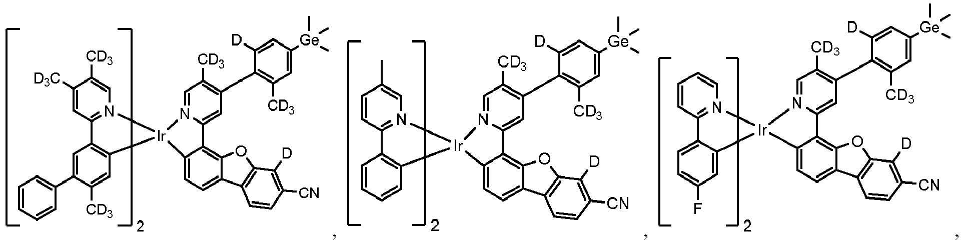 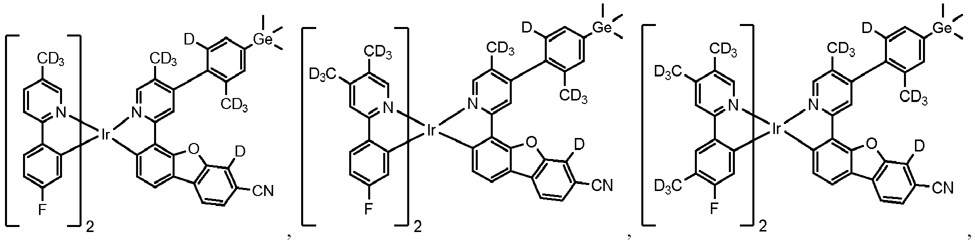 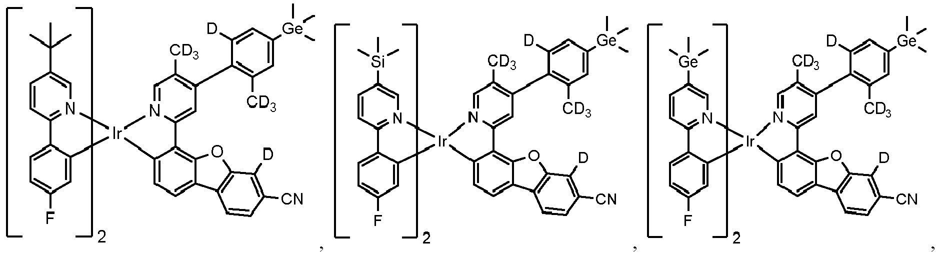 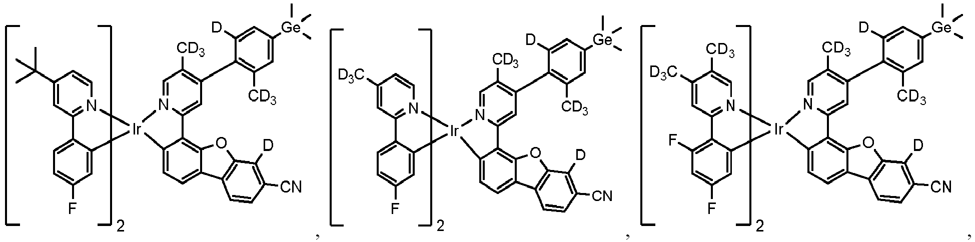 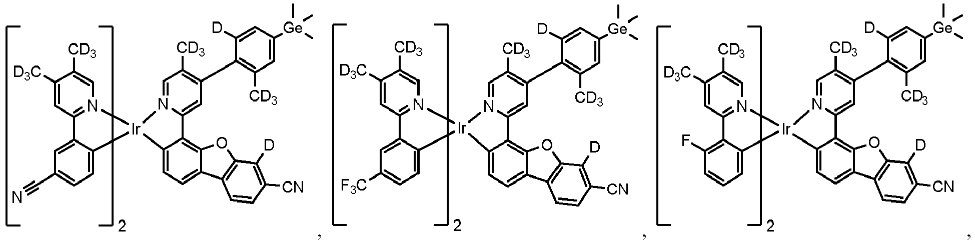 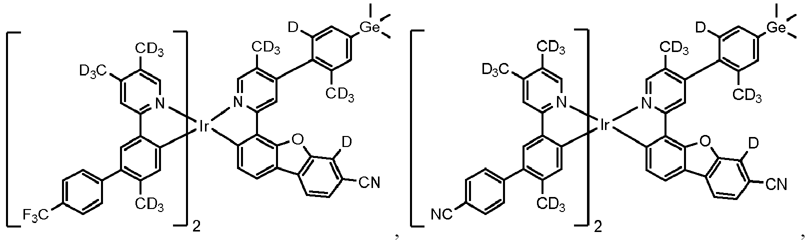 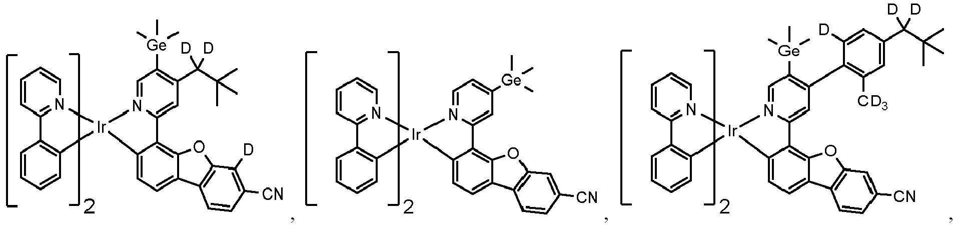 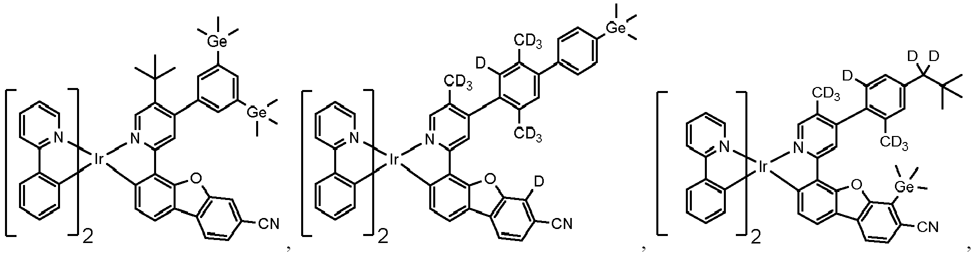 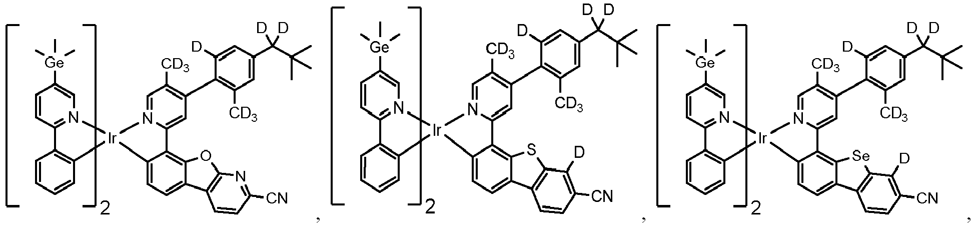 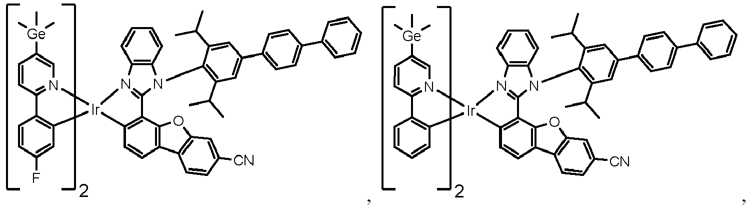 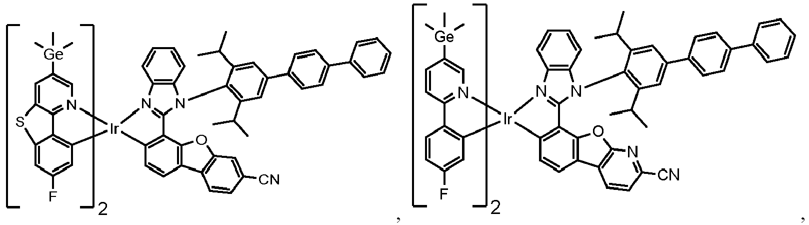 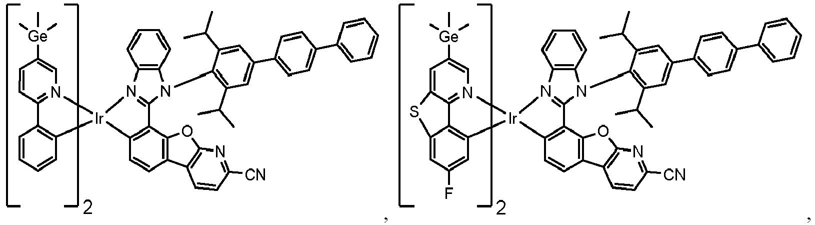 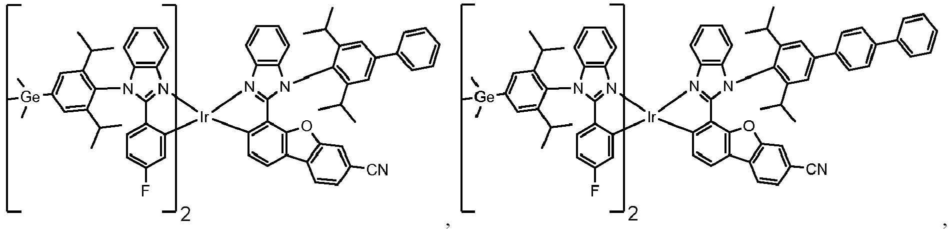 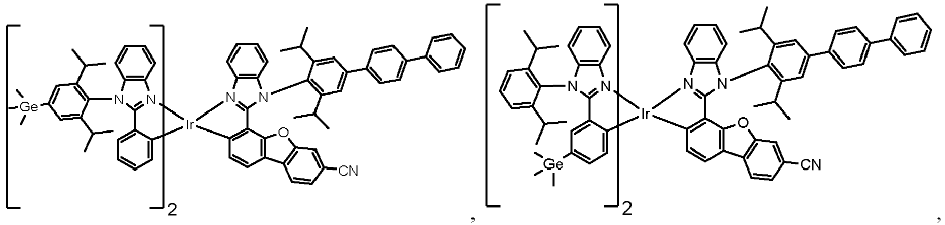 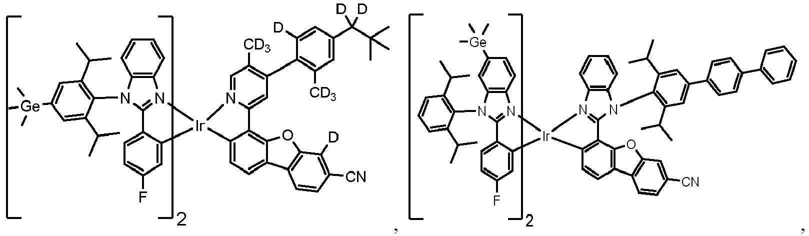 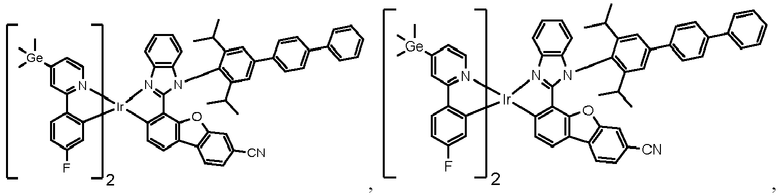 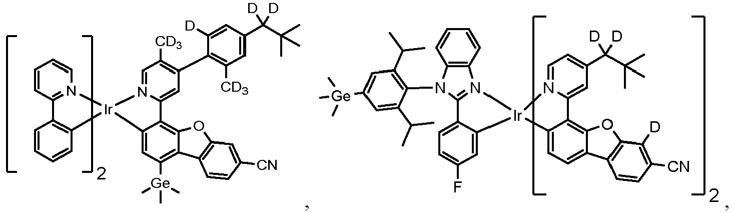 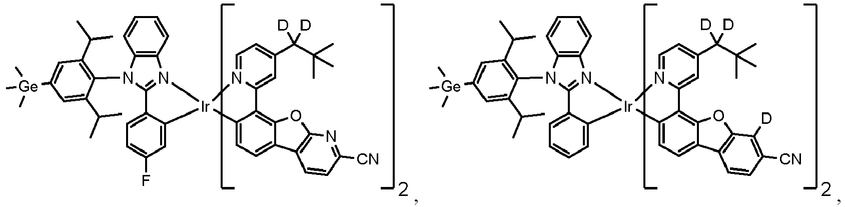 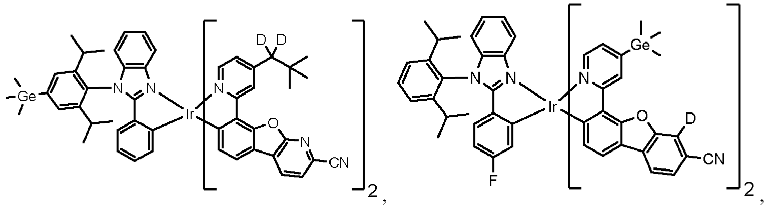 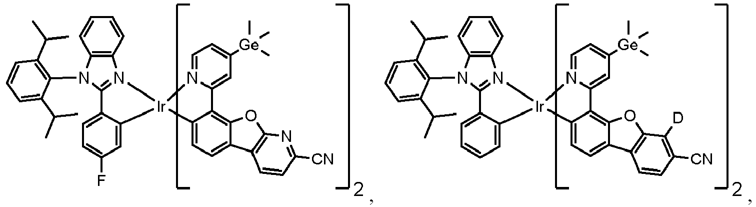 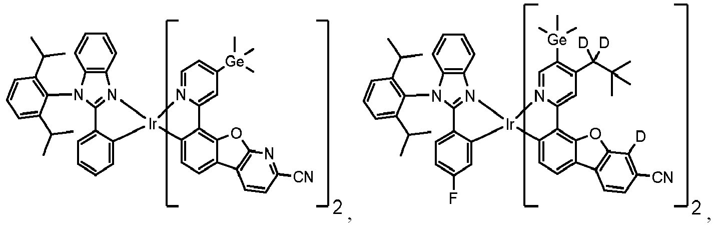 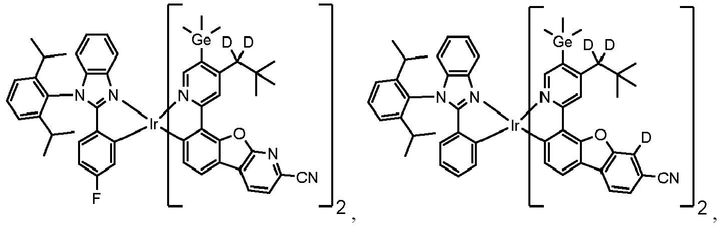 and

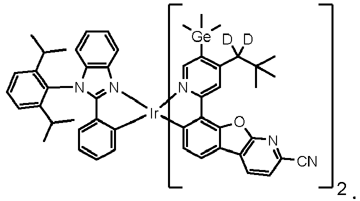

It should be understood that two substituents of the same molecule as described throughout the present dsiclsoure may be joined or fused to form a ring as long as it's chemically feasible.

### C. The OLEDs and the Devices of the Present Disclosure

In another aspect, the present disclosure also provides an OLED device comprising a first organic layer that contains a compound as disclosed in the above compounds section of the present disclosure.

In some embodiments, the OLED comprises: an anode; a cathode; and an organic layer disposed between the anode and the cathode, where the organic layer comprises a compound having a first ligand L_{A} of Formula I or a compound of Formula III as described herein.

In some embodiments, the organic layer may be an emissive layer and the compound as described herein may be an emissive dopant or a non-emissive dopant.

In some embodiments, the organic layer may further comprise a host, wherein the host comprises a triphenylene containing benzo-fused thiophene or benzo-fused furan, wherein any substituent in the host is an unfused substituent independently selected from the group consisting of CₙH₂ₙ₊₁, OCₙH₂ₙ₊₁, OAr₁, N(CₙH₂ₙ₊₁)₂, N(Ar₁)(Ar₂), CH=CH-CₙH₂ₙ₊₁, C=CCₙH₂ₙ₊₁, Ar₁, Ar₁-Ar₂, CₙH₂ₙ-Ar₁, or no substitution, wherein n is an integer from 1 to 10; and wherein Ar₁ and Ar₂ are independently selected from the group consisting of benzene, biphenyl, naphthalene, triphenylene, carbazole, and heteroaromatic analogs thereof.

In some embodiments, the organic layer may further comprise a host, wherein the host comprises at least one chemical group selected from the group consisting of triphenylene, carbazole, indolocarbazole, dibenzothiophene, dibenzofuran, dibenzoselenophene, 5λ2-benzo[d]benzo[4,5]imidazo[3,2-a]imidazole, 5,9-dioxa-13b-boranaphtho[3,2,1-de]anthracene, triazine, boryl, silyl, aza-triphenylene, aza-carbazole, aza-indolocarbazole, aza-dibenzothiophene, aza-dibenzofuran, aza-dibenzoselenophene, aza-5λ2-benzo[d]benzo[4,5]imidazo[3,2-a]imidazole, and aza-(5,9-dioxa-13b-boranaphtho[3,2,1-de]anthracene).

In some embodiments, the host may be selected from the HOST Group 1 consisting of: 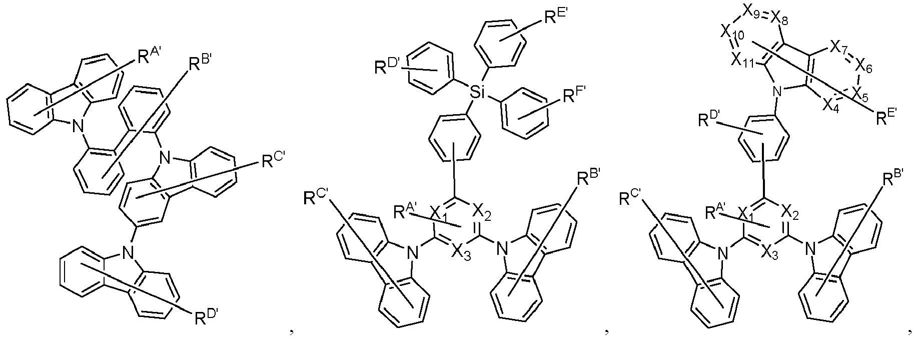 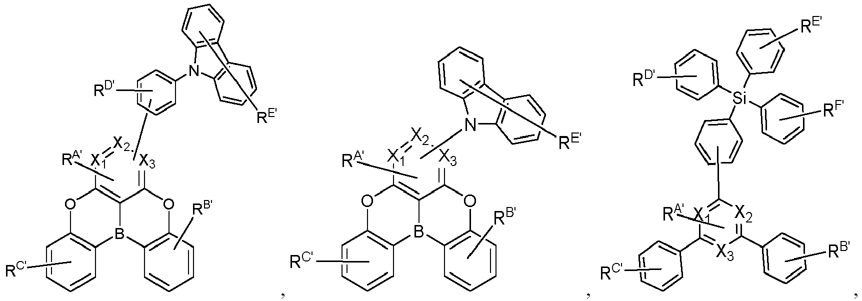 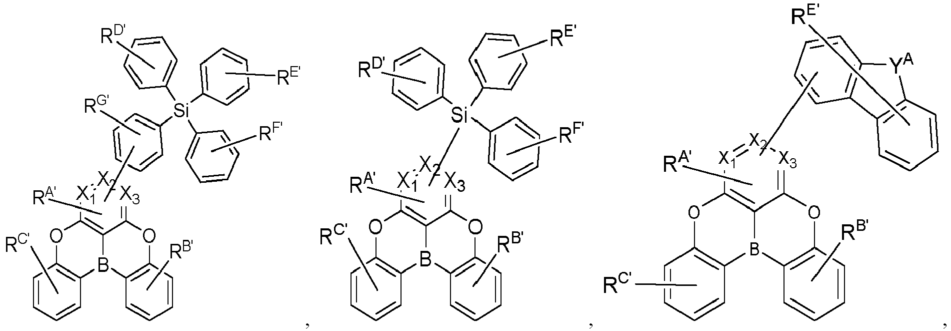 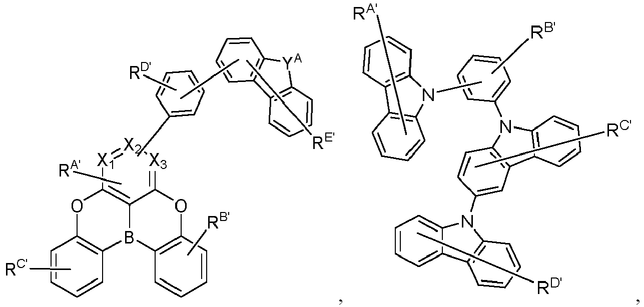 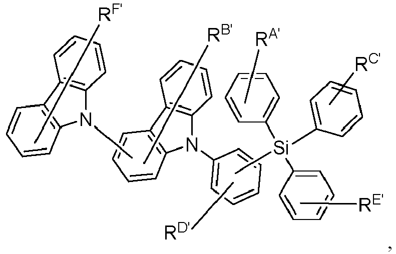 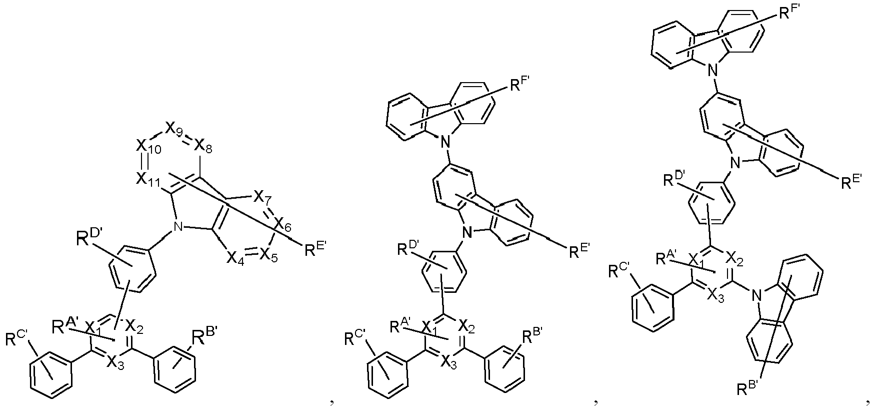 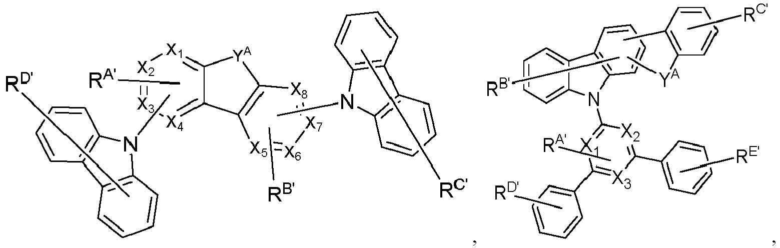 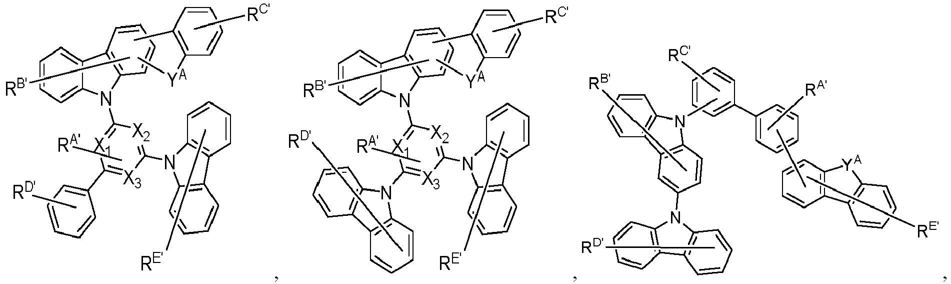 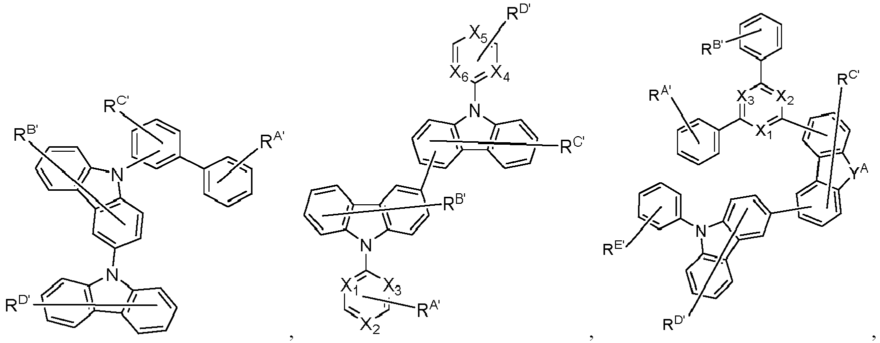 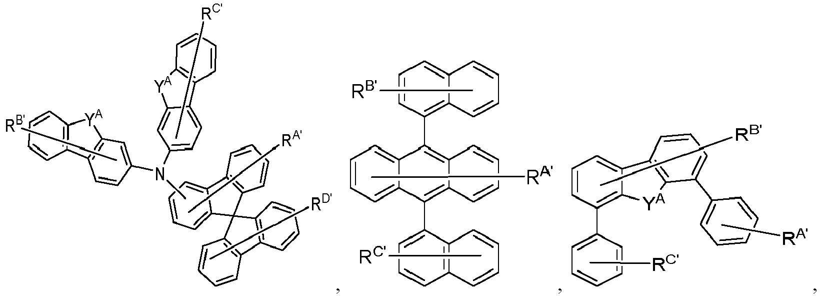 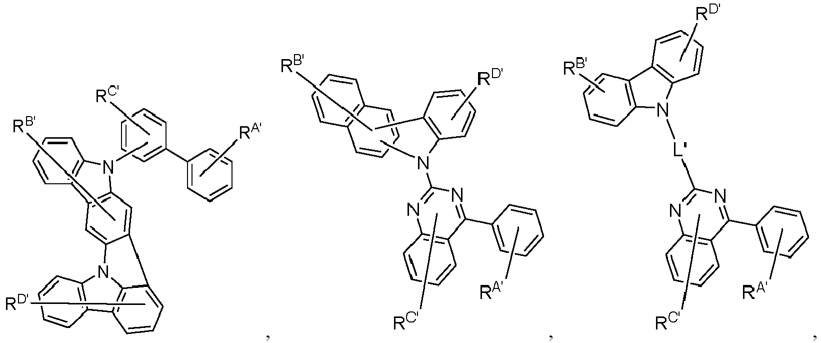 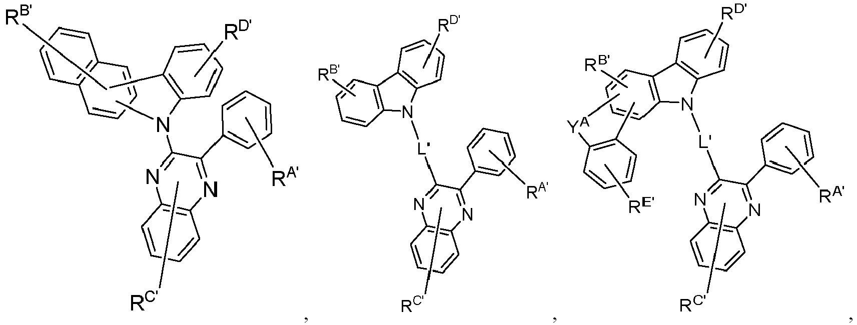 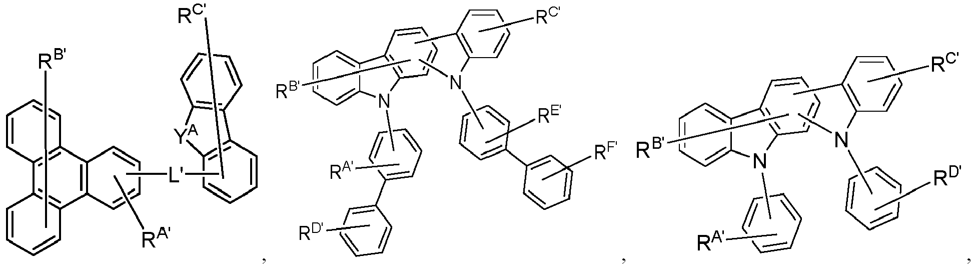 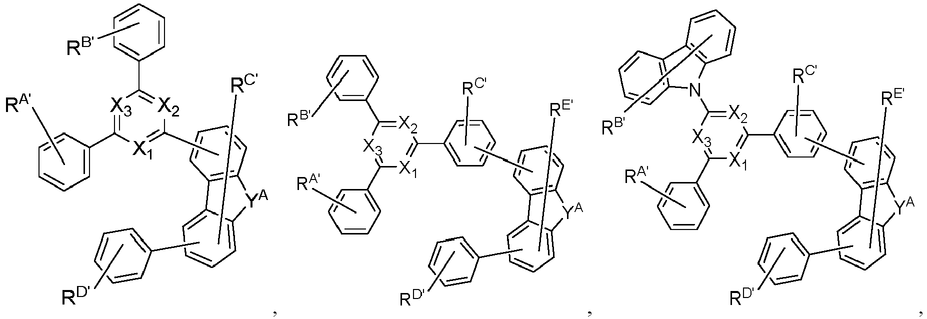 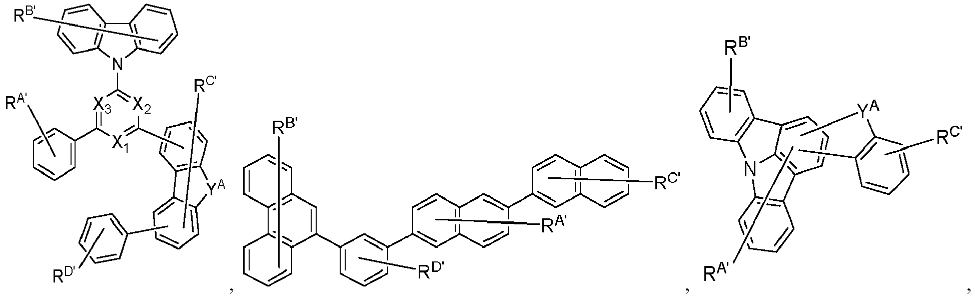 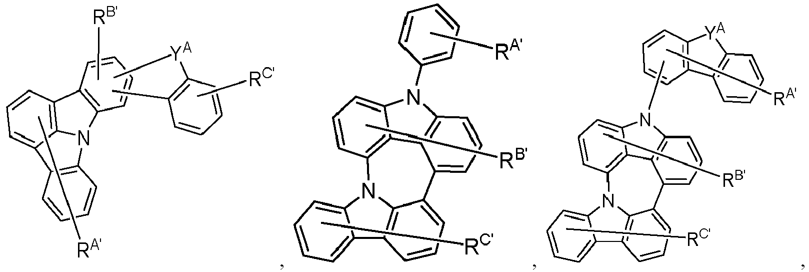 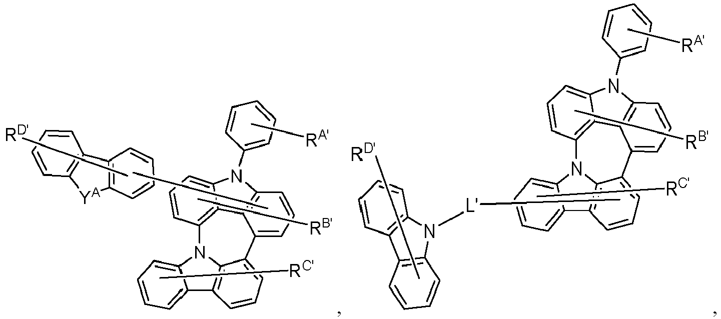 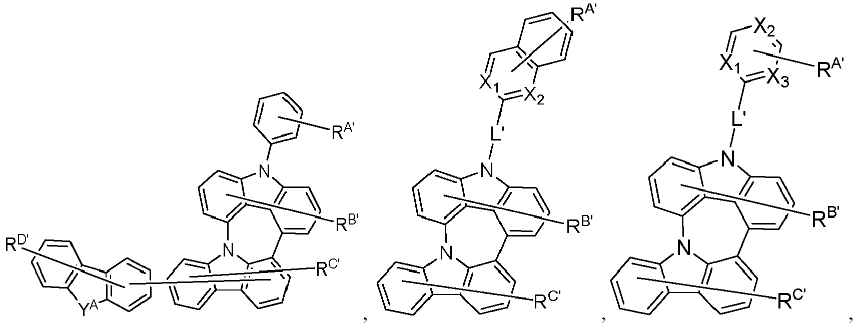 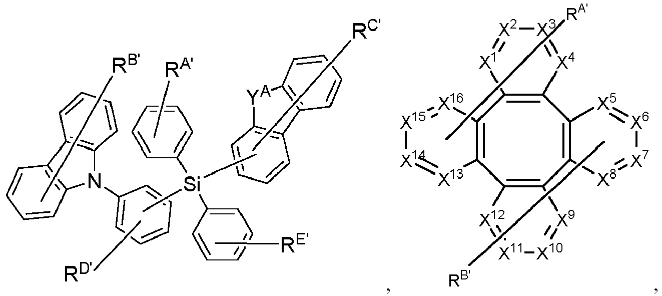 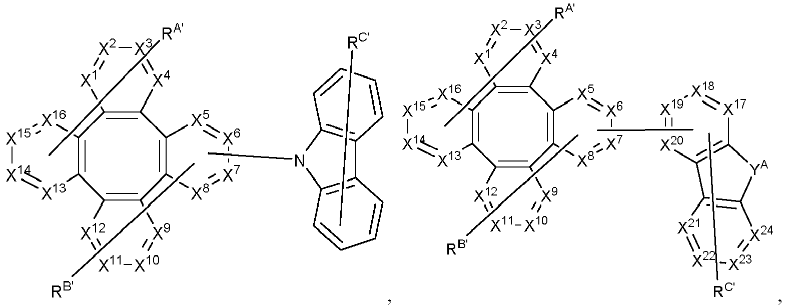 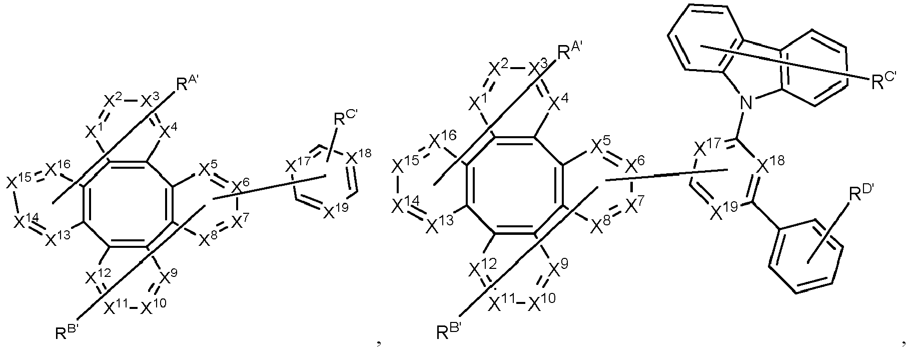 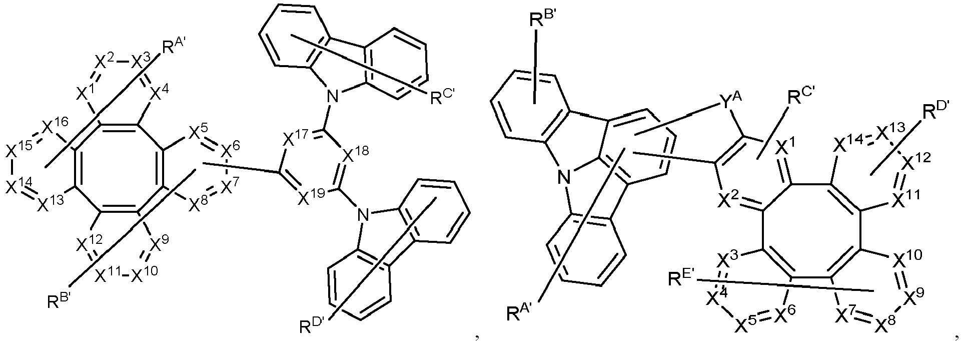 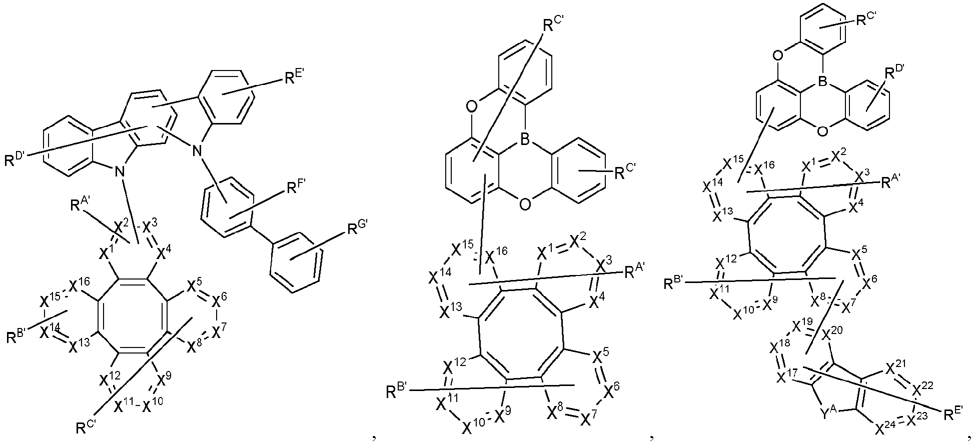 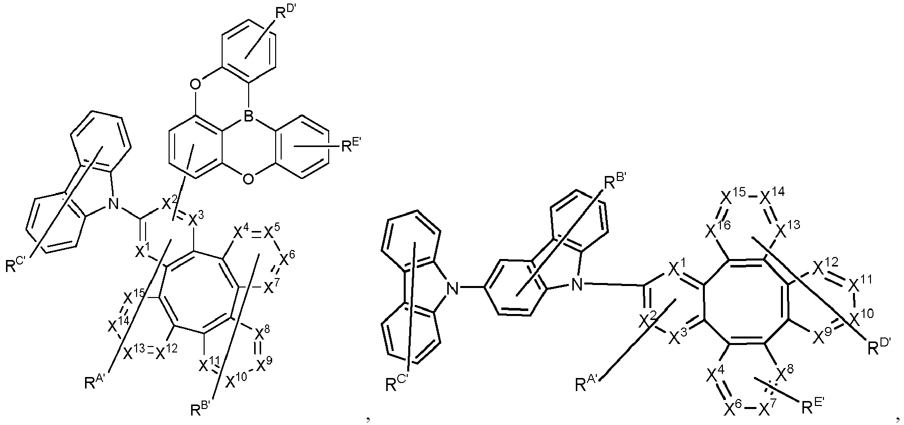 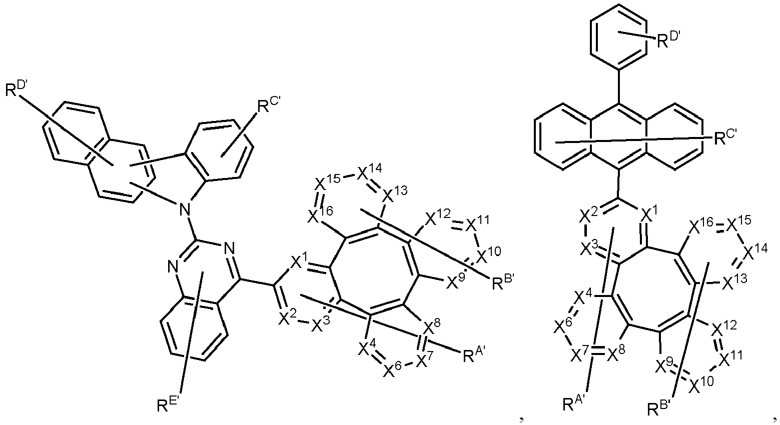 and 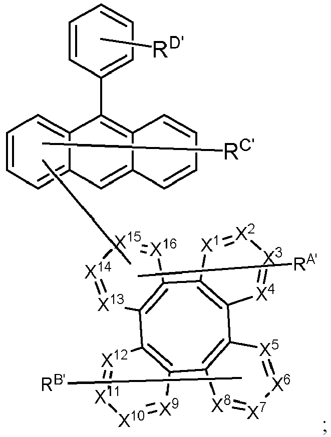 wherein:
each of X¹ to X²⁴ is independently C or N;
L' is a direct bond or an organic linker;
each Y^{A} is independently selected from the group consisting of absent a bond, O, S, Se, CRR', SiRR', GeRR', NR, BR, BRR';
each of R^{A'}, R^{B'}, R^{C'}, R^{D'}, R^{E'}, R^{F'}, and R^{G'} independently represents mono, up to the maximum substitutions, or no substitutions;
each R, R', R^{A'}, R^{B'}, R^{C'}, R^{D'}, R^{E'}, R^{F'}, and R^{G'} is independently a hydrogen or a substituent selected from the group consisting of deuterium, halogen, alkyl, cycloalkyl, heteroalkyl, heterocycloalkyl, arylalkyl, alkoxy, aryloxy, amino, silyl, germyl, selenyl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, boryl, and combinations thereof;
two adjacent of R^{A'}, R^{B'}, R^{C'}, R^{D'}, R^{E'}, R^{F'}, and R^{G'} are optionally joined or fused to form a ring.

In some embodiments, the host may be selected from the HOST Group 2 consisting of: 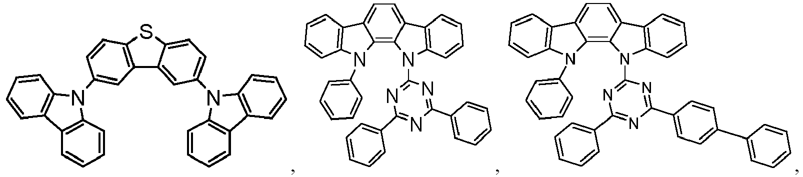 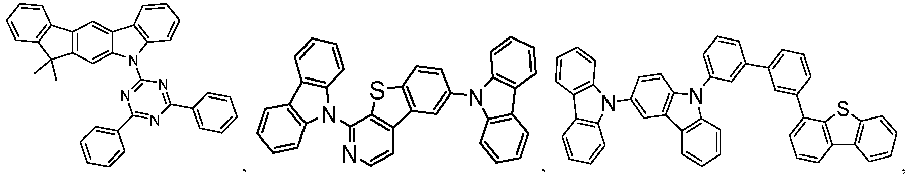 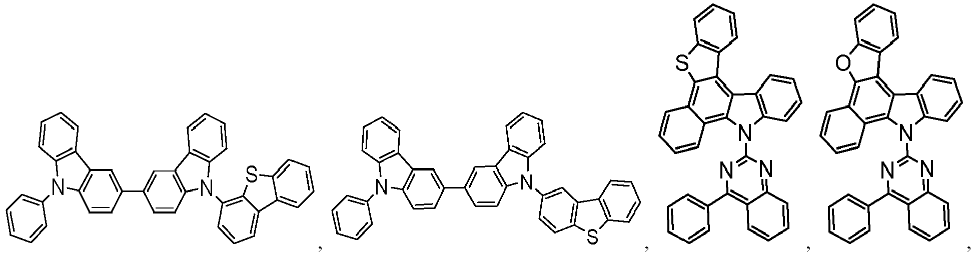 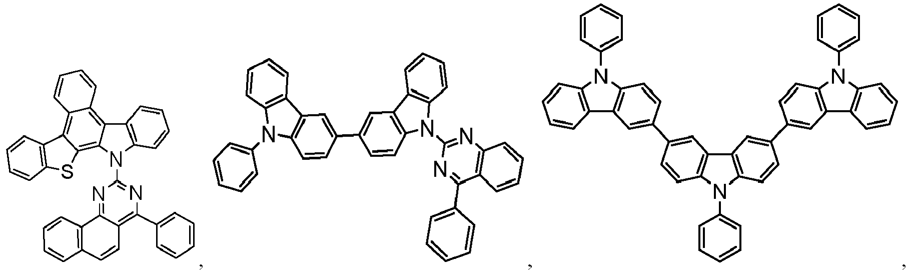 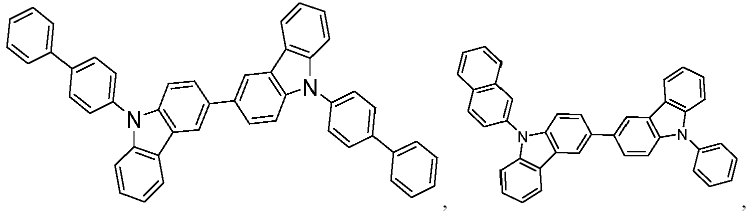 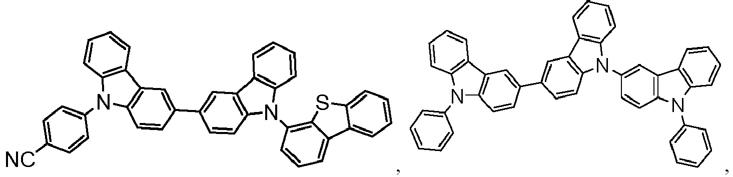 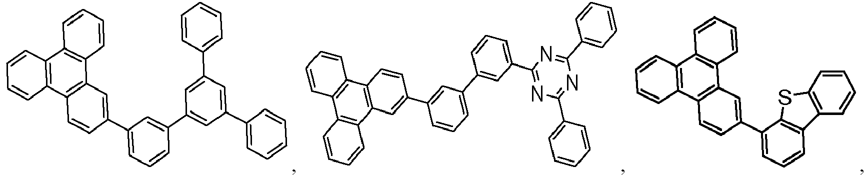 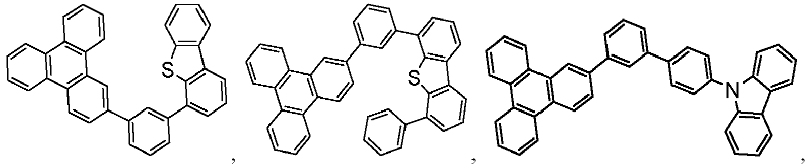 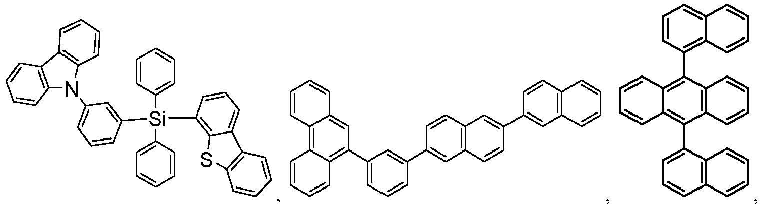 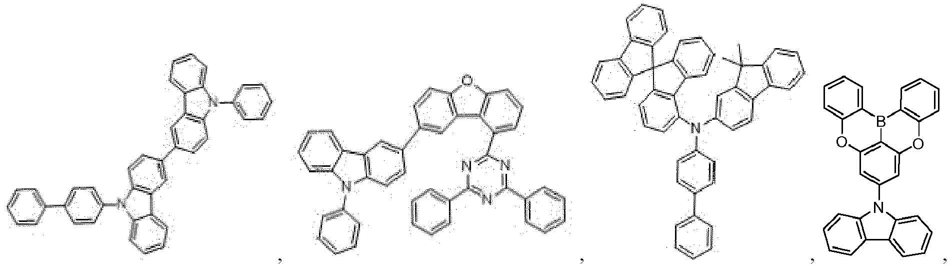 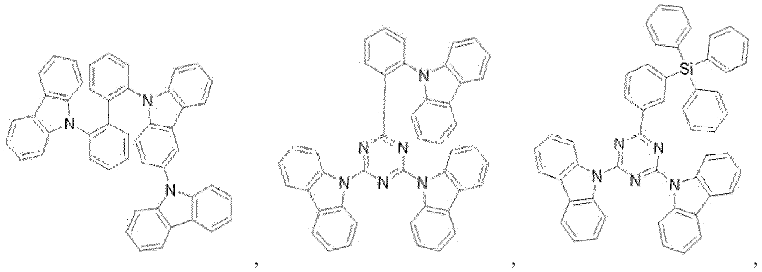 and combinations thereof.

In some embodiments, the organic layer may further comprise a host, wherein the host comprises a metal complex.

In some embodiments, the emissive layer can comprise two hosts, a first host and a second host. In some embodiments, the first host is a hole transporting host, and the second host is an electron transporting host. In some embodiments, the first host and the second host can form an exciplex.

In some embodiments, the compound as described herein may be a sensitizer; wherein the device may further comprise an acceptor; and wherein the acceptor may be selected from the group consisting of fluorescent emitter, delayed fluorescence emitter, and combination thereof.

In yet another aspect, the OLED of the present disclosure may also comprise an emissive region containing a compound as disclosed in the above compounds section of the present disclosure.

In some embodiments, the emissive region can comprise a compound of a compound having a first ligand L_{A} of Formula I or a compound of Formula III as described herein.

In some embodiments, at least one of the anode, the cathode, or a new layer disposed over the organic emissive layer functions as an enhancement layer. The enhancement layer comprises a plasmonic material exhibiting surface plasmon resonance that non-radiatively couples to the emitter material and transfers excited state energy from the emitter material to non-radiative mode of surface plasmon polariton. The enhancement layer is provided no more than a threshold distance away from the organic emissive layer, wherein the emitter material has a total non-radiative decay rate constant and a total radiative decay rate constant due to the presence of the enhancement layer and the threshold distance is where the total non-radiative decay rate constant is equal to the total radiative decay rate constant. In some embodiments, the OLED further comprises an outcoupling layer. In some embodiments, the outcoupling layer is disposed over the enhancement layer on the opposite side of the organic emissive layer. In some embodiments, the outcoupling layer is disposed on opposite side of the emissive layer from the enhancement layer but still outcouples energy from the surface plasmon mode of the enhancement layer. The outcoupling layer scatters the energy from the surface plasmon polaritons. In some embodiments this energy is scattered as photons to free space. In other embodiments, the energy is scattered from the surface plasmon mode into other modes of the device such as but not limited to the organic waveguide mode, the substrate mode, or another waveguiding mode. If energy is scattered to the non-free space mode of the OLED other outcoupling schemes could be incorporated to extract that energy to free space. In some embodiments, one or more intervening layer can be disposed between the enhancement layer and the outcoupling layer. The examples for interventing layer(s) can be dielectric materials, including organic, inorganic, perovskites, oxides, and may include stacks and/or mixtures of these materials.

The enhancement layer modifies the effective properties of the medium in which the emitter material resides resulting in any or all of the following: a decreased rate of emission, a modification of emission line-shape, a change in emission intensity with angle, a change in the stability of the emitter material, a change in the efficiency of the OLED, and reduced efficiency roll-off of the OLED device. Placement of the enhancement layer on the cathode side, anode side, or on both sides results in OLED devices which take advantage of any of the above-mentioned effects. In addition to the specific functional layers mentioned herein and illustrated in the various OLED examples shown in the figures, the OLEDs according to the present disclosure may include any of the other functional layers often found in OLEDs.

The enhancement layer can be comprised of plasmonic materials, optically active metamaterials, or hyperbolic metamaterials. As used herein, a plasmonic material is a material in which the real part of the dielectric constant crosses zero in the visible or ultraviolet region of the electromagnetic spectrum. In some embodiments, the plasmonic material includes at least one metal. In such embodiments the metal may include at least one of Ag, Al, Au, Ir, Pt, Ni, Cu, W, Ta, Fe, Cr, Mg, Ga, Rh, Ti, Ru, Pd, In, Bi, Ca alloys or mixtures of these materials, and stacks of these materials. In general, a metamaterial is a medium composed of different materials where the medium as a whole acts differently than the sum of its material parts. In particular, we define optically active metamaterials as materials which have both negative permittivity and negative permeability. Hyperbolic metamaterials, on the other hand, are anisotropic media in which the permittivity or permeability are of different sign for different spatial directions. Optically active metamaterials and hyperbolic metamaterials are strictly distinguished from many other photonic structures such as Distributed Bragg Reflectors ("DBRs") in that the medium should appear uniform in the direction of propagation on the length scale of the wavelength of light. Using terminology that one skilled in the art can understand: the dielectric constant of the metamaterials in the direction of propagation can be described with the effective medium approximation. Plasmonic materials and metamaterials provide methods for controlling the propagation of light that can enhance OLED performance in a number of ways.

In some embodiments, the enhancement layer is provided as a planar layer. In other embodiments, the enhancement layer has wavelength-sized features that are arranged periodically, quasi-periodically, or randomly, or sub-wavelength-sized features that are arranged periodically, quasi-periodically, or randomly. In some embodiments, the wavelength-sized features and the sub-wavelength-sized features have sharp edges.

In some embodiments, the outcoupling layer has wavelength-sized features that are arranged periodically, quasi-periodically, or randomly, or sub-wavelength-sized features that are arranged periodically, quasi-periodically, or randomly. In some embodiments, the outcoupling layer may be composed of a plurality of nanoparticles and in other embodiments the outcoupling layer is composed of a pluraility of nanoparticles disposed over a material. In these embodiments the outcoupling may be tunable by at least one of varying a size of the plurality of nanoparticles, varying a shape of the plurality of nanoparticles, changing a material of the plurality of nanoparticles, adjusting a thickness of the material, changing the refractive index of the material or an additional layer disposed on the plurality of nanoparticles, varying a thickness of the enhancement layer, and/or varying the material of the enhancement layer. The plurality of nanoparticles of the device may be formed from at least one of metal, dielectric material, semiconductor materials, an alloy of metal, a mixture of dielectric materials, a stack or layering of one or more materials, and/or a core of one type of material and that is coated with a shell of a different type of material. In some embodiments, the outcoupling layer is composed of at least metal nanoparticles wherein the metal is selected from the group consisting of Ag, Al, Au, Ir, Pt, Ni, Cu, W, Ta, Fe, Cr, Mg, Ga, Rh, Ti, Ru, Pd, In, Bi, Ca, alloys or mixtures of these materials, and stacks of these materials. The plurality of nanoparticles may have additional layer disposed over them. In some embodiments, the polarization of the emission can be tuned using the outcoupling layer. Varying the dimensionality and periodicity of the outcoupling layer can select a type of polarization that is preferentially outcoupled to air. In some embodiments the outcoupling layer also acts as an electrode of the device.

In yet another aspect, the present disclosure also provides a consumer product comprising an organic light-emitting device (OLED) having an anode; a cathode; and an organic layer disposed between the anode and the cathode, wherein the organic layer may comprise a compound as disclosed in the above compounds section of the present disclosure.

In some embodiments, the consumer product comprises an OLED having an anode; a cathode; and an organic layer disposed between the anode and the cathode, wherein the organic layer may comprise a compound having a first ligand L_{A} of Formula I or a compound of Formula III as described herein.

In some embodiments, the consumer product can be one of a flat panel display, a computer monitor, a medical monitor, a television, a billboard, a light for interior or exterior illumination and/or signaling, a heads-up display, a fully or partially transparent display, a flexible display, a laser printer, a telephone, a cell phone, tablet, a phablet, a personal digital assistant (PDA), a wearable device, a laptop computer, a digital camera, a camcorder, a viewfinder, a micro-display that is less than 2 inches diagonal, a 3-D display, a virtual reality or augmented reality display, a vehicle, a video wall comprising multiple displays tiled together, a theater or stadium screen, a light therapy device, and a sign.

Generally, an OLED comprises at least one organic layer disposed between and electrically connected to an anode and a cathode. When a current is applied, the anode injects holes and the cathode injects electrons into the organic layer(s). The injected holes and electrons each migrate toward the oppositely charged electrode. When an electron and hole localize on the same molecule, an "exciton," which is a localized electron-hole pair having an excited energy state, is formed. Light is emitted when the exciton relaxes via a photoemissive mechanism. In some cases, the exciton may be localized on an excimer or an exciplex. Non-radiative mechanisms, such as thermal relaxation, may also occur, but are generally considered undesirable.

Several OLED materials and configurations are described in U.S. Pat. Nos. 5,844,363, 6,303,238, and 5,707,745, which are incorporated herein by reference in their entirety.

The initial OLEDs used emissive molecules that emitted light from their singlet states ("fluorescence") as disclosed, for example, in U.S. Pat. No. 4,769,292, which is incorporated by reference in its entirety. Fluorescent emission generally occurs in a time frame of less than 10 nanoseconds.

More recently, OLEDs having emissive materials that emit light from triplet states ("phosphorescence") have been demonstrated. Baldo et al., "Highly Efficient Phosphorescent Emission from Organic Electroluminescent Devices," Nature, vol. 395, 151-154, 1998; ("Baldo-I") and Baldo et al., "Very high-efficiency green organic light-emitting devices based on electrophosphorescence," Appl. Phys. Lett., vol. 75, No. 3, 4-6 (1999) ("Baldo-II"), are incorporated by reference in their entireties. Phosphorescence is described in more detail in U.S. Pat. No. 7,279,704 at cols. 5-6, which are incorporated by reference.

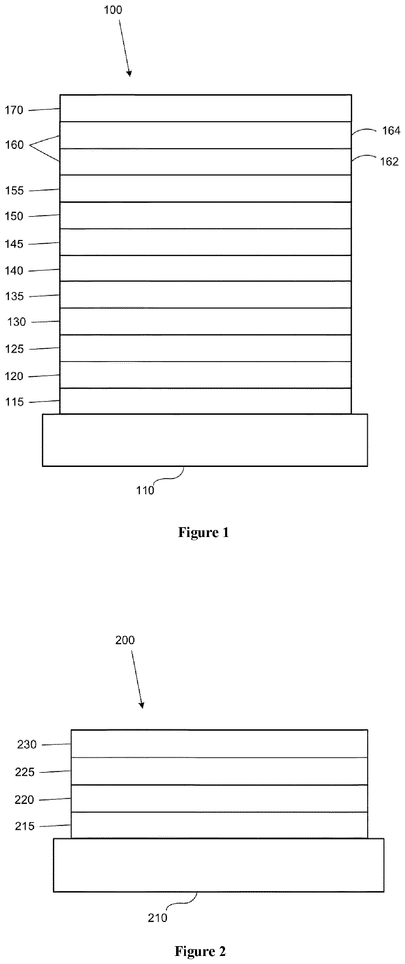

FIG. 1 shows an organic light emitting device 100. The figures are not necessarily drawn to scale. Device 100 may include a substrate 110, an anode 115, a hole injection layer 120, a hole transport layer 125, an electron blocking layer 130, an emissive layer 135, a hole blocking layer 140, an electron transport layer 145, an electron injection layer 150, a protective layer 155, a cathode 160, and a barrier layer 170. Cathode 160 is a compound cathode having a first conductive layer 162 and a second conductive layer 164. Device 100 may be fabricated by depositing the layers described, in order. The properties and functions of these various layers, as well as example materials, are described in more detail in US 7,279,704 at cols. 6-10, which are incorporated by reference.

More examples for each of these layers are available. For example, a flexible and transparent substrate-anode combination is disclosed in U.S. Pat. No. 5,844,363, which is incorporated by reference in its entirety. An example of a p-doped hole transport layer is m-MTDATA doped with F₄-TCNQ at a molar ratio of 50:1, as disclosed in U.S. Patent Application Publication No. 2003/0230980, which is incorporated by reference in its entirety. Examples of emissive and host materials are disclosed in U.S. Pat. No. 6,303,238 to Thompson et al., which is incorporated by reference in its entirety. An example of an n-doped electron transport layer is BPhen doped with Li at a molar ratio of 1:1, as disclosed in U.S. Patent Application Publication No. 2003/0230980, which is incorporated by reference in its entirety. U.S. Pat. Nos. 5,703,436 and 5,707,745, which are incorporated by reference in their entireties, disclose examples of cathodes including compound cathodes having a thin layer of metal such as Mg:Ag with an overlying transparent, electrically-conductive, sputter-deposited ITO layer. The theory and use of blocking layers is described in more detail in U.S. Pat. No. 6,097,147 and U.S. Patent Application Publication No. 2003/0230980, which are incorporated by reference in their entireties. Examples of injection layers are provided in U.S. Patent Application Publication No. 2004/0174116, which is incorporated by reference in its entirety. A description of protective layers may be found in U.S. Patent Application Publication No. 2004/0174116, which is incorporated by reference in its entirety.

FIG. 2 shows an inverted OLED 200. The device includes a substrate 210, a cathode 215, an emissive layer 220, a hole transport layer 225, and an anode 230. Device 200 may be fabricated by depositing the layers described, in order. Because the most common OLED configuration has a cathode disposed over the anode, and device 200 has cathode 215 disposed under anode 230, device 200 may be referred to as an "inverted" OLED. Materials similar to those described with respect to device 100 may be used in the corresponding layers of device 200. FIG. 2 provides one example of how some layers may be omitted from the structure of device 100.

The simple layered structure illustrated in FIGS. 1 and 2 is provided by way of non-limiting example, and it is understood that embodiments of the present disclosure may be used in connection with a wide variety of other structures. The specific materials and structures described are exemplary in nature, and other materials and structures may be used. Functional OLEDs may be achieved by combining the various layers described in different ways, or layers may be omitted entirely, based on design, performance, and cost factors. Other layers not specifically described may also be included. Materials other than those specifically described may be used. Although many of the examples provided herein describe various layers as comprising a single material, it is understood that combinations of materials, such as a mixture of host and dopant, or more generally a mixture, may be used. Also, the layers may have various sublayers. The names given to the various layers herein are not intended to be strictly limiting. For example, in device 200, hole transport layer 225 transports holes and injects holes into emissive layer 220, and may be described as a hole transport layer or a hole injection layer. In one embodiment, an OLED may be described as having an "organic layer" disposed between a cathode and an anode. This organic layer may comprise a single layer, or may further comprise multiple layers of different organic materials as described, for example, with respect to FIGS. 1 and 2.

Structures and materials not specifically described may also be used, such as OLEDs comprised of polymeric materials (PLEDs) such as disclosed in U.S. Pat. No. 5,247,190 to Friend et al., which is incorporated by reference in its entirety. By way of further example, OLEDs having a single organic layer may be used. OLEDs may be stacked, for example as described in U.S. Pat. No. 5,707,745 to Forrest et al, which is incorporated by reference in its entirety. The OLED structure may deviate from the simple layered structure illustrated in FIGS. 1 and 2. For example, the substrate may include an angled reflective surface to improve out-coupling, such as a mesa structure as described in U.S. Pat. No. 6,091,195 to Forrest et al., and/or a pit structure as described in U.S. Pat. No. 5,834,893 to Bulovic et al., which are incorporated by reference in their entireties.

Unless otherwise specified, any of the layers of the various embodiments may be deposited by any suitable method. For the organic layers, preferred methods include thermal evaporation, ink-jet, such as described in U.S. Pat. Nos. 6,013,982 and 6,087,196, which are incorporated by reference in their entireties, organic vapor phase deposition (OVPD), such as described in U.S. Pat. No. 6,337,102 to Forrest et al., which is incorporated by reference in its entirety, and deposition by organic vapor jet printing (OVJP, also referred to as organic vapor jet deposition (OVJD)), such as described in U.S. Pat. No. 7,431,968, which is incorporated by reference in its entirety. Other suitable deposition methods include spin coating and other solution based processes. Solution based processes are preferably carried out in nitrogen or an inert atmosphere. For the other layers, preferred methods include thermal evaporation. Preferred patterning methods include deposition through a mask, cold welding such as described in U.S. Pat. Nos. 6,294,398 and 6,468,819, which are incorporated by reference in their entireties, and patterning associated with some of the deposition methods such as ink-jet and organic vapor jet printing (OVJP). Other methods may also be used. The materials to be deposited may be modified to make them compatible with a particular deposition method. For example, substituents such as alkyl and aryl groups, branched or unbranched, and preferably containing at least 3 carbons, may be used in small molecules to enhance their ability to undergo solution processing. Substituents having 20 carbons or more may be used, and 3-20 carbons are a preferred range. Materials with asymmetric structures may have better solution processability than those having symmetric structures, because asymmetric materials may have a lower tendency to recrystallize. Dendrimer substituents may be used to enhance the ability of small molecules to undergo solution processing.

Devices fabricated in accordance with embodiments of the present disclosure may further optionally comprise a barrier layer. One purpose of the barrier layer is to protect the electrodes and organic layers from damaging exposure to harmful species in the environment including moisture, vapor and/or gases, etc. The barrier layer may be deposited over, under or next to a substrate, an electrode, or over any other parts of a device including an edge. The barrier layer may comprise a single layer, or multiple layers. The barrier layer may be formed by various known chemical vapor deposition techniques and may include compositions having a single phase as well as compositions having multiple phases. Any suitable material or combination of materials may be used for the barrier layer. The barrier layer may incorporate an inorganic or an organic compound or both. The preferred barrier layer comprises a mixture of a polymeric material and a non-polymeric material as described in U.S. Pat. No. 7,968,146, PCT Pat. Application Nos. PCT/US2007/023098 and PCT/US2009/042829, which are herein incorporated by reference in their entireties. To be considered a "mixture", the aforesaid polymeric and non-polymeric materials comprising the barrier layer should be deposited under the same reaction conditions and/or at the same time. The weight ratio of polymeric to non-polymeric material may be in the range of 95:5 to 5:95. The polymeric material and the non-polymeric material may be created from the same precursor material. In one example, the mixture of a polymeric material and a non-polymeric material consists essentially of polymeric silicon and inorganic silicon.

Devices fabricated in accordance with embodiments of the present disclosure can be incorporated into a wide variety of electronic component modules (or units) that can be incorporated into a variety of electronic products or intermediate components. Examples of such electronic products or intermediate components include display screens, lighting devices such as discrete light source devices or lighting panels, etc. that can be utilized by the end-user product manufacturers. Such electronic component modules can optionally include the driving electronics and/or power source(s). Devices fabricated in accordance with embodiments of the present disclosure can be incorporated into a wide variety of consumer products that have one or more of the electronic component modules (or units) incorporated therein. A consumer product comprising an OLED that includes the compound of the present disclosure in the organic layer in the OLED is disclosed. Such consumer products would include any kind of products that include one or more light source(s) and/or one or more of some type of visual displays. Some examples of such consumer products include flat panel displays, curved displays, computer monitors, medical monitors, televisions, billboards, lights for interior or exterior illumination and/or signaling, heads-up displays, fully or partially transparent displays, flexible displays, rollable displays, foldable displays, stretchable displays, laser printers, telephones, mobile phones, tablets, phablets, personal digital assistants (PDAs), wearable devices, laptop computers, digital cameras, camcorders, viewfinders, micro-displays (displays that are less than 2 inches diagonal), 3-D displays, virtual reality or augmented reality displays, vehicles, video walls comprising multiple displays tiled together, theater or stadium screen, a light therapy device, and a sign. Various control mechanisms may be used to control devices fabricated in accordance with the present disclosure, including passive matrix and active matrix. Many of the devices are intended for use in a temperature range comfortable to humans, such as 18 degrees C. to 30 degrees C., and more preferably at room temperature (20-25 °C), but could be used outside this temperature range, for example, from -40 degree C to + 80 °C.

More details on OLEDs, and the definitions described above, can be found in U.S. Pat. No. 7,279,704, which is incorporated herein by reference in its entirety.

The materials and structures described herein may have applications in devices other than OLEDs. For example, other optoelectronic devices such as organic solar cells and organic photodetectors may employ the materials and structures. More generally, organic devices, such as organic transistors, may employ the materials and structures.

In some embodiments, the OLED has one or more characteristics selected from the group consisting of being flexible, being rollable, being foldable, being stretchable, and being curved. In some embodiments, the OLED is transparent or semi-transparent. In some embodiments, the OLED further comprises a layer comprising carbon nanotubes.

In some embodiments, the OLED further comprises a layer comprising a delayed fluorescent emitter. In some embodiments, the OLED comprises a RGB pixel arrangement or white plus color filter pixel arrangement. In some embodiments, the OLED is a mobile device, a hand held device, or a wearable device. In some embodiments, the OLED is a display panel having less than 10 inch diagonal or 50 square inch area. In some embodiments, the OLED is a display panel having at least 10 inch diagonal or 50 square inch area. In some embodiments, the OLED is a lighting panel.

In some embodiments, the compound can be an emissive dopant. In some embodiments, the compound can produce emissions via phosphorescence, fluorescence, thermally activated delayed fluorescence, i.e., TADF (also referred to as E-type delayed fluorescence; *see, e.g.,* U.S. Application No. 15/700,352, which is hereby incorporated by reference in its entirety), triplet-triplet annihilation, or combinations of these processes. In some embodiments, the emissive dopant can be a racemic mixture, or can be enriched in one enantiomer. In some embodiments, the compound can be homoleptic (each ligand is the same). In some embodiments, the compound can be heteroleptic (at least one ligand is different from others). When there are more than one ligand coordinated to a metal, the ligands can all be the same in some embodiments. In some other embodiments, at least one ligand is different from the other ligands. In some embodiments, every ligand can be different from each other. This is also true in embodiments where a ligand being coordinated to a metal can be linked with other ligands being coordinated to that metal to form a tridentate, tetradentate, pentadentate, or hexadentate ligands. Thus, where the coordinating ligands are being linked together, all of the ligands can be the same in some embodiments, and at least one of the ligands being linked can be different from the other ligand(s) in some other embodiments.

In some embodiments, the compound can be used as a phosphorescent sensitizer in an OLED where one or multiple layers in the OLED contains an acceptor in the form of one or more fluorescent and/or delayed fluorescence emitters. In some embodiments, the compound can be used as one component of an exciplex to be used as a sensitizer. As a phosphorescent sensitizer, the compound must be capable of energy transfer to the acceptor and the acceptor will emit the energy or further transfer energy to a final emitter. The acceptor concentrations can range from 0.001% to 100%. The acceptor could be in either the same layer as the phosphorescent sensitizer or in one or more different layers. In some embodiments, the acceptor is a TADF emitter. In some embodiments, the acceptor is a fluorescent emitter. In some embodiments, the emission can arise from any or all of the sensitizer, acceptor, and final emitter.

According to another aspect, a formulation comprising the compound described herein is also disclosed.

The OLED disclosed herein can be incorporated into one or more of a consumer product, an electronic component module, and a lighting panel. The organic layer can be an emissive layer and the compound can be an emissive dopant in some embodiments, while the compound can be a non-emissive dopant in other embodiments.

In yet another aspect of the present disclosure, a formulation that comprises the novel compound disclosed herein is described. The formulation can include one or more components selected from the group consisting of a solvent, a host, a hole injection material, hole transport material, electron blocking material, hole blocking material, and an electron transport material, disclosed herein.

The present disclosure encompasses any chemical structure comprising the novel compound of the present disclosure, or a monovalent or polyvalent variant thereof. In other words, the inventive compound, or a monovalent or polyvalent variant thereof, can be a part of a larger chemical structure. Such chemical structure can be selected from the group consisting of a monomer, a polymer, a macromolecule, and a supramolecule (also known as supermolecule). As used herein, a "monovalent variant of a compound" refers to a moiety that is identical to the compound except that one hydrogen has been removed and replaced with a bond to the rest of the chemical structure. As used herein, a "polyvalent variant of a compound" refers to a moiety that is identical to the compound except that more than one hydrogen has been removed and replaced with a bond or bonds to the rest of the chemical structure. In the instance of a supramolecule, the inventive compound can also be incorporated into the supramolecule complex without covalent bonds.

### D. Combination of the Compounds of the Present Disclosure with Other Materials

The materials described herein as useful for a particular layer in an organic light emitting device may be used in combination with a wide variety of other materials present in the device. For example, emissive dopants disclosed herein may be used in conjunction with a wide variety of hosts, transport layers, blocking layers, injection layers, electrodes and other layers that may be present. The materials described or referred to below are non-limiting examples of materials that may be useful in combination with the compounds disclosed herein, and one of skill in the art can readily consult the literature to identify other materials that may be useful in combination.

### a) Conductivity Dopants:

A charge transport layer can be doped with conductivity dopants to substantially alter its density of charge carriers, which will in turn alter its conductivity. The conductivity is increased by generating charge carriers in the matrix material, and depending on the type of dopant, a change in the Fermi level of the semiconductor may also be achieved. Hole-transporting layer can be doped by p-type conductivity dopants and n-type conductivity dopants are used in the electron-transporting layer.

Non-limiting examples of the conductivity dopants that may be used in an OLED in combination with materials disclosed herein are exemplified below together with references that disclose those materials: EP01617493, EP01968131, EP2020694, EP2684932, US20050139810, US20070160905, US20090167167, US2010288362, WO06081780, WO2009003455, WO2009008277, WO2009011327, WO2014009310, US2007252140, US2015060804, US20150123047, and US2012146012.

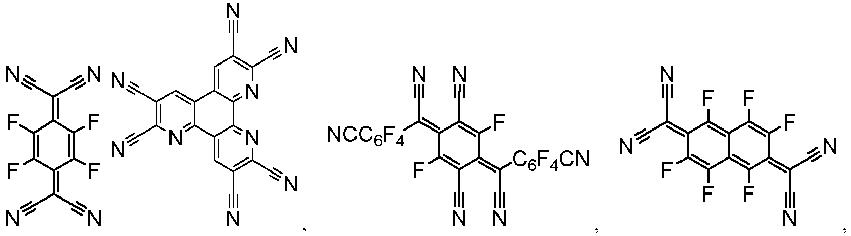

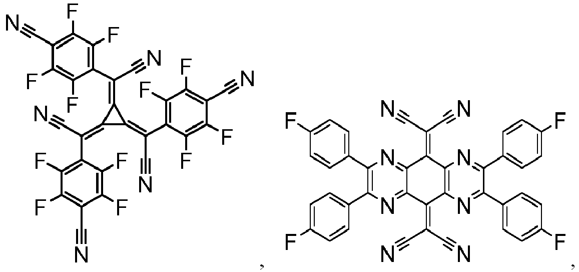

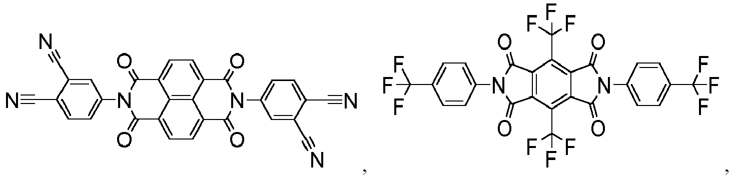

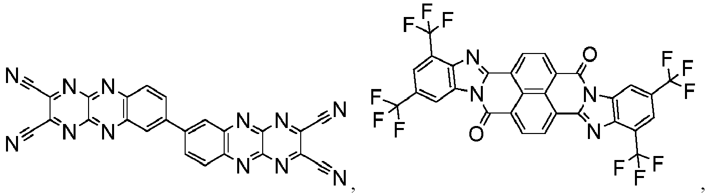

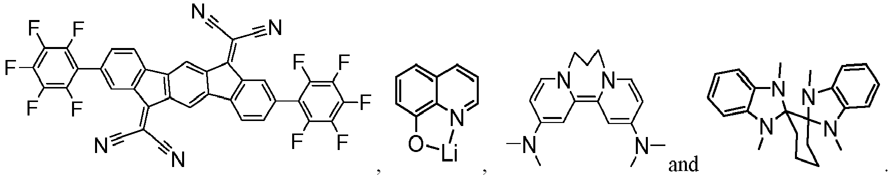

### b) HIL/HTL:

A hole injecting/transporting material to be used in the present disclosure is not particularly limited, and any compound may be used as long as the compound is typically used as a hole injecting/transporting material. Examples of the material include, but are not limited to: a phthalocyanine or porphyrin derivative; an aromatic amine derivative; an indolocarbazole derivative; a polymer containing fluorohydrocarbon; a polymer with conductivity dopants; a conducting polymer, such as PEDOT/PSS; a self-assembly monomer derived from compounds such as phosphonic acid and silane derivatives; a metal oxide derivative, such as MoOₓ; a p-type semiconducting organic compound, such as 1,4,5,8,9,12-Hexaazatriphenylenehexacarbonitrile; a metal complex, and a cross-linkable compounds.

Examples of aromatic amine derivatives used in HIL or HTL include, but not limit to the following general structures:

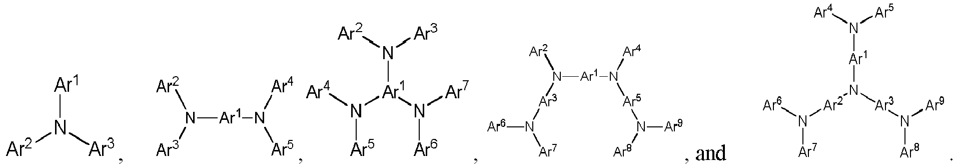

Each of Ar¹ to Ar⁹ is selected from the group consisting of aromatic hydrocarbon cyclic compounds such as benzene, biphenyl, triphenyl, triphenylene, naphthalene, anthracene, phenalene, phenanthrene, fluorene, pyrene, chrysene, perylene, and azulene; the group consisting of aromatic heterocyclic compounds such as dibenzothiophene, dibenzofuran, dibenzoselenophene, furan, thiophene, benzofuran, benzothiophene, benzoselenophene, carbazole, indolocarbazole, pyridylindole, pyrrolodipyridine, pyrazole, imidazole, triazole, oxazole, thiazole, oxadiazole, oxatriazole, dioxazole, thiadiazole, pyridine, pyridazine, pyrimidine, pyrazine, triazine, oxazine, oxathiazine, oxadiazine, indole, benzimidazole, indazole, indoxazine, benzoxazole, benzisoxazole, benzothiazole, quinoline, isoquinoline, cinnoline, quinazoline, quinoxaline, naphthyridine, phthalazine, pteridine, xanthene, acridine, phenazine, phenothiazine, phenoxazine, benzofuropyridine, furodipyridine, benzothienopyridine, thienodipyridine, benzoselenophenopyridine, and selenophenodipyridine; and the group consisting of 2 to 10 cyclic structural units which are groups of the same type or different types selected from the aromatic hydrocarbon cyclic group and the aromatic heterocyclic group and are bonded to each other directly or via at least one of oxygen atom, nitrogen atom, sulfur atom, silicon atom, phosphorus atom, boron atom, chain structural unit and the aliphatic cyclic group. Each Ar may be unsubstituted or may be substituted by a substituent selected from the group consisting of deuterium, halogen, alkyl, cycloalkyl, heteroalkyl, heterocycloalkyl, arylalkyl, alkoxy, aryloxy, amino, silyl, alkenyl, cycloalkenyl, heteroalkenyl, alkynyl, aryl, heteroaryl, acyl, carboxylic acids, ether, ester, nitrile, isonitrile, sulfanyl, sulfinyl, sulfonyl, phosphino, and combinations thereof.

In one aspect, Ar¹ to Ar⁹ is independently selected from the group consisting of: 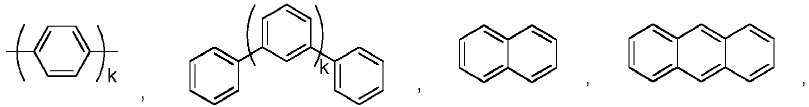 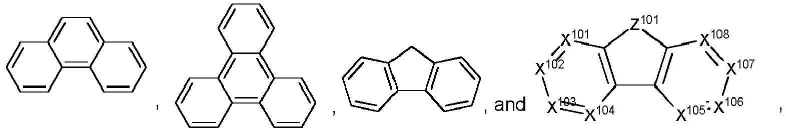 wherein k is an integer from 1 to 20; X¹⁰¹ to X¹⁰⁸ is C (including CH) or N; Z¹⁰¹ is NAr¹, O, or S; Ar¹ has the same group defined above.

Examples of metal complexes used in HIL or HTL include, but are not limited to the following general formula: 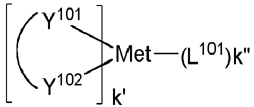 wherein Met is a metal, which can have an atomic weight greater than 40; (Y¹⁰¹-Y¹⁰²) is a bidentate ligand, Y¹⁰¹ and Y¹⁰² are independently selected from C, N, O, P, and S; L¹⁰¹ is an ancillary ligand; k' is an integer value from 1 to the maximum number of ligands that may be attached to the metal; and k'+k" is the maximum number of ligands that may be attached to the metal.

In one aspect, (Y¹⁰¹-Y¹⁰²) is a 2-phenylpyridine derivative. In another aspect, (Y¹⁰¹-Y¹⁰²) is a carbene ligand. In another aspect, Met is selected from Ir, Pt, Os, and Zn. In a further aspect, the metal complex has a smallest oxidation potential in solution vs. Fc⁺/Fc couple less than about 0.6 V.

Non-limiting examples of the HIL and HTL materials that may be used in an OLED in combination with materials disclosed herein are exemplified below together with references that disclose those materials: CN102702075, DE102012005215, EP01624500, EP01698613, EP01806334, EP01930964, EP01972613, EP01997799, EP02011790, EP02055700, EP02055701, EP1725079, EP2085382, EP2660300, EP650955, JP07-073529, JP2005112765, JP2007091719, JP2008021687, JP2014-009196, KR20110088898, KR20130077473, TW201139402, US06517957, US20020158242, US20030162053, US20050123751, US20060182993, US20060240279, US20070145888, US20070181874, US20070278938, US20080014464, US20080091025, US20080106190, US20080124572, US20080145707, US20080220265, US20080233434, US20080303417, US2008107919, US20090115320, US20090167161, US2009066235, US2011007385, US20110163302, US2011240968, US2011278551, US2012205642, US2013241401, US20140117329, US2014183517, US5061569, US5639914, WO05075451, WO07125714, WO08023550, WO08023759, WO2009145016, WO2010061824, WO2011075644, WO2012177006, WO2013018530, WO2013039073, WO2013087142, WO2013118812, WO2013120577, WO2013157367, WO2013175747, WO2014002873, WO2014015935, WO2014015937, WO2014030872, WO2014030921, WO2014034791, WO2014104514, WO2014157018.

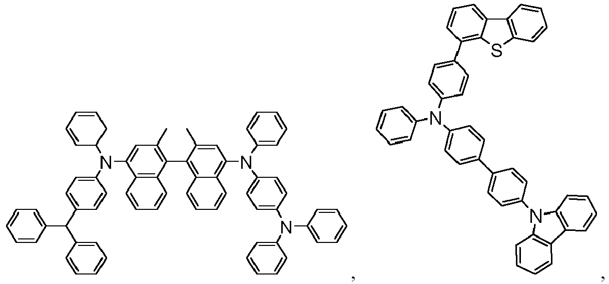

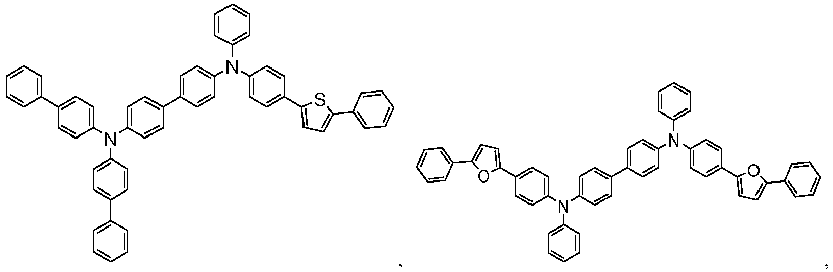

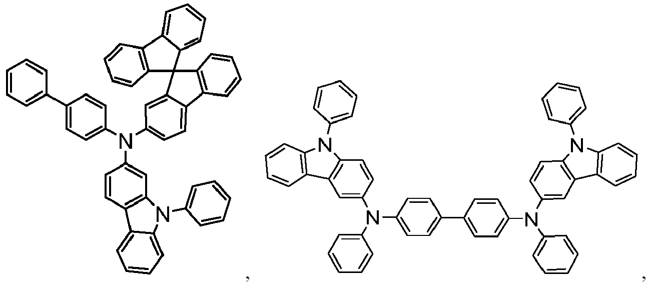

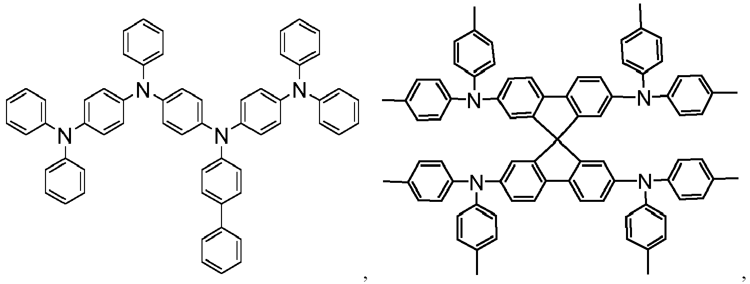

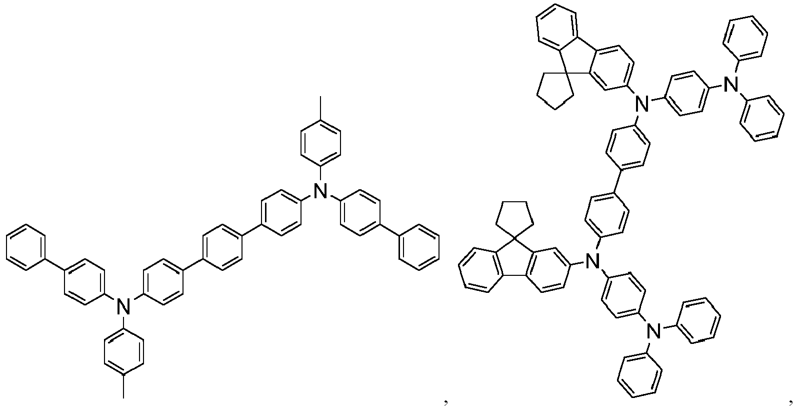

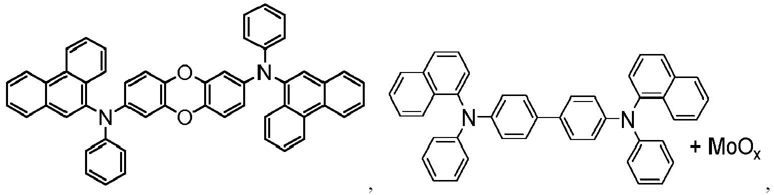

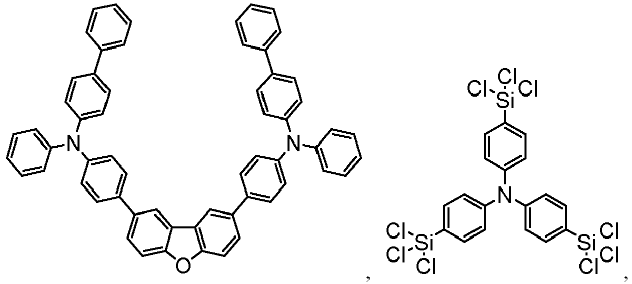

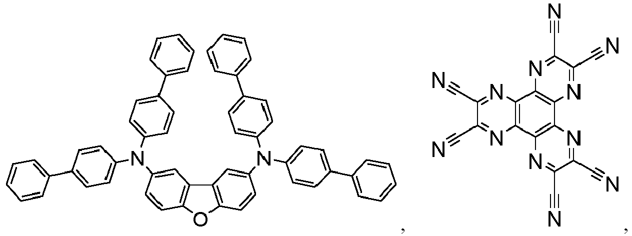

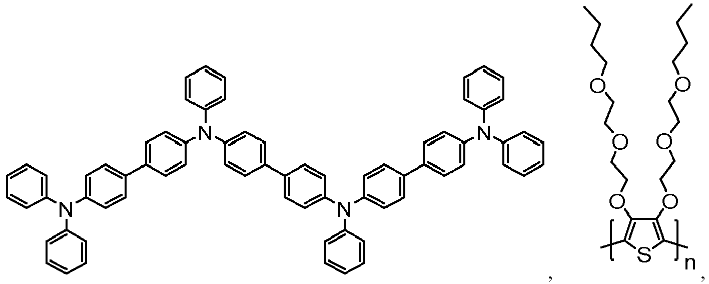

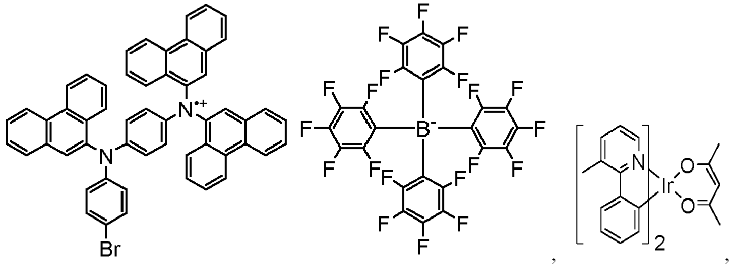

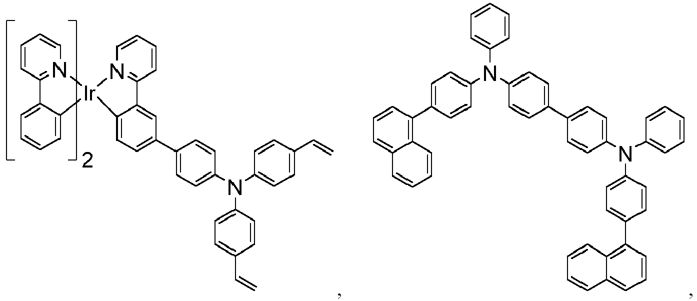

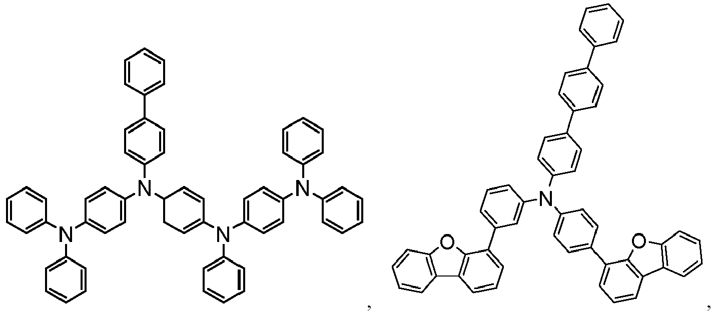

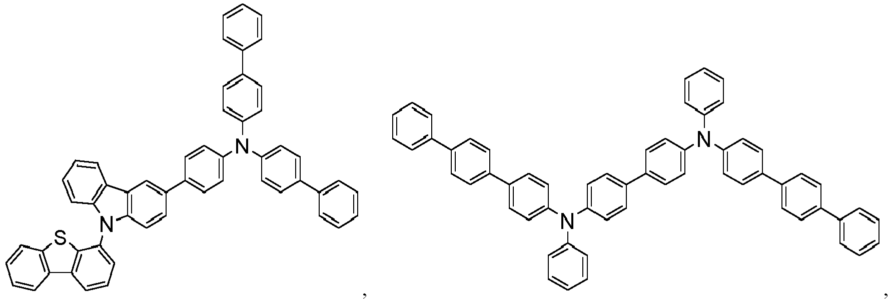

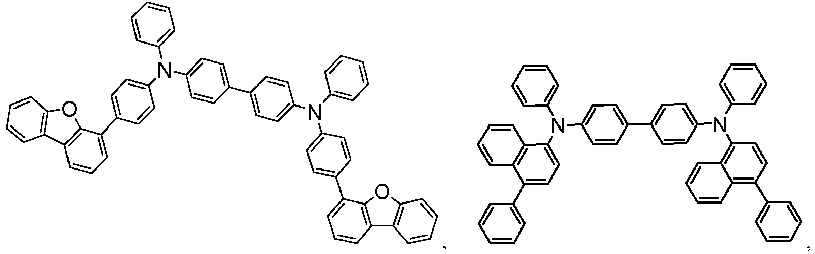

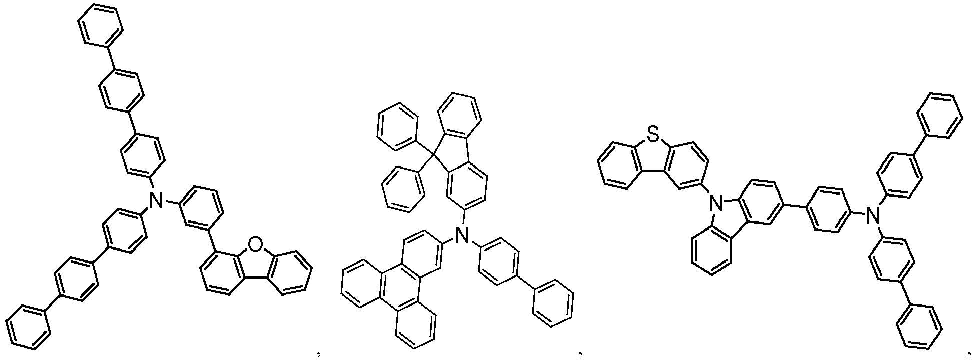

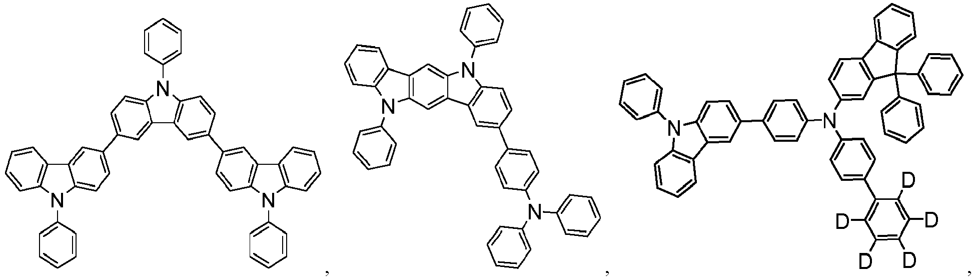

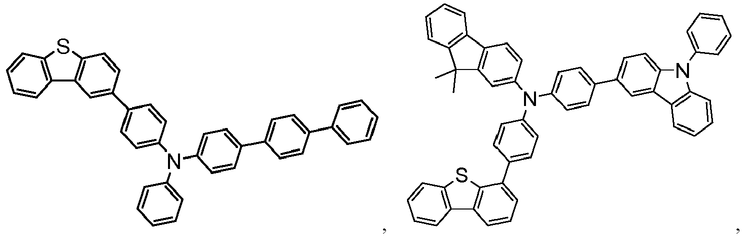

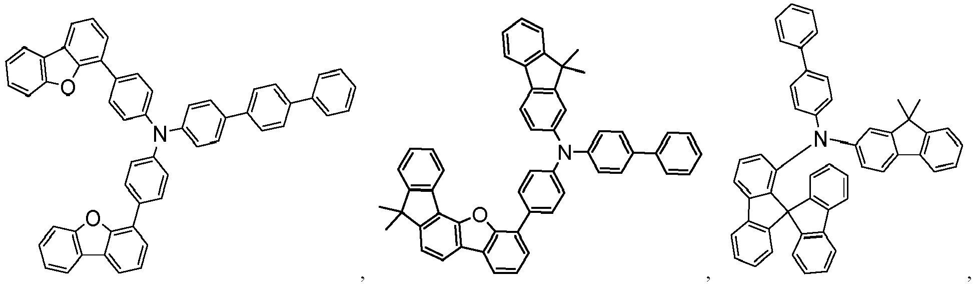

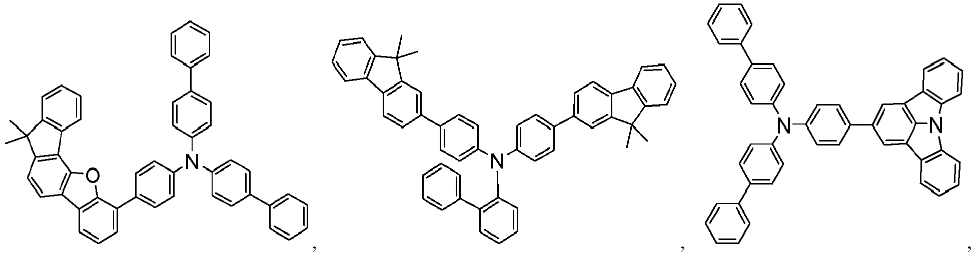

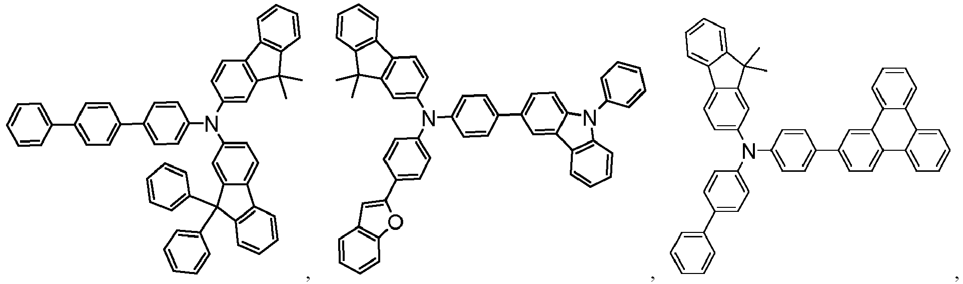

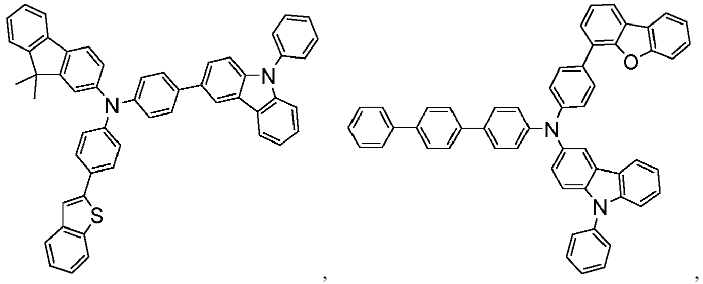

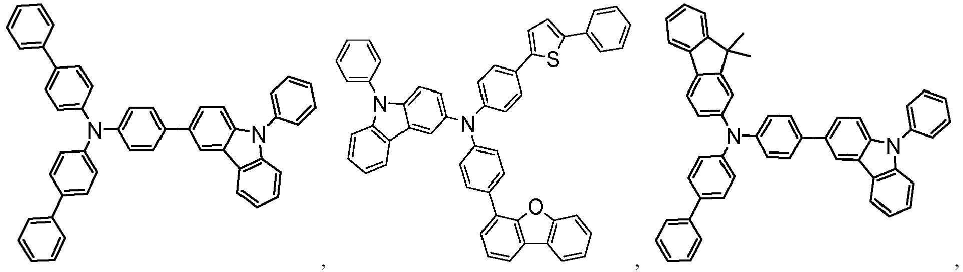

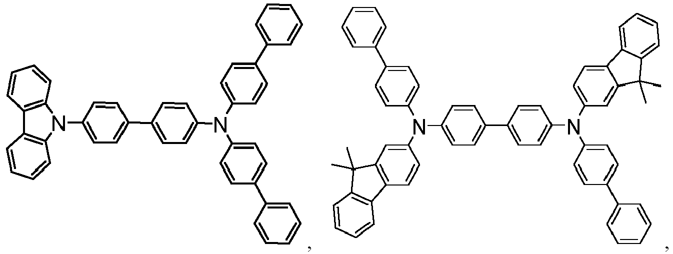

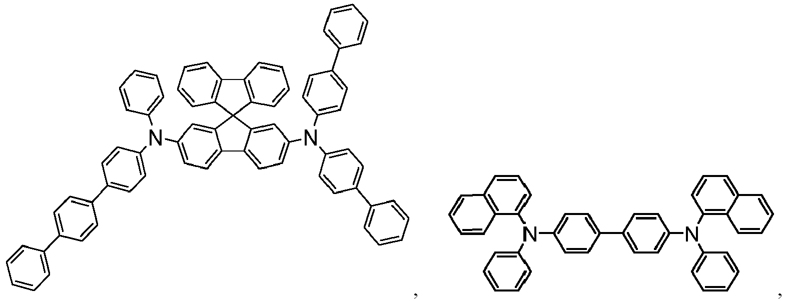

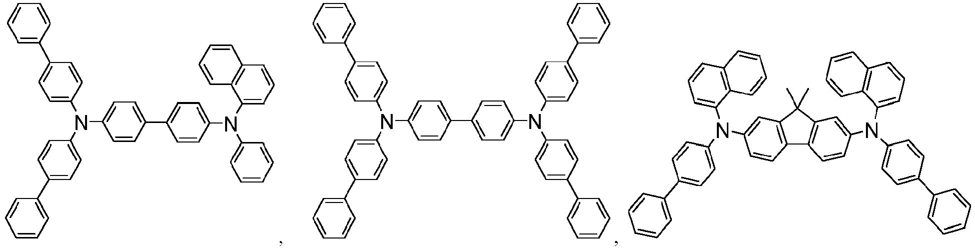

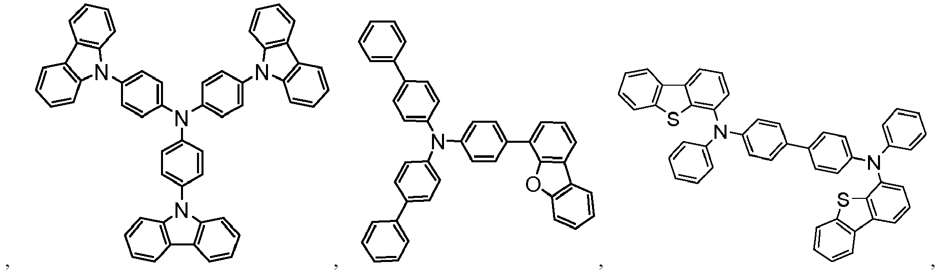

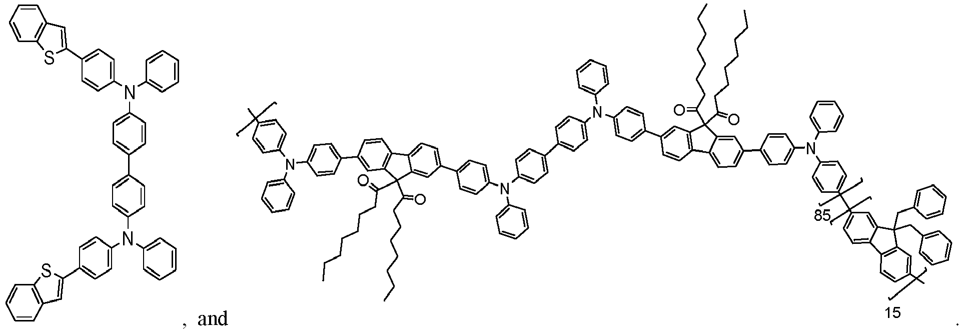

### c) EBL:

An electron blocking layer (EBL) may be used to reduce the number of electrons and/or excitons that leave the emissive layer. The presence of such a blocking layer in a device may result in substantially higher efficiencies, and/or longer lifetime, as compared to a similar device lacking a blocking layer. Also, a blocking layer may be used to confine emission to a desired region of an OLED. In some embodiments, the EBL material has a higher LUMO (closer to the vacuum level) and/or higher triplet energy than the emitter closest to the EBL interface. In some embodiments, the EBL material has a higher LUMO (closer to the vacuum level) and/or higher triplet energy than one or more of the hosts closest to the EBL interface. In one aspect, the compound used in EBL contains the same molecule or the same functional groups used as one of the hosts described below.

### d) Hosts:

The light emitting layer of the organic EL device of the present disclosure preferably contains at least a metal complex as light emitting material, and may contain a host material using the metal complex as a dopant material. Examples of the host material are not particularly limited, and any metal complexes or organic compounds may be used as long as the triplet energy of the host is larger than that of the dopant. Any host material may be used with any dopant so long as the triplet criteria is satisfied.

Examples of metal complexes used as host are preferred to have the following general formula: 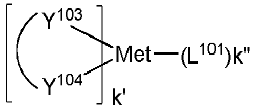 wherein Met is a metal; (Y¹⁰³-Y¹⁰⁴) is a bidentate ligand, Y¹⁰³ and Y¹⁰⁴ are independently selected from C, N, O, P, and S; L¹⁰¹ is an another ligand; k' is an integer value from 1 to the maximum number of ligands that may be attached to the metal; and k'+k" is the maximum number of ligands that may be attached to the metal.

In one aspect, the metal complexes are: 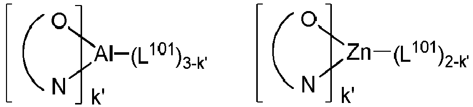 wherein (O-N) is a bidentate ligand, having metal coordinated to atoms O and N.

In another aspect, Met is selected from Ir and Pt. In a further aspect, (Y¹⁰³-Y¹⁰⁴) is a carbene ligand.

In one aspect, the host compound contains at least one of the following groups selected from the group consisting of aromatic hydrocarbon cyclic compounds such as benzene, biphenyl, triphenyl, triphenylene, tetraphenylene, naphthalene, anthracene, phenalene, phenanthrene, fluorene, pyrene, chrysene, perylene, and azulene; the group consisting of aromatic heterocyclic compounds such as dibenzothiophene, dibenzofuran, dibenzoselenophene, furan, thiophene, benzofuran, benzothiophene, benzoselenophene, carbazole, indolocarbazole, pyridylindole, pyrrolodipyridine, pyrazole, imidazole, triazole, oxazole, thiazole, oxadiazole, oxatriazole, dioxazole, thiadiazole, pyridine, pyridazine, pyrimidine, pyrazine, triazine, oxazine, oxathiazine, oxadiazine, indole, benzimidazole, indazole, indoxazine, benzoxazole, benzisoxazole, benzothiazole, quinoline, isoquinoline, cinnoline, quinazoline, quinoxaline, naphthyridine, phthalazine, pteridine, xanthene, acridine, phenazine, phenothiazine, phenoxazine, benzofuropyridine, furodipyridine, benzothienopyridine, thienodipyridine, benzoselenophenopyridine, and selenophenodipyridine; and the group consisting of 2 to 10 cyclic structural units which are groups of the same type or different types selected from the aromatic hydrocarbon cyclic group and the aromatic heterocyclic group and are bonded to each other directly or via at least one of oxygen atom, nitrogen atom, sulfur atom, silicon atom, phosphorus atom, boron atom, chain structural unit and the aliphatic cyclic group. Each option within each group may be unsubstituted or may be substituted by a substituent selected from the group consisting of deuterium, halogen, alkyl, cycloalkyl, heteroalkyl, heterocycloalkyl, arylalkyl, alkoxy, aryloxy, amino, silyl, alkenyl, cycloalkenyl, heteroalkenyl, alkynyl, aryl, heteroaryl, acyl, carboxylic acids, ether, ester, nitrile, isonitrile, sulfanyl, sulfinyl, sulfonyl, phosphino, and combinations thereof.

In one aspect, the host compound contains at least one of the following groups in the molecule: 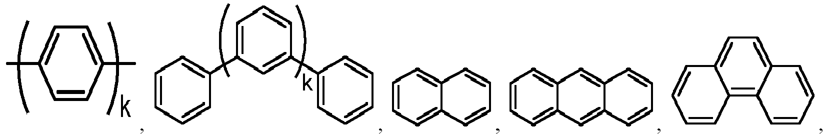 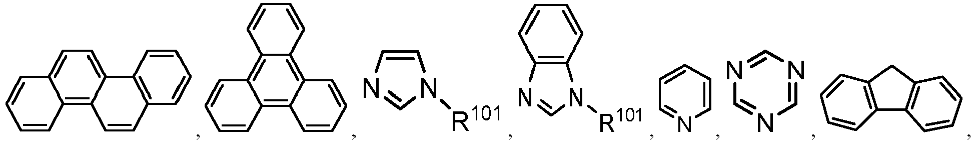 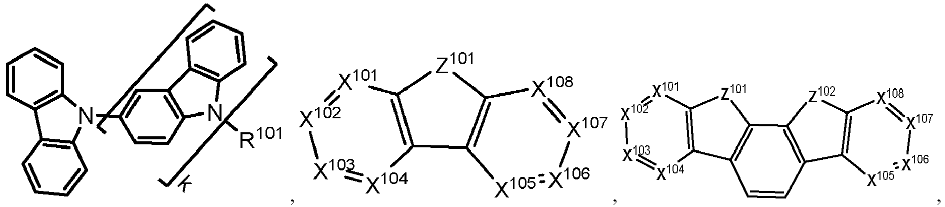 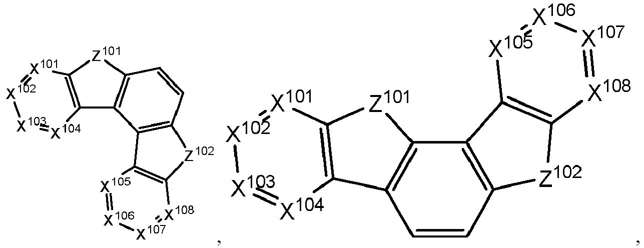 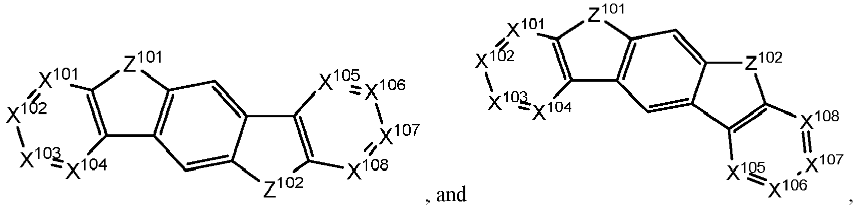 wherein R¹⁰¹ is selected from the group consisting of hydrogen, deuterium, halogen, alkyl, cycloalkyl, heteroalkyl, heterocycloalkyl, arylalkyl, alkoxy, aryloxy, amino, silyl, alkenyl, cycloalkenyl, heteroalkenyl, alkynyl, aryl, heteroaryl, acyl, carboxylic acids, ether, ester, nitrile, isonitrile, sulfanyl, sulfinyl, sulfonyl, phosphino, and combinations thereof, and when it is aryl or heteroaryl, it has the similar definition as Ar's mentioned above. k is an integer from 0 to 20 or 1 to 20. X¹⁰¹ to X¹⁰⁸ are independently selected from C (including CH) or N. Z¹⁰¹ and Z¹⁰² are independently selected from NR¹⁰¹, O, or S.

Non-limiting examples of the host materials that may be used in an OLED in combination with materials disclosed herein are exemplified below together with references that disclose those materials: EP2034538, EP2034538A, EP2757608, JP2007254297, KR20100079458, KR20120088644, KR20120129733, KR20130115564, TW201329200, US20030175553, US20050238919, US20060280965, US20090017330, US20090030202, US20090167162, US20090302743, US20090309488, US20100012931, US20100084966, US20100187984, US2010187984, US2012075273, US2012126221, US2013009543, US2013105787, US2013175519, US2014001446, US20140183503, US20140225088, US2014034914, US7154114, WO2001039234, WO2004093207, WO2005014551, WO2005089025, WO2006072002, WO2006114966, WO2007063754, WO2008056746, WO2009003898, WO2009021126, WO2009063833, WO2009066778, WO2009066779, WO2009086028, WO2010056066, WO2010107244, WO2011081423, WO2011081431, WO2011086863, WO2012128298, WO2012133644, WO2012133649, WO2013024872, WO2013035275, WO2013081315, WO2013191404, WO2014142472, US20170263869, US20160163995, US9466803,

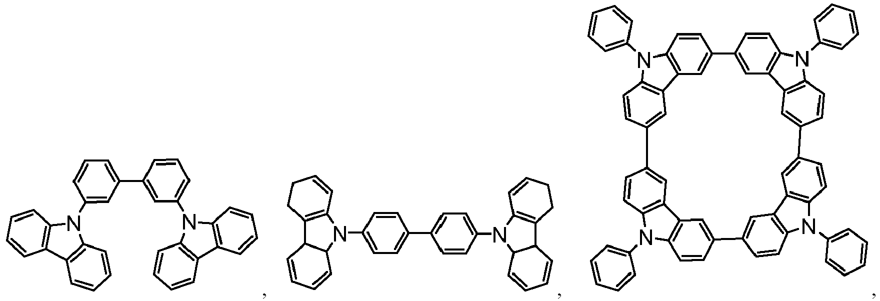

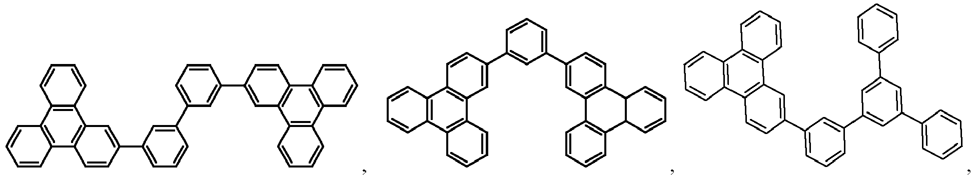

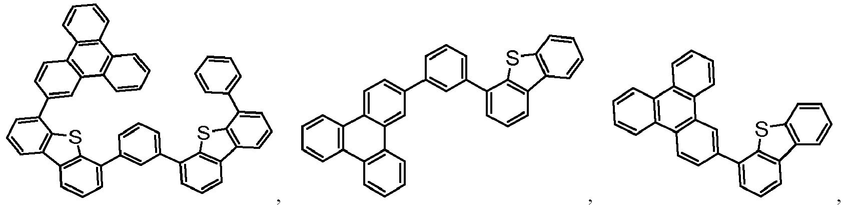

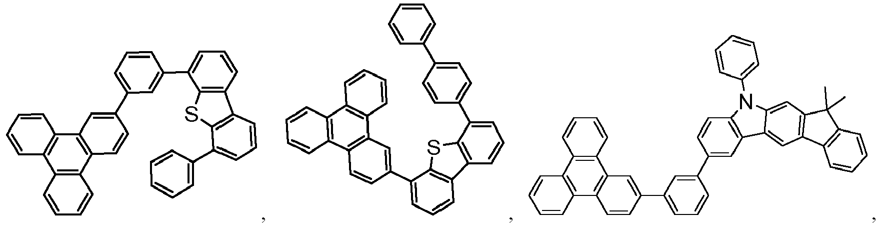

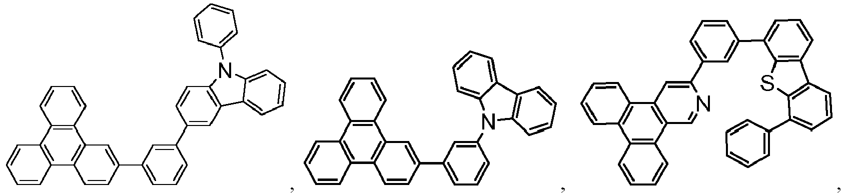

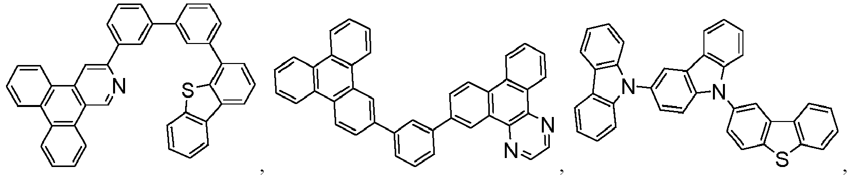

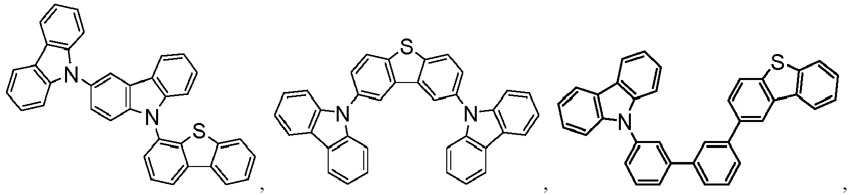

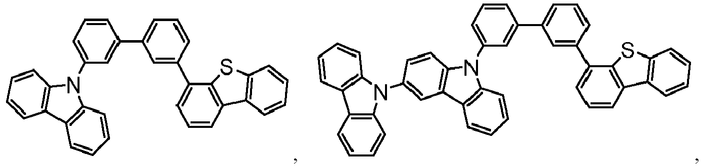

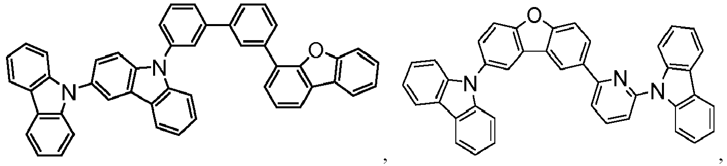

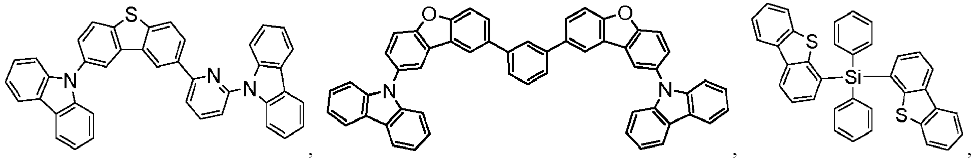

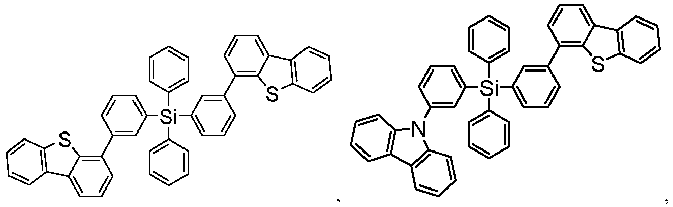

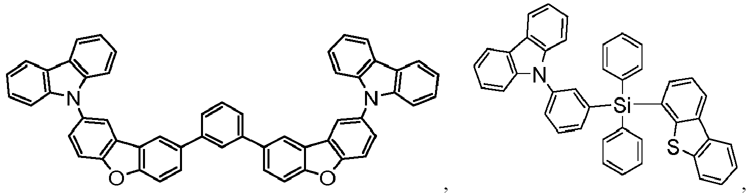

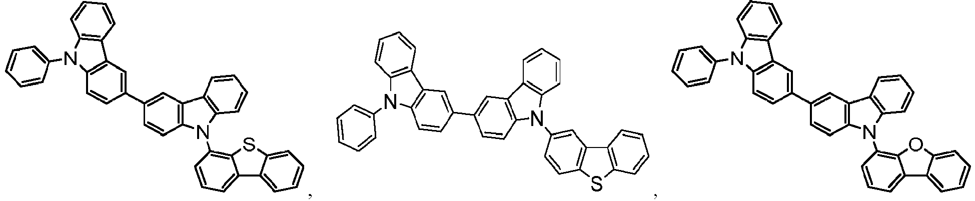

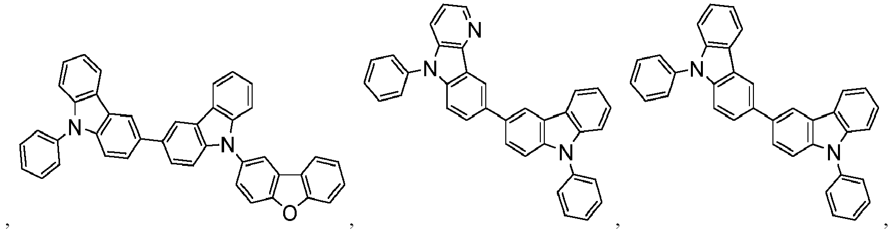

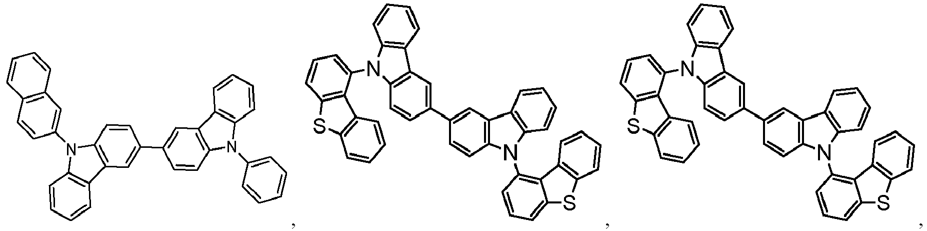

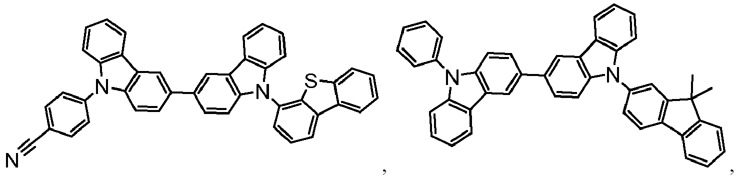

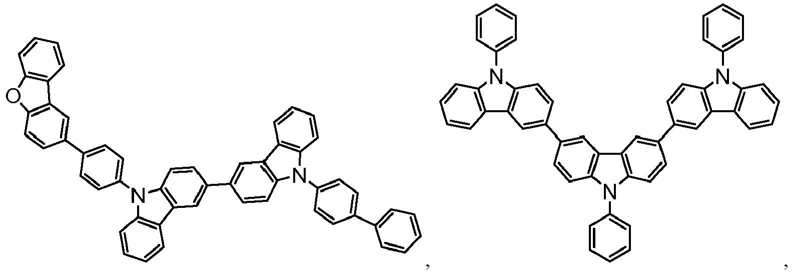

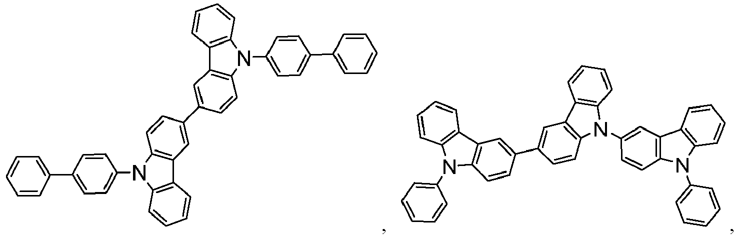

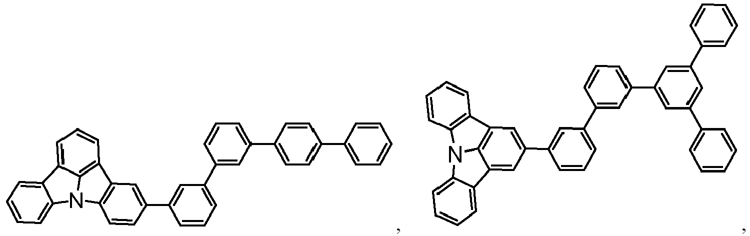

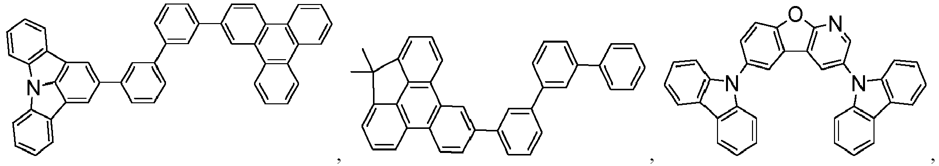

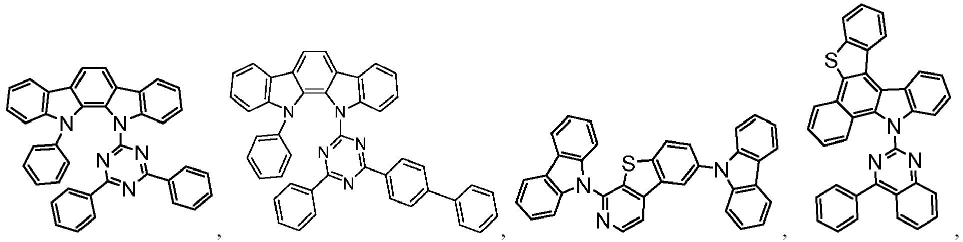

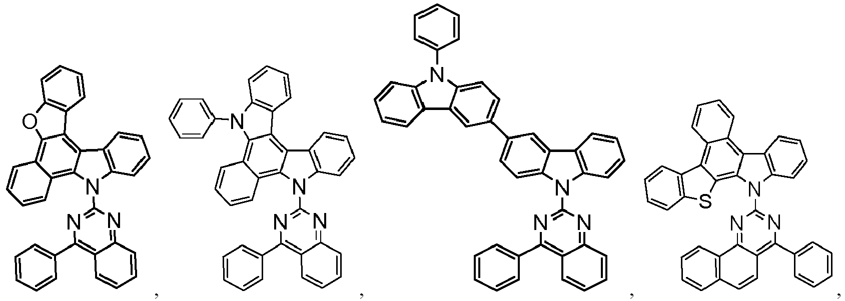

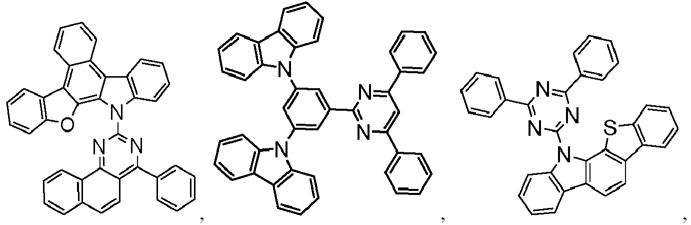

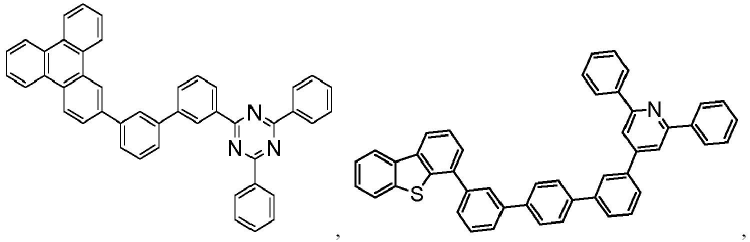

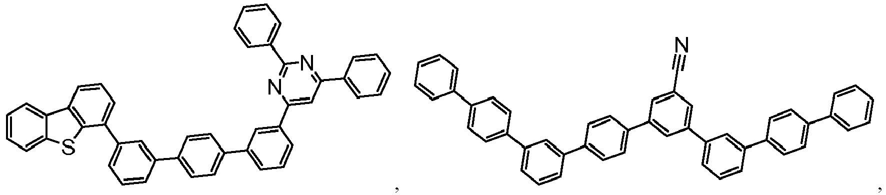

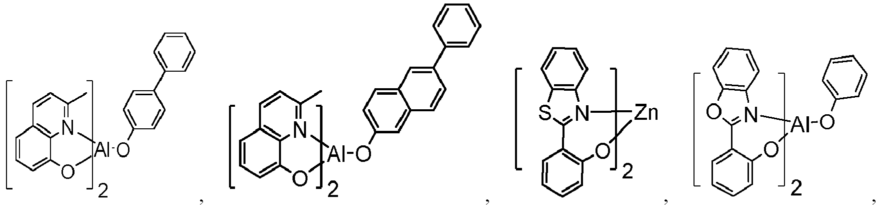

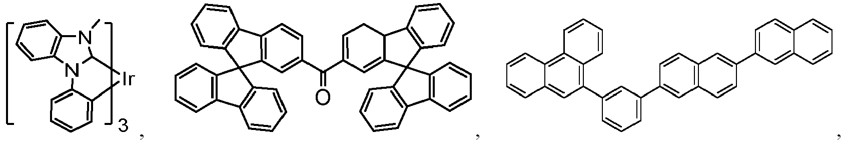

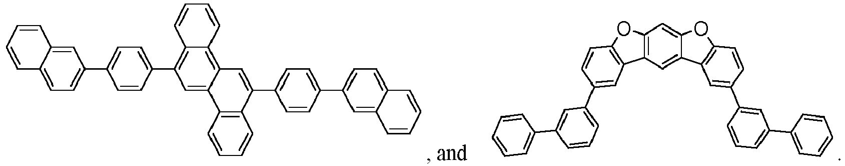

### e) Additional Emitters:

One or more additional emitter dopants may be used in conjunction with the compound of the present disclosure. Examples of the additional emitter dopants are not particularly limited, and any compounds may be used as long as the compounds are typically used as emitter materials. Examples of suitable emitter materials include, but are not limited to, compounds which can produce emissions via phosphorescence, fluorescence, thermally activated delayed fluorescence, i.e., TADF (also referred to as E-type delayed fluorescence), triplet-triplet annihilation, or combinations of these processes.
Non-limiting examples of the emitter materials that may be used in an OLED in combination with materials disclosed herein are exemplified below together with references that disclose those materials: CN103694277, CN1696137, EB01238981, EP01239526, EP01961743, EP1239526, EP1244155, EP1642951, EP1647554, EP1841834, EP1841834B, EP2062907, EP2730583, JP2012074444, JP2013110263, JP4478555, KR1020090133652, KR20120032054, KR20130043460, TW201332980, US06699599, US06916554, US20010019782, US20020034656, US20030068526, US20030072964, US20030138657, US20050123788, US20050244673, US2005123791, US2005260449, US20060008670, US20060065890, US20060127696, US20060134459, US20060134462, US20060202194, US20060251923, US20070034863, US20070087321, US20070103060, US20070111026, US20070190359, US20070231600, US2007034863, US2007104979, US2007104980, US2007138437, US2007224450, US2007278936, US20080020237, US20080233410, US20080261076, US20080297033, US200805851, US2008161567, US2008210930, US20090039776, US20090108737, US20090115322, US20090179555, US2009085476, US2009104472, US20100090591, US20100148663, US20100244004, US20100295032, US2010102716, US2010105902, US2010244004, US2010270916, US20110057559, US20110108822, US20110204333, US2011215710, US2011227049, US2011285275, US2012292601, US20130146848, US2013033172, US2013165653, US2013181190, US2013334521, US20140246656, US2014103305, US6303238, US6413656, US6653654, US6670645, US6687266, US6835469, US6921915, US7279704, US7332232, US7378162, US7534505, US7675228, US7728137, US7740957, US7759489, US7951947, US8067099, US8592586, US8871361, WO06081973, WO06121811, WO07018067, WO07108362, WO07115970, WO07115981, WO08035571, WO2002015645, WO2003040257, WO2005019373, WO2006056418, WO2008054584, WO2008078800, WO2008096609, WO2008101842, WO2009000673, WO2009050281, WO2009100991, WO2010028151, WO2010054731, WO2010086089, WO2010118029, WO2011044988, WO2011051404, WO2011107491, WO2012020327, WO2012163471, WO2013094620, WO2013107487, WO2013174471, WO2014007565, WO2014008982, WO2014023377, WO2014024131, WO2014031977, WO2014038456, WO2014112450. 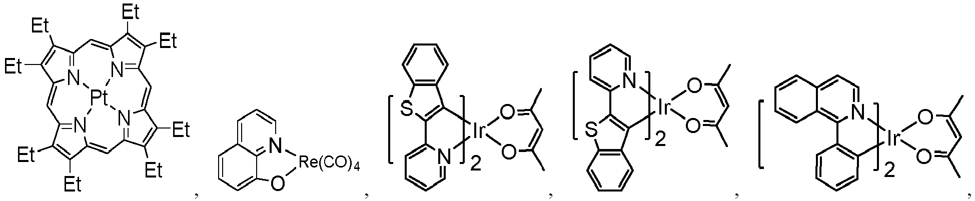 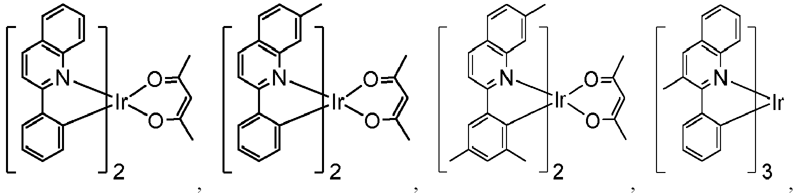 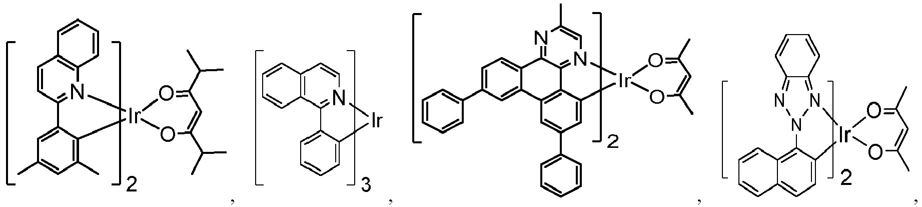 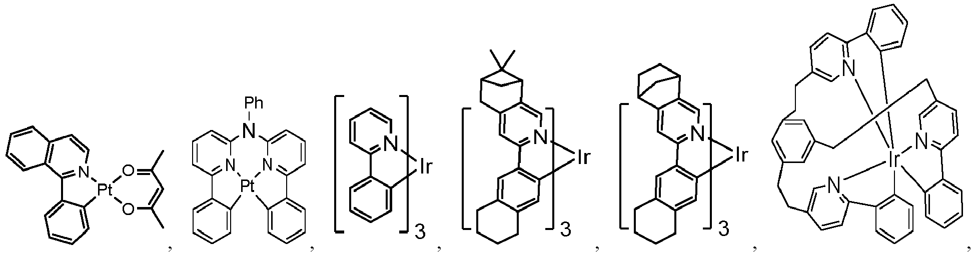 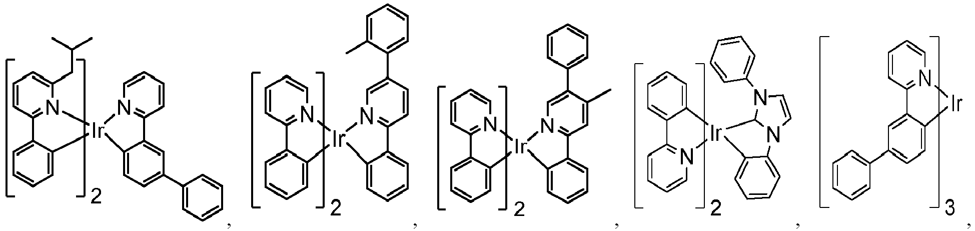 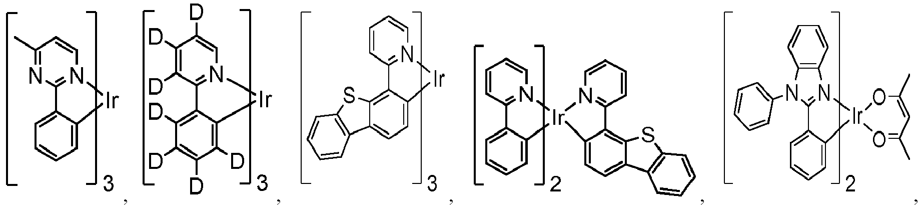 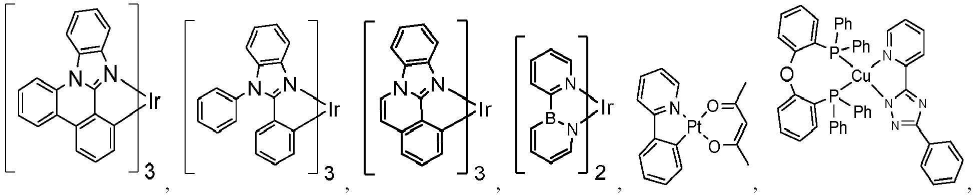 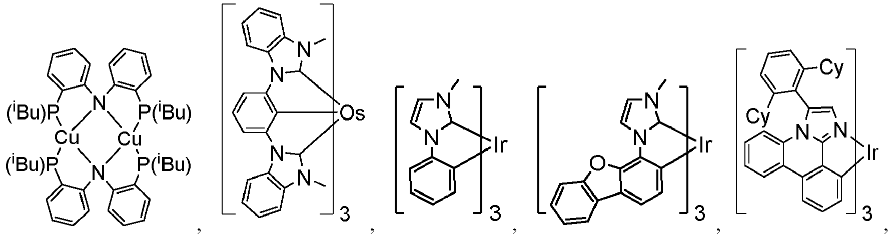 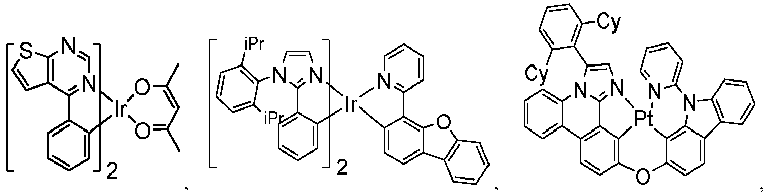 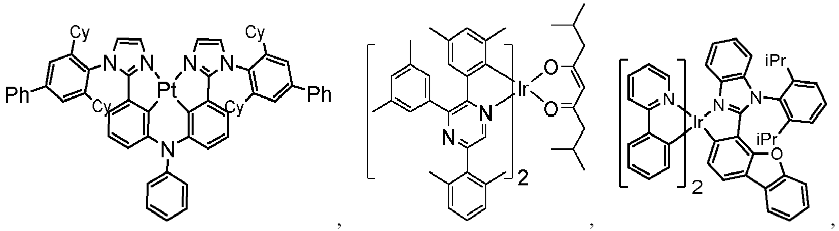 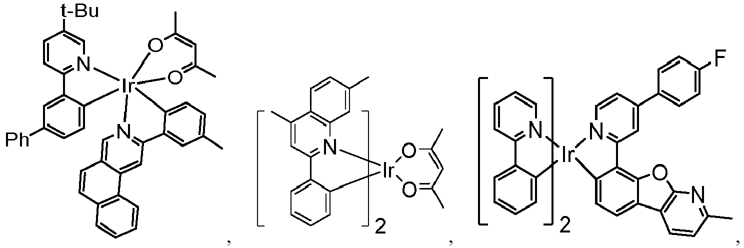 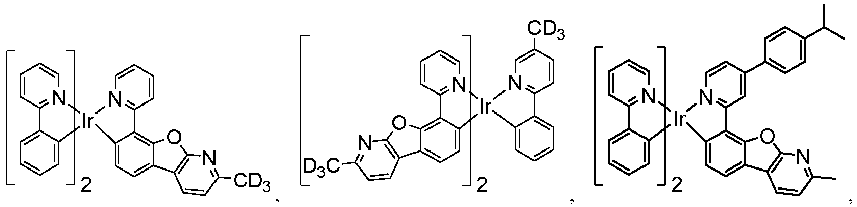 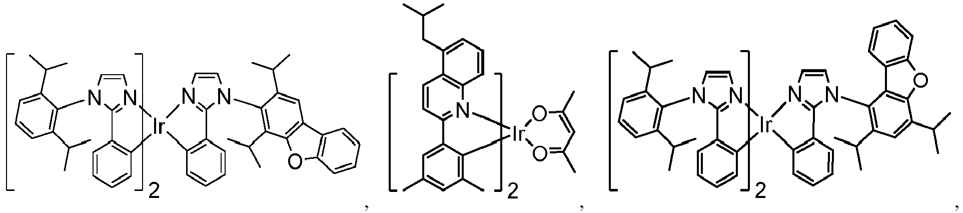 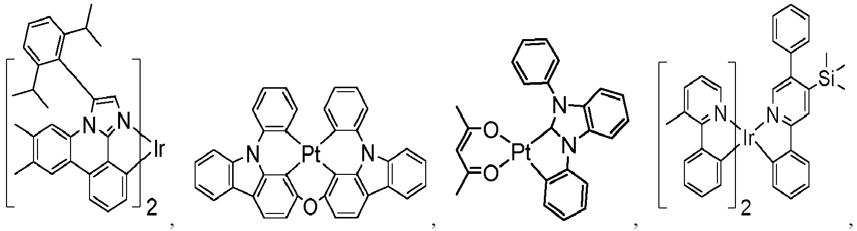 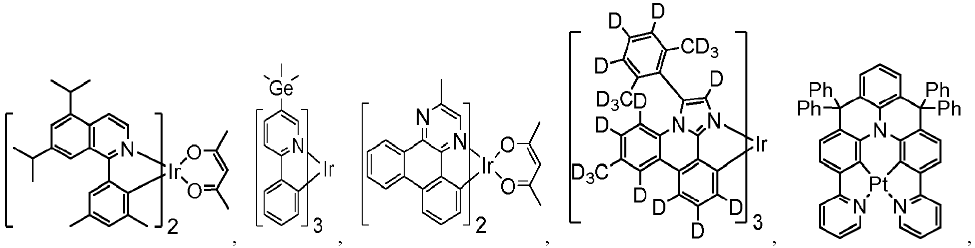 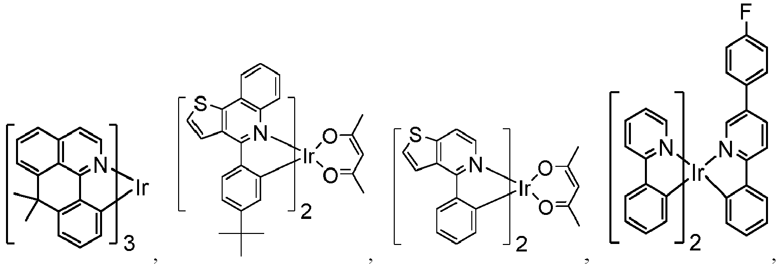 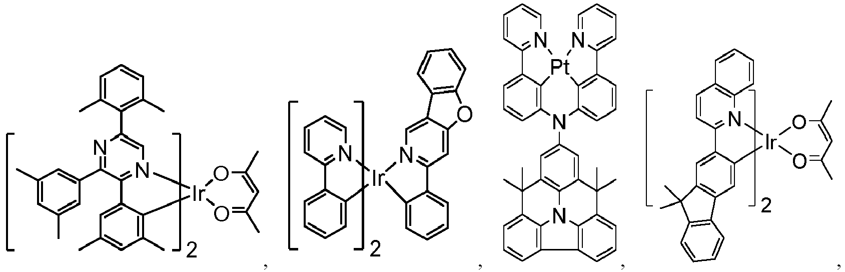 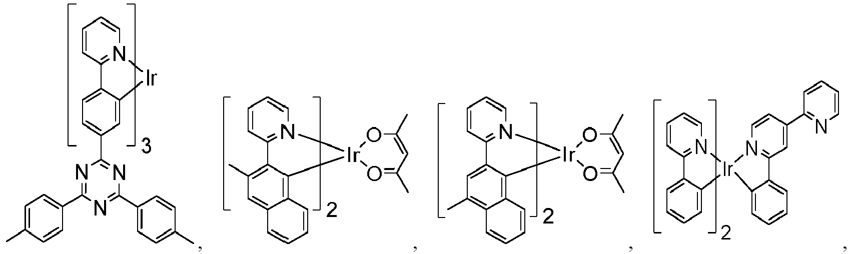 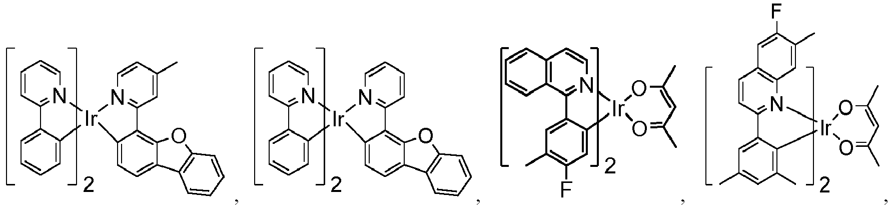 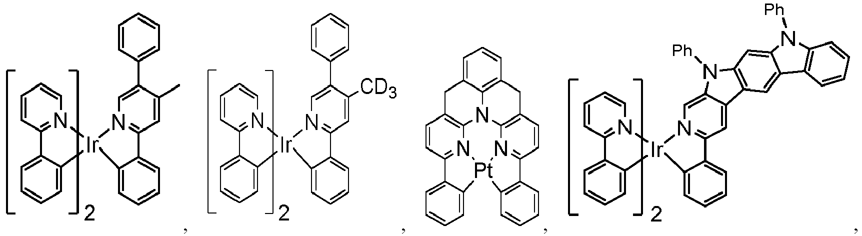 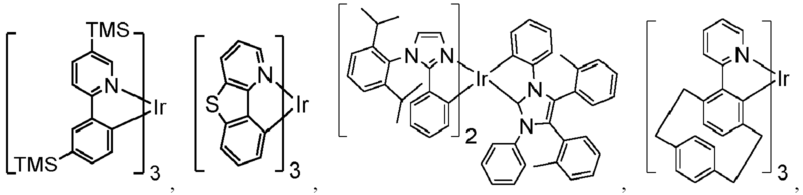 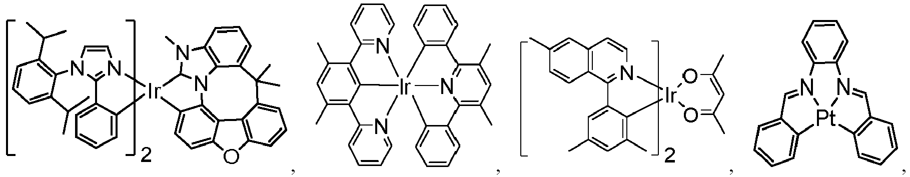 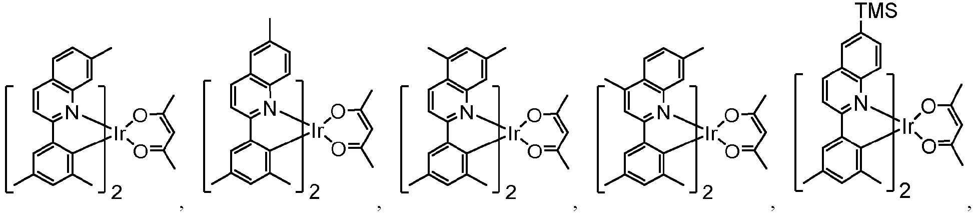 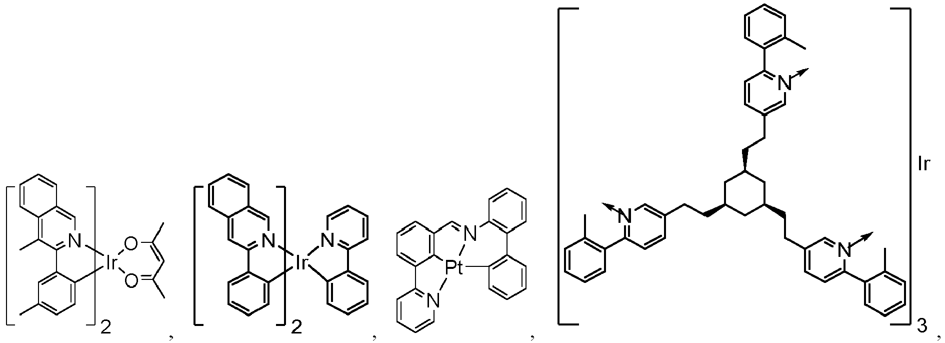 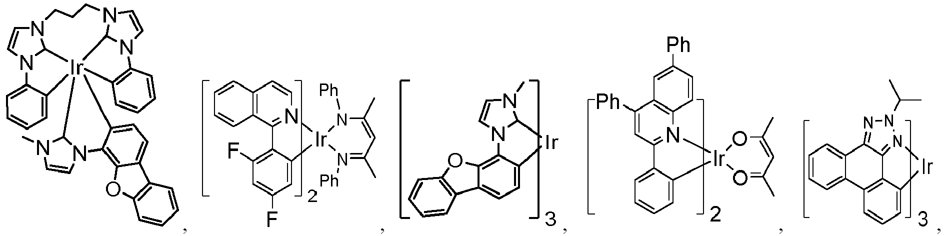 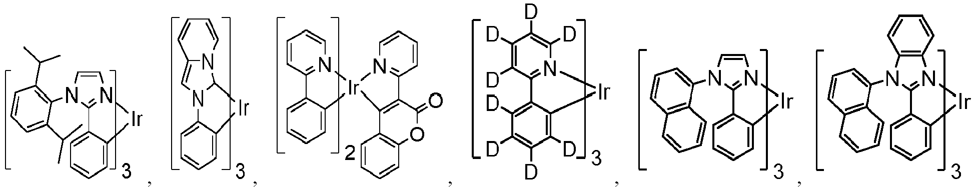 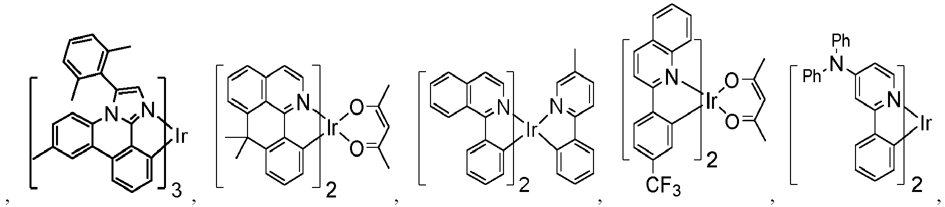 and

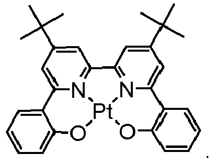

### f) HBL:

A hole blocking layer (HBL) may be used to reduce the number of holes and/or excitons that leave the emissive layer. The presence of such a blocking layer in a device may result in substantially higher efficiencies and/or longer lifetime as compared to a similar device lacking a blocking layer. Also, a blocking layer may be used to confine emission to a desired region of an OLED. In some embodiments, the HBL material has a lower HOMO (further from the vacuum level) and/or higher triplet energy than the emitter closest to the HBL interface. In some embodiments, the HBL material has a lower HOMO (further from the vacuum level) and/or higher triplet energy than one or more of the hosts closest to the HBL interface.

In one aspect, compound used in HBL contains the same molecule or the same functional groups used as host described above.

In another aspect, compound used in HBL contains at least one of the following groups in the molecule: 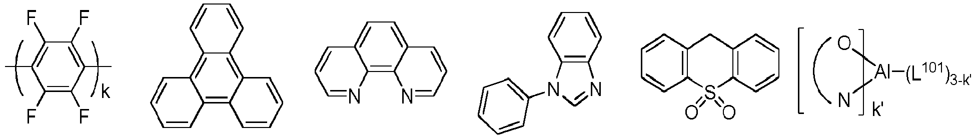 wherein k is an integer from 1 to 20; L¹⁰¹ is another ligand, k' is an integer from 1 to 3.

### g) ETL:

Electron transport layer (ETL) may include a material capable of transporting electrons. Electron transport layer may be intrinsic (undoped), or doped. Doping may be used to enhance conductivity. Examples of the ETL material are not particularly limited, and any metal complexes or organic compounds may be used as long as they are typically used to transport electrons.

In one aspect, compound used in ETL contains at least one of the following groups in the molecule: 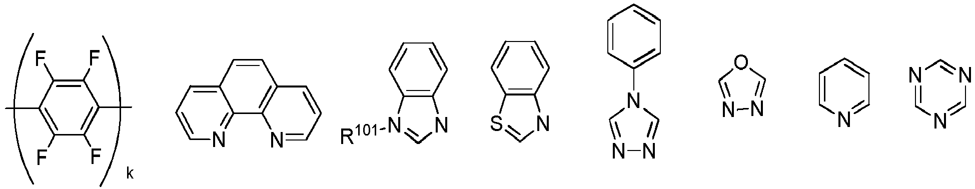 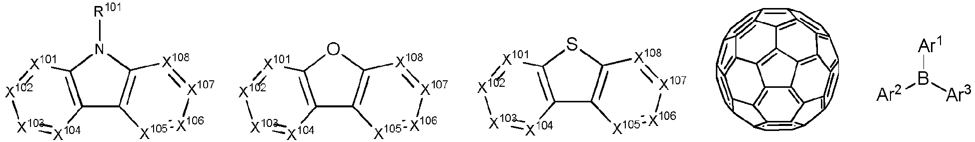 wherein R¹⁰¹ is selected from the group consisting of hydrogen, deuterium, halogen, alkyl, cycloalkyl, heteroalkyl, heterocycloalkyl, arylalkyl, alkoxy, aryloxy, amino, silyl, alkenyl, cycloalkenyl, heteroalkenyl, alkynyl, aryl, heteroaryl, acyl, carboxylic acids, ether, ester, nitrile, isonitrile, sulfanyl, sulfinyl, sulfonyl, phosphino, and combinations thereof, when it is aryl or heteroaryl, it has the similar definition as Ar's mentioned above. Ar¹ to Ar³ has the similar definition as Ar's mentioned above. k is an integer from 1 to 20. X¹⁰¹ to X¹⁰⁸ is selected from C (including CH) or N.

In another aspect, the metal complexes used in ETL contains, but not limit to the following general formula: 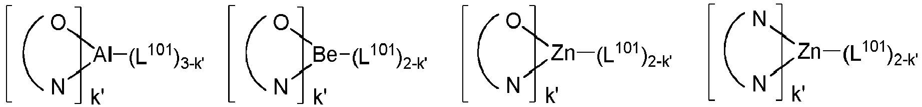 wherein (O-N) or (N-N) is a bidentate ligand, having metal coordinated to atoms O, N or N, N; L¹⁰¹ is another ligand; k' is an integer value from 1 to the maximum number of ligands that may be attached to the metal.

Non-limiting examples of the ETL materials that may be used in an OLED in combination with materials disclosed herein are exemplified below together with references that disclose those materials: CN103508940, EP01602648, EP01734038, EP01956007, JP2004-022334, JP2005149918, JP2005-268199, KR0117693, KR20130108183, US20040036077, US20070104977, US2007018155, US20090101870, US20090115316, US20090140637, US20090179554, US2009218940, US2010108990, US2011156017, US2011210320, US2012193612, US2012214993, US2014014925, US2014014927, US20140284580, US6656612, US8415031, WO2003060956, WO2007111263, WO2009148269, WO2010067894, WO2010072300, WO2011074770, WO2011105373, WO2013079217, WO2013145667, WO2013180376, WO2014104499, WO2014104535,

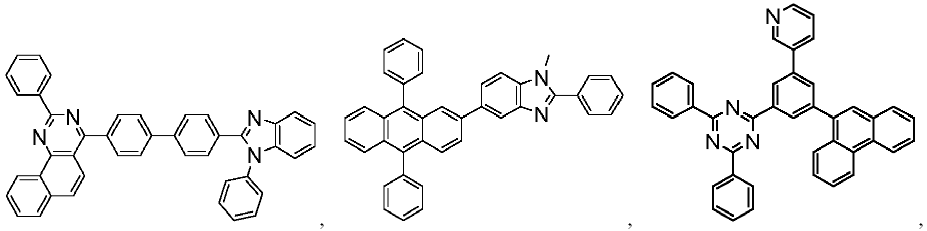

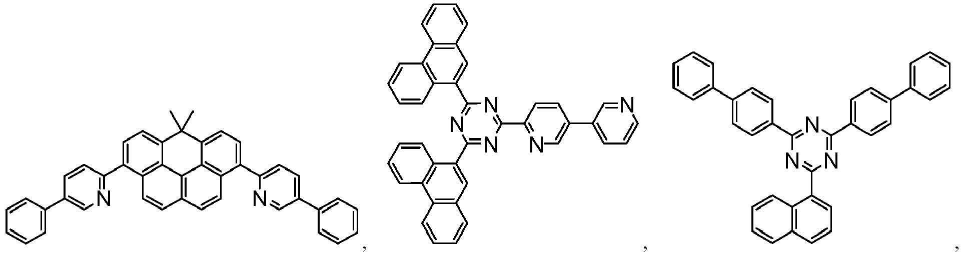

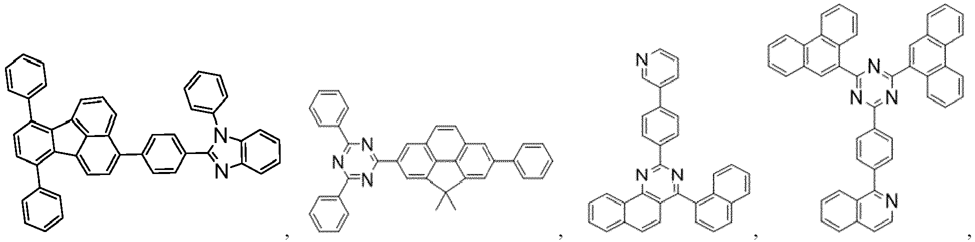

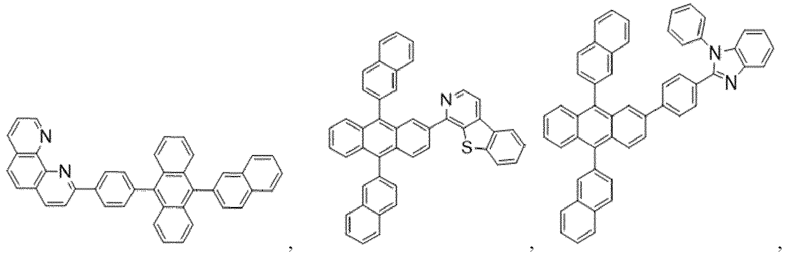

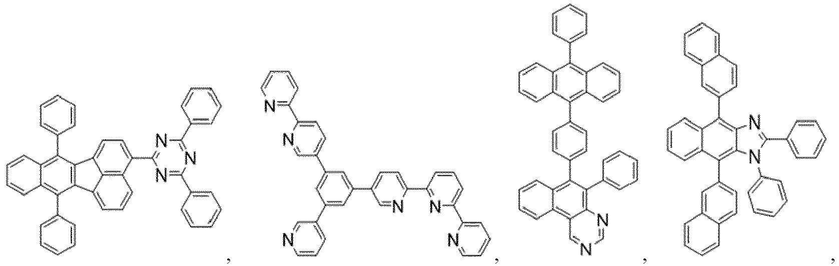

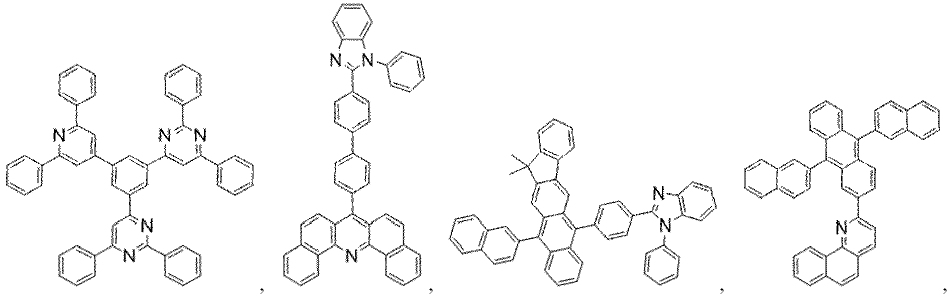

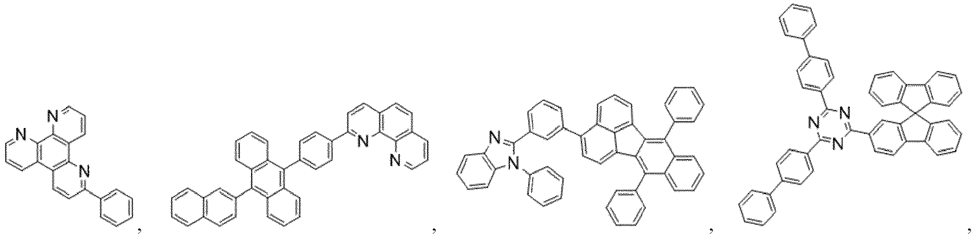

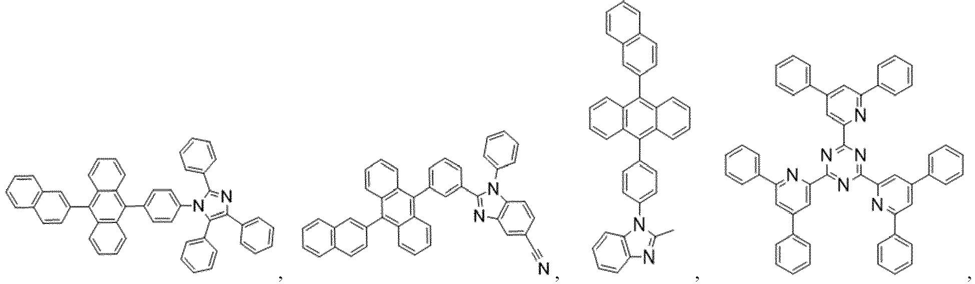

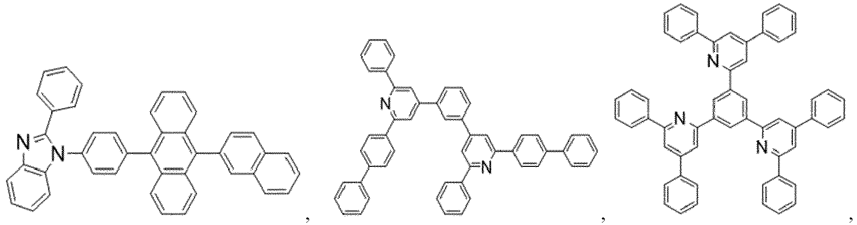

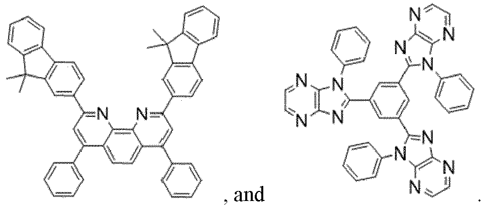

### h) Charge generation layer (CGL)

In tandem or stacked OLEDs, the CGL plays an essential role in the performance, which is composed of an n-doped layer and a p-doped layer for injection of electrons and holes, respectively. Electrons and holes are supplied from the CGL and electrodes. The consumed electrons and holes in the CGL are refilled by the electrons and holes injected from the cathode and anode, respectively; then, the bipolar currents reach a steady state gradually. Typical CGL materials include n and p conductivity dopants used in the transport layers.

In any above-mentioned compounds used in each layer of the OLED device, the hydrogen atoms can be partially or fully deuterated. The minimum amount of hydrogen of the compound being deuterated is selected from the group consisting of 30%, 40%, 50%, 60%, 70%, 80%, 90%, 95%, 99%, and 100%. Thus, any specifically listed substituent, such as, without limitation, methyl, phenyl, pyridyl, etc. may be undeuterated, partially deuterated, and fully deuterated versions thereof. Similarly, classes of substituents such as, without limitation, alkyl, aryl, cycloalkyl, heteroaryl, etc. also may be undeuterated, partially deuterated, and fully deuterated versions thereof.

It is understood that the various embodiments described herein are by way of example only and are not intended to limit the scope of the invention. For example, many of the materials and structures described herein may be substituted with other materials and structures without deviating from the spirit of the invention. The present invention as claimed may therefore include variations from the particular examples and preferred embodiments described herein, as will be apparent to one of skill in the art. It is understood that various theories as to why the invention works are not intended to be limiting.

### Experimental Data

Synthesis of Inventive Compound 1

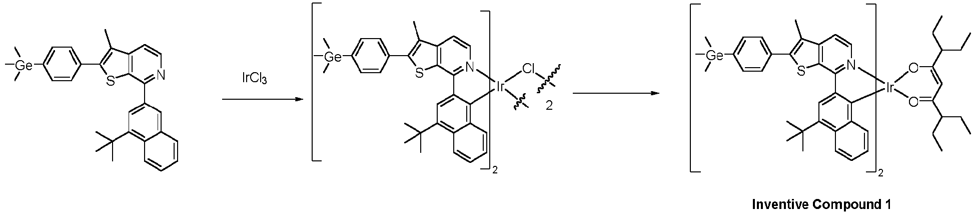

To a 100 mL round bottom flask, 7-(4-(tert-butyl)naphthalen-2-yl)-3-methyl-2-(4-(trimethylgermyl) phenyl)thieno[2,3-c]pyridine (1.766 g, 3.37 mmol), iridium chloride (0.54 g, 1.531 mmol), 2-ethoxyethanol (39 ml), and Water (13.00 ml) were added. The reaction mixture was heated at reflux overnight under nitrogen. After reaction, the mixture was diluted with methanol, a red solid was filtered and used directly in next step. To a 100 mL round bottom flask, the red solid from the previous step, 3,7-diethylnonane-4,6-dione (0.654 g, 3.08 mmol), DCM (25 ml), Methanol (25.00 ml), and lastly potassium carbonate (0.426 g, 3.08 mmol) were added. The mixture was heated to 40 °C overnight under nitrogen. After reaction, the mixture was diluted with DCM (dichloromethane), and filtered through Celite (diatomaceous earth) and washed with DCM. After the filtrate wsa evaporated, the residue was purified on a silica gel column eluting with 30% DCM/heptane to give 1.38 g product.

Synthesis of Inventive Compound 2 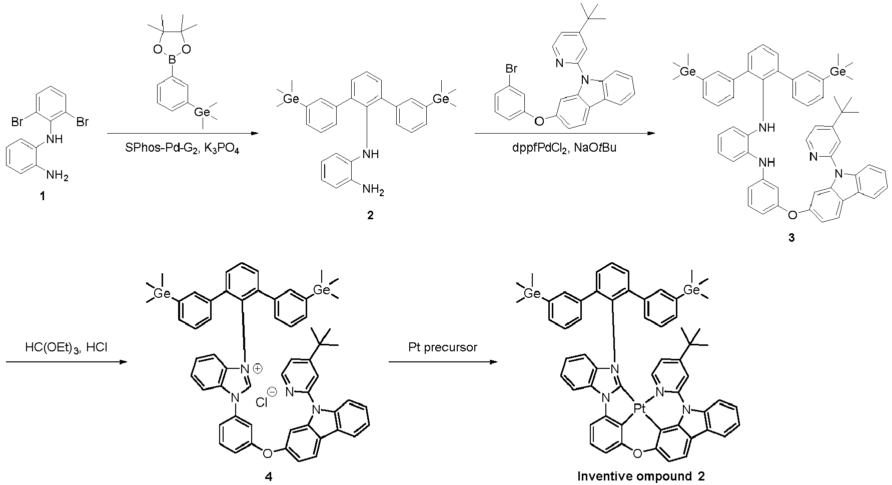 The Inventive Compound 2 can be synthesized using the known starting material 1 reacting with the germyl-containing boronic ester, trimethyl(3-(4,4,5,5-tetramethyl-1,3,2-dioxaborolan-2-yl)phenyl)germane, which can be obtained using the literature procedure reported in J. Organomet. Chem. 2003, 671, 113-119. The Inventive Compound 2 can then be obtained by following the procedures disclosued in US patent application publication No. 20200216481, and the entire contents of the above references are incorporated herein by reference.

### Synthesis of 7-bromodibenzo[b,d]furan-4-carbaldehyde

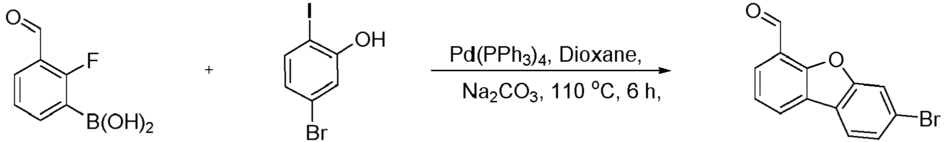

A mixture of (2-fluoro-3-formylphenyl)boronic acid (11.0 g, 65.5 mmol)), 5-bromo-2-iodophenol (14 g, 46.8 mmol), Pd(Ph₃P)₄ (2.70 g, 2.336 mmol) was suspended in dioxane (150 mL) and aq. 2 M sodium carbonate (58.5 mL, 117 mmol) was added under N₂. The reaction mixture was then heated to 110 °C for 6 hours, then cooled to RT (room temperature), diluted with EtOAc (200 mL), washed with water (200 mL), the phases separated and the aqueous further extracted with EtOAc (200 mL). The combined organics were washed with brine (100 mL), dried over Na₂SO₄, filtered, and concentrated in vacuo to give a brown oil. The crude product was purified by chromatography on silica gel (silica dry load, 24 g cartridge, 0-15% EtOAc/isohexane) to afford 7-bromodibenzo[b,d]furan-4-carbaldehyde (4.2 g, 14.96 mmol, 31.9 % yield) as a white solid.

### Synthesis of 4-bromo-2,6-diisopropyl-N-(2-nitrophenyl)aniline

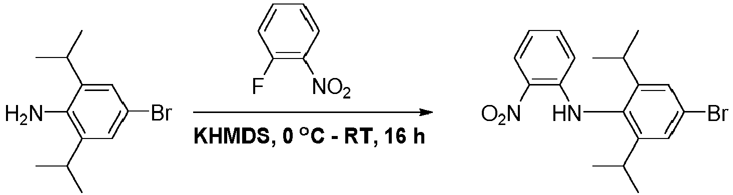

To a mixture of 4-bromo-2,6-diisopropylaniline (12 g, 46.8 mmol) and 1-fluoro-2-nitrobenzene (5.5 mL, 52.2 mmol) in dioxane (200 mL), KHMDS (1M in THF, 103 ml, 103 mmol) was added dropwise at 0 °C over 20 min. The reaction mixture was stirred at RT for 16 hours then quenched with water (200 mL) and extracted with ethyl acetate (3 x 100 mL). The organic layer was washed with brine (100 mL), dried over Na₂SO₄ and concentrated under reduced pressure. The crude product was purified by chromatography on silica gel (silica dry load, 120 g cartridge, 0-15% EtOAc/isohexane) to afford 4-bromo-2,6-diisopropyl-N-(2-nitrophenyl)aniline (14.1 g, 36.6 mmol, 78 % yield) as an orange solid.

### Synthesis of N1-(4-bromo-2,6-diisopropylphenyl)benzene-1,2-diamine)aniline

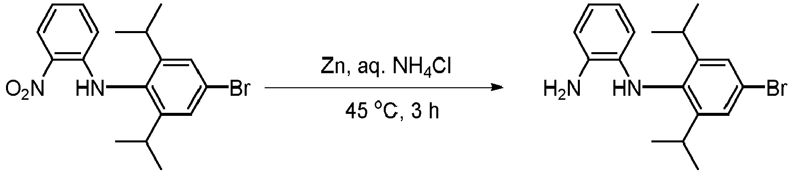

To a solution of 4-bromo-2,6-diisopropyl-N-(2-nitrophenyl)aniline (10 g, 25.2 mmol) in methanol (100 mL) was added zinc powder (10 g, 153 mmol) followed by the dropwise addition of a solution of ammonium chloride (6.73 g, 126 mmol) in water (30 mL) at RT. The reaction mixture was stirred vigorously at 45 °C for 3 hours and filtered through a Celite pad. The Celite pad was washed with EtOAc (100 mL) and the aqueous phase was extracted with EtOAc (3 x 150 mL). The combined organic layers were dried (MgSO₄) and concentrated. The crude product was purified by chromatography on silica gel (silica dry load, 220 g cartridge, 0-20% EtOAc/isohexane) to afford N1-(4-bromo-2,6-diisopropylphenyl)benzene-1,2-diamine (15.83 g, 43.3 mmol, 86 % yield) as a blue solid.

### Synthesis of N1-(3,5-diisopropyl-[1,1':4',1"-terphenyl]-4-yl)benzene-1,2-diamine

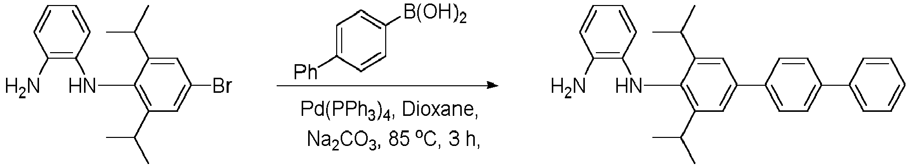

N1-(4-Bromo-2,6-diisopropylphenyl)benzene-1,2-diamine (7.5 g, 20.52 mmol), [1,1'-biphenyl]-4-ylboronic acid (8.5 g, 42.9 mmol), aq. 2 M sodium carbonate (25 mL, 50.0 mmol) were added to dioxane (75 mL) and the reaction mixture was purged with nitrogen for 5 minutes. Pd(Ph₃P)₄ (2.0 g, 1.731 mmol) was added and the reaction mixture was purged with nitrogen for 5 minutes and was then heated to 85 °C for 3 hours, cooled to RT, diluted with EtOAc (150 mL), washed with water (100 mL), the phases separated and the aqueous further extracted with EtOAc (200 mL). The combined organics were washed with brine (100 mL), dried over Na₂SO₄, filtered, and concentrated *in vacuo* to give a brown oil. The crude product was purified by chromatography on silica gel (silica dry load, 220 g cartridge, 0-50% EtOAc/isohexane) to afford N1-(3,5-diisopropyl-[1,1':4',1"-terphenyl]-4-yl)benzene-1,2-diamine (6.5 g, 14.68 mmol, 71.6 % yield) as a blue solid.

### Synthesis of 2-(7-bromodibenzo[b,d]furan-4-yl)-1-(3,5-diisopropyl-[1,1':4',1"-terphenyl]-4-yl)-1H-benzo[d]imidazole

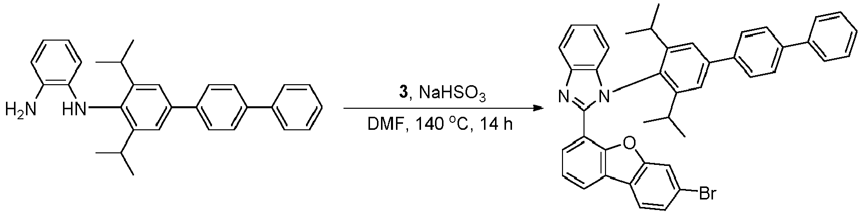

To a stirred solution of 7-bromodibenzo[b,d]furan-4-carbaldehyde (2.62 g, 9.51 mmol) and N1-(3,5-diisopropyl-[1,1':4',1"-terphenyl]-4-yl)benzene-1,2-diamine (4.0 g, 9.51 mmol) in DMF (40 mL) was added sodium bisulfite (6.5 g, 62.5 mmol) and the reaction mixture was heated at 120 °C for 16 hours. The reaction mixture was poured into water (100 mL) and extracted with ethyl acetate (3 x 100 mL). The combined organics were combined with a similarly prepared batch, washed with 50% brine (2 x 100 mL), dried over Na₂SO₄ and concentrated. The crude product was purified with by flash chromatography (silica dry load, 220 g column, 0-50 % ethyl acetate/iso-hexane) then further chromatography (silica dry load, 220 g column, 20-100 % DCM/hexane) to give 2-(7-Bromodibenzo[b,d]furan-4-yl)-1-(3,5-diisopropyl-[1,1':4',1"-terphenyl]-4-yl)-1H-benzo[d]imidazole (12.6 g, 65%) as a white solid.

### Synthesis of 6-(1-(3,5-diisopropyl-[l,l':4',1"-terphenyl]-4-yl)-1H-benzo[d]imidazol-2-yl)dibenzo[b,d]furan-3-carbonitrile

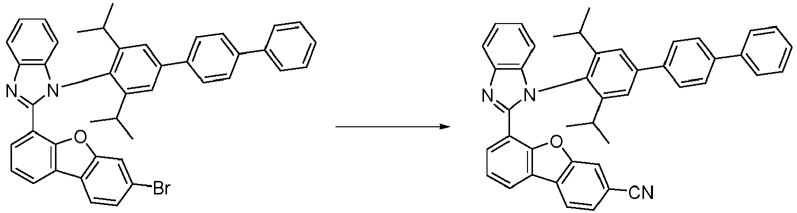

A mixture of 2-(7-bromodibenzo[b,d]furan-4-yl)-1-(3,5-diisopropyl-[1,1':4',1"-terphenyl]-4-yl)-1H-benzo[d]imidazole (5.0 g, 7.40 mmol), potassium hexacyanoferrate(II) trihydrate (1.561 g, 3.70 mmol), potassium acetate (0.725 g, 7.40 mmol), X-Phos Pd Gen2 (0.699 g, 0.888 mmol) and X-Phos (0.881 g, 1.850 mmol) in 100 mL Schlenk flask was degassed by vacuum-N₂ cycles for three times. Dioxane (36 ml) and water (12 ml) were added, and the reaction was heated to 100 °C for 96 hours. This crude was purified by column chromatography, eluting with 25-30% THF/ heptanes, yielding 1.97 g of white solid.

### Synthesis of 2-(4-Fluorophenyl)-4,5-bis(methyl-d₃)pyridine (F-ppy)

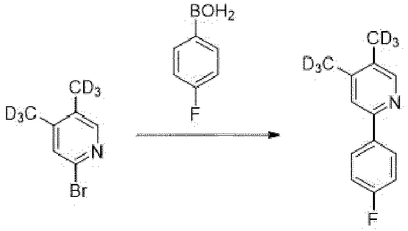

To a solution of 2-bromo-4,5-bis(methyl-d3)pyridine (8.0 g, 41.6 mmol) and (4-fluorophenyl)(14-oxidaneylidene)borane (6.45 g, 52.1 mmol) in DME (210 ml) was added potassium carbonate (11.51 g, 83 mmol) and Water (70.0 ml). The reaction was purged with nitrogen for 15 min then Pd(PPh₃)₄ (1.93 g, 1.67 mmol) was added. The reaction was heated in an oil bath set at 95 °C for 36 hours under nitrogen. The reaction mixture was extracted with EtOAc, then the organic phase was washed with brine 2x, dried with sodium sulfate, filtered and concentrated down to a purple solid. The purple solid was purified by column chromatography, eluting with 50/47.5/2.5 to 50/40/10 DCM/heptane/EtOAc to afford 6.8 g of white solid as the desired product.

### Synthesis of [(F-ppy)₂IrCl]₂

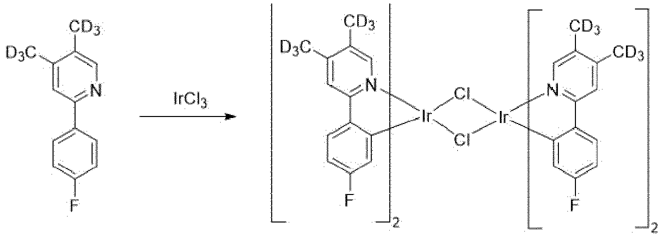

A solution of 2-(4-fluorophenyl)-4,5-bis(methyl-d3)pyridine (6.79 g, 32.8 mmol) and iridium(III) chloride hydrate (5.50 g, 15.60 mmol) in 2-ethoxyethanol (120 mL) and water (40 mL) was degassed with N₂ for 10 minutes. The mixture was heated at 100 °C for 18 hours. After cooling the reaction to RT, MeOH was added and the solid was filtered and washed with MeOH to give 7.82 g of yellow solid.

### Synthesis of solvento-[(F-ppy)zIr]Otf

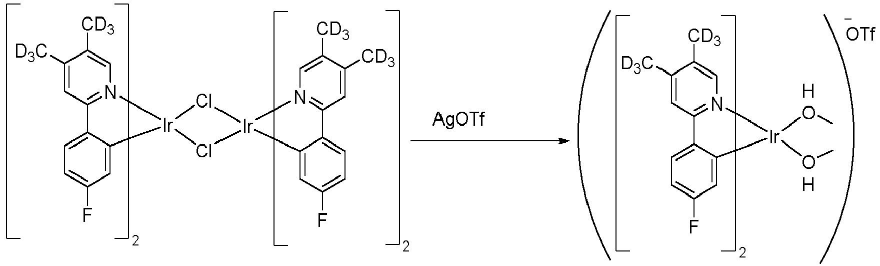

A solution of silver triflate (3.29 g, 12.79 mmol) in MeOH (17.48 ml) was added to a solution of [(F-ppy)₂IrCl]₂ (7.80 g, 6.09 mmol) in DCM (87 ml) in a flask wrapped with aluminum foil to exclude light. The reaction mixture was stirred at RT for 18 hours. The solution was filtered through a pad of Celite, rinsing the flask and pad with dichloromethane (100 mL). The yellow filtrate was concentrated under reduced pressure and the solid dried under vacuum at 40 °C for 4 hours to give 7.84 g of yellow solid.

### Synthesis of the comparative example 2

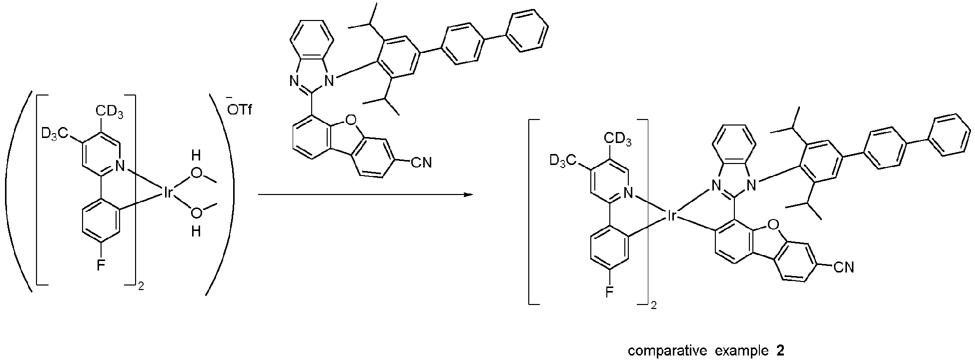

To a solution of solvento-[(F-ppy)₂Ir]OTf (1.32 g, 1.61 mmol) and 6-(1-(3,5-diisopropyl-[1,1':4',1"-terphenyl]-4-yl)-1H-benzo[d]imidazol-2-yl)dibenzo[b,d]furan-3-carbonitrile (1.00 g, 1.61 mmol) in 2-ethoxyethanol (54 ml) was added 2,6-dimethylpyridine (0.37 ml, 3.22 mmol). The reaction was heated to 100 °C for 2 days. After cooling down, the volatiles were removed under vacuum, and the resulting residue was purified by column chromatography, eluting with toluene/heptane = 80/20 to give 0.28 g of yellow solid.

### Synthesis of 5-bromo-2-(4-fluorophenyl)pyridine

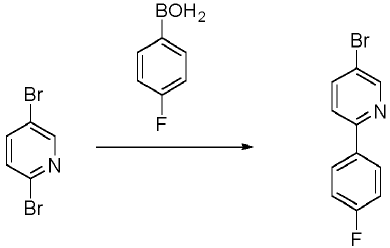

To a solution of 2,5-dibromopyridine (50.0 g, 211.1 mmol) and (4-fluorophenyl)boronic acid (31.0 g, 221.6 mmol) in acetonitrile (700 ml) and methanol (350 ml) was added potassium carbonate (72.9 g, 527.7 mmol). The reaction was purged with nitrogen for 15 minutes then Pd(PPh₃)₄ (12.2 g, 10.6 mmol) was added. The reaction was heated in an oil bath set at 50 °C for 24 hours under nitrogen. The reaction mixture was extracted with dichloromethane, then the organic phase was washed with brine (100 ml), dried with sodium sulfate, filtered and concentrated down to a solid. The solid was purified by column chromatography, eluting with 0 to 15% DCM in heptane to afford 38 g of white solid as the desired product.

### Synthesis of 2-(4-fluorophenyl)-5-(trimethylgermyl)pyridine (TMG-ppy-F)

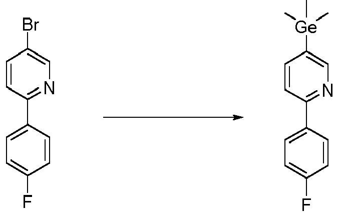

Under a nitrogen atmosphere, *n*-butyllithium (3.5 mL, 2.500 molar, 8.747 mmol) was added dropwise to a solution of 5-bromo-2-(4-fluorophenyl)pyridine (2.100 g, 8.330 mmol) in anhydrous tetrahydrofuran (56 mL) at -78 °C. After the reaction was stirred at -78 °C for 5 minutes, chlorotrimethylgermane (2.552 g, 2.06 mL, 16.66 mmol) was added, and the reaction mixture was allowed to warm to RT and stirred for another 18 hours. The reaction mixture was extracted with ethyl acetate, then the organic phase was washed with brine (50 ml), dried with sodium sulfate, filtered and concentrated down to a solid. The solid was purified by column chromatography, eluting with 5 to 10% ethyl acetate in heptane to afford 2.18 g of white solid as the desired product.

### Synthesis of [(TMG-ppy-F)₂IrCl]₂

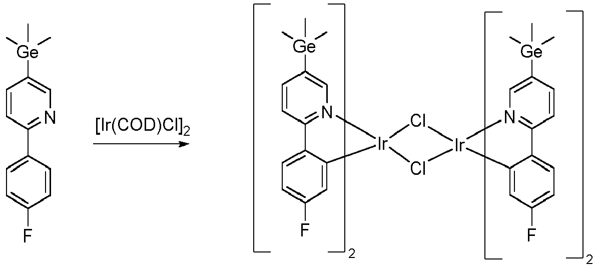

A solution of 2-(4-fluorophenyl)-5-(trimethylgermyl)pyridine (2.18 g, 7.52 mmol) and chloro(1,5-cyclooctadiene)iridium(I) dimer (1.23 g, 1.83 mmol) in 2-ethoxyethanol (10 mL) was degassed with N₂ for 10 minutes. The mixture was heated at 100 °C for 18 hours. After cooling the reaction to RT, water was added and the solid was filtered and washed with MeOH to give 2.68 g of yellow solid.

### Synthesis of the inventive example 3

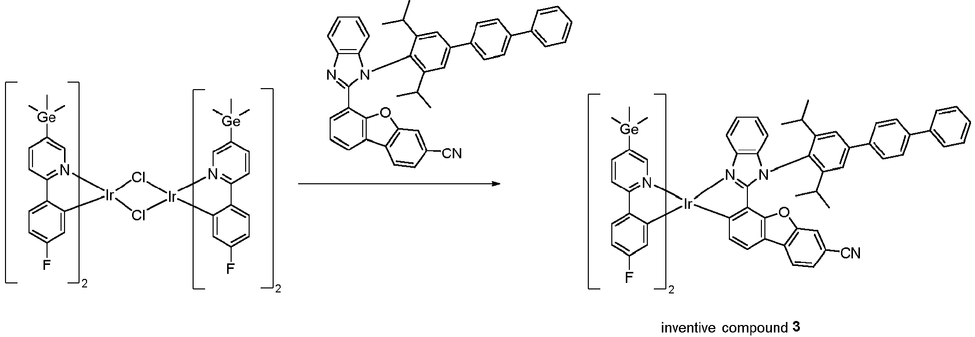

To a solution of [(TMG-ppy-F)₂IrCl]₂ (0.88 g, 0.55 mmol) and 6-(1-(3,5-diisopropyl-[1,1':4',1"-terphenyl]-4-yl)-1H-benzo[d]imidazol-2-yl)dibenzo[b,d]furan-3-carbonitrile (0.68 g, 1.09 mmol) in a mixture of 2-ethoxyethanol (1 ml) and DMF (1 mL) was added potassium acetate (0.16 g, 1.64 mmol). The reaction was heated to 140 °C for 24 hours. After cooling down, the volatiles were removed under vacuum, and the resulting residue was photoisomerized in 15 mL of THF. The reaction mixture was filtered through a pad of Celite^{®}, rinsing with dichloromethane until all yellow product eluted. The filtrate was concentrated under reduced pressure. The crude was purified by silica gel chromatography, eluting with 20% toluene in heptanes. The residue was dissolved in dichloromethane (10 mL) and precipitated with methanol (20 mL). The solid was filtered and dried in a vacuum oven at 50 °C give 0.23 g of yellow solid.

### Device Examples

The following devices were fabricated by high vacuum (<10⁻⁷ Torr) thermal evaporation. The anode electrode was 1,200 Å of indium tin oxide (ITO). The cathode consisted of 10 Å of Liq (8-hydroxyquinoline lithium) followed by 1,000 Å of Al. All devices were encapsulated with a glass lid sealed with an epoxy resin in a nitrogen glove box (<1 ppm of H₂O and O₂) immediately after fabrication, and a moisture getter was incorporated inside the package. The organic stack of the device examples consisted of sequentially, from the ITO surface, 100Å of LG101 (purchased from LG Chem) as the hole injection layer (HIL); 400 Å of HTM as a hole transporting layer (HTL); 50 Å of EBM as a electron blocking layer (EBL); 400 Å of an emissive layer (EML) containing RH and 18% RH2 as red host and 3% of emitter, and 350 Å of Liq (8-hydroxyquinolinelithium) doped with 35% of ETM as the electron transporting layer (ETL). Table 1 shows the thickness of the device layers and materials.

**Table 1. Device layer materials and thicknesses**

| Layer | Material | Thickness [Å] |
|---|---|---|
| Anode | ITO | 1,200 |
| HIL | LG101 | 100 |
| HTL | HTM | 400 |
| EBL | EBM | 50 |
| EML | RH1:RH2 18%: Red emitter 3% | 400 |
| ETL | Liq: ETM 35% | 350 |
| EIL | Liq | 10 |
| Cathode | Al | 1,000 |

The chemical structures of the device materials are shown below:

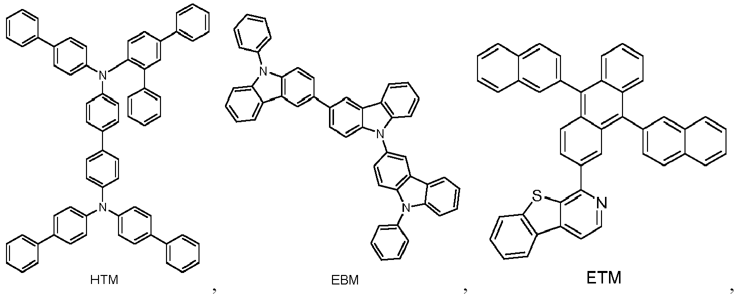

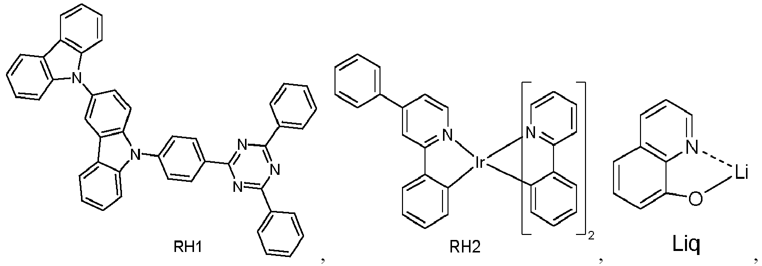

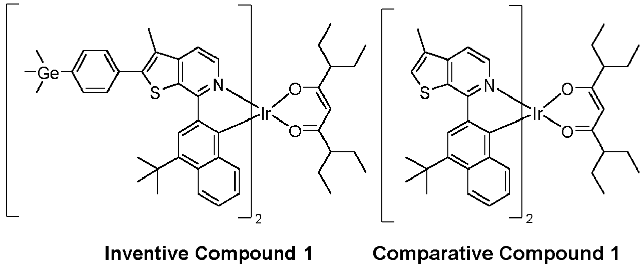

Upon fabrication devices have been EL and JVL tested. For this purpose, the sample was energized by the 2 channel Keysight B2902A SMU at a current density of 10 mA/cm² and measured by the Photo Research PR735 Spectroradiometer. Radiance (W/str/cm²) from 380 nm to 1080 nm, and total integrated photon count were collected. The device is then placed under a large area silicon photodiode for the JVL sweep. The integrated photon count of the device at 10 mA/cm² is used to convert the photodiode current to photon count. The voltage is swept from 0 to a voltage equating to 200 mA/cm². The EQE of the device is calculated using the total integrated photon count. All results are summarized in Table 2. Voltage, EQE, and LT95 of inventive example are reported as relative numbers normalized to the results of the comparative example.

**Table 2.**

| **Device** | **Red emitter** | **λ max [nm]** | **At 10 mA/cm²** | | **LT₉₅** |
|---|---|---|---|---|---|
| | | | **Voltage [V]** | **EQE [%]** | |
| Device 1 | Inventive Compound 1 | 621 | 1.03 | 1.28 | 1.46 |
| Device 2 | Comparative Compound 1 | 611 | 1.00 | 1.00 | 1.00 |

Table 2 summarizes performance of electroluminescence devices. The inventive devices (device 1) using the inventive compound 1 as the emissive dopant showed more saturated red color (λmax=621 nm) compared to the device 2 using the comparative compound 1 (λmax=611 nm). The more saturated color the more desirable for display application. In addition, device 1 gave much higher efficiency and much better device lifetime at 10 mA/cm² than the device 2 while maintaining a similar operating voltage. These improved numbers are above any value that could be attributed to experimental error and the observed improvement is significant and unexpected. As a result, the inventive compound 1 can be used as emissive dopant to improve OLED device performance.

### Device Examples

The following devices were fabricated by high vacuum (<10⁻⁷ Torr) thermal evaporation. The anode electrode was 800 Å of indium tin oxide (ITO). The cathode consisted of 10 Å of Liq (8-hydroxyquinoline lithium) followed by 1,000 Å of Al. All devices were encapsulated with a glass lid sealed with an epoxy resin in a nitrogen glove box (<1 ppm of H₂O and O₂) immediately after fabrication with a moisture getter incorporated inside the package. The organic stack of the device examples consisted of sequentially, from the ITO Surface: 100Å of LG101 (purchased from LG Chem) as the hole injection layer (HIL); 400 Å of HTM as a hole transporting layer (HTL); 50 Å of EBM as an electron blocking layer (EBL); emissive layer (EML) with thickness 400 Å; Emissive layer containing H-host (H1): E-host (H2) in 6:4 ratio and 5 weight % of green emitter; 50 Å of H1 as a hole blocking layer (HBL); 300 Å of Liq (8-hydroxyquinoline lithium) doped with 35% of ETM as the ETL. The device structure is shown in Table 3. The chemical structures of the device materials are shown below.

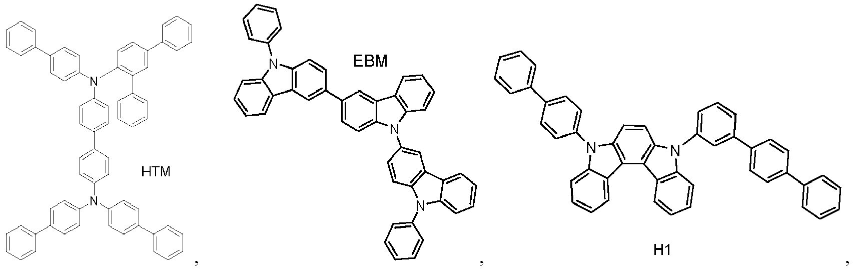

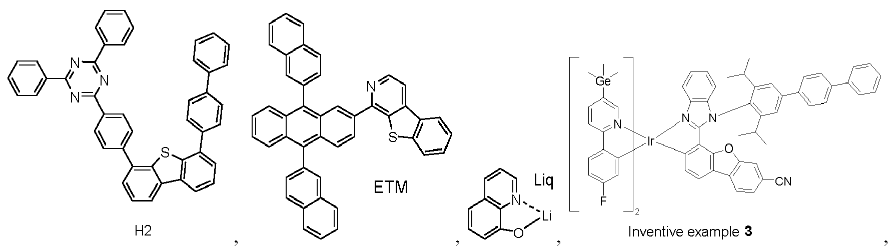

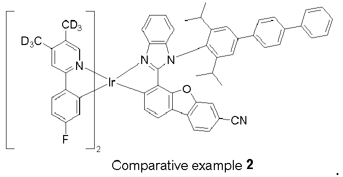

**Table 3. Device layer materials and thicknesses**

| Layer | Material | Thickness [Å] |
|---|---|---|
| | | |
| Anode | ITO | 800 |
| HIL | LG-101 | 100 |
| HTL | HTM | 400 |
| EBL | EBM | 50 |
| EML | H1 : H2 : Emitter 5% | 400 |
| HBL | H1 | 50 |
| ETL | Liq: ETM 35% | 300 |
| EIL | Liq | 10 |
| Cathode | Al | 1,000 |

Upon fabrication, the device was tested to measure EL and JVL. For this purpose, the samples were energized by the 2 channel Keysight B2902A SMU at a current density of 10 mA/cm² and measured by the Photo Research PR735 Spectroradiometer. Radiance (W/str/cm²) from 380 nm to 1080 nm, and total integrated photon count were collected. The devices were then placed under a large area silicon photodiode for the JVL sweep. The integrated photon count of the device at 10 mA/cm² is used to convert the photodiode current to photon count. The voltage is swept from 0 to a voltage equating to 200 mA/cm². The EQE of the device is calculated using the total integrated photon count. All results are summarized in Table 3. Voltage, LE, EQE, PE, and LT_{97%} of inventive example (Device 3) are reported as relative numbers normalized to the results of the comparative example (Device 4).

**Table 4. device results**

| **Device** | **Emitter** | **1931 CIE** | | | | **At 10mA/cm²** | | |
|---|---|---|---|---|---|---|---|---|
| | | **x** | **y** | **λ max [nm]** | **FWHM [nm]** | **LE** | **EQE** | **PE** |
| Device 3 | Inventive Example 3 | 0.325 | 0.640 | 522 | 52 | 1.01 | 1.01 | 1.01 |
| Device 4 | Comparative Example 2 | 0.346 | 0.627 | 526 | 55 | 1.00 | 1.00 | 1.00 |

Tables 4 provides a summary of performance of electroluminescence device of the materials. The inventive device (device 3) shows purer green color with the peak wavelength at 522 nm than the comparative device (device 4). Moreover, the inventive example shows narrower lineshape with FWHM of 52 nm. In general, the FWHM for a phosphorescent emitter complex is broad, normally equal to or above 55 nm as shown in the comparative example here. It has been a long-sought goal to achieve the narrow FWHM. The narrower FWHM, the better color purity for the display application. As a background information, the ideal line shape is a single wavelength (single line). As can be seen here, the current inventive compounds with germyl substituent can cut 3 nm of the FWHM number from the comparative one. This is a remarkably unexpected result. The inventive compounds have also blue shifted to more desirable bluer color, which can make the device more efficiency with purer color. The improvement of these values is above the value that could be attributed to experimental error and the observed improvement is significant. The performance improvement observed in the above data was unexpected. All results show the significance of the inventive compounds for applications in OLEDs.

The present application is also pertained to the following numbered items:
1. A compound of Ir(L_{A})ₚ(L_{B})_{q}(L_{C})ᵣ, wherein:
the first ligand L_{A} has a structure of Formula I, 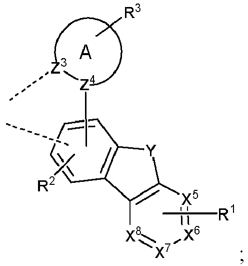 i
ligand L_{B} has a structure of Formula II, 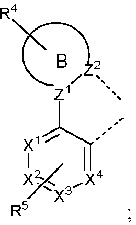
ligand Lc is a bidentate ligand;
p is 1 or 2; q is 0, 1, or 2; r is 0, 1, or 2;
p+q+r = 3;
moieties A and B are each independently a monocyclic ring or a polycyclic fused ring system, where the monocyclic ring and each ring of the polycyclic fused ring system are independently a 5-membered or 6-membered carbocyclic or heterocyclic ring;
each of X¹ to X⁸ and Z¹ to Z⁴ is independently C or N;
Y is selected from the group consisting of BR, BRR', NR, PR, P(O)R, O, S, Se, C=O, C=S, C=Se, C=NR', C=CR'R", S=O, SO₂, CR, CRR', SiRR', and GeRR';
each of R¹, R², R³, R⁴, and R⁵ independently represents mono to the maximum allowable substitution, or no substitutions;
each R, R', R¹, R², R³, R⁴, and R⁵ is independently hydrogen or a substituent selected from the group consisting of deuterium, halide, alkyl, cycloalkyl, heteroalkyl, arylalkyl, alkoxy, aryloxy, amino, silyl, boryl, alkenyl, cycloalkenyl, heteroalkenyl, alkynyl, aryl, heteroaryl, acyl, carbonyl, carboxylic acid, ether, ester, nitrile, isonitrile, sulfanyl, sulfinyl, sulfonyl, phosphino, selenyl, germyl, and combinations thereof;
any two R, R', R¹, R², R³, R⁴, or R⁵ may be joined or fused to form a ring, or to form a tetradentate or hexadentate ligand;
at least one R¹, R², R³, R⁴, or R⁵ comprises at least one germyl group; and
at least one R¹ comprises a cyano group, with the proviso that:
   (1) if both ring A and ring B are unfused pyridine rings and at least one of R⁴ and R⁵ is a germyl group, then (a) at least one of X⁵ to X⁸ is N or (b) Y is not O; and
   (2) if X⁵ is C, then R¹ bonded to X⁵ is selected from the group consisting of hydrogen, deuterium, cycloalkyl, methyl, phenyl, silyl, germyl, and combinations thereof.
2. The compound of item 1, wherein each R¹, R², R³, R⁴, and R⁵ is independently hydrogen or a substituent selected from the group consisting of deuterium, fluorine, alkyl, cycloalkyl, heteroalkyl, alkoxy, aryloxy, amino, silyl, germyl, boryl, alkenyl, cycloalkenyl, heteroalkenyl, aryl, heteroaryl, nitrile, isonitrile, sulfanyl, and combinations thereof.
3. The compound of item 1, wherein one of Z¹ or Z² is N and the other is C; and/or
wherein one of Z³ or Z⁴ is N and the other is C; and/or
wherein each of X¹ to X⁸ is C or at least one of X¹ to X⁸ is N.
4. The compound of item 1, wherein each of moiety A and moiety B is independently selected from the group consisting of benzene, pyridine, pyrimidine, pyridazine, pyrazine, triazine, imidazole, pyrazole, pyrrole, oxazole, furan, thiophene, thiazole, triazole, naphthalene, quinoline, isoquinoline, quinazoline, benzofuran, aza-benzofuran, benzoxazole, aza-benzoxazole, benzothiophene, aza-benzothiophene, benzothiazole, aza-benzothiazole, benzoselenophene, aza-benzoselenophene, indene, aza-indene, indole, aza-indole, benzimidazole, aza-benzimidazole, carbazole, aza-carbazole, dibenzofuran, aza-dibenzofuran, dibenzothiophene, aza-dibenzothiophene, quinoxaline, phthalazine, phenanthrene, aza-phenanathrene, anthracene, aza-antracene, phenanthridine, fluorene, and aza-fluorene.
5. The compound of item 1, wherein at least one of R¹, R², R³, R⁴, and R⁵ is aryl or heteroaryl, and the aryl or heteroaryl is substituted by a substituent that comprises at least one germyl group; and/or wherein Y is selected from the group consisting of O, S, BR, NR, CRR', SiRR', GeRR' and Se.
6. The compound of item 1, wherein at least one R¹, R², or R³ comprises at least one germyl group; and/or wherein at least one R⁴ or R⁵ is a germyl group.
7. The compound of item 1, wherein Z³ is N, moiety A is an unfused pyridine, and the R³ para to the N-Ir bond comprises at least one germyl group; and/or wherein Z² is N, moiety B is an unfused pyridine, and the R⁴ para to Z¹ or Z² comprises at least one germyl group.
8. The compound of item 1, wherein X⁵ is C, and R¹ bonded to X⁵ is selected from the group consisting of hydrogen, deuterium, methyl, phenyl, silyl, germyl, and combinations thereof; and/or
wherein the R¹ bonded to X⁶ or X⁷ comprises cyano.
9. The compound of item 1, wherein two R¹, two R², or two R⁵ are joined or fused to form a ring; and/or wherein at least one R³ comprises at least two aryl or heteroaryl moieties that are not fused together.
10. The compound of item 1, wherein the ligand L_{A} is selected from the group consisting of: 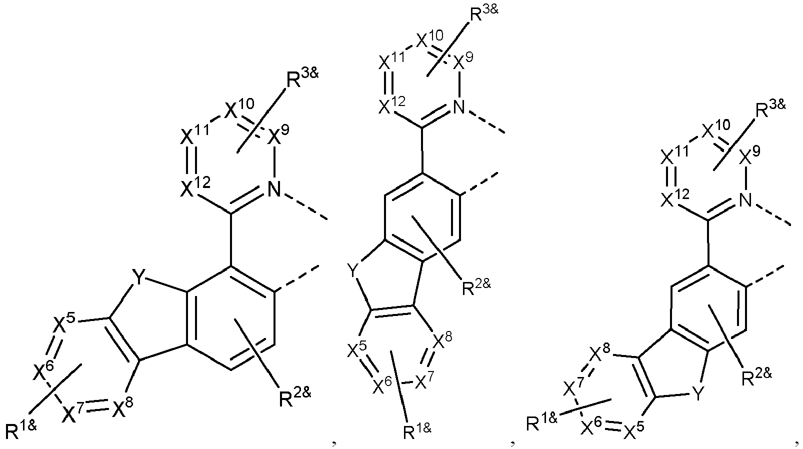 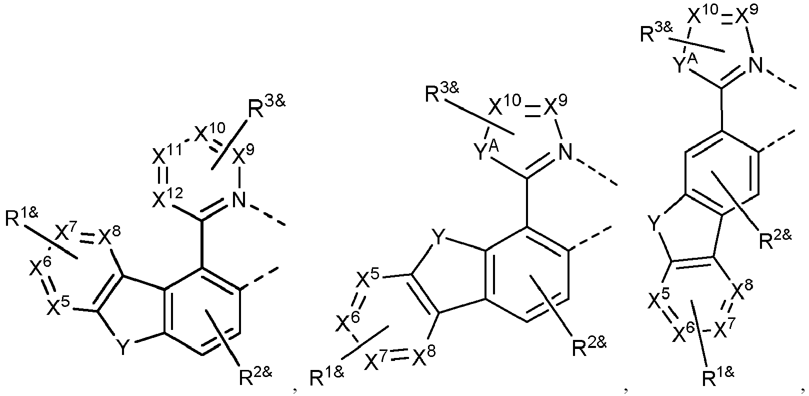 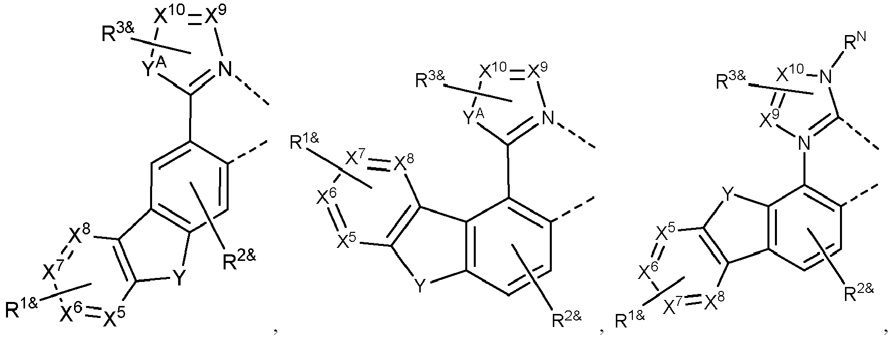 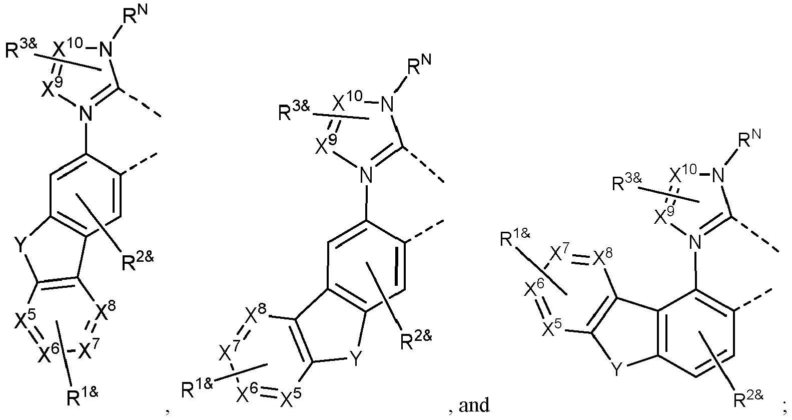 wherein:
each of X⁹ to X¹² is independently C or N;
Y^{A} is selected from the group consisting of BR, BRR', NR, PR, P(O)R, O, S, Se, C=O, C=S, C=Se, C=NR', C=CR'R", S=O, SO₂, CR, CRR', SiRR', and GeRR';
each R, R', R", and R^{N} is independently hydrogen or a substituent selected from the group consisting of deuterium, halide, alkyl, cycloalkyl, heteroalkyl, arylalkyl, alkoxy, aryloxy, amino, silyl, boryl, alkenyl, cycloalkenyl, heteroalkenyl, alkynyl, aryl, heteroaryl, acyl, carbonyl, carboxylic acid, ether, ester, nitrile, isonitrile, sulfanyl, sulfinyl, sulfonyl, phosphino, selenyl, germyl, and combinations thereof; and
any two substituents can be fused or joined to form a ring.
11. The compound of item 1, wherein the ligand L_{A} is selected from the group consisting of: 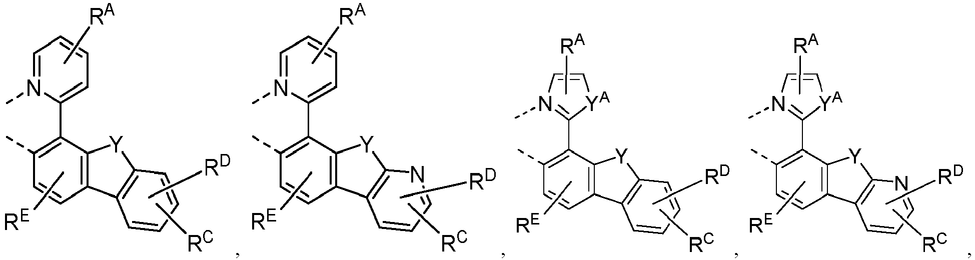 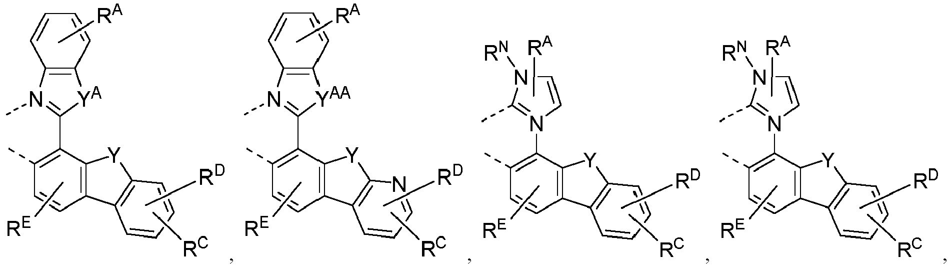 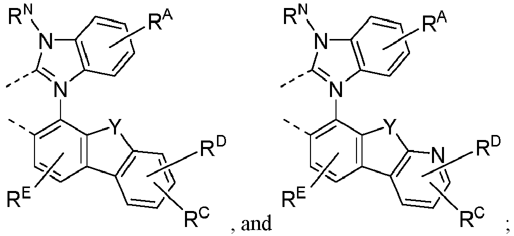 wherein
R^{D} is a monosubstitution selected from the group consisting of cyano group, cyano-containing aryl, and cyano-containing heteroaryl;
each of R^{A}, R^{C}, and R^{E} independently represents mono to the maximum allowable substitution, or no substitutions;
each R^{A}, R^{C}, and R^{E} is independently hydrogen or a substituent selected from the group consisting of deuterium, halide, alkyl, cycloalkyl, heteroalkyl, arylalkyl, alkoxy, aryloxy, amino, silyl, boryl, alkenyl, cycloalkenyl, heteroalkenyl, alkynyl, aryl, heteroaryl, acyl, carbonyl, carboxylic acid, ether, ester, nitrile, isonitrile, sulfanyl, sulfinyl, sulfonyl, phosphino, selenyl, germyl, and combinations thereof; and
any two substituents can be fused or joined to form a ring.
12. The compound of item 1, wherein the ligand L_{A} is selected from the group consisting of L_{Ai}(E^{A})(R*^{K}*)(R*^{L}*)(R*^{M}*), L_{A'm}(E^{A})(R*^{K}*)(R*^{L}*)(R*^{M}*), L_{AAn}(E^{A})(R*^{K}*)(R*^{L}*)(R*^{M}*), and L_{AA'o}(E^{A})(R*^{K}*)(R*^{L}*)(R*^{M}*), wherein i and m are each independently an integer from 1 to 56, n and o are each independently an integer from 1 to 14;
wherein, when L_{A} is selected from the group consisting of L_{Ai}(E^{A})(R*^{K}*)(R*^{L}*)(R*^{M}*), i is an integer from 1 to 56; E^{A} is selected from the group consisting of E1 to E40; each of R^{K} and R^{L} is independently selected from the group consisting of R1 to R110; when i is 1, 2, 17, 45-48, or 51-56, R^{M} is selected from the group consisting of R51 to R110; when i is 3-16, 18-44, or 49-50, R^{M} is selected from the group consisting of R1 to R110; and wherein each of L_{A1}(E1)(R1)(R1)(R51) to L_{A56}(E40)(R110)(R110)(R110) has a structure defined as follows:

| L_{A} | Structure of L_{A} | L_{A} | Structure of L_{A} |
|---|---|---|---|
| L_{A1}(E^{A})(R*^{K}*)(R*^{L}*)(R*^{M}*). wherein L_{A1}(E1)(R1)(R1)(R51) to L_{A1}(E40)(R110)(R110)(R 110) have the structure | 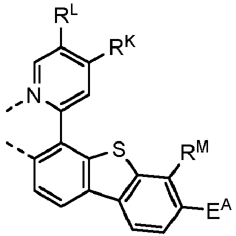 | L_{A2}(E^{A})(R*^{K}*)(R*^{L}*)(R*^{M}*), wherein L_{A2}(E1)(R1)(R1)(R51) to L_{A2}(E40)(R110)(R110)(R 110) have the structure | 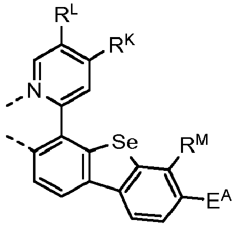 |
| L_{A3}(E^{A})(R*^{K}*)(R*^{L}*)(R*^{M}*), wherein L_{A3}(E1)(R1)(R1)(R1) to L_{A3}(E40)(R110)(R110)(R 110) have the structure | 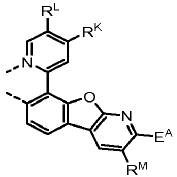 | L_{A4}(E^{A})(R*^{K}*)(R*^{L}*)(R*^{M}*), wherein L_{A4}(E1)(R1)(R1)(R1) to L_{A4}(E40)(R110)(R110)(R 110) have the structure | 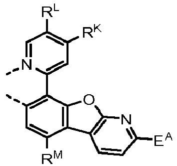 |
| L_{A5}(E^{A})(R*^{K}*)(R*^{L}*)(R*^{M}*), wherein L_{A5}(E1)(R1)(R1)(R1) to L_{A5}(E40)(R110)(R110)(R 110) have the structure | 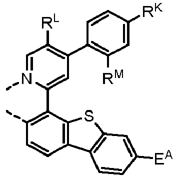 | L_{A6}(E^{A})(R*^{K}*)(R*^{L}*)(R*^{M}*), wherein L_{A6}(E1)(R1)(R1)(R1) to L_{A6}(E40)(R110)(R110)(R 110) have the structure | 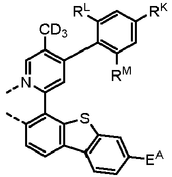 |
| L_{A7}(E^{A})(R*^{K}*)(R*^{L}*)(R*^{M}*), wherein L_{A7}(E1)(R1)(R1)(R1) to L_{A7}(E40)(R110)(R110)(R 110) have the structure | 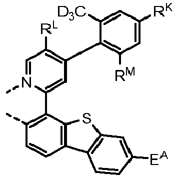 | L_{A8}(E^{A})(R*^{K}*)(R*^{L}*)(R*^{M}*), wherein L_{A8}(E1)(R1)(R1)(R1) to L_{A8}(E40)(R110)(R110)( 110) have the structure | 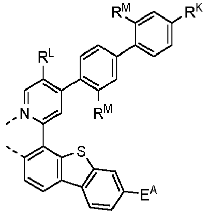 |
| L_{A9}(E^{A})(R*^{K}*)(R*^{L}*)(R*^{M}*), wherein L_{A9}(E1)(R1)(R1)(R1) to L_{A9}(E40)(R110)(R110)(R 110) have the structure | 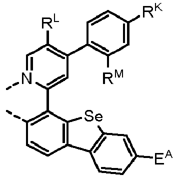 | L_{A10}(E^{A})(R*^{K}*)(R*^{L}*)(R*^{M}*), wherein L_{A10}(E1)(R1)(R1)(R1) to L_{A10}(E40)(R110)(R110)( R110) have the structure | 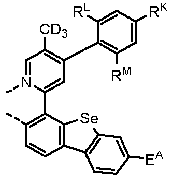 |
| L_{A11}(E^{A})(R*^{K}*)(R*^{L}*)(R*^{M}*), wherein L_{A11}(E1)(R1)(R1)(R1) to L_{A11}(E40)(R110)(R110)( R110) have the structure | 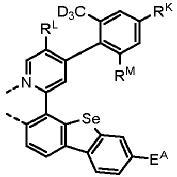 | L_{A12}(E^{A})(R*^{K}*)(R*^{L}*)(R*^{M}*), wherein L_{A12}(E1)(R1)(R1)(R1) to L_{A12}(E40)(R110)(R110)( R110) have the structure | 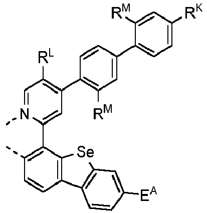 |
| L_{A13}(E^{A})(R*^{K}*)(R*^{L}*)(R*^{M}*), wherein L_{A13}(E1)(R1)(R1)(R1) to L_{A13}(E40)(R110)(R110)( R110) have the structure | 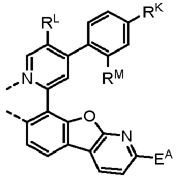 | L_{A14}(E^{A})(R*^{K}*)(R*^{L}*)(R*^{M}*), wherein L_{A14}(E1)(R1)(R1)(R1) to L_{A14}(E40)(R110)(R110)( R110) have the structure | 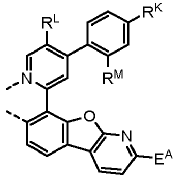 |
| L_{A15}(E^{A})(R*^{K}*)(R*^{L}*)(R*^{M}*), wherein L_{A15}(E1)(R1)(R1)(R1) to L_{A15}(E40)(R110)(R110)( R110) have the structure | 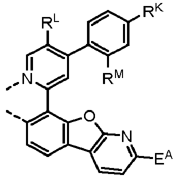 | L_{A16}(E^{A})(R*^{K}*)(R*^{L}*)(R*^{M}*), wherein L_{A16}(E1)(R1)(R1)(R1) to L_{A16}(E40)(R110)(R110)( R110) have the structure | 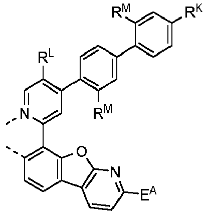 |
| L_{A17}(E^{A})(R*^{K}*)(R*^{L}*)(R*^{M}*), wherein L_{A17}(E1)(R1)(R1)(R51) to L_{A17}(E40)(R110)(R110)( R110) have the structure | 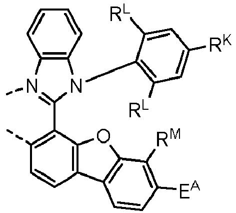 | L_{A18}(E^{A})(R*^{K}*)(R*^{L}*)(R*^{M}*), wherein L_{A18}(E1)(R1)(R1)(R1) to L_{A18}(E40)(R110)(R110)( R110) have the structure | 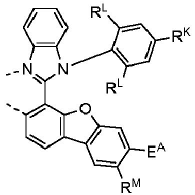 |
| L_{A19}(E^{A})(R*^{K}*)(R*^{L}*)(R*^{M}*), wherein L_{A19}(E1)(R1)(R1)(R1) to L_{A19}(E40)(R110)(R110)( R110) have the structure | 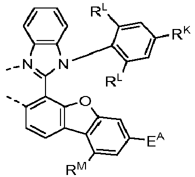 | L_{A20}(E^{A})(R*^{K}*)(R*^{L}*)(R*^{M}*), wherein L_{A20}(E1)(R1)(R1)(R1) to L_{A20}(E40)(R110)(R110)( R110) have the structure | 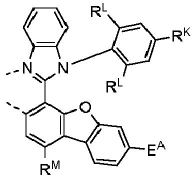 |
| L_{A21}(E^{A})(R*^{K}*)(R*^{L}*)(R*^{M}*), wherein L_{A21}(E1)(R1)(R1)(R1) to L_{A21}(E40)(R110)(R110)( R110) have the structure | 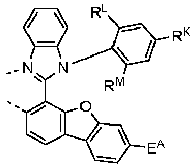 | L_{A22}(E^{A})(R*^{K}*)(R*^{L}*)(R*^{M}*), wherein L_{A22}(E1)(R1)(R1)(R1) to L_{A22}(E40)(R110)(R110)( R110) have the structure | 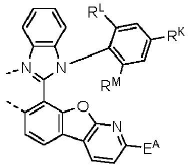 |
| L_{A23}(E^{A})(R*^{K}*)(R*^{L}*)(R*^{M}*), wherein L_{A23}(E1)(R1)(R1)(R1) to L_{A23}(E40)(R110)(R110)( R110) have the structure | 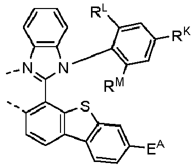 | L_{A24}(E^{A})(R*^{K}*)(R*^{L}*)(R*^{M}*), wherein L_{A24}(E1)(R1)(R1)(R1) to L_{A24}(E40)(R110)(R110)( R110) have the structure | 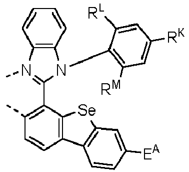 |
| L_{A25}(E^{A})(R*^{K}*)(R*^{L}*)(R*^{M}*), wherein L_{A25}(E1)(R1)(R1)(R1) to L_{A25}(E40)(R110)(R110)( R110) have the structure | 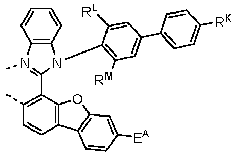 | L_{A26}(E^{A})(R*^{K}*)(R*^{L}*)(R*^{M}*), wherein L_{A26}(E1)(R1)(R1)(R1) to L_{A26}(E40)(R110)(R110)( R110) have the structure | 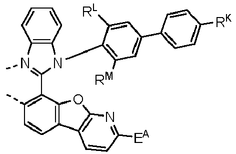 |
| L_{A27}(E^{A})(R*^{K}*)(R*^{L}*)(R*^{M}*), wherein L_{A27}(E1)(R1)(R1)(R1) to L_{A27}(E40)(R110)(R110)( R110) have the structure | 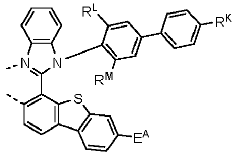 | L_{A28}(E^{A})(R*^{K}*)(R*^{L}*)(R*^{M}*), wherein L_{A28}(E1)(R1)(R1)(R1) to L_{A28}(E40)(R110)(R110)( R110) have the structure | 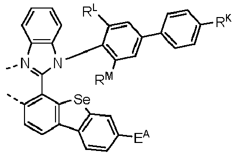 |
| L_{A29}(E^{A})(R*^{K}*)(R*^{L}*)(R*^{M}*), wherein L_{A29}(E1)(R1)(R1)(R1) to L_{A29}(E40)(R110)(R110)( R110) have the structure | 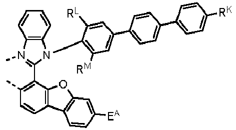 | L_{A30}(E^{A})(R*^{K}*)(R*^{L}*)(R*^{M}*), wherein L_{A30}(E1)(R1)(R1)(R1) to L_{A30}(E40)(R110)(R110)( R110) have the structure | 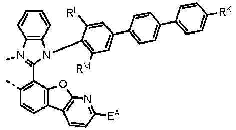 |
| L_{A31}(E^{A})(R*^{K}*)(R*^{L}*)(R*^{M}*), wherein L_{A31}(E1)(R1)(R1)(R1) to L_{A31}(E40)(R110)(R110)( R110) have the structure | 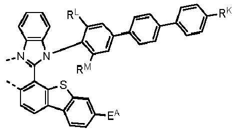 | L_{A32}(E^{A})(R*^{K}*)(R*^{L}*)(R*^{M}*), wherein L_{A32}(E1)(R1)(R1)(R1) to L_{A32}(E40)(R110)(R110)( R110) have the structure | 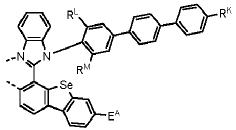 |
| L_{A33}(E^{A})(R*^{K}*)(R*^{L}*)(R*^{M}*), wherein L_{A33}(E1)(R1)(R1)(R1) to L_{A33}(E40)(R110)(R110)( R110) have the structure | 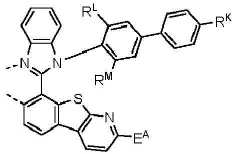 | L_{A34}(E^{A})(R*^{K}*)(R*^{L}*)(R*^{M}*), wherein L_{A34}(E1)(R1)(R1)(R1) to L_{A34}(E40)(R110)(R110)( R110) have the structure | 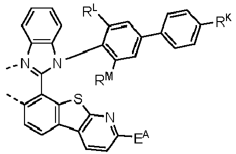 |
| L_{A35}(E^{A})(R*^{K}*)(R*^{L}*)(R*^{M}*), wherein L_{A35}(E1)(R1)(R1)(R1) to L_{A35}(E40)(R110)(R110)( R110) have the structure | 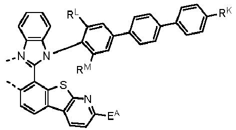 | L_{A36}(E^{A})(R*^{K}*)(R*^{L}*)(R*^{M}*), wherein L_{A36}(E1)(R1)(R1)(R1) to L_{A36}(E40)(R110)(R110)( R110) have the structure | 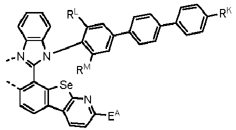 |
| L_{A37}(E^{A})(R*^{K}*)(R*^{L}*)(R*^{M}*), wherein L_{A37}(E1)(R1)(R1)(R1) to L_{A37}(E40)(R110)(R110)( R110) have the structure | 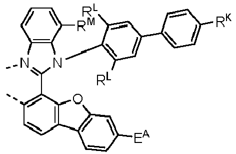 | L_{A38}(E^{A})(R*^{K}*)(R*^{L}*)(R*^{M}*), wherein L_{A38}(E1)(R1)(R1)(R1) to L_{A38}(E40)(R110)(R110)( R110) have the structure | 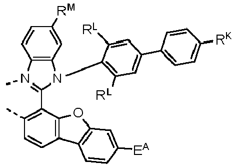 |
| L_{A39}(E^{A})(R*^{K}*)(R*^{L}*)(R*^{M}*), wherein L_{A39}(E1)(R1)(R1)(R1) to L_{A39}(E40)(R110)(R110)( R110) have the structure | 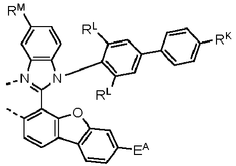 | L_{A40}(E^{A})(R*^{K}*)(R*^{L}*)(R*^{M}*), wherein L_{A40}(E1)(R1)(R1)(R1) to L_{A40}(E40)(R110)(R110)( R110) have the structure | 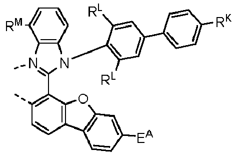 |
| L_{A41}(E^{A})(R*^{K}*)(R*^{L}*)(R*^{M}*), wherein L_{A41}(E1)(R1)(R1)(R1) to L_{A41}(E40)(R110)(R110)( R110) have the structure | 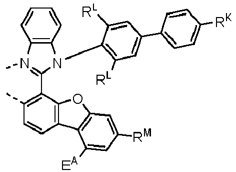 | L_{A42}(E^{A})(R*^{K}*)(R*^{L}*)(R*^{M}*), wherein L_{A42}(E1)(R1)(R1)(R1) to L_{A42}(E40)(R110)(R110)( R110) have the structure | 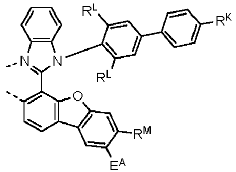 |
| L_{A43}(E^{A})(R*^{K}*)(R*^{L}*)(R*^{M}*), wherein L_{A43}(E1)(R1)(R1)(R1) to L_{A43}(E40)(R110)(R110)( R110) have the structure | 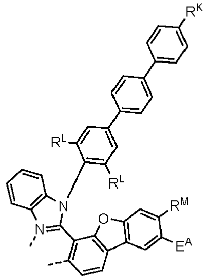 | L_{A44}(E^{A})(R*^{K}*)(R*^{L}*)(R*^{M}*), wherein L_{A44}(E1)(R1)(R1)(R1) to L_{A44}(E40)(R110)(R110)( R110) have the structure | 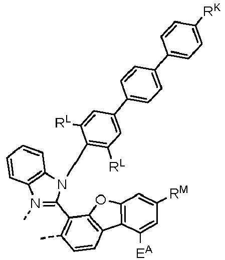 |
| L_{A45}(E^{A})(R*^{K}*)(R*^{L}*)(R*^{M}*), wherein L_{A45}(E1)(R1)(R1)(R51) to L_{A45}(E40)(R110)(R110)( R110) have the structure | 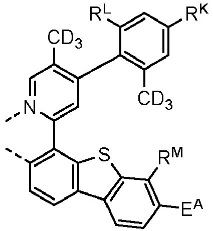 | L_{A46}(E^{A})(R*^{K}*)(R*^{L}*)(R*^{M}*), wherein L_{A46}(E1)(R1)(R1)(R51) to L_{A46}(E40)(R110)(R110)( R110) have the structure | 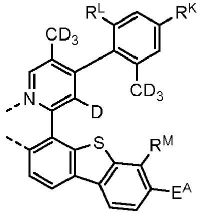 |
| L_{A47}(E^{A})(R*^{K}*)(R*^{L}*)(R*^{M}*), wherein L_{A47}(E1)(R1)(R1)(R51) to L_{A47}(E40)(R110)(R110)( R110) have the structure | 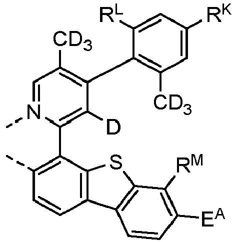 | L_{A48}(E^{A})(R*^{K}*)(R*^{L}*)(R*^{M}*), wherein L_{A48}(E1)(R1)(R1)(R51) to L_{A48}(E40)(R110)(R110)( R110) have the structure | 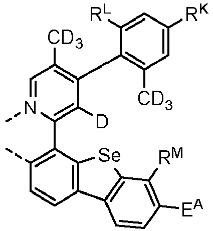 |
| L_{A49}(E^{A})(R*^{K}*)(R*^{L}*)(R*^{M}*), wherein L_{A49}(E1)(R1)(R1)(R1) to L_{A49}(E40)(R110)(R110)( R110) have the structure | 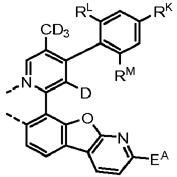 | L_{A50}(E^{A})(R*^{K}*)(R*^{L}*)(R*^{M}*), wherein L_{A50}(E1)(R1)(R1)(R1) to L_{A50}(E40)(R110)(R110)( R110) have the structure | 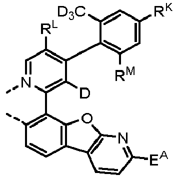 |
| L_{A51}(E^{A})(R*^{K}*)(R*^{L}*)(R*^{M}*), wherein L_{A51}(E1)(R1)(R1)(R51) to L_{A51}(E40)(R110)(R110)( R110) have the structure | 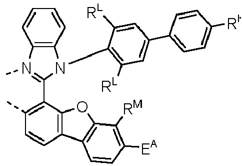 | L_{A52}(E^{A})(R*^{K}*)(R*^{L}*)(R*^{M}*), wherein L_{A52}(E1)(R1)(R1)(R51) to L_{A52}(E40)(R110)(R110)( R110) have the structure | 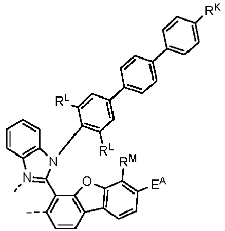 |
| L_{A53}(E^{A})(R*^{K}*)(R*^{L}*)(R*^{M}*), wherein L_{A53}(E1)(R1)(R1)(R51) to L_{A53}(E40)(R110)(R110)( R110) have the structure | 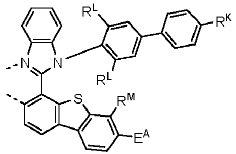 | L_{A54}(E^{A})(R*^{K}*)(R*^{L}*)(R*^{M}*), wherein L_{A54}(E1)(R1)(R1)(R51) to L_{A54}(E40)(R110)(R110)( R110) have the structure | 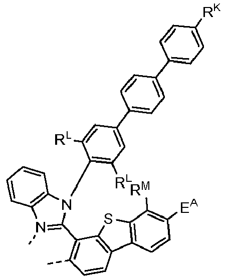 |
| L_{A55}(E^{A})(R*^{K}*)(R*^{L}*)(R*^{M}*), wherein L_{A55}(E1)(R1)(R1)(R51) to L_{A55}(E40)(R110)(R110)( R110) have the structure | 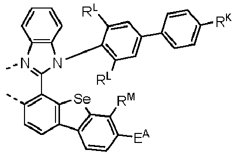 | L_{A56}(E^{A})(R*^{K}*)(R*^{L}*)(R*^{M}*), wherein L_{A56}(E1)(R1)(R1)(R51) to L_{A56}(E40)(R110)(R110)( R110) have the structure | 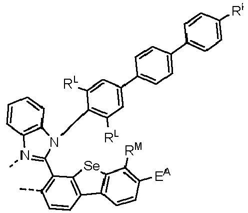 |

wherein, when L_{A} is selected from the group consisting of L_{A'm}(E^{A})(R*^{K}*)(R*^{L}*)(R*^{M}*), m is an integer from 1 to 56; E^{A} is selected from E1 to E40; R^{K} is selected from the group consisting of R71 to R110; R^{L} is independently selected from the group consisting of R1 to R110; when m is 1, 2, 17, or 45-56, R^{M} is selected from the group consisting of R51 to R110; when m is 3-16 or 18-44, R^{M} is selected from the group consisting of R1 to R110; and each of L_{A'1}(E1)(R71)(R1)(R51) to L_{A'56}(E40)(R110)(R110)(R110) has a structure defined as follows:

| L_{A'} | Structure of L_{A'} | L_{A'} | Structure of L_{A'} |
|---|---|---|---|
| L_{A'1}(E^{A})(R*^{K}*)(R*^{L}*)(R*^{M}*), wherein L_{A'1}(E1)(R71)(R1)(R51) to L_{A'1}(E40)(R110)(R110)(R 110) have the structure | 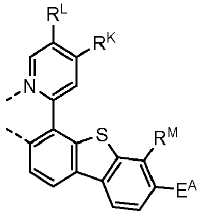 | L_{A'2}(E^{A})(R*^{K}*)(R*^{L}*)(R*^{M}*), wherein L_{A'2}(E1)(R71)(R1)(R51) to L_{A'2}(E40)(R110)(R110)(R 110) have the structure | 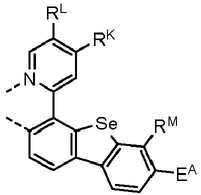 |
| L_{A'3}(E^{A})(R*^{K}*)(R*^{L}*)(R*^{M}*), wherein L_{A'3}(E1)(R71)(R1)(R1) to L_{A'3}(E40)(R110)(R110)(R 110) have the structure | 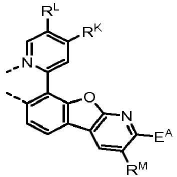 | L_{A'4}(E^{A})(R*^{K}*)(R*^{L}*)(R*^{M}*), wherein L_{A'4}(E1)(R71)(R1)(R1) to L_{A'4}(E40)(R110)(R110)(R 110) have the structure | 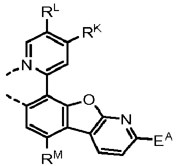 |
| L_{A'5}(E^{A})(R*^{K}*)(R*^{L}*)(R*^{M}*), wherein L_{A'5}(E1)(R71)(R1)(R1) to L_{A'5}(E40)(R110)(R110)(R 110) have the structure | 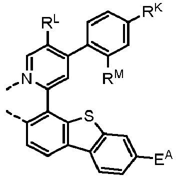 | L_{A'6}(E^{A})(R*^{K}*)(R*^{L}*)(R*^{M}*), wherein L_{A'6}(E1)(R71)(R1)(R1) to L_{A'6}(E40)(R110)(R110)(R 110) have the structure | 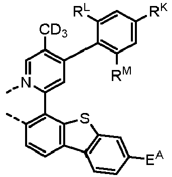 |
| L_{A'7}(E^{A})(R*^{K}*)(R*^{L}*)(R*^{M}*), wherein L_{A'7}(E1)(R71)(R1)(R1) to L_{A'7}(E40)(R110)(R110)(R 110) have the structure | 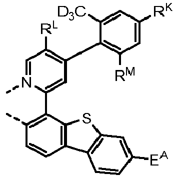 | L_{A'8}(E^{A})(R*^{K}*)(R*^{L}*)(R*^{M}*), wherein L_{A'8}(E1)(R71)(R1)(R1) to L_{A'8}(E40)(R110)(R110)(R 110) have the structure | 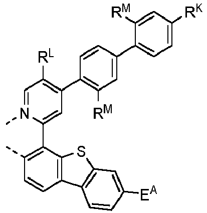 |
| L_{A'9}(E^{A})(R*^{K}*)(R*^{L}*)(R*^{M}*), wherein L_{A'9}(E1)(R71)(R1)(R1) to L_{A'9}(E40)(R110)(R110)(R 110) have the structure | 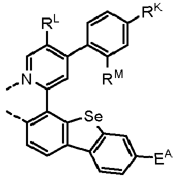 | L_{A'10}(E^{A})(R*^{K}*)(R*^{L}*)(R*^{M}*), wherein L_{A'10}(E1)(R71)(R1)(R1) to L_{A'10}(E40)(R110)(R110)( R110) have the structure | 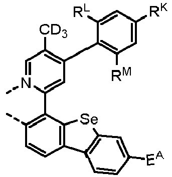 |
| L_{A'11}(E^{A})(R*^{K}*)(R*^{L}*)(R*^{M}*), wherein L_{A'11}(E1)(R71)(R1)(R1) to L_{A'11}(E40)(R110)(R110)( R110) have the structure | 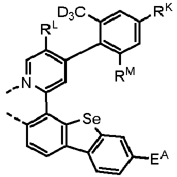 | L_{A'12}(E^{A})(R*^{K}*)(R*^{L}*)(R*^{M}*), wherein L_{A'12}(E1)(R71)(R1)(R1) to L_{A'12}(E40)(R110)(R110)( R110) have the structure | 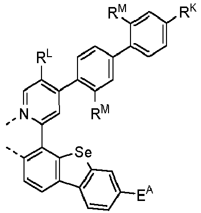 |
| L_{A'13}(E^{A})(R*^{K}*)(R*^{L}*)(R*^{M}*), wherein L_{A'13}(E1)(R71)(R1)(R1) to L_{A'13}(E40)(R110)(R110)( R110) have the structure | 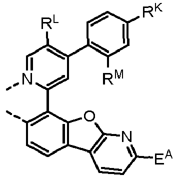 | L_{A'14}(E^{A})(R*^{K}*)(R*^{L}*)(R*^{M}*), wherein L_{A'14}(E1)(R71)(R1)(R1) to L_{A'14}(E40)(R110)(R110)( R110) have the structure | 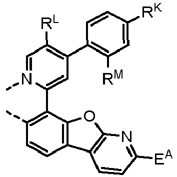 |
| L_{A'15}(E^{A})(R*^{K}*)(R*^{L}*)(R*^{M}*), wherein L_{A'15}(E1)(R71)(R1)(R1) to L_{A'15}(E40)(R110)(R110)( R110) have the structure | 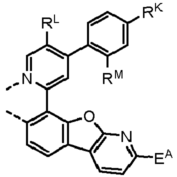 | L_{A'16}(E^{A})(R*^{K}*)(R*^{L}*)(R*^{M}*), wherein L_{A'16}(E1)(R71)(R1)(R1) to L_{A'16}(E40)(R110)(R110)( R110) have the structure | 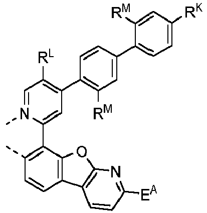 |
| L_{A'17}(E^{A})(R*^{K}*)(R*^{L}*)(R*^{M}*), wherein L_{A'17}(E1)(R71)(R1)(R51) to L_{A'17}(E40)(R110)(R110)( R110) have the structure | 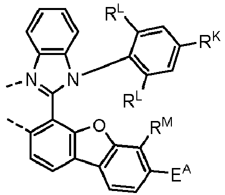 | L_{A'18}(E^{A})(R*^{K}*)(R*^{L}*)(R*^{M}*), wherein L_{A'18}(E1)(R71)(R1)(R1) to L_{A'18}(E40)(R110)(R110)( R110) have the structure | 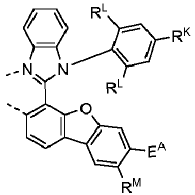 |
| L_{A'19}(E^{A})(R*^{K}*)(R*^{L}*)(R*^{M}*), wherein L_{A'19}(E1)(R71)(R1)(R1) to L_{A'19}(E40)(R110)(R110)( R110) have the structure | 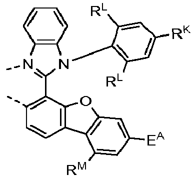 | L_{A'20}(E^{A})(R*^{K}*)(R*^{L}*)(R*^{M}*), wherein L_{A'20}(E1)(R71)(R1)(R1) to L_{A'20}(E40)(R110)(R110)( R110) have the structure | 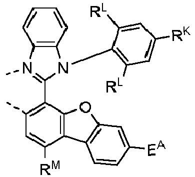 |
| L_{A'21}(E^{A})(R*^{K}*)(R*^{K}*)(R*^{M}*), wherein L_{A'21}(E1)(R71)(R1)(R1) to L_{A'21}(E40)(R110)(R110)( R110) have the structure | 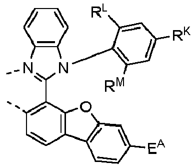 | L_{A'22}(E^{A})(R*^{K}*)(R*^{L}*)(R*^{M}*), wherein L_{A'22}(E1)(R71)(R1)(R1) to L_{A'22}(E40)(R110)(R110)( R110) have the structure | 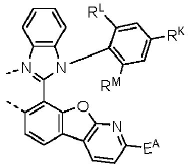 |
| L_{A'23}(E^{A})(R*^{K}*)(R*^{L}*)(R*^{M}*), wherein L_{A'23}(E1)(R71)(R1)(R1) to L_{A'23}(E40)(R110)(R110)( R110) have the structure | 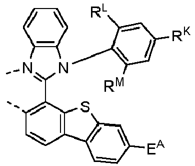 | L_{A'24}(E^{A})(R*^{K}*)(R*^{L}*)(R*^{M}*), wherein L_{A'24}(E1)(R71)(R1)(R1) to L_{A'24}(E40)(R110)(R110)( R110) have the structure | 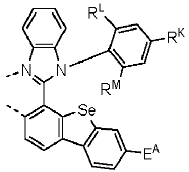 |
| L_{A'25}(E^{A})(R*^{K}*)(R*^{L}*)(R*^{M}*), wherein L_{A'25}(E1)(R71)(R1)(R1) to L_{A'25}(E40)(R110)(R110)( R110) have the structure | 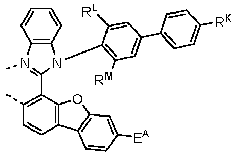 | L_{A'26}(E^{A})(R*^{K}*)(R*^{L}*)(R*^{M}*), wherein L_{A'26}(E1)(R71)(R1)(R1) to L_{A'26}(E40)(R110)(R110)( R110) have the structure | 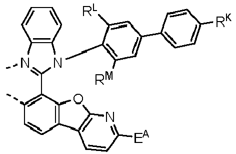 |
| L_{A'27}(E^{A})(R*^{K}*)(R*^{L}*)(R*^{M}*), wherein L_{A'27}(E1)(R71)(R1)(R1) to L_{A'27}(E40)(R110)(R110)( R110) have the structure | 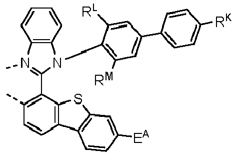 | L_{A'28}(E^{A})(R*^{K}*)(R*^{L}*)(R*^{M}*), wherein L_{A'28}(E1)(R71)(R1)(R1) to L_{A'28}(E40)(R110)(R110)( R110) have the structure | 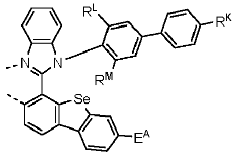 |
| L_{A'29}(E^{A})(R*^{K}*)(R*^{L}*)(R*^{M}*), wherein L_{A'29}(E1)(R71)(R1)(R1) to L_{A'29}(E40)(R110)(R110)( R110) have the structure | 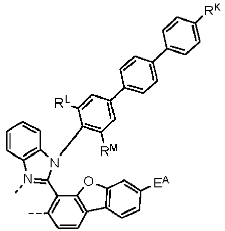 | L_{A'30}(E^{A})(R*^{K}*)(R*^{L}*)(R*^{M}*), wherein L_{A'30}(E1)(R71)(R1)(R1) to L_{A'30}(E40)(R110)(R110)( R110) have the structure | 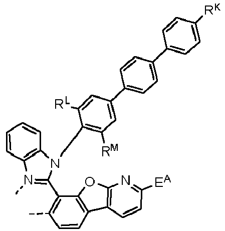 |
| L_{A'31}(E^{A})(R*^{K}*)(R*^{L}*)(R*^{M}*), wherein L_{A'31}(E1)(R71)(R1)(R1) to L_{A'31}(E40)(R110)(R110)( R110) have the structure | 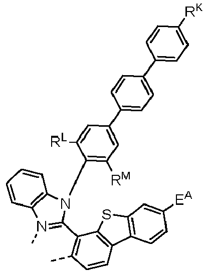 | L_{A'32}(E^{A})(R*^{K}*)(R*^{L}*)(R*^{M}*), wherein L_{A'32}(E1)(R71)(R1)(R1) to L_{A'32}(E40)(R110)(R110)( R110) have the structure | 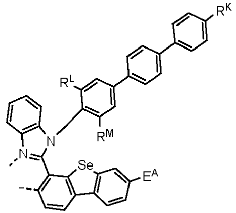 |
| L_{A'33}(E^{A})(R*^{K}*)(R*^{L}*)(R*^{M}*), wherein L_{A'33}(E1)(R71)(R1)(R1) to L_{A'33}(E40)(R110)(R110)( R110) have the structure | 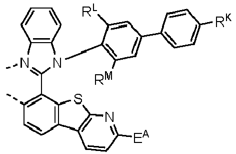 | L_{A'34}(E^{A})(R*^{K}*)(R*^{L}*)(R*^{M}*), wherein L_{A'34}(E1)(R71)(R1)(R1) to L_{A'34}(E40)(R110)(R110)( R110) have the structure | 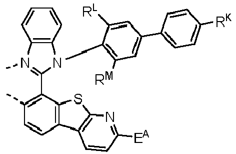 |
| L_{A'35}(E^{A})(R*^{K}*)(R*^{L}*)(R*^{M}*), wherein L_{A'35}(E1)(R71)(R1)(R1) to L_{A'35}(E40)(R110)(R110)( R110) have the structure | 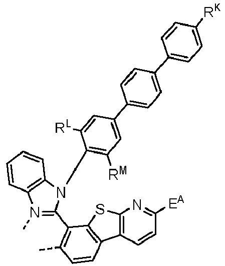 | L_{A'36}(E^{A})(R*^{K}*)(R*^{L}*)(R*^{M}*), wherein L_{A'36}(E1)(R71)(R1)(R1) to L_{A'36}(E40)(R110)(R110)( R110) have the structure | 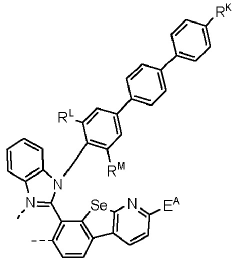 |
| L_{A'37}(E^{A})(R*^{K}*)(R*^{L}*)(R*^{M}*), wherein L_{A'37}(E1)(R71)(R1)(R1) to L_{A'37}(E40)(R110)(R110)( R110) have the structure | 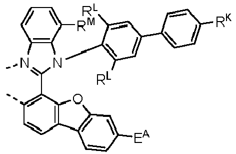 | L_{A'38}(E^{A})(R*^{K}*)(R*^{L}*)(R*^{M}*), wherein L_{A'38}(E1)(R71)(R1)(R1) to L_{A'38}(E40)(R110)(R110)( R110) have the structure | 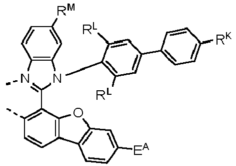 |
| L_{A'39}(E^{A})(R*^{K}*)(R*^{L}*)(R*^{M}*), wherein L_{A'39}(E1)(R71)(R1)(R1) to L_{A'39}(E40)(R110)(R110)( R110) have the structure | 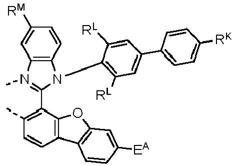 | L_{A'40}(E^{A})(R*^{K}*)(R*^{L}*)(R*^{M}*), wherein L_{A'40}(E1)(R71)(R1)(R1) to L_{A'40}(E40)(R110)(R110)( R110) have the structure | 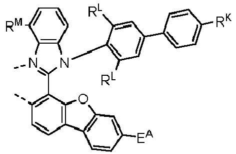 |
| L_{A'41}(E^{A})(R*^{K}*)(R*^{L}*)(R*^{M}*), wherein L_{A'41}(E1)(R71)(R1)(R1) to L_{A'41}(E40)(R110)(R110)( R110) have the structure | 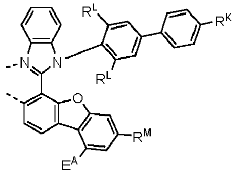 | L_{A'42}(E^{A})(R*^{K}*)(R*^{L}*)(R*^{M}*), wherein L_{A'42}(E1)(R71)(R1)(R1) to L_{A'42}(E40)(R110)(R110)( R110) have the structure | 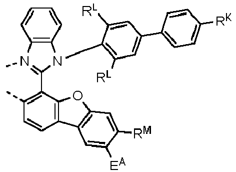 |
| L_{A'43}(E^{A})(R^{K})(R*^{L}*)(R*^{M}*), wherein L_{A'43}(E1)(R71)(R1)(R1) to L_{A'43}(E40)(R110)(R110)( R110) have the structure | 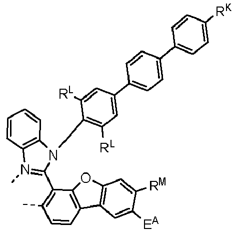 | L_{A'44}(E^{A})(R*^{K}*)(R*^{L}*)(R*^{M}*), wherein L_{A'44}(E1)(R71)(R1)(R1) to L_{A'44}(E40)(R110)(R110)( R110) have the structure | 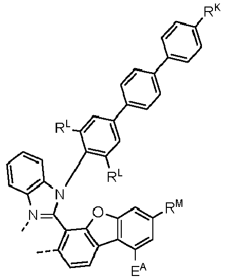 |
| L_{A'45}(E^{A})(R*^{K}*)(R*^{L}*)(R*^{M}*), wherein L_{A'45}(E1)(R71)(R1)(R51) to L_{A'45}(E40)(R110)(R110)( R110) have the structure | 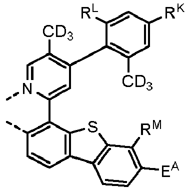 | L_{A'46}(E^{A})(R*^{K}*)(R*^{L}*)(R*^{M}*), wherein L_{A'46}(E1)(R71)(R1)(R51) to L_{A'46}(E40)(R110)(R110)( R110) have the structure | 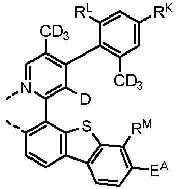 |
| L_{A'47}(E^{A})(R*^{K}*)(R*^{L}*)(R*^{M}*), wherein L_{A'47}(E1)(R71)(R1)(R51) to L_{A'47}(E40)(R110)(R110)( R110) have the structure | 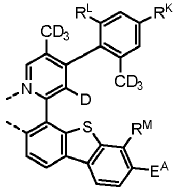 | L_{A'48}(E^{A})(R*^{K}*)(R*^{L}*)(R*^{M}*), wherein L_{A'48}(E1)(R71)(R1)(R51) to L_{A'48}(E40)(R110)(R110)( R110) have the structure | 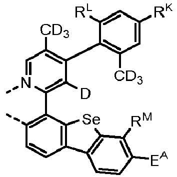 |
| L_{A'49}(E^{A})(R*^{K}*)(R*^{L}*)(R*^{M}*), wherein L_{A'49}(E1)(R71)(R1)(R51) to L_{A'49}(E40)(R110)(R110)( R110) have the structure | 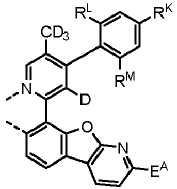 | L_{A'50}(E*^{A}*)(R*^{K}*)(R*^{L}*)(R*^{M}*), wherein L_{A'50}(E1)(R71)(R1)(R51) to L_{A'50}(E40)(R110)(R110)( R110) have the structure | 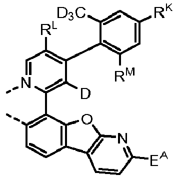 |
| L_{A'51}(E^{A})(R*^{K}*)(R*^{L}*)(R*^{M}*), wherein L_{A'51}(E1)(R71)(R1)(R51) to L_{A'51}(E40)(R110)(R110)( R110) have the structure | 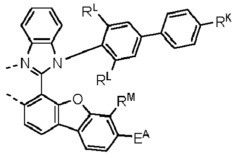 | L_{A'52}(E^{A})(R*^{K}*)(R*^{L}*)(R*^{M}*), wherein L_{A'52}(E1)(R71)(R1)(R51) to L_{A'52}(E40)(R110)(R110)( R110) have the structure | 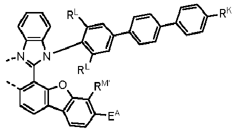 |
| L_{A'53}(E^{A})(R*^{K}*)(R*^{L}*)(R*^{M}*), wherein L_{A'53}(E1)(R71)(R1)(R51) to L_{A'53}(E40)(R110)(R110)( R110) have the structure | 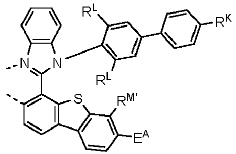 | L_{A'54}(E^{A})(R*^{K}*)(R*^{L}*)(R*^{M}*), wherein L_{A'54}(E1)(R71)(R1)(R51) to L_{A'54}(E40)(R110)(R110)( R110) have the structure | 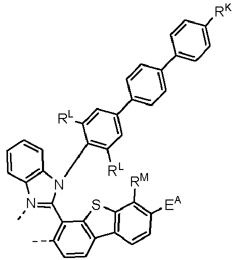 |
| L_{A'55}(E^{A})(R*^{K}*)(R*^{L}*)(R^{M}), wherein L_{A'55}(E1)(R71)(R1)(R51) to L_{A'53}(E40)(R110)(R110)( R110) have the structure | 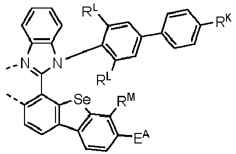 | L_{A'56}(E^{A})(R*^{K}*)(R*^{L}*)(R*^{M}*), wherein L_{A'56}(E1)(R71)(R1)(R51) to L_{A'53}(E40)(R110)(R110)( R110) have the structure | 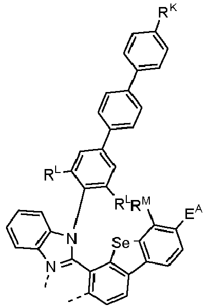 |

wherein, when L_{A} is selected from the group consisting of L_{AAn}(E^{A})(R*^{K}*)(R*^{L}*)(R*^{M}*), n is an integer from 1 to 14, E^{A} is selected from E1 to E40; R^{K} is selected from the group consisting of R1 to R110; when n is 1, R^{L} is selected from the group consising of 51 to 110; when n is 2-14, R^{L} is selected from the group consising of 51 to 110; when n is 1 to 10, R^{M} is selected from the group consising of 1 to 110; when n is 11 to 14, R^{M} is selected from the group consising of 51 to 110; and each of L_{AA1}(E1)(R71)(R51)(R1) to L_{AA14}(E40)(R110)(R110)(R110) has a structure defined as follows:

| L_{AA} | Structure of L_{AA} | L_{AA} | Structure of L_{AA} |
|---|---|---|---|
| L_{AA1}(E^{A})(R*^{K}*)(R*^{L}*)(R*^{M}*), wherein L_{AA1}(E1)(R1)(R51)(R1) to L_{AA1}(E40)(R110)(R110)( R110) have the structure | 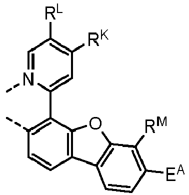 | L_{AA2}(E^{A})(R*^{K}*)(R*^{L}*)(R*^{M}*), wherein L_{AA2}(E1)(R1)(R1)(R1) to L_{AA2}(E40)(R110)(R110)( R110) have the structure | 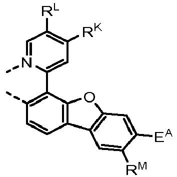 |
| L_{AA3}(E^{A})(R*^{K}*)(R*^{L}*)(R*^{M}*), wherein L_{AA3}(E1)(R1)(R1)(R1) to L_{AA3}(E40)(R110)(R110)( R110) have the structure | 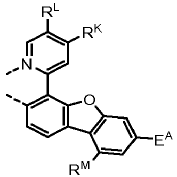 | L_{AA4}(E^{A})(R*^{K}*)(R*^{L}*)(R*^{M}*), wherein L_{AA4}(E1)(R1)(R1)(R1) to L_{AA4}(E40)(R110)(R110)( R110) have the structure | 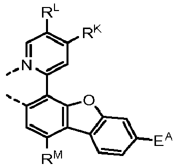 |
| L_{AA5}(E^{A})(R*^{K}*)(R*^{L}*)(R*^{M}*), wherein L_{AA5}(E1)(R1)(R1)(R1) to L_{AA5}(E40)(R110)(R110)( R110) have the structure | 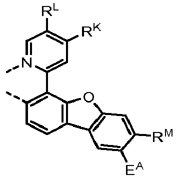 | L_{AA6}(E^{A})(R*^{K})*(R*^{L}*)(R*^{M}*), wherein L_{AA6}(E1)(R1)(R1)(R1) to L_{AA6}(E40)(R110)(R110)( R110) have the structure | 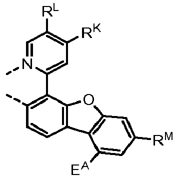 |
| L_{AA7}(E^{A})(R*^{K}*)(R*^{L}*)(R*^{M}*), wherein L_{AA7}(E1)(R1)(R1)(R1) to L_{AA7}(E40)(R110)(R110)( R110) have the structure | 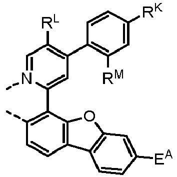 | L_{AA8}(E^{A})(R*^{K}*)(R*^{L}*)(R*^{M}*), wherein L_{AA8}(E1)(R1)(R1)(R1) to L_{AA8}(E40)(R110)(R110)( R110) have the structure | 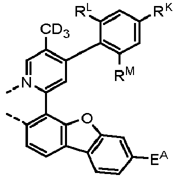 |
| L_{AA9}(E^{A})(R*^{K}*)(R*^{L}*)(R*^{M}*), wherein L_{AA9}(E1)(R1)(R1)(R1) to L_{AA9}(E40)(R110)(R110)( R110) have the structure | 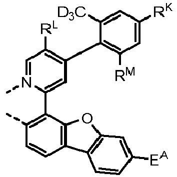 | L_{AA10}(E^{A})(R*^{K}*)(R*^{L}*)(R*^{M}*), wherein L_{AA10}(E1)(R1)(R1)(R1) to L_{AA10}(E40)(R110)(R110)( R110) have the structure | 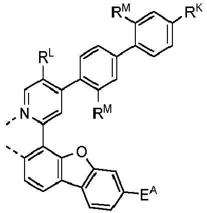 |
| L_{AA11}(E^{A})(R*^{K}*)(R*^{L}*)(R*^{M}*), wherein L_{AA11}(E1)(R1)(R1)(R51) to L_{AA11}(E40)(R110)(R110)( R110) have the structure | 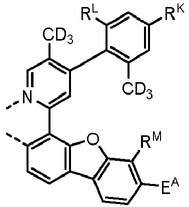 | L_{AA12}(E^{A})(R*^{K}*)(R*^{L}*)(R*^{M}*), wherein L_{AA12}(E1)(R1)(R1)(R51) to L_{AA12}(E40)(R110)(R110)( R110) have the structure | 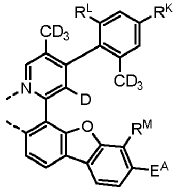 |
| L_{AA13}(E^{A})(R*^{K}*)(R*^{L}*)(R*^{M}*), wherein L_{AA13}(E1)(R1)(R1)(R51) to L_{AA13}(E40)(R110)(R110)( R110) have the structure | 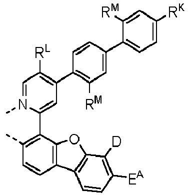 | L_{AA14}(E^{A})(R*^{K}*)(R*^{L}*)(R*^{M}*), wherein L_{AA14}(E1)(R1)(R1)(R51) to L_{AA14}(E40)(R110)(R110)( R110) have the structure | 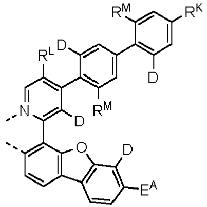 |

wherein, when L_{A} is selected from the group consisting of L_{AA'o}(E^{A})(R*^{K}*)(R*^{L}*)(R*^{M}*), o is an integer from 1 to 14; E^{A} is selected from E1 to E40; R^{K} is selected from the group consisting of R71 to R110; when o is 1, R^{L} is selected from the group consising of 51 to 110; when o is 2-14, R^{L} is selected from the group consising of 51 to 110; when o is 1 to 10, R^{M} is selected from the group consising of 1 to 90; when o is 11 to 14, R^{M} is selected from the group consising of 51 to 110; and each of L_{AA'1}(E1)(R71)(R51)(R1) to L_{AA'14}(E40)(R110)(R110)(R110) has a structure defined as follows:

| L_{AA'} | Structure of L_{AA'} | L_{AA'} | Structure of L_{AA'} |
|---|---|---|---|
| L_{AA'1}(E^{A})(R*^{K}*)(R*^{L}*)(R*^{M}*), wherein L_{AA'1}(E1)(R71)(R51)(R1) to L_{AA'1}(E40)(R110)(R110)( R110) have the structure | 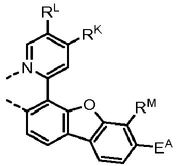 | L_{AA'2}(E^{A})(R*^{K}*)(R*^{L}*)(R*^{M}*), wherein L_{AA'2}(E1)(R71)(R1)(R1) to L_{AA'2}(E40)(R110)(R110)( R110) have the structure | 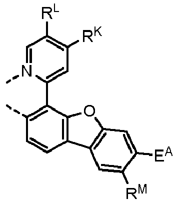 |
| L_{AA'3}(E^{A})(R*^{K}*)(R*^{L}*)(R*^{M}*), wherein L_{AA'3}(E1)(R71)(R1)(R1) to L_{AA3}(E40)(R110)(R110)( R110) have the structure | 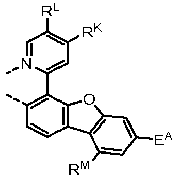 | L_{AA'4}(E^{A})(R*^{K}*)(R*^{L}*)(R*^{M}*), wherein L_{AA'4}(E1)(R71)(R1)(R1) to L_{AA'4}(E40)(R110)(R110)( R110) have the structure | 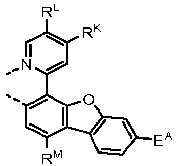 |
| L_{AA'5}(E^{A})(R*^{K}*)(R*^{L}*)(R*^{M}*), wherein L_{AA'5}(E1)(R71)(R1)(R1) to L_{AA'5}(E40)(R110)(R110)( R110) have the structure | 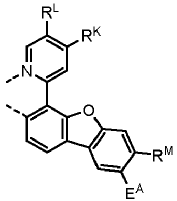 | L_{AA'6}(E^{A})(R*^{K}*)(R*^{L}*)(R*^{M}*), wherein L_{AA'6}(E1)(R71)(R1)(R1) to L_{AA'6}(E40)(R110)(R110)( R110) have the structure | 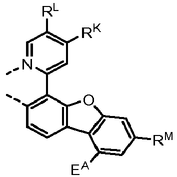 |
| L_{AA'7}(E^{A})(R*^{K}*)(R*^{L}*)(R*^{M}*), wherein L_{AA'7}(E1)(R71)(R1)(R1) to L_{AA'7}(E40)(R110)(R110)( R110) have the structure | 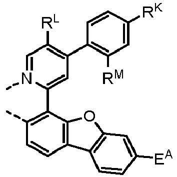 | L_{AA'8}(E^{A})(R*^{K}*)(R*^{L}*)(R*^{M}*), wherein L_{AA'8}(E1)(R71)(R1)(R1) to L_{AA'8}(E40)(R110)(R110)( R110) have the structure | 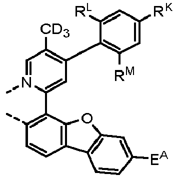 |
| L_{AA'9}(E^{A})(R*^{K}*)(R*^{L}*)(R*^{M}*), wherein L_{AA'953}(R71)(R1)(R1) to L_{AA9}(E40)(R110)(R110)( R110) have the structure | 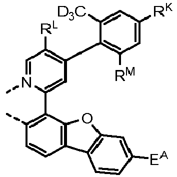 | L_{AA'10}(E^{A})(R*^{K}*)(R*^{L}*)(R*^{M}*), wherein L_{AA'10}(E1)(R71)(R1)(R1) to L_{AA'10}(E40)(R110)(R110) (R110) have the structure | 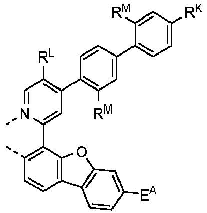 |
| L_{AA'11}(E^{A})(R*^{K}*)(R*^{L}*)(R*^{M}*), wherein L_{AA'11}(E1)(R71)(R1)(R51 ) to L_{AA'11}(E40)(R110)(R110) (R110) have the structure | 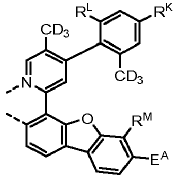 | L_{AA'12}(E^{A})(R*^{K}*)(R*^{L}*)(R*^{M}*)^{,} wherein L_{AA'12}(E1)(R71)(R1)(R51 ) to L_{AA'12}(E40)(R110)(R110) (R110) have the structure | 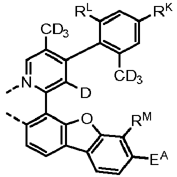 |
| L_{AA'13}(E^{A})(R*^{K}*)(R*^{L}*)(R*^{M}*), wherein L_{AA'13}(E1)(R71)(R1)(R51 ) to L_{AA'13}(E40)(R110)(R110) (R110) have the structure | 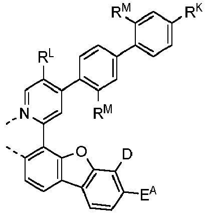 | L_{AA'14}(E^{A})(R*^{K}*)(R*^{L}*)(R*^{M}*), wherein L_{AA'14}(E1)(R71)(R1)(R51 ) to L_{AA'14}(E40)(R110)(R110) (R110) have the structure | 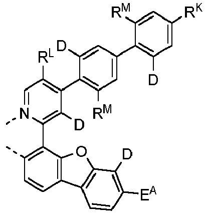 |

wherein R1 to R110 have the structures defined as follows: 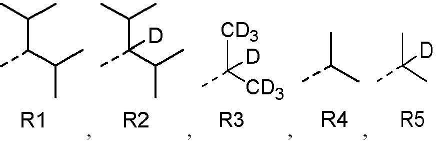 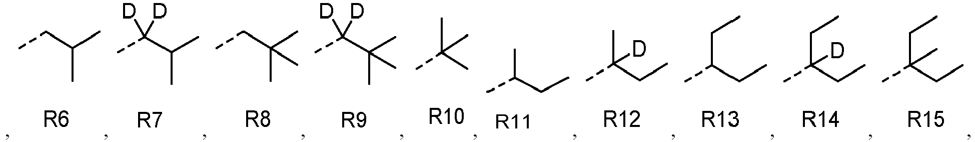 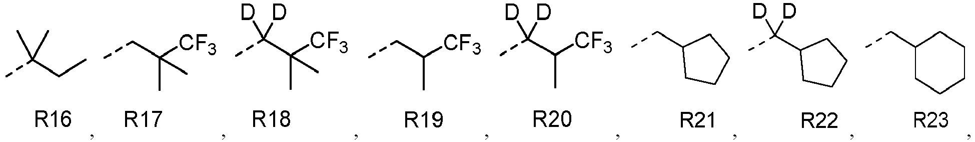 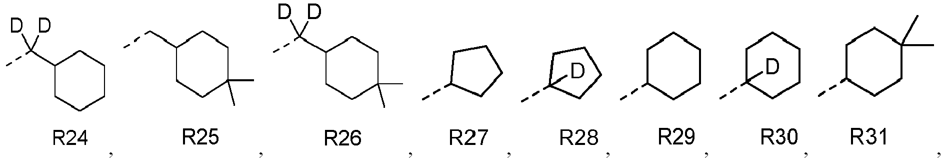 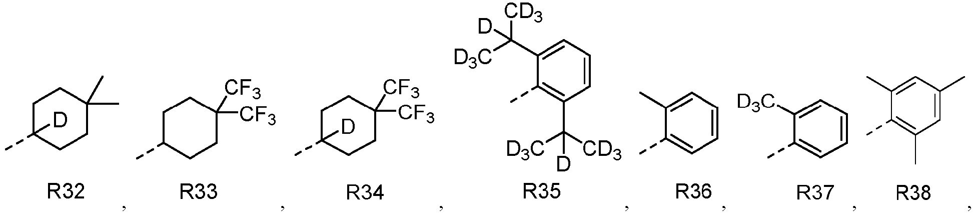 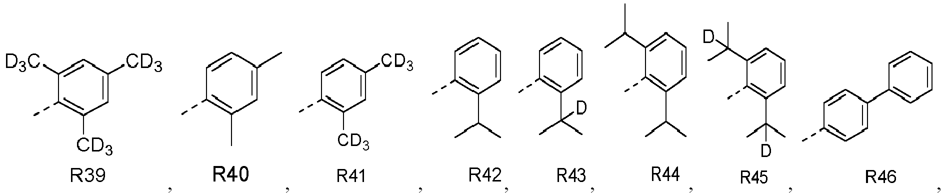 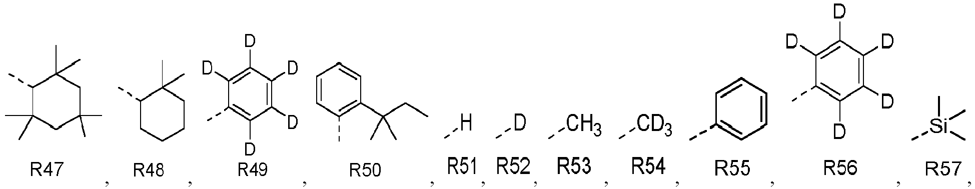 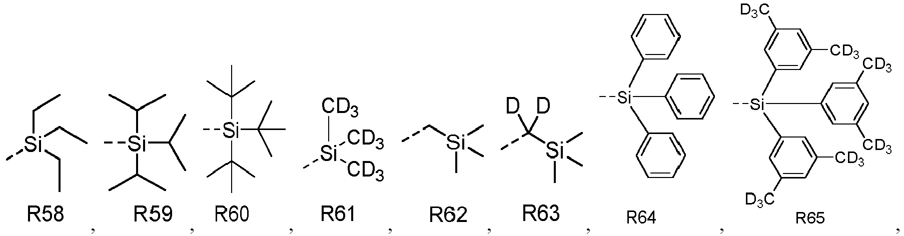 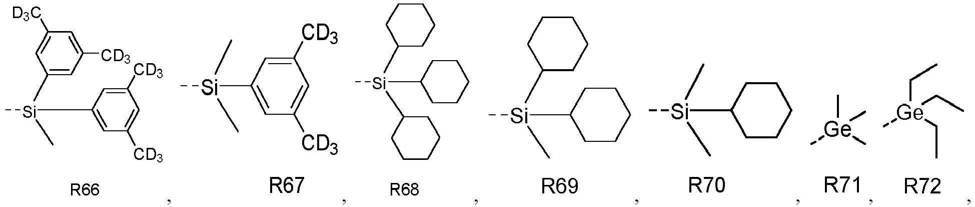 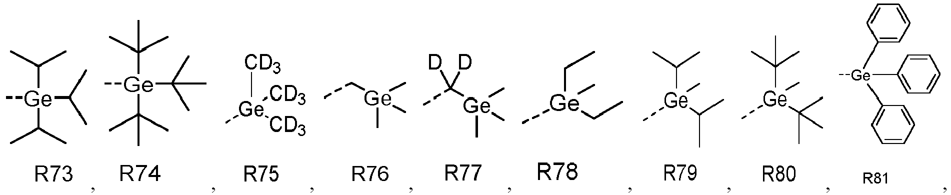 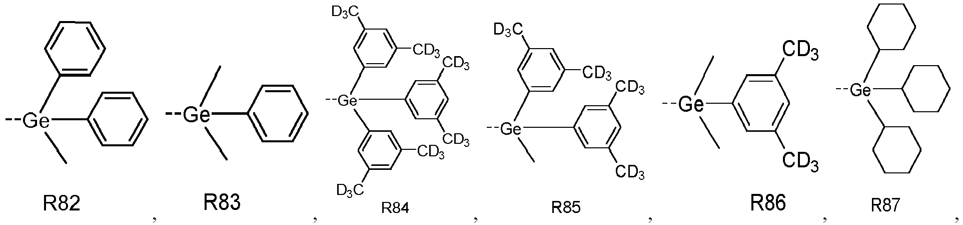 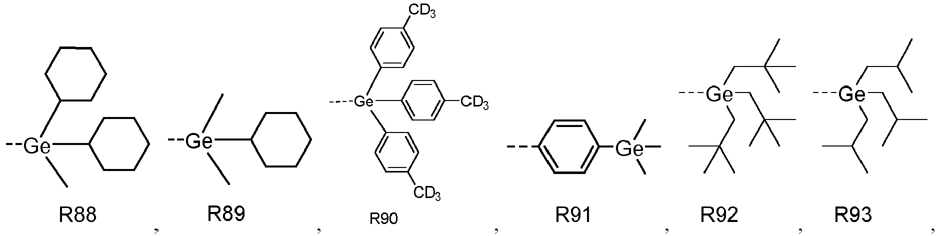 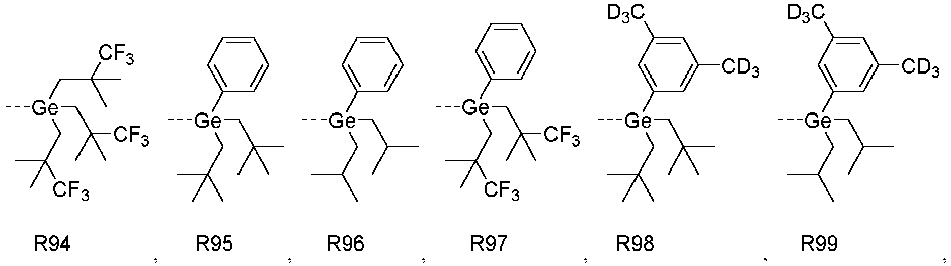 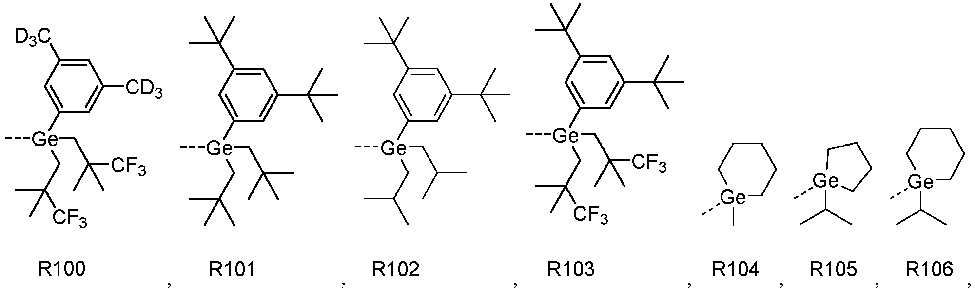 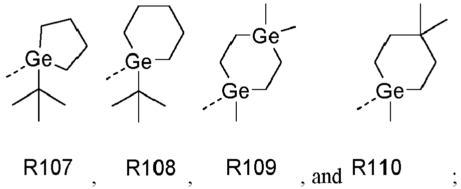 wherein each of E1 to E40 has the structure defined as follows: 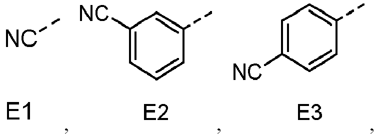 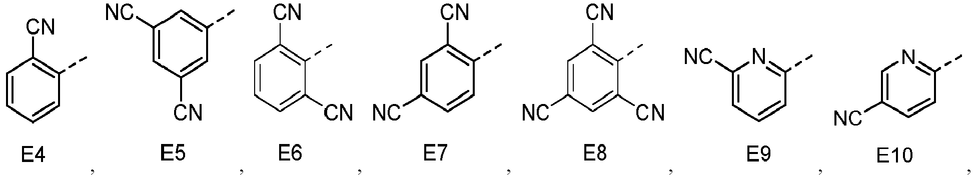 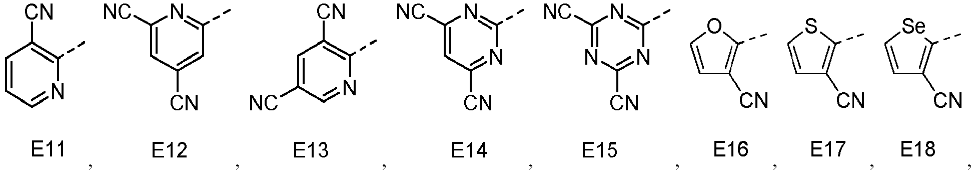 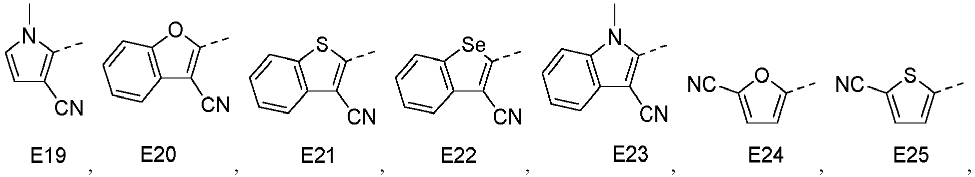 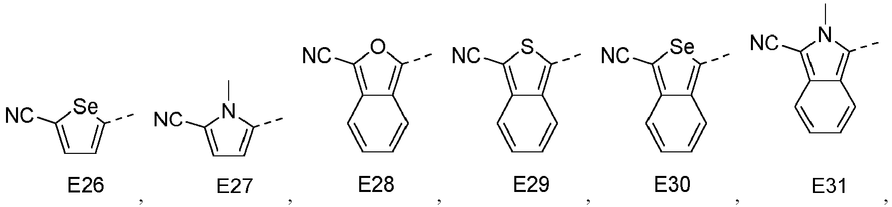 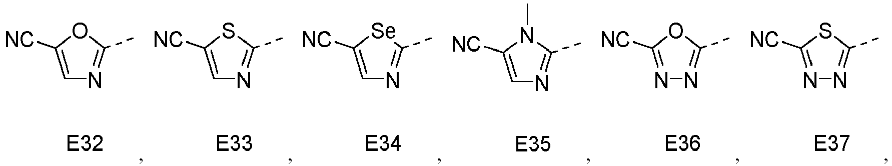 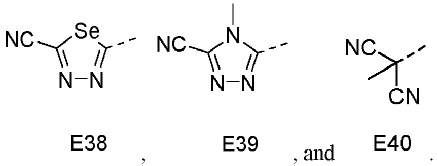 13. The compound of item 1, wherein the compound has a formula selected from the group consisting of Ir(L_{A})₃, Ir(L_{A})(L_{B})₂, Ir(L_{A})₂(L_{B}), Ir(L_{A})₂(L_{C}), and Ir(L_{A})(L_{B})(L_{C}); and wherein L_{A}, L_{B}, and L_{C} are different from each other.
14. The compound of item 1, wherein L_{B} and Lc are each independently selected from the group consisting of: 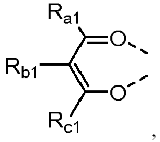 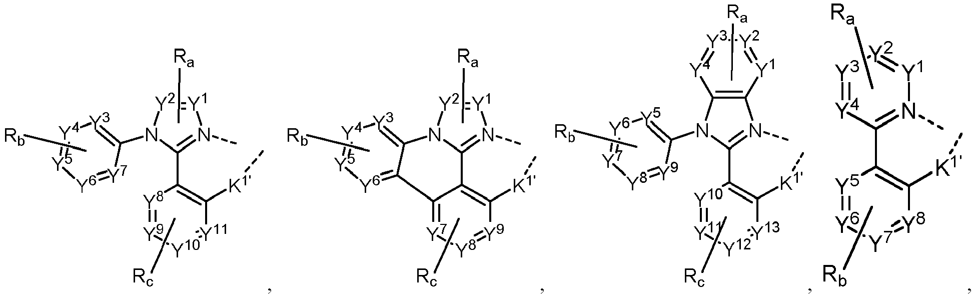 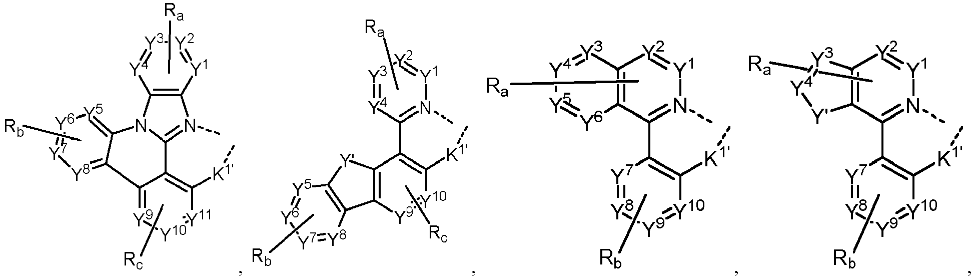 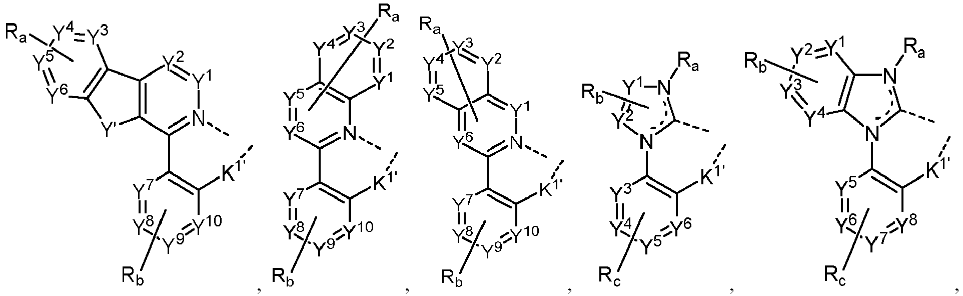 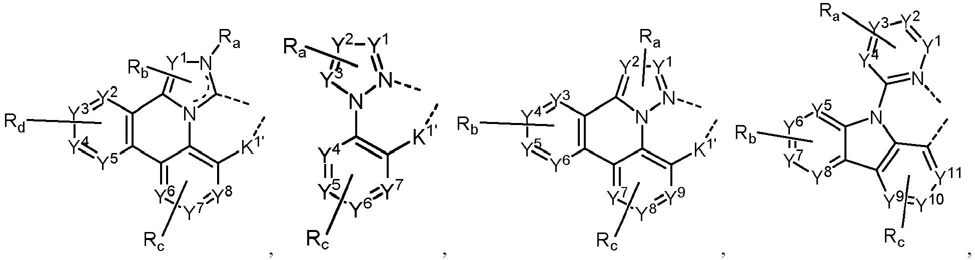 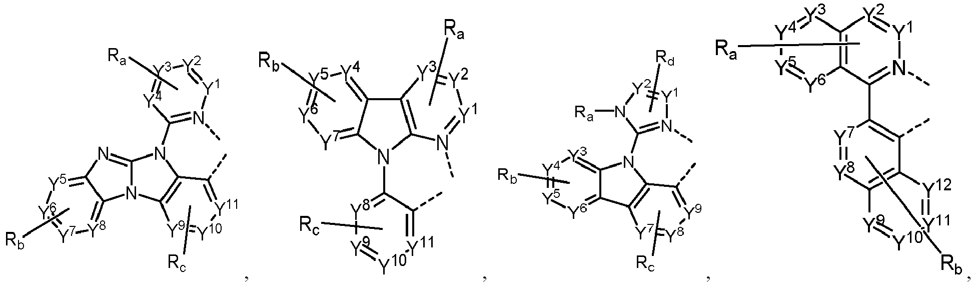 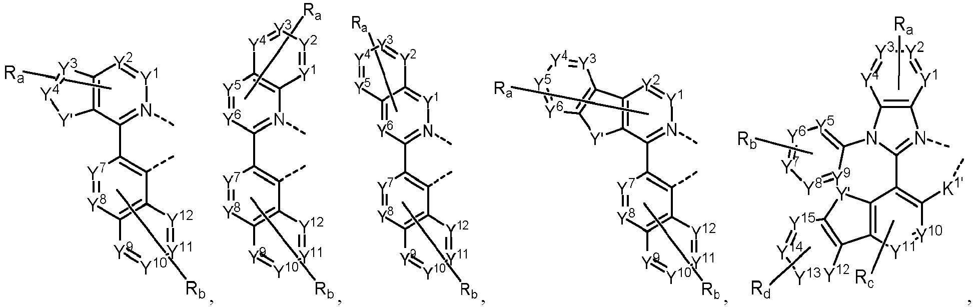 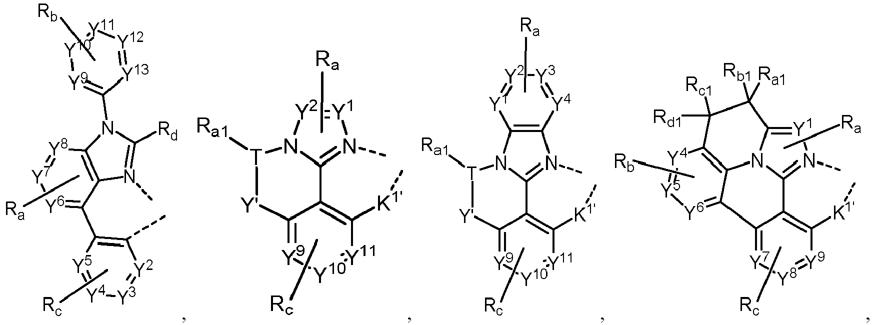 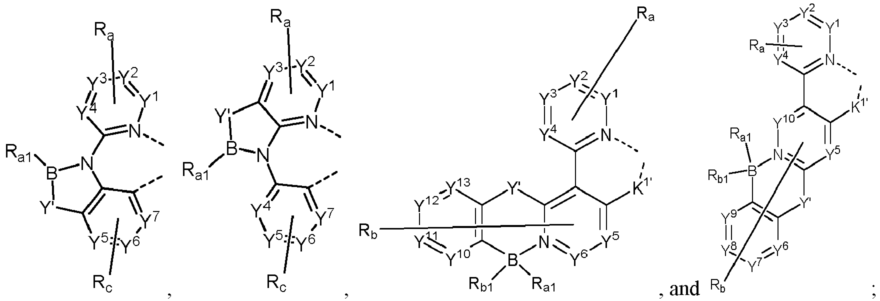 wherein:
T is selected from the group consisting of B, Al, Ga, and In;
K^{1'} is selected from the group consisting of a single bond, O, S, NRₑ, PRₑ, BRₑ, CRₑR_{f}, and SiRₑR_{f};
each of Y¹ to Y¹³ is independently selected from the group consisting of C and N;
Y' is selected from the group consisting of BRₑ, BRₑR_{f}, NRₑ, PRₑ, P(O)Rₑ, O, S, Se, C=O, C=S, C=Se, C=NRₑ, C=CRₑR_{f}, S=O, SO₂, CRₑR_{f}, SiRₑR_{f}, and GeRₑR_{f};
Rₑ and R_{f} can be fused or joined to form a ring;
each Rₐ, R_{b}, R_{c}, and R_{d} independently represents from mono to the maximum allowed number of substitutions, or no substitution;
each of Rₐ₁, R_{b1}, R_{c1}, R_{d1}, Rₐ, R_{b}, R_{c}, R_{d}, Rₑ, and R_{f} is independently a hydrogen or a subsituent selected from the group consisting of deuterium, halide, alkyl, cycloalkyl, heteroalkyl, arylalkyl, alkoxy, aryloxy, amino, silyl, germyl, boryl, alkenyl, cycloalkenyl, heteroalkenyl, alkynyl, aryl, heteroaryl, acyl, carbonyl, carboxylic acid, ester, nitrile, isonitrile, sulfanyl, selenyl, sulfinyl, sulfonyl, phosphino, and combinations thereof; and
any two substituents of Rₐ₁, R_{b1}, R_{c1}, R_{d1}, Rₐ, R_{b}, R_{c}, and R_{d} can be fused or joined to form a ring or form a multidentate ligand.
15. The compound of item 13, wherein the compound has formula Ir(L_{A})₃, formula Ir(L_{A})(L_{B*k*})₂, formula Ir(L_{A})₂(L_{B*k*}), formula Ir(L_{A})₂(L_{C*j*-I}), or formula lr(L_{A})₂(L_{*Cj*-II}),
wherein L_{A} is selected from any L_{A} as defined herein, including the structures of L_{Ai}(E^{A})(R*^{K}*)(R*^{L}*)(R*^{M}*), L_{A'm}(E^{A})(R*^{K}*)(R*^{L}*)(R*^{M}*), L_{AAn}(E^{A})(R*^{K}*)(R*^{L}*)(R*^{M}*), and L_{AA'o}(E^{A})(R*^{K}*)(R*^{L}*)(R*^{M}*);
wherein k is an integer from 1 to 520;
wherein j is an integer from 1 to 1416;
with the provisos that:
when L_{A} is selected from the group consisting of L_{Ai}(E1)(R*^{K}*)(R*^{L}*)(R*^{M}*), k is an integer from 475 to 520; and
when L_{A} is selected from the group consisting of L_{AAn}(E1)(R*^{K}*)(R*^{L}*)(R*^{M}*), k is an integer from 475 to 490;
when L_{A} is selected from the group consisting of L_{AA'o}(E1)(R*^{K}*)(R*^{L}*)(R*^{M}*), k is an integer from 1 to 490;
wherein k is an integer from 1 to 520; and each L_{B*k*} has the structure defined as follows: 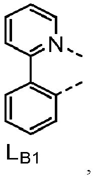 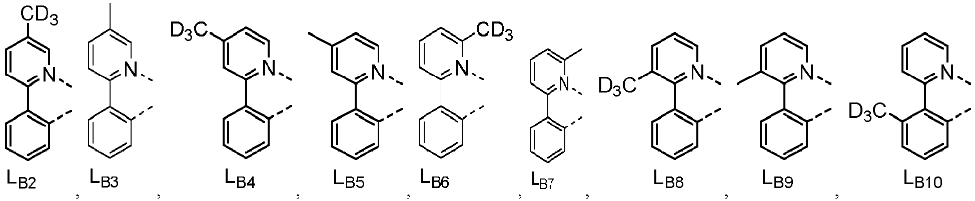 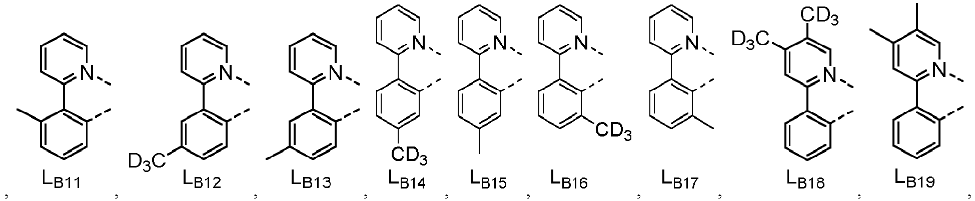 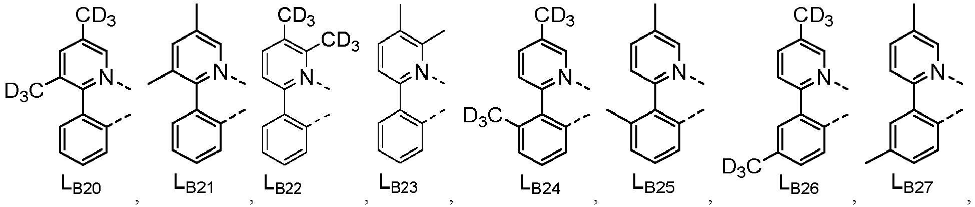 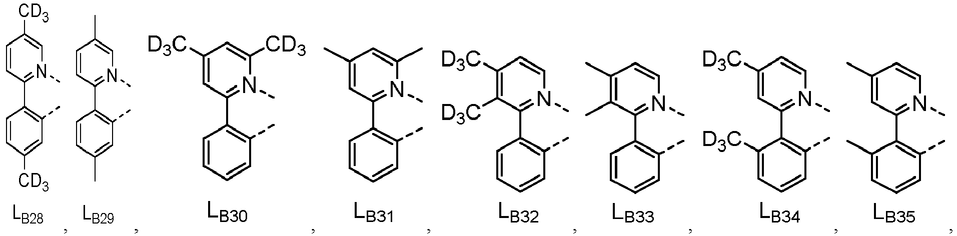 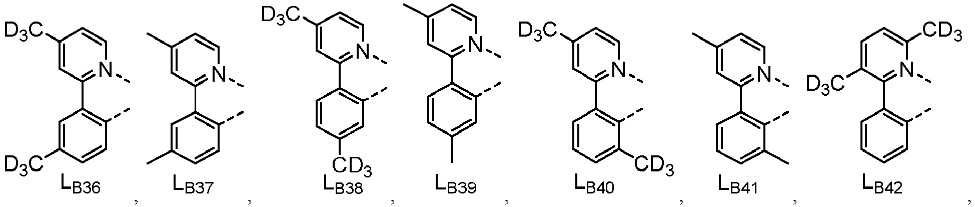 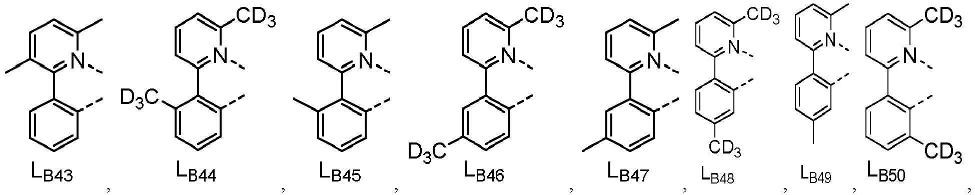 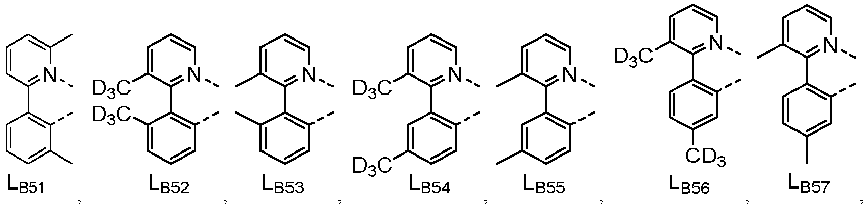 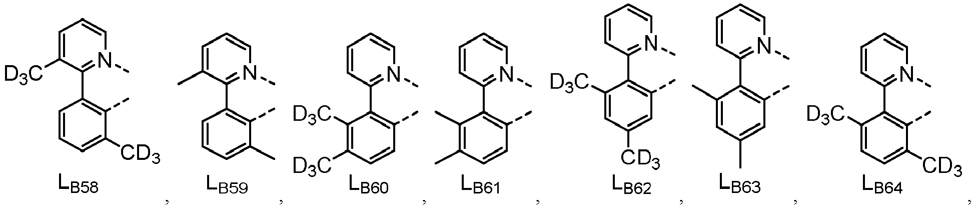 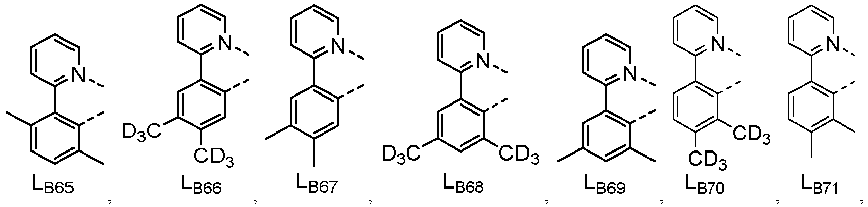 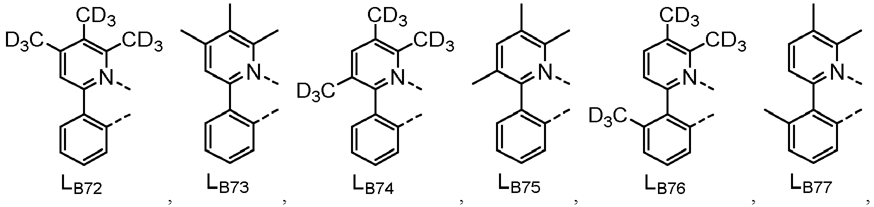 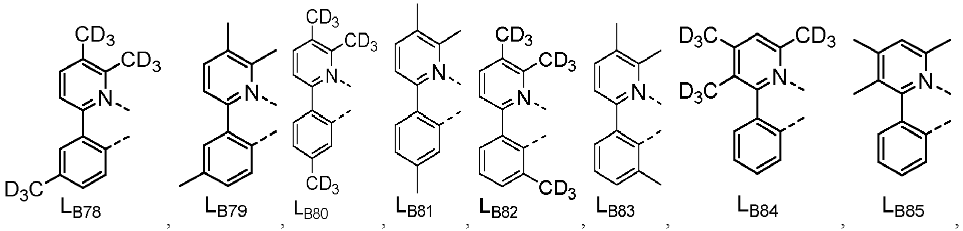 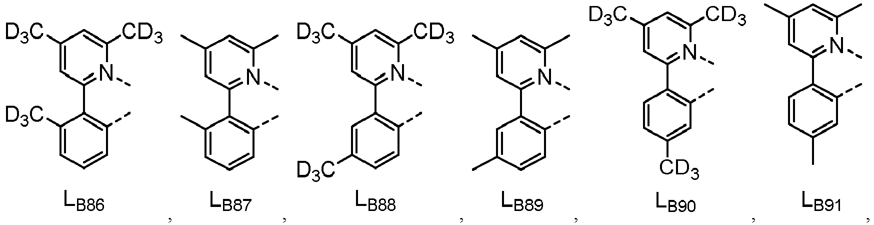 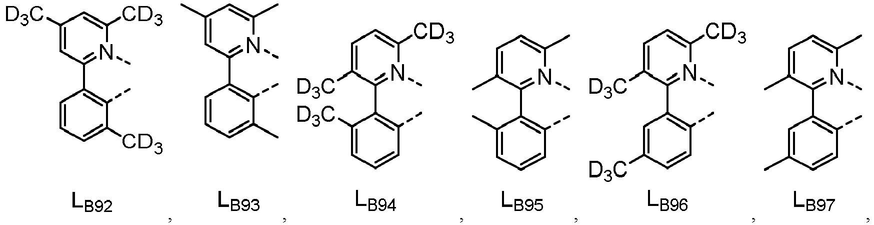 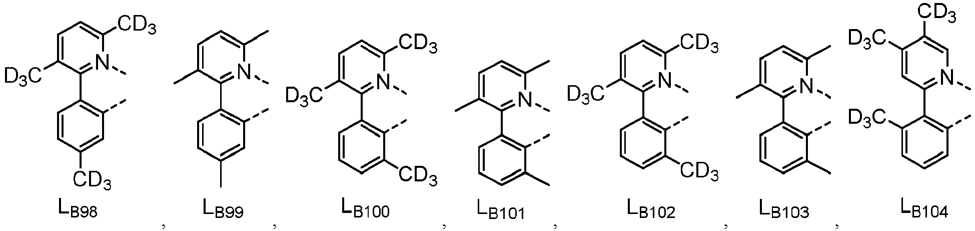 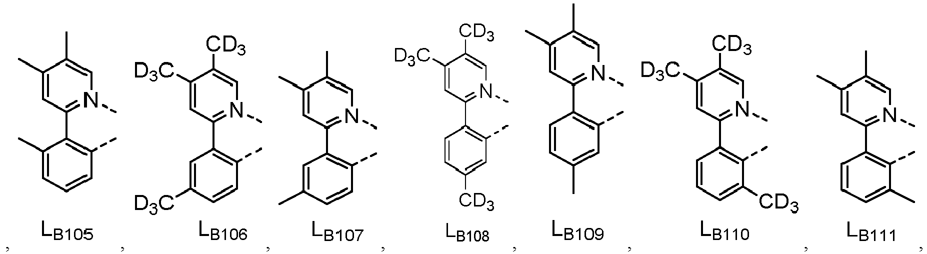 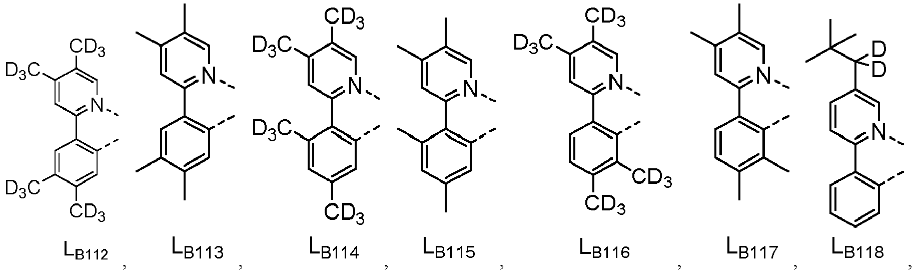 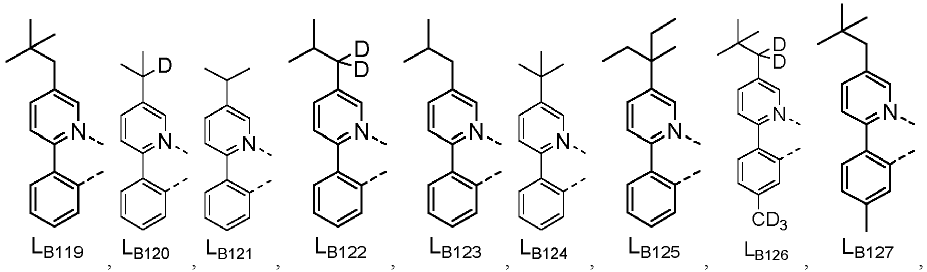 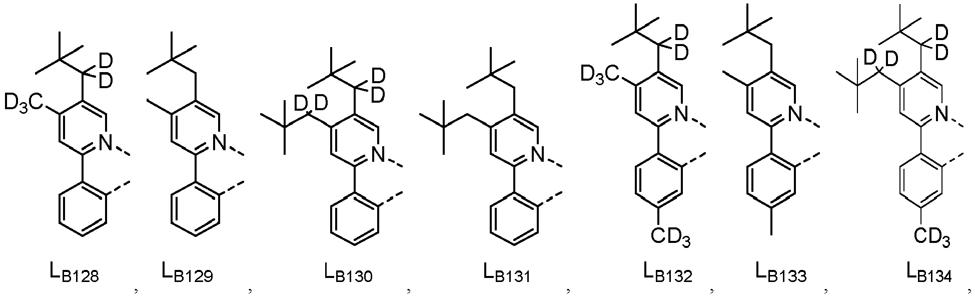 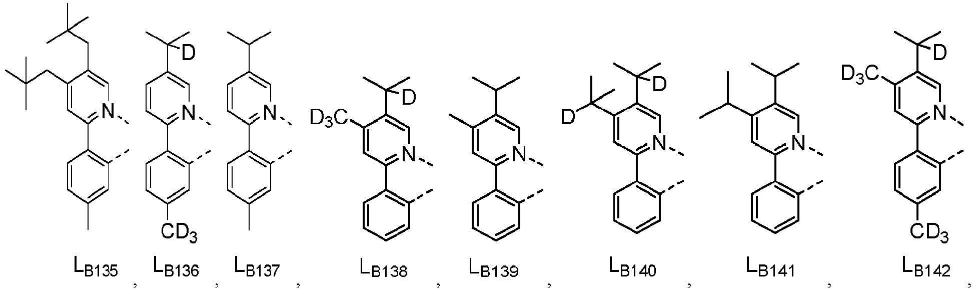 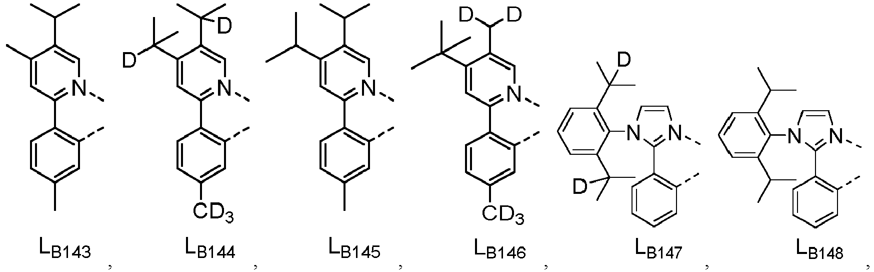 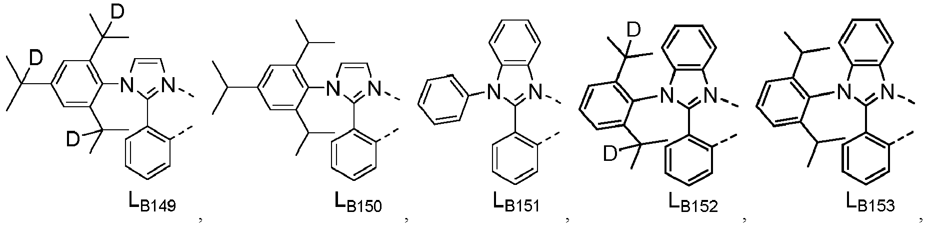 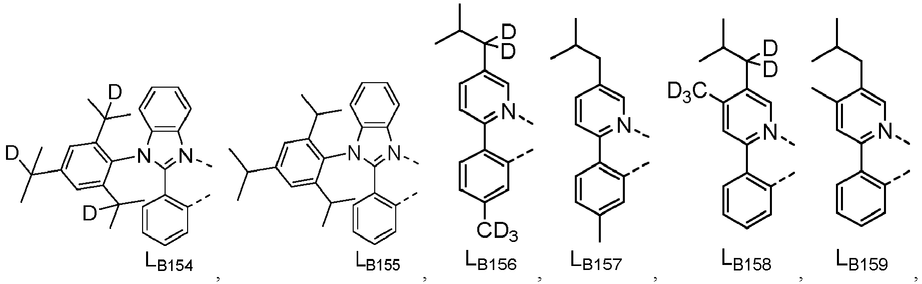 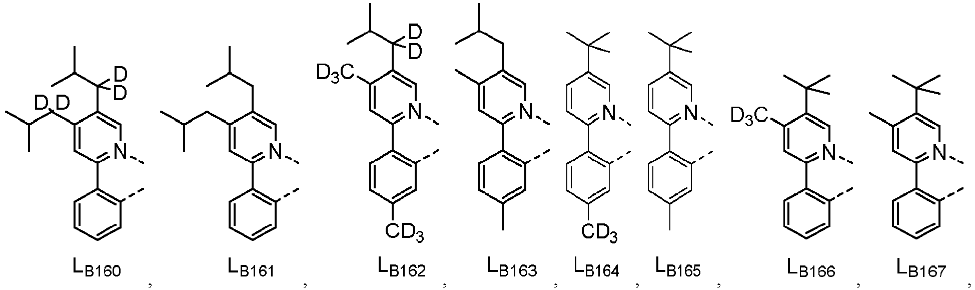 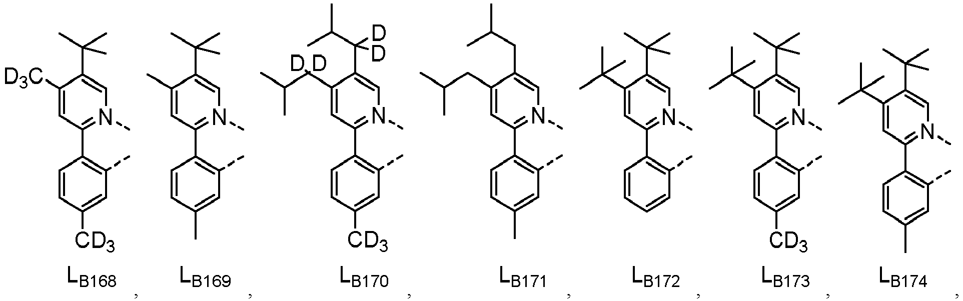 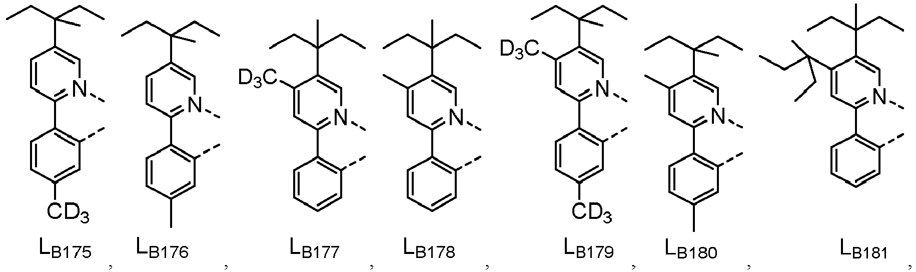 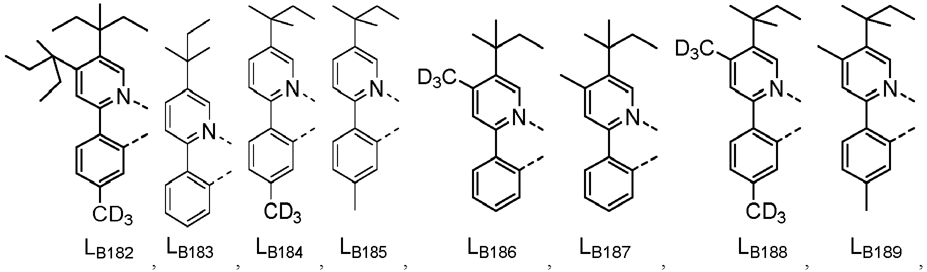 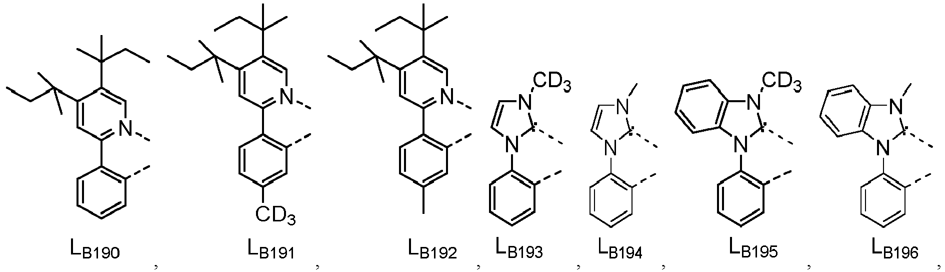 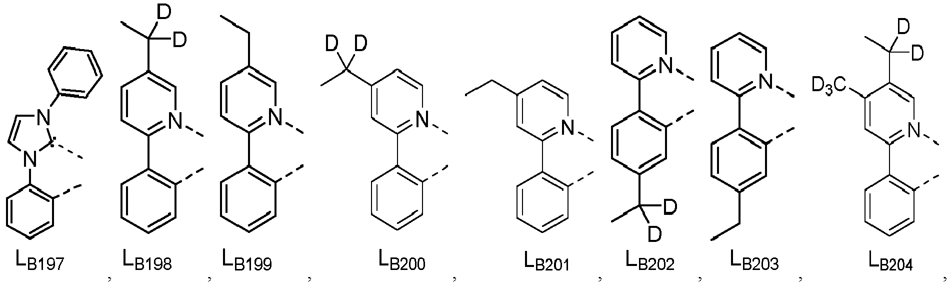 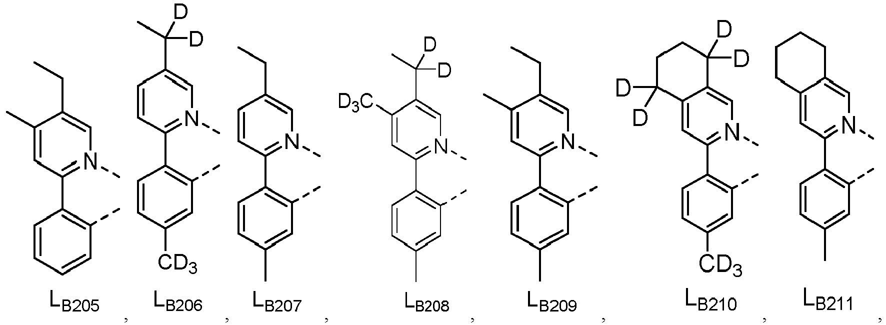 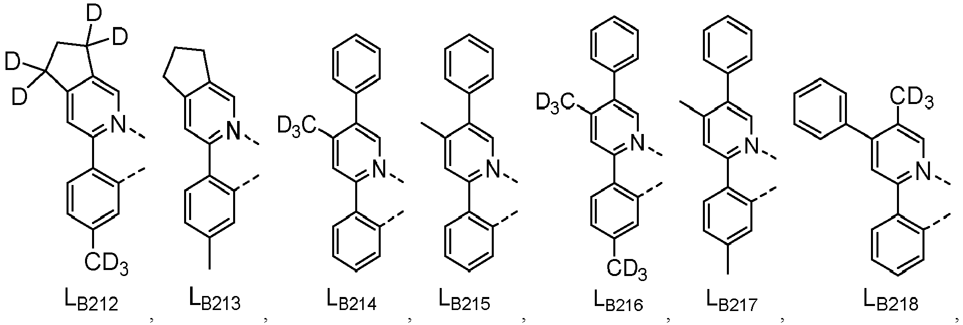 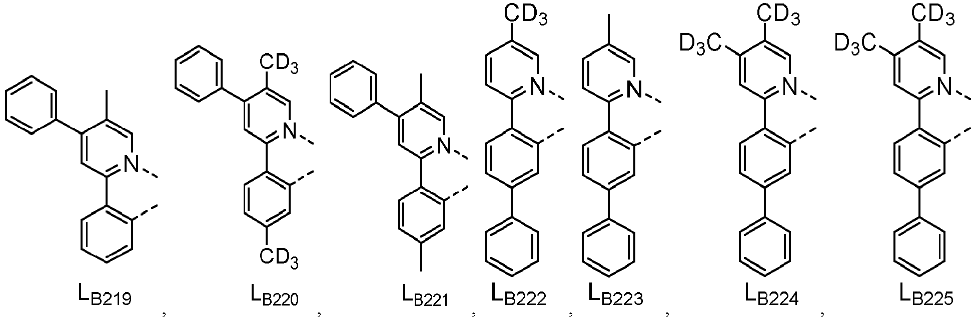 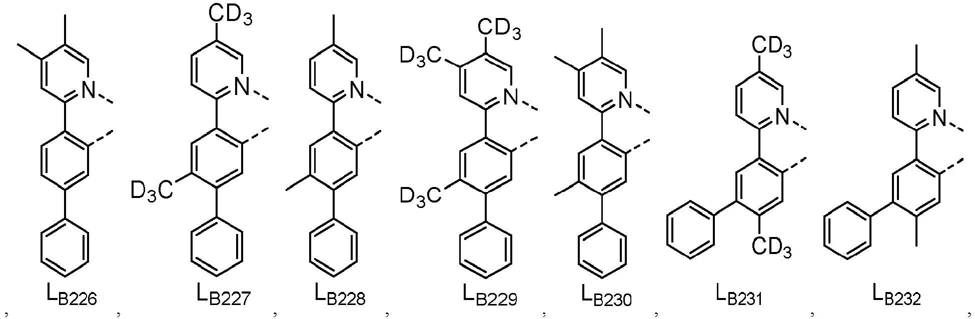 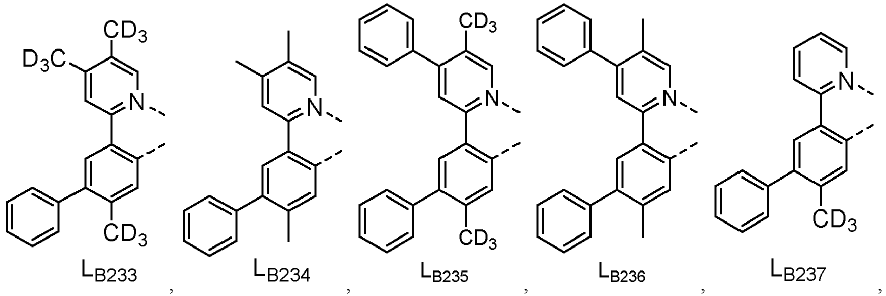 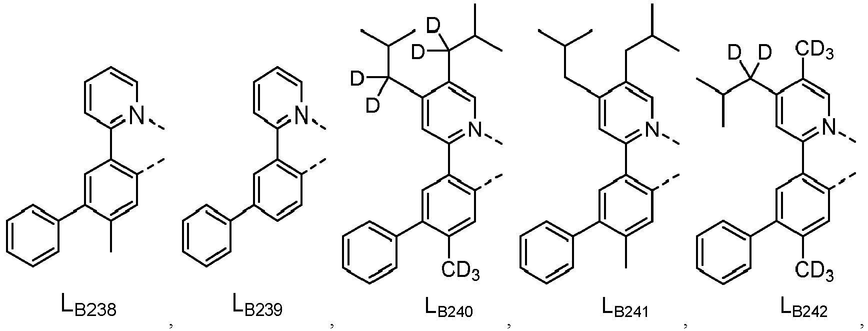 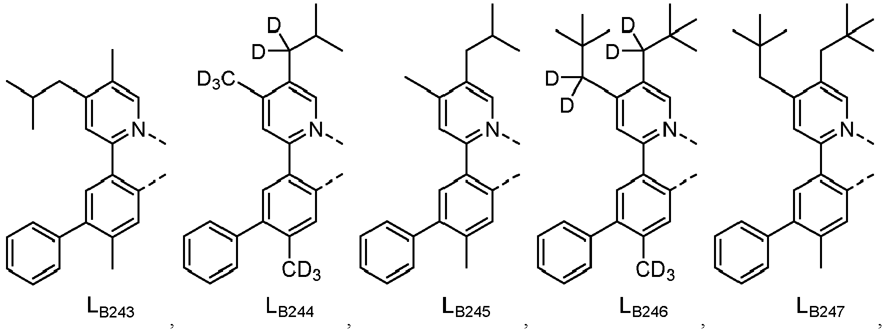 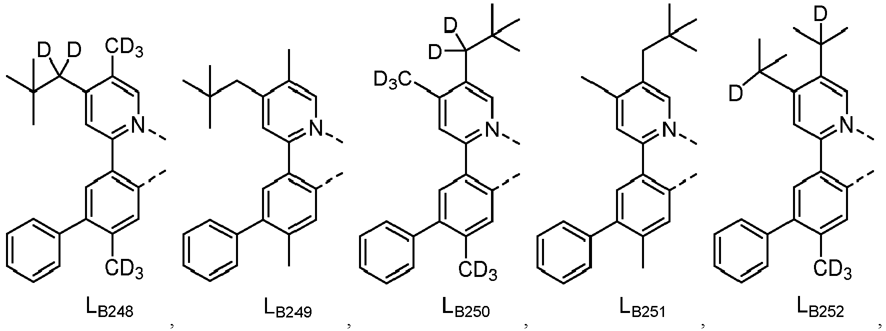 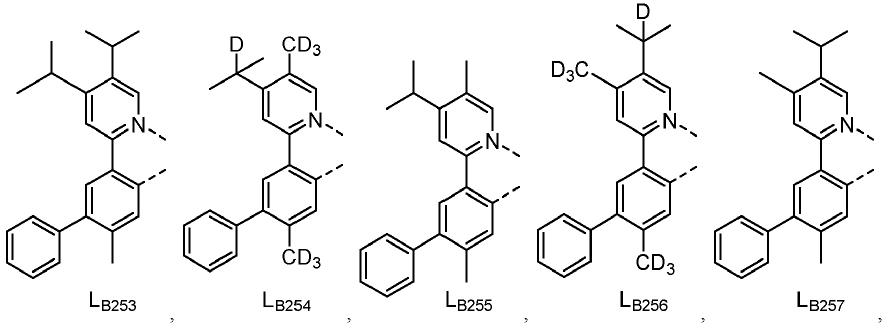 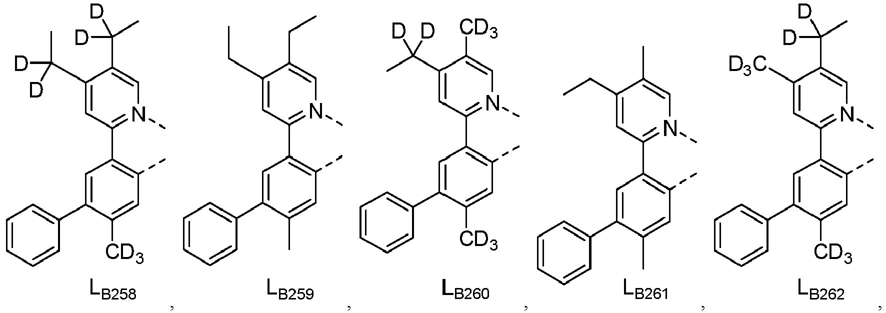 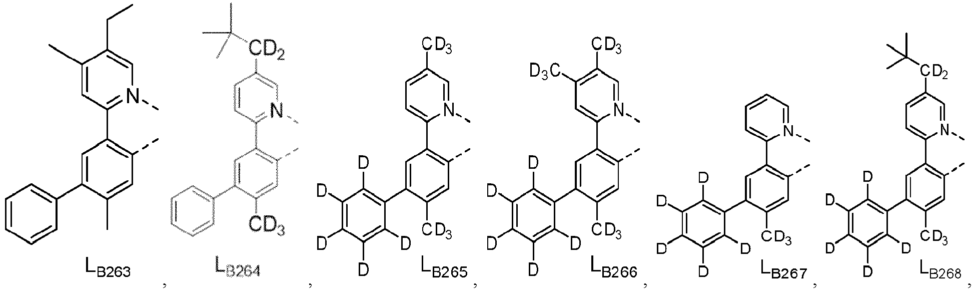 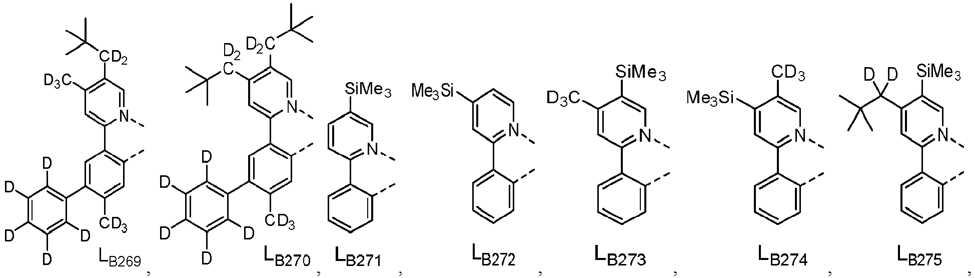 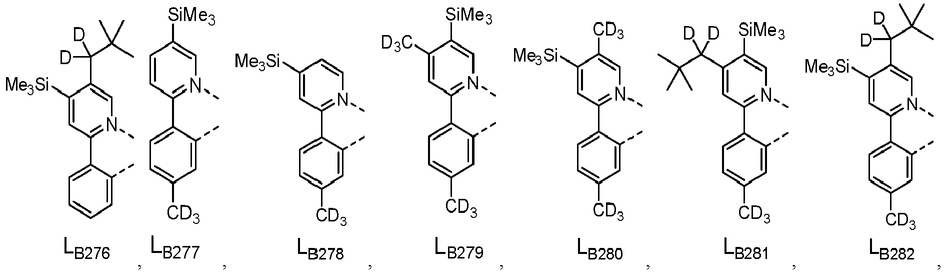 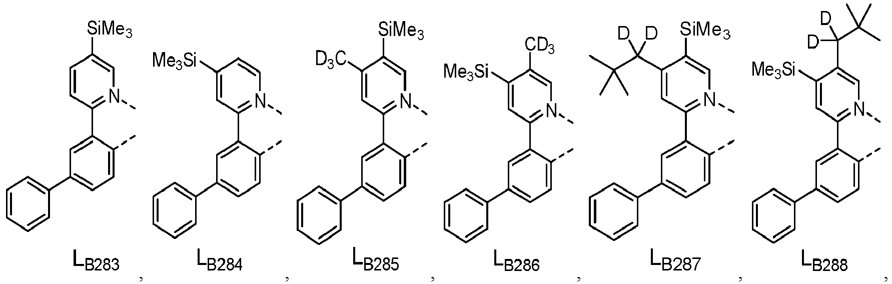 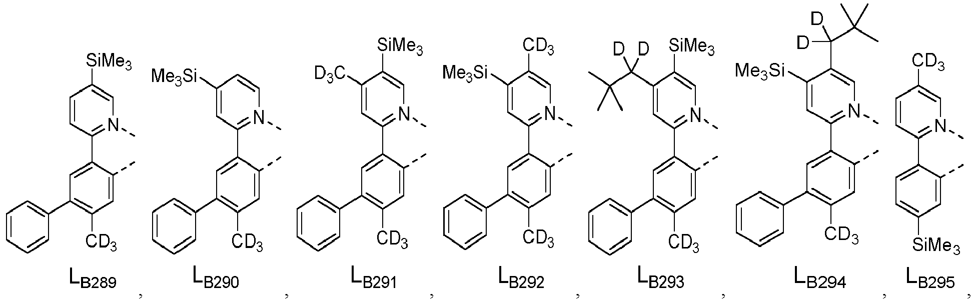 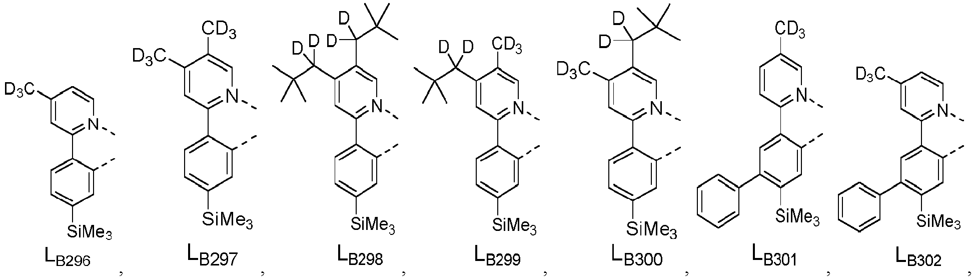 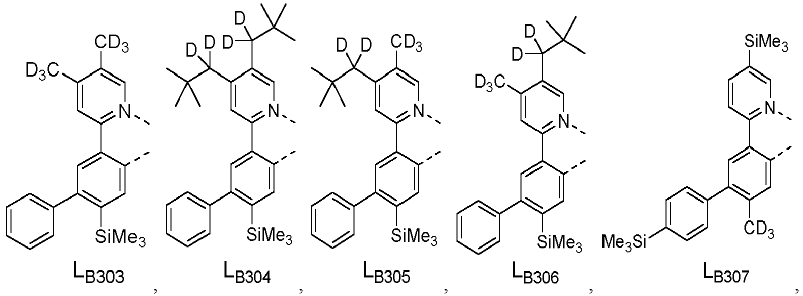 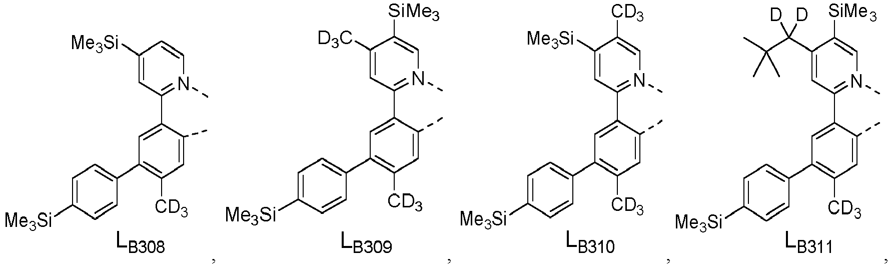 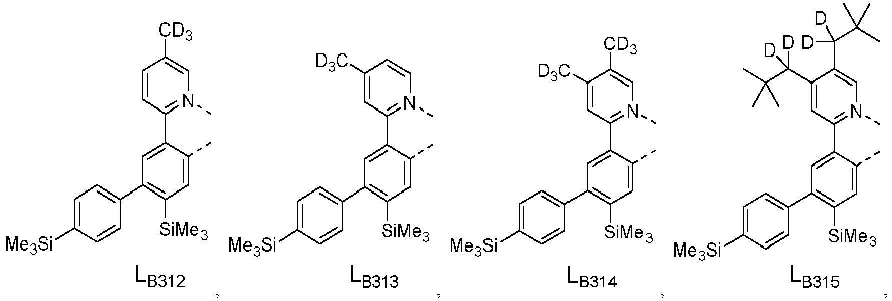 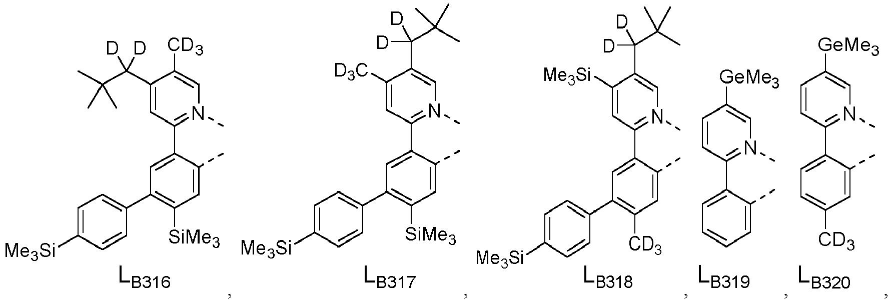 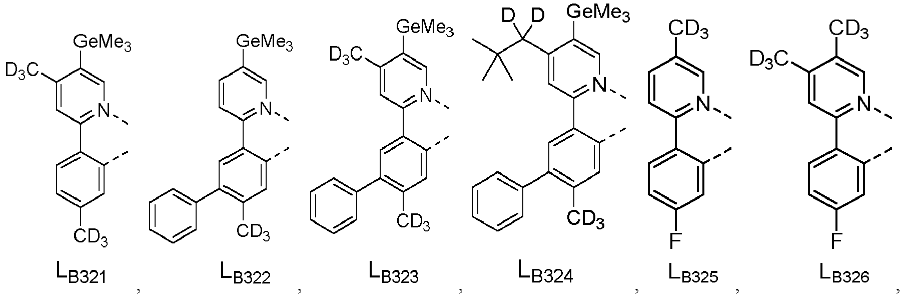 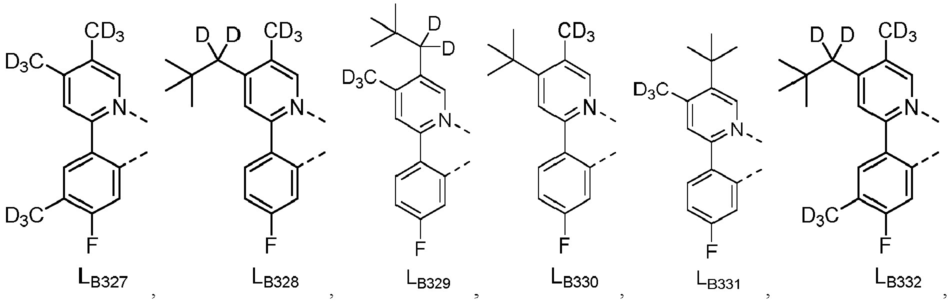 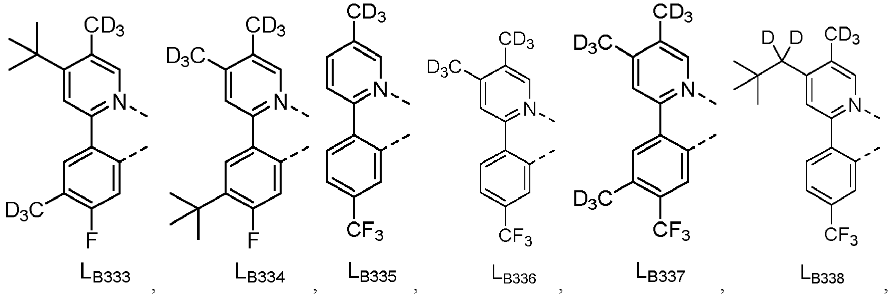 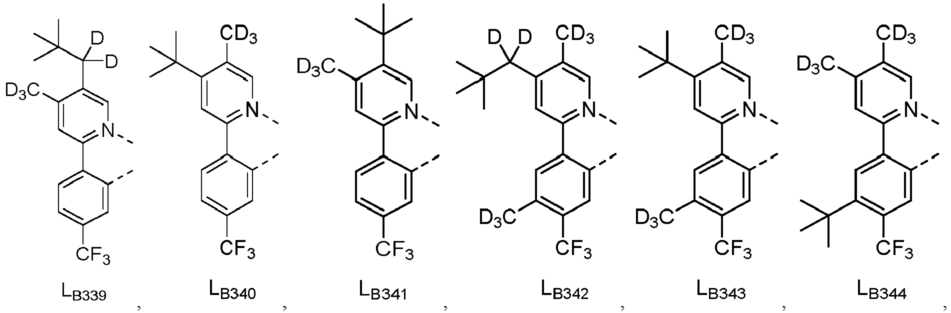 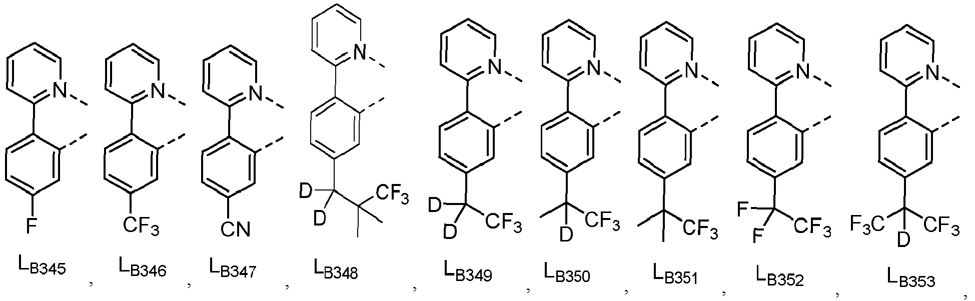 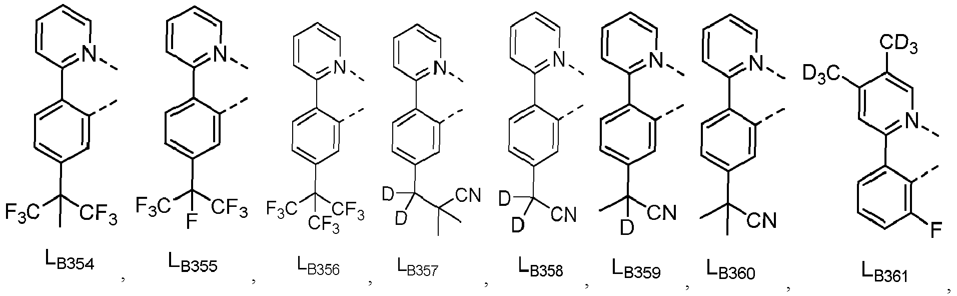 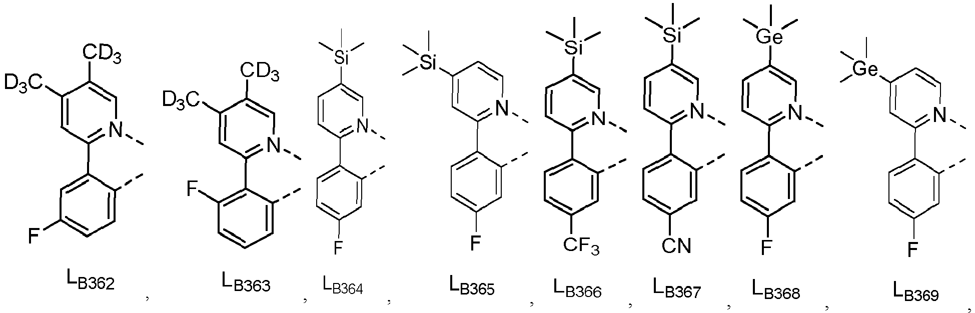 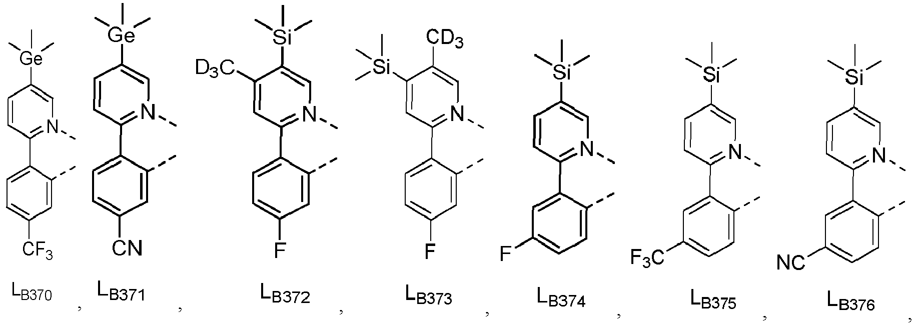 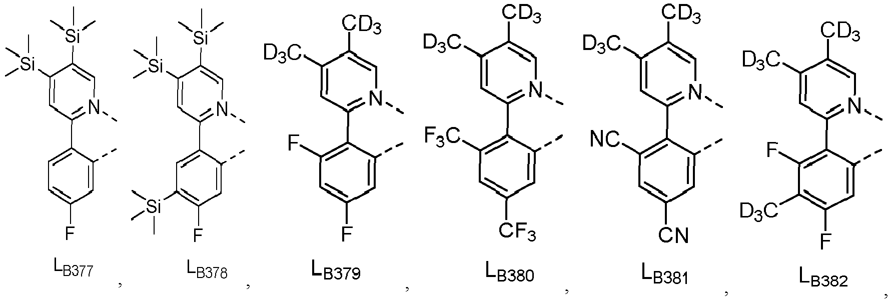 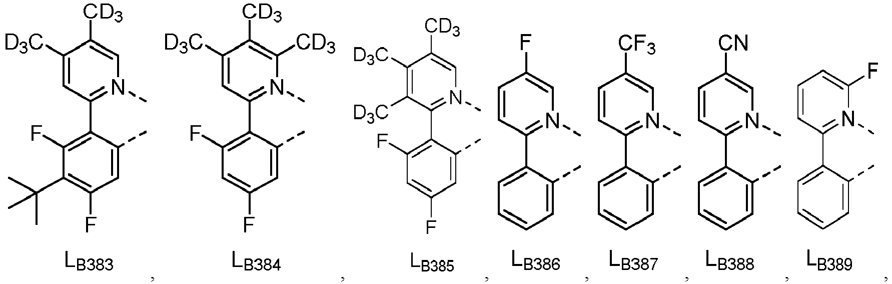 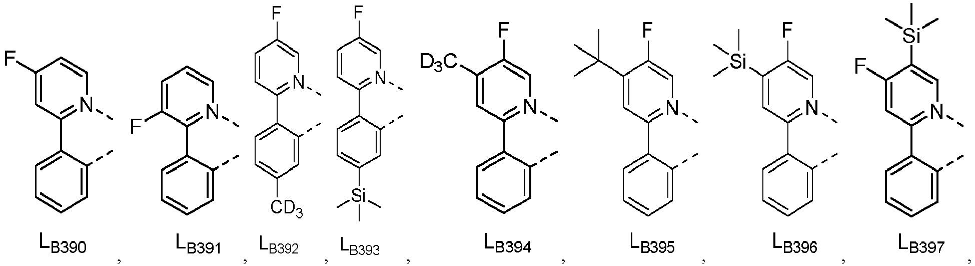 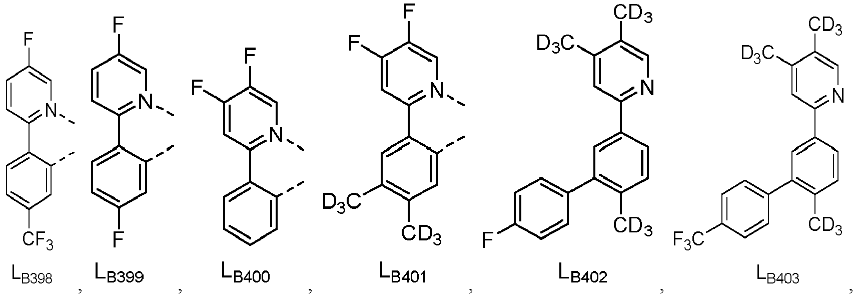 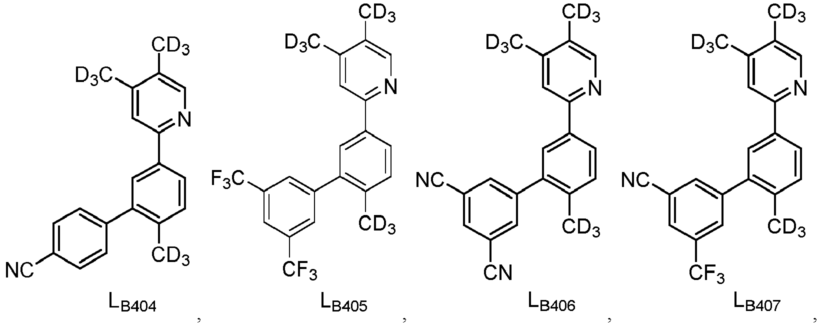 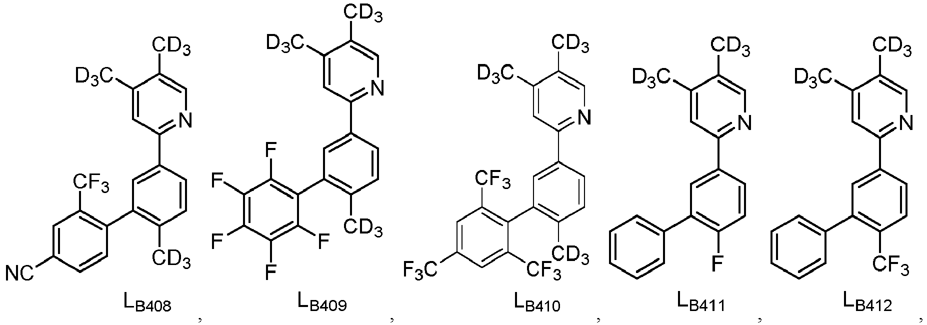 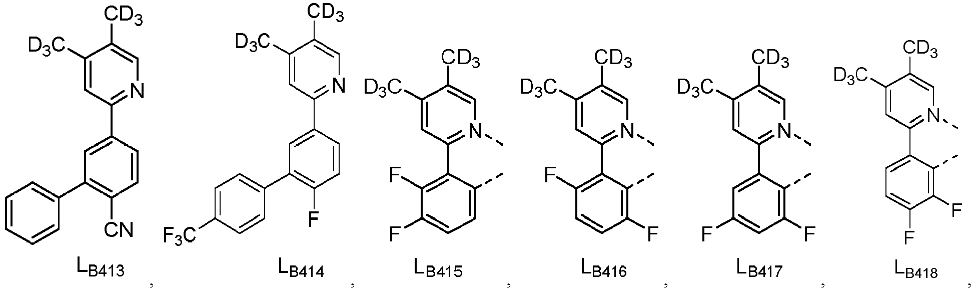 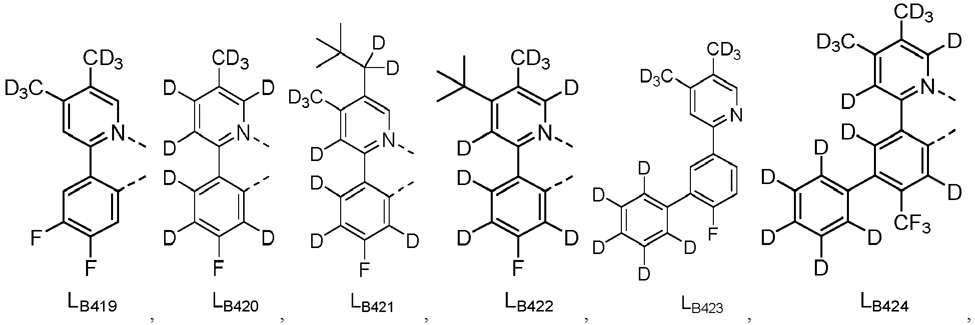 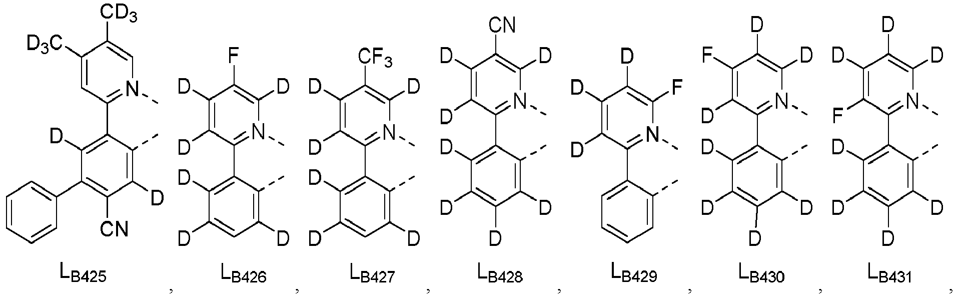 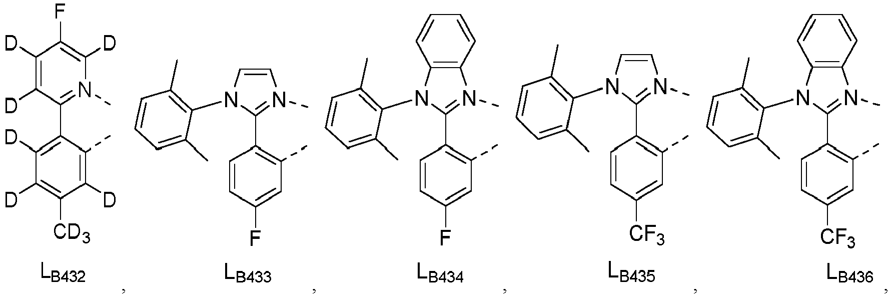 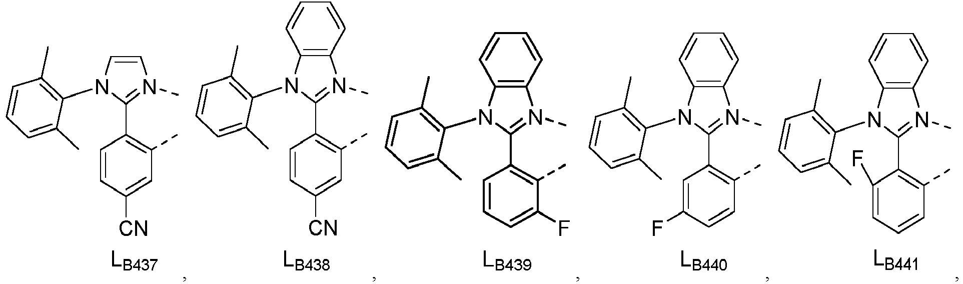 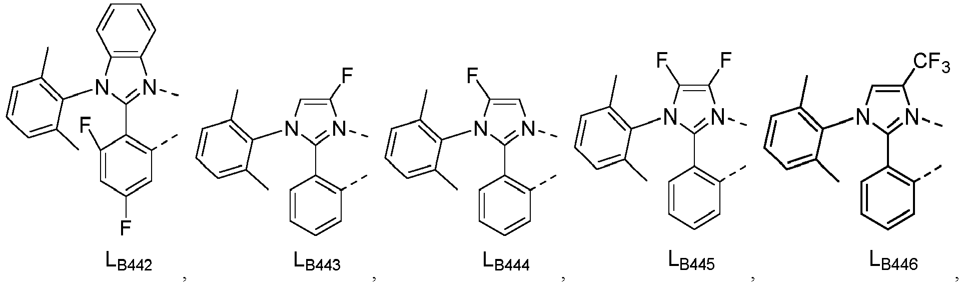 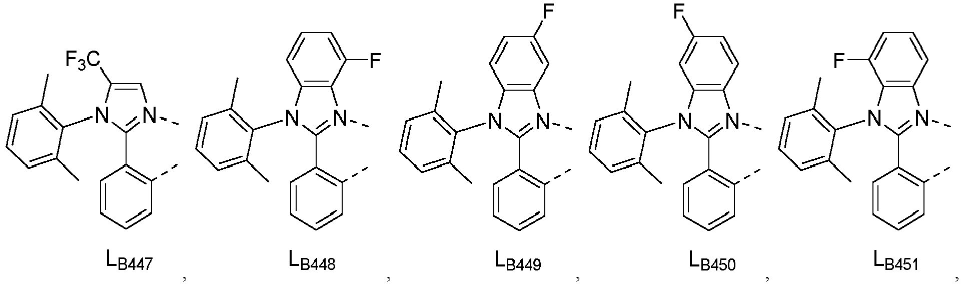 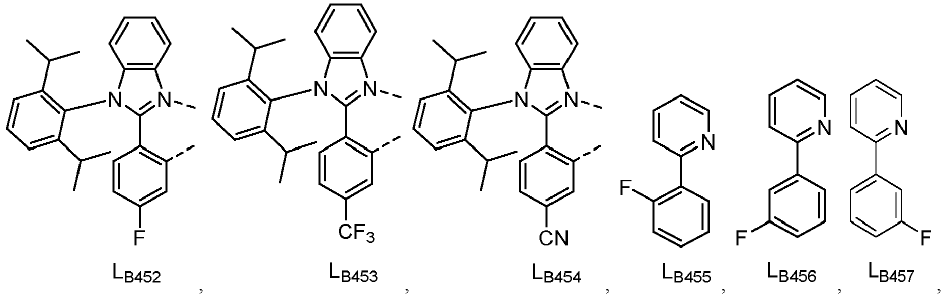 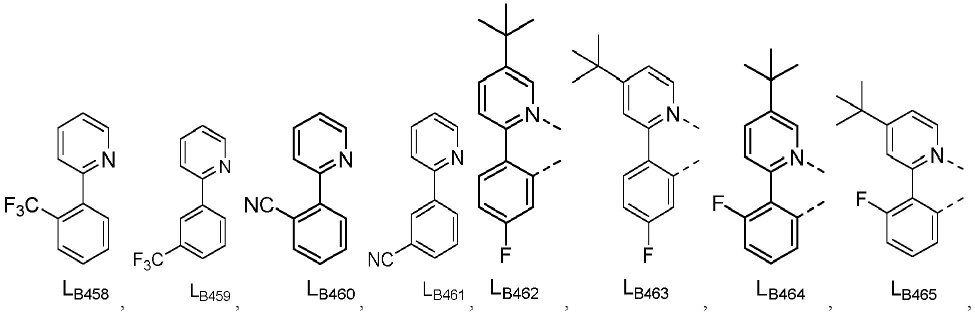 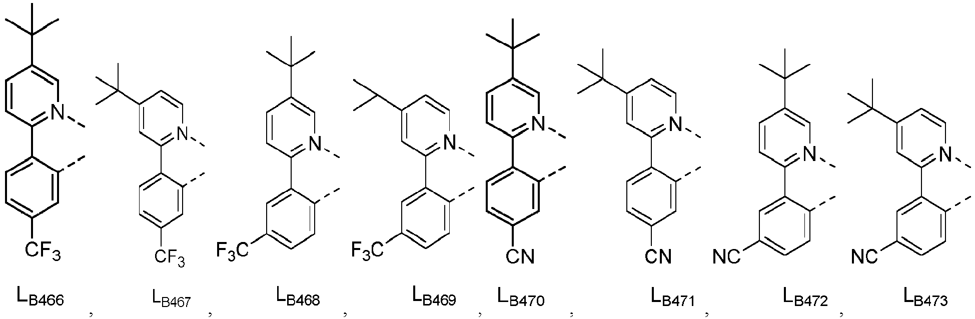 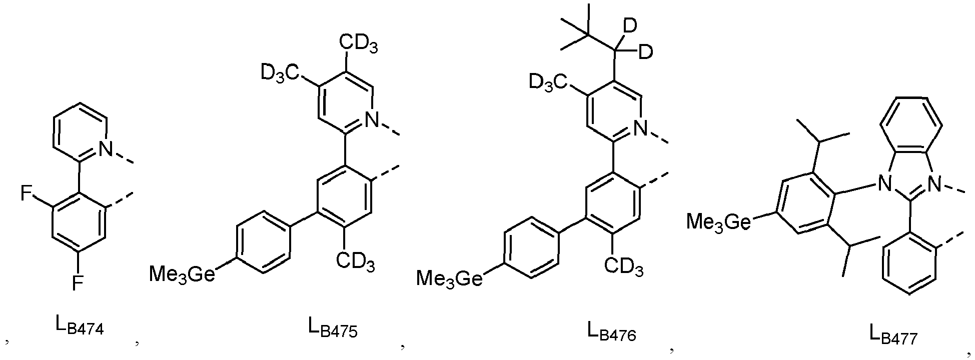 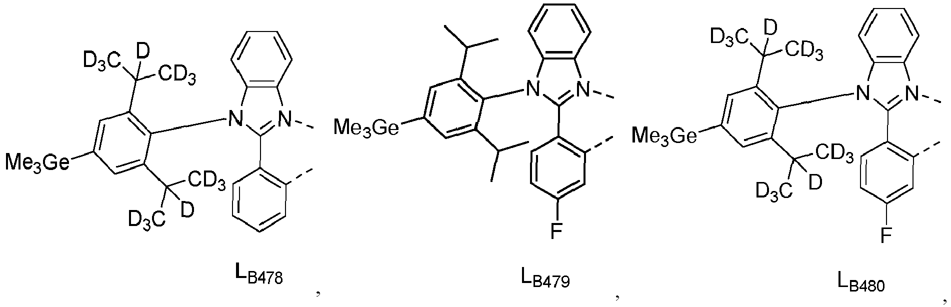 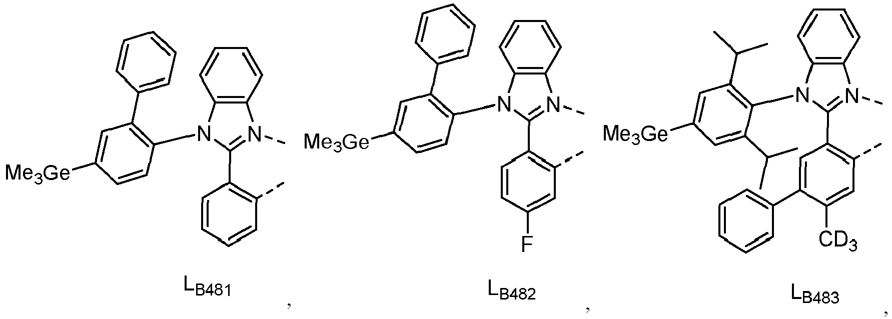 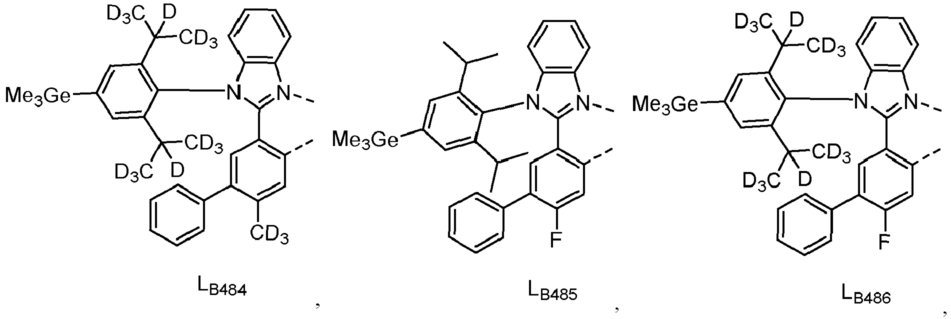 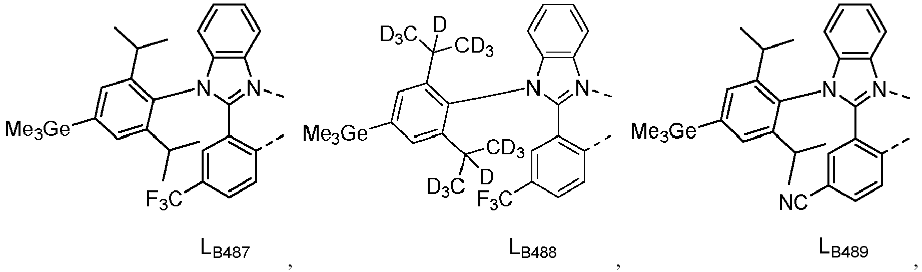 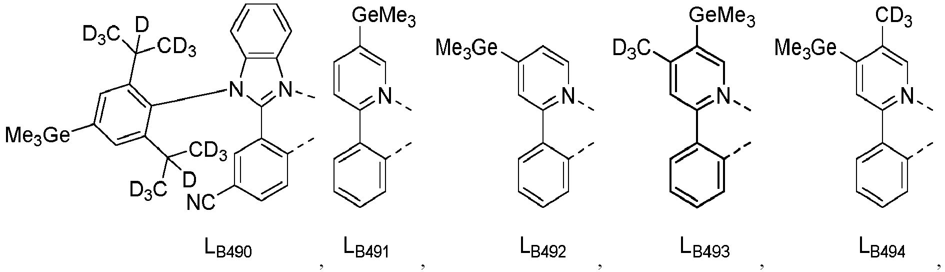 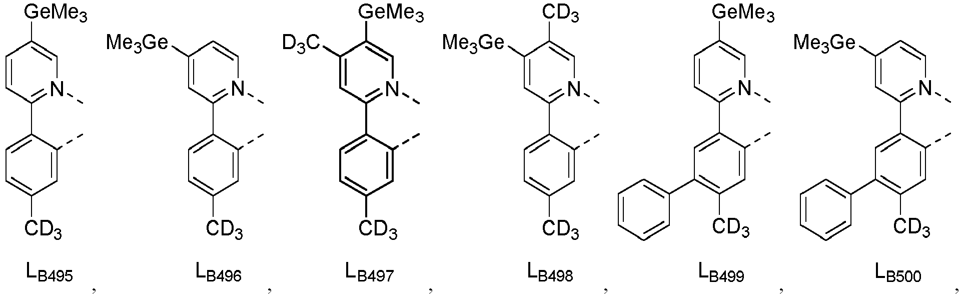 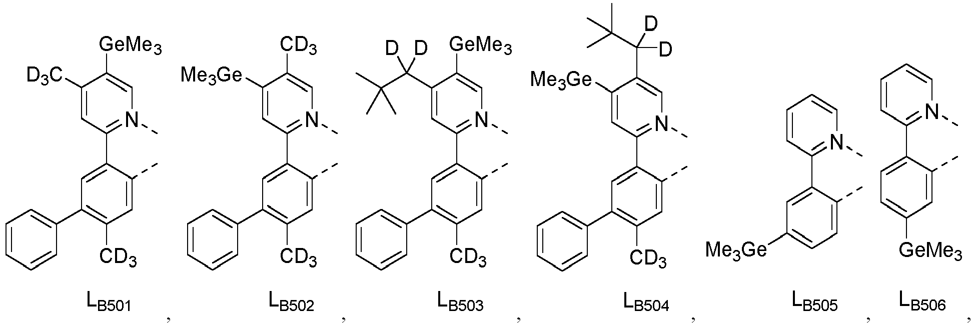 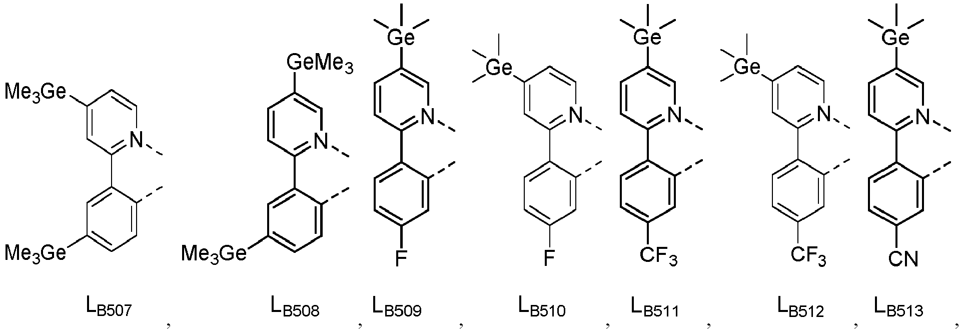 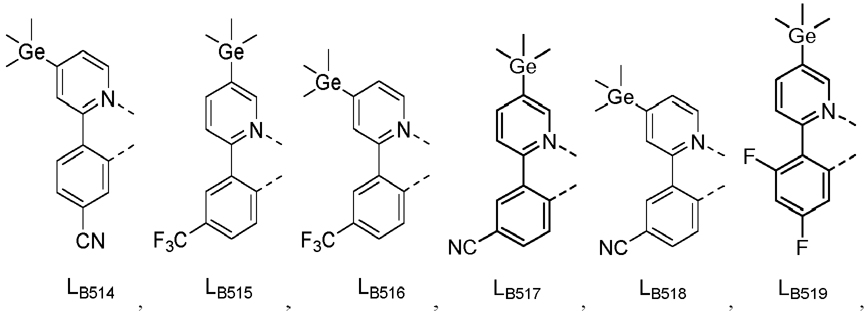 and 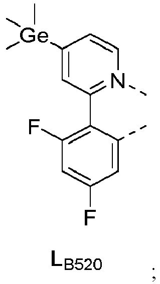 wherein each L_{C*j*-I} has a structure based on formula 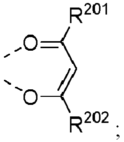 and
each L_{C*j*-II} has a structure based on formula 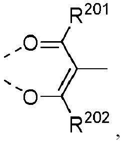 wherein for each L_{C*j*} in L_{C*j*-I} and L_{C*j*-II}, R²⁰¹ and R²⁰² are each independently defined as follows:

| **L_{C*j*}** | **R²⁰¹** | **R²⁰²** | **L_{C*j*}** | **R²⁰¹** | **R²⁰²** | **L_{C*j*}** | R**²⁰¹** | R**²⁰²** | **L_{C*j*}** | **R²⁰¹** | **R²⁰²** |
|---|---|---|---|---|---|---|---|---|---|---|---|
| L_{C1} | R^{D1} | R^{D1} | L_{C193} | R^{D1} | R^{D3} | L_{C385} | R^{D17} | R^{D40} | L_{C577} | R^{D143} | R^{D120} |
| L_{C2} | R^{D2} | R^{D2} | L_{C194} | R^{D1} | R^{D4} | L_{C386} | R^{D17} | R^{D41} | L_{C578} | R^{D143} | R^{D133} |
| L_{C3} | R^{D3} | R^{D3} | L_{C195} | R^{D1} | R^{D5} | L_{C387} | R^{D17} | R^{D42} | L_{C579} | R^{D143} | R^{D134} |
| L_{C4} | R^{D4} | R^{D4} | L_{C196} | R^{D1} | R^{D9} | L_{C388} | R^{D17} | R^{D43} | L_{C580} | R^{D143} | R^{D135} |
| L_{C5} | R^{D5} | R^{D5} | L_{C197} | R^{D1} | R^{D10} | L_{C389} | R^{D17} | R^{D48} | L_{C581} | R^{D143} | R^{D136} |
| L_{C6} | R^{D6} | R^{D6} | L_{C198} | R^{D1} | R^{D17} | L_{C390} | R^{D17} | R^{D49} | L_{C582} | R^{D143} | R^{D144} |
| L_{C7} | R^{D7} | R^{D7} | L_{C199} | R^{D1} | R^{D18} | L_{C391} | R^{D17} | R^{D50} | L_{C583} | R^{D143} | R^{D145} |
| L_{C8} | R^{D8} | R^{D8} | L_{C200} | R^{D1} | R^{D20} | L_{C392} | R^{D17} | R^{D54} | L_{C584} | R^{D143} | R^{D146} |
| L_{C9} | R^{D9} | R^{D9} | L_{C201} | R^{D1} | R^{D22} | L_{C393} | R^{D17} | R^{D55} | L_{C585} | R^{D143} | R^{D147} |
| L_{C10} | R^{D10} | R^{D10} | L_{C202} | R^{D1} | R^{D37} | L_{C394} | R^{D17} | R^{D58} | L_{C586} | R^{D143} | R^{D149} |
| L_{C11} | R^{D11} | R^{D11} | L_{C203} | R^{D1} | R^{D40} | L_{C395} | R^{D17} | R^{D59} | L_{C587} | R^{D143} | R^{D151} |
| L_{C12} | R^{D12} | R^{D12} | L_{C204} | R^{D1} | R^{D41} | L_{C396} | R^{D17} | R^{D78} | L_{C588} | R^{D143} | R^{D154} |
| L_{C13} | R^{D13} | R^{D13} | L_{C205} | R^{D1} | R^{D42} | L_{C397} | R^{D17} | R^{D79} | L_{C589} | R^{D143} | R^{D155} |
| L_{C14} | R^{D14} | R^{D14} | L_{C206} | R^{D1} | R^{D43} | L_{C398} | R^{D17} | R^{D81} | L_{C590} | R^{D143} | R^{D161} |
| L_{C15} | R^{D15} | R^{D15} | L_{C207} | R^{D1} | R^{D48} | L_{C399} | R^{D17} | R^{D87} | L_{C591} | R^{D143} | R^{D175} |
| L_{C16} | R^{D16} | R^{D16} | L_{C208} | R^{D1} | R^{D49} | L_{C400} | R^{D17} | R^{D88} | L_{C592} | R^{D144} | R^{D3} |
| L_{C17} | R^{D17} | R^{D17} | L_{C209} | R^{D1} | R^{D50} | L_{C401} | R^{D17} | R^{D89} | L_{C593} | R^{D144} | R^{D5} |
| L_{C18} | R^{D18} | R^{D18} | L_{C210} | R^{D1} | R^{D54} | L_{C402} | R^{D17} | R^{D93} | L_{C594} | R^{D144} | R^{D17} |
| L_{C19} | R^{D19} | R^{D19} | L_{C211} | R^{D1} | R^{D55} | L_{C403} | R^{D17} | R^{D116} | L_{C595} | R^{D144} | R^{D18} |
| L_{C20} | R^{D20} | R^{D20} | L_{C212} | R^{D1} | R^{D58} | L_{C404} | R^{D17} | R^{D117} | L_{C596} | R^{D144} | R^{D20} |
| L_{C21} | R^{D21} | R^{D21} | L_{C213} | R^{D1} | R^{D59} | L_{C405} | R^{D17} | R^{D118} | L_{C597} | R^{D144} | R^{D22} |
| L_{C22} | R^{D22} | R^{D22} | L_{C214} | R^{D1} | R^{D78} | L_{C406} | R^{D17} | R^{D119} | L_{C598} | R^{D144} | R^{D37} |
| L_{C23} | R^{D23} | R^{D23} | L_{C215} | R^{D1} | R^{D79} | L_{C407} | R^{D17} | R^{D120} | L_{C599} | R^{D144} | R^{D40} |
| L_{C24} | R^{D24} | R^{D24} | L_{C216} | R^{D1} | R^{D81} | L_{C408} | R^{D17} | R^{D133} | L_{C600} | R^{D144} | R^{D41} |
| L_{C25} | R^{D25} | R^{D25} | L_{C217} | R^{D1} | R^{D87} | L_{C409} | R^{D17} | R^{D134} | L_{C601} | R^{D144} | R^{D42} |
| L_{C26} | R^{D26} | R^{D26} | L_{C218} | R^{D1} | R^{D88} | L_{C410} | R^{D17} | R^{D135} | L_{C602} | R^{D144} | R^{D43} |
| L_{C27} | R^{D27} | R^{D27} | L_{C219} | R^{D1} | R^{D89} | L_{C411} | R^{D17} | R^{D136} | L_{C603} | R^{D144} | R^{D48} |
| L_{C28} | R^{D28} | R^{D28} | L_{C220} | R^{D1} | R^{D93} | L_{C412} | R^{D17} | R^{D143} | L_{C604} | R^{D144} | R^{D49} |
| L_{C29} | R^{D29} | R^{D29} | L_{C221} | R^{D1} | R^{D116} | L_{C413} | R^{D17} | R^{D144} | L_{C605} | R^{D144} | R^{D54} |
| L_{C30} | R^{D30} | R^{D30} | L_{C222} | R^{D1} | R^{D117} | L_{C414} | R^{D17} | R^{D145} | L_{C606} | R^{D144} | R^{D58} |
| L_{C31} | R^{D31} | R^{D31} | L_{C223} | R^{D1} | R^{D118} | L_{C415} | R^{D17} | R^{D146} | L_{C607} | R^{D144} | R^{D59} |
| L_{C32} | R^{D32} | R^{D32} | L_{C224} | R^{D1} | R^{D119} | L_{C416} | R^{D17} | R^{D147} | L_{C608} | R^{D144} | R^{D78} |
| L_{C33} | R^{D33} | R^{D33} | L_{C225} | R^{D1} | R^{D120} | L_{C417} | R^{D17} | R^{D149} | L_{C609} | R^{D144} | R^{D79} |
| L_{C34} | R^{D34} | R^{D34} | L_{C226} | R^{D1} | R^{D133} | L_{C418} | R^{D17} | R^{D151} | L_{C610} | R^{D144} | R^{D81} |
| L_{C35} | R^{D35} | R^{D35} | L_{C227} | R^{D1} | R^{D134} | L_{C419} | R^{D17} | R^{D154} | L_{C611} | R^{D144} | R^{D87} |
| L_{C36} | R^{D36} | R^{D36} | L_{C228} | R^{D1} | R^{D135} | L_{C420} | R^{D17} | R^{D155} | L_{C612} | R^{D144} | R^{D88} |
| L_{C37} | R^{D37} | R^{D37} | L_{C229} | R^{D1} | R^{D136} | L_{C421} | R^{D17} | R^{D161} | L_{C613} | R^{D144} | R^{D89} |
| L_{C38} | R^{D38} | R^{D38} | L_{C230} | R^{D1} | R^{D143} | L_{C422} | R^{D17} | R^{D175} | L_{C614} | R^{D144} | R^{D93} |
| L_{C39} | R^{D39} | R^{D39} | L_{C231} | R^{D1} | R^{D144} | L_{C423} | R^{D50} | R^{D3} | L_{C615} | R^{D144} | R^{D116} |
| L_{C40} | R^{D40} | R^{D40} | L_{C232} | R^{D1} | R^{D145} | L_{C424} | R^{D50} | R^{D5} | L_{C616} | R^{D144} | R^{D117} |
| L_{C41} | R^{D41} | R^{D41} | L_{C233} | R^{D1} | R^{D146} | L_{C425} | R^{D50} | R^{D18} | L_{C617} | R^{D144} | R^{D118} |
| L_{C42} | R^{D42} | R^{D42} | L_{C234} | R^{D1} | R^{D147} | L_{C426} | R^{D50} | R^{D20} | L_{C618} | R^{D144} | R^{D119} |
| L_{C43} | R^{D43} | R^{D43} | L_{C235} | R^{D1} | R^{D149} | L_{C427} | R^{D50} | R^{D22} | L_{C619} | R^{D144} | R^{D120} |
| L_{C44} | R^{D44} | R^{D44} | L_{C236} | R^{D1} | R^{D151} | L_{C428} | R^{D50} | R^{D37} | L_{C620} | R^{D144} | R^{D133} |
| L_{C45} | R^{D45} | R^{D45} | L_{C237} | R^{D1} | R^{D154} | L_{C429} | R^{D50} | R^{D40} | L_{C621} | R^{D144} | R^{D134} |
| L_{C46} | R^{D46} | R^{D46} | L_{C238} | R^{D1} | R^{D155} | L_{C430} | R^{D50} | R^{D41} | L_{C622} | R^{D144} | R^{D135} |
| L_{C47} | R^{D47} | R^{D47} | L_{C239} | R^{D1} | R^{D161} | L_{C431} | R^{D50} | R^{D42} | L_{C623} | R^{D144} | R^{D136} |
| L_{C48} | R^{D48} | R^{D48} | L_{C240} | R^{D1} | R^{D175} | L_{C432} | R^{D50} | R^{D43} | L_{C624} | R^{D144} | R^{D145} |
| L_{C49} | R^{D49} | R^{D49} | L_{C241} | R^{D4} | R^{D3} | L_{C433} | R^{D50} | R^{D48} | L_{C625} | R^{D144} | R^{D146} |
| L_{C50} | R^{D50} | R^{D50} | L_{C242} | R^{D4} | R^{D5} | L_{C434} | R^{D50} | R^{D49} | L_{C626} | R^{D144} | R^{D147} |
| L_{C51} | R^{D51} | R^{D51} | L_{C243} | R^{D4} | R^{D9} | L_{C435} | R^{D50} | R^{D54} | L_{C627} | R^{D144} | R^{D149} |
| L_{C52} | R^{D52} | R^{D52} | L_{C244} | R^{D4} | R^{D10} | L_{C436} | R^{D50} | R^{D55} | L_{C628} | R^{D144} | R^{D151} |
| L_{C53} | R^{D53} | R^{D53} | L_{C245} | R^{D4} | R^{D17} | L_{C437} | R^{D50} | R^{D58} | L_{C629} | R^{D144} | R^{D154} |
| L_{C54} | R^{D54} | R^{D54} | L_{C246} | R^{D4} | R^{D18} | L_{C438} | R^{D50} | R^{D59} | L_{C630} | R^{D144} | R^{D155} |
| L_{C55} | R^{D55} | R^{D55} | L_{C247} | R^{D4} | R^{D20} | L_{C439} | R^{D50} | R^{D78} | L_{C631} | R^{D144} | R^{D161} |
| L_{C56} | R^{D56} | R^{D56} | L_{C248} | R^{D4} | R^{D22} | L_{C440} | R^{D50} | R^{D79} | L_{C632} | R^{D144} | R^{D175} |
| L_{C57} | R^{D57} | R^{D57} | L_{C249} | R^{D4} | R^{D37} | L_{C441} | R^{D50} | R^{D81} | L_{C633} | R^{D145} | R^{D3} |
| L_{C58} | R^{D58} | R^{D58} | L_{C250} | R^{D4} | R^{D40} | L_{C442} | R^{D50} | R^{D87} | L_{C634} | R^{D145} | R^{D5} |
| L_{C59} | R^{D59} | R^{D59} | L_{C251} | R^{D4} | R^{D41} | L_{C443} | R^{D50} | R^{D88} | L_{C635} | R^{D145} | R^{D17} |
| L_{C60} | R^{D60} | R^{D60} | L_{C252} | R^{D4} | R^{D42} | L_{C444} | R^{D50} | R^{D89} | L_{C636} | R^{D145} | R^{D18} |
| L_{C61} | R^{D61} | R^{D61} | L_{C253} | R^{D4} | R^{D43} | L_{C445} | R^{D50} | R^{D93} | L_{C637} | R^{D145} | R^{D20} |
| L_{C62} | R^{D62} | R^{D62} | L_{C254} | R^{D4} | R^{D48} | L_{C446} | R^{D50} | R^{D116} | L_{C638} | R^{D145} | R^{D22} |
| L_{C63} | R^{D63} | R^{D63} | L_{C255} | R^{D4} | R^{D49} | L_{C447} | R^{D50} | R^{D117} | L_{C639} | R^{D145} | R^{D37} |
| L_{C64} | R^{D64} | R^{D64} | L_{C256} | R^{D4} | R^{D50} | L_{C448} | R^{D50} | R^{D118} | L_{C640} | R^{D145} | R^{D40} |
| L_{C65} | R^{D65} | R^{D65} | L_{C257} | R^{D4} | R^{D54} | L_{C449} | R^{D50} | R^{D119} | L_{C641} | R^{D145} | R^{D41} |
| L_{C66} | R^{D66} | R^{D66} | L_{C258} | R^{D4} | R^{D55} | L_{C450} | R^{D50} | R^{D120} | L_{C642} | R^{D145} | R^{D42} |
| L_{C67} | R^{D67} | R^{D67} | L_{C259} | R^{D4} | R^{D58} | L_{C451} | R^{D50} | R^{D133} | L_{C643} | R^{D145} | R^{D43} |
| L_{C68} | R^{D68} | R^{D68} | L_{C260} | R^{D4} | R^{D59} | L_{C452} | R^{D50} | R^{D134} | L_{C644} | R^{D145} | R^{D48} |
| L_{C69} | R^{D69} | R^{D69} | L_{C261} | R^{D4} | R^{D78} | L_{C453} | R^{D50} | R^{D135} | L_{C645} | R^{D145} | R^{D49} |
| L_{C70} | R^{D70} | R^{D70} | L_{C262} | R^{D4} | R^{D79} | L_{C454} | R^{D50} | R^{D136} | L_{C646} | R^{D145} | R^{D54} |
| L_{C71} | R^{D71} | R^{D71} | L_{C263} | R^{D4} | R^{D81} | L_{C455} | R^{D50} | R^{D143} | L_{C647} | R^{D145} | R^{D58} |
| L_{C72} | R^{D72} | R^{D72} | L_{C264} | R^{D4} | R^{D87} | L_{C456} | R^{D50} | R^{D144} | L_{C648} | R^{D145} | R^{D59} |
| L_{C73} | R^{D73} | R^{D73} | L_{C265} | R^{D4} | R^{D88} | L_{C457} | R^{D50} | R^{D145} | L_{C649} | R^{D145} | R^{D78} |
| L_{C74} | R^{D74} | R^{D74} | L_{C266} | R^{D4} | R^{D89} | L_{C458} | R^{D50} | R^{D146} | L_{C650} | R^{D145} | R^{D79} |
| L_{C75} | R^{D75} | R^{D75} | L_{C267} | R^{D4} | R^{D93} | L_{C459} | R^{D50} | R^{D147} | L_{C651} | R^{D145} | R^{D81} |
| L_{C76} | R^{D76} | R^{D76} | L_{C268} | R^{D4} | R^{D116} | L_{C460} | R^{D50} | R^{D149} | L_{C652} | R^{D145} | R^{D87} |
| L_{C77} | R^{D77} | R^{D77} | L_{C269} | R^{D4} | R^{D117} | L_{C461} | R^{D50} | R^{D151} | L_{C653} | R^{D145} | R^{D88} |
| L_{C78} | R^{D78} | R^{D78} | L_{C270} | R^{D4} | R^{D118} | L_{C462} | R^{D50} | R^{D154} | L_{C654} | R^{D145} | R^{D89} |
| L_{C79} | R^{D79} | R^{D79} | L_{C271} | R^{D4} | R^{D119} | L_{C463} | R^{D50} | R^{D155} | L_{C655} | R^{D145} | R^{D93} |
| L_{C80} | R^{D80} | R^{D80} | L_{C272} | R^{D4} | R^{D120} | L_{C464} | R^{D50} | R^{D161} | L_{C656} | R^{D145} | R^{D116} |
| L_{C81} | R^{D81} | R^{D81} | L_{C273} | R^{D4} | R^{D133} | L_{C465} | R^{D50} | R^{D175} | L_{C657} | R^{D145} | R^{D117} |
| L_{C82} | R^{D82} | R^{D82} | L_{C274} | R^{D4} | R^{D134} | L_{C466} | R^{D55} | R^{D3} | L_{C658} | R^{D145} | R^{D118} |
| L_{C83} | R^{D83} | R^{D83} | L_{C275} | R^{D4} | R^{D135} | L_{C467} | R^{D55} | R^{D5} | L_{C659} | R^{D145} | R^{D119} |
| L_{C84} | R^{D84} | R^{D84} | L_{C276} | R^{D4} | R^{D136} | L_{C468} | R^{D55} | R^{D18} | L_{C660} | R^{D145} | R^{D120} |
| L_{C85} | R^{D85} | R^{D85} | L_{C277} | R^{D4} | R^{D143} | L_{C469} | R^{D55} | R^{D20} | L_{C661} | R^{D145} | R^{D133} |
| L_{C86} | R^{D86} | R^{D86} | L_{C278} | R^{D4} | R^{D144} | L_{C470} | R^{D55} | R^{D22} | L_{C662} | R^{D145} | R^{D134} |
| L_{C87} | R^{D87} | R^{D87} | L_{C279} | R^{D4} | R^{D145} | L_{C471} | R^{D55} | R^{D37} | L_{C663} | R^{D145} | R^{D135} |
| L_{C88} | R^{D88} | R^{D88} | L_{C280} | R^{D4} | R^{D146} | L_{C472} | R^{D55} | R^{D40} | L_{C664} | R^{D145} | R^{D136} |
| L_{C89} | R^{D89} | R^{D89} | L_{C281} | R^{D4} | R^{D147} | L_{C473} | R^{D55} | R^{D41} | L_{C665} | R^{D145} | R^{D146} |
| L_{C90} | R^{D90} | R^{D90} | L_{C282} | R^{D4} | R^{D149} | L_{C474} | R^{D55} | R^{D42} | L_{C666} | R^{D145} | R^{D147} |
| L_{C91} | R^{D91} | R^{D91} | L_{C283} | R^{D4} | R^{D151} | L_{C475} | R^{D55} | R^{D43} | L_{C667} | R^{D145} | R^{D149} |
| L_{C92} | R^{D92} | R^{D92} | L_{C284} | R^{D4} | R^{D154} | L_{C476} | R^{D55} | R^{D48} | L_{C668} | R^{D145} | R^{D151} |
| L_{C93} | R^{D93} | R^{D93} | L_{C285} | R^{D4} | R^{D155} | L_{C477} | R^{D55} | R^{D49} | L_{C669} | R^{D145} | R^{D154} |
| L_{C94} | R^{D94} | R^{D94} | L_{C286} | R^{D4} | R^{D161} | L_{C478} | R^{D55} | R^{D54} | L_{C670} | R^{D145} | R^{D155} |
| L_{C95} | R^{D95} | R^{D95} | L_{C287} | R^{D4} | R^{D175} | L_{C479} | R^{D55} | R^{D58} | L_{C671} | R^{D145} | R^{D161} |
| L_{C96} | R^{D96} | R^{D96} | L_{C288} | R^{D9} | R^{D3} | L_{C480} | R^{D55} | R^{D59} | L_{C672} | R^{D145} | R^{D175} |
| L_{C97} | R^{D97} | R^{D97} | L_{C289} | R^{D9} | R^{D5} | L_{C481} | R^{D55} | R^{D78} | L_{C673} | R^{D146} | R^{D3} |
| L_{C98} | R^{D98} | R^{D98} | L_{C290} | R^{D9} | R^{D10} | L_{C482} | R^{D55} | R^{D79} | L_{C674} | R^{D146} | R^{D5} |
| L_{C99} | R^{D99} | R^{D99} | L_{C291} | R^{D9} | R^{D17} | L_{C483} | R^{D55} | R^{D81} | L_{C675} | R^{D146} | R^{D17} |
| L_{C100} | R^{D100} | R^{D100} | L_{C292} | R^{D9} | R^{D18} | L_{C484} | R^{D55} | R^{D87} | L_{C676} | R^{D146} | R^{D18} |
| L_{C101} | R^{D101} | R^{D101} | L_{C293} | R^{D9} | R^{D20} | L_{C485} | R^{D55} | R^{D88} | L_{C677} | R^{D146} | R^{D20} |
| L_{C102} | R^{D102} | R^{D102} | L_{C294} | R^{D9} | R^{D22} | L_{C486} | R^{D55} | R^{D89} | L_{C678} | R^{D146} | R^{D22} |
| L_{C103} | R^{D103} | R^{D103} | L_{C295} | R^{D9} | R^{D37} | L_{C487} | R^{D55} | R^{D93} | L_{C679} | R^{D146} | R^{D37} |
| L_{C104} | R^{D104} | R^{D104} | L_{C296} | R^{D9} | R^{D40} | L_{C488} | R^{D55} | R^{D116} | L_{C680} | R^{D146} | R^{D40} |
| L_{C105} | R^{D105} | R^{D105} | L_{C297} | R^{D9} | R^{D41} | L_{C489} | R^{D55} | R^{D117} | L_{C681} | R^{D146} | R^{D41} |
| L_{C106} | R^{D106} | R^{D106} | L_{C298} | R^{D9} | R^{D42} | L_{C490} | R^{D55} | R^{D118} | L_{C682} | R^{D146} | R^{D42} |
| L_{C107} | R^{D107} | R^{D107} | L_{C299} | R^{D9} | R^{D43} | L_{C491} | R^{D55} | R^{D119} | L_{C683} | R^{D146} | R^{D43} |
| L_{C108} | R^{D108} | R^{D108} | L_{C300} | R^{D9} | R^{D48} | L_{C492} | R^{D55} | R^{D120} | L_{C684} | R^{D146} | R^{D48} |
| L_{C109} | R^{D109} | R^{D109} | L_{C301} | R^{D9} | R^{D49} | L_{C493} | R^{D55} | R^{D133} | L_{C685} | R^{D146} | R^{D49} |
| L_{C110} | R^{D110} | R^{P110} | L_{C302} | R^{D9} | R^{D50} | L_{C494} | R^{D55} | R^{D134} | L_{C686} | R^{D146} | R^{D54} |
| L_{C111} | R^{D111} | R^{D111} | L_{C303} | R^{D9} | R^{D54} | L_{C495} | R^{D55} | R^{D135} | L_{C687} | R^{D146} | R^{D58} |
| L_{C112} | R^{D112} | R^{D112} | L_{C304} | R^{D9} | R^{D55} | L_{C496} | R^{D55} | R^{D136} | L_{C688} | R^{D146} | R^{D59} |
| L_{C113} | R^{D113} | R^{D113} | L_{C305} | R^{D9} | R^{D58} | L_{C497} | R^{D55} | R^{D143} | L_{C689} | R^{D146} | R^{D78} |
| L_{C114} | R^{D114} | R^{D114} | L_{C306} | R^{D9} | R^{D59} | L_{C498} | R^{D55} | R^{D144} | L_{C690} | R^{D146} | R^{D79} |
| L_{C115} | R^{D115} | R^{D115} | L_{C307} | R^{D9} | R^{D78} | L_{C499} | R^{D55} | R^{D145} | L_{C691} | R^{D146} | R^{D81} |
| L_{C116} | R^{D116} | R^{D116} | L_{C308} | R^{D9} | R^{D79} | L_{C500} | R^{D55} | R^{D146} | L_{C692} | R^{D146} | R^{D87} |
| L_{C117} | R^{D117} | R^{D117} | L_{C309} | R^{D9} | R^{D81} | L_{C501} | R^{D55} | R^{D147} | L_{C693} | R^{D146} | R^{D88} |
| L_{C118} | R^{D118} | R^{D118} | L_{C310} | R^{D9} | R^{D87} | L_{C502} | R^{D55} | R^{D149} | L_{C694} | R^{D146} | R^{D89} |
| L_{C119} | R^{D119} | R^{D119} | L_{C311} | R^{D9} | R^{D88} | L_{C503} | R^{D55} | R^{D151} | L_{C695} | R^{D146} | R^{D93} |
| L_{C120} | R^{D120} | R^{D120} | L_{C312} | R^{D9} | R^{D89} | L_{C504} | R^{D55} | R^{D154} | L_{C696} | R^{D146} | R^{D117} |
| L_{C121} | R^{D121} | R^{D121} | L_{C313} | R^{D9} | R^{D93} | L_{C505} | R^{D55} | R^{D155} | L_{C697} | L^{D146} | R^{D118} |
| L_{C122} | R^{D122} | R^{D122} | L_{C314} | R^{D9} | R^{D116} | L_{C506} | R^{D55} | R^{D161} | L_{C698} | R^{D146} | R^{D119} |
| L_{C123} | R^{D123} | R^{D123} | L_{C315} | R^{D9} | R^{D117} | L_{C507} | R^{D55} | R^{D175} | L_{C699} | R^{D146} | R^{D120} |
| L_{C124} | R^{D124} | R^{D124} | L_{C316} | R^{D9} | R^{D118} | L_{C508} | R^{D116} | R^{D3} | L_{C700} | R^{D146} | R^{D133} |
| L_{C125} | R^{D125} | R^{D125} | L_{C317} | R^{D9} | R^{D119} | L_{C509} | R^{D116} | R^{D5} | L_{C701} | L^{D146} | R^{D134} |
| L_{C126} | R^{D126} | R^{D126} | L_{C318} | R^{D9} | R^{D120} | L_{C510} | R^{D116} | R^{D17} | L_{C702} | R^{D146} | R^{D135} |
| L_{C127} | R^{D127} | R^{D127} | L_{C319} | R^{D9} | R^{D133} | L_{C511} | R^{D116} | R^{D18} | L_{C703} | R^{D146} | R^{D136} |
| L_{C128} | R^{D128} | R^{D128} | L_{C320} | R^{D9} | R^{D134} | L_{C512} | R^{D116} | R^{D20} | L_{C704} | R^{D146} | R^{D146} |
| L_{C129} | R^{D129} | R^{D129} | L_{C321} | R^{D9} | R^{D135} | L_{C513} | R^{D116} | R^{D22} | L_{C705} | R^{D146} | R^{D147} |
| L_{C130} | R^{D130} | R^{D130} | L_{C322} | R^{D9} | R^{D136} | L_{C514} | R^{D116} | R^{D37} | L_{C706} | R^{D146} | R^{D149} |
| L_{C131} | R^{D131} | R^{D131} | L_{C323} | R^{D9} | R^{D143} | L_{C515} | R^{D116} | R^{D40} | L_{C707} | R^{D146} | R^{D151} |
| L_{C132} | R^{D132} | R^{D132} | L_{C324} | R^{D9} | R^{D144} | L_{C516} | R^{D116} | R^{D41} | L_{C708} | R^{D146} | R^{D154} |
| L_{C133} | R^{D133} | R^{D133} | L_{C325} | R^{D9} | R^{D145} | L_{C517} | R^{D116} | R^{D42} | L_{C709} | R^{D146} | R^{D155} |
| L_{C134} | R^{D134} | R^{D134} | L_{C326} | R^{D9} | R^{D146} | L_{C518} | R^{D116} | R^{D43} | L_{C710} | R^{D146} | R^{D161} |
| L_{C135} | R^{D135} | R^{D135} | L_{C327} | R^{D9} | R^{D147} | L_{C519} | R^{D116} | R^{D48} | L_{C711} | R^{D146} | R^{D175} |
| L_{C136} | R^{D136} | R^{D136} | L_{C328} | R^{D9} | R^{D149} | L_{C520} | R^{D116} | R^{D49} | L_{C712} | R^{D133} | R^{D3} |
| L_{C137} | R^{D137} | R^{D137} | L_{C329} | R^{D9} | R^{D151} | L_{C521} | R^{D116} | R^{D54} | L_{C713} | R^{D133} | R^{D5} |
| L_{C138} | R^{D138} | R^{D138} | L_{C330} | R^{D9} | R^{D154} | L_{C522} | R^{D116} | R^{D58} | L_{C714} | R^{D133} | R^{D3} |
| L_{C139} | R^{D139} | R^{D139} | L_{C331} | R^{D9} | R^{D155} | L_{C523} | R^{D116} | R^{D59} | L_{C715} | R^{D133} | R^{D18} |
| L_{C140} | R^{D140} | R^{D140} | L_{C332} | R^{D9} | R^{D161} | L_{C524} | R^{D116} | R^{D78} | L_{C716} | R^{D133} | R^{D20} |
| L_{C141} | R^{D141} | R^{D141} | L_{C333} | R^{D9} | R^{D175} | L_{C525} | R^{D116} | R^{D79} | L_{C717} | R^{D133} | R^{D22} |
| L_{C142} | R^{D142} | R^{D142} | L_{C334} | R^{D10} | R^{D3} | L_{C526} | R^{D116} | R^{D81} | L_{C718} | R^{D133} | R^{D37} |
| L_{C143} | R^{D143} | R^{D143} | L_{C335} | R^{D10} | R^{D5} | L_{C527} | R^{D116} | R^{D87} | L_{C719} | R^{D133} | R^{D40} |
| L_{C144} | R^{D144} | R^{D144} | L_{C336} | R^{D10} | R^{D17} | L_{C528} | R^{D116} | R^{D88} | L_{C720} | R^{D133} | R^{D41} |
| L_{C145} | R^{D145} | R^{D145} | L_{C337} | R^{D10} | R^{D18} | L_{C529} | R^{D116} | R^{D89} | L_{C721} | R^{D133} | R^{D42} |
| L_{C146} | L^{D146} | R^{D146} | L_{C338} | R^{D10} | R^{D20} | L_{C530} | R^{D116} | R^{D93} | L_{C722} | R^{D133} | R^{D43} |
| L_{C147} | R^{D147} | R^{D147} | L_{C339} | R^{D10} | R^{D22} | L_{C531} | R^{D116} | R^{D117} | L_{C723} | R^{D133} | R^{D48} |
| L_{C148} | R^{D148} | R^{D148} | L_{C340} | R^{D10} | R^{D37} | L_{C532} | R^{D116} | R^{D118} | L_{C724} | R^{D133} | R^{D49} |
| L_{C149} | R^{D149} | R^{D149} | L_{C341} | R^{D10} | R^{D40} | L_{C533} | R^{D116} | R^{D119} | L_{C725} | R^{D133} | R^{D54} |
| L_{C150} | R^{D150} | R^{D150} | L_{C342} | R^{D10} | R^{D41} | L_{C534} | R^{D116} | R^{D120} | L_{C726} | R^{D133} | R^{D58} |
| L_{C151} | R^{D151} | R^{D151} | L_{C343} | R^{D10} | R^{D42} | L_{C535} | R^{D116} | R^{D133} | L_{C727} | R^{D133} | R^{D59} |
| L_{C152} | R^{D152} | R^{D152} | L_{C344} | R^{D10} | R^{D43} | L_{C536} | R^{D116} | R^{D134} | L_{C728} | R^{D133} | R^{D78} |
| L_{C153} | R^{D153} | R^{D153} | L_{C345} | R^{D10} | R^{D48} | L_{C537} | R^{D116} | R^{D135} | L_{C729} | R^{D133} | R^{D79} |
| L_{C154} | R^{D154} | R^{D154} | L_{C346} | R^{D10} | R^{D49} | L_{C538} | R^{D116} | R^{D136} | L_{C730} | R^{D133} | R^{D81} |
| L_{C155} | R^{D155} | R^{D155} | L_{C347} | R^{D10} | R^{D50} | L_{C539} | R^{D116} | R^{D143} | L_{C731} | R^{D133} | R^{D87} |
| L_{C156} | R^{D156} | R^{D156} | L_{C348} | R^{D10} | R^{D54} | L_{C540} | R^{D116} | R^{D144} | L_{C732} | R^{D133} | R^{D88} |
| L_{C157} | R^{D157} | R^{D157} | L_{C349} | R^{D10} | R^{D55} | L_{C541} | R^{D116} | R^{D145} | L_{C733} | R^{D133} | R^{D89} |
| L_{C158} | R^{D158} | R^{D158} | L_{C350} | R^{D10} | R^{D58} | L_{C542} | R^{D116} | R^{D146} | L_{C734} | R^{D133} | R^{D93} |
| L_{C159} | R^{D159} | R^{D159} | L_{C351} | R^{D10} | R^{D59} | L_{C543} | R^{D116} | R^{D147} | L_{C735} | R^{D133} | R^{D117} |
| L_{C160} | R^{D160} | R^{D160} | L_{C352} | R^{D10} | R^{D78} | L_{C544} | R^{D116} | R^{D149} | L_{C736} | R^{D133} | R^{D118} |
| L_{C161} | R^{D161} | R^{D161} | L_{C353} | R^{D10} | R^{D79} | L_{C545} | R^{D116} | R^{D151} | L_{C737} | R^{D133} | R^{D119} |
| L_{C162} | R^{D162} | R^{D162} | L_{C354} | R^{D10} | R^{D81} | L_{C546} | R^{D116} | R^{D154} | L_{C738} | R^{D133} | R^{D120} |
| L_{C163} | R^{D163} | R^{D163} | L_{C355} | R^{D10} | R^{D87} | L_{C547} | R^{D116} | R^{D155} | L_{C739} | R^{D133} | R^{D133} |
| L_{C164} | R^{D164} | R^{D164} | L_{C356} | R^{D10} | R^{D88} | L_{C548} | R^{D116} | R^{D161} | L_{C740} | R^{D133} | R^{D134} |
| L_{C165} | R^{D165} | R^{D165} | L_{C357} | R^{D10} | R^{D89} | L_{C549} | R^{D116} | R^{D175} | L_{C741} | R^{D133} | R^{D135} |
| L_{C166} | R^{D166} | R^{D166} | L_{C358} | R^{D10} | R^{D93} | L_{C550} | R^{D143} | R^{D3} | L_{C742} | R^{D133} | R^{D136} |
| L_{C167} | R^{D167} | R^{D167} | L_{C359} | R^{D10} | R^{D116} | L_{C551} | R^{D143} | R^{D5} | L_{C743} | R^{D133} | R^{D146} |
| L_{C168} | R^{D168} | R^{D168} | L_{C360} | R^{D10} | R^{D117} | L_{C552} | R^{D143} | R^{D17} | L_{C744} | R^{D133} | R^{D147} |
| L_{C169} | R^{D169} | R^{D169} | L_{C361} | R^{D10} | R^{D118} | L_{C553} | R^{D143} | R^{D18} | L_{C745} | R^{D133} | R^{D149} |
| L_{C170} | R^{D170} | R^{D170} | L_{C362} | R^{D10} | R^{D119} | L_{C554} | R^{D143} | R^{D20} | L_{C746} | R^{D133} | R^{D151} |
| L_{C171} | R^{D171} | R^{D171} | L_{C363} | R^{D10} | R^{D120} | _{LC555} | R^{D143} | R^{D22} | L_{C747} | R^{D133} | R^{D154} |
| L_{C172} | R^{D172} | R^{D172} | L_{C364} | R^{D10} | R^{D133} | L_{C556} | R^{D143} | R^{D37} | L_{C748} | R^{D133} | R^{D155} |
| L_{C173} | R^{D173} | R^{D173} | L_{C365} | R^{D10} | R^{D134} | L_{C557} | R^{D143} | R^{D40} | L_{C749} | R^{D133} | R^{D161} |
| L_{C174} | R^{D174} | R^{D174} | L_{C366} | R^{D10} | R^{D135} | L_{C558} | R^{D143} | R^{D41} | L_{C750} | R^{D133} | R^{D175} |
| L_{C175} | R^{D175} | R^{D175} | L_{C367} | R^{D10} | R^{D136} | L_{C559} | R^{D143} | R^{D42} | L_{C751} | R^{D175} | R^{D3} |
| L_{C176} | R^{D176} | R^{D176} | L_{C368} | R^{D10} | R^{D143} | L_{C560} | R^{D143} | R^{D43} | L_{C752} | R^{D175} | R^{D5} |
| L_{C177} | R^{D177} | R^{D177} | L_{C369} | R^{D10} | R^{D144} | L_{C561} | R^{D143} | R^{D48} | L_{C753} | R^{D175} | R^{D18} |
| L_{C178} | R^{D178} | R^{D178} | L_{C370} | R^{D10} | R^{D145} | L_{C562} | R^{D143} | R^{D49} | L_{C754} | R^{D175} | R^{D20} |
| L_{C179} | R^{D179} | R^{D179} | L_{C371} | R^{D10} | R^{D146} | L_{C563} | R^{D143} | R^{D54} | L_{C755} | R^{D175} | R^{D22} |
| L_{C180} | R^{D180} | R^{D180} | L_{C372} | R^{D10} | R^{D147} | L_{C564} | R^{D143} | R^{D58} | L_{C756} | R^{D175} | R^{D37} |
| L_{C181} | R^{D181} | R^{D181} | L_{C373} | R^{D10} | R^{D149} | L_{C565} | R^{D143} | R^{D59} | L_{C757} | R^{D175} | R^{D40} |
| L_{C182} | R^{D182} | R^{D182} | L_{C374} | R^{D10} | R^{D151} | L_{C566} | R^{D143} | R^{D78} | L_{C758} | R^{D175} | R^{D41} |
| L_{C183} | R^{D183} | R^{D183} | L_{C375} | R^{D10} | R^{D154} | L_{C567} | R^{D143} | R^{D79} | L_{C759} | R^{D175} | R^{D42} |
| L_{C184} | R^{D184} | R^{D184} | L_{C376} | R^{D10} | R^{D155} | L_{C568} | R^{D143} | R^{D81} | L_{C760} | R^{D175} | R^{D43} |
| L_{C185} | R^{D185} | R^{D185} | L_{C377} | R^{D10} | R^{D161} | L_{C569} | R^{D143} | R^{D87} | L_{C761} | R^{D175} | R^{D48} |
| L_{C186} | R^{D186} | R^{D186} | L_{C378} | R^{D10} | R^{D175} | L_{C570} | R^{D143} | R^{D88} | L_{C762} | R^{D175} | R^{D49} |
| L_{C187} | R^{P187} | R^{D187} | L_{C379} | R^{D17} | R^{D3} | L_{C571} | R^{D143} | R^{D89} | L_{C763} | R^{D175} | R^{D54} |
| L_{C188} | R^{D188} | R^{D188} | L_{C380} | R^{D17} | R^{D5} | L_{C572} | R^{D143} | R^{D93} | L_{C764} | R^{D175} | R^{D58} |
| L_{C189} | R^{D189} | R^{D189} | L_{C381} | R^{D17} | R^{D18} | L_{C573} | R^{D143} | R^{D116} | L_{C765} | R^{D175} | R^{D59} |
| L_{C190} | R^{D190} | R^{D190} | L_{C382} | R^{D17} | R^{D20} | L_{C574} | R^{D143} | R^{P117} | L_{C766} | R^{D175} | R^{D78} |
| L_{C191} | R^{D191} | R^{D191} | L_{C383} | R^{D17} | R^{D22} | L_{C575} | R^{D143} | R^{D118} | L_{C767} | R^{D175} | R^{D79} |
| L_{C192} | R^{D192} | R^{D192} | L_{C384} | R^{D17} | R^{D37} | L_{C576} | R^{D143} | R^{D119} | L_{C768} | R^{D175} | R^{D81} |
| L_{C769} | R^{D193} | R^{D193} | L_{C877} | R^{D1} | R^{D193} | L_{C985} | R^{D4} | R^{D193} | L_{C1093} | R^{D9} | R^{D193} |
| L_{C770} | R^{D194} | R^{D194} | L_{C878} | R^{D1} | R^{D194} | L_{C986} | R^{D4} | R^{D194} | L_{C1094} | R^{D9} | R^{D194} |
| L_{C771} | R^{D195} | R^{D195} | L_{C879} | R^{D1} | R^{D195} | L_{C987} | R^{D4} | R^{D195} | L_{C1095} | R^{D9} | R^{D195} |
| L_{C772} | R^{D196} | R^{D196} | L_{C880} | R^{D1} | R^{D196} | L_{C988} | R^{D4} | R^{D196} | L_{C1096} | R^{D9} | R^{D196} |
| L_{C773} | R^{D197} | R^{D197} | L_{C881} | R^{D1} | R^{D197} | L_{C989} | R^{D4} | R^{D197} | L_{C1097} | R^{D9} | R^{D197} |
| L_{C774} | R^{D198} | R^{D198} | L_{C882} | R^{D1} | R^{D198} | L_{C990} | R^{D4} | R^{D198} | L_{C1098} | R^{D9} | R^{D198} |
| L_{C775} | R^{D199} | R^{D199} | L_{C883} | R^{D1} | R^{D199} | L_{C991} | R^{D4} | R^{D199} | L_{C1099} | R^{D9} | R^{D199} |
| L_{C776} | R^{D200} | R^{D200} | L_{C884} | R^{D1} | R^{P200} | L_{C992} | R^{D4} | R^{D200} | L_{C1100} | R^{D9} | R^{D200} |
| L_{C777} | R^{D201} | R^{D201} | L_{C885} | R^{D1} | R^{D201} | L_{C993} | R^{D4} | R^{D201} | L_{C1101} | R^{D9} | R^{D201} |
| L_{C778} | R^{D202} | R^{D202} | L_{C886} | R^{D1} | R^{D202} | L_{C994} | R^{D4} | R^{D202} | L_{C1102} | R^{D9} | R^{D202} |
| L_{C779} | R^{D203} | R^{D203} | L_{C887} | R^{D1} | R^{D203} | L_{C995} | R^{D4} | R^{D203} | L_{C1103} | R^{D9} | R^{D203} |
| L_{C780} | R^{D204} | R^{D204} | L_{C888} | R^{D1} | R^{D204} | L_{C996} | R^{D4} | R^{D204} | L_{C1104} | R^{D9} | R^{D204} |
| L_{C781} | R^{D205} | R^{D205} | L_{C889} | R^{D1} | R^{D205} | L_{C997} | R^{D4} | R^{D205} | L_{C1105} | R^{D9} | R^{D205} |
| L_{C782} | R^{D206} | R^{D206} | L_{C890} | R^{D1} | R^{D206} | L_{C998} | R^{D4} | R^{D206} | L_{C1106} | R^{D9} | R^{D206} |
| L_{C783} | R^{D207} | R^{D207} | L_{C891} | R^{D1} | R^{D207} | L_{C999} | R^{D4} | R^{D207} | L_{C1107} | R^{D9} | R^{D207} |
| L_{C784} | R^{D208} | R^{D208} | L_{C892} | R^{D1} | R^{D208} | L_{C1000} | R^{D4} | R^{D208} | L_{C1108} | R^{D9} | R^{D208} |
| L_{C785} | R^{D209} | R^{D209} | L_{C893} | R^{D1} | R^{D209} | L_{C1001} | R^{D4} | R^{D209} | L_{C1109} | R^{D9} | R^{D209} |
| L_{C786} | R^{D210} | R^{D210} | L_{C894} | R^{D1} | R^{D210} | L_{C1002} | R^{D4} | R^{D210} | L_{C1110} | R^{D9} | R^{D210} |
| L_{C787} | R^{D211} | R^{D211} | L_{C895} | R^{D1} | R^{D211} | L_{C1003} | R^{D4} | R^{D211} | L_{C1111} | R^{D9} | R^{D211} |
| L_{C788} | R^{D212} | R^{D212} | L_{C896} | R^{D1} | R^{D212} | L_{C1004} | R^{D4} | R^{D212} | L_{C1112} | R^{D9} | R^{D212} |
| L_{C789} | R^{D213} | R^{D213} | L_{C897} | R^{D1} | R^{D213} | L_{C1005} | R^{D4} | R^{D213} | L_{C1113} | R^{D9} | R^{D213} |
| L_{C790} | R^{D214} | R^{D214} | L_{C898} | R^{D1} | R^{D214} | Lc₁₀₀₆ | R^{D4} | R^{D214} | L_{C1114} | R^{D9} | R^{D214} |
| L_{C791} | R^{D215} | R^{D215} | L_{C899} | R^{D1} | R^{D215} | L_{C1007} | R^{D4} | R^{D215} | L_{C1115} | R^{D9} | R^{D215} |
| L_{C792} | R^{D216} | R^{D216} | L_{C900} | R^{D1} | R^{D216} | L_{C1008} | R^{D4} | R^{D216} | L_{C1116} | R^{D9} | R^{D216} |
| L_{C793} | R^{D217} | R^{D217} | L_{C901} | R^{D1} | R^{D217} | L_{C1009} | R^{D4} | R^{D217} | L_{C1117} | R^{D9} | R^{D217} |
| L_{C794} | R^{D218} | R^{D218} | L_{C902} | R^{D1} | R^{D218} | L_{C1010} | R^{D4} | R^{D218} | L_{C1118} | R^{D9} | R^{D218} |
| L_{C795} | R^{D219} | R^{D219} | L_{C903} | R^{D1} | R^{D219} | L_{C1011} | R^{D4} | R^{D219} | L_{C1119} | R^{D9} | R^{D219} |
| L_{C796} | R^{D220} | R^{D220} | L_{C904} | R^{D1} | R^{D220} | L_{C1012} | R^{D4} | R^{D220} | L_{C1120} | R^{D9} | R^{D220} |
| L_{C797} | R^{D221} | R^{P221} | L_{C905} | R^{D1} | R^{D221} | L_{C1013} | R^{P4} | R^{D221} | L_{C1121} | R^{D9} | R^{D221} |
| L_{C798} | R^{D222} | R^{D222} | L_{C906} | R^{D1} | R^{D222} | L_{C1014} | R^{D4} | R^{D222} | L_{C1122} | R^{D9} | R^{D222} |
| L_{C799} | R^{D223} | R^{D223} | L_{C907} | R^{D1} | R^{D223} | L_{C1015} | R^{D4} | R^{D223} | L_{C1123} | R^{D9} | R^{D223} |
| L_{C800} | R^{D224} | R^{D224} | L_{C908} | R^{D1} | R^{D224} | L_{C1016} | R^{D4} | R^{D224} | L_{C1124} | R^{D9} | R^{D224} |
| L_{C801} | R^{D225} | R^{D225} | L_{C909} | R^{D1} | R^{D225} | L_{C1017} | R^{D4} | R^{D225} | L_{C1125} | R^{D9} | R^{D225} |
| L_{C802} | R^{D226} | R^{D226} | L_{C910} | R^{D1} | R^{D226} | L_{C1018} | R^{D4} | R^{D226} | L_{C1126} | R^{D9} | R^{D226} |
| L_{C803} | R^{D227} | R^{D227} | L_{C911} | R^{D1} | R^{D227} | L_{C1019} | R^{D4} | R^{D227} | L_{C1127} | R^{D9} | R^{D227} |
| L_{C804} | R^{D228} | R^{D228} | L_{C912} | R^{D1} | R^{D228} | L_{C1020} | R^{D4} | R^{D228} | L_{C1128} | R^{D9} | R^{D228} |
| L_{C805} | R^{D229} | R^{D229} | L_{C913} | R^{D1} | R^{D229} | L_{C1021} | R^{D4} | R^{D229} | L_{C1129} | R^{D9} | R^{D229} |
| L_{C806} | R^{D230} | R^{D230} | L_{C914} | R^{D1} | R^{D230} | L_{C1022} | R^{D4} | R^{D230} | L_{C1130} | R^{D9} | R^{D230} |
| L_{C807} | R^{D231} | R^{D231} | L_{C915} | R^{D1} | R^{D231} | L_{C1023} | R^{D4} | R^{D231} | L_{C1131} | R^{D9} | R^{D231} |
| L_{C808} | R^{D232} | R^{D232} | L_{C916} | R^{D1} | R^{D232} | L_{C1024} | R^{D4} | R^{D232} | L_{C1132} | R^{D9} | R^{D232} |
| L_{C809} | R^{D233} | R^{D233} | L_{C917} | R^{D1} | R^{D233} | L_{C1025} | R^{D4} | R^{D233} | L_{C1133} | R^{D9} | R^{D233} |
| L_{C810} | R^{D234} | R^{D234} | L_{C918} | R^{D1} | R^{D234} | L_{C1026} | R^{D4} | R^{D234} | L_{C1134} | R^{D9} | R^{D234} |
| L_{C811} | R^{D235} | R^{D235} | L_{C919} | R^{D1} | R^{D235} | L_{C1027} | R^{D4} | R^{D235} | L_{C1135} | R^{D9} | R^{D235} |
| L_{C812} | R^{D236} | R^{D236} | L_{C920} | R^{D1} | R^{D236} | L_{C1028} | R^{D4} | R^{D236} | L_{C1136} | R^{D9} | R^{D236} |
| L_{C813} | R^{D237} | R^{D237} | L_{C921} | R^{D1} | R^{D237} | L_{C1029} | R^{D4} | R^{D237} | L_{C1137} | R^{D9} | R^{D237} |
| L_{C814} | R^{D238} | R^{D238} | L_{C922} | R^{D1} | R^{D238} | L_{C1030} | R^{D4} | R^{D238} | L_{C1138} | R^{D9} | R^{D238} |
| L_{C815} | R^{D239} | R^{D239} | L_{C923} | R^{D1} | R^{D239} | L_{C1031} | R^{D4} | R^{D239} | L_{C1139} | R^{D9} | R^{D239} |
| L_{C816} | R^{D240} | R^{D240} | L_{C924} | R^{D1} | R^{D240} | L_{C1032} | R^{D4} | R^{D240} | L_{C1140} | R^{D9} | R^{D240} |
| L_{C817} | R^{D241} | R^{D241} | L_{C925} | R^{D1} | R^{D241} | L_{C1033} | R^{D4} | R^{D241} | L_{C1141} | R^{D9} | R^{D241} |
| L_{C818} | R^{D242} | R^{D242} | L_{C926} | R^{D1} | R^{D242} | L_{C1034} | R^{D4} | R^{D242} | L_{C1142} | R^{D9} | R^{D242} |
| L_{C819} | R^{D243} | R^{D243} | L_{C927} | R^{D1} | R^{D243} | L_{C1035} | R^{D4} | R^{D243} | L_{C1143} | R^{D9} | R^{D243} |
| L_{C820} | R^{D244} | R^{D244} | L_{C928} | R^{D1} | R^{D244} | L_{C1036} | R^{D4} | R^{D244} | L_{C1144} | R^{D9} | R^{D244} |
| L_{C821} | R^{D245} | R^{D245} | L_{C929} | R^{D1} | R^{D245} | L_{C1037} | R^{D4} | R^{D245} | L_{C1145} | R^{D9} | R^{D245} |
| L_{C822} | R^{D246} | R^{D246} | L_{C930} | R^{D1} | R^{D246} | L_{C1038} | R^{D4} | R^{D246} | L_{C1146} | R^{D9} | R^{D246} |
| L_{C823} | R^{D17} | R^{D193} | L_{C931} | R^{D50} | R^{D193} | L_{C1039} | R^{D145} | R^{D193} | L_{C1147} | R^{D168} | R^{D193} |
| L_{C824} | R^{D17} | R^{D194} | L_{C932} | R^{D50} | R^{D194} | L_{C1040} | R^{D145} | R^{D194} | L_{C1148} | R^{D168} | R^{D194} |
| L_{C825} | R^{D17} | R^{D195} | L_{C933} | R^{D50} | R^{D195} | L_{C1041} | R^{D145} | R^{D195} | L_{C1149} | R^{D168} | R^{D195} |
| L_{C826} | R^{D17} | R^{D196} | L_{C934} | R^{D50} | R^{D196} | L_{C1042} | R^{D145} | R^{D196} | L_{C1150} | R^{D168} | R^{D196} |
| L_{C827} | R^{D17} | R^{D197} | L_{C935} | R^{D50} | R^{D197} | L_{C1043} | R^{D145} | R^{D197} | L_{C1151} | R^{D168} | R^{D197} |
| L_{C828} | R^{D17} | R^{D198} | L_{C936} | R^{D50} | R^{D198} | L_{C1044} | R^{D145} | R^{D198} | L_{C1152} | R^{D168} | R^{D198} |
| L_{C829} | R^{D17} | R^{D199} | L_{C937} | R^{D50} | R^{D199} | L_{C1045} | R^{D145} | R^{D199} | L_{C1153} | R^{D168} | R^{D199} |
| L_{C830} | R^{D17} | R^{D200} | L_{C938} | R^{D50} | R^{D200} | L_{C1046} | R^{D145} | R^{D200} | L_{C1154} | R^{D168} | R^{D200} |
| L_{C831} | R^{D17} | R^{D201} | L_{C939} | R^{D50} | R^{D201} | L_{C1047} | R^{D145} | R^{D201} | L_{C1155} | R^{D168} | R^{D201} |
| L_{C832} | R^{D17} | R^{D202} | L_{C940} | R^{D50} | R^{D202} | L_{C1048} | R^{D145} | R^{D202} | L_{C1156} | R^{D168} | R^{D202} |
| L_{C833} | R^{D17} | R^{D203} | L_{C941} | R^{D50} | R^{D203} | L_{C1049} | R^{D145} | R^{D203} | L_{C1157} | R^{D168} | R^{D203} |
| L_{C834} | R^{D17} | R^{D204} | L_{C942} | R^{D50} | R^{D204} | L_{C1050} | R^{D145} | R^{D204} | L_{C1158} | R^{D168} | R^{D204} |
| L_{C835} | R^{D17} | R^{D205} | L_{C943} | R^{D50} | R^{D205} | L_{C1051} | R^{D145} | R^{D205} | L_{C1159} | R^{D168} | R^{D205} |
| L_{C836} | R^{D17} | R^{D206} | L_{C944} | R^{D50} | R^{D206} | L_{C1052} | R^{D145} | R^{D206} | L_{C1160} | R^{D168} | R^{D206} |
| L_{C837} | R^{D17} | R^{D207} | L_{C945} | R^{D50} | R^{D207} | L_{C1053} | R^{D145} | R^{D207} | L_{C1161} | R^{D168} | R^{D207} |
| L_{C838} | R^{D17} | R^{D208} | L_{C946} | R^{D50} | R^{D208} | L_{C1054} | R^{D145} | R^{D208} | L_{C1162} | R^{D168} | R^{D208} |
| L_{C839} | R^{D17} | R^{D209} | L_{C947} | R^{D50} | R^{D209} | L_{C1055} | R^{D145} | R^{D209} | L_{C1163} | R^{D168} | R^{D209} |
| L_{C840} | R^{D17} | R^{D210} | L_{C948} | R^{D50} | R^{D210} | L_{C1056} | R^{D145} | R^{D210} | L_{C1164} | R^{D168} | R^{D210} |
| L_{C841} | R^{D17} | R^{D211} | L_{C949} | R^{D50} | R^{D211} | L_{C1057} | R^{D145} | R^{D211} | L_{C1165} | R^{D168} | R^{D211} |
| L_{C842} | R^{D17} | R^{D212} | L_{C950} | R^{D50} | R^{D212} | L_{C1058} | R^{D145} | R^{D212} | L_{C1166} | R^{D168} | R^{D212} |
| L_{C843} | R^{P17} | R^{D213} | L_{C951} | R^{D50} | R^{D213} | L_{C1059} | R^{D145} | R^{D213} | L_{C1167} | R^{D168} | R^{D213} |
| L_{C844} | R^{P17} | R^{D214} | L_{C952} | R^{D50} | R^{D214} | L_{C1060} | R^{D145} | R^{D214} | L_{C1168} | R^{D168} | R^{D214} |
| L_{C845} | R^{D17} | R^{D215} | L_{C953} | R^{D50} | R^{D215} | L_{C1061} | R^{D145} | R^{D215} | L_{C1169} | R^{D168} | R^{D215} |
| L_{C846} | R^{D17} | R^{D216} | L_{C954} | R^{D50} | R^{D216} | L_{C1062} | R^{D145} | R^{D216} | L_{C1170} | R^{D168} | R^{D216} |
| L_{C847} | R^{D17} | R^{D217} | L_{C955} | R^{D50} | R^{D217} | L_{C1063} | R^{D145} | R^{D217} | L_{C171} | R^{D168} | R^{D217} |
| L_{C848} | R^{D17} | R^{D218} | L_{C956} | R^{D50} | R^{D218} | L_{C1064} | R^{D145} | R^{D218} | L_{C1172} | R^{D168} | R^{D218} |
| L_{C849} | R^{D17} | R^{D219} | L_{C957} | R^{D50} | R^{D219} | L_{C1065} | R^{D145} | R^{D219} | L_{C1173} | R^{D168} | R^{D219} |
| L_{C850} | R^{D17} | R^{D220} | L_{C958} | R^{D50} | R^{D220} | L_{C1066} | R^{D145} | R^{D220} | L_{C1174} | R^{D168} | R^{D220} |
| L_{C851} | R^{D17} | R^{D221} | L_{C959} | R^{D50} | R^{D221} | L_{C1067} | R^{D145} | R^{D221} | L_{C1175} | R^{D168} | R^{D221} |
| L_{C852} | R^{D17} | R^{D222} | L_{C960} | R^{D50} | R^{D222} | L_{C1068} | R^{D145} | R^{D222} | L_{C1176} | R^{D168} | R^{D222} |
| L_{C853} | R^{D17} | R^{D223} | L_{C961} | R^{D50} | R^{D223} | L_{C1069} | R^{D145} | R^{D223} | L_{C1177} | R^{D168} | R^{D223} |
| L_{C854} | R^{D17} | R^{D224} | L_{C962} | R^{D50} | R^{D224} | L_{C1070} | R^{D145} | R^{D224} | L_{C1178} | R^{D168} | R^{D224} |
| L_{C855} | R^{D17} | R^{D225} | L_{C963} | R^{D50} | R^{D225} | L_{C1071} | R^{D145} | R^{D225} | L_{C1179} | R^{D168} | R^{D225} |
| L_{C856} | R^{D17} | R^{D226} | L_{C964} | R^{D50} | R^{D226} | L_{C1072} | R^{D145} | R^{D226} | L_{C1180} | R^{D168} | R^{D226} |
| L_{C857} | R^{D17} | R^{D227} | L_{C965} | R^{D50} | R^{D227} | L_{C1073} | R^{D145} | R^{D227} | L_{C1181} | R^{D168} | R^{D227} |
| L_{C858} | R^{D17} | R^{D228} | L_{C966} | R^{D50} | R^{D228} | L_{C1074} | R^{D145} | R^{D228} | L_{C1182} | R^{D168} | R^{D228} |
| L_{C859} | R^{D17} | R^{D229} | L_{C967} | R^{D50} | R^{D229} | L_{C1075} | R^{D145} | R^{D229} | L_{C1183} | R^{D168} | R^{D229} |
| L_{C860} | R^{D17} | R^{D230} | L_{C968} | R^{D50} | R^{D230} | L_{C1076} | R^{D145} | R^{D230} | L_{C1184} | R^{D168} | R^{D230} |
| L_{C861} | R^{D17} | R^{D231} | L_{C969} | R^{D50} | R^{D231} | L_{C1077} | R^{D145} | R^{D231} | L_{C1185} | R^{D168} | R^{D231} |
| L_{C862} | R^{D17} | R^{D232} | L_{C970} | R^{D50} | R^{D232} | L_{C1078} | R^{D145} | R^{D232} | L_{C1186} | R^{D168} | R^{D232} |
| L_{C863} | R^{D17} | R^{D233} | L_{C971} | R^{D50} | R^{D233} | L_{C1079} | R^{D145} | R^{D233} | L_{C1187} | R^{D168} | R^{D233} |
| L_{C864} | R^{D17} | R^{D234} | L_{C972} | R^{D50} | R^{D234} | L_{C1080} | R^{D145} | R^{D234} | L_{C1188} | R^{D168} | R^{D234} |
| L_{C865} | R^{D17} | R^{D235} | L_{C973} | R^{D50} | R^{D235} | L_{C1081} | R^{D145} | R^{D235} | L_{C1189} | R^{D168} | R^{D235} |
| L_{C866} | R^{D17} | R^{D236} | L_{C974} | R^{D50} | R^{D236} | L_{C1082} | R^{D145} | R^{D236} | L_{C1190} | R^{D168} | R^{D236} |
| L_{C867} | R^{D17} | R^{D237} | L_{C975} | R^{D50} | R^{D237} | L_{C1083} | R^{D145} | R^{D237} | L_{C1191} | R^{D168} | R^{D237} |
| L_{C868} | R^{D17} | R^{D238} | L_{C976} | R^{D50} | R^{D238} | L_{C1084} | R^{D145} | R^{D238} | L_{C1192} | R^{D168} | R^{D238} |
| L_{C869} | R^{D17} | R^{D239} | L_{C977} | R^{D50} | R^{D239} | L_{C1085} | R^{D145} | R^{D239} | L_{C1193} | R^{D168} | R^{D239} |
| L_{C870} | R^{D17} | R^{D240} | L_{C978} | R^{D50} | R^{D240} | L_{C1086} | R^{D145} | R^{D240} | L_{C1194} | R^{D168} | R^{D240} |
| L_{C871} | R^{D17} | R^{D241} | L_{C979} | R^{D50} | R^{D241} | L_{C1087} | R^{D145} | R^{D241} | L_{C1195} | R^{D168} | R^{D241} |
| L_{C872} | R^{D17} | R^{D242} | L_{C980} | R^{D50} | R^{D242} | L_{C1088} | R^{D145} | R^{D242} | L_{C1196} | R^{D168} | R^{D242} |
| L_{C873} | R^{D17} | R^{D243} | L_{C981} | R^{D50} | R^{D243} | L_{C1089} | R^{D145} | R^{D243} | L_{C1197} | R^{D168} | R^{D243} |
| L_{C874} | R^{D17} | R^{D244} | L_{C982} | R^{D50} | R^{D244} | L_{C1090} | R^{D145} | R^{D244} | L_{C1198} | R^{D168} | R^{D244} |
| L_{C875} | R^{D17} | R^{D245} | L_{C983} | R^{D50} | R^{D245} | L_{C1091} | R^{D145} | R^{D245} | L_{C1199} | R^{D168} | R^{D245} |
| L_{C876} | R^{D17} | R^{D246} | L_{C984} | R^{D50} | R^{D246} | L_{C1092} | R^{D145} | R^{D246} | L_{C1200} | R^{D168} | R^{D246} |
| L_{C1201} | R^{D10} | R^{D193} | L_{C1255} | R^{D55} | R^{D193} | L_{C1309} | R^{D37} | R^{D193} | L_{C1363} | R^{D143} | R^{D193} |
| L_{C1202} | R^{D10} | R^{D194} | L_{C1256} | R^{D55} | R^{D194} | L_{C1310} | R^{D37} | R^{D194} | L_{C1364} | R^{D143} | R^{D194} |
| L_{C1203} | R^{D10} | R^{D195} | L_{C1257} | R^{D55} | R^{D195} | L_{C1311} | R^{D37} | R^{D195} | L_{C1365} | R^{D143} | R^{D195} |
| L_{C1204} | R^{D10} | R^{D196} | L_{C1258} | R^{D55} | R^{D196} | L_{C1312} | R^{D37} | R^{D196} | L_{C1366} | R^{D143} | R^{D196} |
| L_{C1205} | R^{D10} | R^{D197} | L_{C1259} | R^{D55} | R^{D197} | L_{C1313} | R^{D37} | R^{D197} | L_{C1367} | R^{D143} | R^{D197} |
| L_{C1206} | R^{D10} | R^{D198} | L_{C1260} | R^{D55} | R^{D198} | L_{C1314} | R^{D37} | R^{D198} | L_{C1368} | R^{D143} | R^{D198} |
| L_{C1207} | R^{D10} | R^{D199} | L_{C1261} | R^{D55} | R^{D199} | L_{C1315} | R^{D37} | R^{D199} | L_{C1369} | R^{D143} | R^{D199} |
| L_{C1208} | R^{D10} | R^{D200} | L_{C1262} | R^{D55} | R^{D200} | L_{C1316} | R^{D37} | R^{D200} | L_{C2370} | R^{D143} | R^{D200} |
| L_{C1209} | R^{D10} | R^{D201} | L_{C1263} | R^{D55} | R^{D201} | L_{C1317} | R^{D37} | R^{D201} | L_{C1371} | R^{D143} | R^{D201} |
| L_{C1210} | R^{D10} | R^{D202} | _{LC1264} | R^{D55} | R^{D202} | L_{C1318} | R^{D37} | R^{D202} | L_{C1372} | R^{D143} | R^{D202} |
| L_{C1211} | R^{D10} | R^{D203} | L_{C1265} | R^{D55} | R^{D203} | L_{C1319} | R^{D37} | R^{D203} | L_{C1373} | R^{D143} | R^{D203} |
| L_{C1212} | R^{D10} | R^{D204} | L_{C1266} | R^{D55} | R^{D204} | L_{C1320} | R^{D37} | R^{D204} | L_{C1374} | R^{D143} | R^{D204} |
| L_{C1213} | R^{D10} | R^{D205} | L_{C1267} | R^{D55} | R^{D205} | L_{C1321} | R^{D37} | R^{D205} | L_{C1375} | R^{D143} | R^{D205} |
| L_{C1214} | R^{D10} | R^{D206} | L_{C1268} | R^{D55} | R^{D206} | L_{C1322} | R^{D37} | R^{D206} | L_{C1376} | R^{D143} | R^{D206} |
| L_{C1215} | R^{D10} | R^{D207} | L_{C1269} | R^{D55} | R^{D207} | L_{C1323} | R^{D37} | R^{D207} | L_{C1377} | R^{D143} | R^{D207} |
| L_{C1216} | R^{D10} | R^{D208} | L_{C1270} | R^{D55} | R^{D208} | L_{C1324} | R^{D37} | R^{D208} | L_{C1378} | R^{D143} | R^{D208} |
| L_{C1217} | R^{D10} | R^{D209} | L_{C1271} | R^{D55} | R^{D209} | L_{C1325} | R^{D37} | R^{D209} | L_{C1379} | R^{D143} | R^{D209} |
| L_{C1218} | R^{D10} | R^{D210} | L_{C1272} | R^{D55} | R^{D210} | L_{C1326} | R^{D37} | R^{D210} | L_{C1380} | R^{D143} | R^{D210} |
| L_{C1219} | R^{D10} | R^{D211} | L_{C1273} | R^{D55} | R^{D211} | L_{C1327} | R^{D37} | R^{D211} | L_{C1381} | R^{D143} | R^{D211} |
| L_{C1220} | R^{D10} | R^{D212} | L_{C1274} | R^{D55} | R^{D212} | L_{C1328} | R^{D37} | R^{D212} | L_{C1382} | R^{D143} | R^{D212} |
| L_{C1221} | R^{D10} | R^{D213} | L_{C1275} | R^{D55} | R^{D213} | L_{C1329} | R^{D37} | R^{D213} | L_{C1383} | R^{D143} | R^{D213} |
| L_{C1222} | R^{D10} | R^{D214} | L_{C1276} | R^{D55} | R^{D214} | L_{C1330} | R^{D37} | R^{D214} | L_{C1384} | R^{D143} | R^{D214} |
| L_{C1223} | R^{D10} | R^{D215} | L_{C1277} | R^{D55} | R^{D215} | L_{C1331} | R^{D37} | R^{D215} | L_{C1385} | R^{D143} | R^{D215} |
| L_{C1224} | R^{D10} | R^{D216} | L_{C1278} | R^{D55} | R^{D216} | L_{C1332} | R^{D37} | R^{D216} | L_{C1386} | R^{D143} | R^{D216} |
| L_{C1225} | R^{D10} | R^{D217} | L_{C1279} | R^{D55} | R^{D217} | L_{C1333} | R^{D37} | R^{D217} | L_{C1387} | R^{D143} | R^{D217} |
| L_{C1226} | R^{D10} | R^{D218} | L_{C1280} | R^{D55} | R^{D218} | L_{C1334} | R^{D37} | R^{D218} | L_{C1388} | R^{D143} | R^{D218} |
| L_{C1227} | R^{D10} | R^{D219} | L_{C1281} | R^{D55} | R^{D219} | L_{C1335} | R^{D37} | R^{D219} | L_{C1389} | R^{D143} | R^{D219} |
| L_{C1228} | R^{D10} | R^{D220} | L_{C1282} | R^{D55} | R^{D220} | L_{C1336} | R^{D37} | R^{D220} | L_{C1390} | R^{D143} | R^{D220} |
| L_{C1229} | R^{D10} | R^{D221} | L_{C1283} | R^{D55} | R^{D221} | L_{C1337} | R^{D37} | R^{D221} | L_{C1391} | R^{D143} | R^{D221} |
| L_{C1230} | R^{D10} | R^{D222} | L_{C1284} | R^{D55} | R^{D222} | L_{C1338} | R^{D37} | R^{D222} | L_{C1392} | R^{D143} | R^{D222} |
| L_{C1231} | R^{D10} | R^{D223} | L_{C1285} | R^{D55} | R^{D223} | L_{C1339} | R^{D37} | R^{D223} | L_{C1393} | R^{D143} | R^{D223} |
| L_{C1232} | R^{D10} | R^{D224} | L_{C1286} | R^{D55} | R^{D224} | L_{C1340} | R^{D37} | R^{D224} | L_{C1394} | R^{D143} | R^{D224} |
| L_{C1233} | R^{D10} | R^{D225} | L_{C1287} | R^{D55} | R^{D225} | L_{C1341} | R^{D37} | R^{D225} | L_{C1395} | R^{D143} | R^{D225} |
| L_{C1234} | R^{D10} | R^{D226} | L_{C1288} | R^{D55} | R^{D226} | L_{C1342} | R^{D37} | R^{D226} | L_{C1396} | R^{D143} | R^{D226} |
| L_{C1235} | R^{D10} | R^{D227} | L_{C1289} | R^{D55} | R^{D227} | L_{C1343} | R^{D37} | R^{D227} | L_{C1397} | R^{D143} | R^{D227} |
| L_{C1236} | R^{D10} | R^{D228} | L_{C1290} | R^{D55} | R^{D228} | L_{C1344} | R^{D37} | R^{D228} | L_{C1398} | R^{D143} | R^{D228} |
| L_{C1237} | R^{D10} | R^{D229} | L_{C1291} | R^{D55} | R^{D229} | L_{C1345} | R^{D37} | R^{D229} | L_{C1399} | R^{D143} | R^{D229} |
| L_{C1238} | R^{D10} | R^{D230} | L_{C1292} | R^{D55} | R^{D230} | L_{C1346} | R^{D37} | R^{D230} | L_{C1400} | R^{D143} | R^{D230} |
| L_{C1239} | R^{D10} | R^{D231} | L_{C1293} | R^{D55} | R^{D231} | L_{C1347} | R^{D37} | R^{D231} | L_{C1401} | R^{D143} | R^{D231} |
| L_{C1240} | R^{D10} | R^{D232} | L_{C1294} | R^{D55} | R^{D232} | L_{C1348} | R^{D37} | R^{D232} | L_{C1402} | R^{D143} | R^{D232} |
| L_{C1241} | R^{D10} | R^{D233} | L_{C1295} | R^{D55} | R^{D233} | L_{C1349} | R^{D37} | R^{D233} | L_{C1403} | R^{D143} | R^{D233} |
| L_{C1242} | R^{D10} | R^{D234} | L_{C1296} | R^{D55} | R^{D234} | L_{C1350} | R^{D37} | R^{D234} | L_{C1404} | R^{D143} | R^{D234} |
| L_{C1243} | R^{D10} | R^{D235} | L_{C1297} | R^{D55} | R^{D235} | L_{C1351} | R^{D37} | R^{D235} | L_{C1405} | R^{D143} | R^{D235} |
| L_{C1244} | R^{D10} | R^{D236} | L_{C1298} | R^{D55} | R^{D236} | L_{C1352} | R^{D37} | R^{D236} | L_{C1406} | R^{D143} | R^{D236} |
| L_{C1245} | R^{D10} | R^{D237} | L_{C1299} | R^{D55} | R^{D237} | L_{C1353} | R^{D37} | R^{D237} | L_{C1407} | R^{D143} | R^{D237} |
| L_{C1246} | R^{D10} | R^{D238} | L_{C1300} | R^{D55} | R^{D238} | L_{C1354} | R^{D37} | R^{D238} | L_{C1408} | R^{D143} | R^{D238} |
| L_{C1247} | R^{D10} | R^{D239} | L_{C1301} | R^{D55} | R^{D239} | L_{C1355} | R^{D37} | R^{D239} | L_{C1409} | R^{D143} | R^{D239} |
| L_{C1248} | R^{D10} | R^{D240} | L_{C1302} | R^{D55} | R^{D240} | L_{C1356} | R^{D37} | R^{D240} | L_{C1410} | R^{D143} | R^{D240} |
| L_{C1249} | R^{D10} | R^{D241} | L_{C1303} | R^{D55} | R^{D241} | L_{C1357} | R^{D37} | R^{D241} | L_{C1411} | R^{D143} | R^{D241} |
| L_{C1250} | R^{D10} | R^{D242} | L_{C1304} | R^{D55} | R^{D242} | L_{C1358} | R^{D37} | R^{D242} | L_{C1412} | R^{D143} | R^{D242} |
| L_{C1251} | R^{D10} | R^{D243} | L_{C1305} | R^{D55} | R^{D243} | L_{C1359} | R^{D37} | R^{D243} | L_{C1413} | R^{D143} | R^{D243} |
| L_{C1252} | R^{D10} | R^{D244} | L_{C1306} | R^{D55} | R^{D244} | L_{C1360} | R^{D37} | R^{D244} | L_{C1414} | R^{D143} | R^{D244} |
| L_{C1253} | R^{D10} | R^{D245} | L_{C1307} | R^{D55} | R^{D245} | L_{C1361} | R^{D37} | R^{D245} | L_{C1415} | R^{D143} | R^{D245} |
| L_{C1254} | R^{D10} | R^{D246} | L_{C1308} | R^{D55} | R^{D246} | L_{C1362} | R^{D37} | R^{D246} | L_{C1416} | R^{D143} | R^{D246} |

wherein R^{D1} to R^{D246} have the following structures: 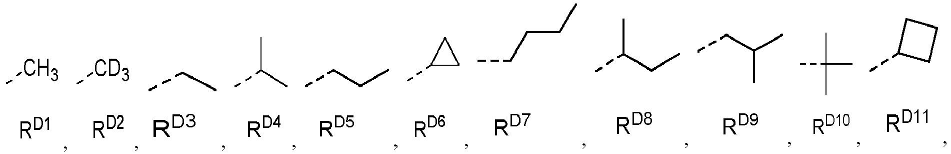 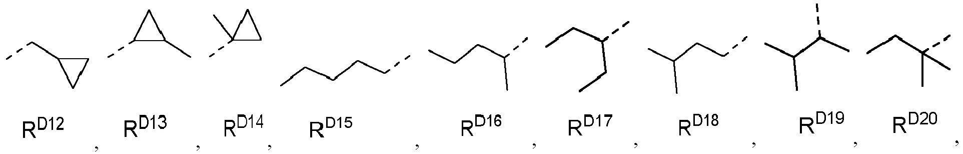 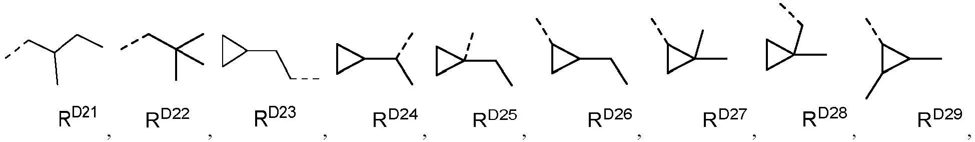 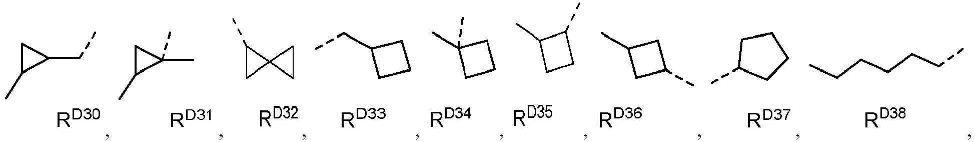 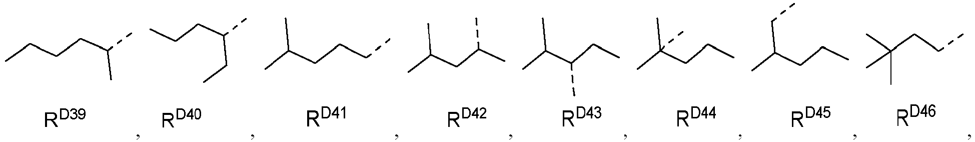 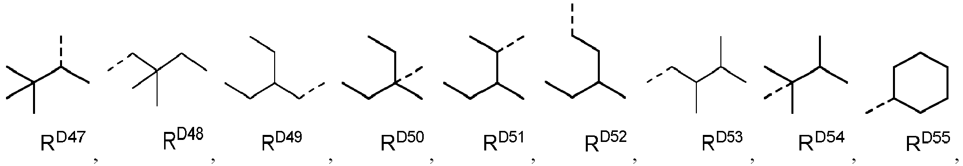 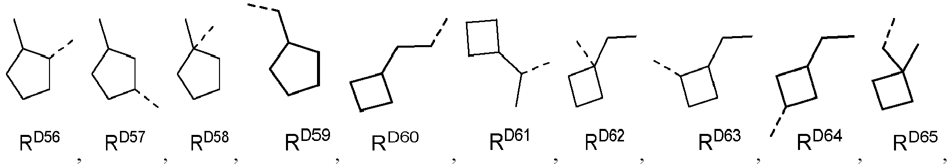 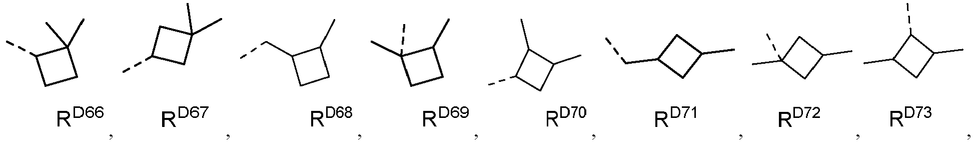 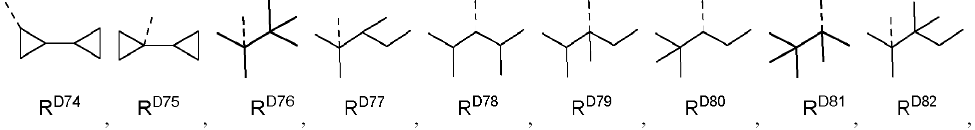 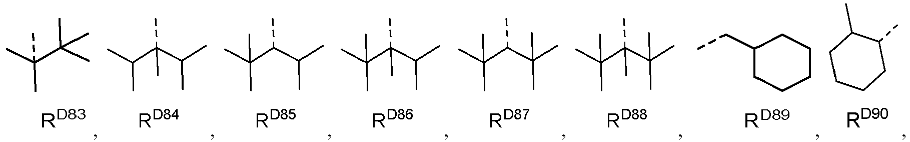 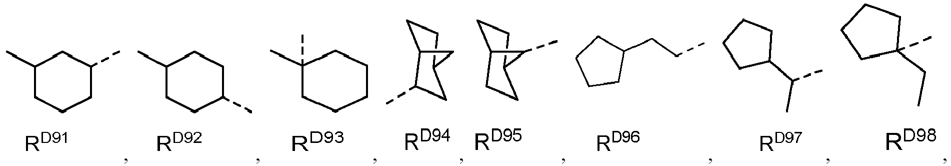 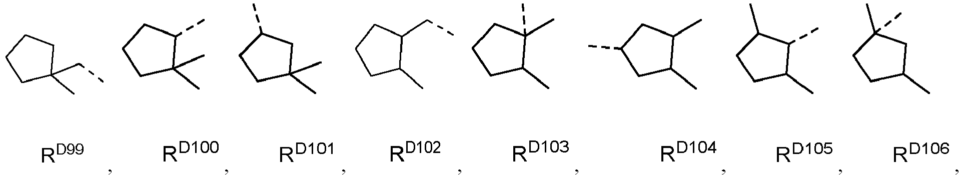 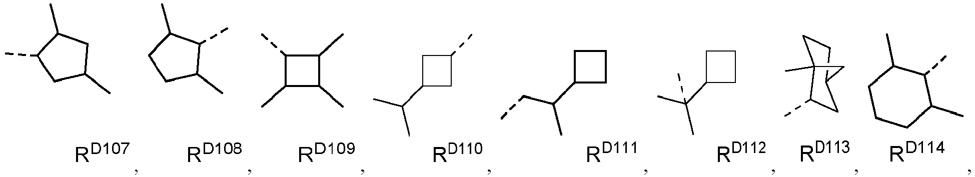 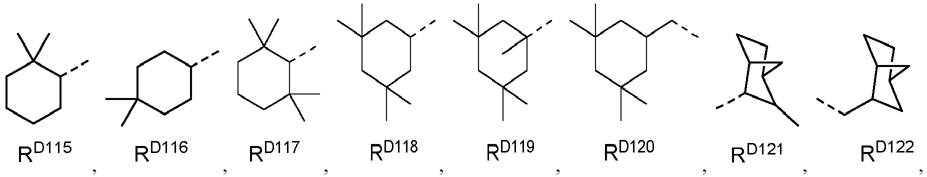 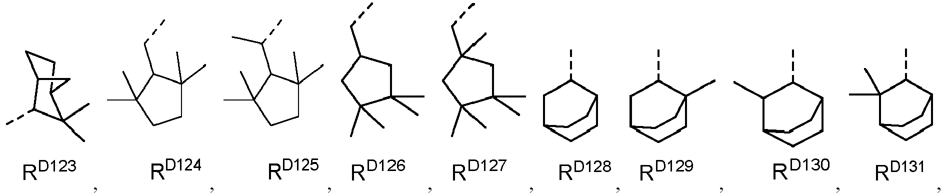 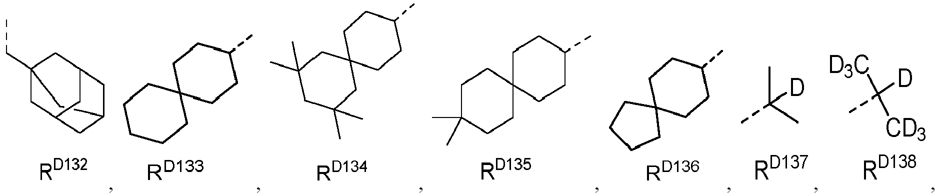 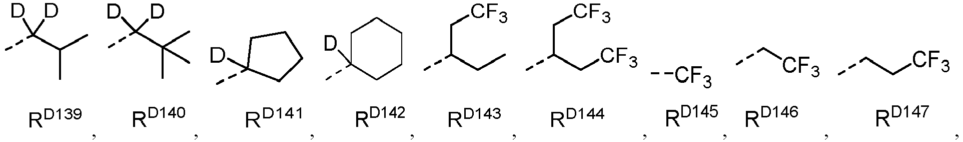 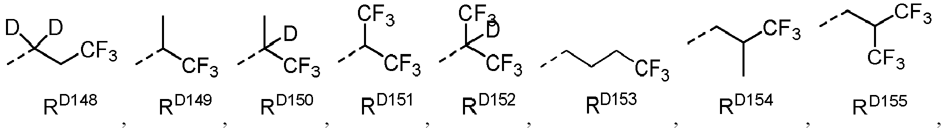 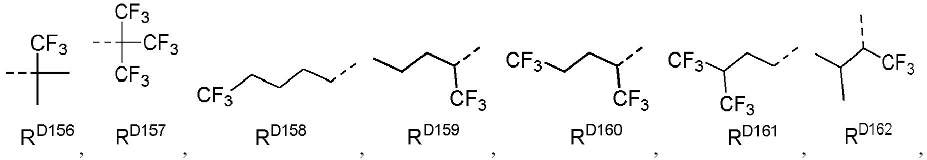 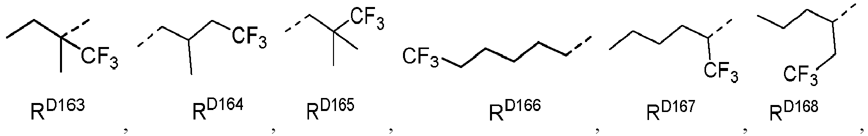 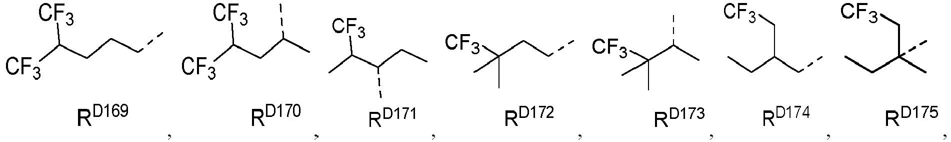 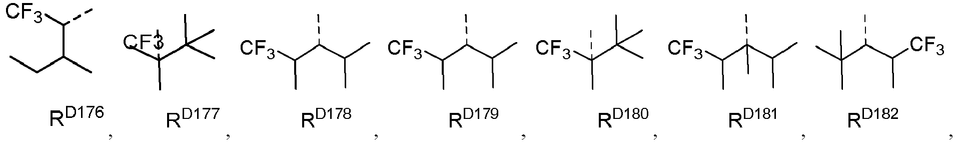 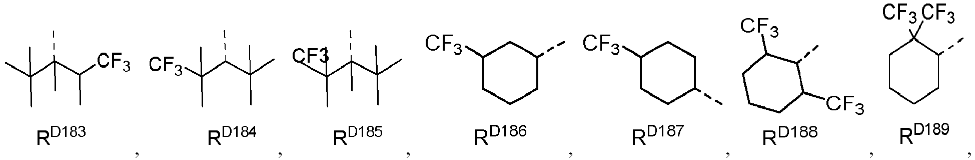 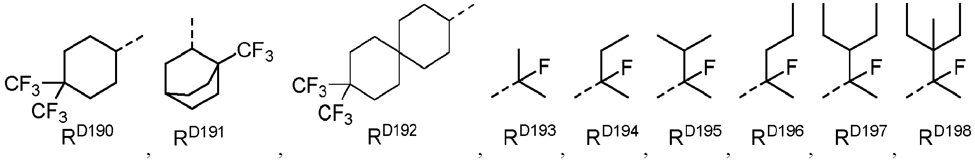 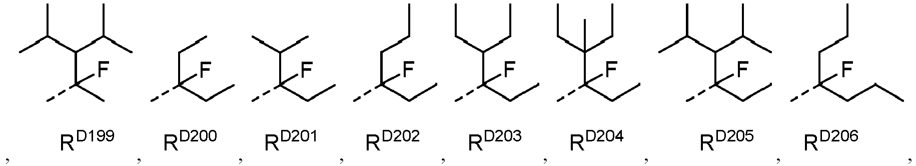 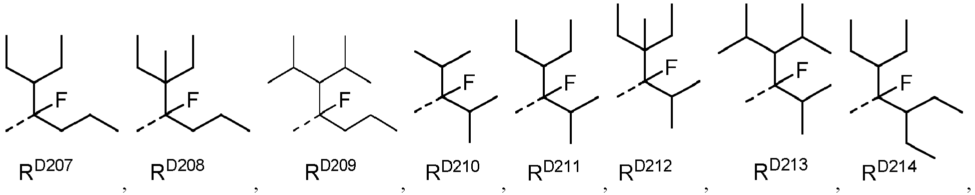 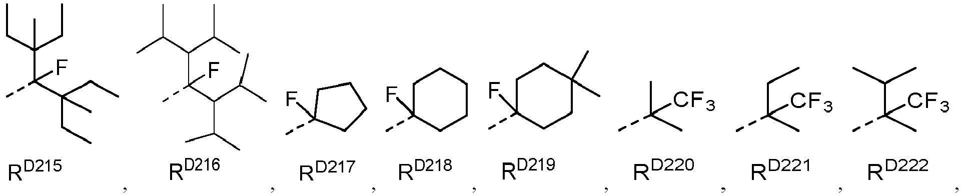 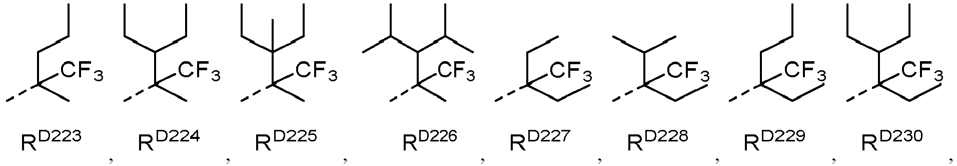 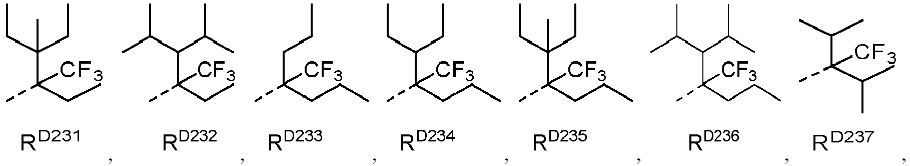 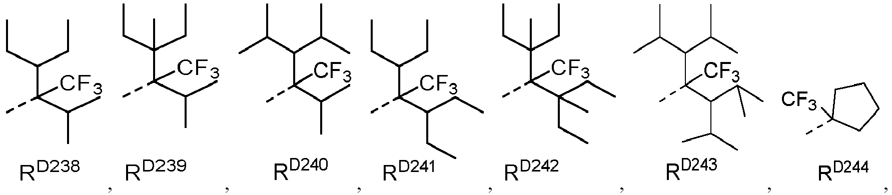 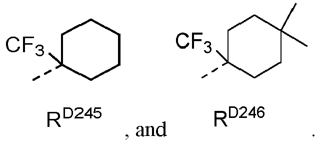 16. The compound of item 1, wherein the compound is selected from the group consisting of: 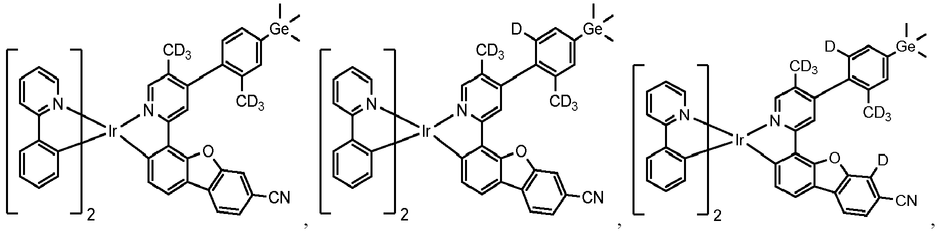 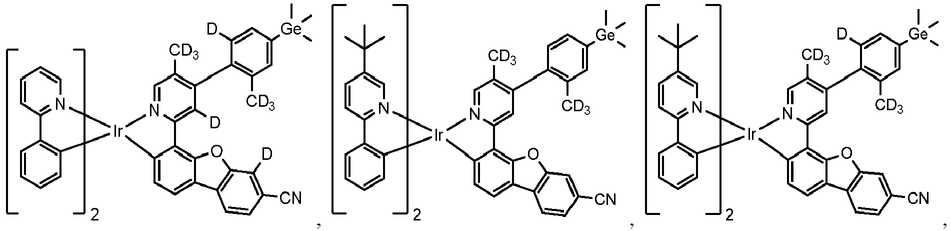 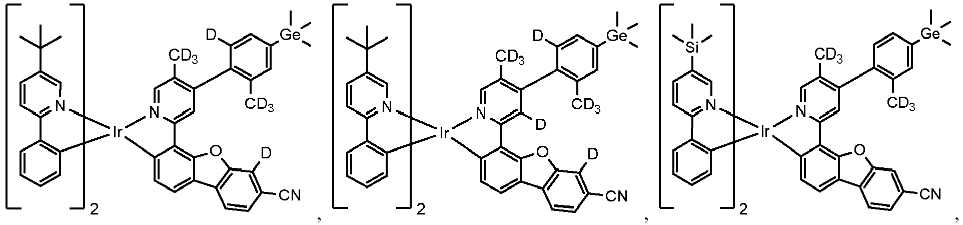 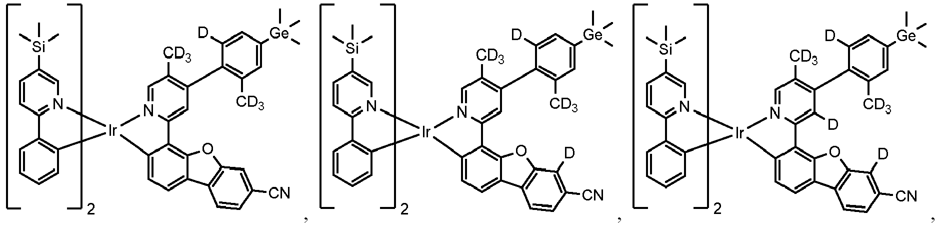 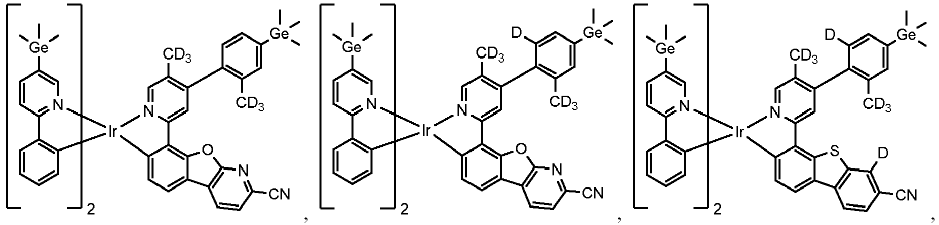 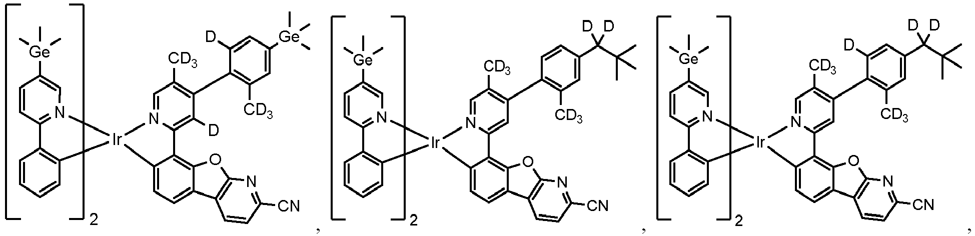 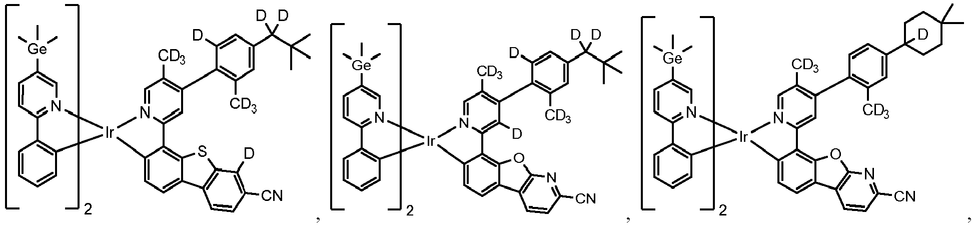 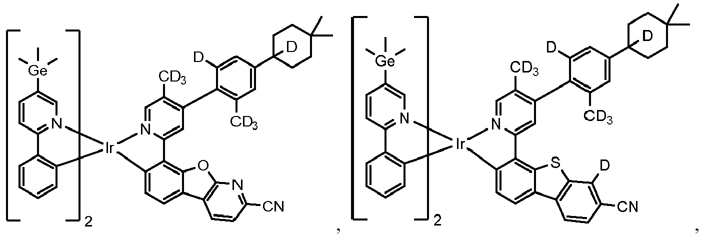 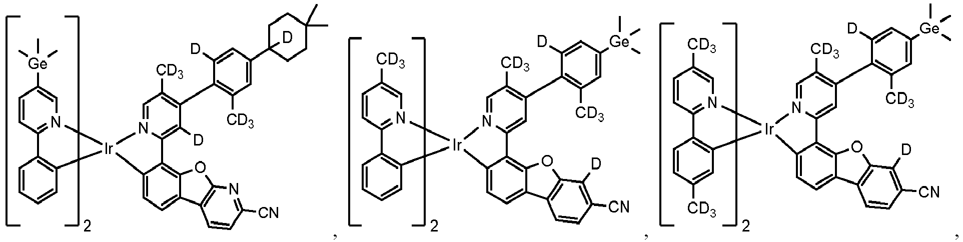 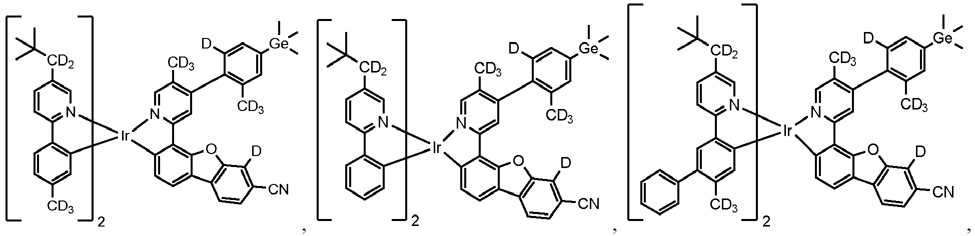 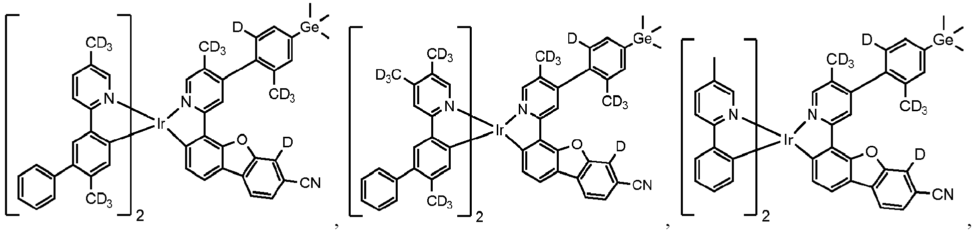 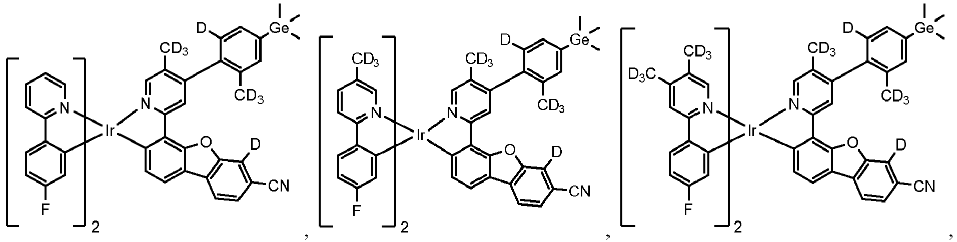 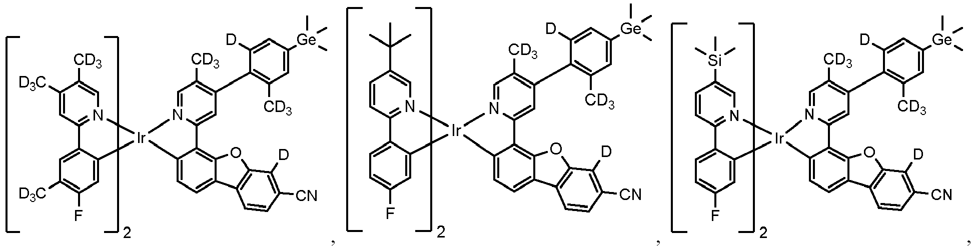 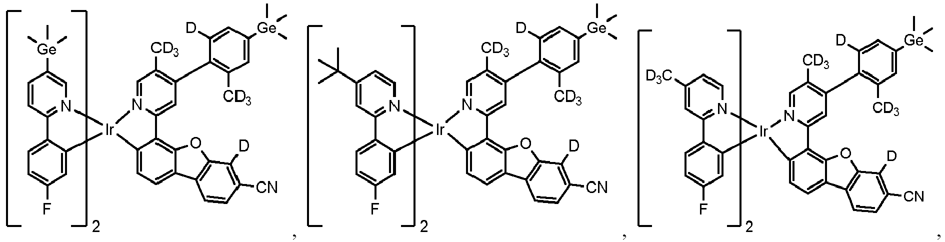 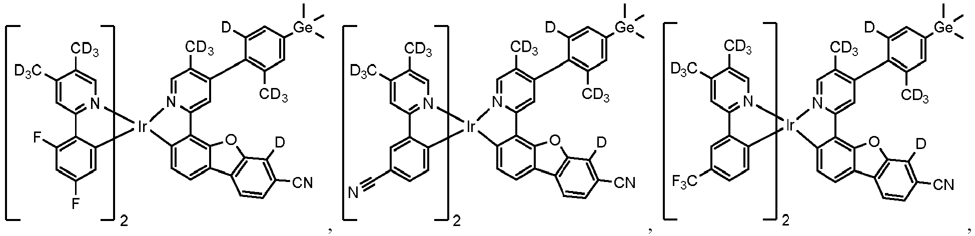 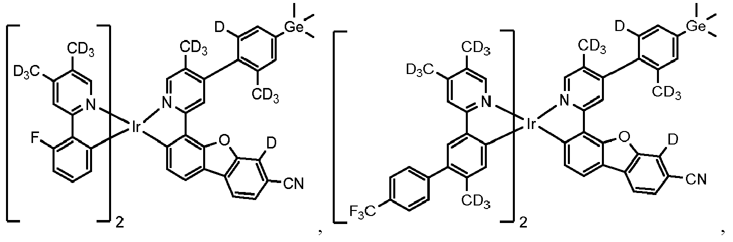 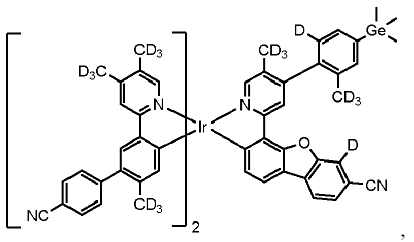 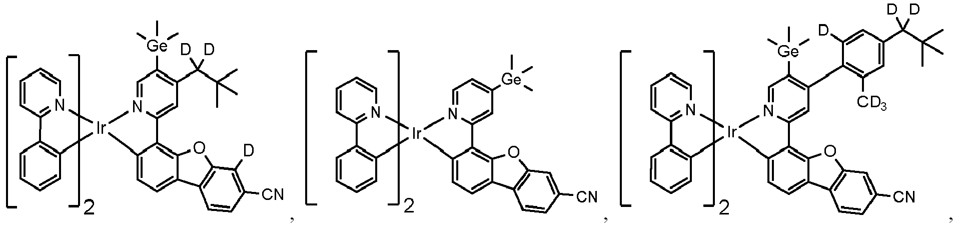 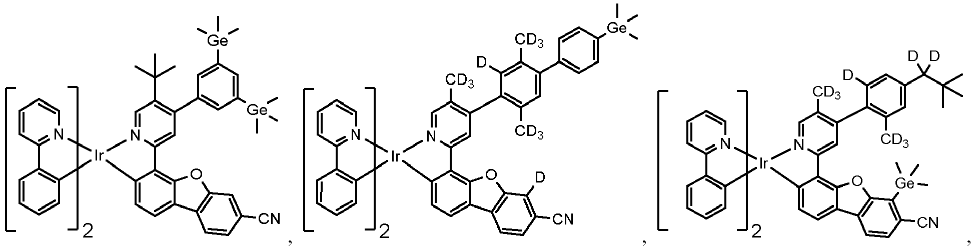 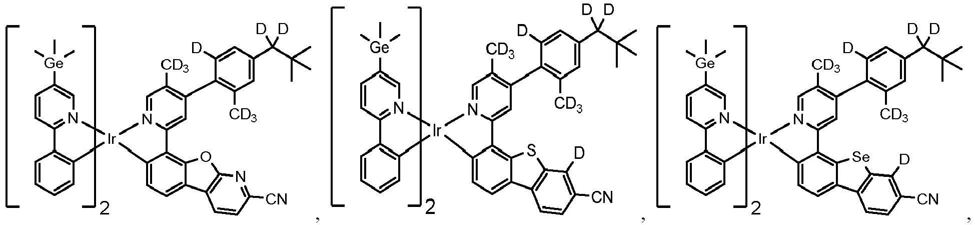 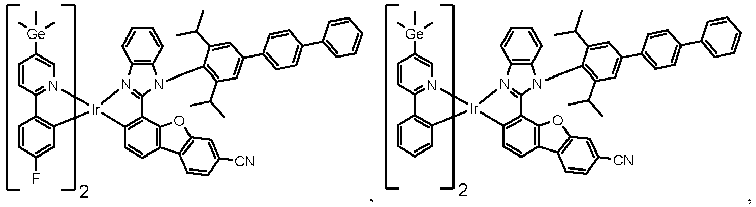 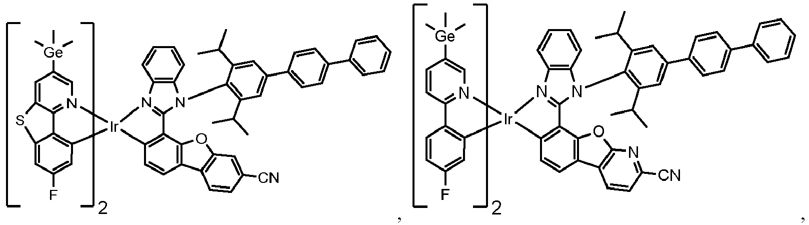 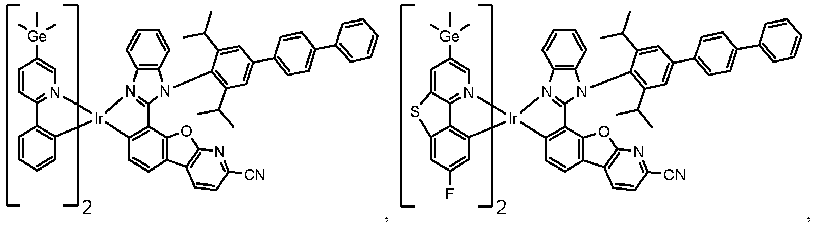 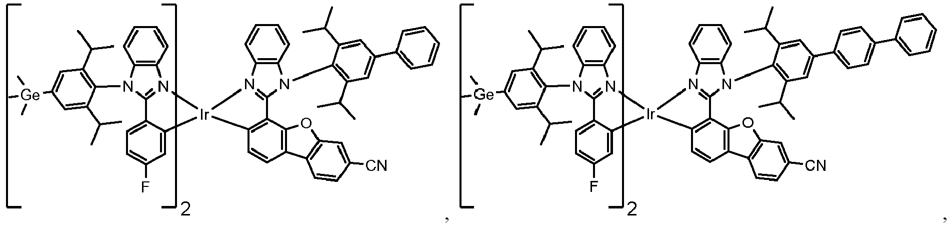 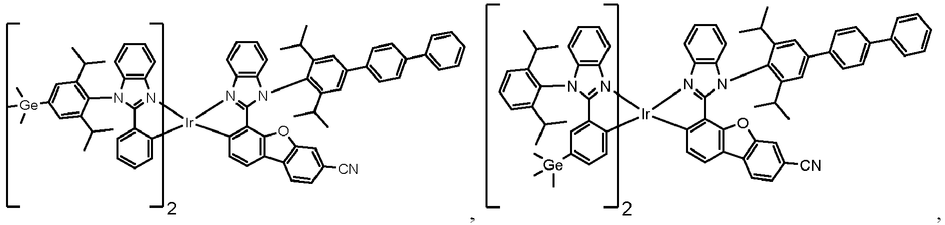 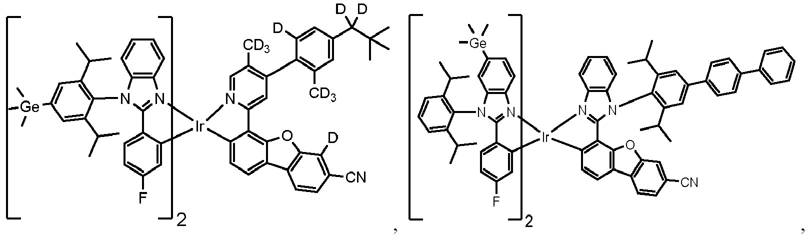 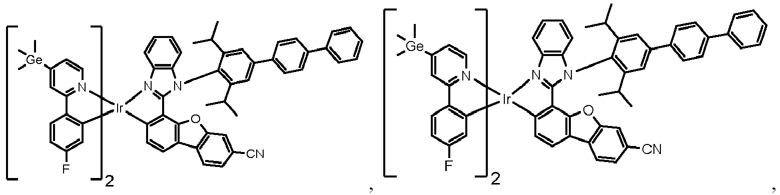 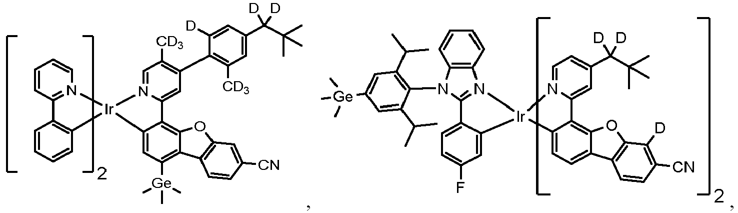 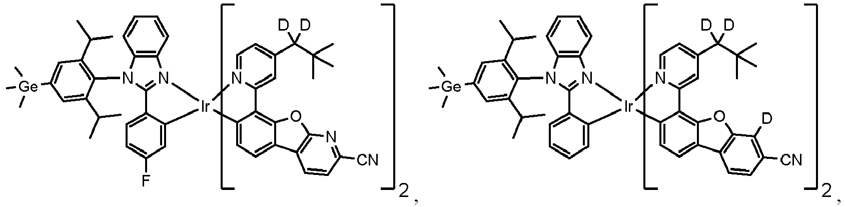 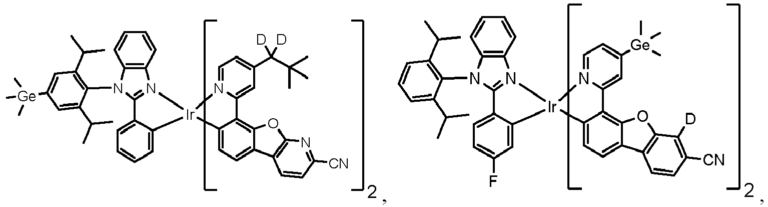 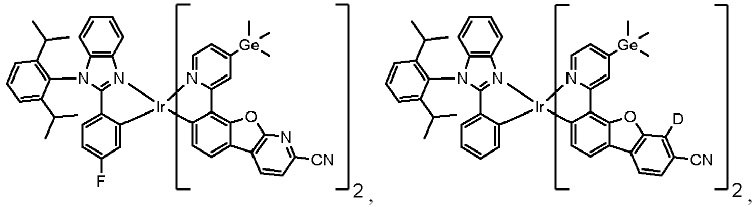 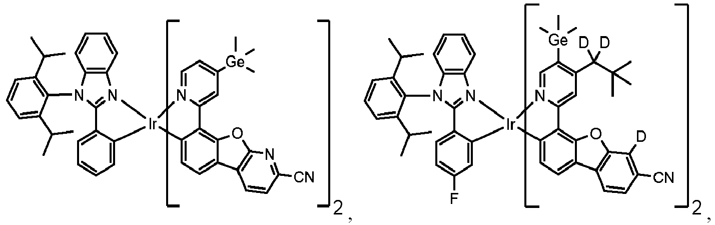 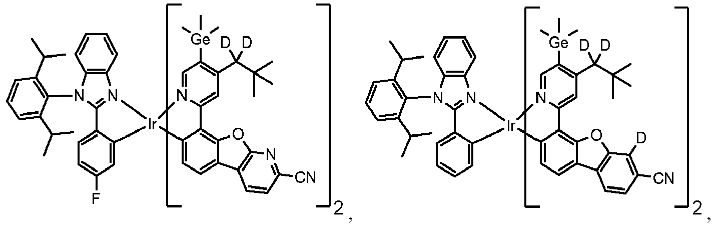 and 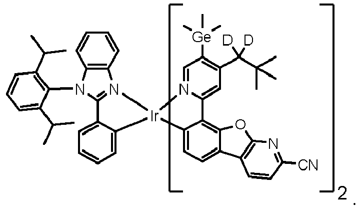 17. An organic light emitting device (OLED) comprising:
an anode;
a cathode; and
an organic layer disposed between the anode and the cathode, wherein the organic layer comprises a compound according to any one of the preceeding items.
18. The OLED of item 17, wherein the organic layer further comprises a host, wherein host comprises at least one chemical moiety selected from the group consisting of triphenylene, carbazole, indolocarbazole, dibenzothiophene, dibenzofuran, dibenzoselenophene, 5λ²-benzo[d]benzo[4,5]imidazo[3,2-a]imidazole, 5,9-dioxa-13b-boranaphtho[3,2,1-de]anthracene, triazine, boryl, silyl, aza-triphenylene, aza-carbazole, aza-indolocarbazole, aza-dibenzothiophene, aza-dibenzofuran, aza-dibenzoselenophene, aza-5λ²-benzo[d]benzo[4,5]imidazo[3,2-a]imidazole, and aza-(5,9-dioxa-13b-boranaphtho[3,2,1-de]anthracene).
19. The OLED of item 17, wherein the organic layer further comprises a host, wherein the host is selected from the group consisting of: 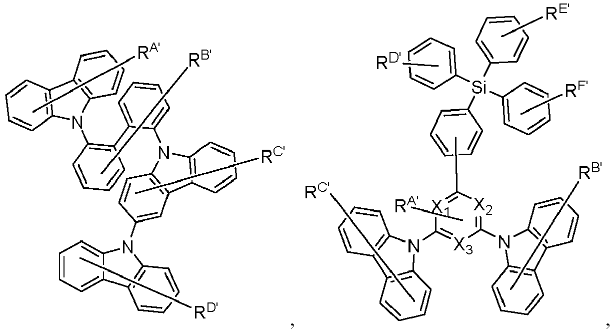 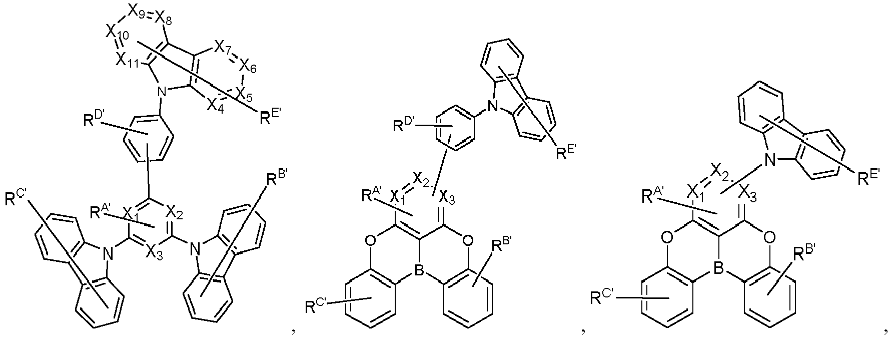 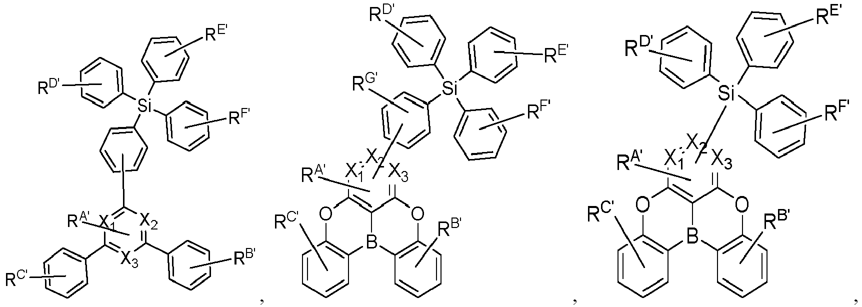 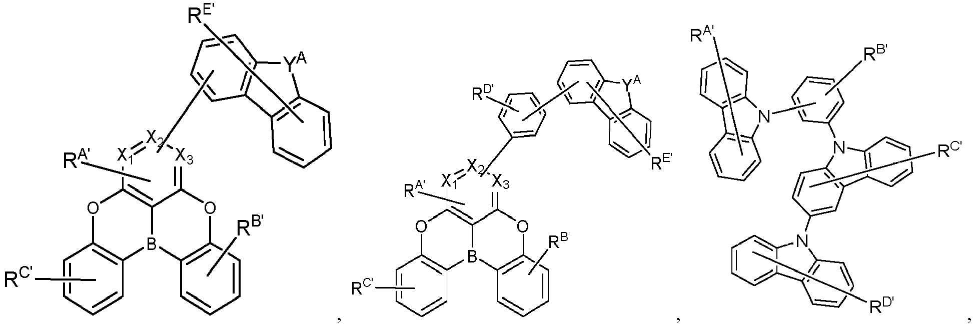 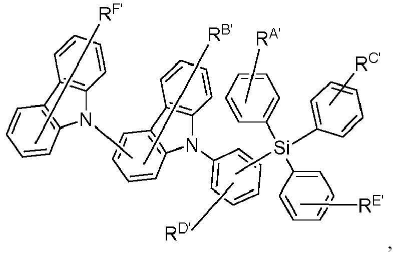 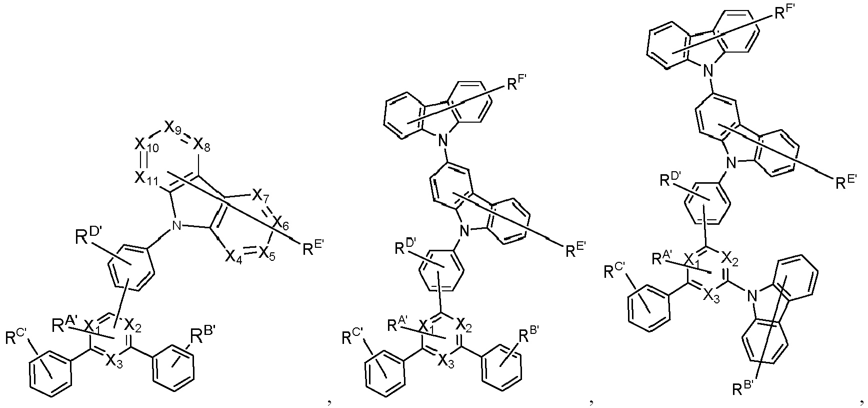 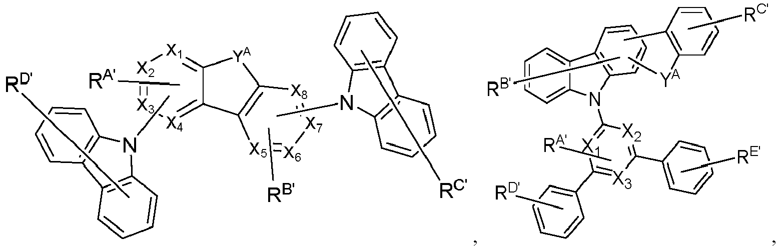 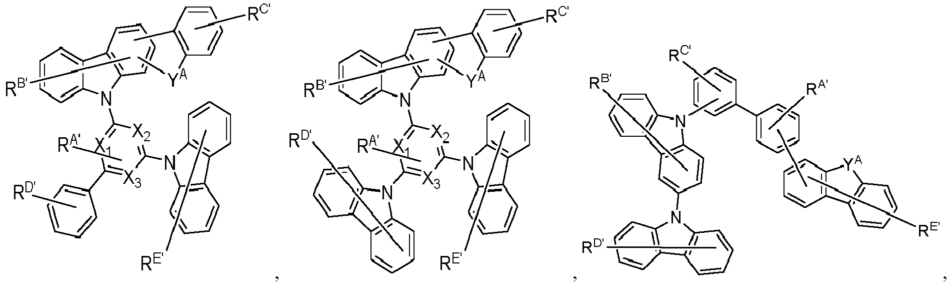 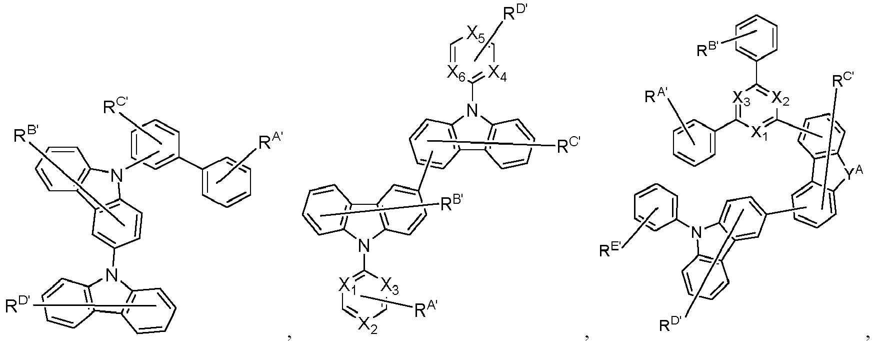 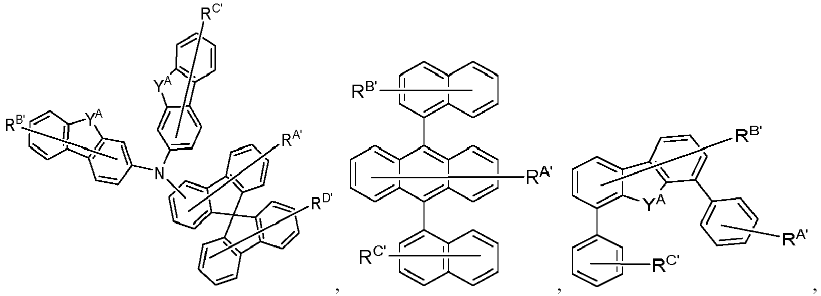 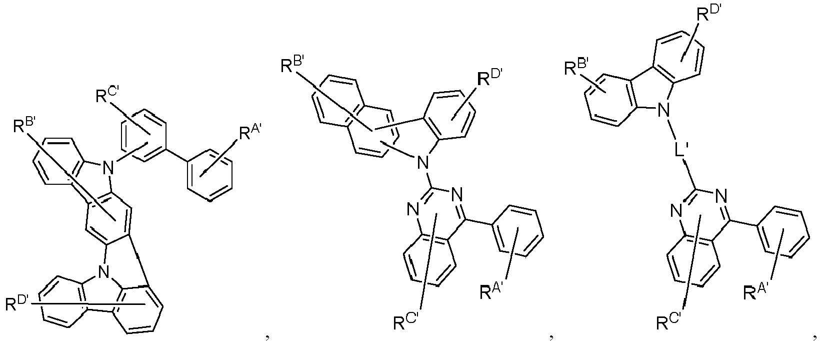 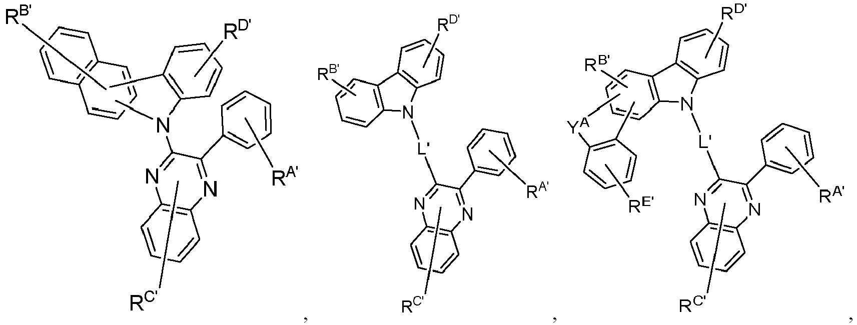 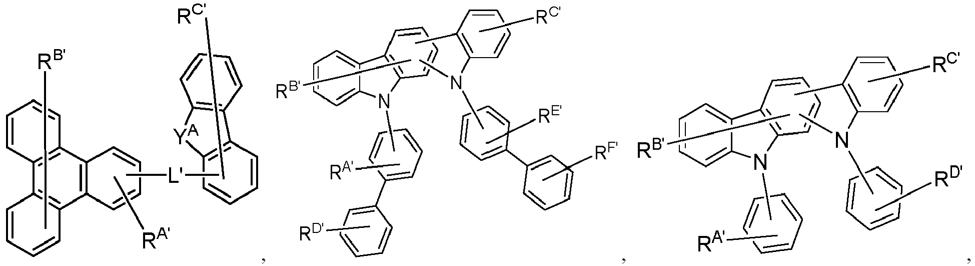 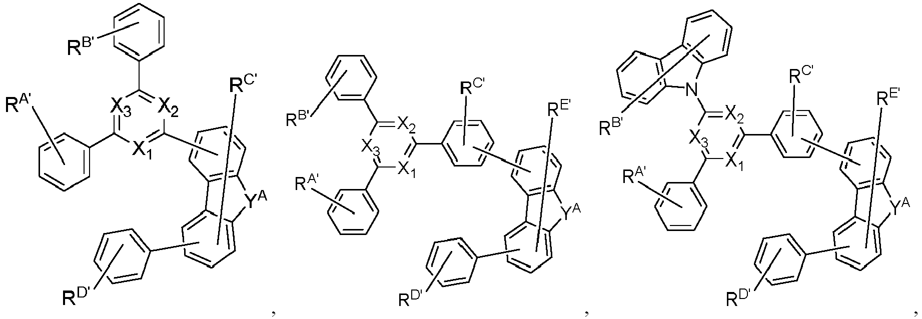 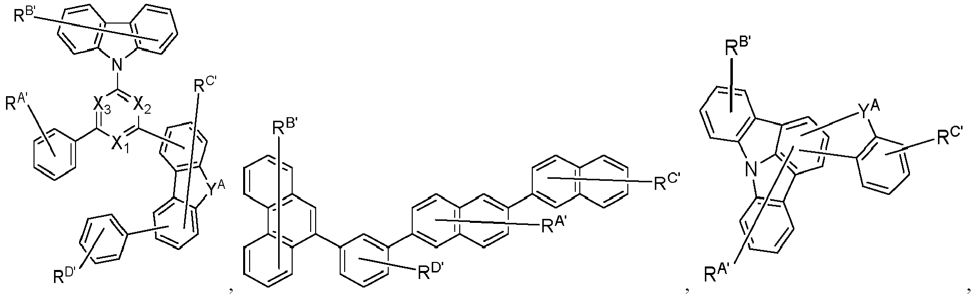 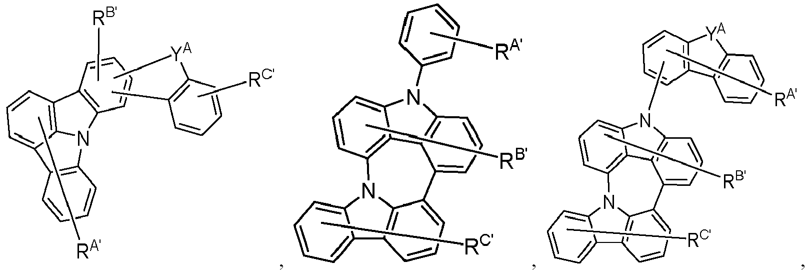 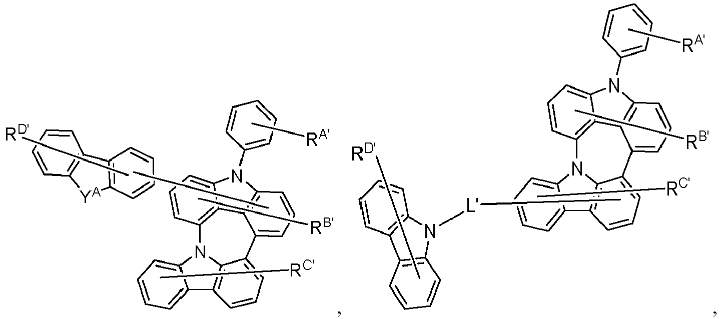 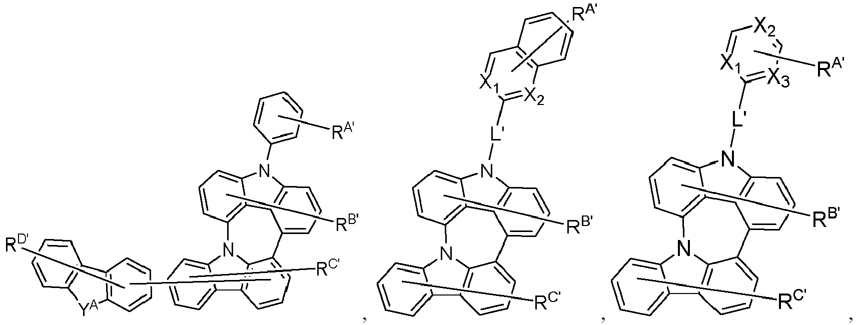 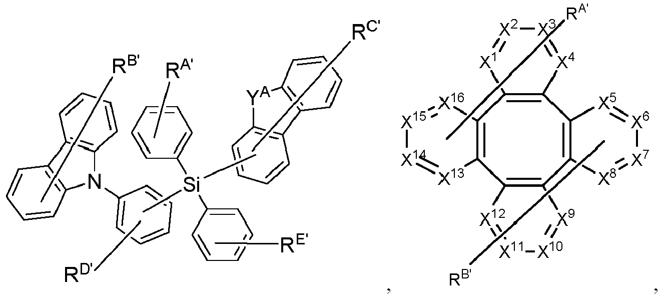 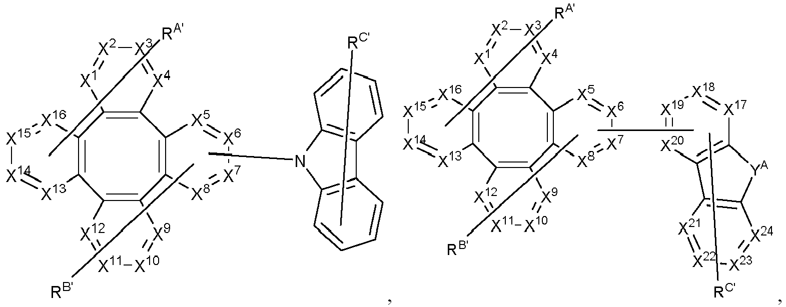 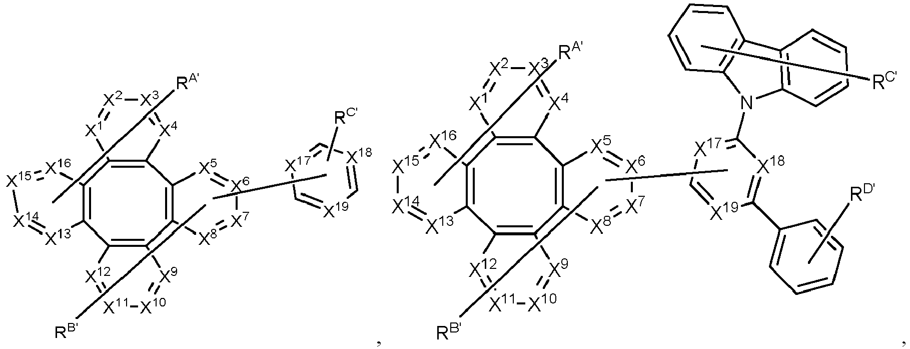 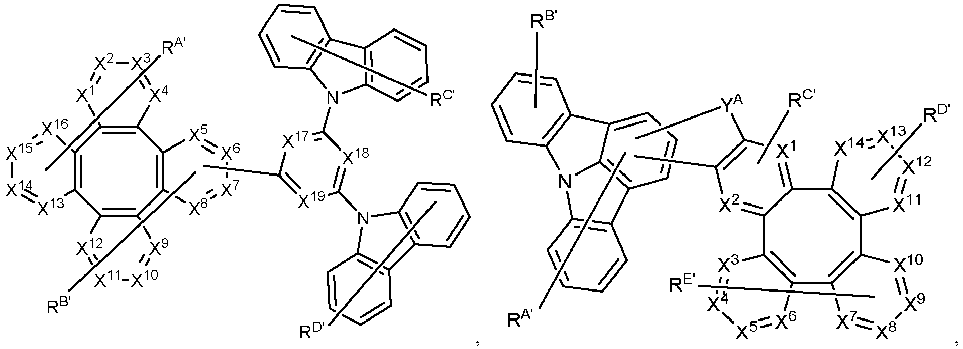 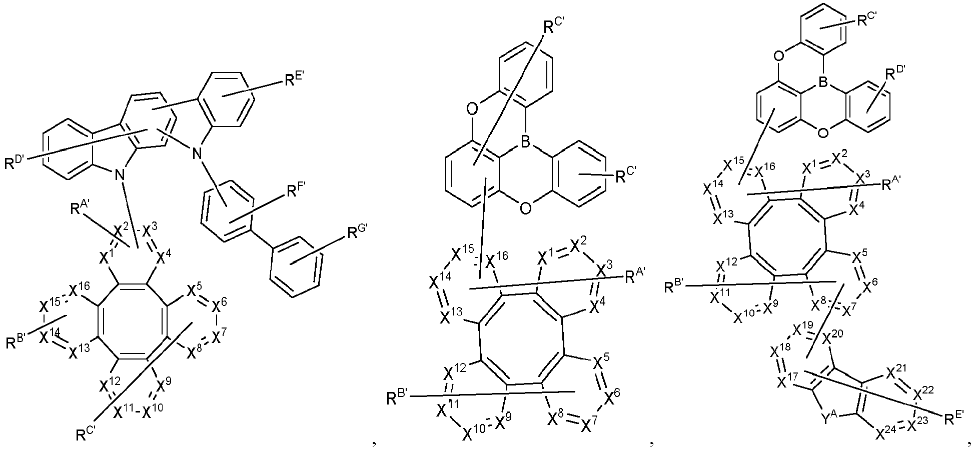 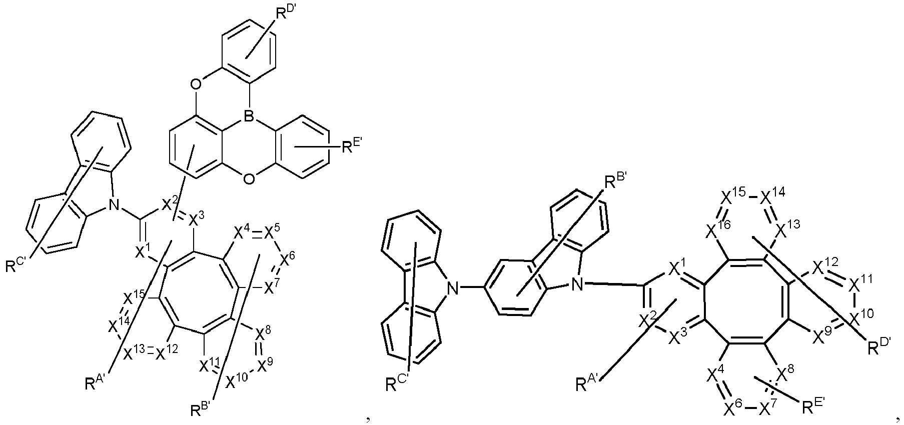 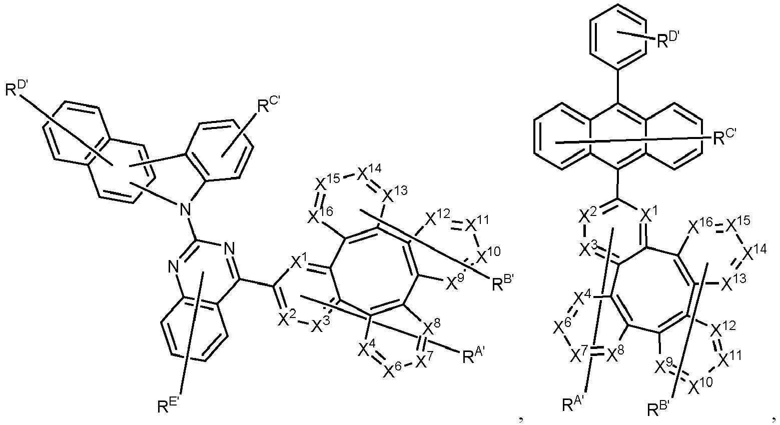 and 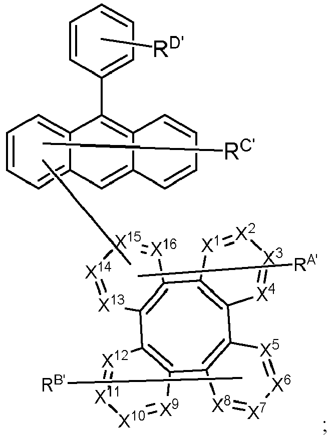 wherein:
each of X¹ to X²⁴ is independently C or N;
L' is a direct bond or an organic linker;
each Y^{A} is independently selected from the group consisting of absent a bond, O, S, Se, CRR', SiRR', GeRR', NR, BR, BRR';
each of R^{A'}, R^{B'}, R^{C'}, R^{D'}, R^{E'}, R^{F'}, and R^{G'} independently represents mono, up to the maximum substitutions, or no substitutions;
each R, R', R^{A'}, R^{B'}, R^{C'}, R^{D'}, R^{E'}, R^{F'}, and R^{G'} is independently a hydrogen or a substituent selected from the group consisting of deuterium, halogen, alkyl, cycloalkyl, heteroalkyl, heterocycloalkyl, arylalkyl, alkoxy, aryloxy, amino, silyl, germyl, selenyl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, boryl, and combinations thereof; and
two adjacent of R^{A'}, R^{B'}, R^{C'}, R^{D'}, R^{E'}, R^{F'}, and R^{G'} are optionally joined or fused to form a ring.
20. A consumer product comprising an organic light-emitting device comprising:
an anode;
a cathode; and
an organic layer disposed between the anode and the cathode, wherein the organic layer comprises a compound according to any one of the preceeding claims.

## Claims

1. A compound of Ir(L_{A})ₚ(L_{B})_{q}(L_{C})ᵣ, wherein:
the first ligand L_{A} has a structure of Formula I, 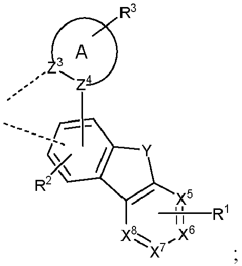
ligand L_{B} has a structure of Formula II, 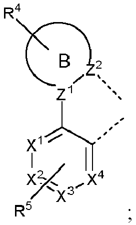
ligand Lc is a bidentate ligand;
p is 1 or 2; q is 0, 1, or 2; r is 0, 1, or 2;
p+q+r = 3;
moieties A and B are each independently a monocyclic ring or a polycyclic fused ring system, where the monocyclic ring and each ring of the polycyclic fused ring system are independently a 5-membered or 6-membered carbocyclic or heterocyclic ring;
each of X¹ to X⁸ and Z¹ to Z⁴ is independently C or N;
Y is selected from the group consisting of BR, BRR', NR, PR, P(O)R, O, S, Se, C=O, C=S, C=Se, C=NR', C=CR'R", S=O, SO₂, CR, CRR', SiRR', and GeRR';
each of R¹, R², R³, R⁴, and R⁵ independently represents mono to the maximum allowable substitution, or no substitutions;
each R, R', R¹, R², R³, R⁴, and R⁵ is independently hydrogen or a substituent selected from the group consisting of deuterium, halide, alkyl, cycloalkyl, heteroalkyl, arylalkyl, alkoxy, aryloxy, amino, silyl, boryl, alkenyl, cycloalkenyl, heteroalkenyl, alkynyl, aryl, heteroaryl, acyl, carbonyl, carboxylic acid, ether, ester, nitrile, isonitrile, sulfanyl, sulfinyl, sulfonyl, phosphino, selenyl, germyl, and combinations thereof;
any two R, R', R¹, R², R³, R⁴, or R⁵ may be joined or fused to form a ring, or to form a tetradentate or hexadentate ligand;
at least one R¹, R², R³, R⁴, or R⁵ comprises at least one germyl group; and
at least one R¹ comprises a cyano group, with the proviso that:
(1) if both ring A and ring B are unfused pyridine rings and at least one of R⁴ and R⁵ is a germyl group, then (a) at least one of X⁵ to X⁸ is N or (b) Y is not O; and
(2) if X⁵ is C, then R¹ bonded to X⁵ is selected from the group consisting of hydrogen, deuterium, cycloalkyl, methyl, phenyl, silyl, germyl, and combinations thereof.

2. The compound of claim 1, wherein one of Z¹ or Z² is N and the other is C; and/or
wherein one of Z³ or Z⁴ is N and the other is C; and/or
wherein each of X¹ to X⁸ is C or at least one of X¹ to X⁸ is N.

3. The compound of any one of the preceeding claims, wherein each of moiety A and moiety B is independently selected from the group consisting of benzene, pyridine, pyrimidine, pyridazine, pyrazine, triazine, imidazole, pyrazole, pyrrole, oxazole, furan, thiophene, thiazole, triazole, naphthalene, quinoline, isoquinoline, quinazoline, benzofuran, azabenzofuran, benzoxazole, aza-benzoxazole, benzothiophene, aza-benzothiophene, benzothiazole, aza-benzothiazole, benzoselenophene, aza-benzoselenophene, indene, aza-indene, indole, aza-indole, benzimidazole, aza-benzimidazole, carbazole, aza-carbazole, dibenzofuran, aza-dibenzofuran, dibenzothiophene, aza-dibenzothiophene, quinoxaline, phthalazine, phenanthrene, aza-phenanathrene, anthracene, aza-antracene, phenanthridine, fluorene, and aza-fluorene; and/or
wherein two R¹, two R², or two R⁵ are joined or fused to form a ring; and/or
wherein at least one R³ comprises at least two aryl or heteroaryl moieties that are not fused together.

4. The compound of any one of the preceeding claims, wherein at least one R¹, R², or R³ comprises at least one germyl group; and/or wherein at least one R⁴ or R⁵ is a germyl group.

5. The compound of any one of the preceeding claims, wherein Z³ is N, moiety A is an unfused pyridine, and the R³ para to the N-Ir bond comprises at least one germyl group; and/or wherein Z² is N, moiety B is an unfused pyridine, and the R⁴ para to Z¹ or Z² comprises at least one germyl group.

6. The compound of any one of the preceeding claims, wherein X⁵ is C, and R¹ bonded to X⁵ is selected from the group consisting of hydrogen, deuterium, methyl, phenyl, silyl, germyl, and combinations thereof; and/or
wherein the R¹ bonded to X⁶ or X⁷ comprises cyano.

7. The compound of any one of the preceeding claims, wherein the ligand L_{A} is selected from the group consisting of: 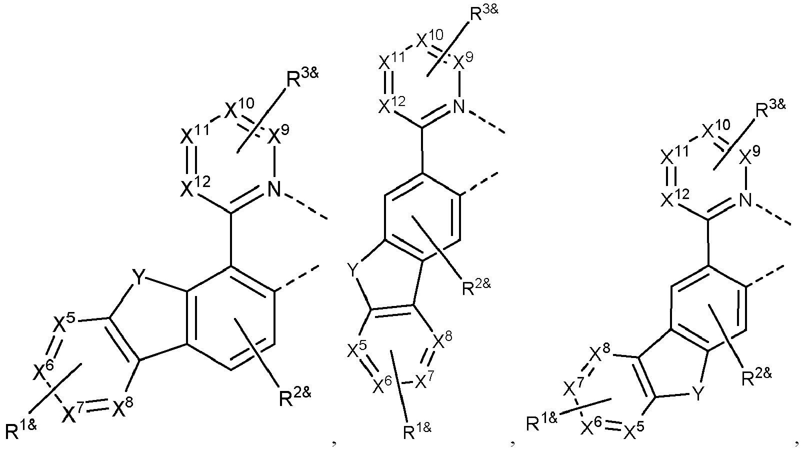 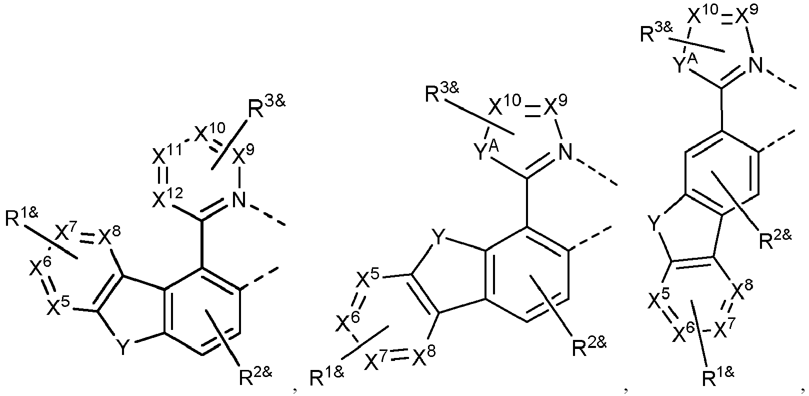 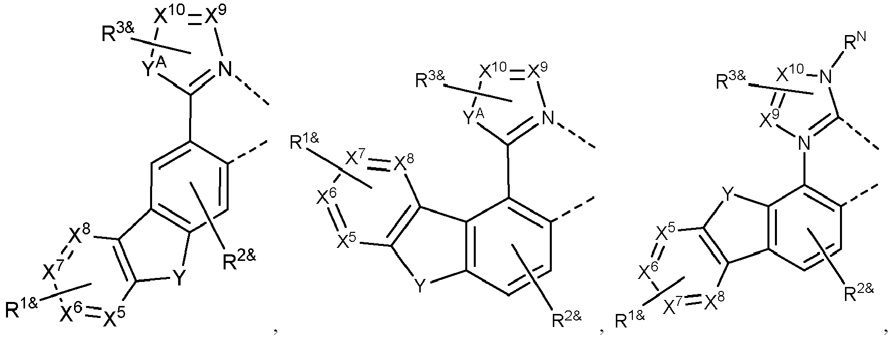 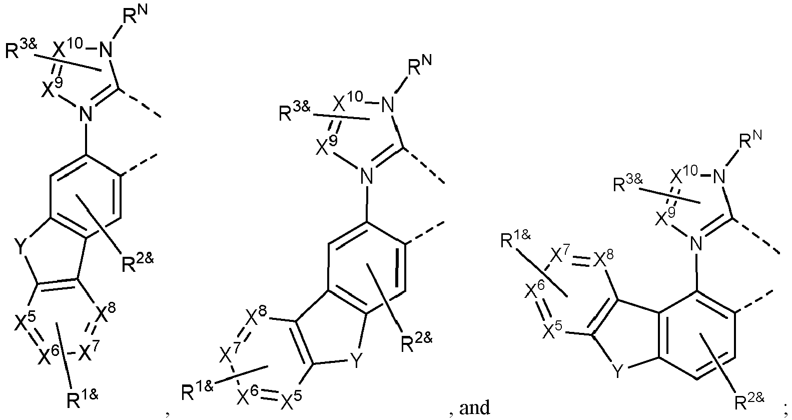 wherein:
each of X⁹ to X¹² is independently C or N;
Y^{A} is selected from the group consisting of BR, BRR', NR, PR, P(O)R, O, S, Se, C=O, C=S, C=Se, C=NR', C=CR'R", S=O, SO₂, CR, CRR', SiRR', and GeRR';
each R, R', R", and R^{N} is independently hydrogen or a substituent selected from the group consisting of deuterium, halide, alkyl, cycloalkyl, heteroalkyl, arylalkyl, alkoxy, aryloxy, amino, silyl, boryl, alkenyl, cycloalkenyl, heteroalkenyl, alkynyl, aryl, heteroaryl, acyl, carbonyl, carboxylic acid, ether, ester, nitrile, isonitrile, sulfanyl, sulfinyl, sulfonyl, phosphino, selenyl, germyl, and combinations thereof; and
any two substituents can be fused or joined to form a ring.

8. The compound of any one of the preceeding claims, wherein the ligand L_{A} is selected from the group consisting of: 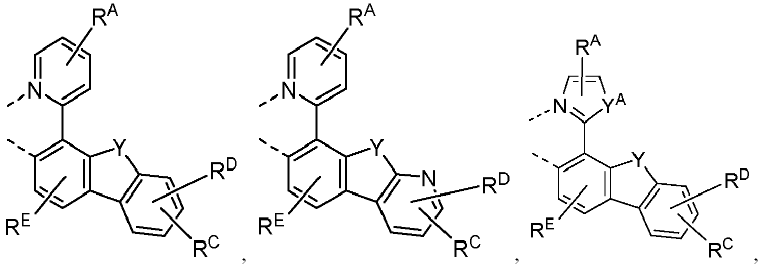 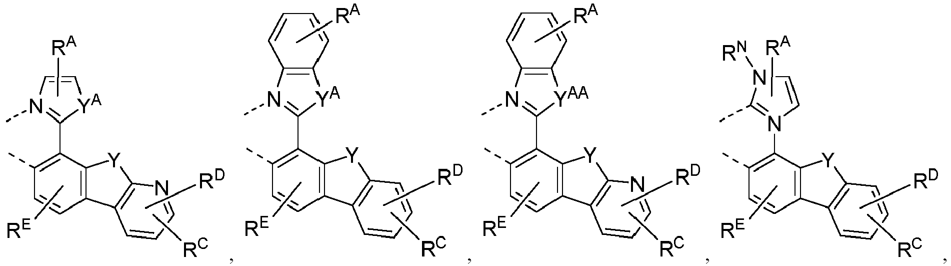 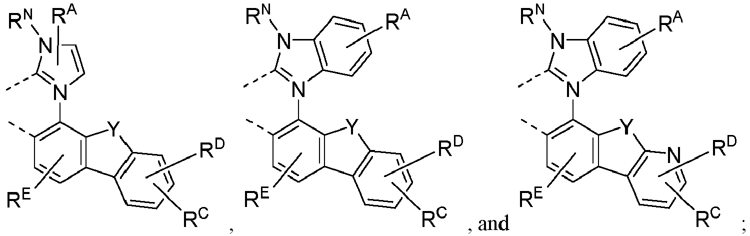 wherein
R^{D} is a monosubstitution selected from the group consisting of cyano group, cyano-containing aryl, and cyano-containing heteroaryl;
each of R^{A}, R^{C}, and R^{E} independently represents mono to the maximum allowable substitution, or no substitutions;
each R^{A}, R^{C}, and R^{E} is independently hydrogen or a substituent selected from the group consisting of deuterium, halide, alkyl, cycloalkyl, heteroalkyl, arylalkyl, alkoxy, aryloxy, amino, silyl, boryl, alkenyl, cycloalkenyl, heteroalkenyl, alkynyl, aryl, heteroaryl, acyl, carbonyl, carboxylic acid, ether, ester, nitrile, isonitrile, sulfanyl, sulfinyl, sulfonyl, phosphino, selenyl, germyl, and combinations thereof; and
any two substituents can be fused or joined to form a ring.

9. The compound of any one of the preceeding claims, wherein the ligand L_{A} is selected from the group consisting of L_{Ai}(E^{A})(R*^{K}*)(R*^{L}*)(R*^{M}*), L_{A'm}(E^{A})(R*^{K}*)(R*^{L}*)(R*^{M}*), L_{AAn}(E^{A})(R*^{K}*)(R*^{L}*)(R*^{M}*), and L_{AA'o}(E^{A})(R*^{K}*)(R*^{L}*)(R*^{M}*), wherein i and m are each independently an integer from 1 to 56, n and o are each independently an integer from 1 to 14;
wherein, when L_{A} is selected from the group consisting of L_{Ai}(E^{A})(R*^{K}*)(R*^{L}*)(R*^{M}*), i is an integer from 1 to 56; E^{A} is selected from the group consisting of E1 to E40; each of R^{K} and R^{L} is independently selected from the group consisting of R1 to R110; when i is 1, 2, 17, 45-48, or 51-56, R^{M} is selected from the group consisting of R51 to R110; when i is 3-16, 18-44, or 49-50, R^{M} is selected from the group consisting of R1 to R110; and wherein each of L_{A1}(E1)(R1)(R1)(R51) to L_{A56}(E40)(R110)(R110)(R110) has a structure defined as follows:
| L_{A} | Structure of L_{A} | L_{A} | Structure of L_{A} |
|---|---|---|---|
| L_{A1}(E^{A})(R*^{K}*)(R*^{L}*)(R*^{M}*), wherein L_{A1}(E1)(R1)(R1)(R51) to L_{A1}(E40)(R110)(R110)(R 110) have the structure | 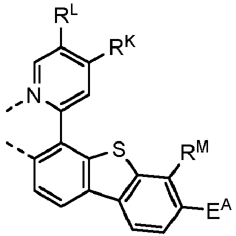 | L_{A2}(E^{A})(R*^{K}*)(R*^{L}*)(R*^{M}*), wherein L_{A2}(E1)(R1)(R1)(R51) to L_{A2}(E40)(R110)(R110)(R 110) have the structure | 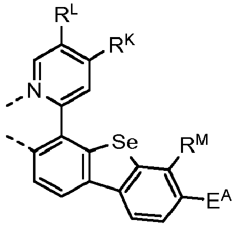 |
| L_{A3}(E^{A})(R*^{K}*)(R*^{L}*)(R*^{M}*), wherein L_{A3}(E1)(R1)(R1)(R1) to L_{A3}(E40)(R110)(R110)(R 110) have the structure | 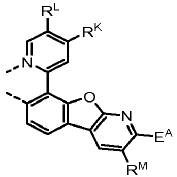 | L_{A4}(E^{A})(R*^{K}*)(R*^{L}*)(R*^{M}*), wherein L_{A4}(E1)(R1)(R1)(R1) to L_{A4}(E40)(R110)(R110)(R 110) have the structure | 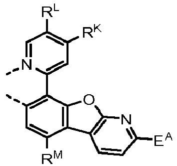 |
| L_{A5}(E^{A})(R*^{K}*)(R*^{L}*)(R*^{M}*), wherein L_{A5}(E1)(R1)(R1)(R1) to L_{A5}(E40)(R110)(R110)(R 110) have the structure | 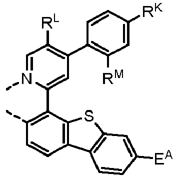 | L_{A6}(E^{A})(R*^{K}*)(R*^{L}*)(R*^{M}*), wherein L_{A6}(E1)(R1)(R1)(R1) to L_{A6}(E40)(R110)(R110)(R 110) have the structure | 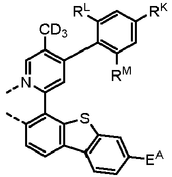 |
| L_{A7}(E^{A})(R*^{K}*)(R*^{L}*)(R*^{M}*), wherein L_{A7}(E1)(R1)(R1)(R1) to L_{A7}(E40)(R110)(R110)(R 110) have the structure | 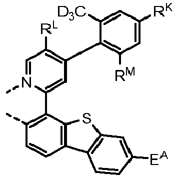 | L_{A8}(E^{A})(R*^{K}*)(R*^{L}*)(R*^{M}*), wherein L_{A8}(E1)(R1)(R1)(R1) to L_{A8}(E40)(R110)(R110)(R 110) have the structure | 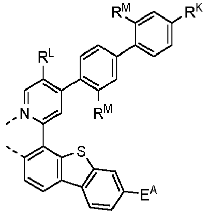 |
| L_{A9}(E^{A})(R*^{K}*)(R*^{L}*)(R*^{M}*), wherein L_{A9}(E1)(R1)(R1)(R1) to L_{A9}(E40)(R110)(R110)(R 110) have the structure | 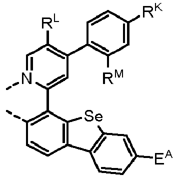 | L_{A10}(E^{A})(R*^{K}*)(R*^{L}*)(R*^{M}*), wherein L_{A10}(E1)(R1)(R1)(R1) to L_{A10}(E40)(R110)(R110)( R110) have the structure | 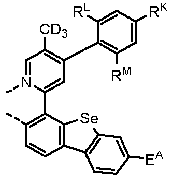 |
| L_{A11}(E^{A})(R*^{K}*)(R*^{L}*)(R*^{M}*), wherein L_{A11}(E1)(R1)(R1)(R1) to L_{A11}(E40)(R110)(R110)( R110) have the structure | 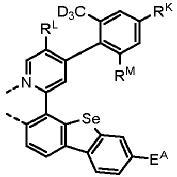 | L_{A12}(E^{A})(R*^{K}*)(R*^{L}*)(R*^{M}*), wherein L_{A12}(E1)(R1)(R1)(R1) to L_{A12}(E40)(R110)(R110)( R110) have the structure | 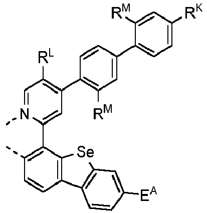 |
| L_{A13}(E^{A})(R*^{K}*)(R*^{L}*)(R*^{M}*), wherein L_{A13}(E1)(R1)(R1)(R1) to L_{A13}(E40)(R110)(R110)( R110) have the structure | 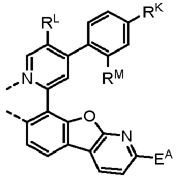 | L_{A14}(E^{A})(R*^{K}*)(R*^{L}*)(R*^{M}*), wherein L_{A14}(E1)(R1)(R1)(R1) to L_{A14}(E40)(R110)(R110)( R110) have the structure | 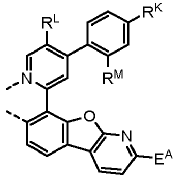 |
| L_{A15}(E^{A})(R*^{K}*)(R*^{L}*)(R*^{M}*), wherein L_{A15}(E1)(R1)(R1)(R1) to L_{A15}(E40)(R110)(R110)( R110) have the structure | 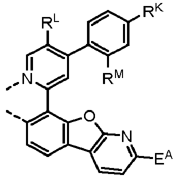 | L_{A16}(E^{A})(R*^{K}*)(R*^{L}*)(R*^{M}*), wherein L_{A16}(E1)(R1)(R1)(R1) to L_{A16}(E40)(R110)(R110)( R110) have the structure | 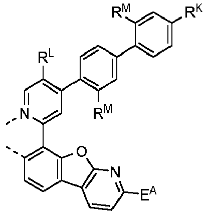 |
| L_{A17}(E^{A})(R*^{K}*)(R*^{L}*)(R*^{M}*), wherein L_{A17}(E1)(R1)(R1)(R51) to L_{A17}(E40)(R110)(R110)( R110) have the structure | 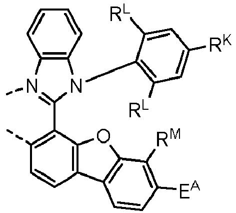 | L_{A18}(E^{A})(R*^{K}*)(R*^{L}*)(R*^{M}*), wherein L_{A18}(E1)(R1)(R1)(R1) to L_{A18}(E40)(R110)(R110)( R110) have the structure | 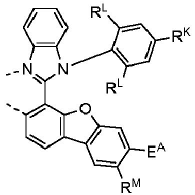 |
| L_{A19}(E^{A})(R*^{K}*)(R*^{L}*)(R*^{M}*), wherein L_{A19}(E1)(R1)(R1)(R1) to L_{A19}(E40)(R110)(R110)( R110) have the structure | 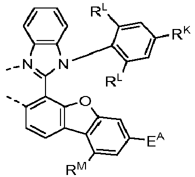 | L_{A20}(E^{A})(R*^{K}*)(R*^{L}*)(R*^{M}*), wherein L_{A20}(E1)(R1)(R1)(R1) to L_{A20}(E40)(R110)(R110)( R110) have the structure | 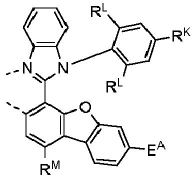 |
| L_{A21}(E^{A})(R*^{K}*)(R*^{L}*)(R*^{M}*), wherein L_{A21}(E1)(R1)(R1)(R1) to L_{A21}(E40)(R110)(R110)( R110) have the structure | 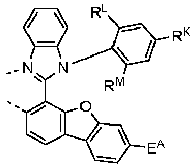 | L_{A22}(E^{A})(R*^{K}*)(R*^{L}*)(R*^{M}*), wherein L_{A22}(E1)(R1)(R1)(R1) to L_{A22}(E40)(R110)(R110)( R110) have the structure | 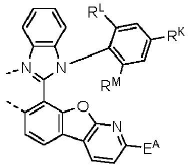 |
| L_{A23}(E^{A})(R*^{K}*)(R*^{L}*)(R*^{M}*), wherein L_{A23}(E1)(R1)(R1)(R1) to L_{A23}(E40)(R110)(R110)( R110) have the structure | 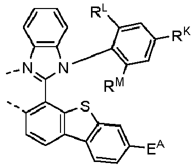 | L_{A24}(E^{A})(R*^{K}*)(R*^{L}*)(R*^{M}*), wherein L_{A24}(E1)(R1)(R1)(R1) to L_{A24}(E40)(R110)(R110)( R110) have the structure | 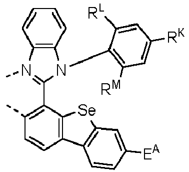 |
| L_{A25}(E^{A})(R*^{K}*)(R*^{L}*)(R*^{M}*), wherein L_{A25}(E1)(R1)(R1)(R1) to L_{A25}(E40)(R110)(R110)( R110) have the structure | 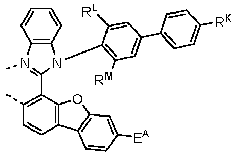 | L_{A26}(E^{A})(R*^{K}*)(R*^{L}*)(R*^{M}*), wherein L_{A26}(E1)(R1)(R1)(R1) to L_{A26}(E40)(R110)(R110)( R110) have the structure | 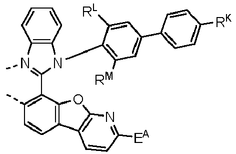 |
| L_{A27}(E^{A})(R*^{K}*)(R*^{L}*)(R*^{M}*), wherein L_{A27}(E1)(R1)(R1)(R1) to L_{A27}(E40)(R110)(R110)( R110) have the structure | 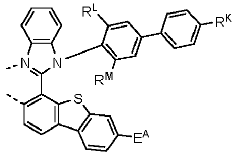 | L_{A28}(E^{A})(R*^{K}*)(R*^{L}*)(R*^{M}*), wherein L_{A28}(E1)(R1)(R1)(R1) to L_{A28}(E40)(R110)(R110)( R110) have the structure | 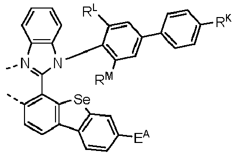 |
| L_{A29}(E^{A})(R*^{K}*)(R*^{L}*)(R*^{M}*), wherein L_{A29}(E1)(R1)(R1)(R1) to L_{A29}(E40)(R110)(R110)( R110) have the structure | 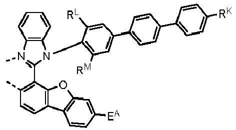 | L_{A30}(E^{A})(R*^{K}*)(R*^{L}*)(R*^{M}*), wherein L_{A30}(E1)(R1)(R1)(R1) to L_{A30}(E40)(R110)(R110)( R110) have the structure | 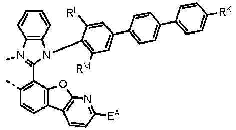 |
| L_{A31}(E^{A})(R*^{K}*)(R*^{L}*)(R*^{M}*), wherein L_{A31}(E1)(R1)(R1)(R1) to L_{A31}(E40)(R110)(R110)( R110) have the structure | 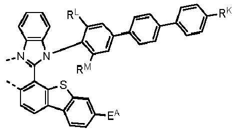 | L_{A32}(E^{A})(R*^{K}*)(R*^{L}*)(R*^{M}*), wherein L_{A32}(E1)(R1)(R1)(R1) to L_{A32}(E40)(R110)(R110)( R110) have the structure | 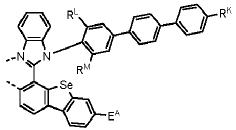 |
| L_{A33}(E^{A})(R*^{K}*)(R*^{L}*)(R*^{M}*), wherein L_{A33}(E1)(R1)(R1)(R1) to L_{A33}(E40)(R110)(R110)( R110) have the structure | 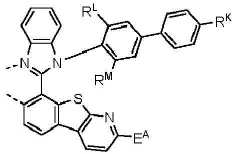 | L_{A34}(E^{A})(R*^{K}*)(R*^{L}*)(R*^{M}*), wherein L_{A34}(E1)(R1)(R1)(R1) to L_{A34}(E40)(R110)(R110)( R110) have the structure | 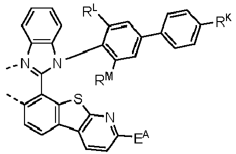 |
| L_{A35}(E^{A})(R*^{K}*)(R*^{L}*)(R*^{M}*), wherein L_{A35}(E1)(R1)(R1)(R1) to L_{A35}(E40)(R110)(R110)( R110) have the structure | 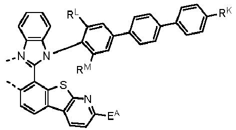 | L_{A36}(E^{A})(R*^{K}*)(R*^{L}*)(R*^{M}*), wherein L_{A36}(E1)(R1)(R1)(R1) to L_{A36}(E40)(R110)(R110)( R110) have the structure | 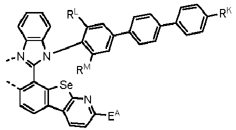 |
| L_{A37}(E^{A})(R*^{K}*)(R*^{L}*)(R*^{M}*), wherein L_{A37}(E1)(R1)(R1)(R1) to L_{A37}(E40)(R110)(R110)( R110) have the structure | 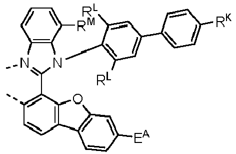 | L_{A38}(E^{A})(R*^{K}*)(R*^{L}*)(R*^{M}*), wherein L_{A38}(E1)(R1)(R1)(R1) to L_{A38}(E40)(R110)(R110)( R110) have the structure | 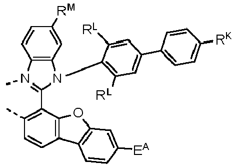 |
| L_{A39}(E^{A})(R*^{K}*)(R*^{L}*)(R*^{M}*), wherein L_{A39}(E1)(R1)(R1)(R1) to L_{A39}(E40)(R110)(R110)( R110) have the structure | 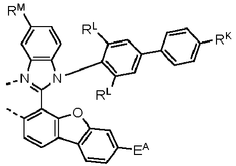 | L_{A40}(E^{A})(R*^{K}*)(R*^{L}*)(R*^{M}*), wherein L_{A40}(E1)(R1)(R1)(R1) to L_{A40}(E40)(R110)(R110)( R110) have the structure | 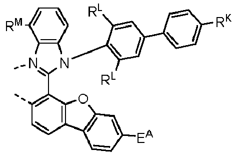 |
| L_{A41}(E^{A})(R*^{K}*)(R*^{L}*)(R*^{M}*), wherein L_{A41}(E1)(R1)(R1)(R1) to L_{A41}(E40)(R110)(R110)( R110) have the structure | 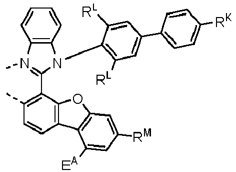 | L_{A42}(E^{A})(R*^{K}*)(R*^{L}*)(R*^{M}*), wherein L_{A42}(E1)(R1)(R1)(R1) to L_{A42}(E40)(R110)(R110)( R110) have the structure | 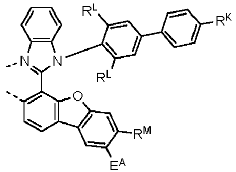 |
| L_{A43}(E^{A})(R*^{K}*)(R*^{L}*)(R*^{M}*), wherein L_{A43}(E1)(R1)(R1)(R1) to L_{A43}(E40)(R110)(R110)( R110) have the structure | 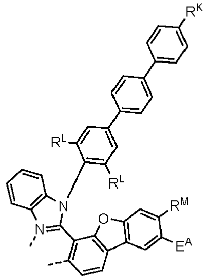 | L_{A44}(E^{A})(R*^{K}*)(R*^{L}*)(R*^{M}*), wherein L_{A44}(E1)(R1)(R1)(R1) to L_{A44}(E40)(R110)(R110)( R110) have the structure | 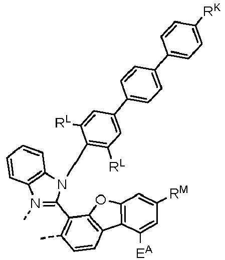 |
| L_{A45}(E^{A})(R*^{K}*)(R*^{L}*)(R*^{M}*), wherein L_{A45}(E1)(R1)(R1)(R51) to L_{A45}(E40)(R110)(R110)( R110) have the structure | 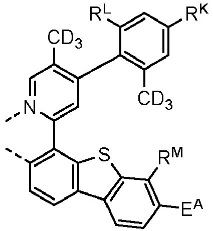 | L_{A46}(E^{A})(R*^{K}*)(R*^{L}*)(R*^{M}*), wherein L_{A46}(E1)(R1)(R1)(R51) to L_{A46}(E40)(R110)(R110)( R110) have the structure | 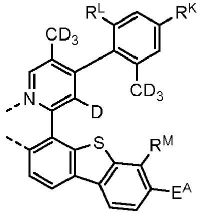 |
| L_{A47}(E^{A})(R*^{K}*)(R*^{L}*)(R*^{M}*), wherein L_{A47}(E1)(R1)(R1)(R51) to L_{A47}(E40)(R110)(R110)( R110) have the structure | 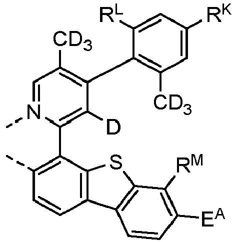 | L_{A48}(E^{A})(R*^{K}*)(R*^{L}*)(R*^{M}*), wherein L_{A48}(E1)(R1)(R1)(R51) to L_{A48}(E40)(R110)(R110)( R110) have the structure | 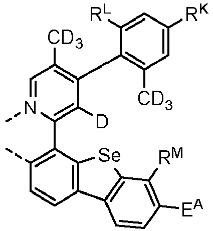 |
| L_{A49}(E^{A})(R*^{K}*)(R*^{L}*)(R*^{M}*), wherein L_{A49}(E1)(R1)(R1)(R1) to L_{A49}(E40)(R110)(R110)( R110) have the structure | 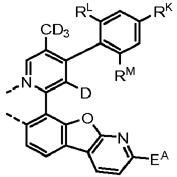 | L_{A50}(E^{A})(R*^{K}*)(R*^{L}*)(R*^{M}*), wherein L_{A50}(E1)(R1)(R1)(R1) to L_{A50}(E40)(R110)(R110)( R110) have the structure | 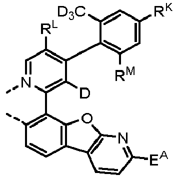 |
| L_{A51}(E^{A})(R*^{K}*)(R*^{L}*)(R*^{M}*), wherein L_{A51}(E1)(R1)(R1)(R51) to L_{A51}(E40)(R110)(R110)( R110) have the structure | 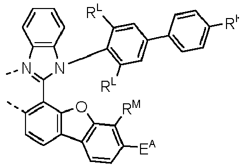 | L_{A52}(E^{A})(R*^{K}*)(R*^{L}*)(R*^{M}*), wherein L_{A52}(E1)(R1)(R1)(R51) to L_{A52}(E40)(R110)(R110)( R110) have the structure | 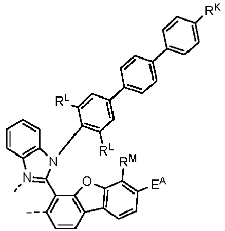 |
| L_{A53}(E^{A})(R*^{K}*)(R*^{L}*)(R*^{M}*), wherein L_{A53}(E1)(R1)(R1)(R51) to L_{A53}(E40)(R110)(R110)( R110) have the structure | 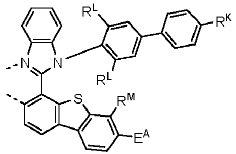 | L_{A54}(E^{A})(R*^{K}*)(R*^{L}*)(R*^{M}*), wherein L_{A54}(E1)(R1)(R1)(R51) to L_{A54}(E40)(R110)(R110)( R110) have the structure | 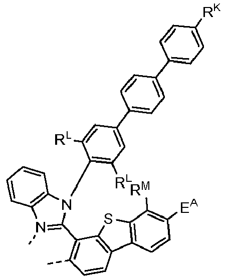 |
| L_{A55}(E^{A})(R*^{K}*)(R*^{L}*)(R*^{M}*), wherein L_{A55}(E1)(R1)(R1)(R51) to L_{A55}(E40)(R110)(R110)( R110) have the structure | 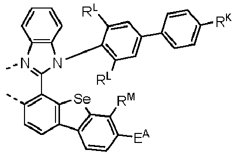 | L_{A56}(E^{A})(R*^{K}*)(R*^{L}*)(R*^{M}*), wherein L_{A56}(E1)(R1)(R1)(R51) to L_{A56}(E40)(R110)(R110)( R110) have the structure | 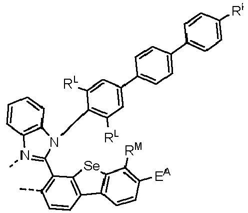 |
wherein, when L_{A} is selected from the group consisting of L_{A'm}(E^{A})(R*^{K}*)(R*^{L}*)(R*^{M}*), m is an integer from 1 to 56; E^{A} is selected from E1 to E40; R^{K} is selected from the group consisting of R71 to R110; R^{L} is independently selected from the group consisting of R1 to R110; when m is 1, 2, 17, or 45-56, R^{M} is selected from the group consisting of R51 to R110; when m is 3-16 or 18-44, R^{M} is selected from the group consisting of R1 to R110; and each of L_{A'1}(E1)(R71)(R1)(R51) to L_{A'56}(E40)(R110)(R110)(R110) has a structure defined as follows:
| L_{A'} | Structure of L_{A'} | L_{A'} | Structure of L_{A'} |
|---|---|---|---|
| L_{A'1}(E^{A})(R*^{K}*)(R*^{L}*)(R*^{M}*), wherein L_{A'1}(E1)(R71)(R1)(R51) to L_{A'1}(E40)(R110)(R110)(R 110) have the structure | 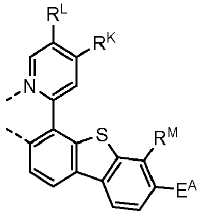 | L_{A'2}(E^{A})(R*^{K}*)(R*^{L}*)(R*^{M}*), wherein L_{A'2}(E1)(R71)(R1)(R51) to L_{A'2}(E40)(R110)(R110)(R 110) have the structure | 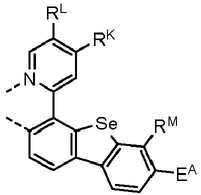 |
| L_{A'3}(E^{A})(R*^{K}*)(R*^{L}*)(R*^{M}*), wherein L_{A'3}(E1)(R71)(R1)(R1) to L_{A'3}(E40)(R110)(R110)(R 110) have the structure | 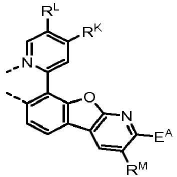 | L_{A'4}(E^{A})(R*^{K}*)(R*^{L}*)(R*^{M}*), wherein L_{A'4}(E1)(R71)(R1)(R1) to L_{A'4}(E40)(R110)(R110)(R 110) have the structure | 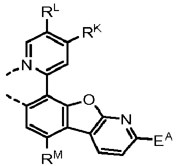 |
| L_{A'5}(E^{A})(R*^{K}*)(R*^{L}*)(R*^{M}*), wherein L_{A'5}(E1)(R71)(R1)(R1) to L_{A'5}(E40)(R110)(R110)(R 110) have the structure | 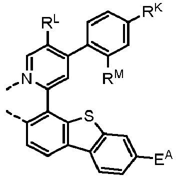 | L_{A'6}(E^{A})(R*^{K}*)(R*^{L}*)(R*^{M}*), wherein L_{A'6}(E1)(R71)(R1)(R1) to L_{A'6}(E40)(R110)(R110)(R 110) have the structure | 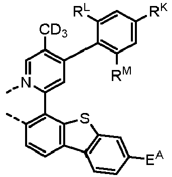 |
| L_{A'7}(E^{A})(R*^{K}*)(R*^{L}*)(R*^{M}*), wherein L_{A'7}(E1)(R71)(R1)(R1) to L_{A'7}(E40)(R110)(R110)(R 110) have the structure | 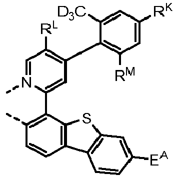 | L_{A'8}(E^{A})(R*^{K}*)(R*^{L}*)(R*^{M}*), wherein L_{A'8}(E1)(R71)(R1)(R1) to L_{A'8}(E40)(R110)(R110)(R 110) have the structure | 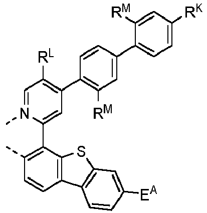 |
| L_{A'9}(E^{A})(R*^{K}*)(R*^{L}*)(R*^{M}*), wherein L_{A'9}(E1)(R71)(R1)(R1) to L_{A'9}(E40)(R110)(R110)(R 110) have the structure | 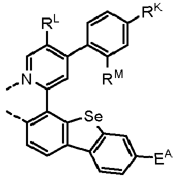 | L_{A'10}(E^{A})(R*^{K}*)(R*^{L}*)(R*^{M}*), wherein L_{A'10}(E1)(R71)(R1)(R1) to L_{A'10}(E40)(R110)(R110)( R110) have the structure | 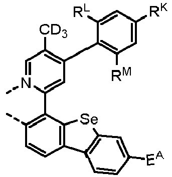 |
| L_{A'11}(E^{A})(R*^{K}*)(R*^{L}*)(R*^{M}*), wherein L_{A'11}(E1)(R71)(R1)(R1) to L_{A'11}(E40)(R110)(R110)( R110) have the structure | 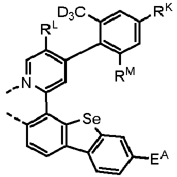 | L_{A'12}(E^{A})(R*^{K}*)(R*^{L}*)(R*^{M}*), wherein L_{A'12}(E1)(R71)(R1)(R1) to L_{A'12}(E40)(R110)(R110)( R110) have the structure | 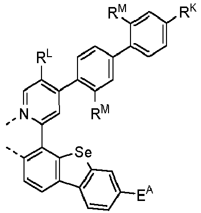 |
| L_{A'13}(E^{A})(R*^{K}*)(R*^{L}*)(R*^{M}*), wherein L_{A'13}(E1)(R71)(R1)(R1) to L_{A'13}(E40)(R110)(R110)( R110) have the structure | 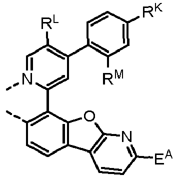 | L_{A'14}(E^{A})(R*^{K}*)(R*^{L}*)(R*^{M}*), wherein L_{A'14}(E1)(R71)(R1)(R1) to L_{A'14}(E40)(R110)(R110)( R110) have the structure | 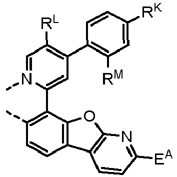 |
| L_{A'15}(E^{A})(R*^{K}*)(R*^{L}*)(R*^{M}*), wherein L_{A'15}(E1)(R71)(R1)(R1) to L_{A'15}(E40)(R110)(R110)( R110) have the structure | 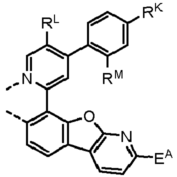 | L_{A'16}(E^{A})(R*^{K}*)(R*^{L}*)(R*^{M}*), wherein L_{A'16}(E1)(R71)(R1)(R1) to L_{A'16}(E40)(R110)(R110)( R110) have the structure | 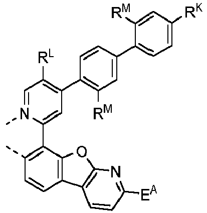 |
| L_{A'17}(E^{A})(R*^{K}*)(R*^{L}*)(R*^{M'}*), wherein L_{A'17}(E1)(R71)(R1)(R51) to L_{A'17}(E40)(R110)(R110)( R110) have the structure | 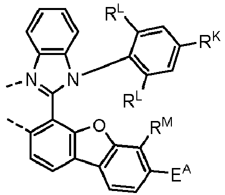 | L_{A'18}(E^{A})(R*^{K}*)(R*^{L}*)(R*^{M'}*), wherein L_{A'18}(E1)(R71)(R1)(R1) to L_{A'18}(E40)(R110)(R110)( R110) have the structure | 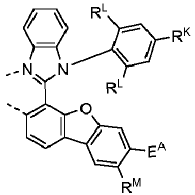 |
| L_{A'19}(E^{A})(R*^{K}*)(R*^{L}*)(R*^{M}*), wherein L_{A'19}(E1)(R71)(R1)(R1) to L_{A'19}(E40)(R110)(R110)( R110) have the structure | 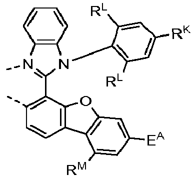 | L_{A'20}(E^{A})(R*^{K}*)(R*^{L}*)(R*^{M}*), wherein L_{A'20}(E1)(R71)(R1)(R1) to L_{A'20}(E40)(R110)(R110)( R110) have the structure | 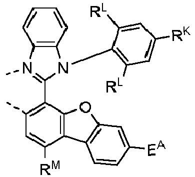 |
| L_{A'21}(E^{A})(R*^{K}*)(R*^{L}*)(R*^{M}*), wherein L_{A'21}(E1)(R71)(R1)(R1) to L_{A'21}(E40)(R110)(R110)( R110) have the structure | 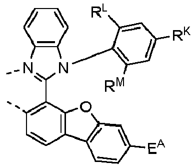 | L_{A'22}(E^{A})(R*^{K}*)(R*^{L}*)(R*^{M}*), wherein L_{A'22}(E1)(R71)(R1)(R1) to L_{A'22}(E40)(R110)(R110)( R110) have the structure | 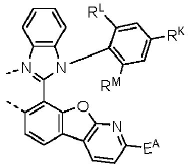 |
| L_{A'23}(E^{A})(R*^{K}*)(R*^{L}*)(R*^{M}*), wherein L_{A'23}(E1)(R71)(R1)(R1) to L_{A'23}(E40)(R110)(R110)( R110) have the structure | 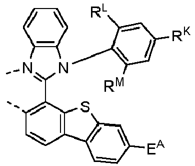 | L_{A'24}(E^{A})(R*^{K}*)(R*^{L}*)(R*^{M}*), wherein L_{A'24}(E1)(R71)(R1)(R1) to L_{A'24}(E40)(R110)(R110)( R110) have the structure | 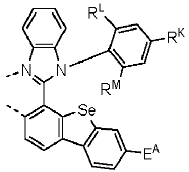 |
| L_{A'25}(E^{A})(R*^{K}*)(R*^{L}*)(R*^{M}*), wherein L_{A'25}(E1)(R71)(R1)(R1) to L_{A'25}(E40)(R110)(R110)( R110) have the structure | 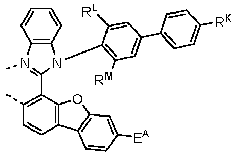 | L_{A'26}(E^{A})(R*^{K}*)(R*^{L}*)(R*^{M}*), wherein L_{A'26}(E1)(R71)(R1)(R1) to L_{A'26}(E40)(R110)(R110)( R110) have the structure | 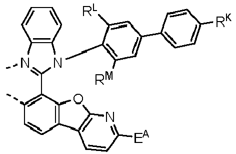 |
| L_{A'27}(E^{A})(R*^{K}*)(R*^{L}*)(R*^{M}*), wherein L_{A'27}(E1)(R71)(R1)(R1) to L_{A'27}(E40)(R110)(R110)( R110) have the structure | 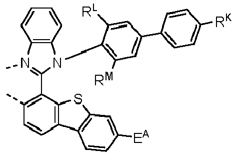 | L_{A'28}(E^{A})(R*^{K}*)(R*^{L}*)(R*^{M}*), wherein L_{A'28}(E1)(R71)(R1)(R1) to L_{A'28}(E40)(R110)(R110)( R110) have the structure | 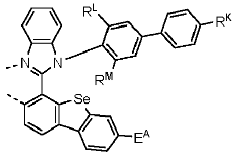 |
| L_{A'29}(E^{A})(R*^{K}*)(R*^{L}*)(R*^{M}*), wherein L_{A'29}(E1)(R71)(R1)(R1) to L_{A'29}(E40)(R110)(R110)( R110) have the structure | 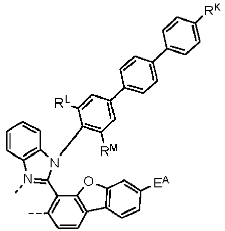 | L_{A'30}(E^{A})(R*^{K}*)(R*^{L}*)(R*^{M}*), wherein L_{A'30}(E1)(R71)(R1)(R1) to L_{A'30}(E40)(R110)(R110)( R110) have the structure | 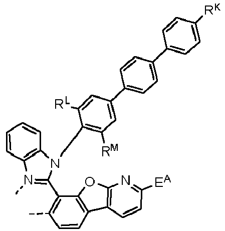 |
| L_{A'31}(E^{A})(R*^{K}*)(R*^{L}*)(R*^{M}*), wherein L_{A'31}(E1)(R71)(R1)(R1) to L_{A'31}(E40)(R110)(R110)( R110) have the structure | 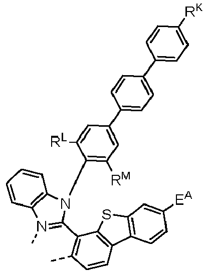 | L_{A'32}(E^{A})(R*^{K}*)(R*^{L}*)(R*^{M}*), wherein L_{A'32}(E1)(R71)(R1)(R1) to L_{A'32}(E40)(R110)(R110)( R110) have the structure | 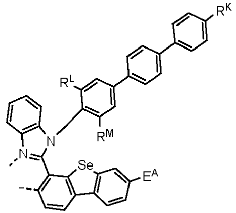 |
| L_{A'33}(E^{A})(R*^{K}*)(R*^{L}*)(R*^{M}*), wherein L_{A'33}(E1)(R71)(R1)(R1) to L_{A'33}(E40)(R110)(R110)( R110) have the structure | 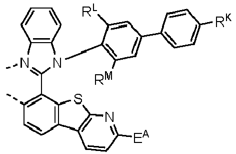 | L_{A'34}(E^{A})(R*^{K}*)(R*^{L}*)(R*^{M}*), wherein L_{A'34}(E1)(R71)(R1)(R1) to L_{A'34}(E40)(R110)(R110)( R110) have the structure | 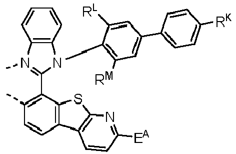 |
| L_{A'35}(E^{A})(R*^{K}*)(R*^{L}*)(R*^{M}*), wherein L_{A'35}(E1)(R71)(R1)(R1) to L_{A'35}(E40)(R110)(R110)( R110) have the structure | 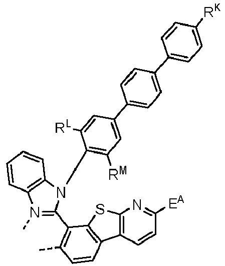 | L_{A'36}(E^{A})(R*^{K}*)(R*^{L}*)(R*^{M}*), wherein L_{A'36}(E1)(R71)(R1)(R1) to L_{A'36}(E40)(R110)(R110)( R110) have the structure | 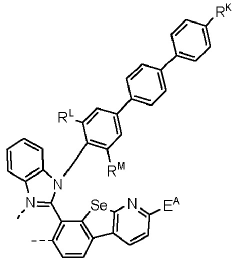 |
| L_{A'37}(E^{A})(R*^{K}*)(R*^{L}*)(R*^{M}*), wherein L_{A'37}(E1)(R71)(R1)(R1) to L_{A'37}(E40)(R110)(R110)( R110) have the structure | 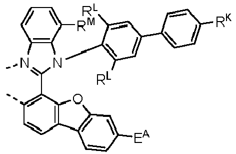 | L_{A'38}(E^{A})(R*^{K}*)(R*^{L}*)(R*^{M}*), wherein L_{A'38}(E1)(R71)(R1)(R1) to L_{A'38}(E40)(R110)(R110)( R110) have the structure | 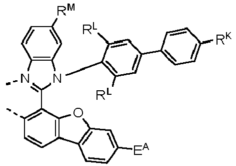 |
| L_{A'39}(E^{A})(R*^{K}*)(R*^{L}*)(R*^{M}*), wherein L_{A'39}(E1)(R71)(R1)(R1) to L_{A'39}(E40)(R110)(R110)( R110) have the structure | 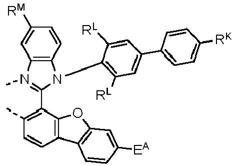 | L_{A'40}(E^{A})(R*^{K}*)(R*^{L}*)(R*^{M}*), wherein L_{A'40}(E1)(R71)(R1)(R1) to L_{A'40}(E40)(R110)(R110)( R110) have the structure | 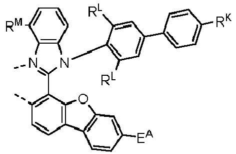 |
| L_{A'41}(E^{A})(R*^{K}*)(R*^{L}*)(R*^{M}*), wherein L_{A'41}(E1)(R71)(R1)(R1) to L_{A'41}(E40)(R110)(R110)( R110) have the structure | 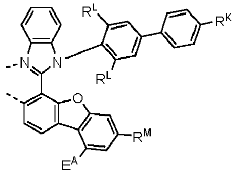 | L_{A'42}(E^{A})(R*^{K}*)(R*^{L}*)(R*^{M}*), wherein L_{A'42}(E1)(R71)(R1)(R1) to L_{A'42}(E40)(R110)(R110)( R110) have the structure | 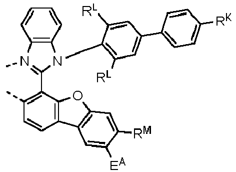 |
| L_{A'43}(E^{A})(R*^{K}*)(R*^{L}*)(R*^{M}*), wherein L_{A'43}(E1)(R71)(R1)(R1) to L_{A'43}(E40)(R110)(R110)( R110) have the structure | 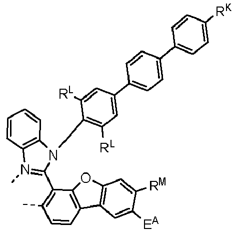 | L_{A'44}(E^{A})(R*^{K}*)(R*^{L}*)(R*^{M}*), wherein L_{A'44}(E1)(R71)(R1)(R1) to L_{A'44}(E40)(R110)(R110)( R110) have the structure | 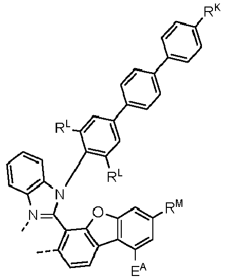 |
| L_{A'45}(E^{A})(R*^{K}*)(R*^{L}*)(R*^{M}*), wherein L_{A'45}(E1)(R71)(R1)(R51) to L_{A'45}(E40)(R110)(R110)( R110) have the structure | 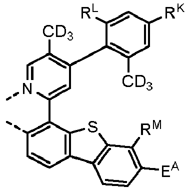 | L_{A'46}(E^{A})(R*^{K}*)(R*^{L}*)(R*^{M}*), wherein L_{A'46}(E1)(R71)(R1)(R51) to L_{A'46}(E40)(R110)(R110)( R110) have the structure | 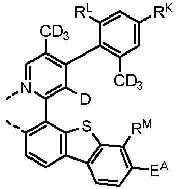 |
| L_{A'47}(E^{A})(R*^{K}*)(R*^{L}*)(R*^{M}*), wherein L_{A'47}(E1)(R71)(R1)(R51) to L_{A'47}(E40)(R110)(R110)( R110) have the structure | 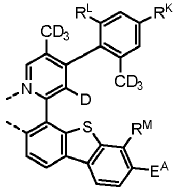 | L_{A'48}(E^{A})(R*^{K}*)(R*^{L}*)(R*^{M}*), wherein L_{A'48}(E1)(R71)(R1)(R51) to L_{A'48}(E40)(R110)(R110)( R110) have the structure | 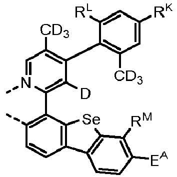 |
| L_{A'49}(E^{A})(R*^{K}*)(R*^{L}*)(R*^{M}*), wherein L_{A'49}(E1)(R71)(R1)(R51) to L_{A'49}(E40)(R110)(R110)( R110) have the structure | 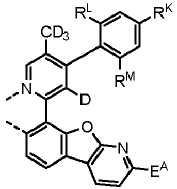 | L_{A'50}(E^{A})(R*^{K}*)(R*^{L}*)(R*^{M}*), wherein L_{A'50}(E1)(R71)(R1)(R51) to L_{A'50}(E40)(R110)(R110)( R110) have the structure | 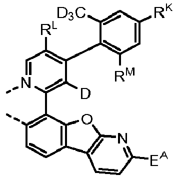 |
| L_{A'51}(E^{A})(R*^{K}*)(R*^{L}*)(R*^{M}*), wherein L_{A'51}(E1)(R71)(R1)(R51) to L_{A'51}(E40)(R110)(R110)( R110) have the structure | 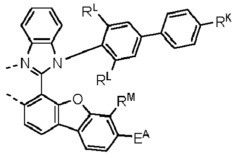 | L_{A'52}(E^{A})(R*^{K}*)(R*^{L}*)(R*^{M}*), wherein L_{A'52}(E1)(R71)(R1)(R51) to L_{A'52}(E40)(R110)(R110)( R110) have the structure | 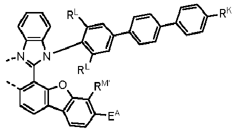 |
| L_{A'53}(E^{A})(R*^{K}*)(R*^{L}*)(R*^{M}*), wherein L_{A'53}(E1)(R71)(R1)(R51) to L_{A'53}(E40)(R110)(R110)( R110) have the structure | 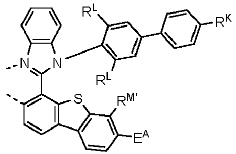 | L_{A'54}(E^{A})(R*^{K}*)(R*^{L}*)(R*^{M}*), wherein L_{A'54}(E1)(R71)(R1)(R51) to L_{A'54}(E40)(R110)(R110)( R110) have the structure | 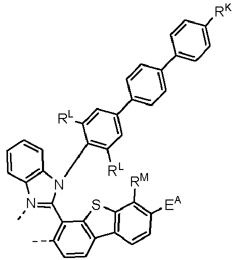 |
| L_{A'55}(E^{A})(R*^{K}*)(R*^{L}*)(R*^{M}*), wherein L_{A'55}(E1)(R71)(R1)(R51) to L_{A'55}(E40)(R110)(R110)( R110) have the structure | 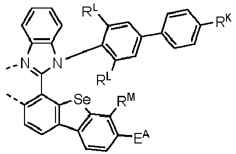 | L_{A'56}(E^{A})(R*^{K}*)(R*^{L}*)(R*^{M}*), wherein L_{A'56}(E1)(R71)(R1)(R51) to L_{A'56}(E40)(R110)(R110)( R110) have the structure | 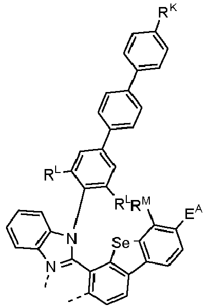 |
wherein, when L_{A} is selected from the group consisting of L_{AAn}(E^{A})(R*^{K}*)(R*^{L}*)(R*^{M}*), n is an integer from 1 to 14, E^{A} is selected from E1 to E40; R^{K} is selected from the group consisting of R1 to R110; when n is 1, R^{L} is selected from the group consising of 51 to 110; when n is 2-14, R^{L} is selected from the group consising of 51 to 110; when n is 1 to 10, R^{M} is selected from the group consising of 1 to 110; when n is 11 to 14, R^{M} is selected from the group consising of 51 to 110; and each of L_{AA1}(E1)(R71)(R51)(R1) to L_{AA14}(E40)(R110)(R110)(R110) has a structure defined as follows:
| L_{AA} | Structure of L_{AA} | L_{AA} | Structure of L_{AA} |
|---|---|---|---|
| L_{AA1}(E^{A})(R*^{K}*)(R*^{L}*)(R*^{M}*), wherein L_{AA1}(E1)(R1)(R51)(R1) to L_{AA1}(E40)(R110)(R110)( R110) have the structure | 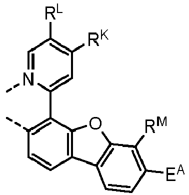 | L_{AA2}(E^{A})(R*^{K}*)(R*^{L}*)(R*^{M}*), wherein L_{AA2}(E1)(R1)(R1)(R1) to L_{AA2}(E40)(R110)(R110)( R110) have the structure | 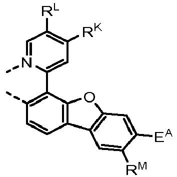 |
| L_{AA3}(E^{A})(R*^{K}*)(R*^{L}*)(R*^{M}*), wherein L_{AA3}(E1)(R1)(R1)(R1) to L_{AA3}(E40)(R110)(R110)( R110) have the structure | 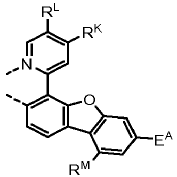 | L_{AA4}(E^{A})(R*^{K}*)(R*^{L}*)(R*^{M}*), wherein L_{AA4}(E1)(R1)(R1)(R1) to L_{AA4}(E40)(R110)(R110)( R110) have the structure | 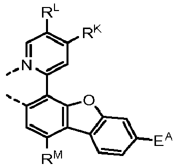 |
| L_{AA5}(E^{A})(R*^{K}*)(R*^{L}*)(R*^{M}*), wherein L_{AA5}(E1)(R1)(R1)(R1) to L_{AA5}(E40)(R110)(R110)( R110) have the structure | 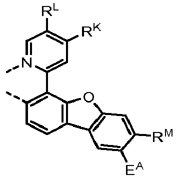 | L_{AA6}(E^{A})(R*^{K}*)(R*^{L}*)(R*^{M}*), wherein L_{AA6}(E1)(R1)(R1)(R1) to L_{AA6}(E40)(R110)(R110)( R110) have the structure | 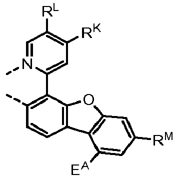 |
| L_{AA7}(E^{A})(R*^{K}*)(R*^{L}*)(R*^{M}*), wherein L_{AA7}(E1)(R1)(R1)(R1) to L_{AA7}(E40)(R110)(R110)( R110) have the structure | 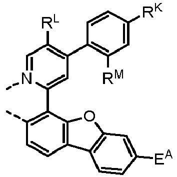 | L_{AA8}(E^{A})(R*^{K}*)(R*^{L}*)(R*^{M}*), wherein L_{AA8}(E1)(R1)(R1)(R1) to L_{AA8}(E40)(R110)(R110)( R110) have the structure | 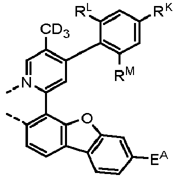 |
| L_{AA9}(E^{A})(R*^{K}*)(R*^{L}*)(R*^{M}*), wherein L_{AA9}(E1)(R1)(R1)(R1) to L_{AA9}(E40)(R110)(R110)( R110) have the structure | 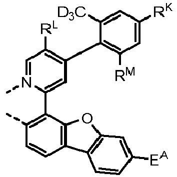 | L_{AA10}(E^{A})(R*^{K}*)(R*^{L}*)(R*^{M}*), wherein L_{AA10}(E1)(R1)(R1)(R1) to L_{AA10}(E40)(R110)(R110)( R110) have the structure | 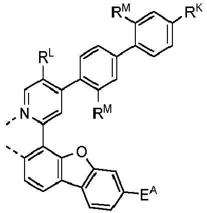 |
| L_{AA11}(E^{A})(R*^{K}*)(R*^{L}*)(R*^{M}*), wherein L_{AA11}(E1)(R1)(R1)(R51) to L_{AA11}(E40)(R110)(R110)( R110) have the structure | 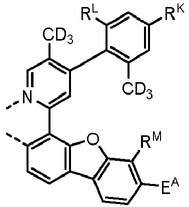 | L_{AA12}(E^{A})(R*^{K}*)(R*^{L}*)(R*^{M}*), wherein L_{AA12}(E1)(R1)(R1)(R51) to L_{AA12}(E40)(R110)(R110)( R110) have the structure | 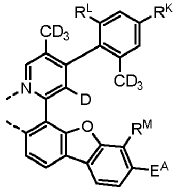 |
| L_{AA13}(E^{A})(R*^{K}*)(R*^{L}*)(R*^{M}*), wherein L_{AA13}(E1)(R1)(R1)(R51) to L_{AA13}(E40)(R110)(R110)( R110) have the structure | 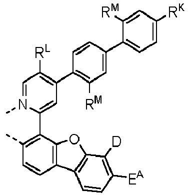 | L_{AA14}(E^{A})(R*^{K}*)(R*^{L}*)(R*^{M}*), wherein L_{AA14}(E1)(R1)(R1)(R51) to L_{AA14}(E40)(R110)(R110)( R110) have the structure | 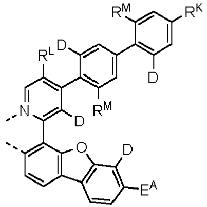 |
wherein, when L_{A} is selected from the group consisting of L_{AA'o}(E^{A})(R*^{K}*)(R*^{L}*)(R*^{M}*); o is an integer from 1 to 14; E^{A} is selected from E1 to E40; R^{K} is selected from the group consisting of R71 to R110; when o is 1, R^{L} is selected from the group consising of 51 to 110; when o is 2-14, R^{L} is selected from the group consising of 51 to 110; when o is 1 to 10, R^{M} is selected from the group consising of 1 to 90; when o is 11 to 14, R^{M} is selected from the group consising of 51 to 110; and each of L_{AA'1}(E1)(R71)(R51)(R1) to L_{AA'14}(E40)(R110)(R110)(R110) has a structure defined as follows:
| L_{AA'} | Structure of L_{AA'} | L_{AA'} | Structure of L_{AA'} |
|---|---|---|---|
| L_{AA'1}(E^{A})(R*^{K}*)(R*^{L}*)(R*^{M}*), wherein L_{AA'1}(E 1)(R7 1)(R5 1)(R1) to L_{AA'1}(E40)(R110)(R110)( R110) have the structure | 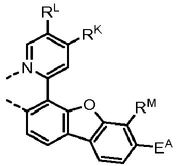 | L_{AA'2}(E^{A})(R*^{K}*)(R*^{L}*)(R*^{M}*), wherein L_{AA'2}(E1)(R71)(R1)(R1) to L_{AA'2}(E40)(R110)(R110)( R110) have the structure | 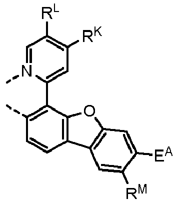 |
| L_{AA'3}(E^{A})(R*^{K}*)(R*^{L}*)(R*^{M}*), wherein L_{AA'3}(E1)(R71)(R1)(R1) to L_{AA'3}(E40)(R110)(R110)( R110) have the structure | 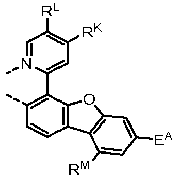 | L_{AA'4}(E^{A})(R*^{K}*)(R*^{L}*)(R*^{M}*), wherein L_{AA'4}(E1)(R71)(R1)(R1) to L_{AA'4}(E40)(R110)(R110)( R110) have the structure | 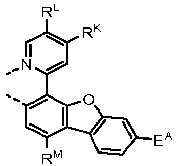 |
| L_{AA'5}(E^{A})(R*^{K}*)(R*^{L}*)(R*^{M}*), wherein L_{AA'5}(E1)(R71)(R1)(R1) to L_{AA'5}(E40)(R110)(R110)( R110) have the structure | 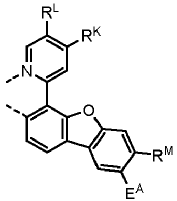 | L_{AA'6}(E^{A})(R*^{K}*)(R*^{L}*)(R*^{M}*), wherein L_{AA'6}(E1)(R71)(R1)(R1) to L_{AA'6}(E40)(R110)(R110)( R110) have the structure | 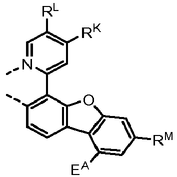 |
| L_{AA'7}(E^{A})(R*^{K}*)(R*^{L}*)(R*^{M}*), wherein L_{AA'7}(E1)(R71)(R1)(R1) to L_{AA'7}(E40)(R110)(R110)( R110) have the structure | 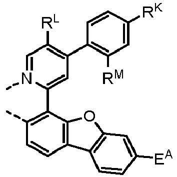 | L_{AA'8}(E^{A})(R*^{K}*)(R*^{L}*)(R*^{M}*), wherein L_{AA'8}(E1)(R71)(R1)(R1) to L_{AA'8}(E40)(R110)(R110)( R110) have the structure | 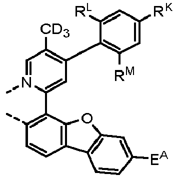 |
| L_{AA'9}(E^{A})(R*^{K}*)(R*^{L}*)(R*^{M}*), wherein L_{AA'953}(E1)(R71)(R1)(R1) to L_{AA'9}(E40)(R110)(R110)( R110) have the structure | 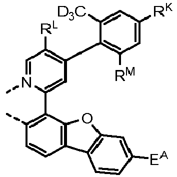 | L_{AA'10}(E^{A})(R*^{K}*)(R*^{L}*)(R*^{M}*), wherein L_{AA'10}(E1)(R71)(R1)(R1) to L_{AA'10}(E40)(R110)(R110) (R110) have the structure | 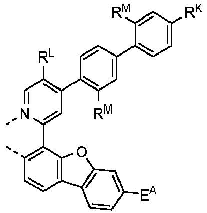 |
| L_{AA'11}(E^{A})(R*^{K}*)(R*^{L}*)(R*^{M}*), wherein L_{AA'11}(E1)(R71)(R1)(R51 ) to L_{AA'11}(E40)(R110)(R110) (R110) have the structure | 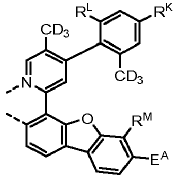 | L_{AA'12}(E^{A})(R*^{K}*)(R*^{L}*)(R*^{M}*), wherein L_{AA'12}(E1)(R71)(R1)(R51 ) to L_{AA'12}(E40)(R110)(R110) (R110) have the structure | 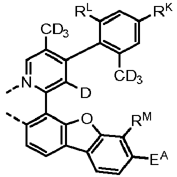 |
| L_{AA'13}(E^{A})(R*^{K}*)(R*^{L}*)(R*^{M}*), wherein L_{AA'13}(E1)(R71)(R1)(R51 ) to L_{AA'13}(E40)(R110)(R110) (R110) have the structure | 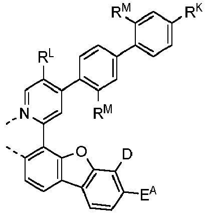 | L_{AA'14}(E^{A})(R*^{K}*)(R*^{L}*)(R*^{M}*), wherein L_{AA'14}(E1)(R71)(R1)(R51 ) to L_{AA'14}(E40)(R110)(R110) (R110) have the structure | 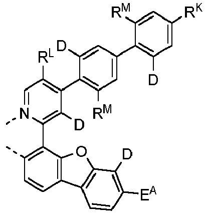 |
wherein R1 to R110 have the structures defined as follows: 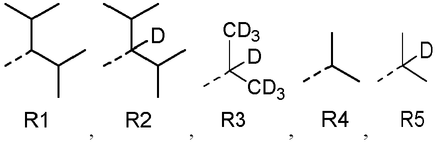 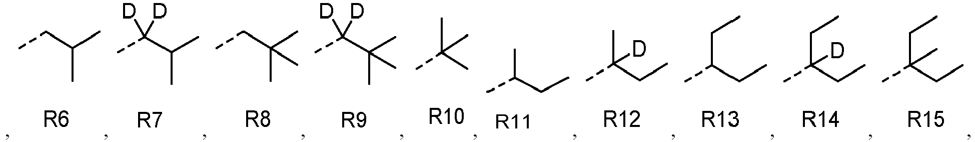 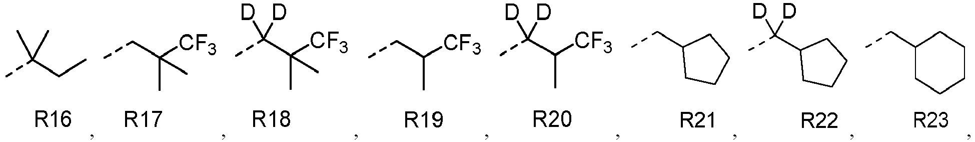 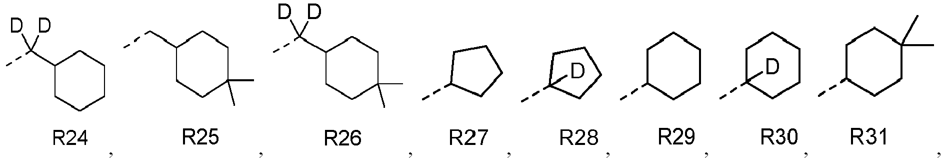 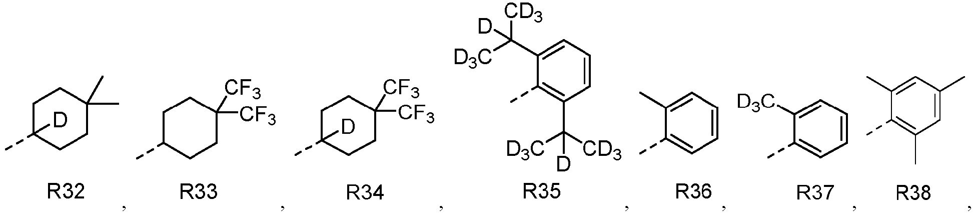 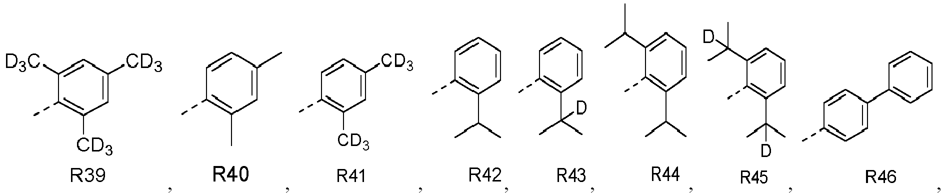 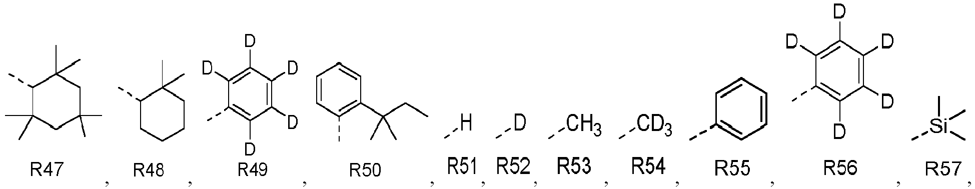 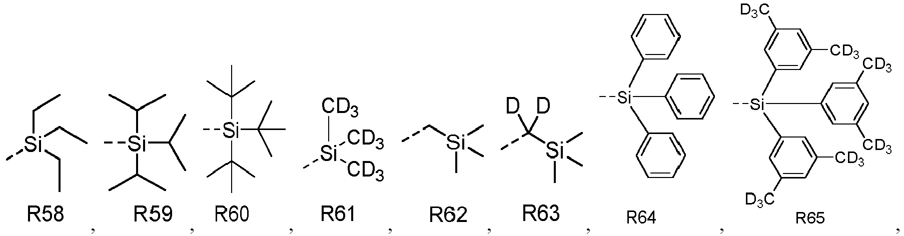 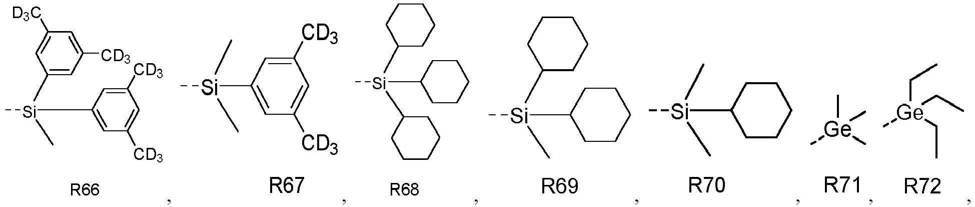 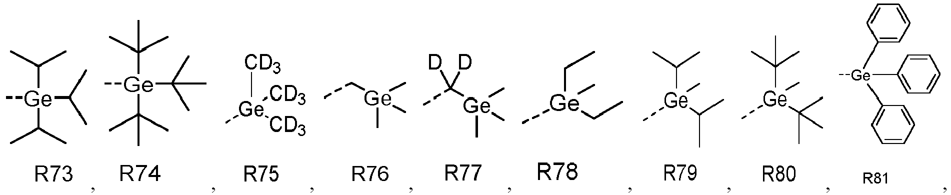 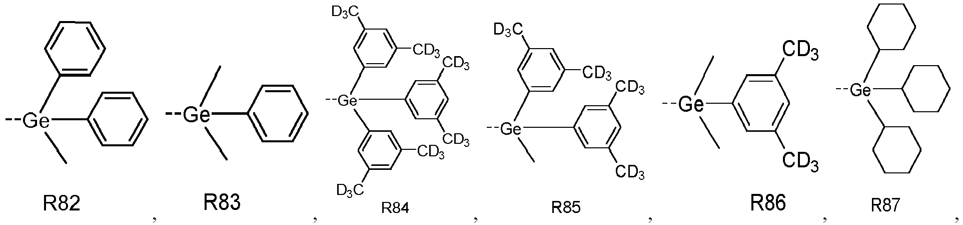 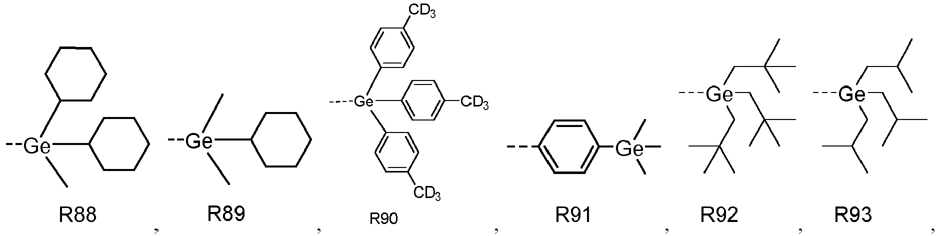 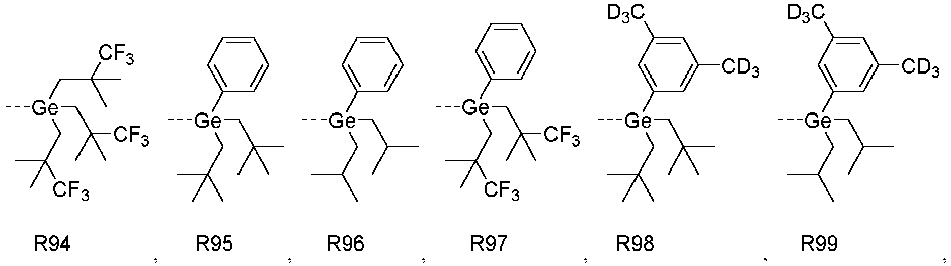 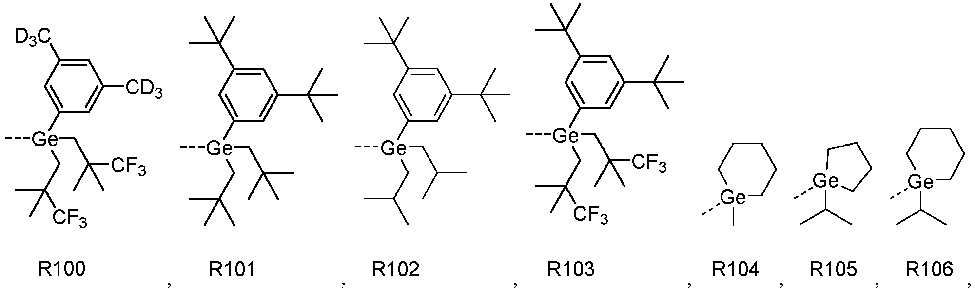 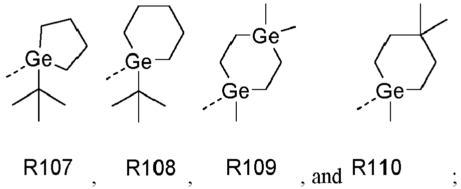
wherein each of E1 to E40 has the structure defined as follows:

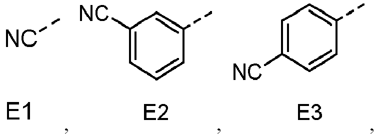

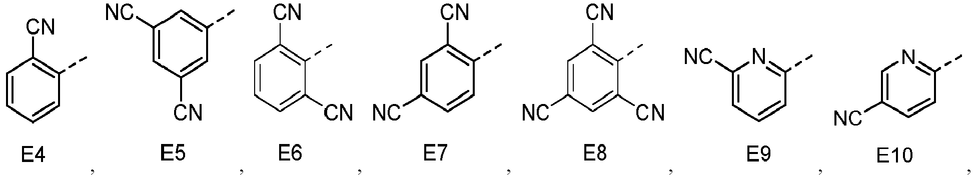

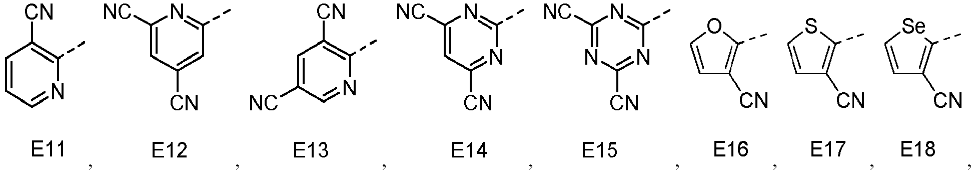

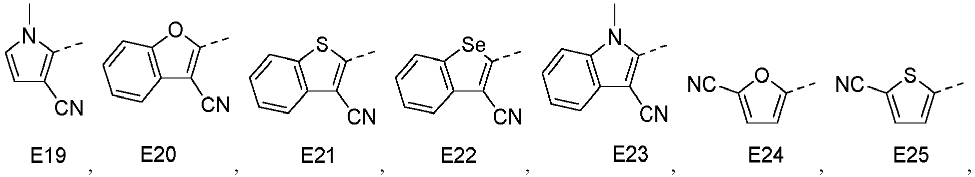

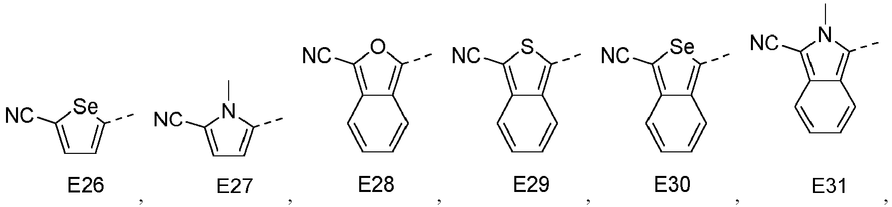

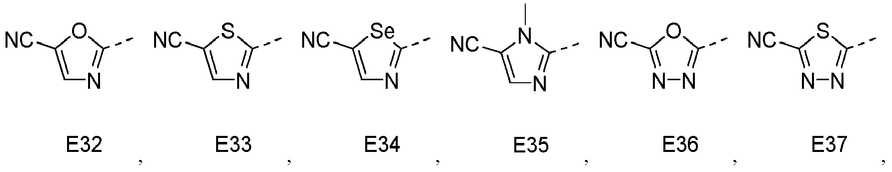

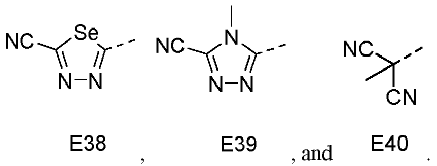

10. The compound of any one of the preceeding claims, wherein the compound has a formula selected from the group consisting of Ir(L_{A})₃, Ir(L_{A})(L_{B})₂, Ir(L_{A})₂(L_{B}), Ir(L_{A})₂(L_{C}), and Ir(L_{A})(L_{B})(L_{C}); and wherein L_{A}, L_{B}, and Lc are different from each other.

11. The compound of any one of the preceeding claims, wherein L_{B} and Lc are each independently selected from the group consisting of: 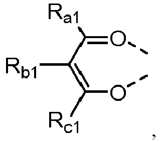 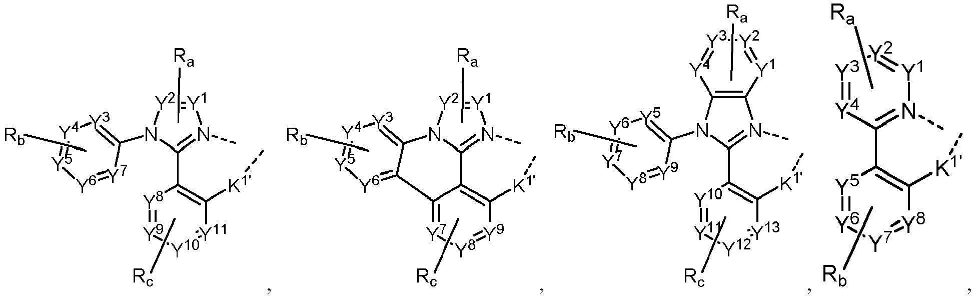 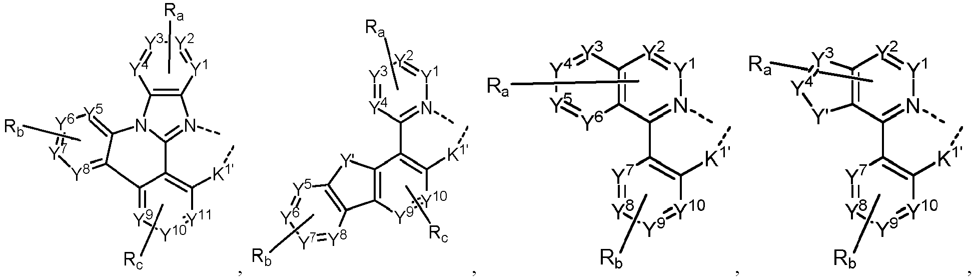 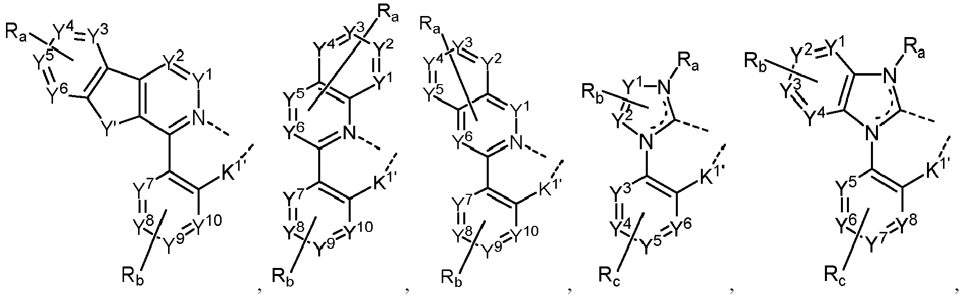 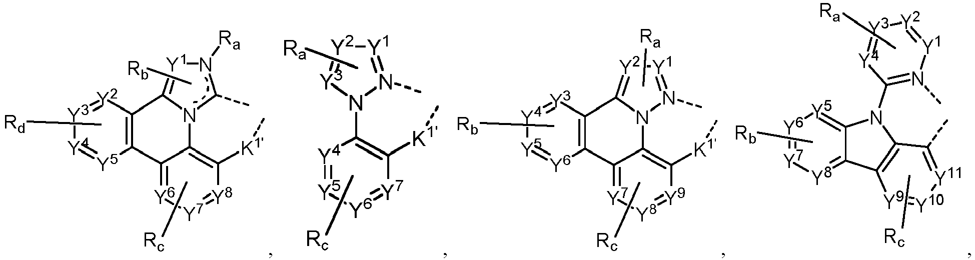 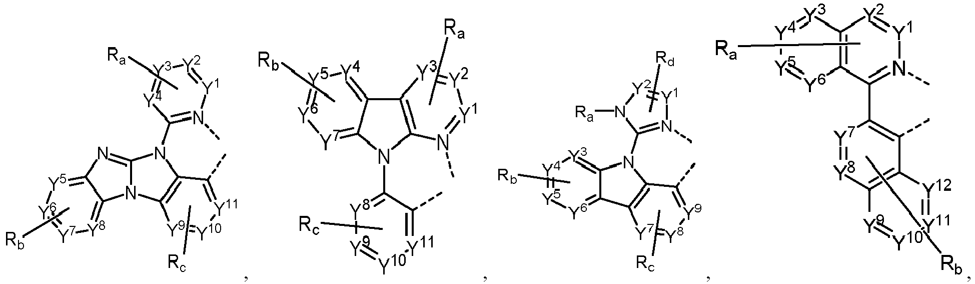 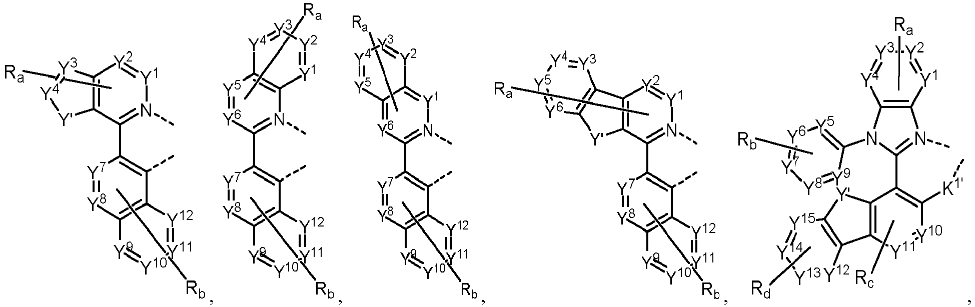 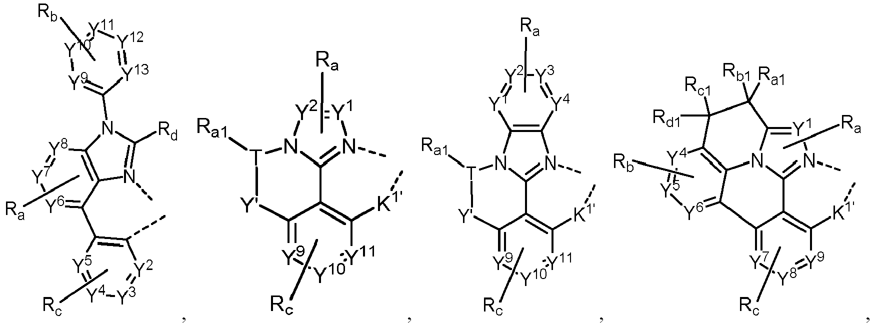 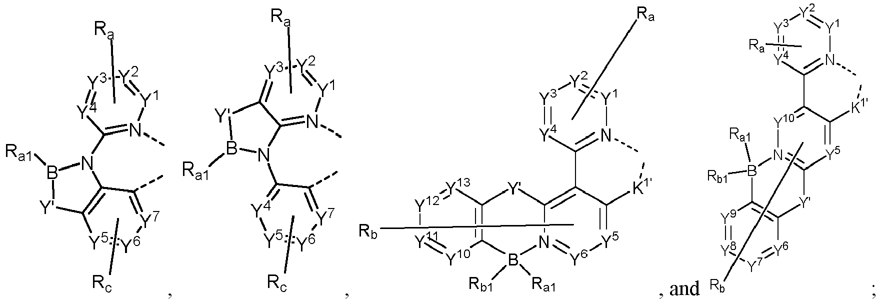 wherein:
T is selected from the group consisting of B, Al, Ga, and In;
K^{1'} is selected from the group consisting of a single bond, O, S, NRₑ, PRₑ, BRₑ, CRₑR_{f}, and SiRₑR_{f};
each of Y¹ to Y¹³ is independently selected from the group consisting of C and N;
Y' is selected from the group consisting of BRₑ, BRₑR_{f}, NRₑ, PRₑ, P(O)Rₑ, O, S, Se, C=O, C=S, C=Se, C=NRₑ, C=CRₑR_{f}, S=O, SO₂, CRₑR_{f}, SiRₑR_{f}, and GeRₑR_{f};
Rₑ and R_{f} can be fused or joined to form a ring;
each Rₐ, R_{b}, R_{c}, and R_{d} independently represents from mono to the maximum allowed number of substitutions, or no substitution;
each of Rₐ₁, R_{b1}, R_{c1}, R_{d1}, Rₐ, R_{b}, R_{c}, R_{d}, R_{c}, and R_{f} is independently a hydrogen or a subsituent selected from the group consisting of deuterium, halide, alkyl, cycloalkyl, heteroalkyl, arylalkyl, alkoxy, aryloxy, amino, silyl, germyl, boryl, alkenyl, cycloalkenyl, heteroalkenyl, alkynyl, aryl, heteroaryl, acyl, carbonyl, carboxylic acid, ester, nitrile, isonitrile, sulfanyl, selenyl, sulfinyl, sulfonyl, phosphino, and combinations thereof; and
any two substituents of Rₐ₁, R_{b1}, R_{c1}, R_{d1}, Rₐ, R_{b}, R_{c}, and R_{d} can be fused or joined to form a ring or form a multidentate ligand.

12. The compound of claim 10, wherein the compound has formula Ir(L_{A})₃, formula Ir(L_{A})(L_{B*k*})₂, formula Ir(L_{A})₂(L_{B*k*}), formula Ir(L_{A})₂(L_{C*j*-I}), or formula Ir(L_{A})₂(L_{*Cj*-II}),
wherein L_{A} is selected from any L_{A} as defined herein, including the structures of L_{Ai}(E^{A})(R*^{K}*)(R*^{L}*)(R*^{M}*), L_{A'm}(E^{A})(R*^{K}*)(R*^{L}*)(R*^{M}*), L_{AAn}(E^{A})(R*^{K}*)(R*^{L}*)(R*^{M}*), and L_{AA'o}(E^{A})(R*^{K}*)(R*^{L}*)(R*^{M}*);
wherein k is an integer from 1 to 520;
wherein j is an integer from 1 to 1416;
with the provisos that:
when L_{A} is selected from the group consisting of L_{Ai}(E1)(R*^{K}*)(R*^{L}*)(R*^{M}*), k is an integer from 475 to 520; and
when L_{A} is selected from the group consisting of L_{AAn}(E1)(R*^{K}*)(R*^{L}*)(R*^{M}*), k is an integer from 475 to 490;
when L_{A} is selected from the group consisting of L_{AA'o}(E1)(R*^{K}*)(R*^{L}*)(R*^{M}*), k is an integer from 1 to 490;
wherein k is an integer from 1 to 520; and each L_{B*k*} has the structure defined as follows: 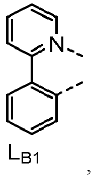 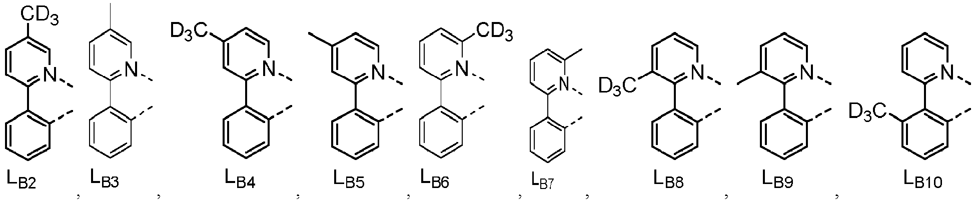 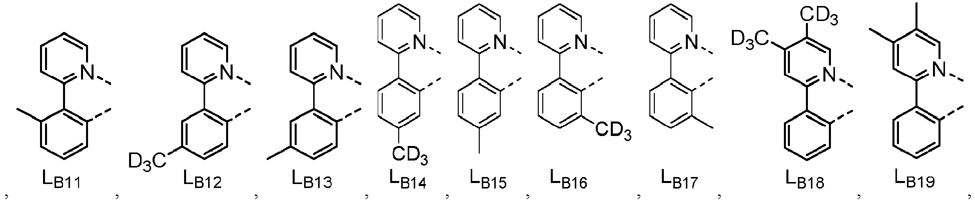 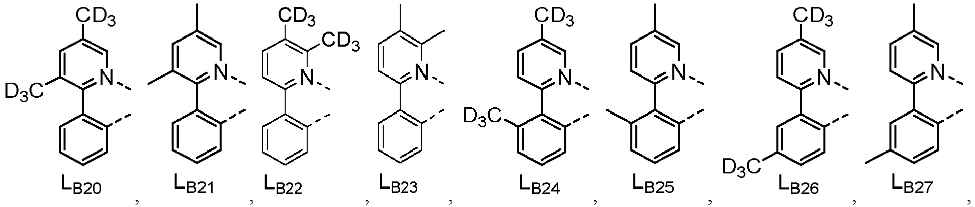 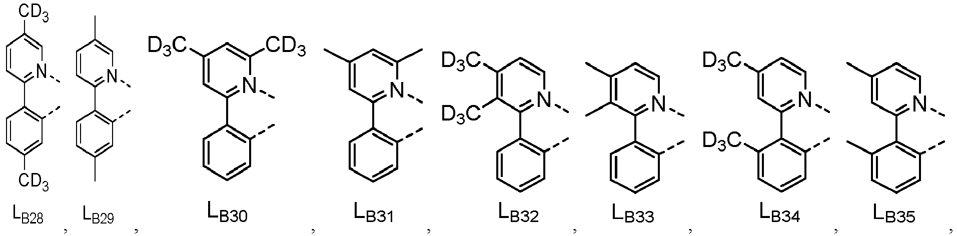 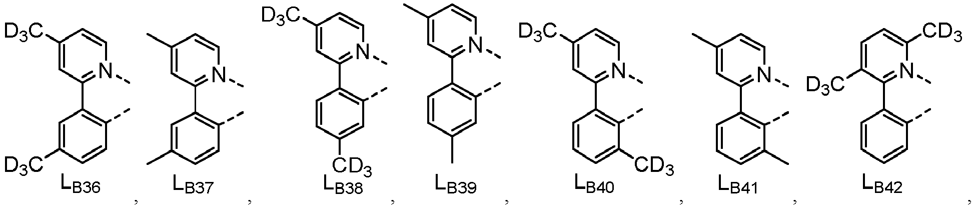 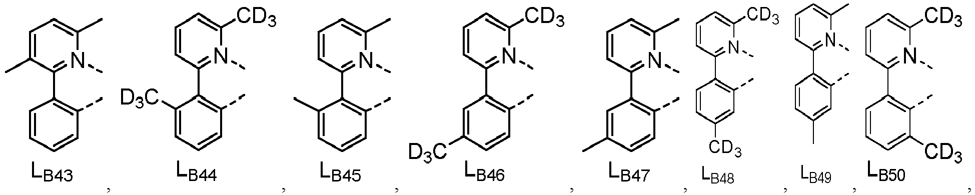 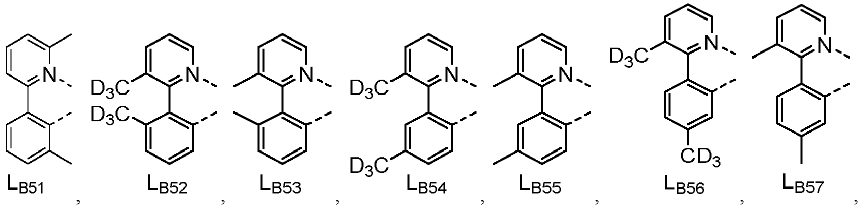 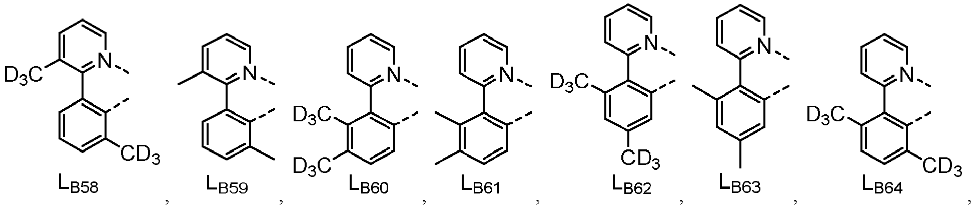 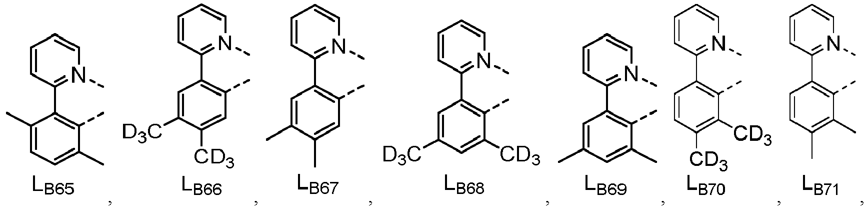 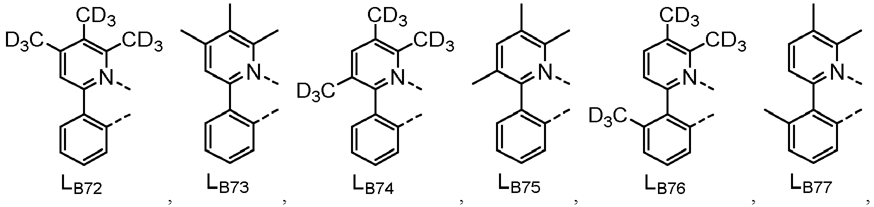 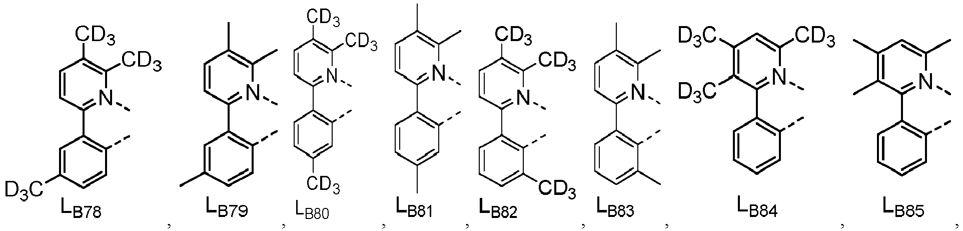 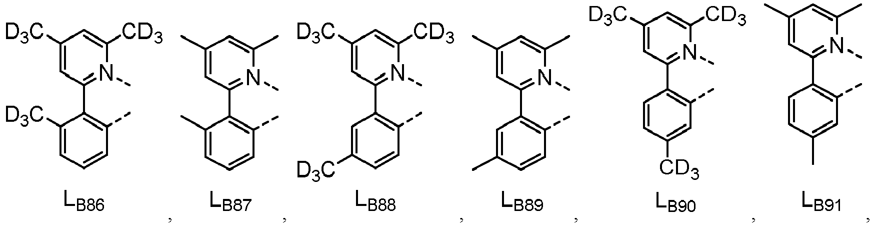 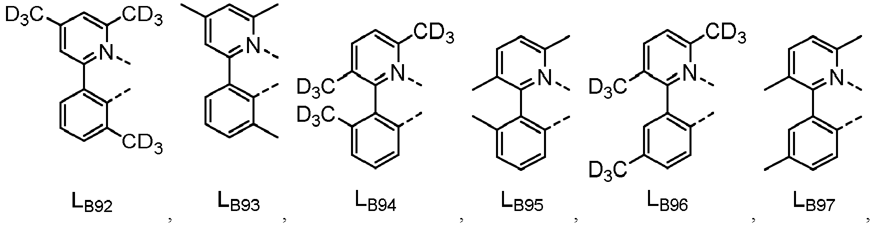 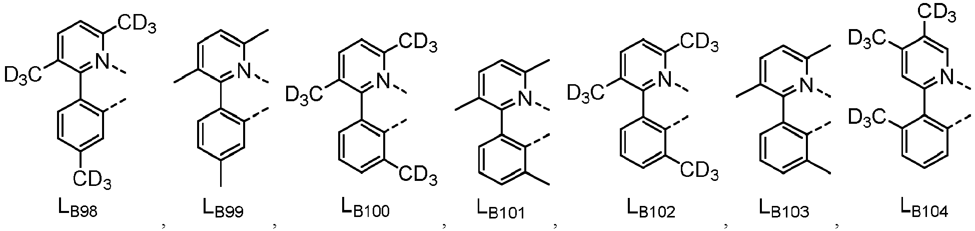 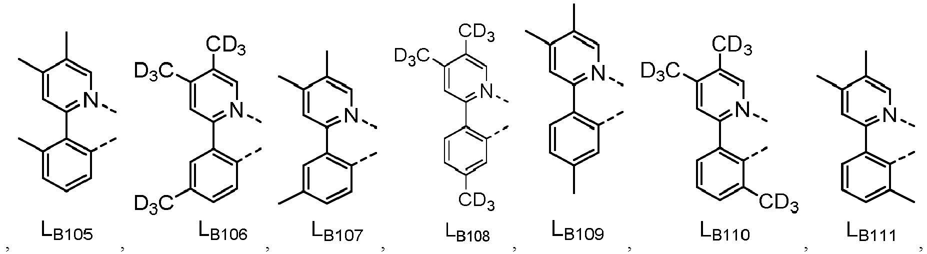 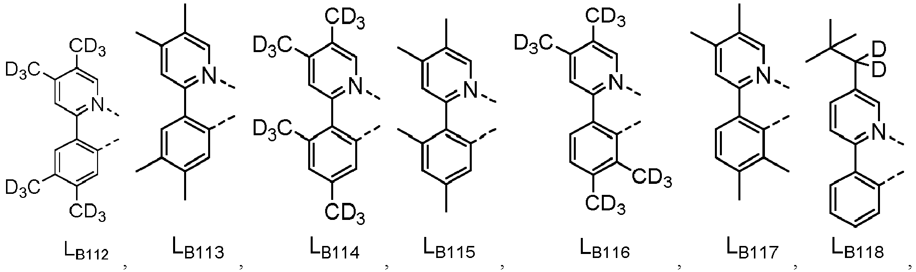 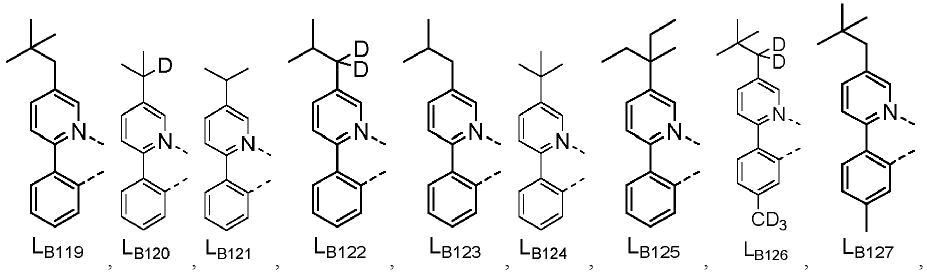 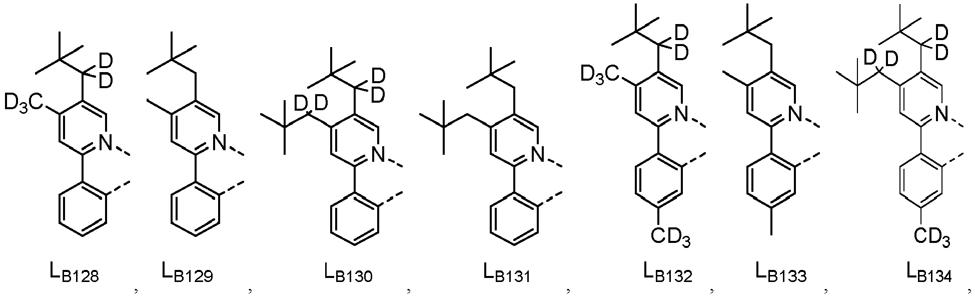 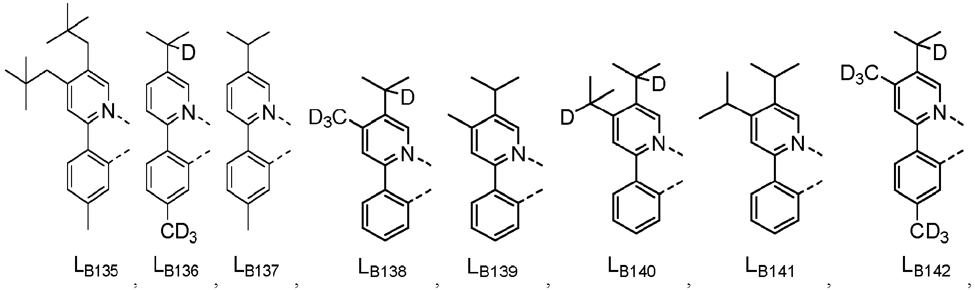 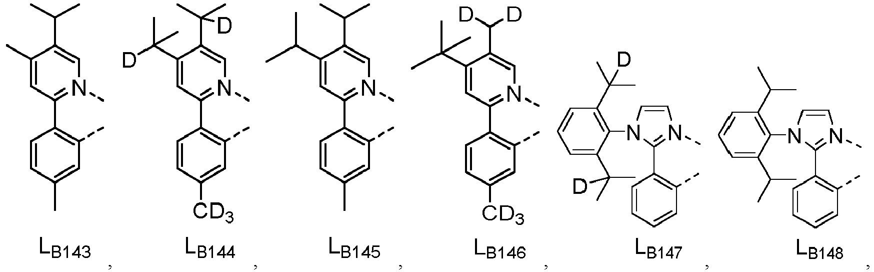 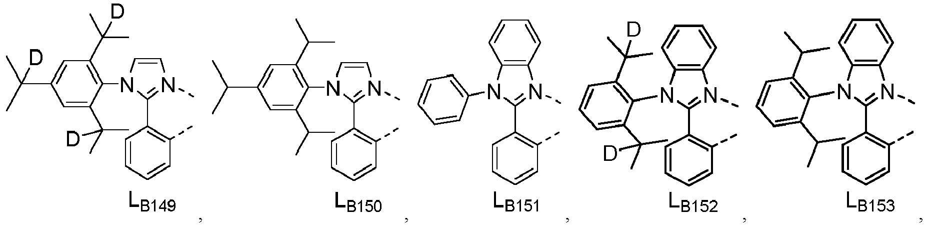 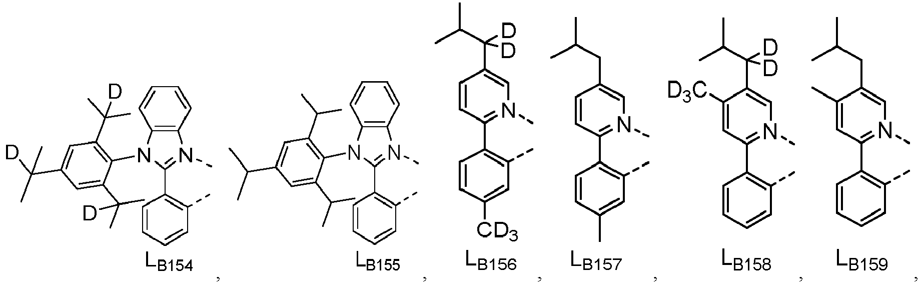 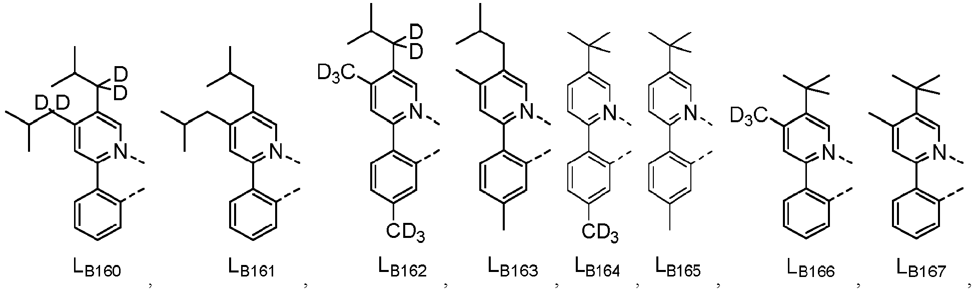 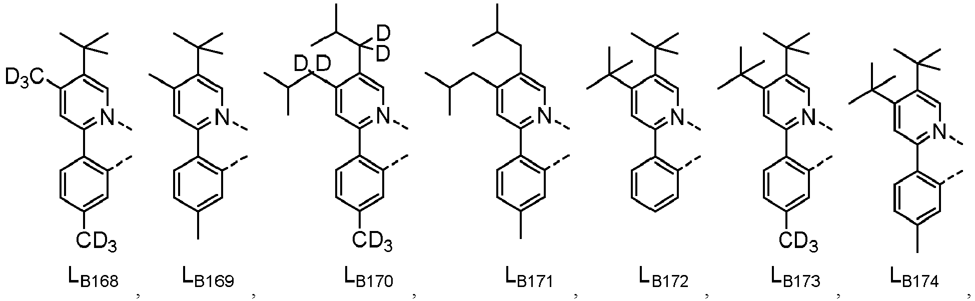 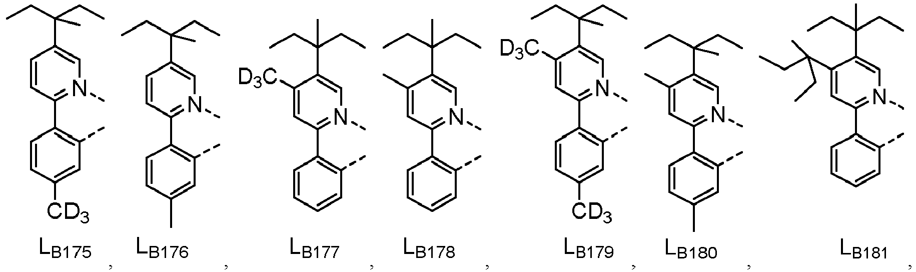 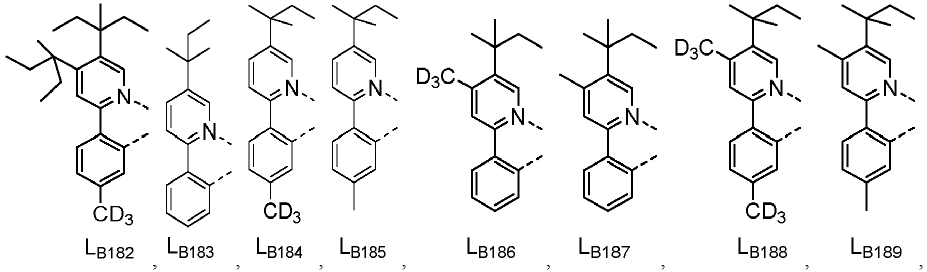 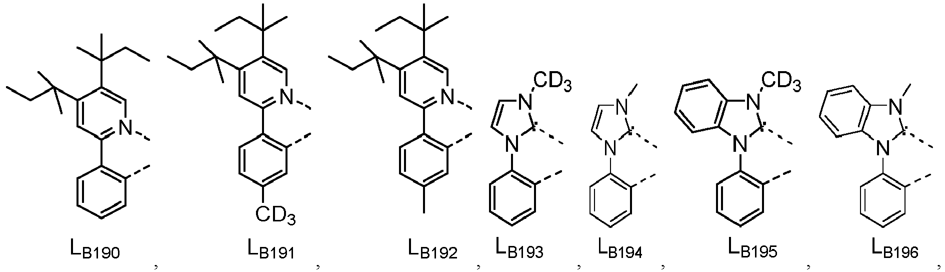 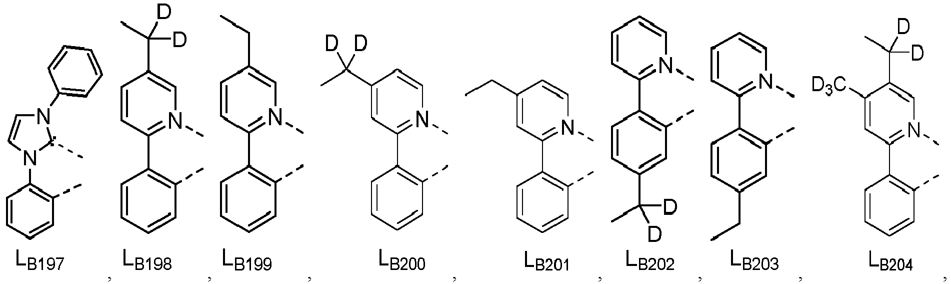 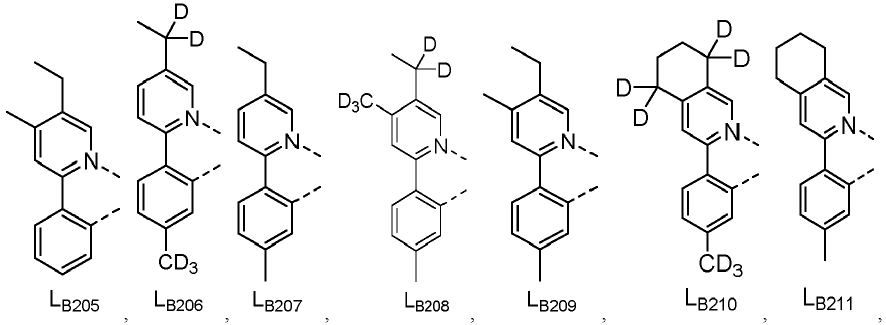 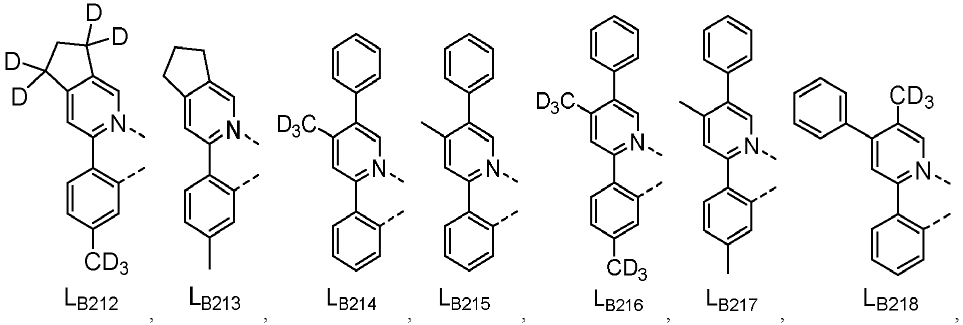 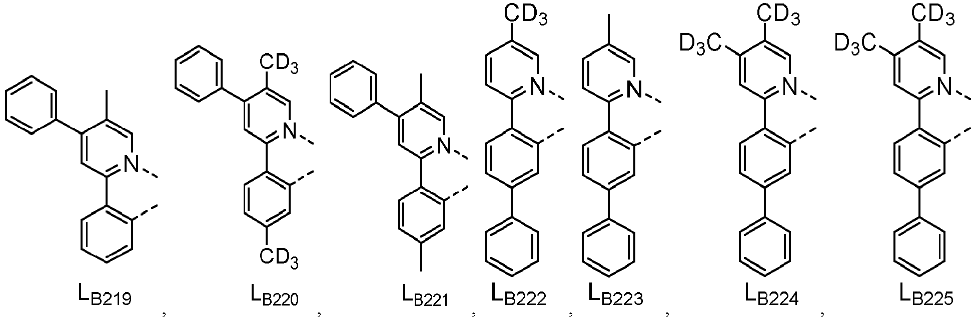 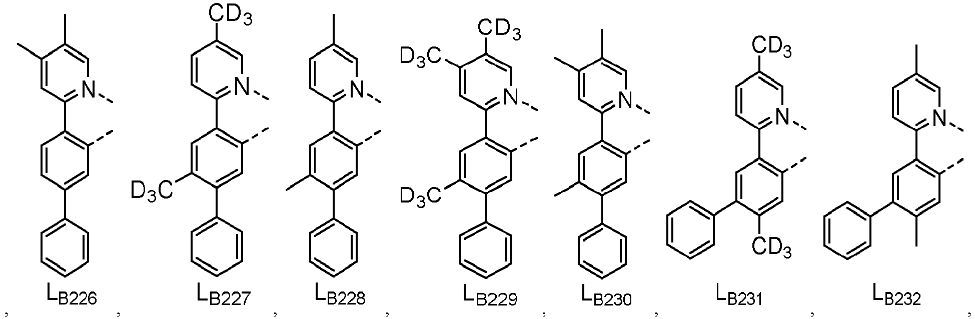 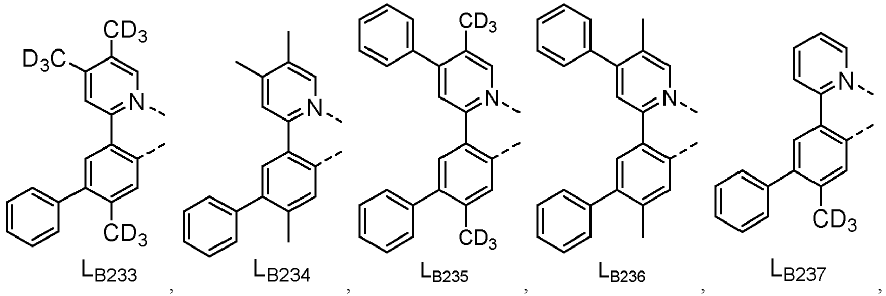 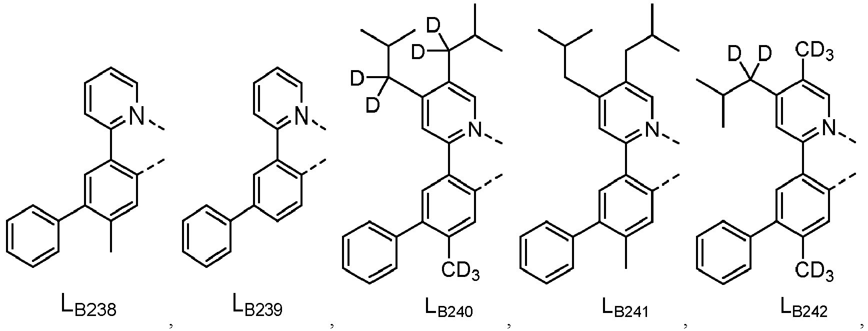 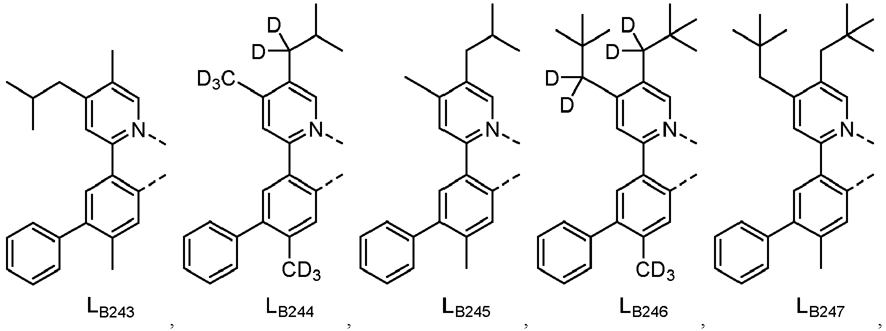 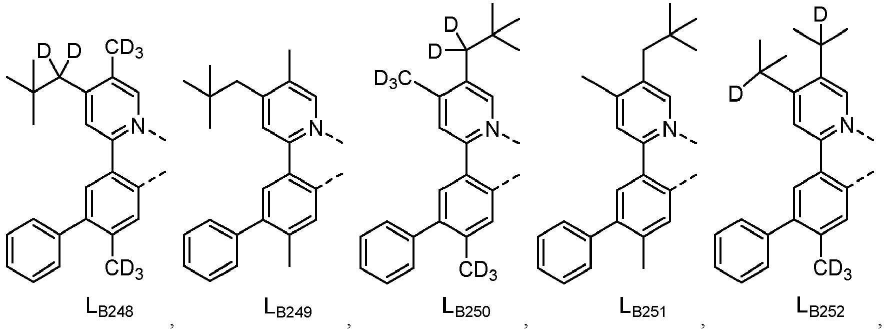 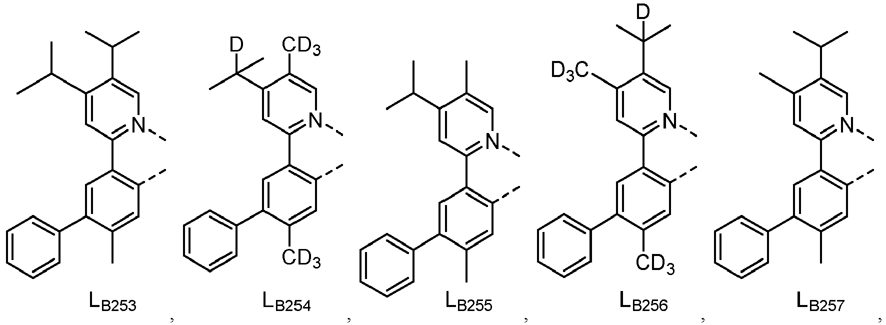 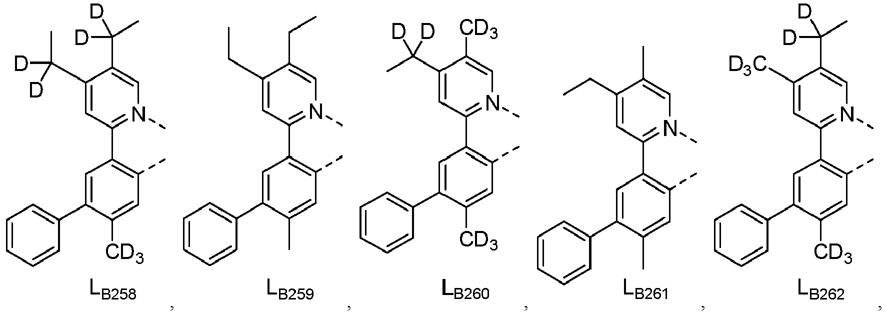 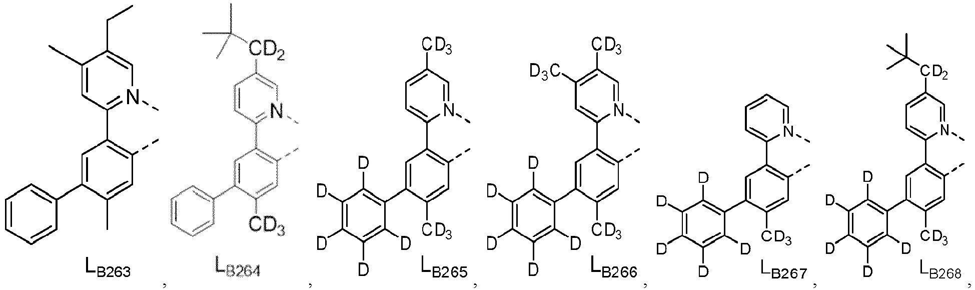 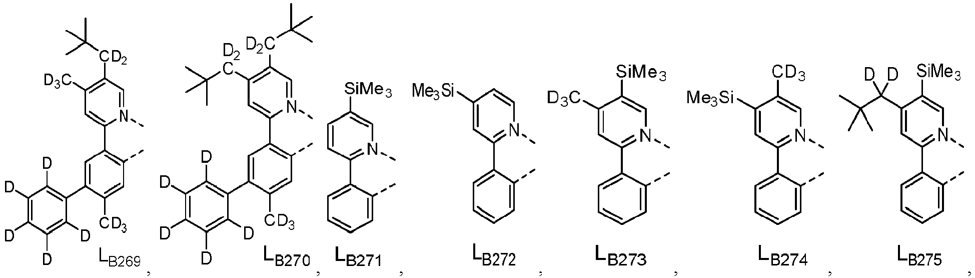 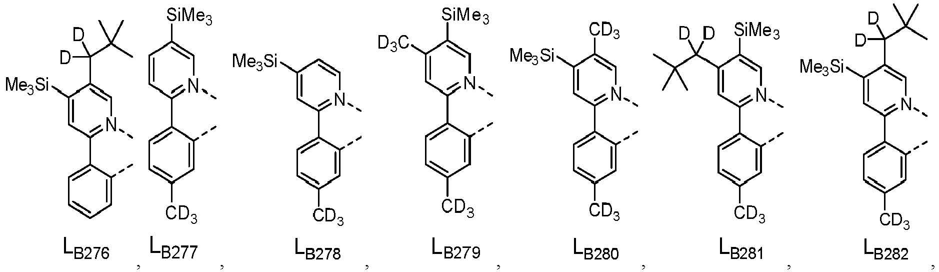 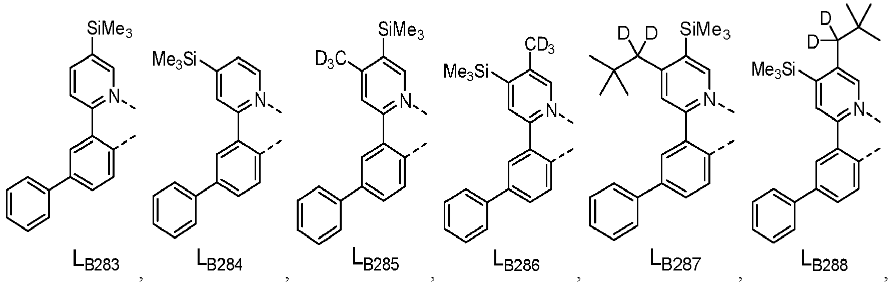 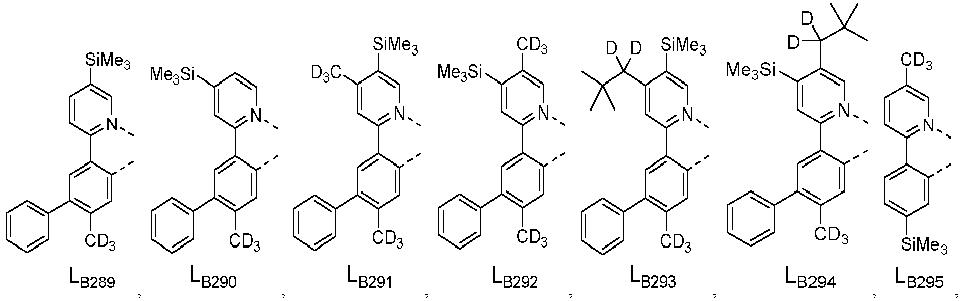 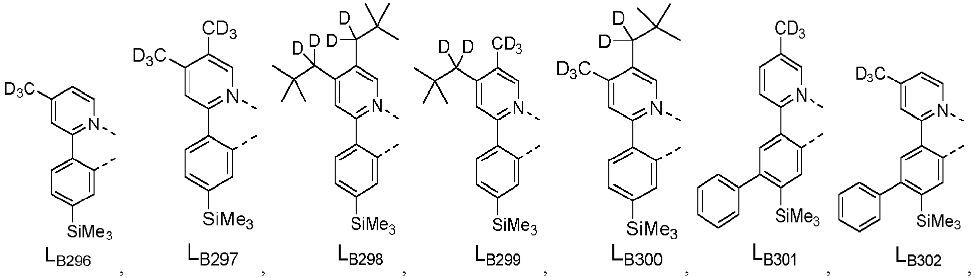 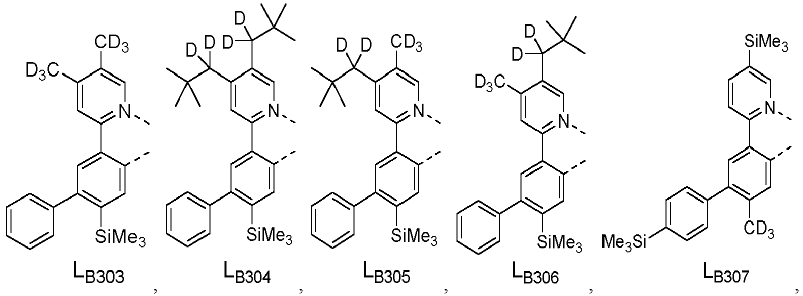 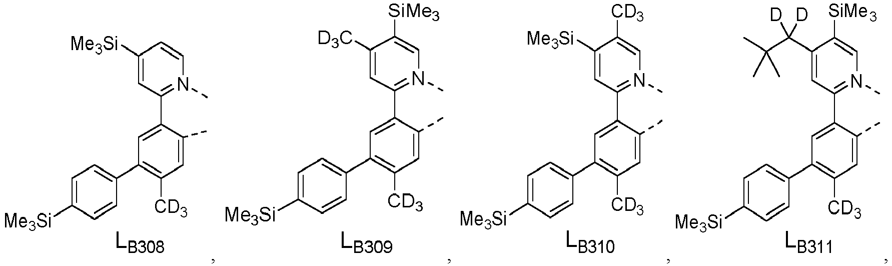 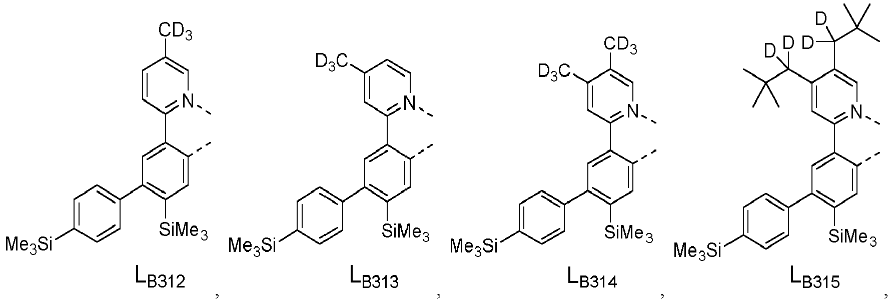 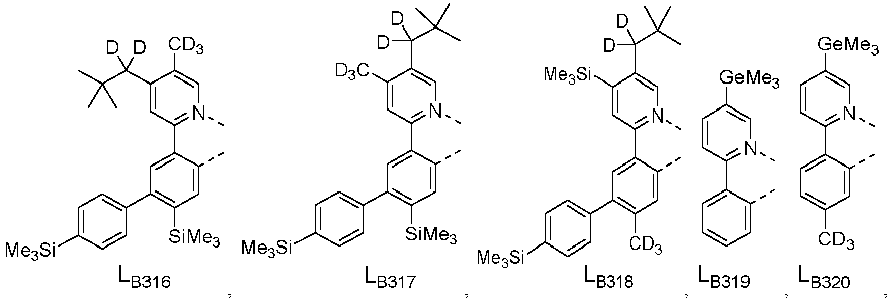 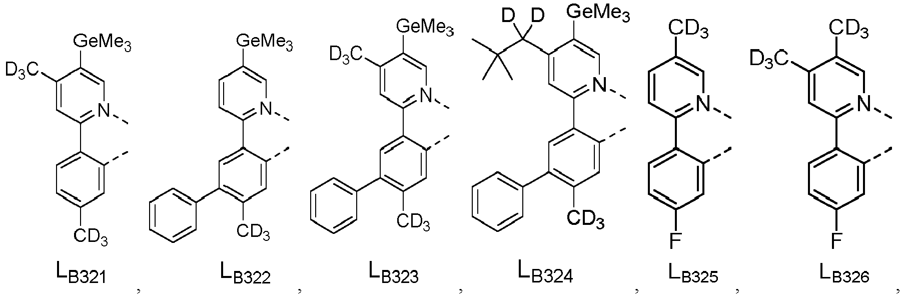 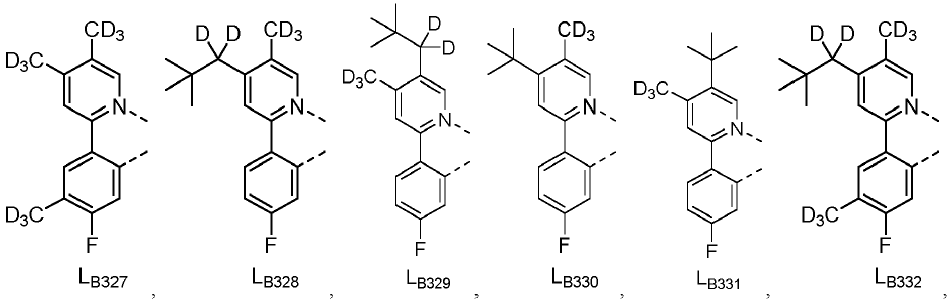 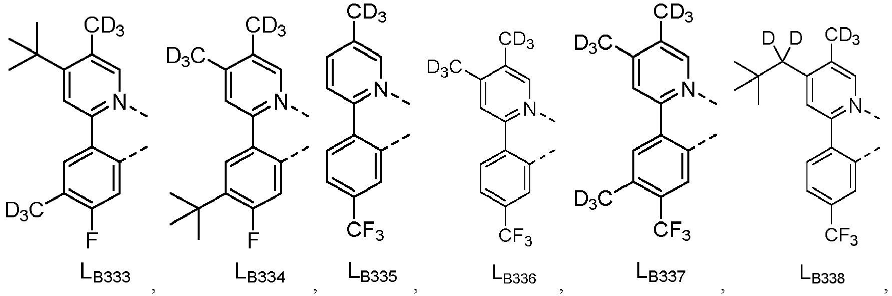 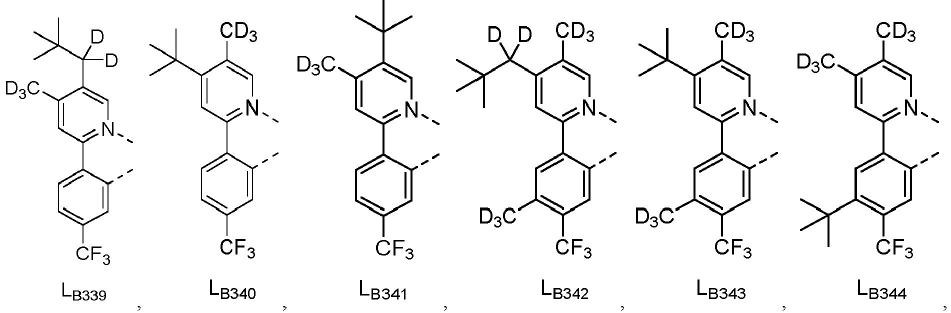 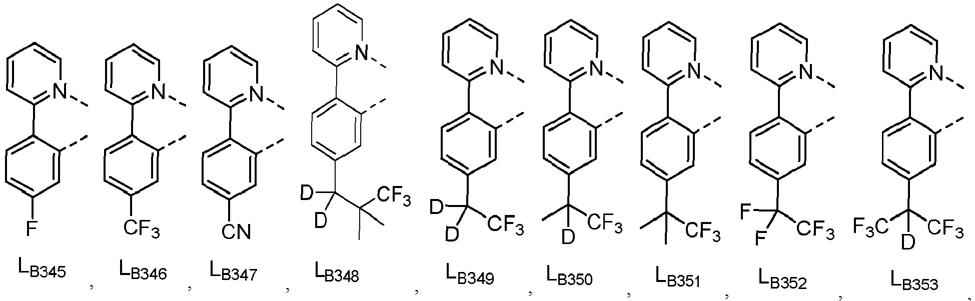 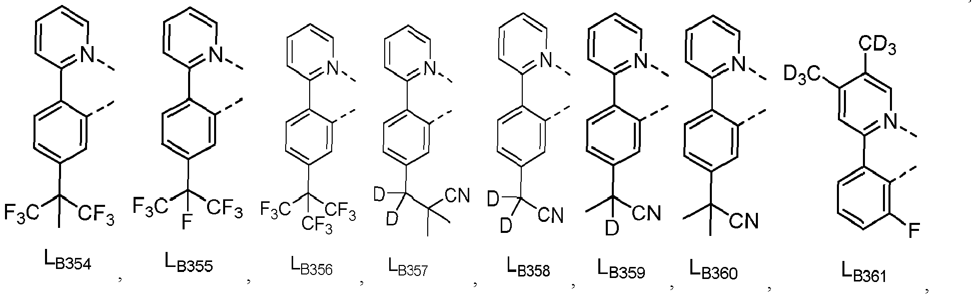 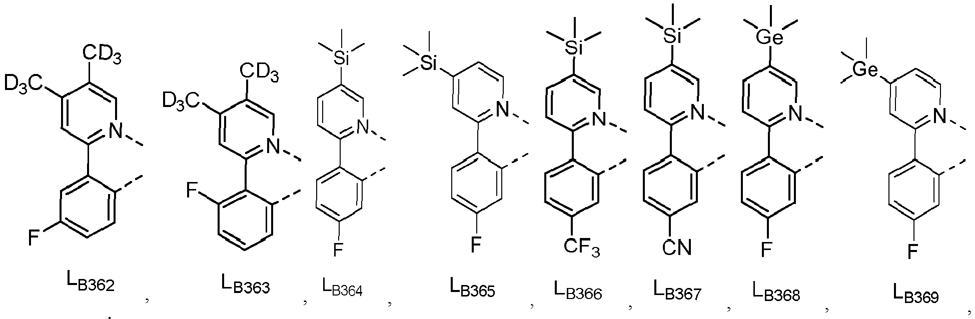 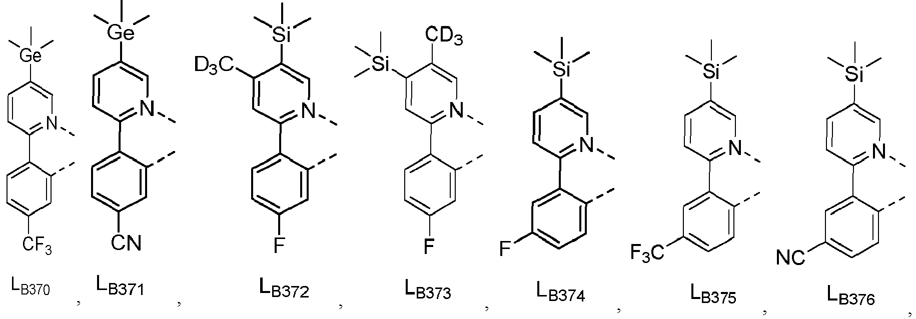 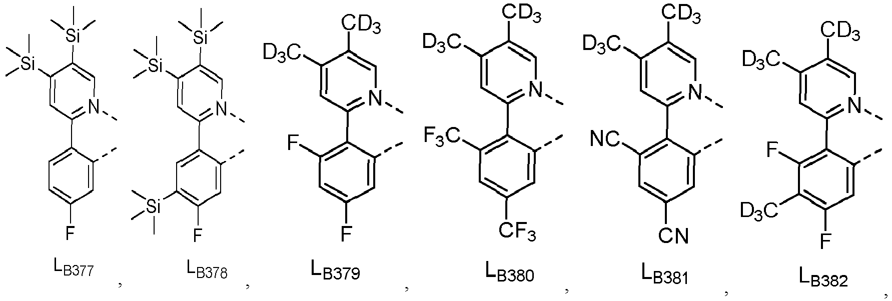 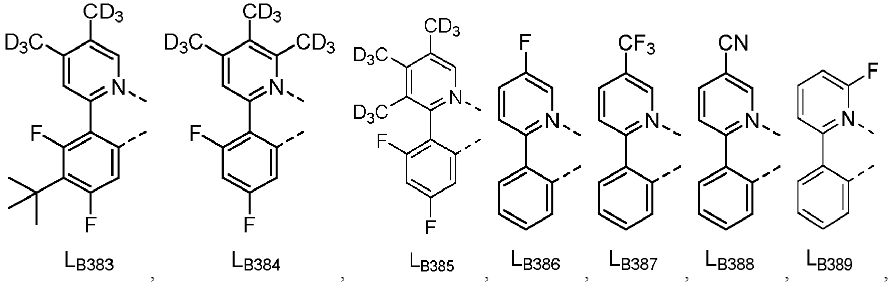 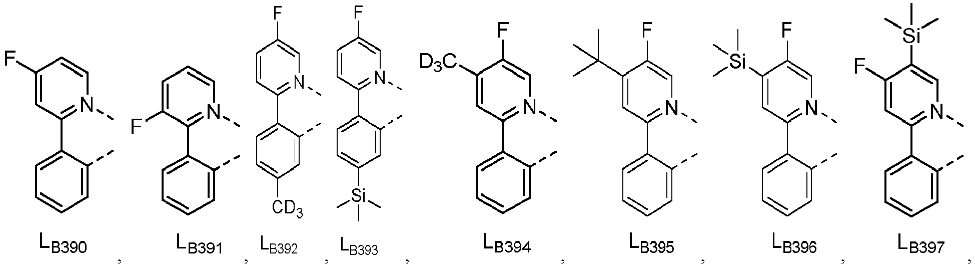 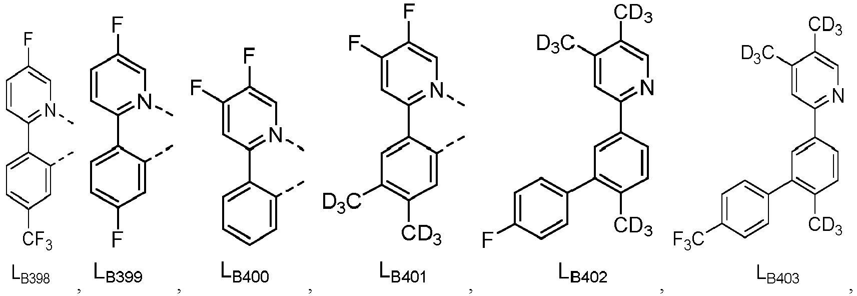 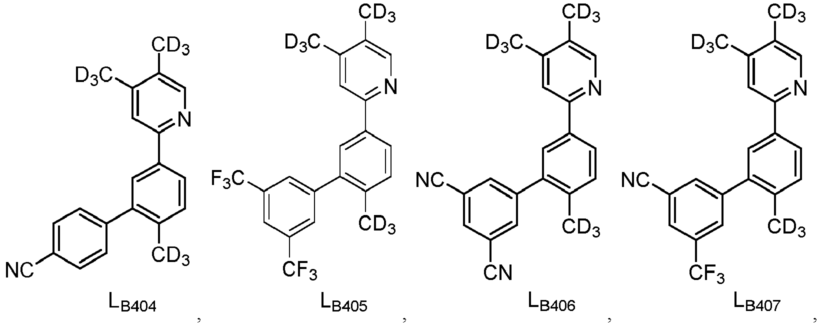 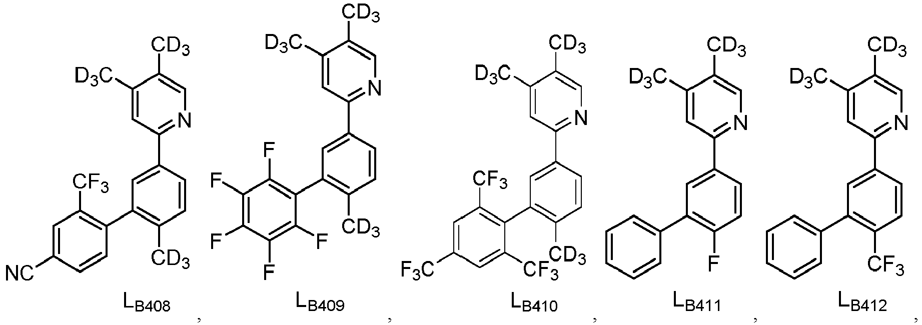 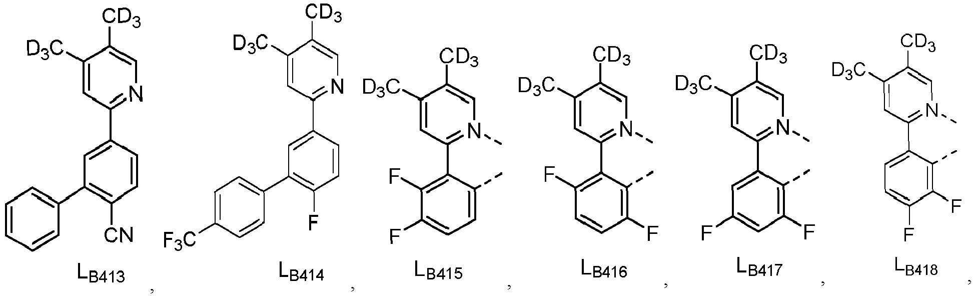 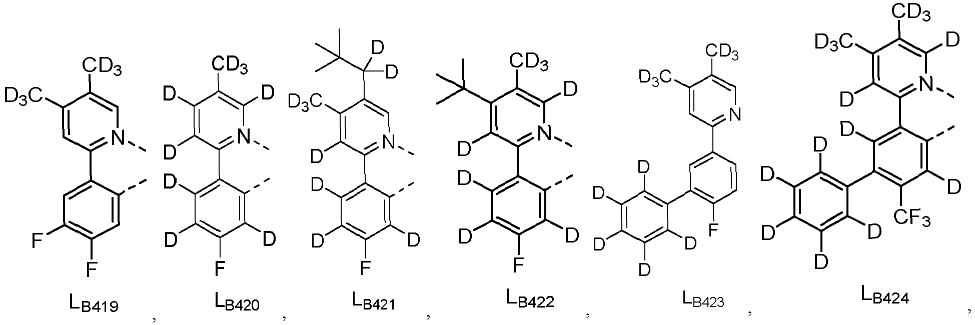 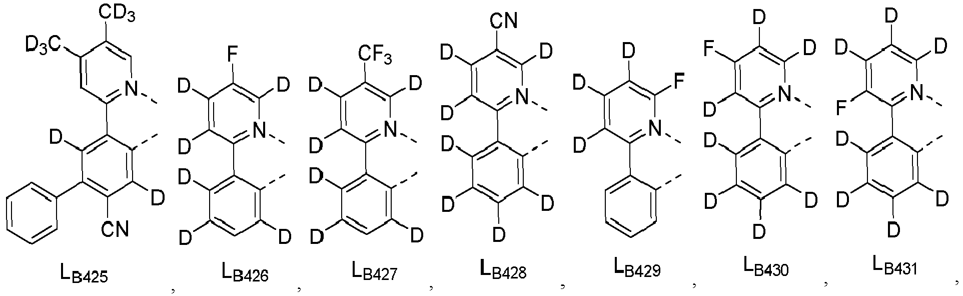 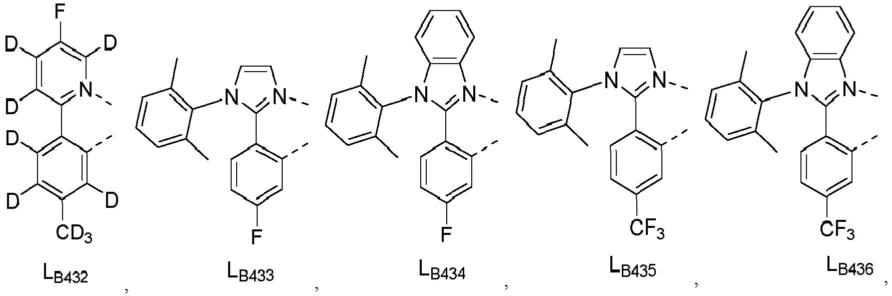 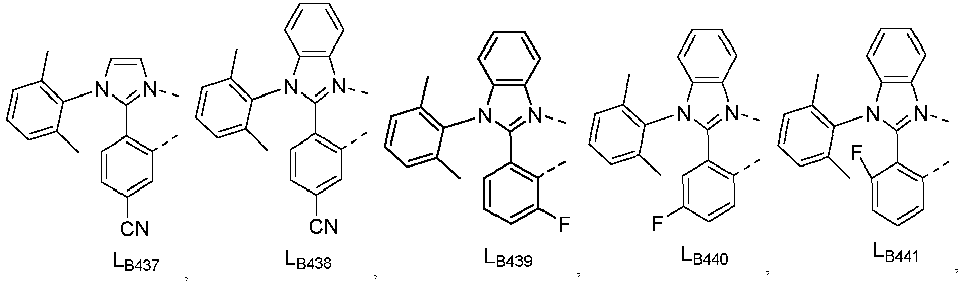 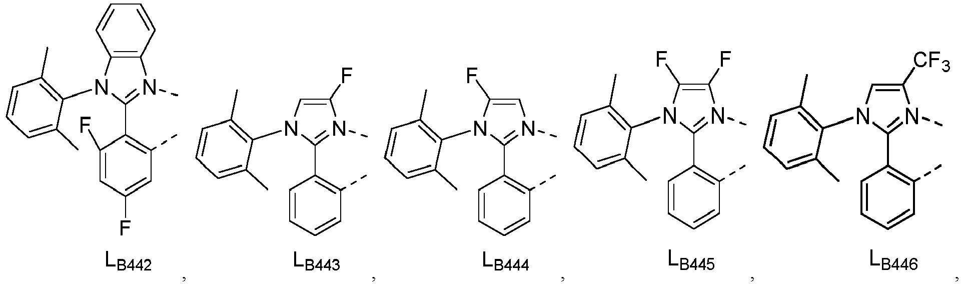 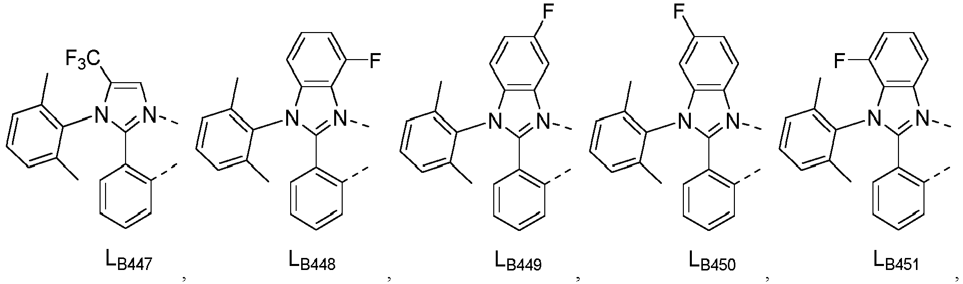 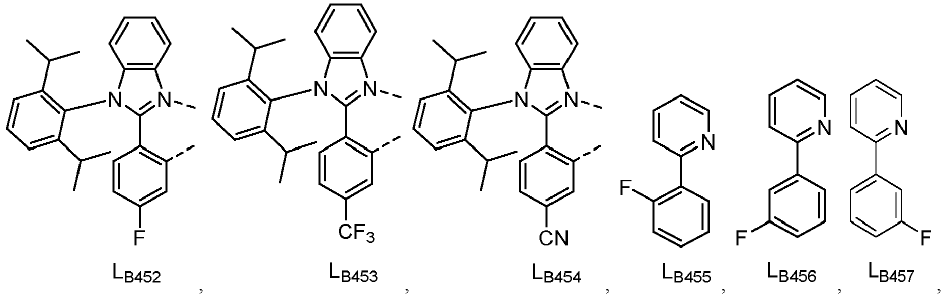 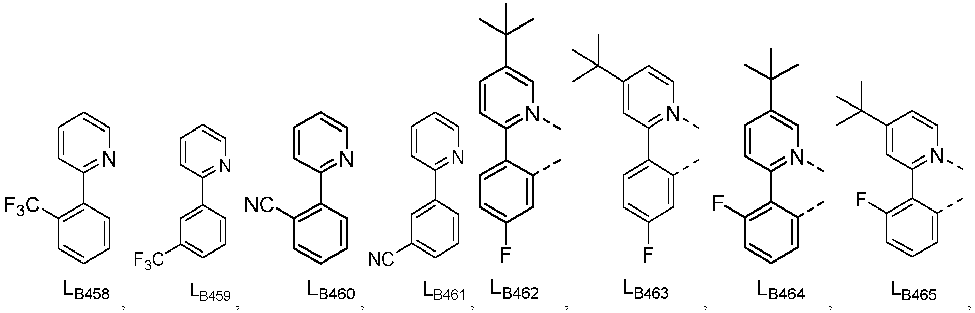 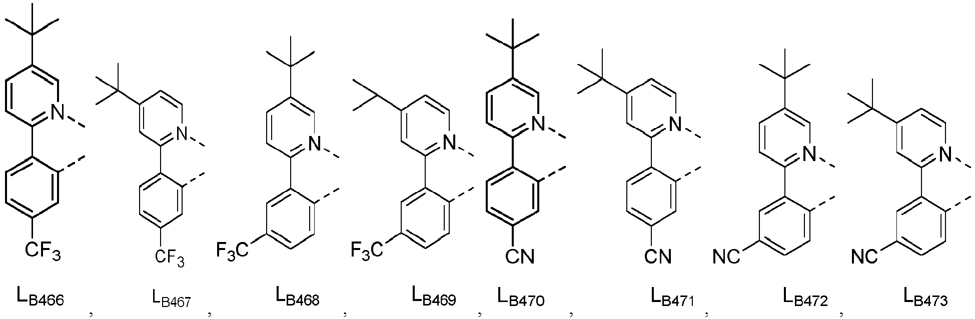 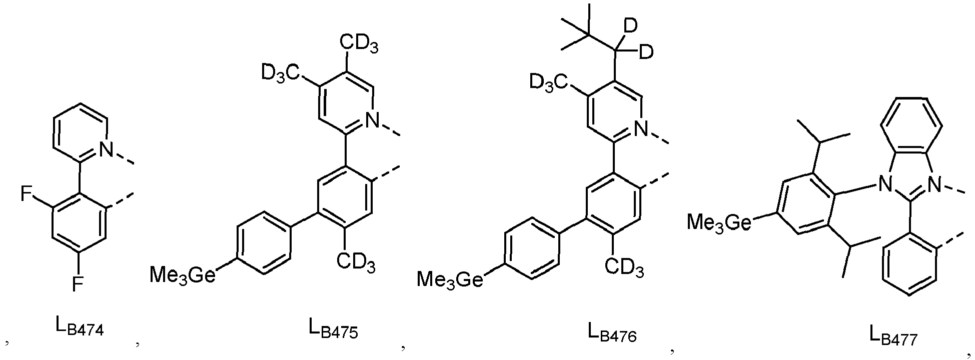 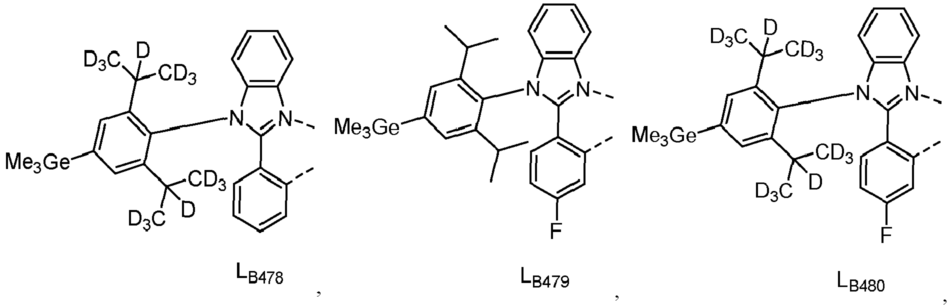 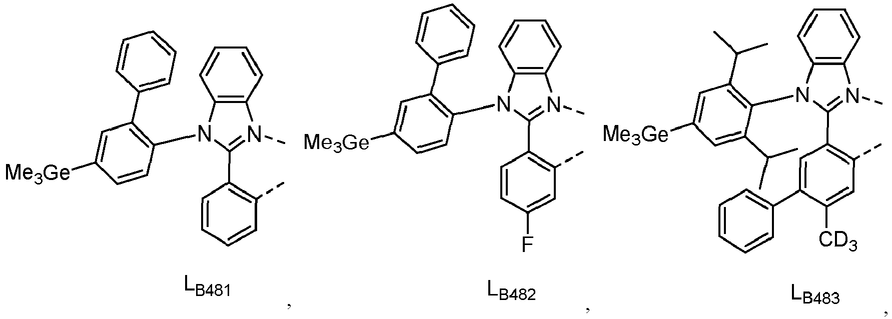 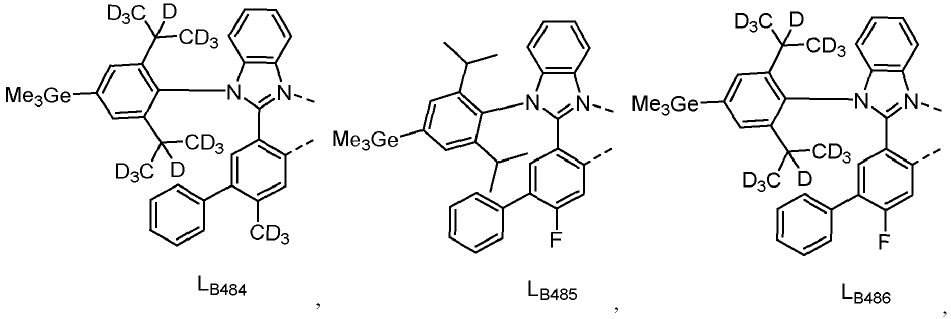 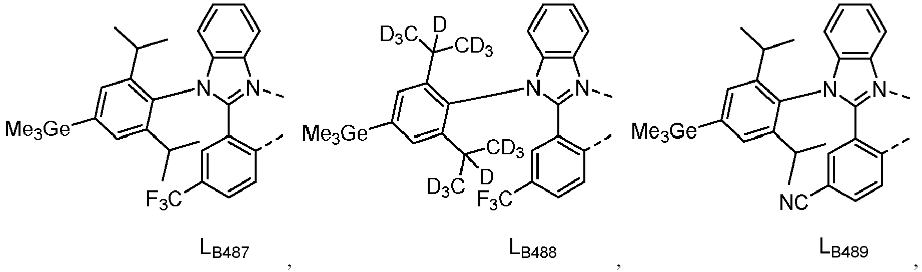 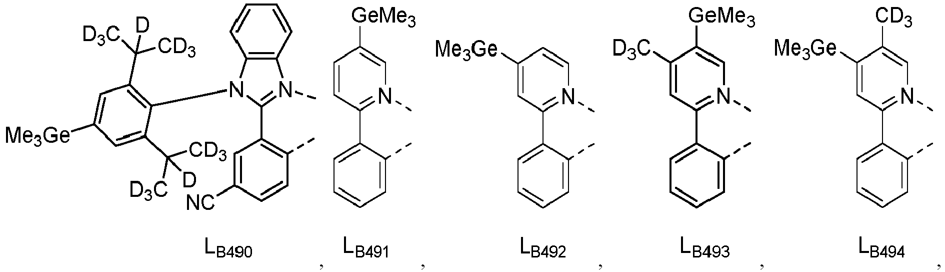 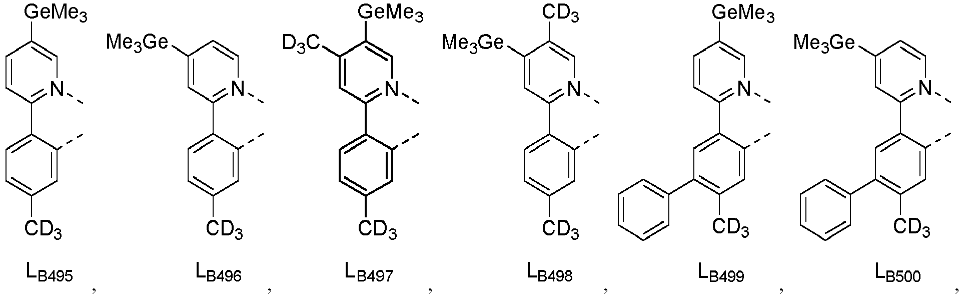 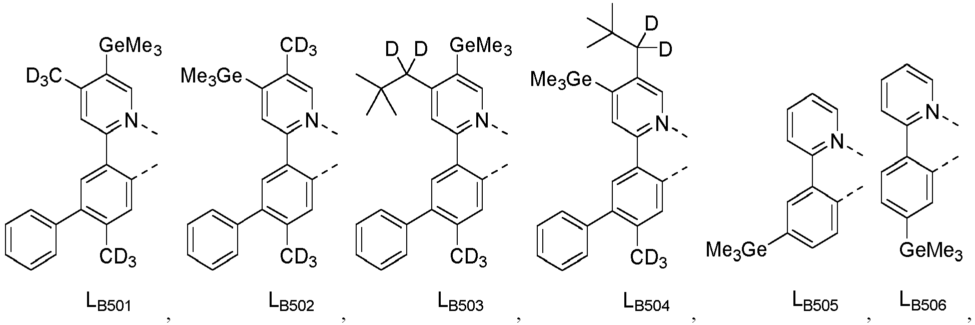 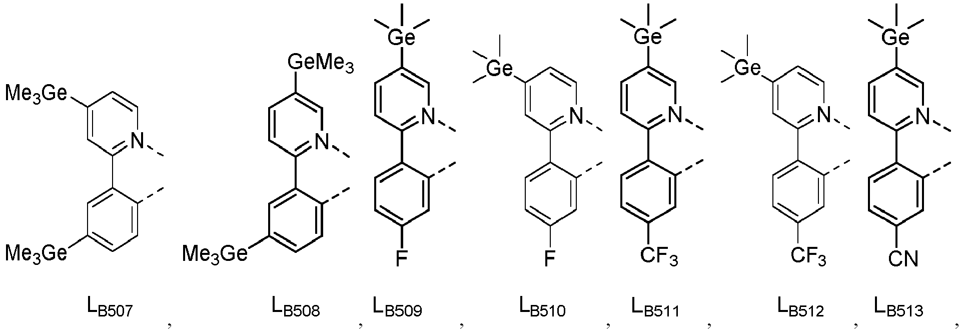 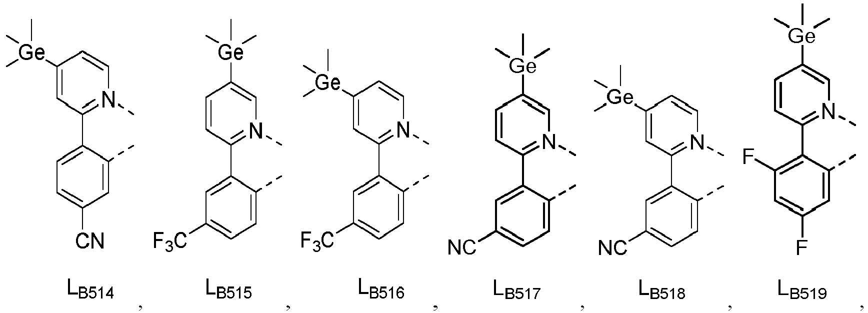 and 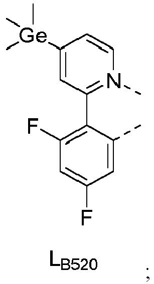 wherein each L_{*Cj*-I} has a structure based on formula 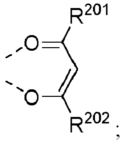 and
each L_{*Cj*-II} has a structure based on formula 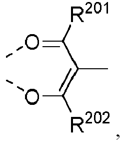 wherein for each L*_{Cj}* in L_{*Cj*-I} and L_{*Cj*-II}, R²⁰¹ and R²⁰² are each independently defined as follows:
| **L_{C*j*}** | **R²⁰¹** | **R²⁰²** | **L_{C*j*}** | **R²⁰¹** | **R²⁰²** | **L_{C*j*}** | **R²⁰¹** | **R²⁰²** | **L_{C*j*}** | **R²⁰¹** | **R²⁰²** |
|---|---|---|---|---|---|---|---|---|---|---|---|
| L_{C1} | R^{D1} | R^{D1} | L_{C193} | R^{D1} | R^{D3} | L_{C385} | R^{D17} | R^{D40} | L_{C577} | R^{D143} | R^{D120} |
| L_{C2} | R^{D2} | R^{D2} | L_{C194} | R^{D1} | R^{D4} | L_{C386} | R^{D17} | R^{D41} | L_{C578} | R^{D143} | R^{D133} |
| L_{C3} | R^{D3} | R^{D3} | L_{C195} | R^{D1} | R^{D5} | L_{C387} | R^{D17} | R^{D42} | L_{C579} | R^{D143} | R^{D134} |
| L_{C4} | R^{D4} | R^{D4} | L_{C196} | R^{D1} | R^{D9} | L_{C388} | R^{D17} | R^{D43} | L_{C580} | R^{D143} | R^{D135} |
| L_{C5} | R^{D5} | R^{D5} | L_{C197} | R^{D1} | R^{D10} | L_{C389} | R^{D17} | R^{D48} | L_{C581} | R^{D143} | R^{D136} |
| L_{C6} | R^{D6} | R^{D6} | L_{C198} | R^{D1} | R^{D17} | L_{C390} | R^{D17} | R^{D49} | L_{C582} | R^{D143} | R^{D144} |
| L_{C7} | R^{D7} | R^{D7} | L_{C199} | R^{D1} | R^{D18} | L_{C391} | R^{D17} | R^{D50} | L_{C583} | R^{D143} | R^{D145} |
| L_{C8} | R^{D8} | R^{D8} | L_{C200} | R^{D1} | R^{D20} | L_{C392} | R^{D17} | R^{D54} | L_{C584} | R^{D143} | R^{D146} |
| L_{C9} | R^{D9} | R^{D9} | L_{C201} | R^{D1} | R^{D22} | L_{C393} | R^{D17} | R^{D55} | L_{C585} | R^{D143} | R^{D147} |
| L_{C10} | R^{D10} | R^{D10} | L_{C202} | R^{D1} | R^{D37} | L_{C394} | R^{D17} | R^{D58} | L_{C586} | R^{D143} | R^{D149} |
| L_{C11} | R^{D11} | R^{D11} | L_{C203} | R^{D1} | R^{D40} | L_{C395} | R^{D17} | R^{D59} | L_{C587} | R^{D143} | R^{D151} |
| L_{C12} | R^{D12} | R^{P12} | L_{C204} | R^{D1} | R^{D41} | L_{C396} | R^{D17} | R^{D78} | L_{C588} | R^{D143} | R^{D154} |
| L_{C13} | R^{D13} | R^{D13} | L_{C205} | R^{D1} | R^{D42} | L_{C397} | R^{D17} | R^{D79} | L_{C589} | R^{D143} | R^{D155} |
| L_{C14} | R^{D14} | R^{D14} | L_{C206} | R^{D1} | R^{D43} | L_{C398} | R^{D17} | R^{D81} | L_{C590} | R^{D143} | R^{D161} |
| L_{C15} | R^{D15} | R^{D15} | L_{C207} | R^{D1} | R^{D48} | L_{C399} | R^{D17} | R^{D87} | L_{C591} | R^{D143} | R^{D175} |
| L_{C16} | R^{D16} | R^{D16} | L_{C208} | R^{D1} | R^{D49} | L_{C400} | R^{D17} | R^{D88} | L_{C592} | R^{D144} | R^{D3} |
| L_{C17} | R^{D17} | R^{D17} | L_{C209} | R^{D1} | R^{D50} | L_{C401} | R_{D17} | R^{D89} | L_{C593} | R^{D144} | R^{D5} |
| L_{C18} | R^{D18} | R^{D18} | L_{C210} | R^{D1} | R^{D54} | L_{C402} | R_{D17} | R^{D93} | L_{C594} | R^{D144} | R^{D17} |
| L_{C19} | R^{D19} | R^{D19} | L_{C211} | R^{D1} | R^{D55} | L_{C403} | R^{D17} | R^{D116} | L_{C595} | R^{D144} | R^{D18} |
| L_{C20} | R^{D20} | R^{D20} | L_{C212} | R^{D1} | R^{D58} | L_{C404} | R^{D17} | R^{D117} | L_{C596} | R^{D144} | R^{D20} |
| L_{C21} | R^{D21} | R^{D21} | L_{C213} | R^{D1} | R^{D59} | L_{C405} | R^{D17} | R^{D118} | L_{C597} | R^{D144} | R^{D22} |
| L_{C22} | R^{D22} | R^{D22} | L_{C214} | R^{D1} | R^{D78} | L_{C406} | R^{D17} | R^{D119} | L_{C598} | R^{D144} | R^{D37} |
| L_{C23} | R^{D23} | R^{D23} | L_{C215} | R^{D1} | R^{D79} | L_{C407} | R^{D17} | R^{D120} | L_{C599} | R^{D144} | R^{D40} |
| L_{C24} | R^{D24} | R^{D24} | L_{C7216} | R^{D1} | R^{D81} | L_{C408} | R^{D17} | R^{D133} | L_{C600} | R^{D144} | R^{D41} |
| L_{C25} | R^{D25} | R^{D25} | L_{C217} | R^{D1} | R^{D87} | L_{C409} | R^{D17} | R^{D134} | L_{C601} | R^{D144} | R^{D42} |
| L_{C26} | R^{D26} | R^{D26} | L_{C218} | R^{D1} | R^{D88} | L_{C410} | R^{D17} | R^{D135} | L_{C602} | R^{D144} | R^{D43} |
| L_{C27} | R^{D27} | R^{D27} | L_{C219} | R^{D1} | R^{D89} | L_{C411} | R^{D17} | R^{D136} | L_{C603} | R^{D144} | R^{D48} |
| L_{C28} | R^{D28} | R^{D28} | L_{C220} | R^{D1} | R^{D93} | L_{C412} | R^{D17} | R^{D143} | L_{C604} | R^{D144} | R^{D49} |
| L_{C29} | R^{D29} | R^{D29} | L_{C221} | R^{D1} | R^{D116} | L_{C413} | R^{D17} | R^{D144} | L_{C605} | R^{D144} | R^{D54} |
| L_{C30} | R^{D30} | R^{D30} | L_{C222} | R^{D1} | R^{D117} | L_{C414} | R^{D17} | R^{D145} | L_{C606} | R^{D144} | R^{D58} |
| L_{C31} | R^{D31} | R^{D31} | L_{C223} | R^{D1} | R^{D118} | L_{C415} | R^{D17} | R^{D146} | L_{C607} | R^{D144} | R^{D59} |
| L_{C32} | R^{D32} | R^{D32} | L_{C224} | R^{D1} | R^{D119} | L_{C416} | R^{D17} | R^{D147} | L_{C608} | R^{D144} | R^{D78} |
| L_{C33} | R^{D33} | R^{D33} | L_{C225} | R^{D1} | R^{D120} | L_{C417} | R^{D17} | R^{D149} | L_{C609} | R^{D144} | R^{D79} |
| L_{C34} | R^{D34} | R^{D34} | L_{C226} | R^{D1} | R^{D133} | L_{C418} | R^{D17} | R^{D151} | L_{C610} | R^{D144} | R^{D81} |
| L_{C35} | R^{D35} | R^{D35} | L_{C227} | R^{D1} | R^{D134} | L_{C419} | R^{D17} | R^{D154} | L_{C611} | R^{D144} | R^{D87} |
| L_{C36} | R^{D36} | R^{D36} | L_{C228} | R^{D1} | R^{D135} | L_{C420} | R^{D17} | R^{D155} | L_{C612} | R^{D144} | R^{D88} |
| L_{C37} | R^{D37} | R^{D37} | L_{C229} | R^{D1} | R^{D136} | L_{C421} | R^{D17} | R^{D161} | L_{C613} | R^{D144} | R^{D89} |
| L_{C38} | R^{D38} | R^{D38} | L_{C230} | R^{D1} | R^{D143} | L_{C422} | R^{D17} | R^{D175} | L_{C614} | R^{D144} | R^{D93} |
| L_{C39} | R^{D39} | R^{D39} | L_{C231} | R^{D1} | R^{D144} | L_{C423} | R^{D50} | R^{D3} | L_{C615} | R^{D144} | R^{D116} |
| L_{C40} | R^{D40} | R^{D40} | L_{C232} | R^{D1} | R^{D145} | L_{C424} | R^{D50} | R^{D5} | L_{C616} | R^{D144} | R^{D117} |
| L_{C41} | R^{D41} | R^{D41} | L_{C233} | R^{D1} | R^{D146} | L_{C425} | R^{D50} | R^{D18} | L_{C617} | R^{D144} | R^{D118} |
| L_{C42} | R^{D42} | R^{D42} | L_{C234} | R^{D1} | R^{D147} | L_{C426} | R^{D50} | R^{D20} | L_{C618} | R^{D144} | R^{D119} |
| L_{C43} | R^{D43} | R^{D43} | L_{C235} | R^{D1} | R^{D149} | L_{C427} | R^{D50} | R^{D22} | L_{C619} | R^{D144} | R^{D120} |
| L_{C44} | R^{D44} | R^{D44} | L_{C236} | R^{D1} | R^{D151} | L_{C428} | R^{D50} | R^{D37} | L_{C620} | R^{D144} | R^{D133} |
| L_{C45} | R^{D45} | R^{D45} | L_{C237} | R^{D1} | R^{D154} | L_{C429} | R^{D50} | R^{D40} | L_{C621} | R^{D144} | R^{D134} |
| L_{C46} | R^{D46} | R^{D46} | L_{C238} | R^{D1} | R^{D155} | L_{C430} | R^{D50} | R^{D41} | L_{C622} | R^{D144} | R^{D135} |
| L_{C47} | R^{D47} | R^{D47} | L_{C239} | R^{D1} | R^{D161} | L_{C431} | R^{D50} | R^{D42} | L_{C623} | R^{D144} | R^{D136} |
| L_{C48} | R^{D48} | R^{D48} | L_{C240} | R^{D1} | R^{D175} | L_{C432} | R^{D50} | R^{D43} | L_{C624} | R^{D144} | R^{D145} |
| L_{C49} | R^{D49} | R^{D49} | L_{C241} | R^{D4} | R^{D3} | L_{C433} | R^{D50} | R^{D48} | L_{C625} | R^{D144} | R^{D146} |
| L_{C50} | R^{D50} | R^{D50} | L_{C242} | R^{D4} | R^{D5} | L_{C434} | R^{D50} | R^{D49} | L_{C626} | R^{D144} | R^{D147} |
| L_{C51} | R^{D51} | R^{D51} | L_{C243} | R^{D4} | R^{D9} | L_{C435} | R^{D50} | R^{D54} | L_{C627} | R^{D144} | R^{D149} |
| L_{C52} | R^{D52} | R^{DS2} | L_{C244} | R^{D4} | R^{D10} | L_{C436} | R^{D50} | R^{D55} | L_{C628} | R^{D144} | R^{D151} |
| L_{C53} | R^{D53} | R^{D53} | L_{C245} | R^{D4} | R^{D17} | L_{C437} | R^{D50} | R^{D58} | L_{C629} | R^{D144} | R^{D154} |
| L_{C54} | R^{D54} | R^{D54} | L_{C246} | R^{D4} | R^{D18} | L_{C438} | R^{D50} | R^{D59} | L_{C630} | R^{D144} | R^{D155} |
| L_{C55} | R^{D55} | R^{D55} | L_{C247} | R^{D4} | R^{D20} | L_{C439} | R^{D50} | R^{D78} | L_{C631} | R^{D144} | R^{D161} |
| L_{C56} | R^{D56} | R^{D56} | L_{C248} | R^{D4} | R^{D22} | L_{C440} | R^{D50} | R^{D79} | L_{C632} | R^{D144} | R^{D175} |
| L_{C57} | R^{D57} | R^{D57} | L_{C249} | R^{D4} | R^{D37} | L_{C441} | R^{D50} | R^{D81} | L_{C633} | R^{D145} | R^{D3} |
| L_{C58} | R^{D58} | R^{D58} | L_{C250} | R^{D4} | R^{D40} | L_{C442} | R^{D50} | R^{D87} | L_{C634} | R^{D145} | R^{D5} |
| L_{C59} | R^{D59} | R^{D59} | L_{C251} | R^{D4} | R^{D41} | L_{C443} | R^{D50} | R^{D88} | L_{C635} | R^{D145} | R^{D17} |
| L_{C60} | R^{D60} | R^{D60} | L_{C252} | R^{D4} | R^{D42} | L_{C444} | R^{D50} | R^{D89} | L_{C636} | R^{D145} | R^{P18} |
| L_{C61} | R^{D61} | R^{D61} | L_{C253} | R^{D4} | R^{D43} | L_{C445} | R^{D50} | R^{D93} | L_{C637} | R^{D145} | R^{D20} |
| L_{C62} | R^{D62} | R^{D62} | L_{C254} | R^{D4} | R^{D48} | L_{C446} | R^{D50} | R^{D116} | L_{C638} | R^{D145} | R^{D22} |
| L_{C63} | R^{D63} | R^{D63} | L_{C255} | R^{D4} | R^{D49} | L_{C447} | R^{D50} | R^{D117} | L_{C639} | R^{D145} | R^{D37} |
| L_{C64} | R^{D64} | R^{D64} | L_{C256} | R^{D4} | R^{D50} | L_{C448} | R^{D50} | R^{D118} | L_{C640} | R^{D145} | R^{D40} |
| L_{C65} | R^{D65} | R^{D65} | L_{C257} | R^{D4} | R^{DS4} | L_{C449} | R^{D50} | R^{D119} | L_{C641} | R^{D145} | R^{D41} |
| L_{C66} | R^{D66} | R^{D66} | L_{C258} | R^{D4} | R^{D55} | L_{C450} | R^{D50} | R^{D120} | L_{C642} | R^{D145} | R^{D42} |
| L_{C67} | R^{D67} | R^{D67} | L_{C259} | R^{D4} | R^{D58} | L_{C451} | R^{D50} | R^{D133} | L_{C643} | R^{D145} | R^{D43} |
| L_{C68} | R^{D68} | R^{D68} | L_{C260} | R^{D4} | R^{D59} | L_{C452} | R^{D50} | R^{D134} | L_{C644} | R^{D145} | R^{D48} |
| L_{C69} | R^{D69} | R^{D69} | L_{C261} | R^{D4} | R^{D78} | L_{C453} | R^{D50} | R^{D135} | L_{C645} | R^{D145} | R^{D49} |
| L_{C70} | R^{D70} | R^{D70} | L_{C262} | R^{D4} | R^{D79} | L_{C454} | R^{D50} | R^{D136} | L_{C646} | R^{D145} | R^{D54} |
| L_{C71} | R^{D71} | R^{D71} | L_{C263} | R^{D4} | R^{D81} | L_{C455} | R^{D50} | R^{D143} | L_{C647} | R^{D145} | R^{D58} |
| L_{C72} | R^{D72} | R^{D72} | L_{C264} | R^{D4} | R^{D87} | L_{C456} | R^{D50} | R^{D144} | L_{C648} | R^{D145} | R^{D59} |
| L_{C73} | R^{D73} | R^{D73} | L_{C265} | R^{D4} | R^{D88} | L_{C457} | R^{D50} | R^{D145} | L_{C649} | R^{D145} | R^{D78} |
| L_{C74} | R^{D74} | R^{D74} | L_{C266} | R^{D4} | R^{D89} | L_{C458} | R^{D50} | R^{D146} | L_{C650} | R^{D145} | R^{D79} |
| L_{C75} | R^{D75} | R^{D75} | L_{C267} | R^{D4} | R^{D93} | L_{C459} | R^{D50} | R^{D147} | L_{C651} | R^{D145} | R^{D81} |
| L_{C76} | R^{D76} | R^{D76} | L_{C268} | R^{D4} | R^{D116} | L_{C460} | R^{D50} | R^{D149} | L_{C652} | R^{D145} | R^{D87} |
| L_{C77} | R^{D77} | R^{D77} | L_{C269} | R^{D4} | R^{D117} | L_{C461} | R^{D50} | R^{D151} | L_{C653} | R^{D145} | R^{D88} |
| L_{C78} | R^{D78} | R^{D78} | L_{C270} | R^{D4} | R^{D118} | L_{C462} | R^{D50} | R^{D154} | L_{C654} | R^{D145} | R^{D89} |
| L_{C79} | R^{D79} | R^{D79} | L_{C271} | R^{D4} | R^{D119} | L_{C463} | R^{D50} | R^{D155} | L_{C655} | R^{D145} | R^{D93} |
| L_{C80} | R^{D80} | R^{D80} | L_{C272} | R^{D4} | R^{D120} | L_{C464} | R^{D50} | R^{D161} | L_{C656} | R^{D145} | R^{D116} |
| L_{C81} | R^{D81} | R^{D81} | L_{C273} | R^{D4} | R^{D133} | L_{C465} | R^{D50} | R^{D175} | L_{C657} | R^{D145} | R^{D117} |
| L_{C82} | R^{D82} | R^{D82} | L_{C274} | R^{D4} | R^{D134} | L_{C466} | R^{D55} | R^{D3} | L_{C658} | R^{D145} | R^{D118} |
| L_{C83} | R^{D83} | R^{D83} | L_{C275} | R^{D4} | R^{D135} | L_{C467} | R^{D55} | R^{D5} | L_{C659} | R^{D145} | R^{D119} |
| L_{C84} | R^{D84} | R^{D84} | L_{C276} | R^{D4} | R^{D136} | L_{C468} | R^{D55} | R^{D18} | L_{C660} | R^{D145} | R^{D120} |
| L_{C84} | R^{D85} | R^{D85} | L_{C277} | R^{D4} | R^{D143} | L_{C469} | R^{D55} | R^{D20} | L_{C661} | R^{D145} | R^{D133} |
| L_{C86} | R^{D86} | R^{D86} | L_{C278} | R^{D4} | R^{D144} | L_{C470} | R^{D55} | R^{D22} | L_{C662} | R^{D145} | R^{D134} |
| L_{C87} | R^{D87} | R^{D87} | L_{C279} | R^{D4} | R^{D145} | L_{C471} | R^{D55} | R^{D37} | L_{C663} | R^{D145} | R^{D135} |
| L_{C88} | R^{D88} | R^{D88} | L_{C280} | R^{D4} | R^{D146} | L_{C472} | R^{D55} | R^{D40} | L_{C664} | R^{D145} | R^{D136} |
| L_{C89} | R^{D89} | R^{D89} | L_{C281} | R^{D4} | R^{D147} | L_{C473} | R^{D55} | R^{D41} | L_{C665} | R^{D145} | R^{D146} |
| L_{C90} | R^{D90} | R^{D90} | L_{C282} | R^{D4} | R^{D149} | L_{C474} | R^{D55} | R^{D42} | L_{C666} | R^{D145} | R^{D147} |
| L_{C91} | R^{D91} | R^{D91} | L_{C283} | R^{D4} | R^{D151} | L_{C475} | R^{D55} | R^{P43} | L_{C667} | R^{D145} | R^{D149} |
| L_{C92} | R^{D92} | R^{D92} | L_{C284} | R^{D4} | R^{D154} | L_{C476} | R^{D55} | R^{D48} | L_{C668} | R^{D145} | R^{D151} |
| L_{C93} | R^{D93} | R^{D93} | L_{C285} | R^{D4} | R^{D155} | L_{C477} | R^{D55} | R^{D49} | L_{C669} | R^{D145} | R^{D154} |
| L_{C94} | R^{D94} | R^{D94} | L_{C286} | R^{D4} | R^{D161} | L_{C478} | R^{D55} | R^{D54} | L_{C670} | R^{D145} | R^{D155} |
| L_{C95} | R^{D95} | R^{D95} | L_{C287} | R^{D4} | R^{D175} | L_{C479} | R^{D55} | R^{D58} | L_{C671} | R^{D145} | R^{D161} |
| L_{C96} | R^{D96} | R^{D96} | L_{C288} | R^{D9} | R^{D3} | L_{C480} | R^{D55} | R^{D59} | L_{C672} | R^{D145} | R^{D175} |
| L_{C97} | R^{D97} | R^{D97} | L_{C289} | R^{D9} | R^{D5} | L_{C481} | R^{D55} | R^{D78} | L_{C673} | R^{D146} | R^{D3} |
| L_{C98} | R^{D98} | R^{D98} | L_{C290} | R^{D9} | R^{D10} | L_{C482} | R^{D55} | R^{D79} | L_{C674} | R^{D146} | R^{D5} |
| L_{C99} | R^{D99} | R^{D99} | L_{C291} | R^{D9} | R^{D17} | L_{C483} | R^{D55} | R^{D81} | L_{C675} | R^{D146} | R^{D17} |
| L_{C100} | R^{D100} | R^{D100} | L_{C292} | R^{D9} | R^{D18} | L_{C484} | R^{D55} | R^{D87} | L_{C676} | R^{D146} | R^{D18} |
| L_{C101} | R^{D101} | R^{D101} | L_{C293} | R^{D9} | R^{P20} | L_{C485} | R^{D55} | R^{D88} | L_{C677} | R^{D146} | R^{D20} |
| L_{C102} | R^{D102} | R^{D102} | L_{C294} | R^{D9} | R^{D22} | L_{C486} | R^{D55} | R^{D89} | L_{C678} | R^{D146} | R^{D22} |
| L_{C103} | R^{D103} | R^{D103} | L_{C295} | R^{D9} | R^{D37} | L_{C487} | R^{D55} | R^{D93} | L_{C679} | R^{D146} | R^{D37} |
| L_{C104} | R^{D104} | R^{D104} | L_{C296} | R^{D9} | R^{D40} | L_{C488} | R^{D55} | R^{D116} | L_{C680} | R^{D146} | R^{D40} |
| L_{C105} | R^{D105} | R^{D105} | L_{C297} | R^{D9} | R^{D41} | L_{C489} | R^{D55} | R^{D117} | L_{C681} | R^{D146} | R^{D41} |
| L_{C106} | R^{D106} | R^{D106} | L_{C298} | R^{D9} | R^{D42} | L_{C490} | R^{D55} | R^{D118} | L_{C682} | R^{D146} | R^{D42} |
| L_{C107} | R^{D107} | R^{D107} | L_{C299} | R^{D9} | R^{D43} | L_{C491} | R^{D55} | R^{D119} | L_{C683} | R^{D146} | R^{D43} |
| L_{C108} | R^{D108} | R^{D108} | L_{C300} | R^{D9} | R^{D48} | L_{C492} | R^{D55} | R^{D120} | L_{C684} | R^{D146} | R^{D48} |
| L_{C109} | R^{D109} | R^{D109} | L_{C301} | R^{D9} | R^{D49} | L_{C493} | R^{D55} | R^{D133} | L_{C685} | R^{D146} | R^{D49} |
| L_{C110} | R^{D110} | R^{D110} | L_{C302} | R^{D9} | R^{D50} | L_{C494} | R^{D55} | R^{D134} | L_{C686} | R^{D146} | R^{D54} |
| L_{C111} | R^{D111} | R^{D111} | L_{C303} | R^{D9} | R^{D54} | L_{C495} | R^{D55} | R^{D135} | L_{C687} | R^{D146} | R^{D58} |
| L_{C112} | R^{D112} | R^{D112} | L_{C304} | R^{D9} | R^{D55} | L_{C496} | R^{D55} | R^{D136} | L_{C688} | R^{D146} | R^{D59} |
| L_{C113} | R^{D113} | R^{D113} | L_{C305} | R^{D9} | R^{D58} | L_{C497} | R^{D55} | R^{D143} | L_{C689} | R^{D146} | R^{D78} |
| L_{C114} | R^{D114} | R^{D114} | L_{C306} | R^{D9} | R^{D59} | L_{C498} | R^{D55} | R^{D144} | L_{C690} | R^{D146} | R^{D79} |
| L_{C115} | R^{D115} | R^{D115} | L_{C307} | R^{D9} | R^{D78} | L_{C499} | R^{D55} | R^{D145} | L_{C691} | R^{D146} | R^{D81} |
| L_{C116} | R^{D116} | R^{D116} | L_{C308} | R^{D9} | R^{D79} | L_{C500} | R^{D55} | R^{D146} | L_{C692} | R^{D146} | R^{D87} |
| L_{C117} | R^{D117} | R^{D117} | L_{C309} | R^{D9} | R^{D81} | L_{C501} | R^{D55} | R^{D147} | L_{C693} | R^{D146} | R^{D88} |
| L_{C118} | R^{D118} | R^{D118} | L_{C310} | R^{D9} | R^{D87} | L_{C502} | R^{D55} | R^{D149} | L_{C694} | R^{D146} | R^{D59} |
| L_{C119} | R^{D119} | R^{D119} | L_{C311} | R^{D9} | R^{D88} | L_{C503} | R^{D55} | R^{D151} | L_{C695} | R^{D146} | R^{D93} |
| L_{C120} | R^{D120} | R^{D120} | L_{C312} | R^{D9} | R^{D89} | L_{C504} | R^{D55} | R^{D154} | L_{C696} | R^{D146} | R^{D117} |
| L_{C121} | R^{D121} | R^{D121} | L_{C313} | R^{D9} | R^{D93} | L_{C505} | R^{D55} | R^{D155} | L_{C697} | R^{D146} | R^{D118} |
| L_{C122} | R^{D122} | R^{D122} | L_{C314} | R^{D9} | R^{D116} | L_{C506} | R^{D55} | R^{D161} | L_{C698} | R^{D146} | R^{D119} |
| L_{C123} | R^{D123} | R^{D123} | L_{C315} | R^{D9} | R^{D117} | L_{C507} | R^{D55} | R^{D175} | L_{C699} | R^{D146} | R^{D120} |
| L_{C124} | R^{D124} | R^{D124} | L_{C316} | R^{D9} | R^{D118} | L_{C508} | R^{D116} | R^{D3} | L_{C700} | R^{D146} | R^{D133} |
| L_{C125} | R^{D125} | R^{D125} | L_{C317} | R^{D9} | R^{D119} | L_{C509} | R^{D116} | R^{D5} | L_{C701} | R^{D146} | R^{D134} |
| L_{C126} | R^{D126} | R^{D126} | L_{C318} | R^{D9} | R^{D120} | L_{C510} | R^{D116} | R^{D17} | L_{C702} | R^{D146} | R^{D135} |
| L_{C127} | R^{D127} | R^{D127} | L_{C319} | R^{D9} | R^{D133} | L_{C511} | R^{D116} | R^{D18} | L_{C703} | R^{D146} | R^{D136} |
| L_{C128} | R^{D128} | R^{D128} | L_{C320} | R^{D9} | R^{D134} | L_{C512} | R^{D116} | R^{D20} | L_{C704} | R^{D146} | R^{D146} |
| L_{C129} | R^{D129} | R^{D129} | L_{C321} | R^{D9} | R^{D135} | L_{C513} | R^{D116} | R^{D22} | L_{C705} | R^{D146} | R^{D147} |
| L_{C130} | R^{D130} | R^{D130} | L_{C322} | R^{D9} | R^{D136} | L_{C514} | R^{D116} | R^{D37} | L_{C706} | R^{D146} | R^{D149} |
| L_{C131} | R^{D131} | R^{D131} | L_{C323} | R^{D9} | R^{D143} | L_{C515} | R^{D116} | R^{D40} | L_{C707} | R^{D146} | R^{D151} |
| L_{C132} | R^{D132} | R^{D132} | L_{C324} | R^{D9} | R^{D144} | L_{C516} | R^{D116} | R^{D41} | L_{C708} | R^{D146} | R^{D154} |
| L_{C133} | R^{D133} | R^{D133} | L_{C325} | R^{D9} | R^{D145} | L_{C517} | R^{D116} | R^{D42} | L_{C709} | R^{D146} | R^{D155} |
| L_{C134} | R^{D134} | R^{D134} | L_{C326} | R^{D9} | R^{D146} | L_{C518} | R^{D116} | R^{D43} | L_{C710} | R^{D146} | R^{D161} |
| L_{C135} | R^{D135} | R^{D135} | L_{C327} | R^{D9} | R^{D147} | L_{C519} | R^{D116} | R^{D48} | L_{C711} | R^{D146} | R^{D175} |
| L_{C136} | R^{D136} | R^{D136} | L_{C328} | R^{D9} | R^{D149} | L_{C520} | R^{D116} | R^{D49} | L_{C712} | R^{D133} | R^{D3} |
| L_{C137} | R^{D137} | R^{D137} | L_{C329} | R^{D9} | R^{D151} | L_{C521} | R^{D116} | R^{D54} | L_{C713} | R^{D133} | R^{D5} |
| L_{C138} | R^{D138} | R^{D138} | L_{C330} | R^{D9} | R^{D154} | L_{C522} | R^{D116} | R^{D58} | L_{C714} | R^{D133} | R^{D3} |
| L_{C139} | R^{D139} | R^{D139} | L_{C331} | R^{D9} | R^{D155} | L_{C523} | R^{D116} | R^{D59} | L_{C715} | R^{D133} | R^{D18} |
| L_{C140} | R^{D140} | R^{D140} | L_{C332} | R^{D9} | R^{D161} | L_{C524} | R^{D116} | R^{D78} | L_{C716} | R^{D133} | R^{D20} |
| L_{C141} | R^{D141} | R^{D141} | L_{C333} | R^{D9} | R^{D175} | L_{C525} | R^{D116} | R^{D79} | L_{C717} | R^{D133} | R^{D22} |
| L_{C142} | R^{D142} | R^{D142} | L_{C334} | R^{D10} | R^{D3} | L_{C526} | R^{D116} | R^{D81} | L_{C718} | R^{D133} | R^{D37} |
| L_{C143} | R^{D143} | R^{D143} | L_{C335} | R^{D10} | R^{D5} | L_{C527} | R^{D116} | R^{D87} | L_{C719} | R^{D133} | R^{D40} |
| L_{C144} | R^{D144} | R^{D144} | L_{C336} | R^{D10} | R^{D17} | L_{C528} | R^{D116} | R^{D88} | L_{C720} | R^{D133} | R^{D41} |
| L_{C145} | R^{D145} | R^{D145} | L_{C337} | R^{D10} | R^{D18} | L_{C529} | R^{D116} | R^{D89} | L_{C721} | R^{D133} | R^{D42} |
| L_{C146} | R^{D146} | R^{D146} | L_{C338} | R^{D10} | R^{D20} | L_{C530} | R^{D116} | R^{D93} | L_{C722} | R^{D133} | R^{D43} |
| L_{C147} | R^{D147} | R^{D147} | L_{C339} | R^{D10} | R^{D22} | L_{C531} | R^{D116} | R^{D117} | L_{C723} | R^{D133} | R^{D48} |
| L_{C148} | R^{D148} | R^{D148} | L_{C340} | R^{D10} | R^{D37} | L_{C532} | R^{D116} | R^{D118} | L_{C724} | R^{D133} | R^{D49} |
| L_{C149} | R^{D149} | R^{D149} | L_{C341} | R^{D10} | R^{D40} | L_{C533} | R^{D116} | R^{D119} | L_{C725} | R^{D133} | R^{D54} |
| L_{C150} | R^{D150} | R^{D150} | L_{C342} | R^{D10} | R^{D41} | L_{C534} | R^{D116} | R^{D120} | L_{C726} | R^{D133} | R^{D58} |
| L_{C151} | R^{D151} | R^{D151} | L_{C343} | R^{D10} | R^{D42} | L_{C535} | R^{D116} | R^{D133} | L_{C727} | R^{D133} | R^{D59} |
| L_{C152} | R^{D152} | R^{D152} | L_{C344} | R^{D10} | R^{D43} | L_{C536} | R^{D116} | R^{D134} | L_{C728} | R^{D133} | R^{D78} |
| L_{C153} | R^{D153} | R^{D153} | L_{C345} | R^{D10} | R^{D48} | L_{C537} | R^{D116} | R^{D135} | L_{C729} | R^{D133} | R^{D79} |
| L_{C154} | R^{D154} | R^{D154} | L_{C346} | R^{D10} | R^{D49} | L_{C538} | R^{D116} | R^{D136} | L_{C730} | R^{D133} | R^{D81} |
| L_{C155} | R^{D155} | R^{D155} | L_{C347} | R^{D10} | R^{D50} | L_{C539} | R^{D116} | R^{D143} | L_{C731} | R^{D133} | R^{D87} |
| L_{C156} | R^{D156} | R^{D156} | L_{C348} | R^{D10} | R^{D54} | L_{C540} | R^{D116} | R^{D144} | L_{C732} | R^{D133} | R^{D88} |
| L_{C157} | R^{D157} | R^{D157} | L_{C349} | R^{D10} | R^{D55} | L_{C541} | R^{D116} | R^{D145} | L_{C733} | R^{D133} | R^{D89} |
| L_{C158} | R^{D158} | R^{D158} | L_{C350} | R^{D10} | R^{D58} | L_{C542} | R^{D116} | R^{D146} | L_{C734} | R^{D133} | R^{D93} |
| L_{C159} | R^{D159} | R^{D159} | L_{C351} | R^{D10} | R^{D59} | L_{C543} | R^{D116} | R^{D147} | L_{C735} | R^{D133} | R^{D117} |
| L_{C160} | R^{D160} | R^{D160} | L_{C352} | R^{D10} | R^{D78} | L_{C544} | R^{D116} | R^{D149} | L_{C736} | R^{D133} | R^{D118} |
| L_{C161} | R^{D161} | R^{D161} | L_{C353} | R^{D10} | R^{D79} | L_{C545} | R^{D116} | R^{D151} | L_{C737} | R^{D133} | R^{D119} |
| L_{C162} | R^{D162} | R^{D162} | L_{C354} | R^{D10} | R^{D81} | L_{C546} | R^{D116} | R^{D154} | L_{C738} | R^{D133} | R^{D120} |
| L_{C163} | R^{D163} | R^{D163} | L_{C355} | R^{D10} | R^{D87} | L_{C547} | R^{D116} | R^{D155} | L_{C739} | R^{D133} | R^{D133} |
| L_{C164} | R^{D164} | R^{D164} | L_{C356} | R^{D10} | R^{D88} | L_{C548} | R^{D116} | R^{D161} | L_{C740} | R^{D133} | R^{D134} |
| L_{C165} | R^{D165} | R^{D165} | L_{C357} | R^{D10} | R^{D89} | L_{C549} | R^{D116} | R^{D175} | L_{C741} | R^{D133} | R^{D135} |
| L_{C166} | R^{D166} | R^{D166} | L_{C358} | R^{D10} | R^{D93} | L_{C550} | R^{D143} | R^{D3} | L_{C742} | R^{D133} | R^{D136} |
| L_{C167} | R^{D167} | R^{D167} | L_{C359} | R^{D10} | R^{D116} | L_{C551} | R^{D143} | R^{D5} | L_{C743} | R^{D133} | R^{D146} |
| L_{C168} | R^{D168} | R^{D168} | L_{C360} | R^{D10} | R^{D117} | L_{C552} | R^{D143} | R^{D17} | L_{C744} | R^{D133} | R^{D147} |
| L_{C169} | R^{D169} | R^{D169} | L_{C361} | R^{D10} | R^{D118} | L_{C553} | R^{D143} | R^{D18} | L_{C745} | R^{D133} | R^{D149} |
| L_{C170} | R^{D170} | R^{D170} | L_{C362} | R^{D10} | R^{D119} | L_{C554} | R^{D143} | R^{D20} | L_{C746} | R^{D133} | R^{D151} |
| L_{C171} | R^{D171} | R^{D171} | L_{C363} | R^{D10} | R^{D120} | L_{C555} | R^{D143} | R^{D22} | L_{C747} | R^{D133} | R^{D154} |
| L_{C172} | RP¹⁷² | R^{D172} | L_{C364} | R^{D10} | R^{D133} | L_{C556} | R^{D143} | R^{D37} | L_{C748} | R^{D133} | R^{D155} |
| L_{C173} | R^{D173} | R^{D173} | L_{C365} | R^{D10} | R^{D134} | L_{C557} | R^{D143} | R^{D40} | L_{C749} | R^{D133} | R^{D161} |
| L_{C174} | R^{D174} | R^{D174} | L_{C366} | R^{D10} | R^{D135} | L_{C558} | R^{D143} | R^{D41} | L_{C750} | R^{D133} | R^{D175} |
| L_{C175} | R^{D175} | R^{D175} | L_{C367} | R^{D10} | R^{D136} | L_{C559} | R^{D143} | R^{D42} | L_{C751} | R^{D175} | R^{D3} |
| L_{C176} | R^{D176} | R^{D176} | L_{C368} | R^{D10} | R^{D143} | L_{C560} | R^{D143} | R^{D43} | L_{C752} | R^{D175} | R^{D5} |
| L_{C177} | RP¹⁷⁷ | R^{D177} | L_{C369} | R^{D10} | R^{D144} | L_{C561} | R^{D143} | R^{D48} | L_{C753} | R^{D175} | R^{D18} |
| L_{C178} | R^{D178} | R^{D178} | L_{C370} | R^{D10} | R^{D145} | L_{C562} | R^{D143} | R^{D49} | L_{C754} | R^{D175} | R^{D20} |
| L_{C179} | R^{D179} | R^{D179} | L_{C371} | R^{D10} | R^{D146} | L_{C563} | R^{D143} | R^{D54} | L_{C755} | R^{D175} | R^{D22} |
| L_{C180} | R^{D180} | R^{D180} | L_{C372} | R^{D10} | R^{D147} | L_{C564} | R^{D143} | R^{D58} | L_{C756} | R^{D175} | R^{D37} |
| L_{C181} | R^{D181} | R^{D181} | L_{C373} | R^{D10} | R^{D149} | L_{C565} | R^{D143} | R^{D59} | L_{C757} | R^{D175} | R^{D40} |
| L_{C182} | R^{D182} | R^{D182} | L_{C374} | R^{D10} | R^{D151} | L_{C566} | R^{D143} | R^{D78} | L_{C758} | R^{D175} | R^{D41} |
| L_{C183} | R^{D183} | R^{D183} | L_{C375} | R^{D10} | R^{D154} | L_{C567} | R^{D143} | R^{D79} | L_{C759} | R^{D175} | R^{D42} |
| L_{C184} | R^{D184} | R^{D184} | L_{C376} | R^{D10} | R^{D155} | L_{C568} | R^{D143} | R^{D81} | L_{C760} | RD¹⁷⁵ | R^{D43} |
| L_{C185} | R^{D185} | R^{D185} | L_{C377} | R^{D10} | R^{D161} | L_{C569} | R^{D143} | R^{D87} | L_{C761} | R^{D175} | R^{D48} |
| L_{C186} | R^{D186} | R^{D186} | L_{C378} | R^{D10} | R^{D175} | L_{C570} | R^{D143} | R^{D88} | L_{C762} | R^{D175} | R^{D49} |
| L_{C187} | R^{D187} | R^{D187} | L_{C379} | R^{D17} | R^{D3} | L_{C571} | R^{D143} | R^{D89} | L_{C763} | R^{D175} | R^{D54} |
| L_{C188} | R^{D188} | R^{D188} | L_{C380} | R^{D17} | R^{D5} | L_{C572} | R^{D143} | R^{D93} | L_{C764} | R^{D175} | R^{D58} |
| L_{C189} | R^{D189} | R^{D189} | L_{C381} | R^{D17} | R^{D18} | L_{C573} | R^{D143} | R^{D116} | L_{C765} | R^{D175} | R^{D59} |
| L_{C190} | R^{D190} | R^{D190} | L_{C382} | R^{D17} | R^{D20} | L_{C574} | R^{D143} | R^{D117} | L_{C766} | R^{D175} | R^{D78} |
| L_{C191} | R^{D191} | R^{D191} | L_{C383} | R^{D17} | R^{D22} | L_{C575} | R^{D143} | R^{D118} | L_{C767} | R^{D175} | R^{D79} |
| L_{C192} | R^{D192} | R^{D192} | L_{C384} | R^{D17} | R^{D37} | L_{C576} | R^{D143} | R^{D119} | L_{C768} | R^{D175} | R^{D81} |
| L_{C769} | R^{D193} | R^{D193} | L_{C877} | R^{D1} | R^{D193} | L_{C985} | R^{D4} | R^{D193} | L_{C1093} | R^{D9} | R^{D193} |
| L_{C770} | R^{D194} | R^{D194} | L_{C878} | R^{D1} | R^{D194} | L_{C986} | R^{D4} | R^{D194} | L_{C1094} | R^{D9} | R^{D194} |
| L_{C771} | R^{D195} | R^{D195} | L_{C879} | R^{D1} | R^{D195} | L_{C987} | R^{D4} | R^{D195} | L_{C1095} | R^{D9} | R^{D195} |
| L_{C772} | R^{D196} | R^{D196} | L_{C880} | R^{D1} | R^{D196} | L_{C988} | R^{D4} | R^{D196} | L_{C1096} | R^{D9} | R^{D196} |
| L_{C773} | R^{D197} | R^{D197} | L_{C881} | R^{D1} | R^{D197} | L_{C989} | R^{D4} | R^{D197} | L_{C1097} | R^{D9} | R^{D197} |
| L_{C774} | R^{D198} | R^{D198} | L_{C882} | R^{D1} | R^{D198} | L_{C990} | R^{D4} | R^{D198} | L_{C1098} | R^{D9} | R^{D198} |
| L_{C775} | R^{D199} | R^{D199} | L_{C883} | R^{D1} | R^{D199} | L_{C991} | R^{D4} | R^{D199} | L_{C1099} | R^{D9} | R^{D199} |
| L_{C776} | R^{D200} | R^{D200} | L_{C884} | R^{D1} | R^{D200} | L_{C992} | R^{D4} | R^{D200} | L_{C1100} | R^{D9} | R^{D200} |
| L_{C777} | R^{D201} | R^{D201} | L_{C885} | R^{D1} | R^{D201} | L_{C993} | R^{D4} | R^{D201} | L_{C1101} | R^{D9} | R^{D201} |
| L_{C778} | R^{D202} | R^{D202} | L_{C886} | R^{D1} | R^{D202} | L_{C994} | R^{D4} | R^{D202} | L_{C1102} | R^{D9} | R^{D202} |
| L_{C779} | R^{D203} | R^{D203} | L_{C887} | R^{D1} | R^{D203} | L_{C995} | R^{D4} | R^{D203} | L_{C1103} | R^{D9} | R^{D203} |
| L_{C780} | R^{D204} | R^{D204} | L_{C888} | R^{D1} | R^{D204} | L_{C996} | R^{D4} | R^{D204} | L_{C1104} | R^{D9} | R^{D204} |
| L_{C781} | R^{D205} | R^{D205} | L_{C889} | R^{D1} | R^{D205} | L_{C997} | R^{D4} | R^{D205} | L_{C1105} | R^{D9} | R^{D205} |
| L_{C782} | R^{D206} | R^{D206} | L_{C890} | R^{D1} | R^{D206} | L_{C998} | R^{D4} | R^{D206} | L_{C1106} | R^{D9} | R^{D206} |
| L_{C783} | R^{D207} | R^{D207} | L_{C891} | R^{D1} | R^{D207} | L_{C999} | R^{D4} | R^{D207} | L_{C1107} | R^{D9} | R^{D207} |
| L_{C784} | R^{D208} | R^{D208} | L_{C892} | R^{D1} | R^{D208} | L_{C1000} | R^{D4} | R^{D208} | L_{C1108} | R^{D9} | R^{D208} |
| L_{C785} | R^{D209} | R^{D209} | L_{C893} | R^{D1} | R^{D209} | L_{C1001} | R^{D4} | R^{D209} | L_{C1109} | R^{D9} | R^{D209} |
| L_{C786} | R^{D210} | R^{D210} | L_{C894} | R^{D1} | R^{D210} | L_{C1002} | R^{D4} | R^{D210} | L_{C1110} | R^{D9} | R^{D210} |
| L_{C787} | R^{D211} | R^{D211} | L_{C895} | R^{D1} | R^{D211} | L_{C1003} | R^{D4} | R^{D211} | L_{C1111} | R^{D9} | R^{D211} |
| L_{C788} | R^{D212} | R^{D212} | L_{C896} | R^{D1} | R^{D212} | L_{C1004} | R^{D4} | R^{D212} | L_{C1112} | R^{D9} | R^{D212} |
| L_{C789} | R^{D213} | R^{D213} | L_{C897} | R^{D1} | R^{D213} | L_{C1005} | R^{D4} | R^{D213} | L_{C1113} | R^{D9} | R^{D213} |
| L_{C790} | R^{D214} | R^{D214} | L_{C898} | R^{D1} | R^{D214} | L_{C1006} | R^{D4} | R^{D214} | L_{C1114} | R^{D9} | R^{D214} |
| L_{C791} | R^{D215} | R^{D215} | L_{C899} | R^{D1} | R^{D215} | L_{C1007} | R^{D4} | R^{D215} | L_{C1115} | R^{D9} | R^{D215} |
| L_{C792} | R^{D216} | R^{D216} | L_{C900} | R^{D1} | R^{D216} | L_{C1008} | R^{D4} | R^{D216} | L_{C1116} | R^{D9} | R^{D216} |
| L_{C793} | R^{D217} | R^{D217} | L_{C901} | R^{D1} | R^{D217} | L_{C1009} | R^{D4} | R^{D217} | L_{C1117} | R^{D9} | R^{D217} |
| L_{C794} | R^{D218} | R^{D218} | L_{C902} | R^{D1} | R^{D218} | L_{C1010} | R^{D4} | R^{D218} | L_{C1118} | R^{D9} | R^{D218} |
| L_{C795} | R^{D219} | R^{D219} | L_{C903} | R^{D1} | R^{D219} | L_{C1011} | R^{D4} | R^{D219} | L_{C1119} | R^{D9} | R^{D219} |
| L_{C796} | R^{D220} | R^{D220} | L_{C904} | R^{D1} | R^{D220} | L_{C1012} | R^{D4} | R^{D220} | L_{C1120} | R^{D9} | R^{D220} |
| L_{C797} | R^{D221} | R^{D221} | L_{C905} | R^{D1} | R^{D221} | L_{C1013} | R^{D4} | R^{D221} | L_{C1121} | R^{D9} | R^{D221} |
| L_{C798} | R^{D222} | R^{D222} | L_{C906} | R^{D1} | R^{D222} | L_{C1014} | R^{D4} | R^{D222} | L_{C1122} | R^{D9} | R^{D222} |
| L_{C799} | R^{D223} | R^{D223} | L_{C907} | R^{D1} | R^{D223} | L_{C1015} | R^{D4} | R^{D223} | L_{C1123} | R^{D9} | R^{D223} |
| L_{C800} | R^{D224} | R^{D224} | L_{C908} | R^{D1} | R^{D224} | L_{C1016} | R^{D4} | R^{D224} | L_{C1124} | R^{D9} | R^{D224} |
| L_{C801} | R^{D225} | R^{D225} | L_{C909} | R^{D1} | R^{D225} | L_{C1017} | R^{D4} | R^{D225} | L_{C1125} | R^{D9} | R^{D225} |
| L_{C802} | R^{D226} | R^{D226} | L_{C910} | R^{D1} | R^{D226} | L_{C1018} | R^{D4} | R^{D226} | L_{C1126} | R^{D9} | R^{D226} |
| L_{C803} | R^{D227} | R^{D227} | L_{C911} | R^{D1} | R^{D227} | L_{C1019} | R^{D4} | R^{D227} | L_{C1127} | R^{D9} | R^{D227} |
| L_{C804} | R^{D228} | R^{D228} | L_{C912} | R^{D1} | R^{D228} | L_{C1020} | R^{D4} | R^{D228} | L_{C1128} | R^{D9} | R^{D228} |
| L_{C805} | R^{D229} | R^{D229} | L_{C913} | R^{D1} | R^{D229} | L_{C1021} | R^{D4} | R^{D229} | L_{C1129} | R^{D9} | R^{D229} |
| L_{C806} | R^{D230} | R^{D230} | L_{C914} | R^{D1} | R^{D230} | L_{C1022} | R^{D4} | R^{D230} | L_{C1130} | R^{D9} | R^{D230} |
| L_{C807} | R^{D231} | R^{D231} | L_{C915} | R^{D1} | R^{D231} | L_{C1023} | R^{D4} | R^{D231} | L_{C1131} | R^{D9} | R^{D231} |
| L_{C808} | R^{D232} | R^{D232} | L_{C916} | R^{D1} | R^{D232} | L_{C1024} | R^{D4} | R^{D232} | L_{C1132} | R^{D9} | R^{D232} |
| L_{C809} | R^{D233} | R^{D233} | L_{C917} | R^{D1} | R^{D233} | L_{C1025} | R^{D4} | R^{P233} | L_{C1133} | R^{D9} | R^{D233} |
| L_{C810} | R^{D234} | R^{D234} | L_{C918} | R^{D1} | R^{D234} | L_{C1026} | R^{D4} | R^{D234} | L_{C1134} | R^{D9} | R^{D234} |
| L_{C811} | R^{D235} | R^{D235} | L_{C919} | R^{D1} | R^{D235} | L_{C1027} | R^{D4} | R^{D235} | L_{C1135} | R^{D9} | R^{D235} |
| L_{C812} | R^{D236} | R^{D236} | L_{C920} | R^{D1} | R^{D236} | L_{C1028} | R^{D4} | R^{D236} | L_{C1136} | R^{D9} | R^{D236} |
| L_{C813} | R^{D237} | R^{D237} | L_{C921} | R^{D1} | R^{D237} | L_{C1029} | R^{D4} | R^{D237} | L_{C1137} | R^{D9} | R^{D237} |
| L_{C814} | R^{D238} | R^{D238} | L_{C922} | R^{D1} | R^{D238} | L_{C1030} | R^{D4} | R^{D238} | L_{C1138} | R^{D9} | R^{D238} |
| L_{C815} | R^{D239} | R^{D239} | L_{C923} | R^{D1} | R^{D239} | L_{C1031} | R^{D4} | R^{D239} | L_{C1139} | R^{D9} | R^{D239} |
| L_{C816} | R^{D240} | R^{D240} | L_{C924} | R^{D1} | R^{D240} | L_{C1032} | R^{D4} | R^{D240} | L_{C1140} | R^{D9} | R^{D240} |
| L_{C817} | R^{D241} | R^{D241} | L_{C925} | R^{D1} | R^{D241} | L_{C1033} | R^{D4} | R^{D241} | L_{C1141} | R^{D9} | R^{D241} |
| L_{C818} | R^{D242} | R^{D242} | L_{C926} | R^{D1} | R^{D242} | L_{C1034} | R^{D4} | R^{D242} | L_{C1142} | R^{D9} | R^{D242} |
| L_{C819} | R^{D243} | R^{D243} | L_{C927} | R^{D1} | R^{D243} | L_{C1035} | R^{D4} | R^{D243} | L_{C1143} | R^{D9} | R^{D243} |
| L_{C820} | R^{D244} | R^{D244} | L_{C928} | R^{D1} | R^{D244} | L_{C1036} | R^{D4} | R^{D244} | L_{C1144} | R^{D9} | R^{D244} |
| L_{C821} | R^{D245} | R^{D245} | L_{C929} | R^{D1} | R^{D245} | L_{C1037} | R^{D4} | R^{D245} | L_{C1145} | R^{D9} | R^{D245} |
| L_{C822} | R^{D246} | R^{D246} | L_{C930} | R^{D1} | R^{D246} | L_{C1038} | R^{D4} | R^{D246} | L_{C1146} | R^{D9} | R^{D246} |
| L_{C823} | R^{D17} | R^{D193} | L_{C931} | R^{D50} | R^{D193} | L_{C1039} | R^{D145} | R^{D193} | L_{C1147} | R^{D168} | R^{D193} |
| L_{C824} | R^{D17} | R^{D194} | L_{C932} | R^{D50} | R^{D194} | L_{C1040} | R^{D145} | R^{D194} | L_{C1148} | R^{D168} | R^{D194} |
| L_{C825} | R^{D17} | R^{D195} | L_{C933} | R^{D50} | R^{D195} | L_{C1041} | R^{D145} | R^{D195} | L_{C1149} | R^{D168} | R^{D195} |
| L_{C826} | R^{D17} | R^{D196} | L_{C934} | R^{D50} | R^{D196} | L_{C1042} | R^{D145} | R^{D196} | L_{C1150} | R^{D168} | R^{D196} |
| L_{C827} | R^{D17} | R^{D197} | L_{C935} | R^{D50} | R^{D197} | L_{C1043} | R^{D145} | R^{D197} | L_{C1151} | R^{D168} | R^{D197} |
| L_{C828} | R^{D17} | R^{D198} | L_{C936} | R^{D50} | R^{D198} | L_{C1044} | R^{D145} | R^{D198} | L_{C1152} | R^{D168} | R^{D198} |
| L_{C829} | R^{D17} | R^{D199} | L_{C937} | R^{D50} | R^{D199} | L_{C1045} | R^{D145} | R^{D199} | L_{C1153} | R^{D168} | R^{D199} |
| L_{C830} | R^{D17} | R^{D200} | L_{C938} | R^{D50} | R^{D200} | L_{C1046} | R^{D145} | R^{D200} | L_{C1154} | R^{D168} | R^{D200} |
| L_{C831} | R^{D17} | R^{D201} | L_{C939} | R^{D50} | R^{D201} | L_{C1047} | R^{D145} | R^{D201} | L_{C1155} | R^{D168} | R^{D201} |
| L_{C832} | R^{D17} | R^{D202} | L_{C940} | R^{D50} | R^{D202} | L_{C1048} | R^{D145} | R^{D202} | L_{C1156} | R^{D168} | R^{D202} |
| L_{C833} | R^{D17} | R^{D203} | L_{C941} | R^{D50} | R^{D203} | L_{C1049} | R^{D145} | R^{D203} | L_{C1157} | R^{D168} | R^{D203} |
| L_{C834} | R^{D17} | R^{D204} | L_{C942} | R^{D50} | R^{D204} | L_{C1050} | R^{D145} | R^{D204} | L_{C1158} | R^{D168} | R^{D204} |
| L_{C835} | R^{D17} | R^{D205} | L_{C943} | R^{D50} | R^{D205} | L_{C1051} | R^{D145} | R^{D205} | L_{C1159} | R^{D168} | R^{D205} |
| L_{C836} | R^{D17} | R^{D206} | L_{C944} | R^{D50} | R^{D206} | L_{C1052} | R^{D145} | R^{D206} | L_{C1160} | R^{D168} | R^{D206} |
| L_{C837} | R^{D17} | R^{D207} | L_{C945} | R^{D50} | R^{D207} | L_{C1053} | R^{D145} | R^{D207} | L_{C1161} | R^{D168} | R^{D207} |
| L_{C838} | R^{D17} | R^{D208} | L_{C946} | R^{D50} | R^{D208} | L_{C1054} | R^{D145} | R^{D208} | L_{C1162} | R^{D168} | R^{D208} |
| L_{C839} | R^{D17} | R^{D209} | L_{C947} | R^{D50} | R^{D209} | L_{C1055} | R^{D145} | R^{D209} | L_{C1163} | R^{D168} | R^{D209} |
| L_{C840} | R^{D17} | R^{D210} | L_{C948} | R^{D50} | R^{D210} | L_{C1056} | R^{D145} | R^{D210} | L_{C1164} | R^{D168} | R^{D210} |
| L_{C841} | R^{D17} | R^{D211} | L_{C949} | R^{D50} | R^{D211} | L_{C1057} | R^{D145} | R^{D211} | L_{C1165} | R^{D168} | R^{D211} |
| L_{C842} | R^{D17} | R^{D212} | L_{C950} | R^{D50} | R^{D212} | L_{C1058} | R^{D145} | R^{D212} | L_{C1166} | R^{D168} | R^{D212} |
| L_{C843} | R^{D17} | R^{D213} | L_{C951} | R^{D50} | R^{D213} | L_{C1059} | R^{D145} | R^{D213} | L_{C1167} | R^{D168} | R^{D213} |
| L_{C844} | R^{D17} | R^{D214} | L_{C952} | R^{D50} | R^{D214} | L_{C1060} | R^{D145} | R^{D214} | L_{C1168} | R^{D168} | R^{D214} |
| L_{C845} | R^{D17} | R^{D215} | L_{C953} | R^{D50} | R^{D215} | L_{C1061} | R^{D145} | R^{D215} | L_{C1169} | R^{D168} | R^{D215} |
| L_{C846} | R^{D17} | R^{D216} | L_{C954} | R^{D50} | R^{D216} | L_{C1062} | R^{D145} | R^{D216} | L_{C1170} | R^{D168} | R^{D216} |
| L_{C847} | R^{D17} | R^{D217} | L_{C955} | R^{D50} | R^{D217} | L_{C1063} | R^{D145} | R^{D217} | L_{C1171} | R^{D168} | R^{D217} |
| L_{C848} | R^{D17} | R^{D218} | L_{C956} | R^{D50} | R^{D218} | L_{C1064} | R^{D145} | R^{D218} | L_{C1172} | R^{D168} | R^{D218} |
| L_{C849} | R^{D17} | R^{D219} | L_{C957} | R^{D50} | R^{D219} | L_{C1065} | R^{D145} | R^{D219} | L_{C1173} | R^{D168} | R^{D219} |
| L_{C850} | R^{D17} | R^{D220} | L_{C958} | R^{D50} | R^{D220} | L_{C1066} | R^{D145} | R^{D220} | L_{C1174} | R^{D168} | R^{D220} |
| L_{C851} | R^{D17} | R^{D221} | L_{C959} | R^{D50} | R^{D221} | L_{C1067} | R^{D145} | R^{D221} | L_{C1175} | R^{D168} | R^{D221} |
| L_{C852} | R^{D17} | R^{D222} | L_{C960} | R^{D50} | R^{D222} | L_{C1068} | R^{D145} | R^{D222} | L_{C1176} | R^{D168} | R^{D222} |
| L_{C853} | R^{D17} | R^{D223} | L_{C961} | R^{D50} | R^{D223} | L_{C1069} | R^{D145} | R^{D223} | L_{C1177} | R^{D168} | R^{D223} |
| L_{C854} | R^{D17} | R^{D224} | L_{C962} | R^{D50} | R^{D224} | L_{C1070} | R^{D145} | R^{D224} | L_{C1178} | R^{D168} | R^{D224} |
| L_{C855} | R^{D17} | R^{D225} | L_{C963} | R^{D50} | R^{D225} | L_{C1071} | R^{D145} | R^{D225} | L_{C1179} | R^{D168} | R^{D225} |
| L_{C856} | R^{D17} | R^{D226} | L_{C964} | R^{D50} | R^{D226} | L_{C1072} | R^{D145} | R^{D226} | L_{C1180} | R^{D168} | R^{D226} |
| L_{C857} | R^{D17} | R^{D227} | L_{C965} | R^{D50} | R^{D227} | L_{C1073} | R^{D145} | R^{D227} | L_{C1181} | R^{D168} | R^{D227} |
| L_{C858} | R^{D17} | R^{D228} | L_{C966} | R^{D50} | R^{D228} | L_{C1074} | R^{D145} | R^{D228} | L_{C1182} | R^{D168} | R^{D228} |
| L_{C859} | R^{D17} | R^{D229} | L_{C967} | R^{D50} | R^{D229} | L_{C1075} | R^{D145} | R^{D229} | L_{C1183} | R^{D168} | R^{D229} |
| L_{C860} | R^{D17} | R^{D230} | L_{C968} | R^{D50} | R^{D230} | L_{C1076} | R^{D145} | R^{D230} | L_{C1184} | R^{D168} | R^{D230} |
| L_{C861} | R^{D17} | R^{D231} | L_{C969} | R^{D50} | R^{D231} | L_{C1077} | R^{D145} | R^{D231} | L_{C1185} | R^{D168} | R^{D231} |
| L_{C862} | R^{D17} | R^{D232} | L_{C970} | R^{D50} | R^{D232} | L_{C1078} | R^{D145} | R^{D232} | L_{C1186} | R^{D168} | R^{D232} |
| L_{C863} | R^{D17} | R^{D233} | L_{C971} | R^{D50} | R^{D233} | L_{C1079} | R^{D145} | R^{D233} | L_{C1187} | R^{D168} | R^{D233} |
| L_{C864} | R^{D17} | R^{D234} | L_{C972} | R^{D50} | R^{D234} | L_{C1080} | R^{D145} | R^{D234} | L_{C1188} | R^{D168} | R^{D234} |
| L_{C865} | R^{D17} | R^{D235} | L_{C973} | R^{D50} | R^{D235} | L_{C1081} | R^{D145} | R^{D235} | L_{C1189} | R^{D168} | R^{D235} |
| L_{C866} | R^{D17} | R^{D236} | L_{C974} | R^{D50} | R^{D236} | L_{C1082} | R^{D145} | R^{D236} | L_{C1190} | R^{D168} | R^{D236} |
| L_{C867} | R^{D17} | R^{D237} | L_{C975} | R^{D50} | R^{D237} | L_{C1083} | R^{D145} | R^{D237} | L_{C1191} | R^{D168} | R^{D237} |
| L_{C868} | R^{D17} | R^{D238} | L_{C976} | R^{D50} | R^{D238} | L_{C1084} | R^{D145} | R^{D238} | L_{C1192} | R^{D168} | R^{D238} |
| L_{C869} | R^{D17} | R^{D239} | L_{C977} | R^{D50} | R^{D239} | L_{C1085} | R^{D145} | R^{D239} | L_{C1193} | R^{D168} | R^{D239} |
| L_{C870} | R^{D17} | R^{D240} | L_{C978} | R^{D50} | R^{D240} | L_{C1086} | R^{D145} | R^{D240} | L_{C1194} | R^{D168} | R^{D240} |
| L_{C871} | R^{D17} | R^{D241} | L_{C979} | R^{D50} | R^{D241} | L_{C1087} | R^{D145} | R^{D241} | L_{C1195} | R^{D168} | R^{D241} |
| L_{C872} | R^{D17} | R^{D242} | L_{C980} | R^{D50} | R^{D242} | L_{C1088} | R^{D145} | R^{D242} | L_{C1196} | R^{D168} | R^{D242} |
| L_{C873} | R^{D17} | R^{D243} | L_{C981} | R^{D50} | R^{D243} | L_{C1089} | R^{D145} | R^{D243} | L_{C1197} | R^{D168} | R^{D243} |
| L_{C874} | R^{D17} | R^{D244} | L_{C982} | R^{D50} | R^{D244} | L_{C1090} | R^{D145} | R^{D244} | L_{C1198} | R^{D168} | R^{D244} |
| L_{C875} | R^{D17} | R^{D245} | L_{C983} | R^{D50} | R^{D245} | L_{C1091} | R^{D145} | R^{D245} | L_{C1199} | R^{D168} | R^{D245} |
| L_{C876} | R^{D17} | R^{D246} | L_{C984} | R^{D50} | R^{D246} | L_{C1092} | R^{D145} | R^{D246} | L_{C1200} | R^{D168} | R^{D246} |
| L_{C1201} | R^{D10} | R^{D193} | L_{C1255} | R^{D55} | R^{D193} | L_{C1309} | R^{D37} | R^{D193} | L_{C1363} | R^{D143} | R^{D193} |
| L_{C1202} | R^{D10} | R^{D194} | L_{C1256} | R^{D55} | R^{D194} | L_{C1310} | R^{D37} | R^{D194} | L_{C1364} | R^{D143} | R^{D194} |
| L_{C1203} | R^{D10} | R^{D195} | L_{C1257} | R^{D55} | R^{D195} | L_{C1311} | R^{D37} | R^{D195} | L_{C1365} | R^{D143} | R^{D195} |
| L_{C1204} | R^{D10} | R^{D196} | L_{C1258} | R^{D55} | R^{D196} | L_{C1312} | R^{D37} | R^{D196} | L_{C1366} | R^{D143} | R^{D196} |
| L_{C1205} | R^{D10} | R^{D197} | L_{C1259} | R^{D55} | R^{D197} | L_{C1313} | R^{D37} | R^{D197} | L_{C1367} | R^{D143} | R^{D197} |
| L_{C1206} | R^{D10} | R^{D198} | L_{C1260} | R^{D55} | R^{D198} | L_{C1314} | R^{D37} | R^{D198} | L_{C1368} | R^{D143} | R^{D198} |
| L_{C1207} | R^{D10} | R^{D199} | L_{C1261} | R^{D55} | R^{D199} | L_{C1315} | R^{D37} | R^{D199} | L_{C1369} | R^{D143} | R^{D199} |
| L_{C1208} | R^{D10} | R^{D200} | L_{C1262} | R^{D55} | R^{D200} | L_{C1316} | R^{D37} | R^{D200} | L_{C1370} | R^{D143} | R^{D200} |
| L_{C1209} | R^{D10} | R^{D201} | L_{C1263} | R^{D55} | R^{D201} | L_{C1317} | R^{D37} | R^{D201} | L_{C1371} | R^{D143} | R^{D201} |
| L_{C1210} | R^{D10} | R^{D202} | L_{C1264} | R^{D55} | R^{D202} | L_{C1318} | R^{D37} | R^{D202} | L_{C1372} | R^{D143} | R^{D202} |
| L_{C1211} | R^{D10} | R^{D203} | L_{C1265} | R^{D55} | R^{D203} | L_{C1319} | R^{D37} | R^{D203} | L_{C1373} | R^{D143} | R^{D203} |
| L_{C1212} | R^{D10} | R^{D204} | L_{C1266} | R^{D55} | R^{D204} | L_{C1320} | R^{D37} | R^{D204} | L_{C1374} | R^{D143} | R^{D204} |
| L_{C1213} | R^{D10} | R^{D205} | L_{C1267} | R^{D55} | R^{D205} | L_{C1321} | R^{D37} | R^{D205} | L_{C1375} | R^{D143} | R^{D205} |
| L_{C1214} | R^{D10} | R^{D206} | L_{C1268} | R^{D55} | R^{D206} | L_{C1322} | R^{D37} | R^{D206} | L_{C1376} | R^{D143} | R^{D206} |
| L_{C1215} | R^{D10} | R^{D207} | _{LC1269} | R^{D55} | R^{D207} | L_{C1323} | R^{D37} | R^{D207} | L_{C1377} | R^{D143} | R^{D207} |
| L_{C1216} | R^{D10} | R^{D208} | L_{C1270} | R^{D55} | R^{D208} | L_{C1324} | R^{D37} | R^{D208} | L_{C1378} | R^{D143} | R^{D208} |
| L_{C1217} | R^{D10} | R^{D209} | L_{C1271} | R^{D55} | R^{D209} | L_{C1325} | R^{D37} | R^{D209} | L_{C1379} | R^{D143} | R^{D209} |
| L_{C1218} | R^{D10} | R^{D210} | L_{C1272} | R^{D55} | R^{D210} | L_{C1326} | R^{D37} | R^{D210} | L_{C1380} | R^{D143} | R^{D210} |
| L_{C1219} | R^{D10} | R^{D211} | L_{C1273} | R^{D55} | R^{D211} | L_{C1327} | R^{D37} | R^{D211} | L_{C1381} | R^{D143} | R^{D211} |
| L_{C1220} | R^{D10} | R^{D212} | L_{C1274} | R^{D55} | R^{D212} | L_{C1328} | R^{D37} | R^{D212} | L_{C1382} | R^{D143} | R^{D212} |
| L_{C1221} | R^{D10} | R^{D213} | L_{C1275} | R^{D55} | R^{D213} | L_{C1329} | R^{D37} | R^{D213} | L_{C1383} | R^{D143} | R^{D213} |
| L_{C1222} | R^{D10} | R^{D214} | L_{C1276} | R^{D55} | R^{D214} | L_{C1330} | R^{D37} | R^{D214} | L_{C1384} | R^{D143} | R^{D214} |
| L_{C1223} | R^{D10} | R^{D215} | L_{C1277} | R^{D55} | R^{D215} | L_{C1331} | R^{D37} | R^{D215} | L_{C1385} | R^{D143} | R^{D215} |
| L_{C1224} | R^{D10} | R^{D216} | L_{C1278} | R^{D55} | R^{D216} | L_{C1332} | R^{D37} | R^{D216} | L_{C1386} | R^{D143} | R^{D216} |
| L_{C1225} | R^{D10} | R^{D217} | L_{C1279} | R^{D55} | R^{D217} | L_{C1333} | R^{D37} | R^{D217} | L_{C1387} | R^{D143} | R^{D217} |
| L_{C1226} | R^{D10} | R^{D218} | L_{C1280} | R^{D55} | R^{D218} | L_{C1334} | R^{D37} | R^{D218} | L_{C1388} | R^{D143} | R^{D218} |
| L_{C1227} | R^{D10} | R^{D219} | L_{C1281} | R^{D55} | R^{D219} | L_{C1335} | R^{D37} | R^{D219} | L_{C1389} | R^{D143} | R^{D219} |
| L_{C1228} | R^{D10} | R^{D220} | L_{C1282} | R^{D55} | R^{D220} | L_{C1336} | R^{D37} | R^{D220} | L_{C1390} | R^{D143} | R^{D220} |
| L_{C1229} | R^{D10} | R^{D221} | L_{C1283} | R^{D55} | R^{D221} | L_{C1337} | R^{D37} | R^{D221} | L_{C1391} | R^{D143} | R^{D221} |
| L_{C1230} | R^{D10} | R^{D222} | L_{C1284} | R^{D55} | R^{D222} | L_{C1338} | R^{D37} | R^{D222} | L_{C1392} | R^{D143} | R^{D222} |
| L_{C1231} | R^{D10} | R^{D223} | L_{C1285} | R^{D55} | R^{D223} | L_{C1339} | R^{D37} | R^{D223} | L_{C1393} | R^{D143} | R^{D223} |
| L_{C1232} | R^{D10} | R^{D224} | L_{C1286} | R^{D55} | R^{D224} | L_{C1340} | R^{D37} | R^{D224} | L_{C1394} | R^{D143} | R^{D224} |
| L_{C1233} | R^{D10} | R^{D225} | L_{C1287} | R^{D55} | R^{D225} | L_{C1341} | R^{D37} | R^{D225} | L_{C1395} | R^{D143} | R^{D225} |
| L_{C1234} | R^{D10} | R^{D226} | L_{C1288} | R^{D55} | R^{D226} | L_{C1342} | R^{D37} | R^{D226} | L_{C1396} | R^{D143} | R^{D226} |
| L_{C1235} | R^{D10} | R^{D227} | L_{C1289} | R^{D55} | R^{D227} | L_{C1343} | R^{D37} | R^{D227} | L_{C1397} | R^{D143} | R^{D227} |
| L_{C1236} | R^{D10} | R^{D228} | L_{C1290} | R^{D55} | R^{D228} | L_{C1344} | R^{D37} | R^{D228} | L_{C1398} | R^{D143} | R^{D228} |
| L_{C1237} | R^{D10} | R^{D229} | L_{C1291} | R^{D55} | R^{D229} | L_{C1345} | R^{D37} | R^{D229} | L_{C1399} | R^{D143} | R^{D229} |
| L_{C1238} | R^{D10} | R^{D230} | L_{C1292} | R^{D55} | R^{D230} | L_{C1346} | R^{D37} | R^{D230} | L_{C1400} | R^{D143} | R^{D230} |
| L_{C1239} | R^{D10} | R^{D231} | L_{C1293} | R^{D55} | R^{D231} | L_{C1347} | R^{D37} | R^{D231} | L_{C1401} | R^{D143} | R^{D231} |
| L_{C1240} | R^{D10} | R^{D232} | L_{C1294} | R^{D55} | R^{D232} | L_{C1348} | R^{D37} | R^{D232} | L_{C1402} | R^{D143} | R^{D232} |
| L_{C1241} | R^{D10} | R^{D233} | L_{C1295} | R^{D55} | R^{D233} | L_{C1349} | R^{D37} | R^{D233} | L_{C1403} | R^{D143} | R^{D233} |
| L_{C1242} | R^{D10} | R^{D234} | L_{C1296} | R^{D55} | R^{D234} | L_{C1350} | R^{D37} | R^{D234} | L_{C1404} | R^{D143} | R^{D234} |
| L_{C1243} | R^{D10} | R^{D235} | L_{C1297} | R^{D55} | R^{D235} | L_{C1351} | R^{D37} | R^{D235} | L_{C1405} | R^{D143} | R^{D235} |
| L_{C1244} | R^{D10} | R^{D236} | L_{C1298} | R^{D55} | R^{D236} | L_{C1352} | R^{D37} | R^{D236} | L_{C1406} | R^{D143} | R^{D236} |
| L_{C1245} | R^{D10} | R^{D237} | L_{C1299} | R^{D55} | R^{D237} | L_{C1353} | R^{D37} | R^{D237} | L_{C1407} | R^{D143} | R^{D237} |
| L_{C1246} | R^{D10} | R^{D238} | L_{C1300} | R^{D55} | R^{D238} | L_{C1354} | R^{D37} | R^{D238} | L_{C1408} | R^{D143} | R^{D238} |
| L_{C1247} | R^{D10} | R^{D239} | L_{C1301} | R^{D55} | R^{D239} | L_{C1355} | R^{D37} | R^{D239} | L_{C1409} | R^{D143} | R^{D239} |
| L_{C1248} | R^{D10} | R^{D240} | L_{C1302} | R^{D55} | R^{D240} | L_{C1356} | R^{D37} | R^{D240} | L_{C1410} | R^{D143} | R^{D240} |
| L_{C1249} | R^{D10} | R^{D241} | L_{C1303} | R^{D55} | R^{D241} | L_{C1357} | R^{D37} | R^{D241} | L_{C1411} | R^{D143} | R^{D241} |
| L_{C1250} | R^{D10} | R^{D242} | L_{C1304} | R^{D55} | R^{D242} | L_{C1358} | R^{D37} | R^{D242} | L_{C1412} | R^{D143} | R^{D242} |
| L_{C1251} | R^{D10} | R^{D243} | L_{C1305} | R^{D55} | R^{D243} | L_{C1359} | R^{D37} | R^{D243} | L_{C1413} | R^{D143} | R^{D243} |
| L_{C1252} | R^{D10} | R^{D244} | L_{C1306} | R^{D55} | R^{D244} | L_{C1360} | R^{D37} | R^{D244} | L_{C1414} | R^{D143} | R^{D244} |
| L_{C1253} | R^{D10} | R^{D245} | L_{C1307} | R^{D55} | R^{D245} | L_{C1361} | R^{D37} | R^{D245} | L_{C1415} | R^{D143} | R^{D245} |
| L_{C1254} | R^{D10} | R^{D246} | L_{C1308} | R^{D55} | R^{D246} | L_{C1362} | R^{D37} | R^{D246} | L_{C1416} | R^{D143} | R^{D246} |
wherein R^{D1} to R^{D246} have the following structures:

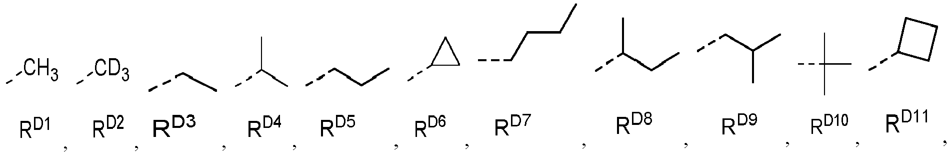

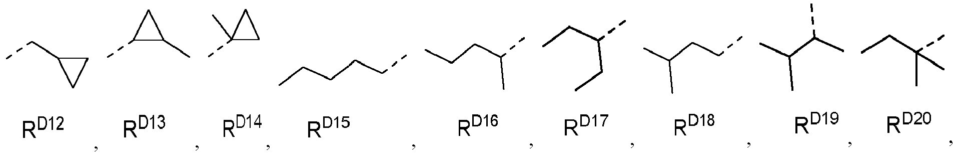

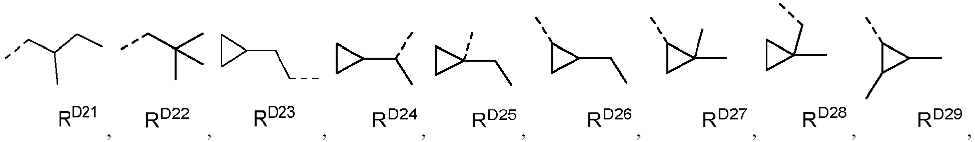

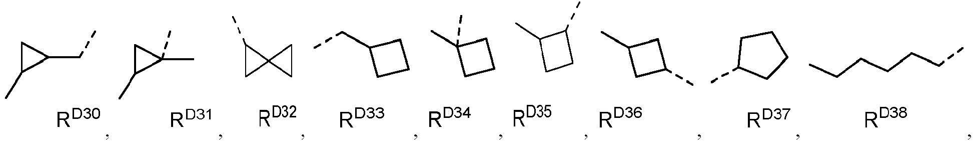

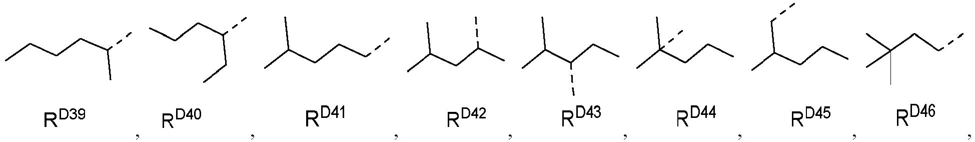

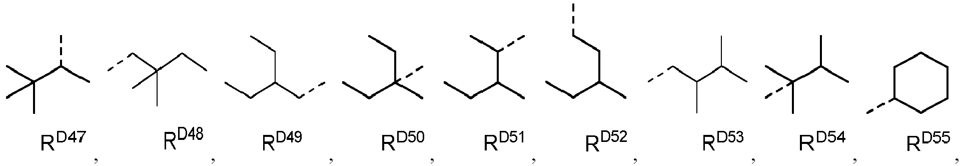

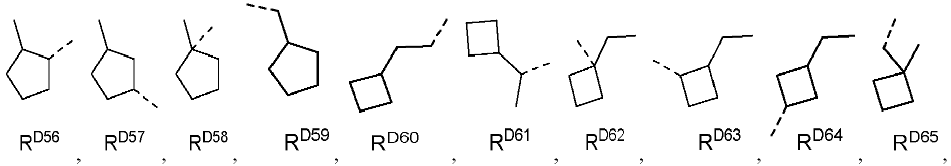

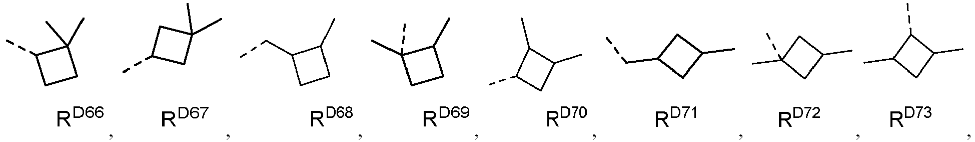

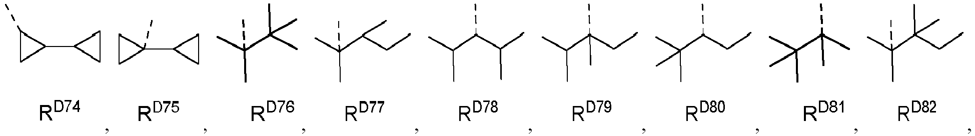

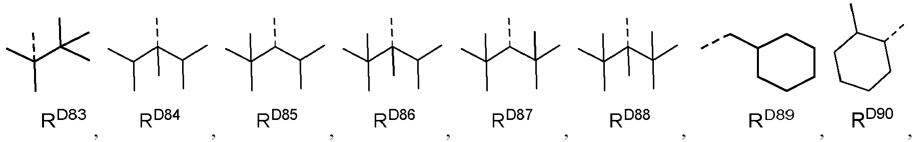

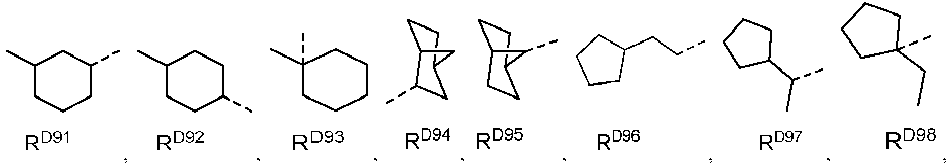

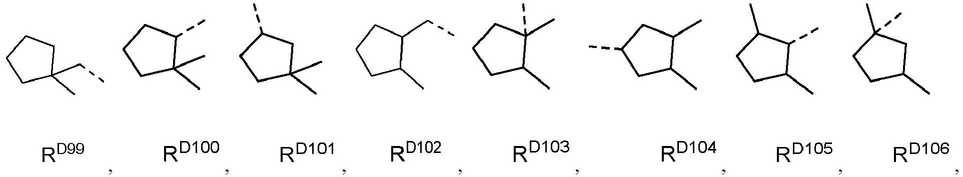

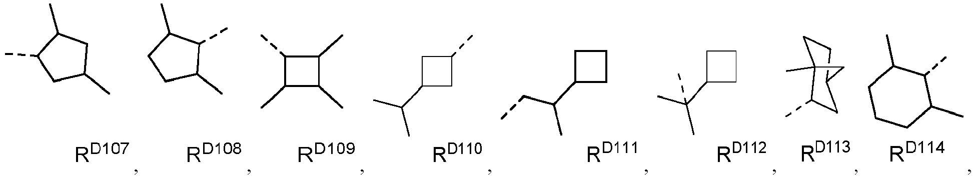

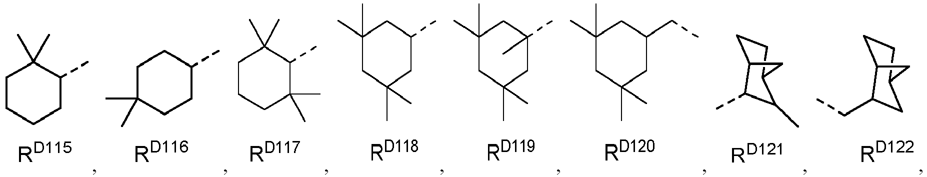

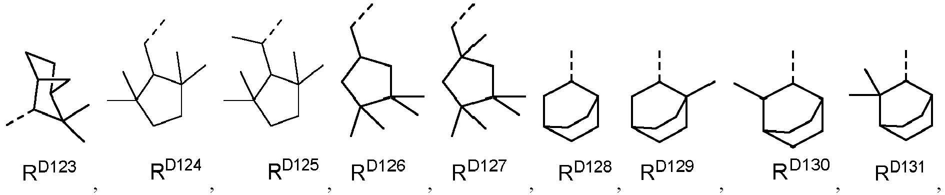

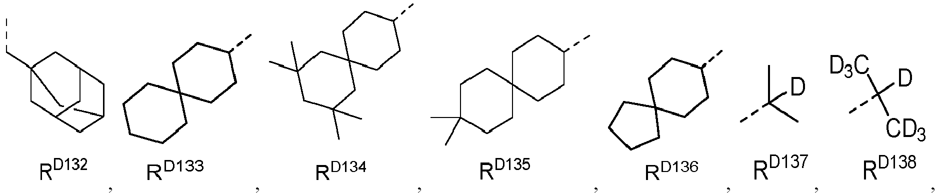

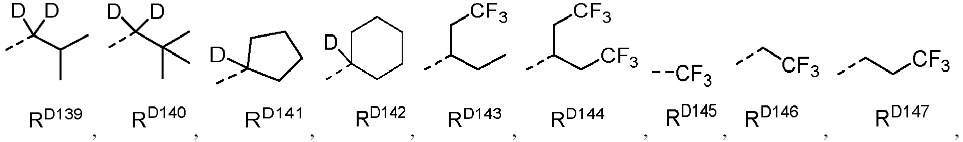

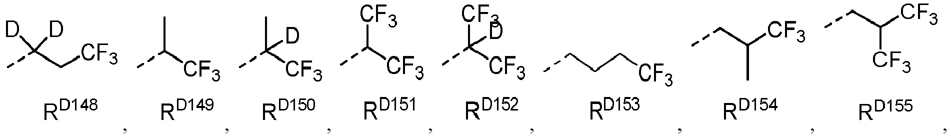

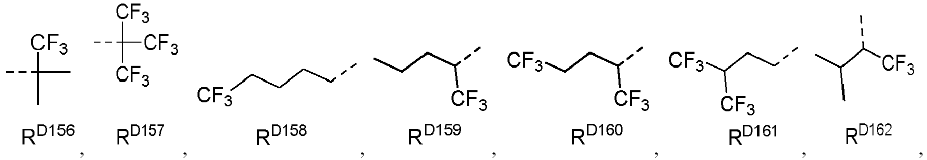

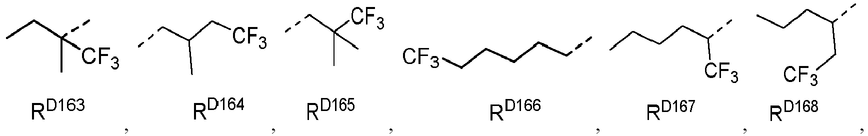

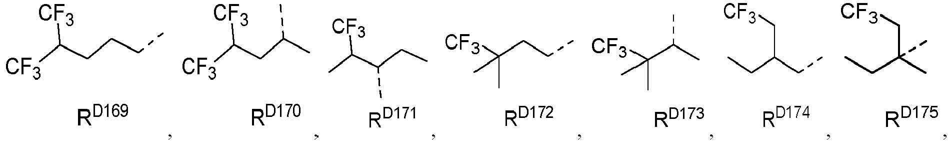

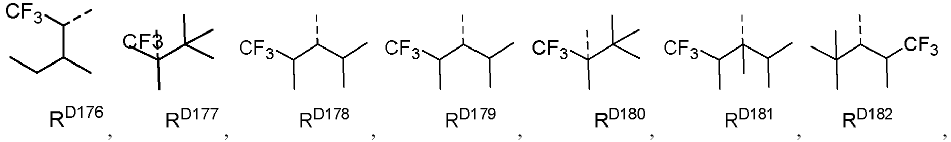

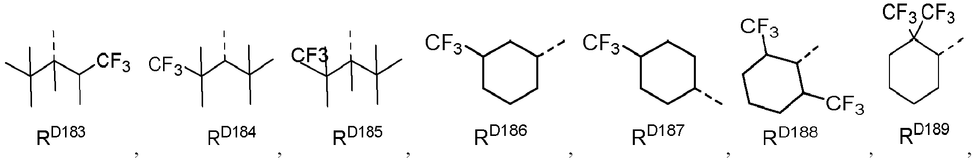

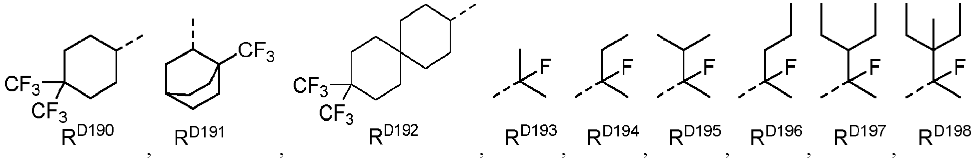

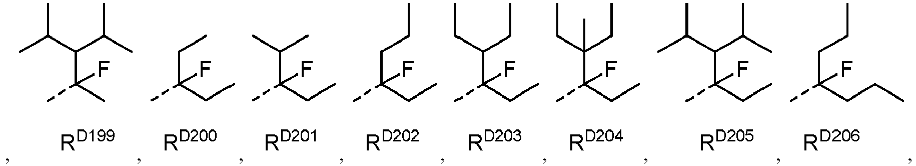

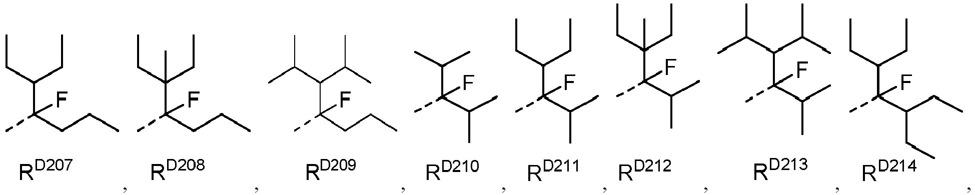

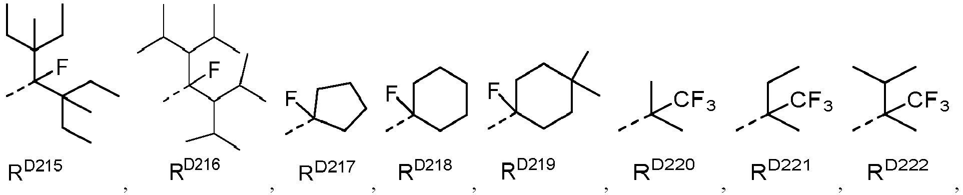

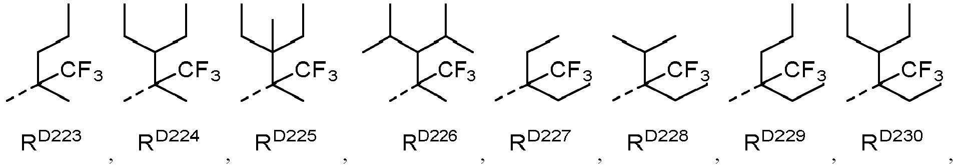

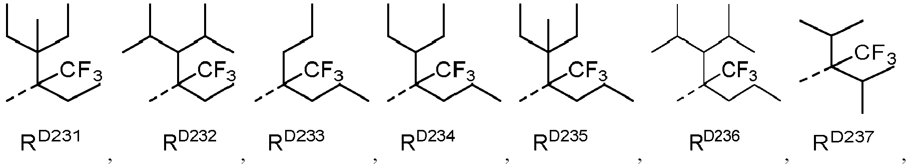

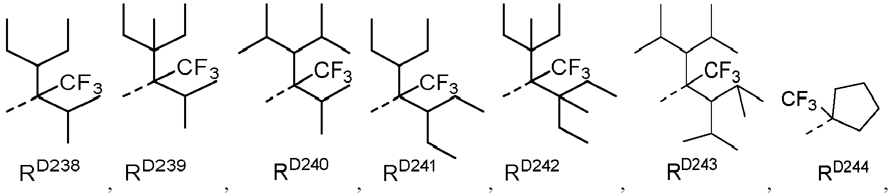

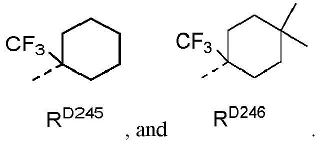

13. The compound of claim 1, wherein the compound is selected from the group consisting of: 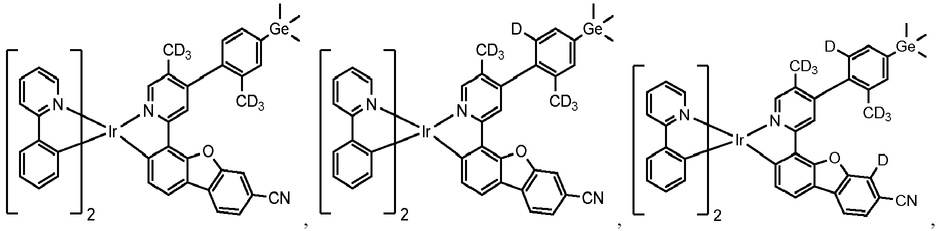 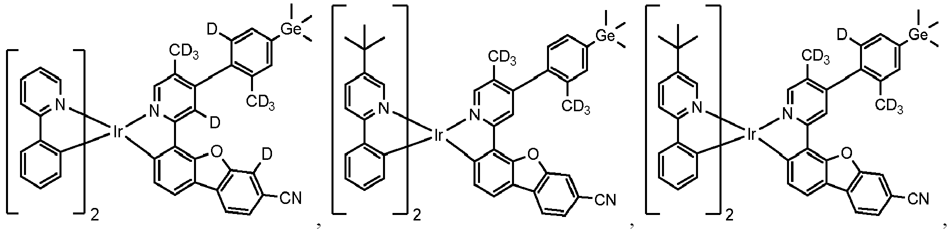 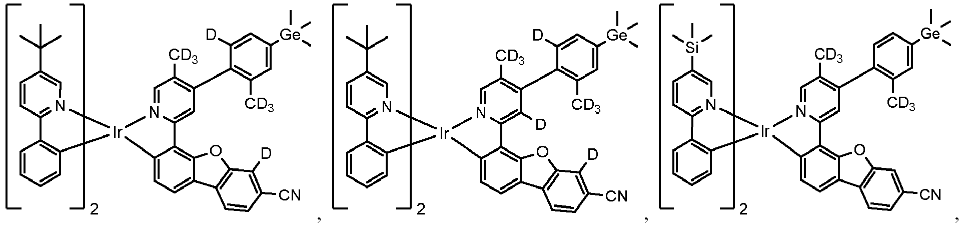 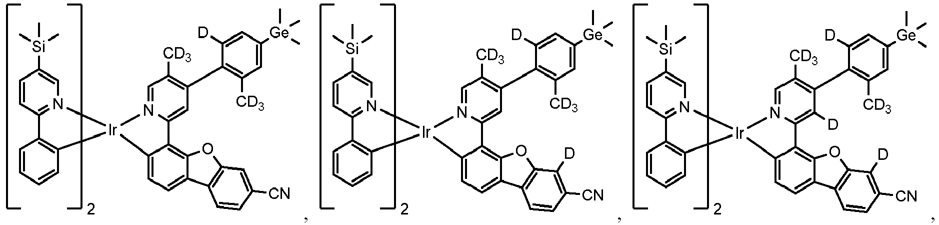 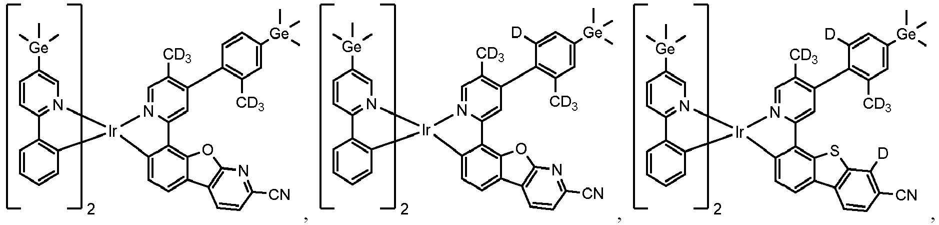 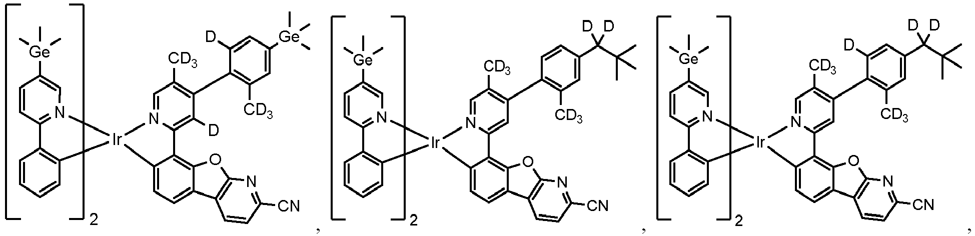 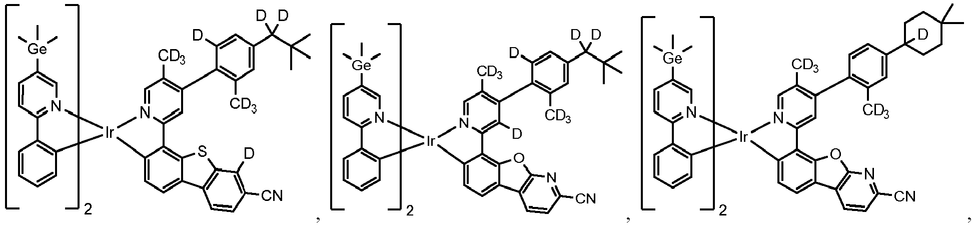 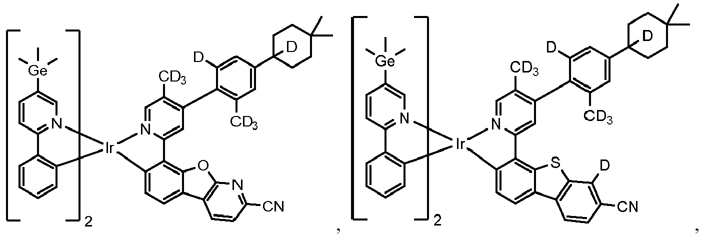 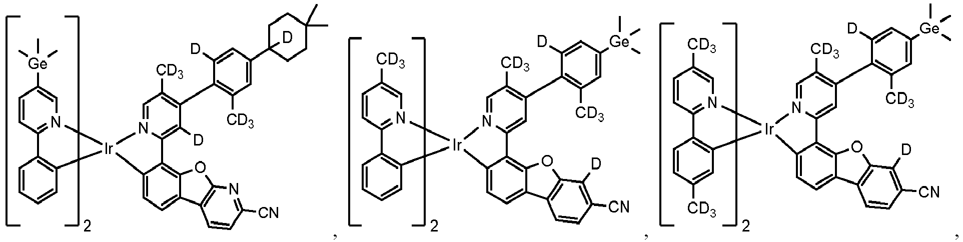 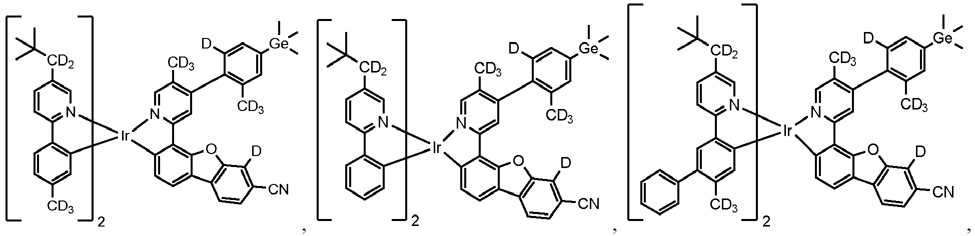 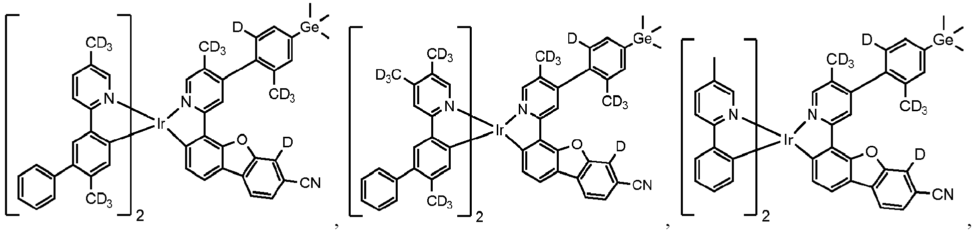 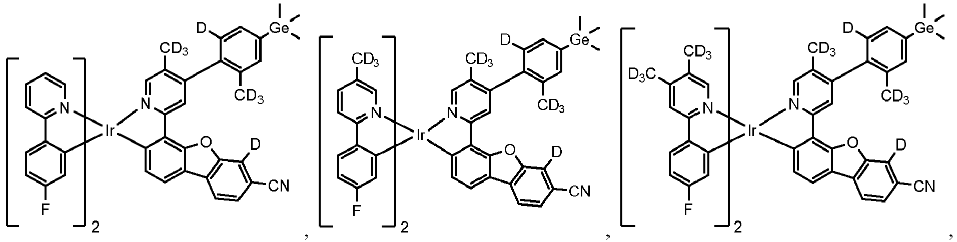 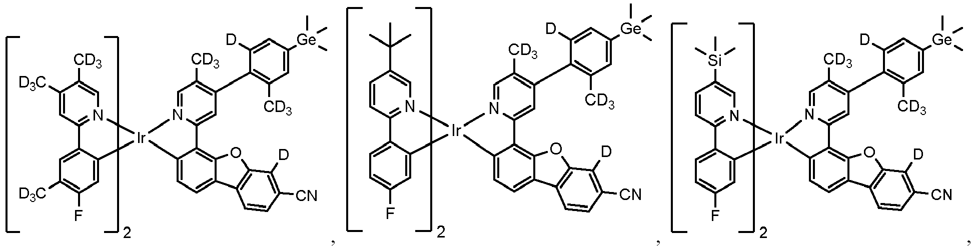 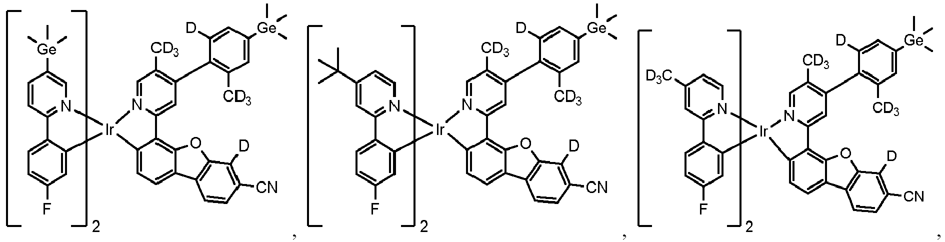 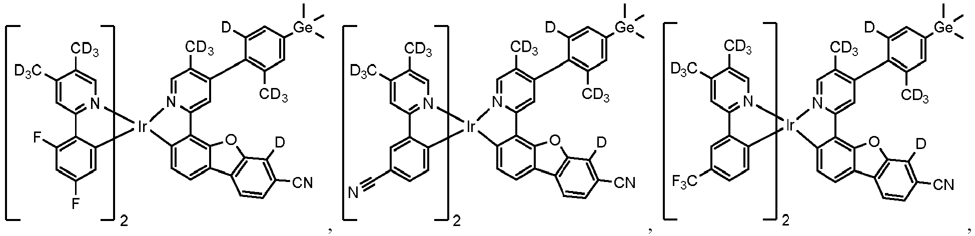 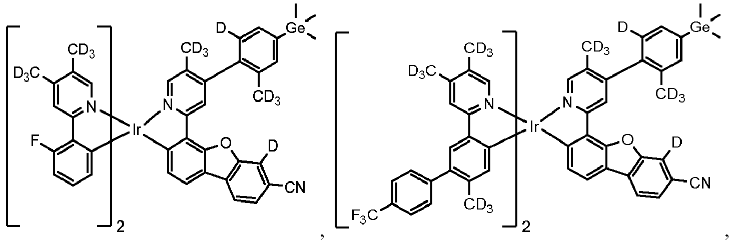 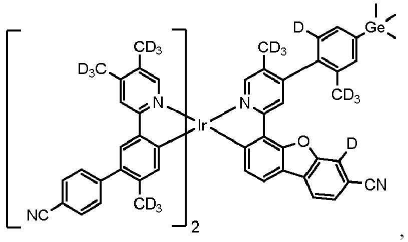 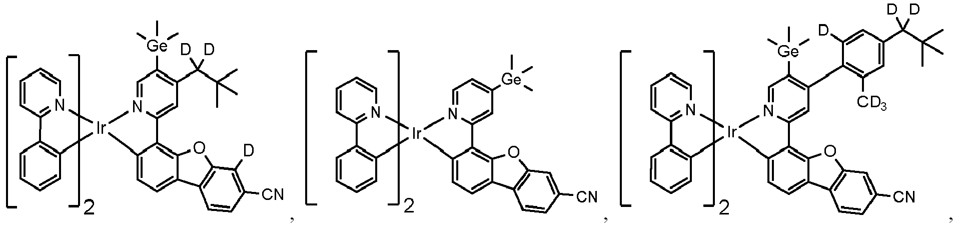 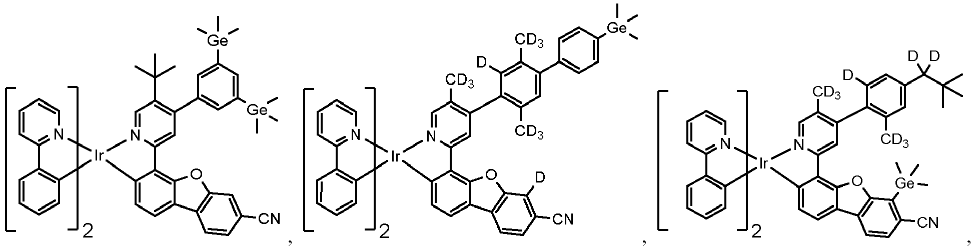 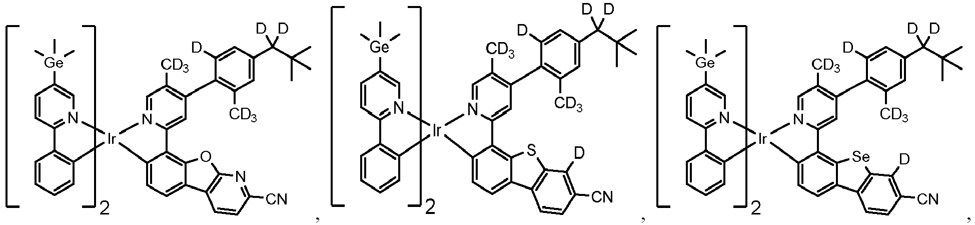 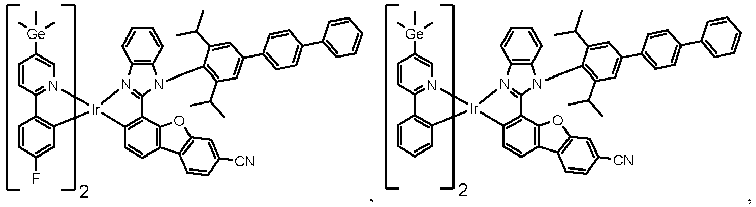 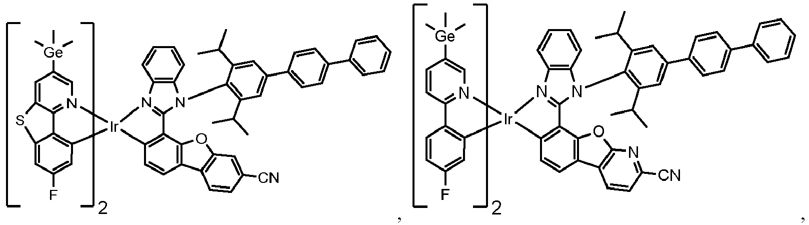 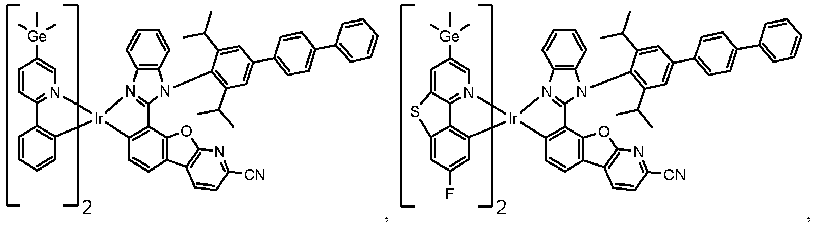 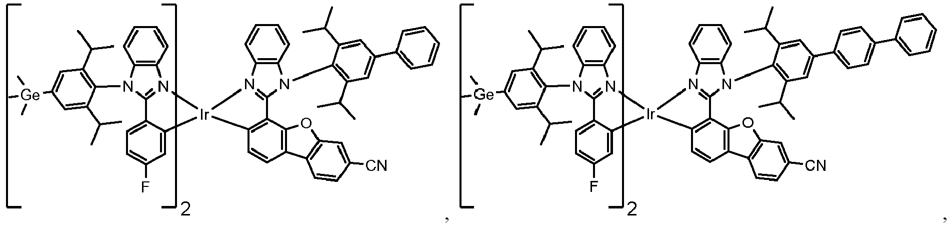 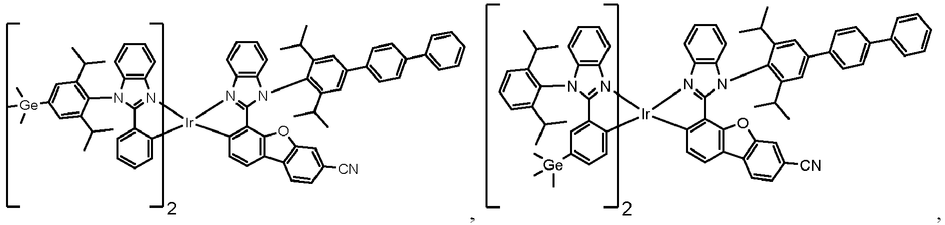 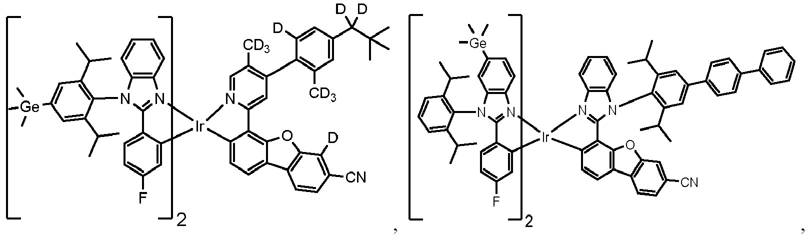 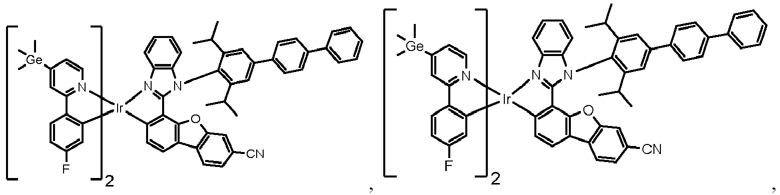 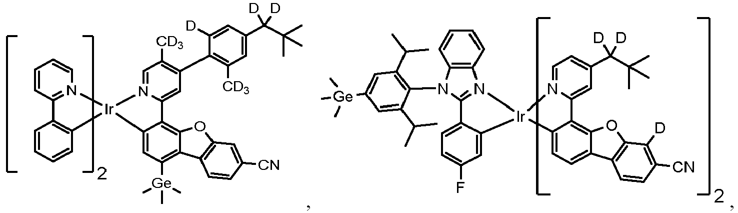 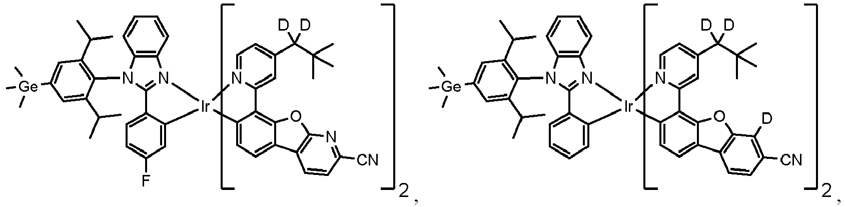 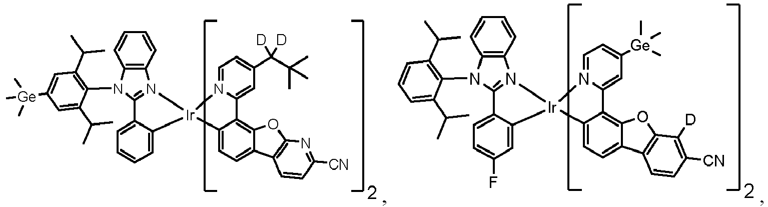 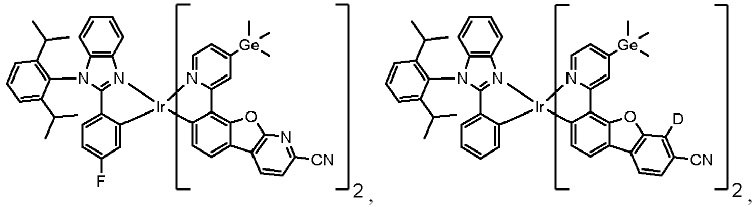 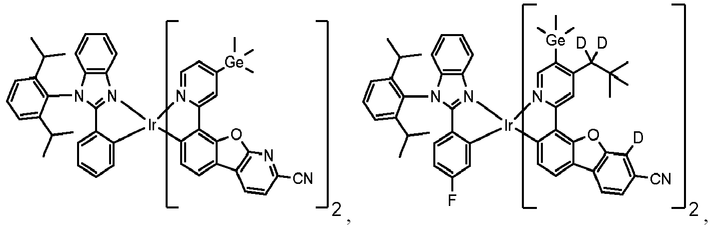 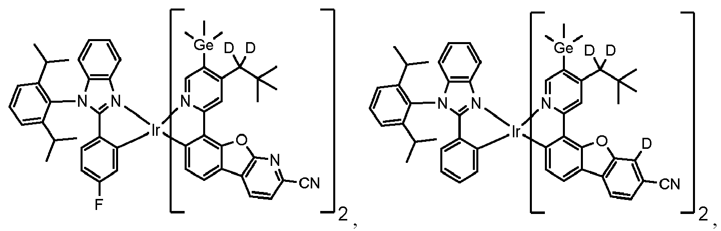 and

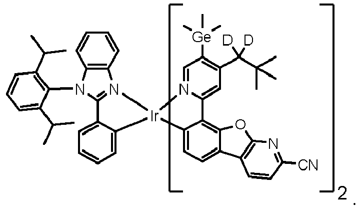

14. An organic light emitting device (OLED) comprising:
an anode;
a cathode; and
an organic layer disposed between the anode and the cathode, wherein the organic layer comprises a compound according to any one of the preceeding claims.

15. A consumer product comprising an organic light-emitting device comprising:
an anode;
a cathode; and
an organic layer disposed between the anode and the cathode, wherein the organic layer comprises a compound according to any one of the preceeding claims.
